# EUROPEAN PATENT SPECIFICATION

(11) **EP 3 109 253 B1**
(45) Date of publication and mention of the grant of the patent: **24.10.2018**
(21) Application number: 15733314.7
(22) Date of filing: 18.02.2015
(51) Int. Cl.: C07F 5/02, C09K 11/06, H01L 29/786, H01L 51/00

(54) **POLYCYCLIC AROMATIC COMPOUNDS AND THEIR USE AS ORGANIC DEVICE MATERIAL**
POLYCYCLISCHE AROMATISCHE VERBINDUNGEN UND DEREN VERWENDUNG ALS MATERIAL FÜR ORGANISCHE VORRICHTUNGEN
COMPOSÉS AROMATIQUES POLYCYCLIQUES ET LEUR UTILISATION COMME MATÉRIAU POUR DISPOSITIFS ORGANIQUES

(30) Priority: 18.02.2014 JP 2014028750; 07.10.2014 JP 2014206049
(43) Date of publication of application: 28.12.2016
(60) Divisional application: 18154644.1
(73) Proprietor: Kwansei Gakuin Educational Foundation, Nishinomiya-shi, Hyogo 662-8501 (JP); JNC Corporation, Chiyoda-ku Tokyo 100-8105 (JP)
(72) Inventor: HATAKEYAMA, Takuji, Sanda-shi Hyogo 669-1337 (JP); NAKATSUKA, Soichiro, Sanda-shi Hyogo 669-1337 (JP); NAKAJIMA, Kiichi, Sanda-shi Hyogo 669-1337 (JP); HIRAI, Hiroki, Sanda-shi Hyogo 669-1337 (JP); ONO, Yohei, Ichihara-shi Chiba 290-8551 (JP); SHIREN, Kazushi, Ichihara-shi Chiba 290-8551 (JP); NI, Jingping, Ichihara-shi Chiba 290-8551 (JP); MATSUSHITA, Takeshi, Ichihara-shi Chiba 290-8551 (JP); IKUTA, Toshiaki, Ichihara-shi Chiba 290-8551 (JP)
(74) Representative: Hoffmann Eitle
(86) International application number: PCT/JP2015/054426
(87) International publication number: WO 2015/102118

(56) References cited:
- WO-A2-2014/008967
- JP-A- 2012 234 873
- KREBS, FREDERIK C ET AL.: 'Synthesis, Structure, and Properties of 4,8,12-Trioxa-12c-phospha -4,8,12,12c-tetrahydrodibenzo[ cd ,mn]pyrene, a Molecular Pyroelectric' JOURNAL OF THE AMERICAN CHEMICAL SOCIETY vol. 119, no. 6, 1997, pages 1208 - 1216, XP055356748
- TAI, TRUONG BA ET AL.: 'Theoretical Design of n- Conjugated Heteropolycyclic Compounds Containing a Tricoordinated Boron Center' JOURNAL OF PHYSICAL CHEMISTRY C vol. 117, no. 29, 2013, pages 14999 - 15008, XP055310725
- HATAKEYAMA, T. ET AL.: 'Tandem Phospha-Friedel- Crafts Reacction toward Curved n-Conjugated Frameworks with a Phosphorus Ring Junctin' ORGANIC LETTERS vol. 13, no. 8, 2011, pages 2130 - 2133, XP055356754

## Description

### Technical Field

The present invention relates to a polycyclic aromatic compound, and an organic electroluminescent (EL) element, an organic field effect transistor and an organic thin film solar cell using the polycyclic aromatic compound, as well as a display apparatus and a lighting apparatus.

### Related Art

Conventionally, since display apparatuses employing light emitting elements that are electroluminescent can be subjected to reduction of power consumption and thickness reduction, various studies have been conducted thereon. Furthermore, organic electroluminescent elements formed from organic materials have been a subject of active investigation, from the viewpoint that weight reduction or size expansion can be easily achieved. Particularly, active research has been hitherto conducted on the development of organic materials having luminescence characteristics for blue light, which is one of the primary colors of light, and the development of organic materials having charge transport capability for holes, electrons and the like (having a potential for serving as a semiconductor or a superconductor), irrespective of whether the organic materials are high molecular weight compounds or low molecular weight compounds.

An organic EL element has a structure having a pair of electrodes composed of a positive electrode and a negative electrode, and a single layer or plural layers that are disposed between the pair of electrodes and contain organic compounds. Those layers include a layer containing an organic compound, a light emitting layer, a charge transport/injection layer for transporting or injecting charges such as holes or electrons, and the like, and various organic materials suitable for these layers have been developed.

Regarding the materials for light emitting layers, for example, benzofluorene-based compounds and the like have been developed (WO 2004/061047). Furthermore, regarding hole transporting materials, for example, triphenylamine-based compounds and the like have been developed (JP 2001-172232 A). Also, regarding electron transporting materials, for example, anthracene-based compounds and the like have been developed (JP 2005-170911 A).

Furthermore, in recent years, materials obtained by improving triphenylamine derivatives have also been reported as materials that are used in organic EL elements and organic thin film solar cells (WO 2012/118164). These materials are materials characterized in that N,N'-diphenyl-N,N'-bis(3-methylphenyl)-1,1'-biphenyl-4,4'-d iamine (TPD), which has been already put to practical use, is used as a base material, and flatness thereof is increased by connecting the aromatic rings that constitute triphenylamine. In this document, for example, evaluation of the charge transporting characteristics of a NO-linked system compound (compound 1 of page 63) has been made; however, there is no description on the method for producing materials other than the NO-linked system compound. Also, when the element that connects is different, the overall electron state of the compound is different; however, in this regard, the characteristics obtainable from materials other than the NO-linked system compound are still not known. Examples of such a compound are also found elsewhere (WO 2011/107186). For example, since a compound having a conjugated structure involving high energy of triplet exciton (T1) can emit phosphorescent light having a shorter wavelength, the compound is useful as a material for blue light emitting layer. There is also a demand for a novel compound having a conjugated structure with high T1 as an electron transporting material or a hole transporting material that interposes a light emitting layer.

A host material for organic EL elements is generally a molecule in which plural existing aromatic rings of benzene, carbazole or the like are linked via single bonds, phosphorus atoms or silicon atoms. This is because when a number of aromatic rings having a relatively small conjugated system are connected, the large HOMO-LUMO gap required from a host material (band gap Eg in a thin film) is secured. Furthermore, in a host material for organic EL elements that use phosphorescent materials or thermally activated delayed fluorescence materials, high triplet excitation energy (E_{T}) is needed; however, the triplet excitation energy (E_{T}) can be increased by localizing SOMO1 and SOMO2 in the triplet excitation state (T1) by connecting a donor-like or acceptor-like aromatic ring or substituent to the molecule, and thereby reducing the exchange interaction between the two orbitals. However, aromatic rings having small conjugated systems do not have sufficient redox stability, and an element which uses a molecule obtained by connecting existing aromatic rings as the host material, does not have a sufficient service life. On the other hand, polycyclic aromatic compounds having extended π-conjugated systems generally have excellent redox stability; however, since the HOMO-LUMO gap (band gap Eg in a thin film) or the triplet excitation energy (E_{T}) is low, polycyclic aromatic compounds have been considered to be unsuitable as host materials.
JP 2012-234873 discloses compounds of a specific formula shown therein wherein the radical which may be compared with Y¹ of the present invention represents N, P, P=O, P=S, SiAr.

### Citation List

### Patent Literatures

Patent Document 1: WO 2004/061047
Patent Document 2: JP 2001-172232 A
Patent Document 3: JP 2005-170911 A
Patent Document 4: WO 2012/118164
Patent Document 5: WO 2011/107186

### SUMMARY

### Problems to be resolved by the invention

As described above, various materials that are used in organic EL elements have been developed; however, in order to increase the selection range of the material for organic EL elements, it is desired to develop materials formed from compounds different from the conventional compounds. Particularly, the organic EL characteristics obtainable from materials other than the NO-linked system compounds reported in Patent Documents 1-4, and the methods for producing such materials are not yet known.

### Means of solving the problems

The inventors of the present invention conducted a thorough investigation in order to solve the problems described above, and as a result, the inventors found a novel polycyclic aromatic compound in which plural aromatic rings are linked via boron atoms, oxygen atoms and the like, and succeeded in production thereof. Also, the inventors found that when an organic EL element was configured by disposing a layer containing this polycyclic aromatic compound between a pair of electrodes, an excellent organic EL element was obtained, thus completing the present invention. That is, the present invention provides a polycyclic aromatic compound such as follows or an oligomer thereof, and a material for organic EL element containing a polycyclic aromatic compound such as follows or an oligomer thereof.
[1] A polycyclic aromatic compound represented by the following general formula (2), or an oligomer of a polycyclic aromatic compound having plural structures each represented by the following general formula (2): 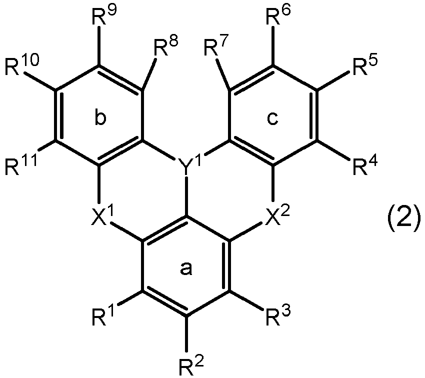 wherein in formula (2),
   R¹, R², R³, R⁴, R⁵, R⁶, R⁷, R⁸, R⁹, R¹⁰ and R¹¹ each independently represent a hydrogen atom, an aryl, a heteroaryl, a diarylamino, a diheteroarylamino, an arylheteroarylamino, an alkyl, an alkoxy or an aryloxy, while at least one hydrogen atom in these may be substituted by an aryl, a heteroaryl or an alkyl, adjacent groups among R¹ to R¹¹ may be bonded to each other and form an aryl ring or a heteroaryl ring together with the ring a, ring b or ring c, at least one hydrogen atom in the ring thus formed may be substituted by an aryl, a heteroaryl, a diarylamino, a diheteroarylamino, an arylheteroarylamino, an alkyl, an alkoxy or an aryloxy, and at least one hydrogen atom in these substituents may be substituted by an aryl, a heteroaryl or an alkyl wherein all the aryls are aryl having 6 to 30 carbon atoms, all the heteroaryls are heteroaryl having 2 to 30 carbon atoms, all the alkyls are a linear alkyl having 1 to 24 carbon atoms or a branched alkyl having 3 to 24 carbon atoms, all the alkoxys are a linear alkoxy having 1 to 24 carbon atoms or a branched alkoxy having 3 to 24 carbon atoms, the aryl ring is aryl ring having 9 to 30 carbon atoms, and the heteroaryl ring is heteroaryl ring having 6 to 30 carbon atoms;
   Y¹ represents B;
   X¹ and X² each independently represent O, N-R or S, wherein R of the moiety N-R represents an aryl having 6 to 12 carbon atoms which may be substituted by an alkyl having 1 to 6 carbon atoms, a heteroaryl having 2 to 15 carbon atoms, or an alkyl having 1 to 6 carbon atoms, R of the moiety N-R may be bonded to the ring a, ring b and/or ring c by -O-, -S-, -C(-R)₂- or a single bond, and R of the moiety -C(-R)₂- represents an alkyl having 1 to 6 carbon atoms; and
   at least one hydrogen atom in the compound represented by formula (2) may be substituted by a halogen atom or a deuterium atom.
[2] The polycyclic aromatic compound described in the above item [1], wherein
   R¹, R², R³, R⁴, R⁵, R⁶, R⁷, R⁸, R⁹, R¹⁰ and R¹¹ each independently represent a hydrogen atom, an aryl having 6 to 30 carbon atoms, a heteroaryl having 2 to 30 carbon atoms, or a diarylamino (provided that the aryl is an aryl having 6 to 12 carbon atoms), while adjacent groups among R¹ to R¹¹ are bonded to each other and form an aryl ring having 9 to 16 carbon atoms or a heteroaryl ring having 6 to 15 carbon atoms together with the ring a, ring b or ring c, and at least one hydrogen atom in the ring thus formed may be substituted by an aryl having 6 to 10 carbon atoms;
   Y¹ represents B, P, P=O, P=S or Si-R, wherein R in the moiety Si-R represents an aryl having 6 to 10 carbon atoms or an alkyl having 1 to 4 carbon atoms;
   X¹ and X² each independently represent O, N-R or S, wherein R in the moiety N-R represents an aryl having 6 to 10 carbon atoms or an alkyl having 1 to 4 carbon atoms; and
   at least one hydrogen atom in the compound represented by formula (2) may be substituted by a halogen atom or a deuterium atom.
[3] The polycyclic aromatic compound or the oligomer thereof described in above item [1] or [2], wherein the halogen atom is a fluorine atom.
[4] The polycyclic aromatic compound described in the above item [1], which is represented by the following formula (1-1), the following formula (1-2), the following formula (1-4), the following formula (1-10), the following formula (1-49), the following formula (1-81), the following formula (1-91), the following formula (1-100), the following formula (1-141), the following formula (1-151), the following formula (1-176), the following formula (1-411), the following formula (1-447), the following formula (1-501), the following formula (1-601), or the following formula (1-701): 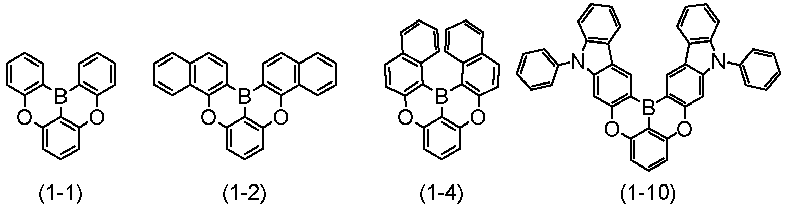 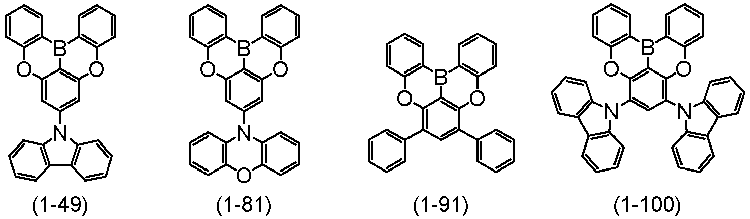 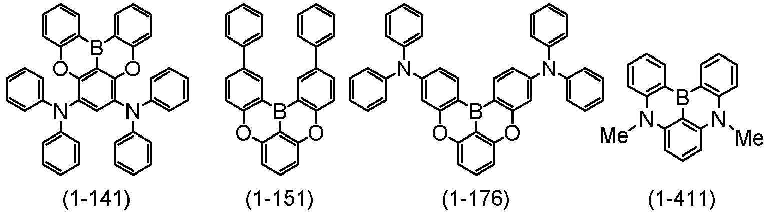 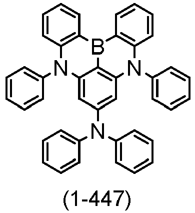
[5] The polycyclic aromatic compound described in the above item [1], which is represented by the following formula (1-21), the following formula (1-23), the following formula (1-24), the following formula (1-50), the following formula (1-152), the following formula (1-201), the following formula (1-401), the following formula (1-422), the following formula (1-1048), the following formula (1-1049), the following formula (1-1050), the following formula (1-1069), the following formula (1-1084), the following formula (1-1090), the following formula (1-1092), the following formula (1-1101), the following formula (1-1102), the following formula (1-1103), the following formula (1-1145), the following formula (1-1152), the following formula (1-1159), the following formula (1-1201), the following formula (1-1210), or the following formula (1-1271): 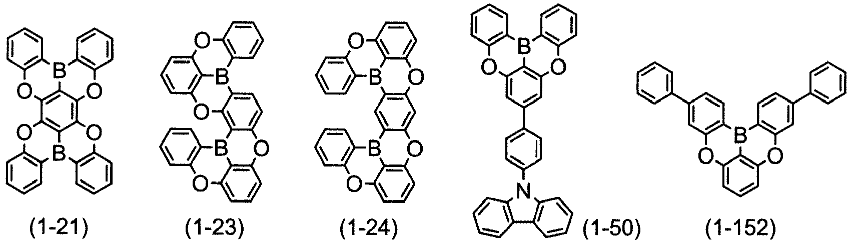 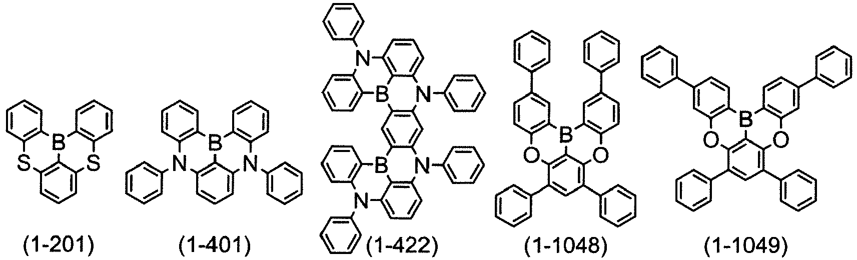 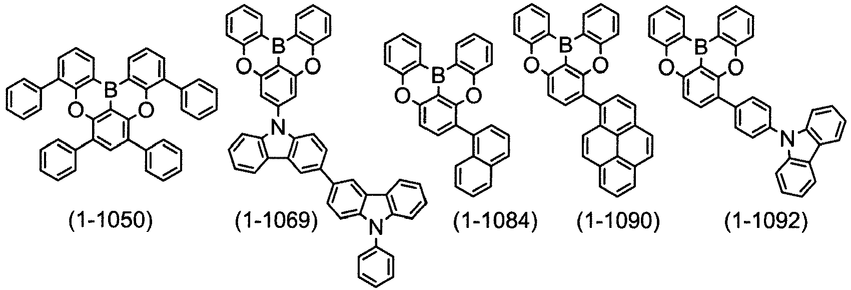 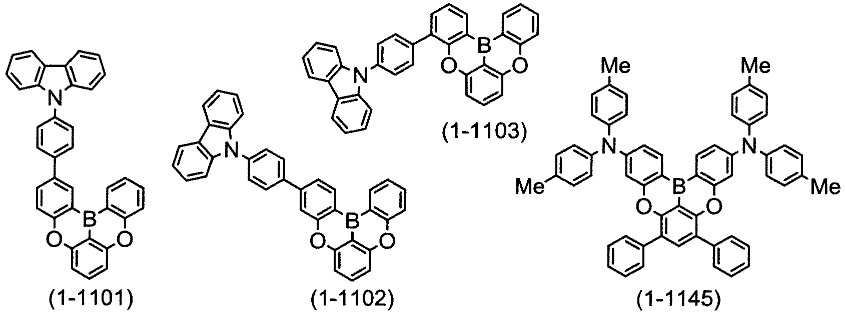 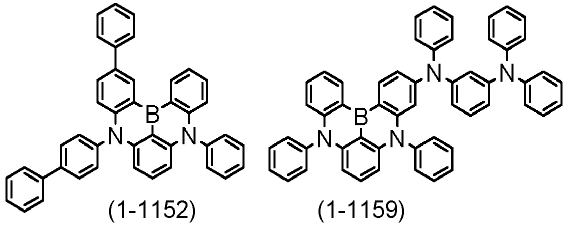 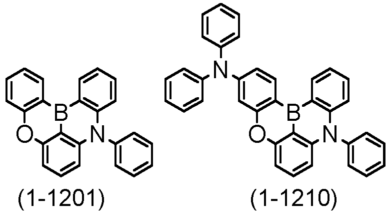 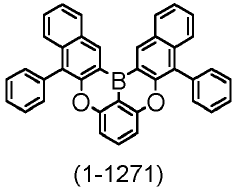
[6] The polycyclic aromatic compound described in the above item [1], which is represented by the following formula (1-1-1), the following formula (1-79), the following formula (1-142), the following formula (1-152-2), the following formula (1-158), the following formula (1-159), the following formula (1-1006), the following formula (1-1104), the following formula (1-1149), the following formula (1-1150), the following formula (1-1301), the following formula (1-1351), the following formula (1-2305), the following formula (1-2626), the following formula (1-2657), the following formula (1-2662), the following formula (1-2665), the following formula (1-2676), the following formula (1-2678), the following formula (1-2679), the following formula (1-2680), the following formula (1-2681), the following formula (1-2682), the following formula (1-2683), the following formula (1-2691), the following formula (1-2699), the following formula (1-4346), the following formula (1-4401), or the following formula (1-4421-1): 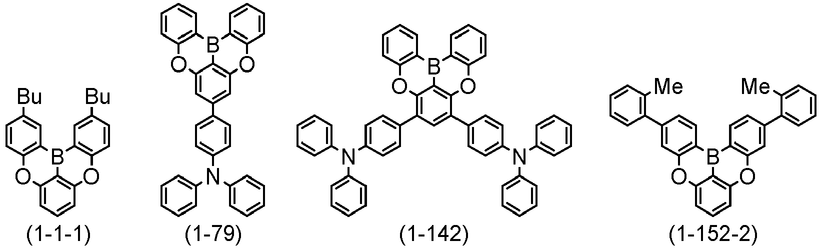 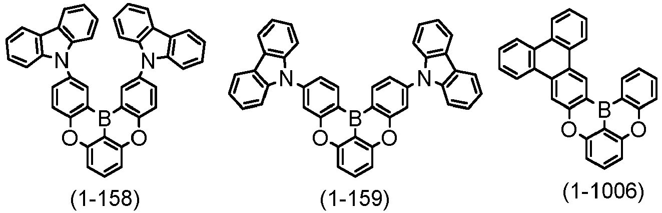 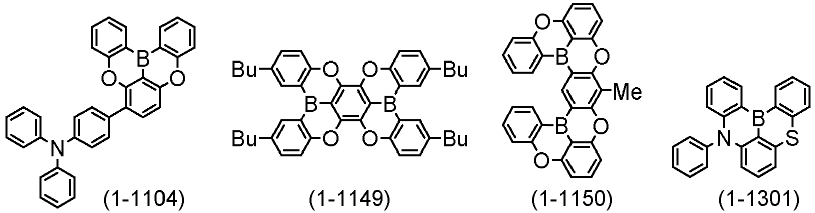 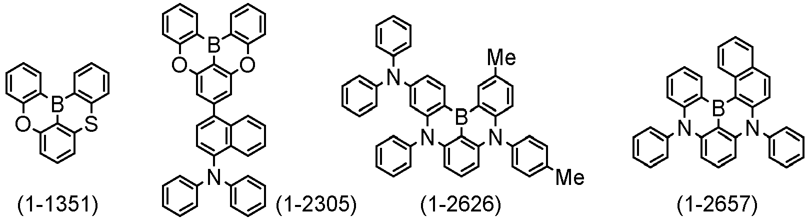 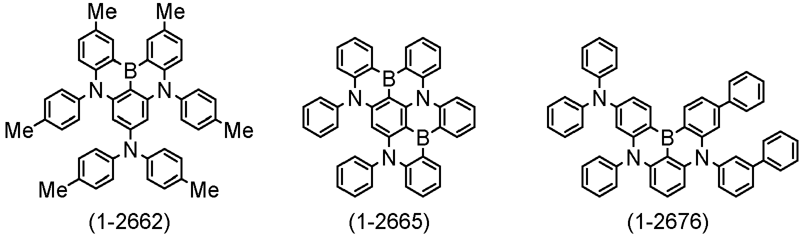 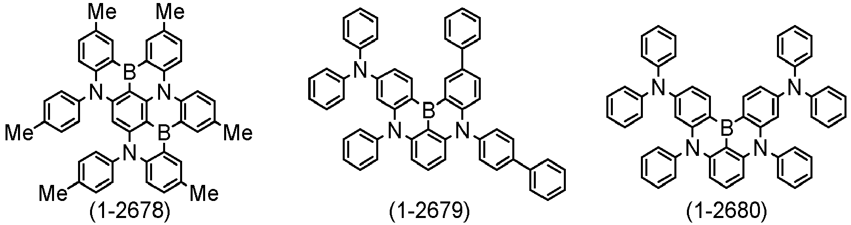 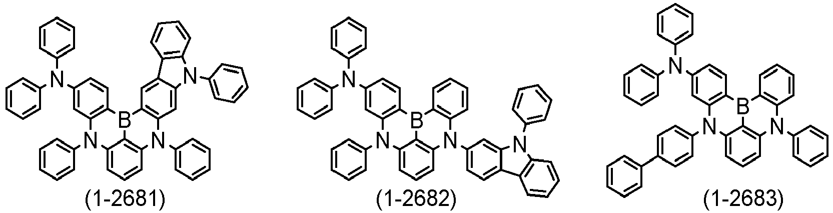 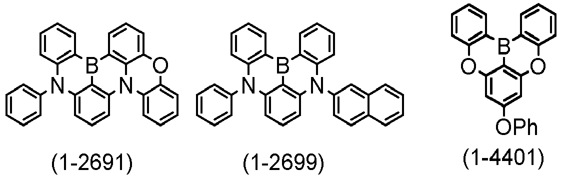 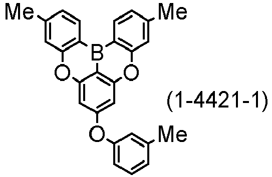
[7] A material for an organic device, comprising the polycyclic aromatic compound or the oligomer thereof described in any one of the above items [1] to [6].
[8] The material for an organic device described in the above item [7], wherein the material for an organic device is a material for an organic electroluminescent element, a material for an organic field effect transistor, or a material for an organic thin film solar cell.
[9] The material for an organic electroluminescent element described in the above item [8], which is a material for a light emitting layer.
[10] The material for an organic electroluminescent element described in the above item [8], which is a material for an electron injection layer or a material for an electron transport layer.
[11] The material for an organic electroluminescent element described in the above item [8], which is a material for a hole injection layer or a material for a hole transport layer.
[12] An organic electroluminescent element, comprising a pair of electrodes composed of a positive electrode and a negative electrode; and a light emitting layer that is disposed between the pair of electrodes and contains the material for a light emitting layer described in the above item [9].
[13] An organic electroluminescent element, comprising a pair of electrodes composed of a positive electrode and a negative electrode; a light emitting layer that is disposed between the pair of electrodes; and an electron injection layer and/or an electron transport layer that is disposed between the negative electrode and the light emitting layer and contains the material for an electron injection layer and/or the material for an electron transport layer described in the above item [10].
[14] An organic electroluminescent element, comprising a pair of electrodes composed of a positive electrode and a negative electrode; a light emitting layer that is disposed between the pair of electrodes; and a hole injection layer and/or a hole transport layer that is disposed between the positive electrode and the light emitting layer and contains the material for a hole injection layer and/or the material for a hole transport layer described in the above item [11].
[15] The organic electroluminescent element described in any one of the above items [12] or [14], further comprising an electron transport layer and/or an electron injection layer that is disposed between the negative electrode and the light emitting layer, wherein at least one of the electron transport layer and the electron injection layer contains at least one selected from the group consisting of a quinolinol-based metal complex, a pyridine derivative, a phenanthroline derivative, a borane derivative, and a benzimidazole derivative.
[16] The organic electroluminescent element described in the above [15], wherein the electron transport layer and/or electron injection layer further contains at least one selected from the group consisting of an alkali metal, an alkaline earth metal, a rare earth metal, an oxide of an alkali metal, a halide of an alkali metal, an oxide of an alkaline earth metal, a halide of an alkaline earth metal, an oxide of a rare earth metal, a halide of a rare earth metal, an organic complex of an alkali metal, an organic complex of an alkaline earth metal, and an organic complex of a rare earth metal.
[17] A display apparatus comprising the organic electroluminescent element described in any one of the above items [12] to [16].
[18] A lighting apparatus comprising the organic electroluminescent element described in any one of the above items [12] to [16].
[19]
   A method for producing the polycyclic aromatic compound represented by the following general formula (2) or the oligomer of a polycyclic aromatic compound having plural structures each represented by the following general formula (2) described in item [1],
   the method comprising a reaction step of linking ring a, ring b and ring c in the following intermediate via Y¹ through a continuous aromatic electrophilic substitution reaction, using a reagent selected from the group consisting of a halide of Y¹, an amination halide of Y¹, an alkoxylation product of Y¹ and an aryloxylation product of Y¹, and optionally a Brønsted base: 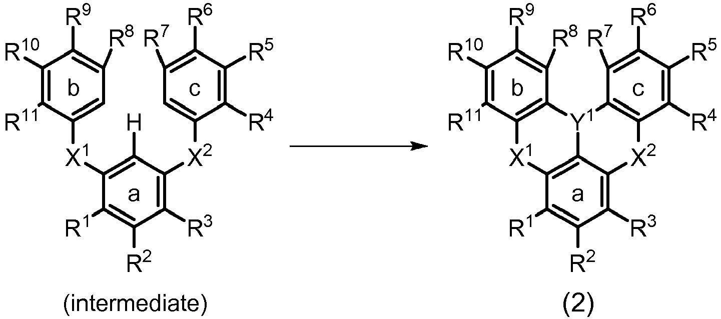 or the method comprising:
   a reaction step of ortho-metalating a hydrogen atom present between X¹ and X² in the following intermediate using an organic alkali compound;
   a reaction step of exchanging the metal for Y¹ using a reagent selected from the group consisting of a halide of Y¹, an aminated halide of Y¹, an alkoxylation product of Y¹, and an aryloxylation product of Y¹; and
   a reaction step of linking ring b and ring c via Y¹ through a continuous aromatic electrophilic substitution reaction using a Brønsted base: 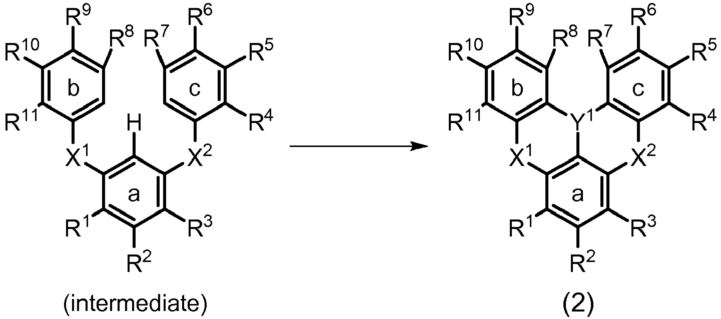
[20] The production method described in the above item [19], wherein the reaction is accelerated by further adding a Lewis acid to the reaction system.
[21] The production method described in above item [19] or [20], further comprising a reaction step of halogenating in advance a hydrogen atom present between X¹ and X² in the intermediate.

### Advantageous effect of the invention

According to preferred embodiments of the present invention, a novel polycyclic aromatic compound that can be used as, for example, a material for an organic EL element can be provided, and an excellent organic EL element can be provided by using this polycyclic aromatic compound.

Specifically, the inventors of the present invention found that a polycyclic aromatic compound in which aromatic rings are linked via a heteroelement such as boron, phosphorus, oxygen, nitrogen or sulfur, has a large HOMO-LUMO gap (band gap Eg in a thin film) and high triplet excitation energy (E_{T}). This is speculated to be because, since a 6-membered ring containing a heteroelement has low aromaticity, a decrease in the HOMO-LUMO gap that comes along with extension of the conjugated system is suppressed, and SOMO1 and SOMO2 of the triplet excitation state (T1) are localized by electronic perturbation of the heteroelement. Furthermore, the polycyclic aromatic compound containing a heteroelement related to the present invention is such that due to the localization of SOMO1 and SOMO2 in the triplet excitation state (T1), the exchange interaction between the two orbitals is reduced, and therefore, the energy difference between the triplet excitation state (T1) and the single excitation state (S1) is small. Also, since the polycyclic aromatic compound exhibits thermally activated delayed fluorescence, the compound is also useful as a fluorescent material for an organic EL element. Furthermore, a material having high triplet excitation energy (E_{T}) is also useful as an electron transport layer or a hole transport layer of a phosphorescence organic EL element or an organic EL element using a thermally activated delayed fluorescence. Also, since these polycyclic aromatic compounds can have the energy of HOMO and LUMO arbitrarily shifted by introducing a substituent, the ionization potential or the electron affinity can be optimized in accordance with the peripheral materials.

### Brief description of drawings

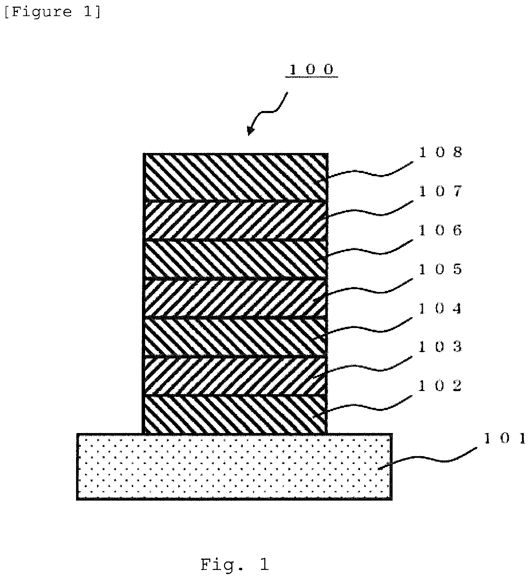

FIG. 1 is a schematic cross-sectional diagram illustrating an organic EL element related to the present exemplary embodiment.

### Detailed description

### 1. Polycyclic aromatic compound and oligomer thereof

The invention of the present application relates to a polycyclic aromatic compound represented by the above-defined general formula (2), or an oligomer of a polycyclic aromatic compound having plural structures each represented by the following general formula (2).

Ring a, ring b and ring c in the general formula (2) each independently represent an aryl ring, and at least one hydrogen atom in these rings may be substituted by a substituted or unsubstituted aryl, a substituted or unsubstituted heteroaryl, a substituted or unsubstituted diarylamino, a substituted or unsubstituted diheteroarylamino, a substituted or unsubstituted arylheteroarylamino (an amino group having an aryl and a heteroaryl), a substituted or unsubstituted alkyl, a substituted or unsubstituted alkoxy, or a substituted or unsubstituted aryloxy. Examples of the substituent in the case in which these groups have a substituent, include an aryl, a heteroaryl, and an alkyl. Furthermore, the aryl ring or heteroaryl ring preferably has a 5-membered ring or 6-membered ring that shares a bond with the fused bicyclic structure at the center of the general formula (2) constructed by Y¹, X¹ and X² (hereinafter, this structure is also referred to as "structure D").

Here, the "fused bicyclic structure (structure D)" means a structure in which two saturated hydrocarbon rings that are configured to include Y¹, X¹ and X² and indicated at the center of the general formula (2), are fused. Furthermore, a "6-membered ring sharing a bond with the fused bicyclic structure" means, for example, ring a (benzene ring (6-membered ring)) fused to the structure D as represented by the above general formula (2). Furthermore, the phrase "aryl ring or heteroaryl ring (which is ring A) has this 6-membered ring" means that the ring A is formed from this 6-membered ring only, or the ring A is formed such that other rings are further fused to this 6-membered ring so as to include this 6-membered ring. In other words, the "aryl ring or heteroaryl ring (which is ring A) having a 6-membered ring" as used herein means that the 6-membered ring that constitutes the entirety or a portion of the ring a is fused to the structure D.

In general formula (2), adjacent groups among the substituents R¹ to R¹¹ of the ring a, ring b and ring c may be bonded to each other and form an aryl ring or a heteroaryl ring together with the ring a, ring b or ring c, and at least one hydrogen atom in the ring thus formed may be substituted by an aryl, a heteroaryl, a diarylamino, a diheteroarylamino, an arylheteroarylamino, an alkyl, an alkoxy or an aryloxy, while at least one hydrogen atom in these substituents may be substituted by an aryl, a heteroaryl or an alkyl. Therefore, the polycyclic aromatic compound represented by general formula (2) is such that the ring structure that constitutes the compound changes as indicated by the following formula (2-1) and formula (2-2), as a result of the mutual bonding form of the substituents in the ring a, ring b or ring c. Ring A', ring B' and ring C' in the respective formulas correspond to ring A, ring B and ring C, respectively, in the general formula (2) .

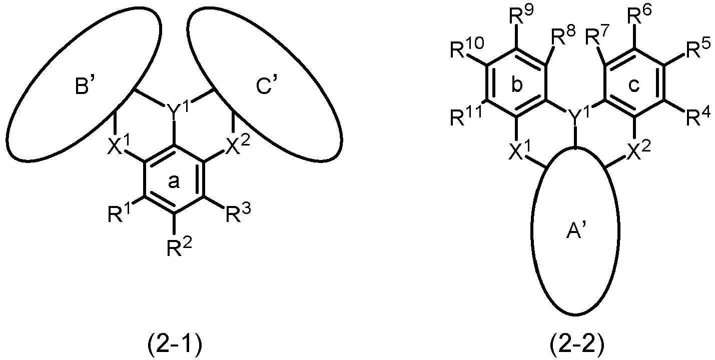

Ring A', ring B' and ring C' in the above formula (2-1) and formula (2-2) each represent, to be explained in connection with the general formula (2), an aryl ring or a heteroaryl ring formed by bonding between adjacent groups among the substituents R¹ to R¹¹, together with the ring a, ring b and ring c, respectively (may also be referred to as a fused ring obtained as another ring structure is fused to the ring a, ring b or ring c). In addition, although it is not suggested in the formula, there is also a compound in which all of the ring a, ring b and ring c have been changed to ring A', ring B' and ring C'. Furthermore, it can be seen from the above formula (2-1) and formula (2-2), for example, R⁸ of ring b and R⁷ of ring c, R¹¹ of ring b and R¹ of ring a, R⁴ of ring c and R³ of ring a, and the like do not correspond to "adjacent groups", and these are not to be bonded. That is, the expression "adjacent groups" means adjacent groups on the same ring.

A compound represented by the above formula (2-1) or formula (2-2) corresponds to, for example, a compound represented by any one of formulas (1-2) to (1-17) listed as specific compounds that are described below. That is, for example, the compound represented by formula (2-1) or formula (2-2) is a compound having ring A' (or ring B' or ring C') that is formed when a benzene ring, an indole ring, a pyrrole ring, a benzofuran ring or a benzothiophene ring is fused to the benzene ring which is ring a (or ring b or ring c), and the fused ring A' (or fused ring B' or fused ring C') that could be formed is a naphthalene ring, a carbazole ring, an indole ring, a dibenzofuran ring, or a dibenzothiophene ring.

X¹ and X² in the general formula (2) each independently represent O, N-R, S or Se, while R of the moiety N-R represents an aryl which may be substituted, a heteroaryl which may be substituted, or an alkyl which may be substituted, and R of the moiety N-R may be bonded to the ring B and/or ring C by a linking group or a single bond. The linking group is preferably -O-, -S- or -C(-R)₂-. Meanwhile, R of the moiety "-C(-R)₂-" represents a hydrogen atom or an alkyl.

This provision that "R of the moiety N-R is bonded to the ring A, ring B and/or ring C by a linking group or a single bond" for the general formula (2) can be expressed by a compound having a ring structure represented by the following formula (2-3-1), in which X¹ or X² is incorporated into the fused ring B' and the fused ring C'. That is, for example, the compound is a compound having ring B' (or ring C') that is formed as another ring is fused to a benzene ring which is ring b (or ring c) in the general formula (2) so as to incorporate X¹ (or X²). This compound corresponds to, for example, a compound represented by any one of formulas (1-451) to (1-462) or a compound represented by any one of formulas (1-1401) to (1-1460), which are listed as specific examples that are described below, and the fused ring B' (or fused ring C') that could be formed is, for example, a phenoxazine ring, a phenothiazine ring, or an acridine ring.

Also, the above provision can be expressed by a compound having a ring structure in which X¹ and/or X² is incorporated into the fused ring A', as represented by the following formula (2-3-2) or formula (2-3-3) . That is, for example, a compound having ring A' that is formed as another ring is fused to a benzene ring which is ring a in general formula (2) so as to incorporate X¹ (and/or X²). This compound corresponds to, for example, a compound represented by any one of formulas (1-471) to (1-479) listed as specific examples that are described below, and the fused ring A' that could be formed is, for example, a phenoxazine ring, a phenothiazine ring, or an acridine ring.

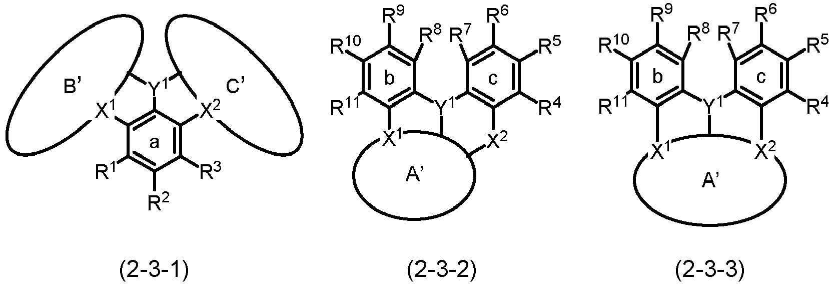

The "aryl ring" as the ring a, ring b or ring c of the general formula (2) is, for example, an aryl ring having 6 to 30 carbon atoms, and the aryl ring is preferably an aryl ring having 6 to 16 carbon atoms, more preferably an aryl ring having 6 to 12 carbon atoms, and particularly preferably an aryl ring having 6 to 10 carbon atoms. Also, since ring a (or ring b or ring c) is already configured by a benzene ring having 6 carbon atoms, a carbon number of 9 in total of a fused ring obtained when a 5-membered ring is fused to this benzene ring, becomes the lower limit of the carbon number.

Specific examples of the "aryl ring" include a benzene ring which is a monocyclic system; a biphenyl ring which is a bicyclic system; a naphthalene ring which is a fused bicyclic system; a terphenyl ring (m-terphenyl, o-terphenyl, or p-terphenyl) which is a tricyclic system; an acenaphthylene ring, a fluorene ring, a phenalene ring and a phenanthrene ring, which are fused tricyclic systems; a triphenylene ring, a pyrene ring and a naphthacene ring, which are fused tetracyclic systems; and a perylene ring and a pentacene ring, which are fused pentacyclic systems.

The "heteroaryl ring" as the ring a, ring b or ring c of the general formula (2) is, for example, a heteroaryl ring having 2 to 30 carbon atoms, and the heteroaryl ring is preferably a heteroaryl ring having 2 to 25 carbon atoms, more preferably a heteroaryl ring having 2 to 20 carbon atoms, even more preferably a heteroaryl ring having 2 to 15 carbon atoms, and particularly preferably a heteroaryl ring having 2 to 10 carbon atoms. Furthermore, the "heteroaryl ring" may be, for example, a heterocyclic ring containing 1 to 5 heteroatoms selected from oxygen, sulfur and nitrogen in addition to carbon as the ring-constituting atoms. Since the ring a (or ring b or ring c) is already composed of a benzene ring having 6 carbon atoms, a carbon number of 6 in total of a fused ring obtained when a 5-membered ring is fused to this benzene ring, becomes the lower limit of the carbon number.

Specific examples of the "heteroaryl ring" include a pyrrole ring, an oxazole ring, an isoxazole ring, a thiazole ring, an isothiazole ring, an imidazole ring, an oxadiazole ring, a thiadiazole ring, a triazole ring, a tetrazole ring, a pyrazole ring, a pyridine ring, a pyrimidine ring, a pyridazine ring, a pyrazine ring, a triazine ring, an indole ring, an isoindole ring, a 1H-indazole ring, a benzimidazole ring, a benzoxazole ring, a benzothiazole ring, a 1H-benzotriazole ring, a quinoline ring, an isoquinoline ring, a cinnoline ring, a quinazoline ring, a quinoxaline ring, a phthalazine ring, a naphthyridine ring, a purine ring, a pteridine ring, a carbazole ring, an acridine ring, a phenoxathiin ring, a phenoxazine ring, a phenothiazine ring, a phenazine ring, an indolizine ring, a furan ring, a benzofuran ring, an isobenzofuran ring, a dibenzofuran ring, a thiophene ring, a benzothiophene ring, a dibenzothiophene ring, a furazane ring, an oxadiazole ring, and a thianthrene ring.

At least one hydrogen atom in the aforementioned "aryl ring" or "heteroaryl ring" may be substituted by a substituted or unsubstituted "aryl", a substituted or unsubstituted "heteroaryl", a substituted or unsubstituted "diarylamino", a substituted or unsubstituted "diheteroarylamino", a substituted or unsubstituted "arylheteroarylamino", a substituted or unsubstituted "alkyl", a substituted or unsubstituted "alkoxy", or a substituted or unsubstituted "aryloxy", which is a primary substituent. Examples of the aryl of the "aryl", "heteroaryl" and "diarylamino", the heteroaryl of the "diheteroarylamino", the aryl and the heteroaryl of the "arylheteroarylamino" and the aryl of "aryloxy" as these primary substituents include a monovalent group of the "aryl ring" or "heteroaryl ring" described above.

Furthermore, the "alkyl" as the primary substituent may be any of a straight chain or a branched chain, and examples thereof include a linear alkyl having 1 to 24 carbon atoms and a branched alkyl having 3 to 24 carbon atoms. The alkyl is preferably an alkyl having 1 to 18 carbon atoms (branched alkyl having 3 to 18 carbon atoms), more preferably an alkyl having 1 to 12 carbon atoms (branched alkyl having 3 to 12 carbon atoms), even more preferably an alkyl having 1 to 6 carbon atoms (branched alkyl having 3 to 6 carbon atoms), and particularly preferably an alkyl having 1 to 4 carbon atoms (branched alkyl having 3 to 4 carbon atoms).

Specific examples of the alkyl include methyl, ethyl, n-propyl, isopropyl, n-butyl, isobutyl, s-butyl, t-butyl, n-pentyl, isopentyl, neopentyl, t-pentyl, n-hexyl, 1-methylpentyl, 4-methyl-2-pentyl, 3,3-dimethylbutyl, 2-ethylbutyl, n-heptyl, 1-methylhexyl, n-octyl, t-octyl, 1-methylheptyl, 2-ethylhexyl, 2-propylpentyl, n-nonyl, 2,2-dimethylheptyl, 2,6-dimethyl-4-heptyl, 3,5,5-trimethylhexyl, n-decyl, n-undecyl, 1-methyldecyl, n-dodecyl, n-tridecyl, 1-hexylheptyl, n-tetradecyl, n-pentadecyl, n-hexadecyl, n-heptadecyl, n-octadecyl, and n-eicosyl.

Furthermore, the "alkoxy" as a primary substituent may be, for example, a linear alkoxy having 1 to 24 carbon atoms or a branched alkoxy having 3 to 24 carbon atoms. The alkoxy is preferably an alkoxy having 1 to 18 carbon atoms (branched alkoxy having 3 to 18 carbon atoms), more preferably an alkoxy having 1 to 12 carbon atoms (branched alkoxy having 3 to 12 carbon atoms), even more preferably an alkoxy having 1 to 6 carbon atoms (branched alkoxy having 3 to 6 carbon atoms), and particularly preferably an alkoxy having 1 to 4 carbon atoms (branched alkoxy having 3 to 4 carbon atoms).

Specific examples of the alkoxy include methoxy, ethoxy, propoxy, isopropoxy, butoxy, isobutoxy, s-butoxy, t-butoxy, pentyloxy, hexyloxy, heptyloxy, and octyloxy.

The substituted or unsubstituted "aryl", substituted or unsubstituted "heteroaryl", substituted or unsubstituted "diarylamino", substituted or unsubstituted "diheteroarylamino", substituted or unsubstituted "arylheteroarylamino", substituted or unsubstituted "alkyl", substituted or unsubstituted "alkoxy", or substituted or unsubstituted "aryloxy", which is the primary substituent, is such that at least one hydrogen atom thereof may be substituted by a secondary substituent, as it is explained to be substituted or unsubstituted. Examples of this secondary substituent include an aryl, a heteroaryl, and an alkyl, and for the details thereof, reference can be made to the explanations on the monovalent group of the "aryl ring" or "heteroaryl ring" described above and the "alkyl" as the primary substituent. Furthermore, regarding the aryl or heteroaryl as the secondary substituent, an aryl or heteroaryl in which at least one hydrogen atom thereof has been substituted by an aryl such as phenyl (specific examples are described above), or an alkyl such as methyl (specific examples are described above), is also included in the aryl or heteroaryl as the secondary substituent. For instance, when the secondary substituent is a carbazolyl group, a carbazolyl group in which at least one hydrogen atom at the 9-position has been substituted by an aryl such as phenyl, or an alkyl such as methyl, is also included in the heteroaryl as the secondary substituent.

Furthermore, regarding the alkyl or alkoxy for R¹ to R¹¹, reference can be made to the explanation on the "alkyl" or "alkoxy" as the primary substituent in the explanation of the general formula (2). In addition, the same also applies to the aryl, heteroaryl or alkyl as the substituent for these groups. Furthermore, the same also applies to the heteroaryl, diarylamino, diheteroarylamino, arylheteroarylamino, alkyl, alkoxy or aryloxy in the case of forming an aryl ring or a heteroaryl ring by bonding between adjacent groups among R¹ to R¹¹ together with the ring a, ring b or ring c, and the aryl, heteroaryl or alkyl as the further substituent.

R of the moieties Si-R and Ge-R for Y¹ in the general formula (2) represents an aryl or an alkyl, and examples of this aryl or alkyl include those described above. Particularly, an aryl having 6 to 10 carbon atoms (for example, phenyl or naphthyl), and an alkyl having 1 to 4 carbon atoms (for example, methyl or ethyl) are preferred. This explanation also applies to Y¹ for the general formula (2).

R of the moiety N-R for X¹ and X² of the general formula (2) represents an aryl, a heteroaryl or an alkyl, both of which may be substituted by the secondary substituents described above, and at least one hydrogen in the aryl or heteroaryl may be substituted by, for example, an alkyl. Examples of this aryl, heteroaryl or alkyl include those described above. Particularly, an aryl having 6 to 10 carbon atoms (for example, phenyl or naphthyl), a heteroaryl having 2 to 15 carbon atoms (for example, carbazolyl), and an alkyl having 1 to 4 carbon atoms (for example, methyl or ethyl) are preferred. This explanation also applies to X¹ and X² in the general formula (2) .

R of the moiety "-C(-R)₂-" as a linking group for the general formula (2) represents a hydrogen atom or an alkyl, and examples of this alkyl include those described above. Particularly, an alkyl having 1 to 4 carbon atoms (for example, methyl or ethyl) is preferred. This explanation also applies to "-C(-R)₂-" as a linking group for general formula (2).

Furthermore, the invention of the present application is an oligomer of a polycyclic aromatic compound having plural unit structures each represented by general formula (2), and preferably an oligomer of a polycyclic aromatic compound having plural unit structures each represented by general formula (2) . The oligomer is preferably a dimer to a hexamer, more preferably a dimer to a trimer, and a particularly preferably a dimer. The oligomer may be in a form having a plural number of the unit structures described above in one compound, and for example, the oligomer may be in a form in which a plural number of the unit structures are linked via a linking group such as a single bond, an alkylene group having 1 to 3 carbon atoms, a phenylene group, or a naphthylene group, as well as a form in which a plural number of the unit structures are linked such that any ring contained in the unit structure (ring a, ring b or ring c) is shared by the plural unit structures, or may be in a form in which the unit structures are linked such that any rings contained in the unit structures (ring a, ring b or ring c) are fused.

Examples of such an oligomer include oligomer compounds represented by the following formula (2-4), formula (2-4-1), formula (2-4-2), formula (2-5-1) to formula (2-5-4), and formula (2-6). An oligomer compound represented by the following formula (2-4) corresponds to, for example, a compound represented by formula (1-21) described below. That is, to explain this in view of general formula (2), the oligomer is an oligomer compound in which plural unit structures each represented by general formula (2) are carried in one compound such that a benzene ring as ring a is shared. Furthermore, an oligomer compound represented by the following formula (2-4-1) corresponds to, for example, a compound represented by the following formula (1-2665) . That is, to explain this in view of general formula (2), the oligomer compound is an oligomer compound in which two unit structures represented by general formula (2) are carried in one compound such that a benzene ring as ring a is shared. Furthermore, an oligomer compound represented by the following formula (2-4-2) corresponds to, for example, a compound represented by the following formula (1-2666) . That is, to explain this in view of general formula (2), the oligomer compound is an oligomer compound in which two unit structures represented by general formula (2) are carried in one compound such that a benzene ring as ring a is shared. Furthermore, oligomer compounds represented by the following formula (2-5-1) to formula (2-5-4) correspond to, for example, compounds represented by the following formulas (1-22) to (1-25). That is, to explain this in view of general formula (2), such an oligomer is an oligomer compound in which plural unit structures each represented by general formula (2) are carried in one compound such that a benzene ring as ring b (or ring c) is shared. Furthermore, an oligomer compound represented by the following formula (2-6) corresponds to, for example, a compound represented by any one of the following formulas (1-31) to (1-37). That is, to explain this in view of general formula (2), for example, the oligomer is an oligomer compound in which plural unit structures each represented by general formula (2) are carried out in one compound such that a benzene ring as ring b (or ring a or ring c) of a certain unit structure and a benzene ring as ring b (or ring a or ring c) are fused.

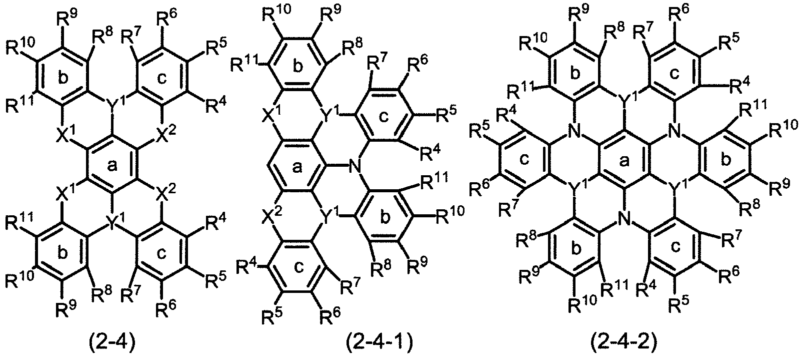

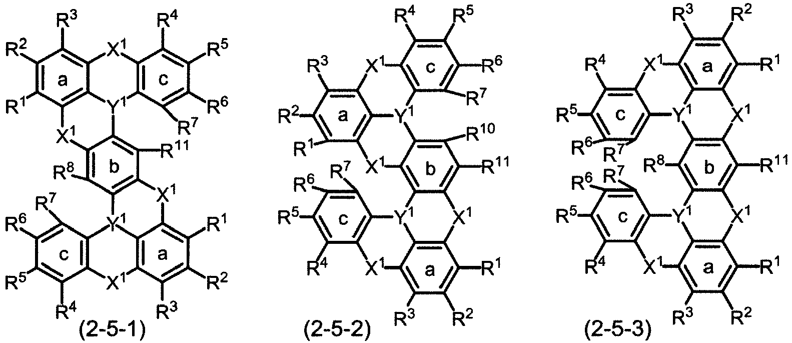

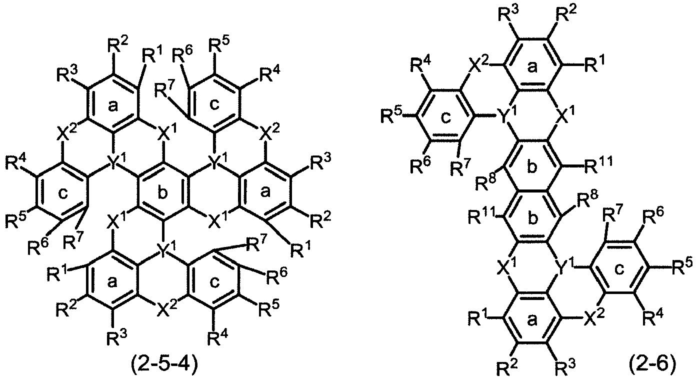

The oligomer compound may be an oligomer in which an oligomer form represented by formula (2-4), formula (2-4-1) or formula (2-4-2) and an oligomer form represented by any one of formula (2-5-1) to formula (2-5-4) or formula (2-6) are combined; may be an oligomer in which an oligomer form represented by any one of formula (2-5-1) to formula (2-5-4) and an oligomer form represented by formula (2-6) are combined; or may be an oligomer in which an oligomer form represented by formula (2-4), formula (2-4-1) or formula (2-4-2), an oligomer form represented by any one of formula (2-5-1) to formula (2-5-4), and an oligomer form represented by formula (2-6) are combined.

Furthermore, all or a portion of the hydrogen atoms in the chemical structures of the polycyclic aromatic compound represented by general formula (2) and an oligomer thereof may be deuterium atoms.

Also, all or a portion of the hydrogen atoms in the chemical structures of the polycyclic aromatic compound represented by general formula (2) and an oligomer thereof may be halogen atoms. For example, in regard to formula (2), the hydrogen atoms in the ring a, ring b, ring c (ring a to ring c are aryl rings), substituents of the ring a to ring c, R (= alkyl or aryl) when Y¹ represents Si-R or Ge-R, and R (= alkyl or aryl) when X¹ and X² each represent N-R, may be substituted by halogen atoms, and among these, a form in which all or a portion of the hydrogen atoms in the aryl or heteroaryl have been substituted by halogen atoms may be mentioned. A halogen is fluorine, chlorine, bromine or iodine, and a halogen is preferably fluorine, chlorine or bromine, and more preferably chlorine.

Furthermore, the polycyclic aromatic compound related to the present invention and oligomers thereof can be used as materials for organic devices. Examples of the organic devices include an organic electroluminescent element, an organic field effect transistor, or an organic thin film solar cell. Particularly, in regard to an organic electroluminescent element, a compound in which Y¹ represents B; and X¹ and X² each represent N-R, a compound in which Y¹ represents B; X¹ represents O; and X² represents N-R, and a compound in which Y¹ represents B; and X¹ and X² each represent O, are preferred as dopant materials for the light emitting layer. Also, a compound in which Y¹ represents B; X¹ represents O; and X² represents N-R, and a compound in which Y¹ represents B; and X¹ and X² each represent O are preferred as host materials for the light emitting layer, and a compound in which Y¹ represents B; and X¹ and X² each represent O, and a compound in which Y¹ represents P=O; and X¹ and X² each represent O are preferably used as electron transport materials.

More specific examples of the polycyclic aromatic compound of the present invention and oligomers thereof include, for example, compounds represented by the following formulas (1-1) to (1-479), compounds represented by the following formulas (1-1001) to (1-1159), (1-1201) to (1-1211), (1-1271) to (1-1274), compounds represented by the following formulas (1-1301) to (1-1311), compounds represented by the following formulas (1-1351) to (1-1361), and compounds represented by the following formulas (1-1401) to (1-1460).

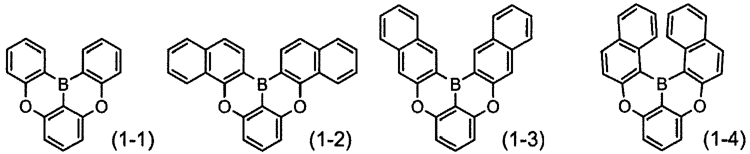

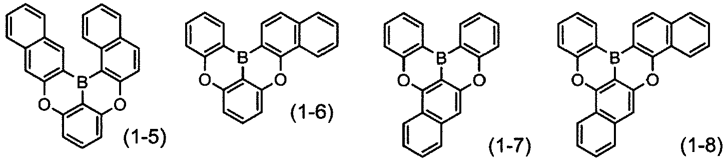

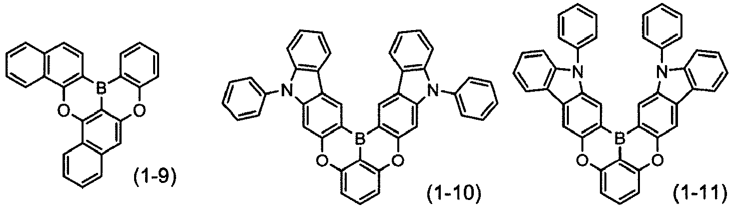

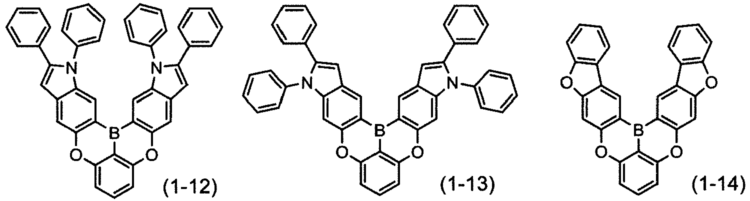

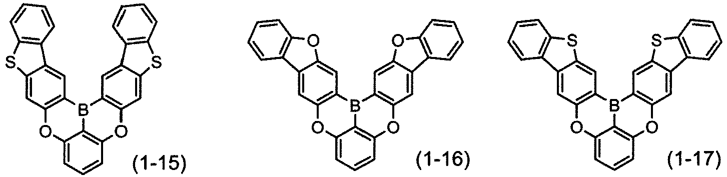

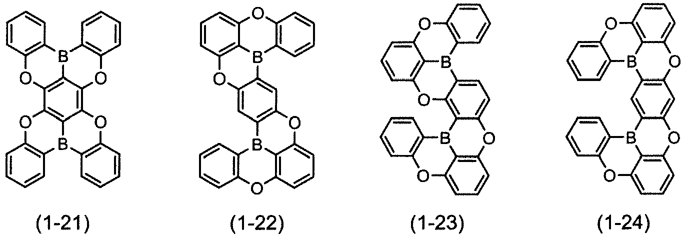

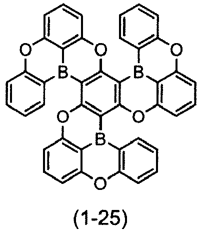

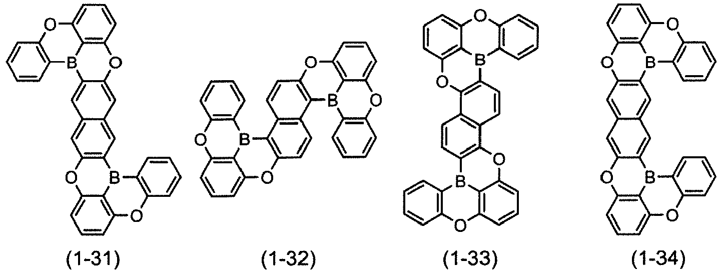

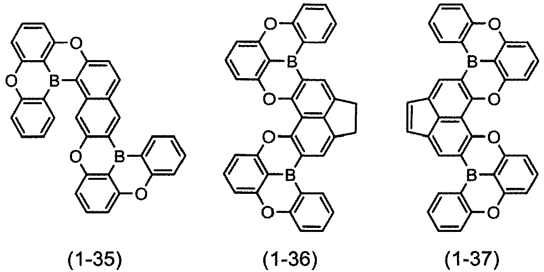

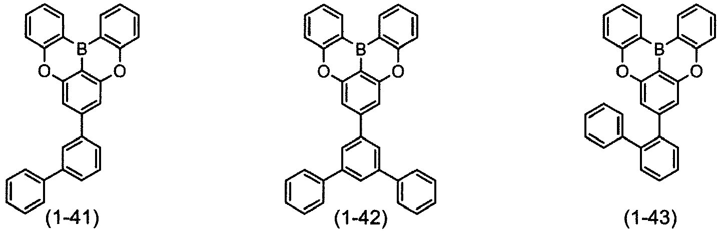

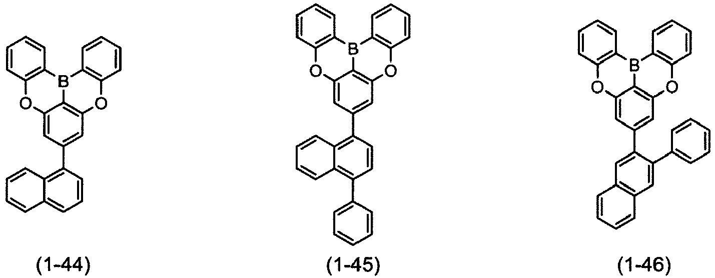

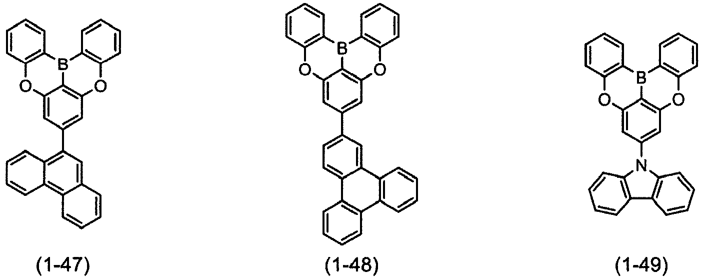

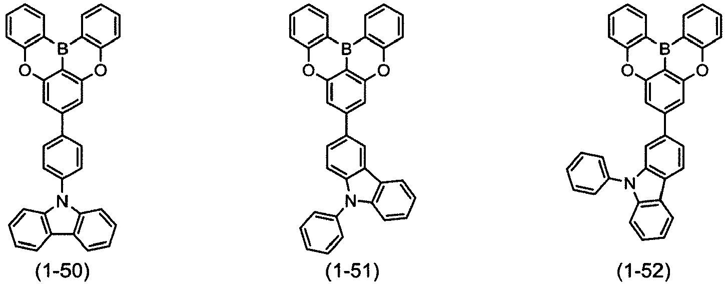

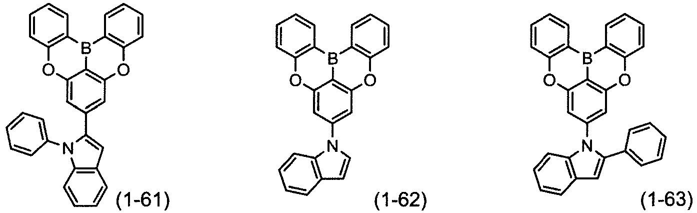

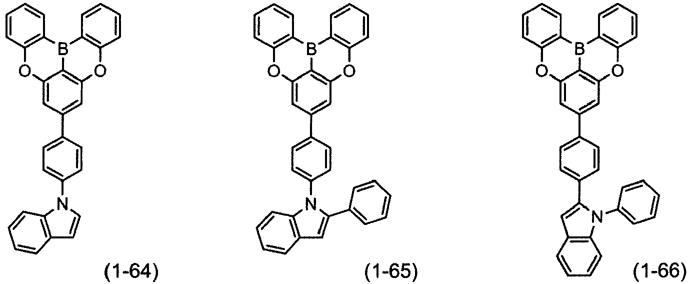

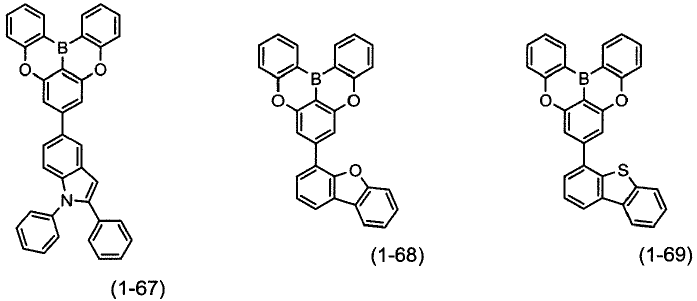

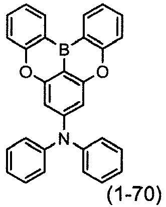

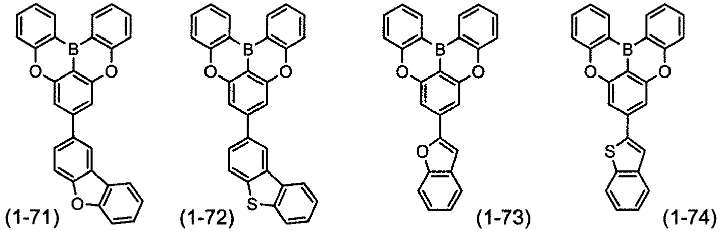

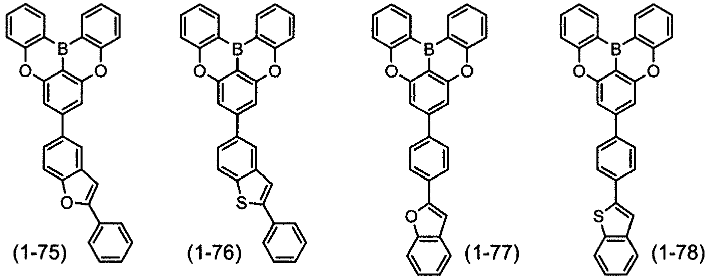

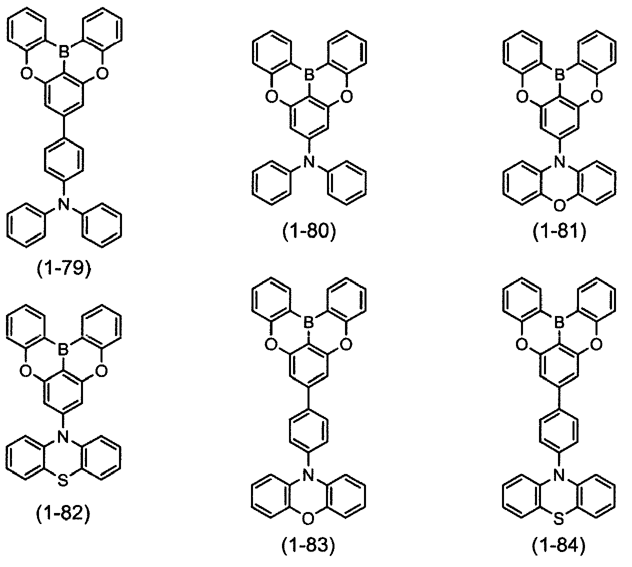

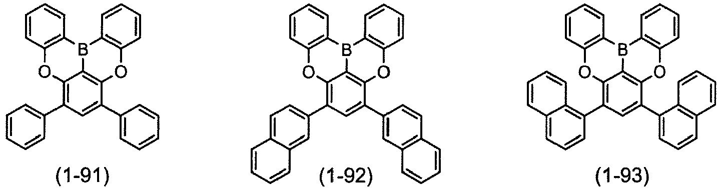

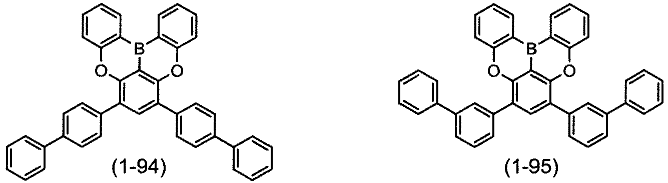

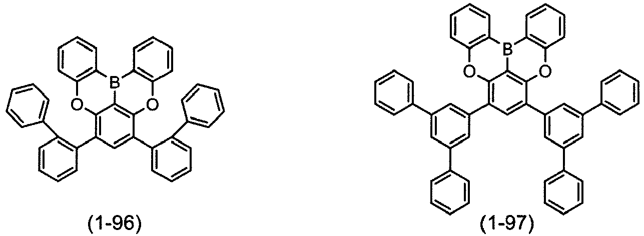

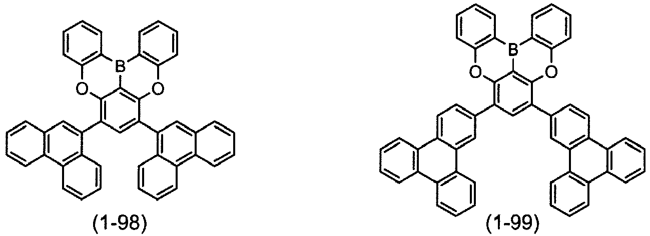

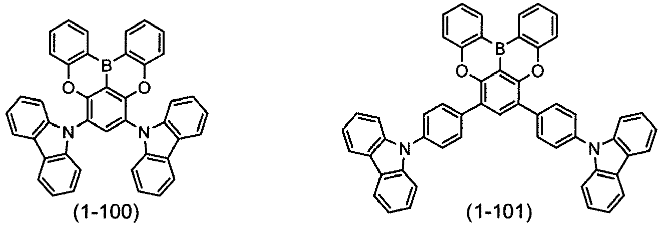

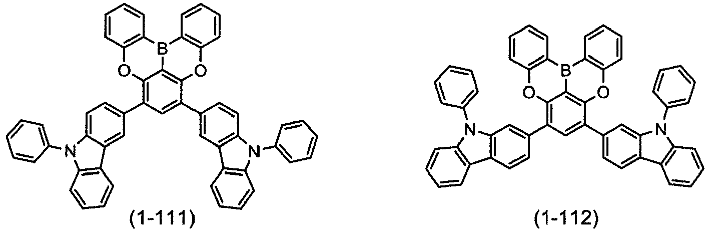

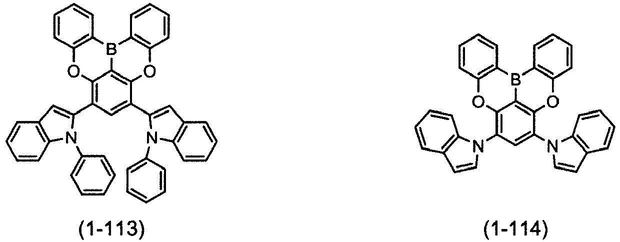

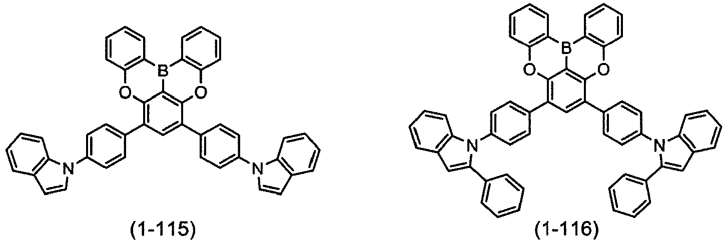

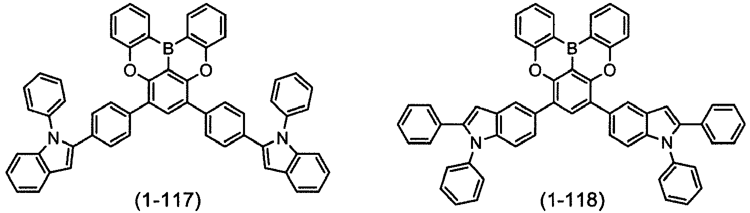

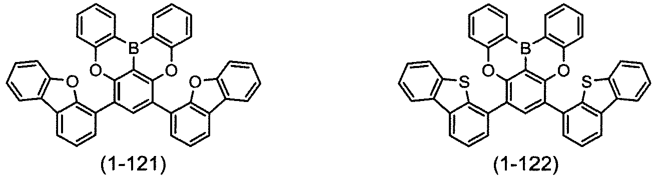

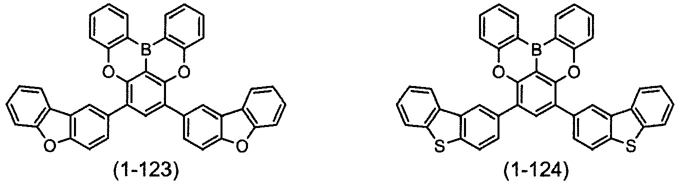

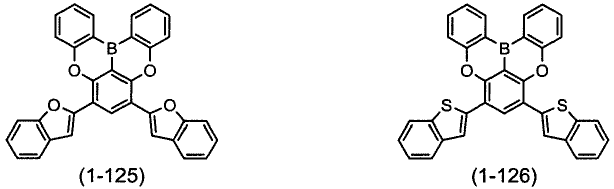

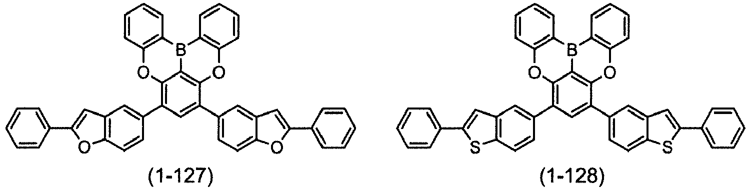

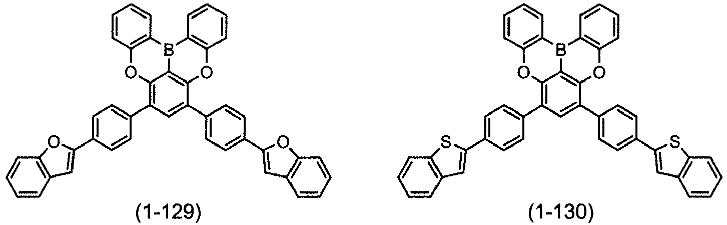

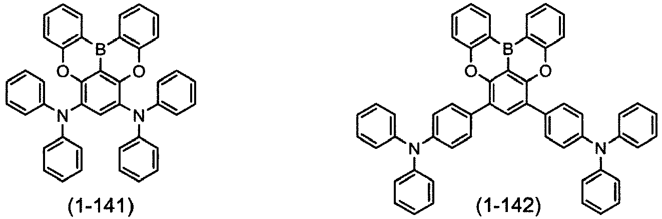

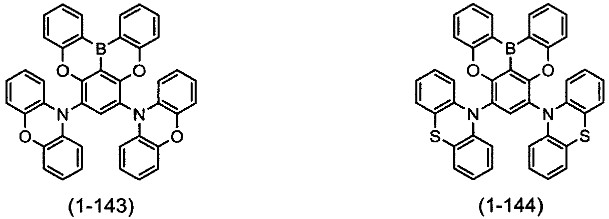

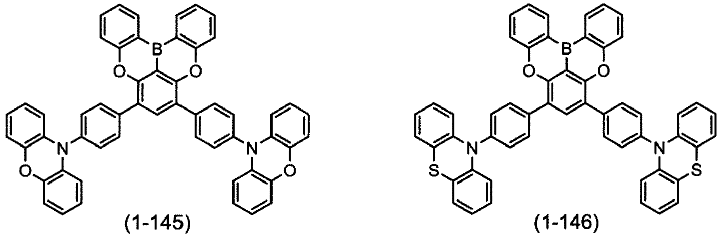

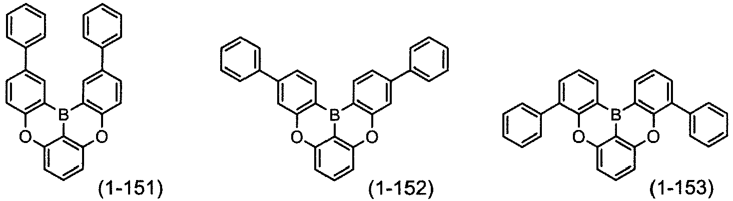

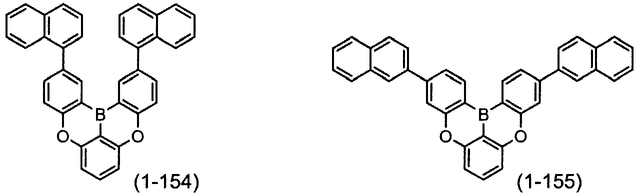

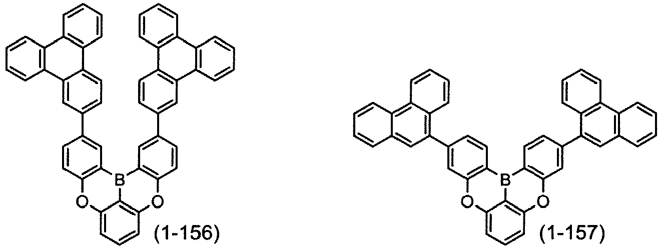

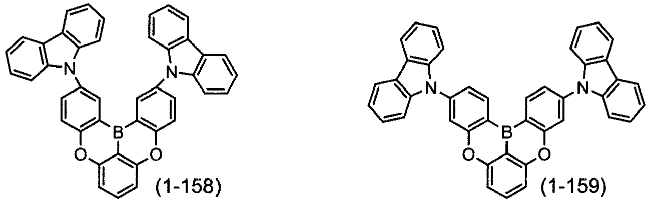

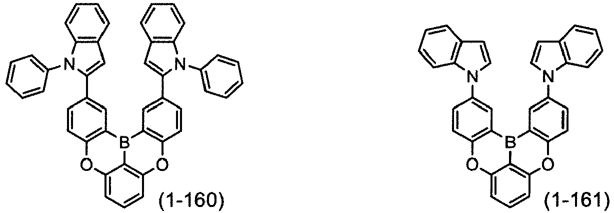

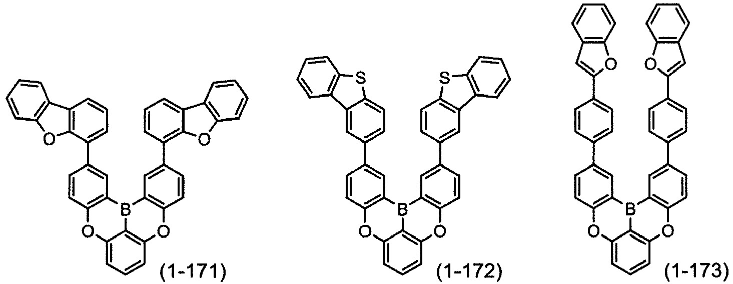

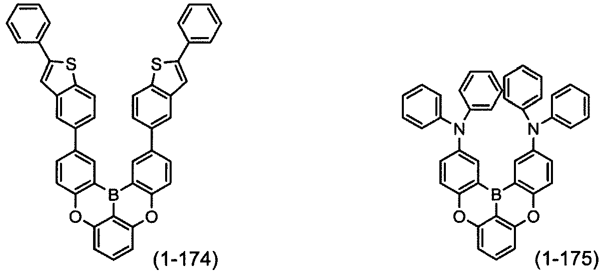

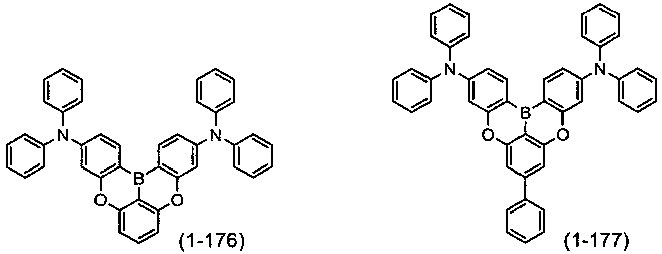

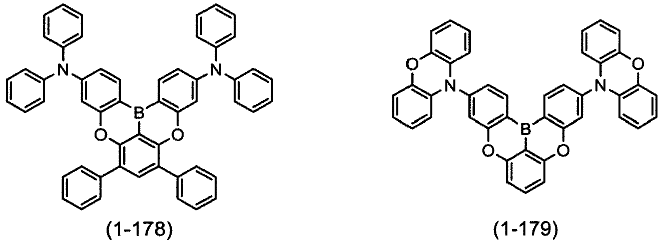

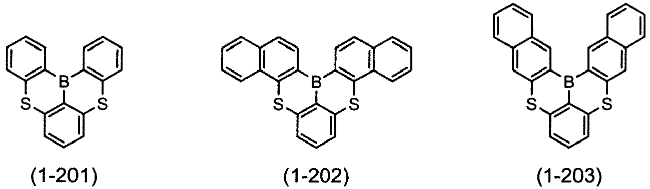

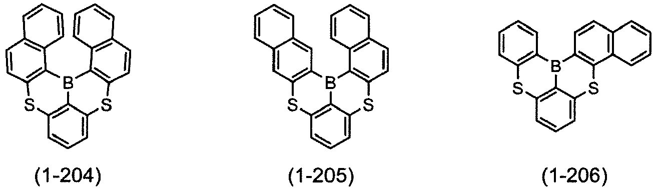

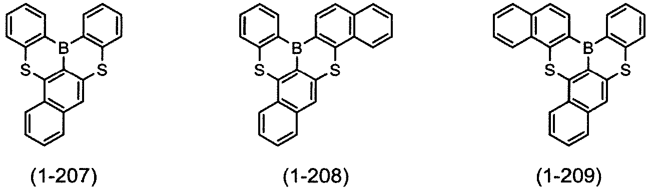

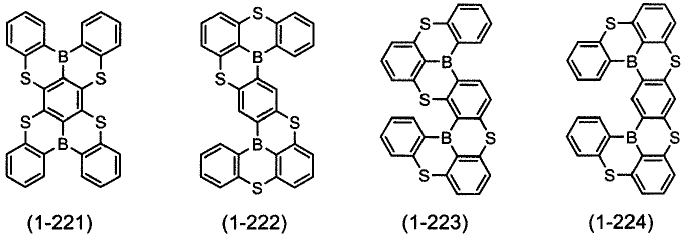

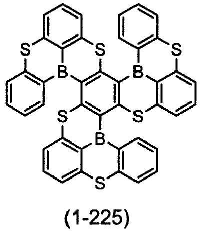

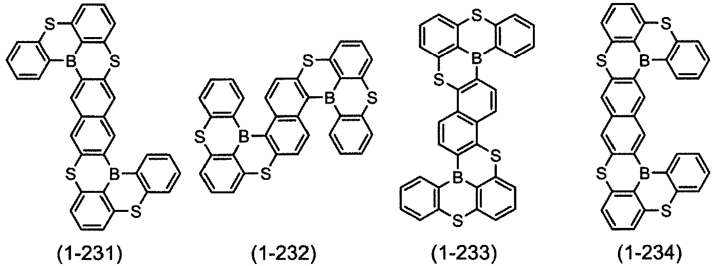

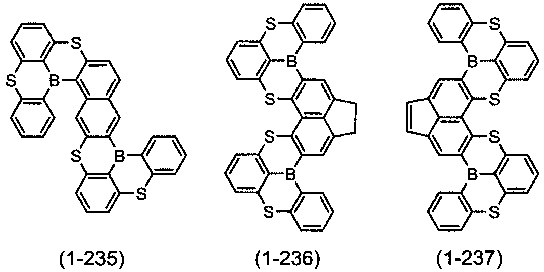

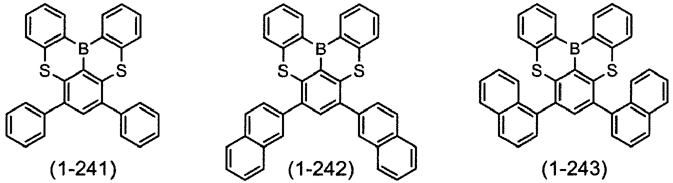

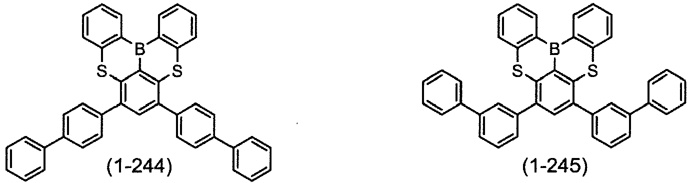

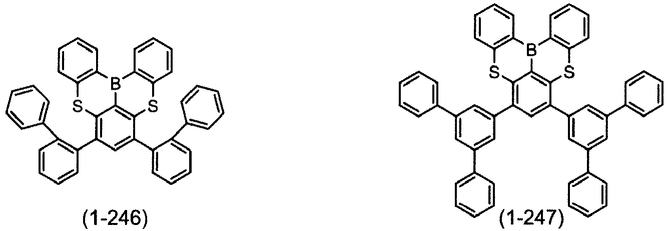

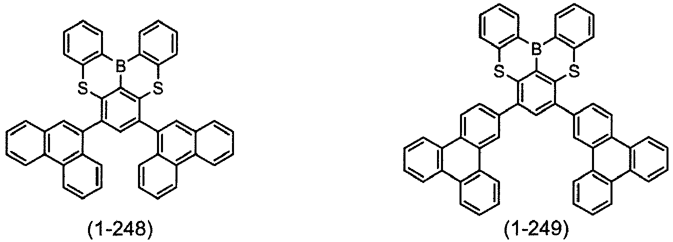

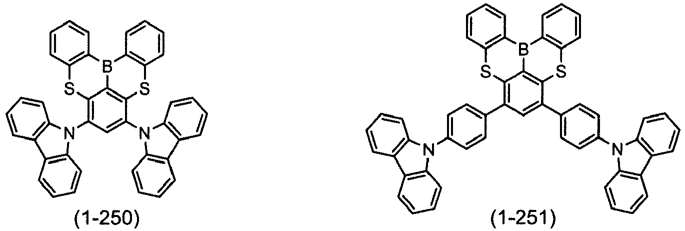

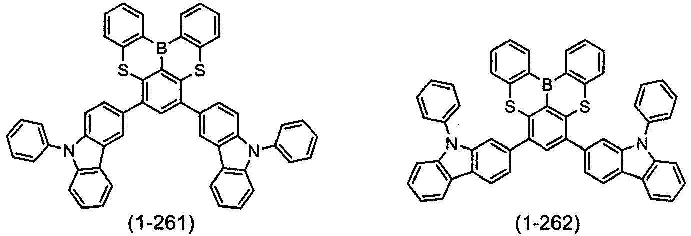

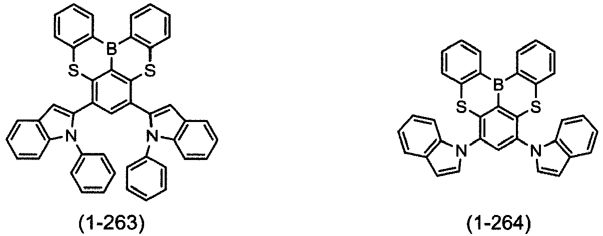

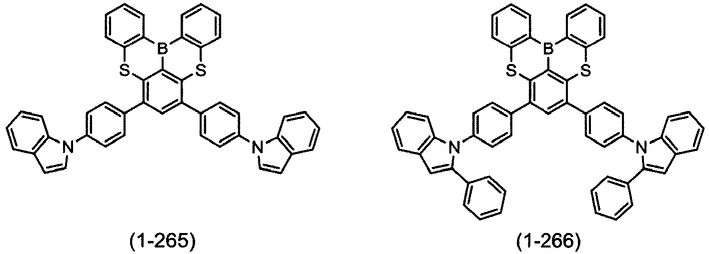

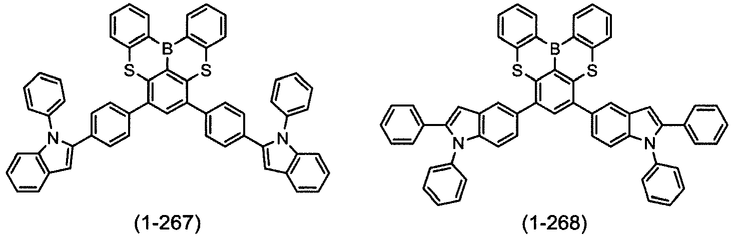

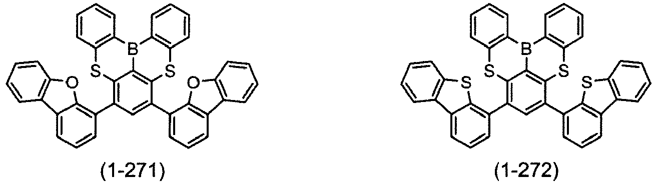

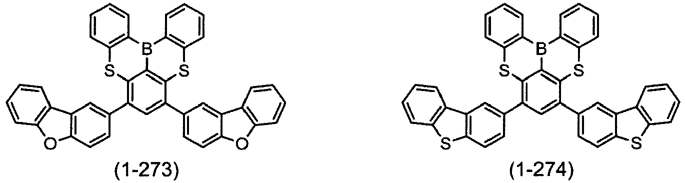

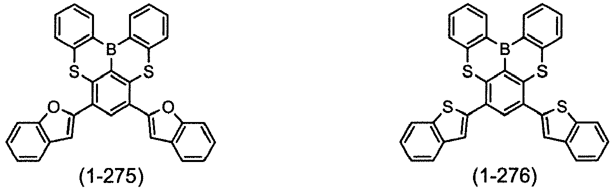

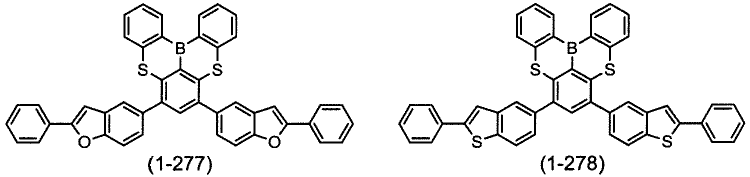

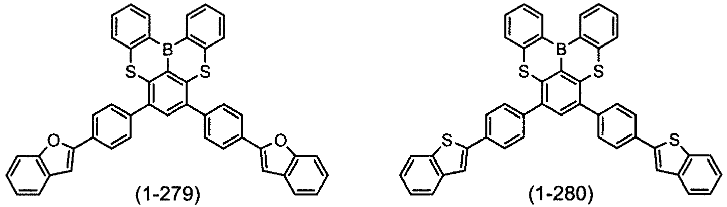

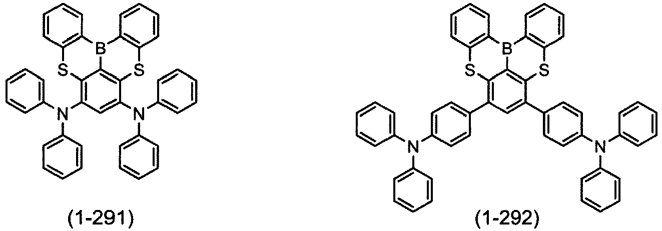

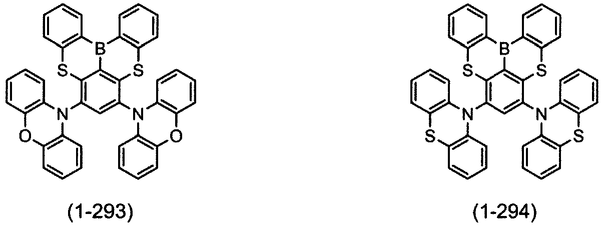

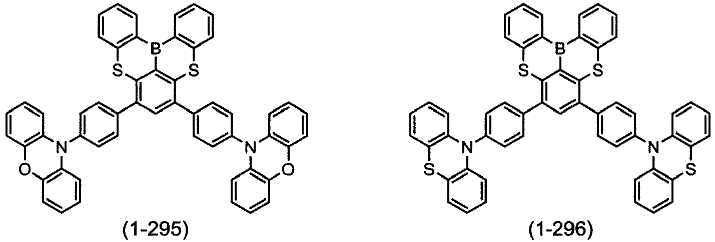

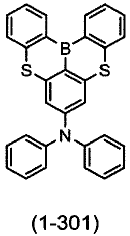

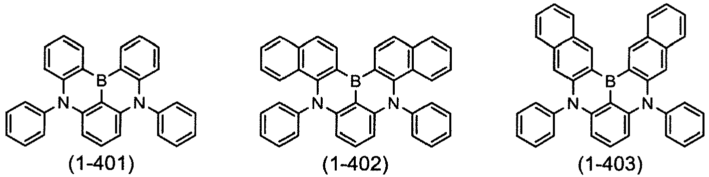

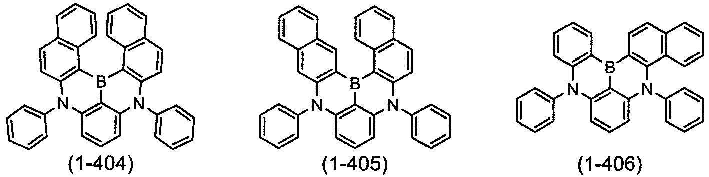

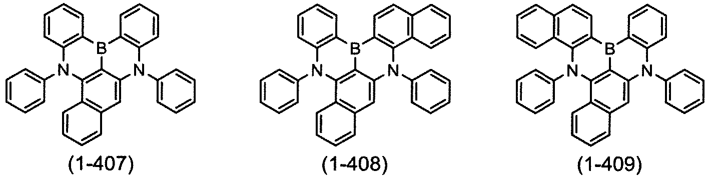

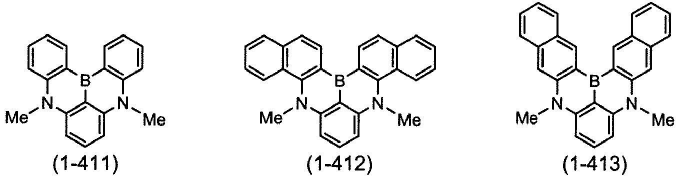

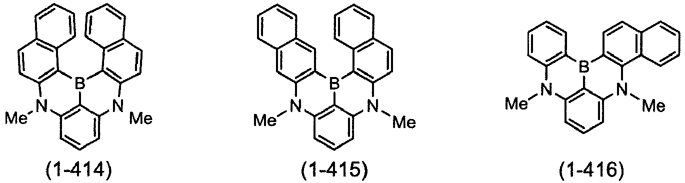

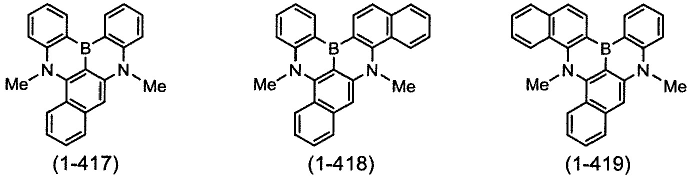

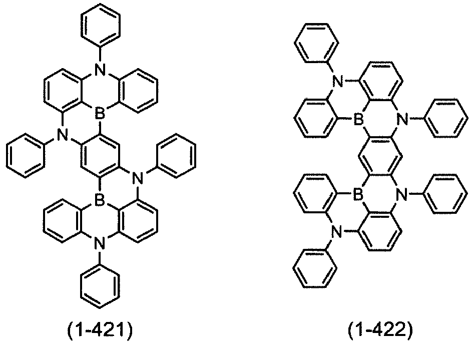

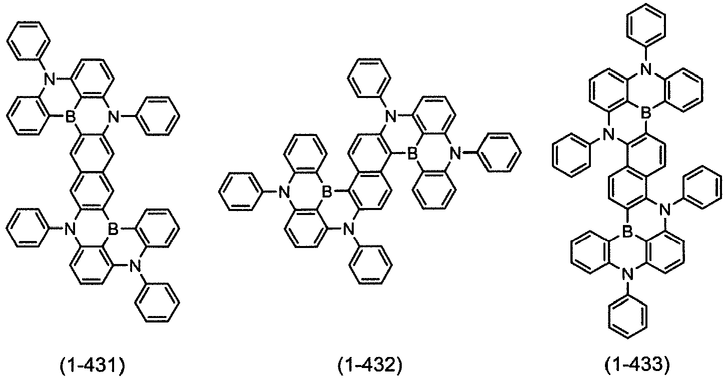

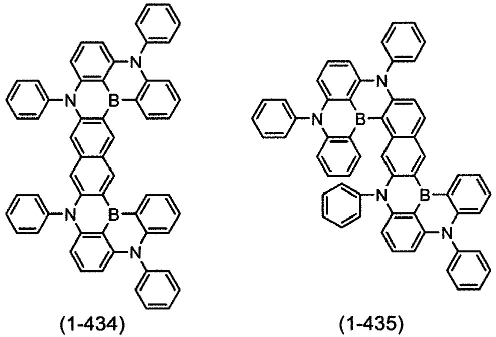

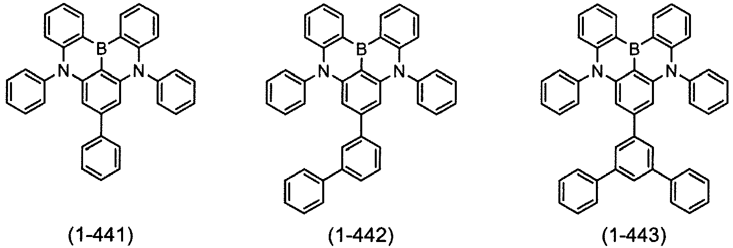

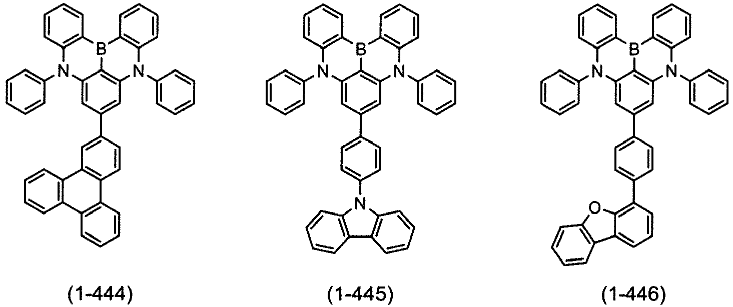

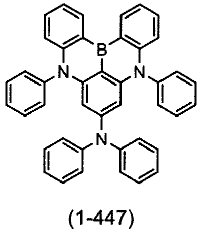

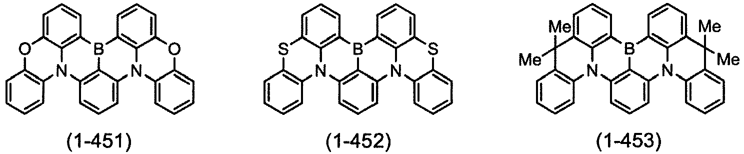

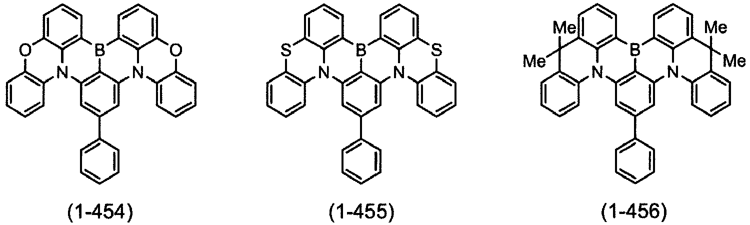

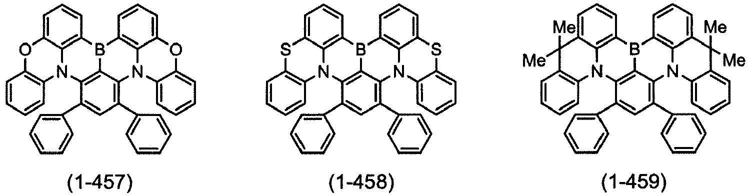

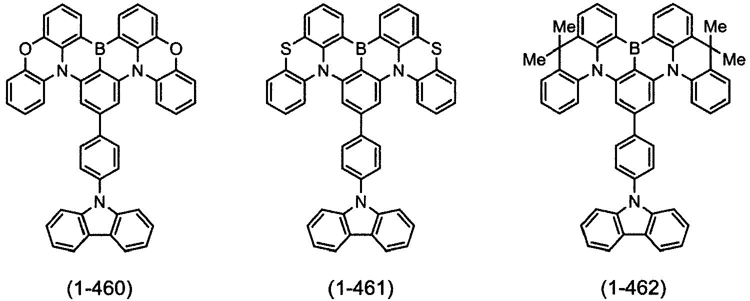

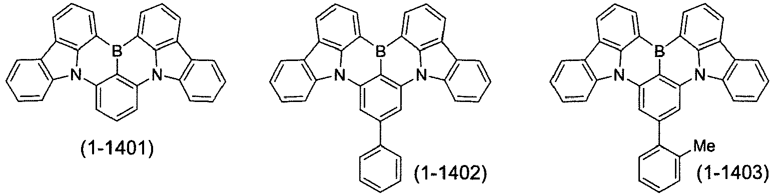

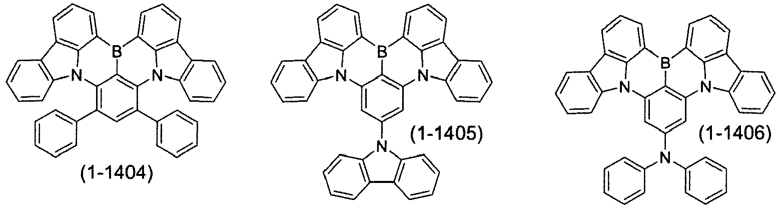

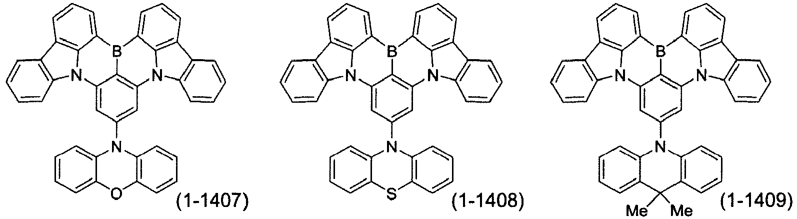

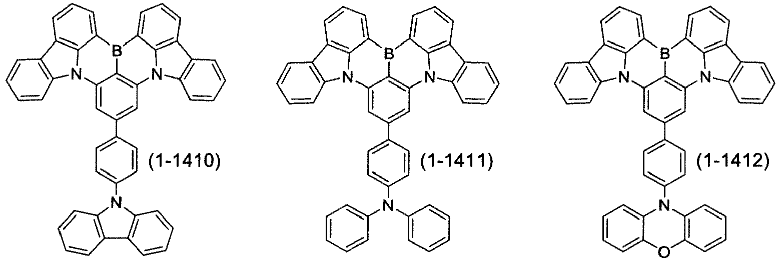

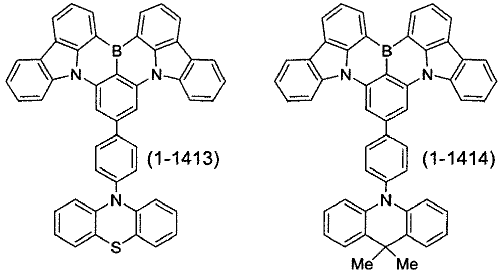

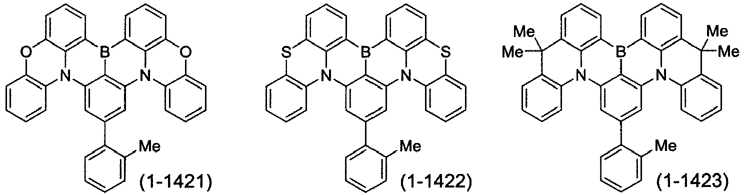

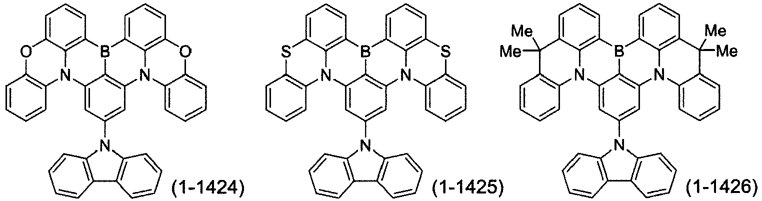

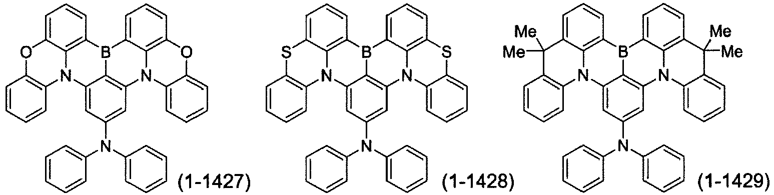

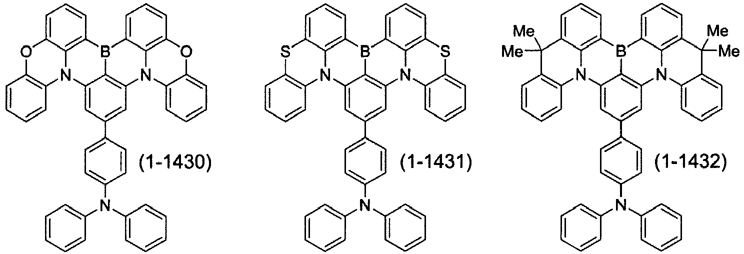

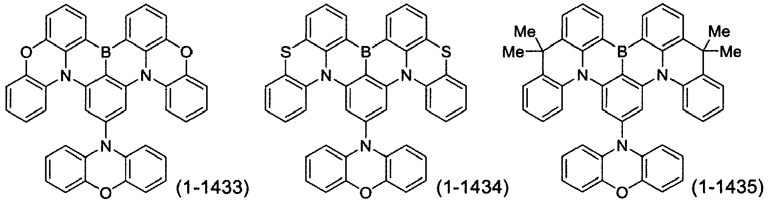

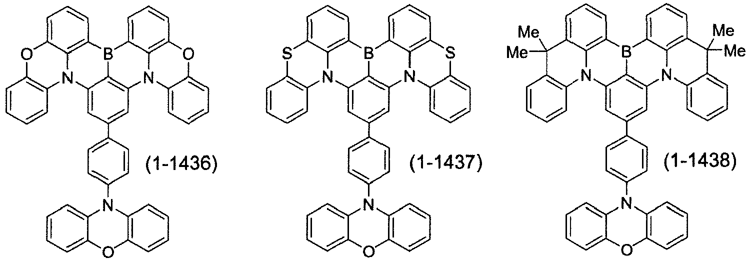

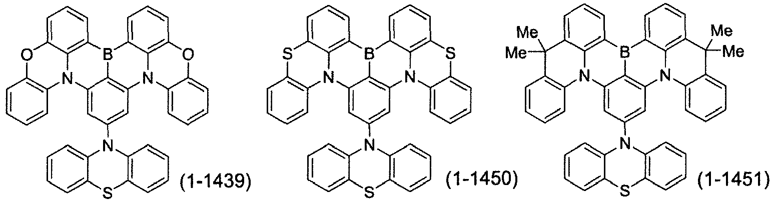

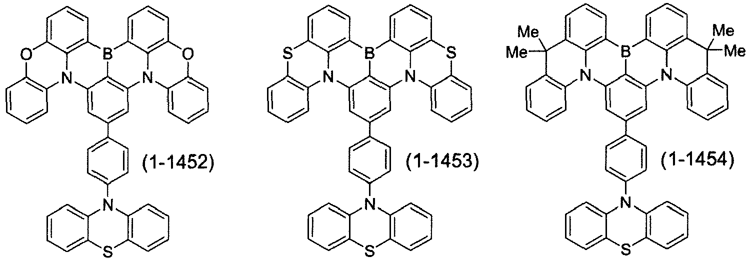

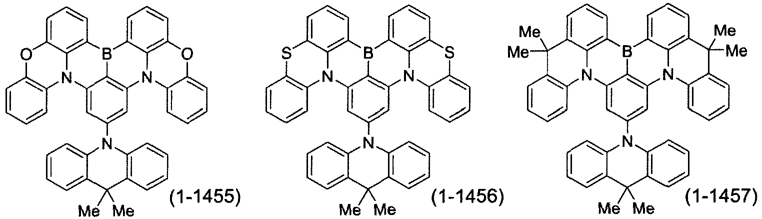

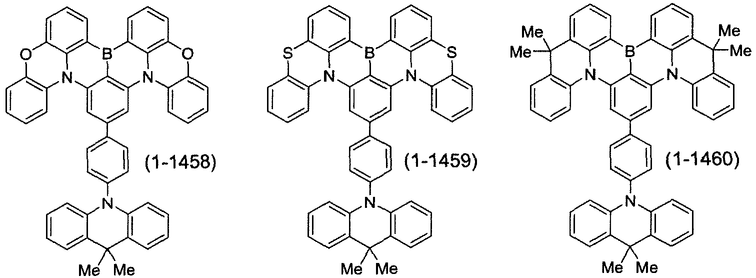

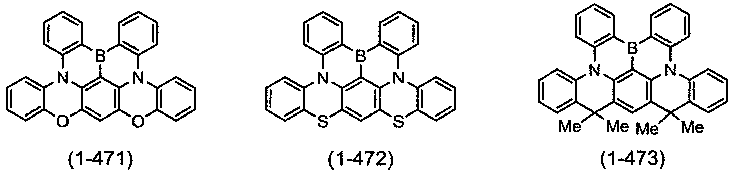

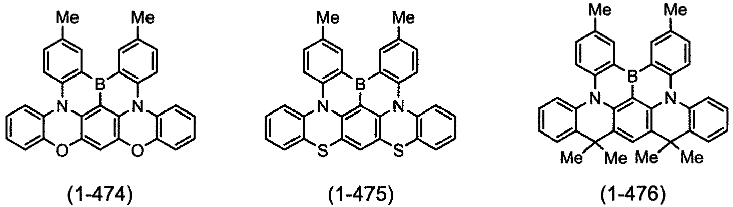

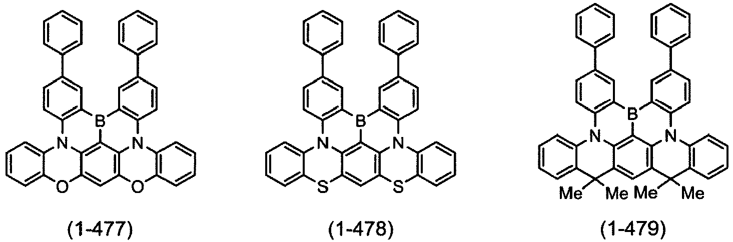

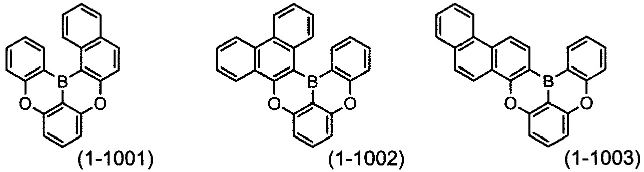

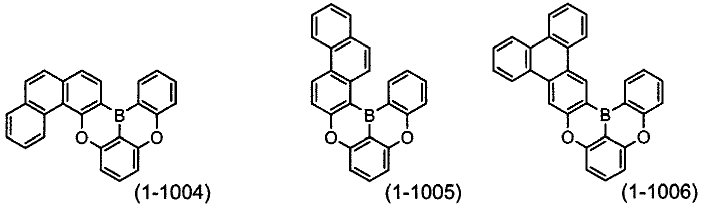

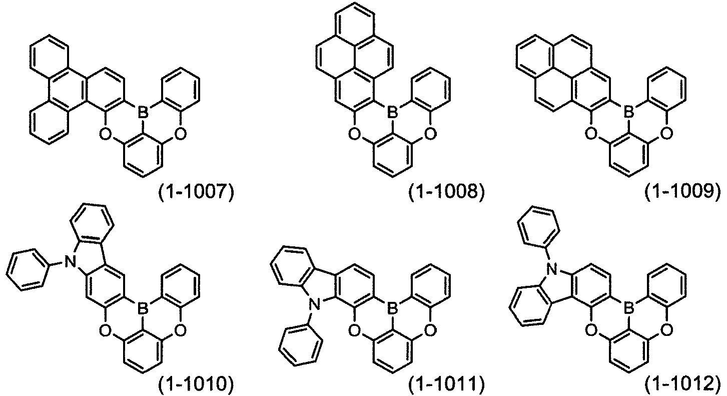

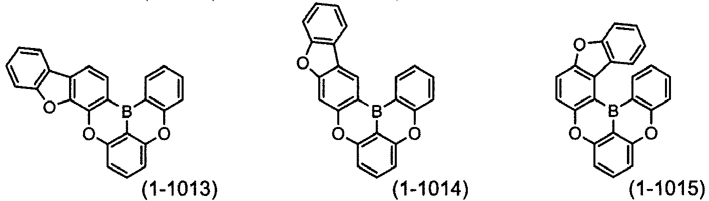

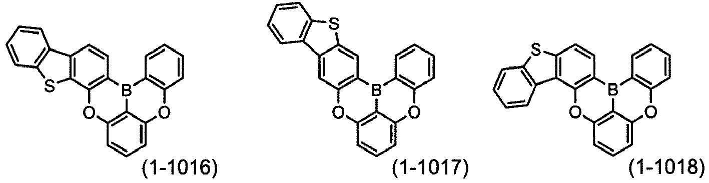

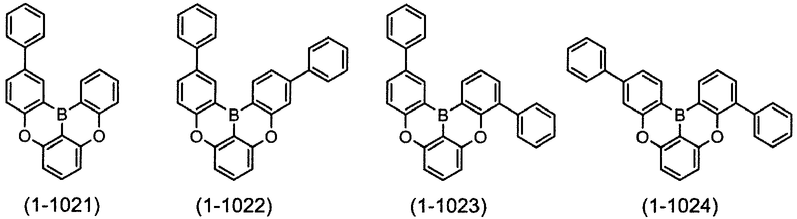

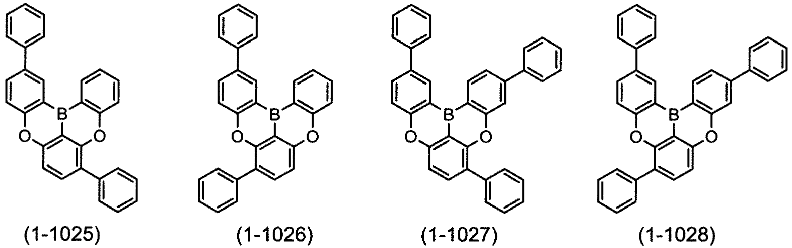

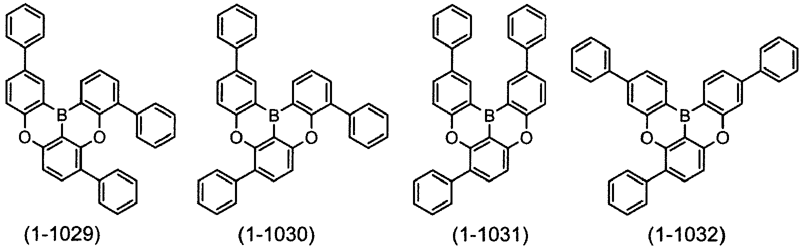

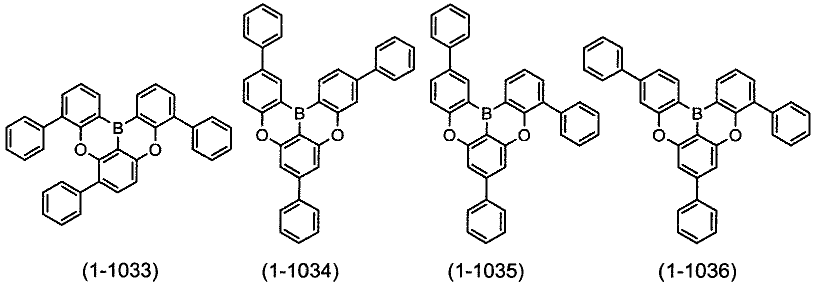

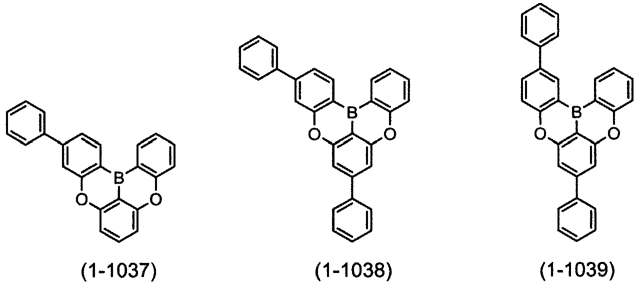

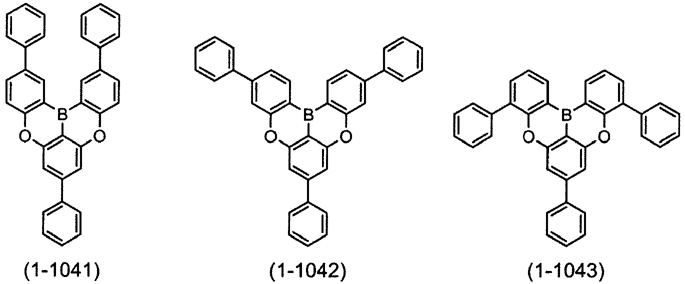

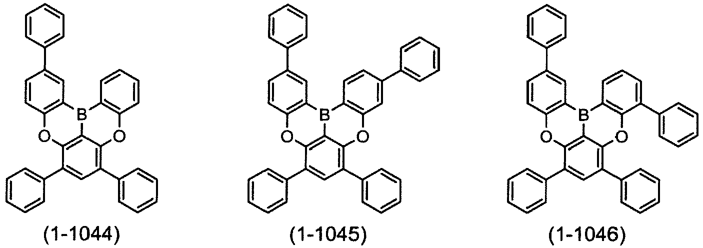

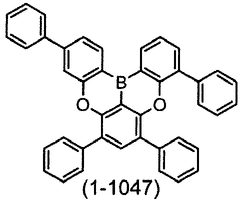

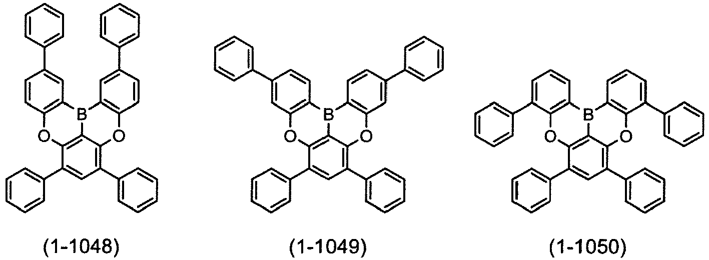

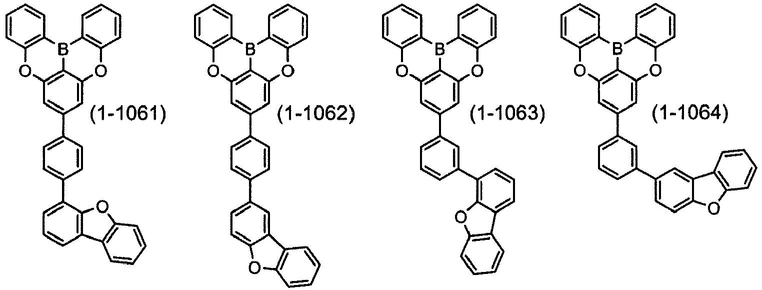

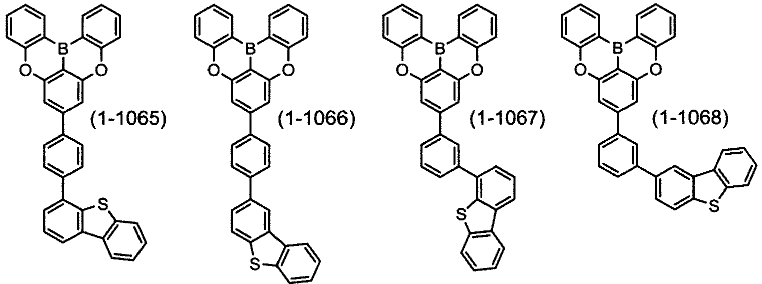

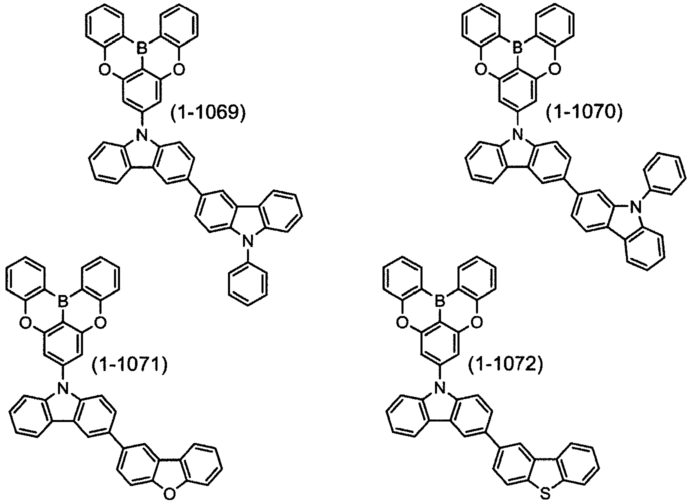

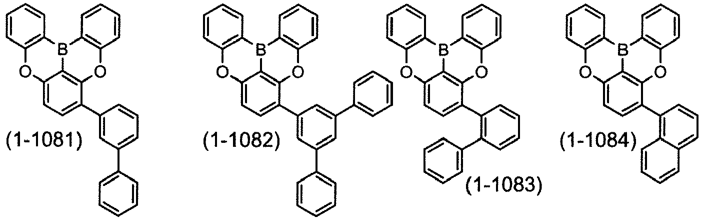

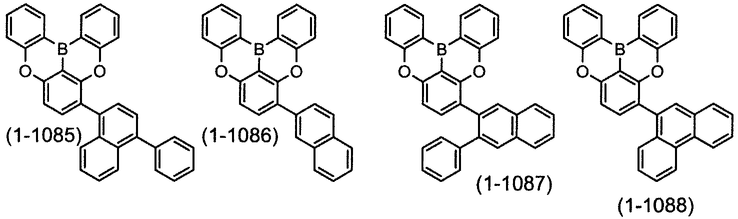

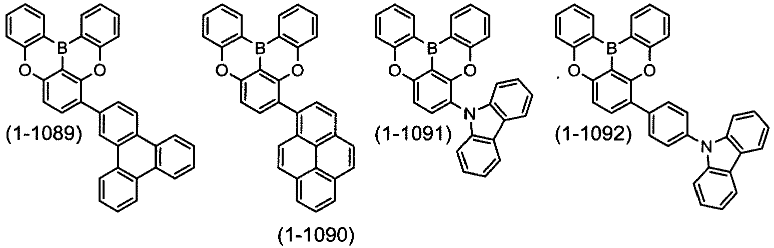

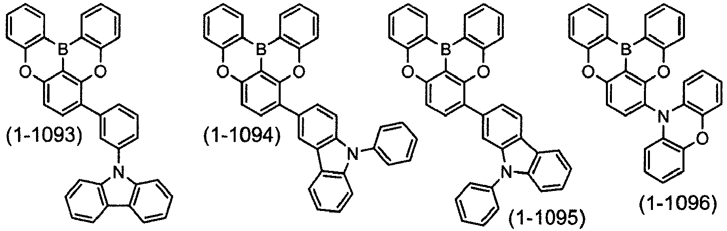

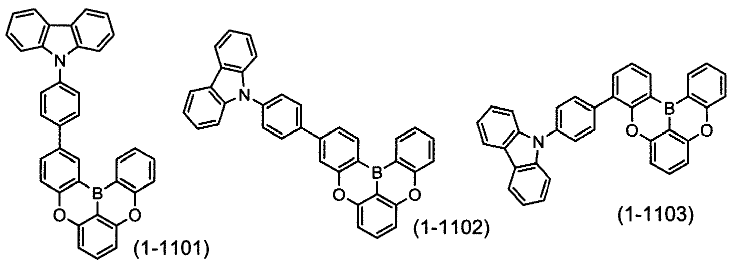

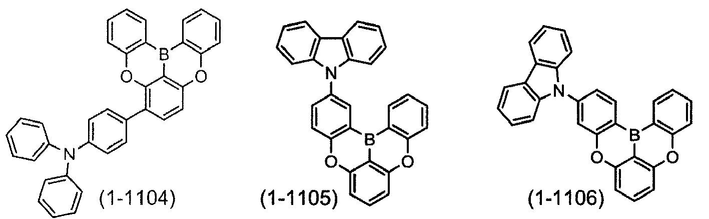

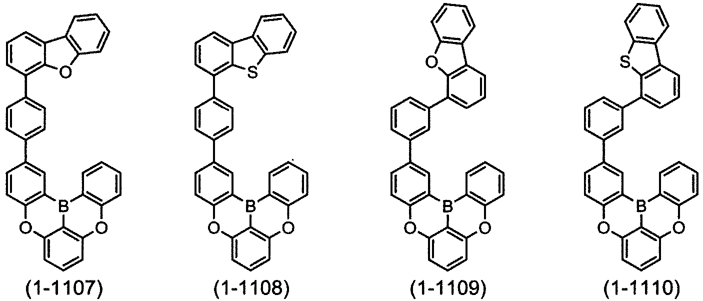

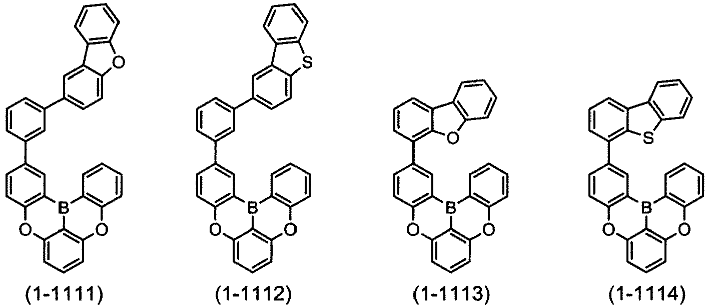

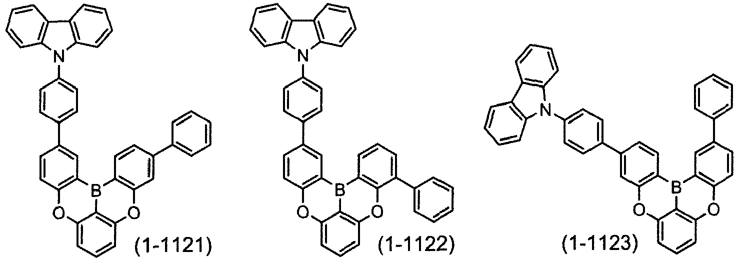

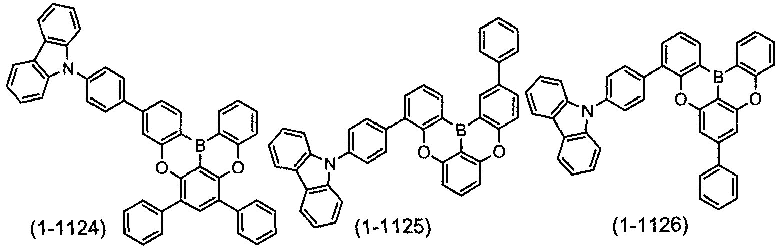

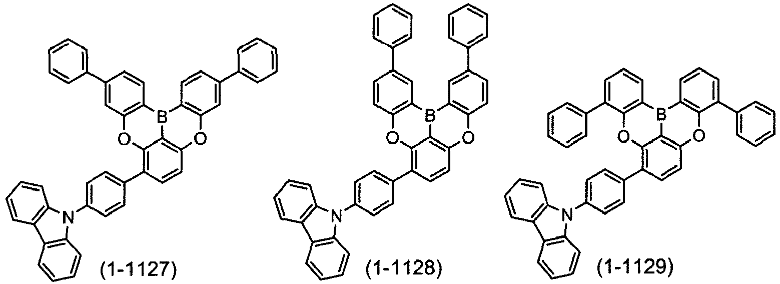

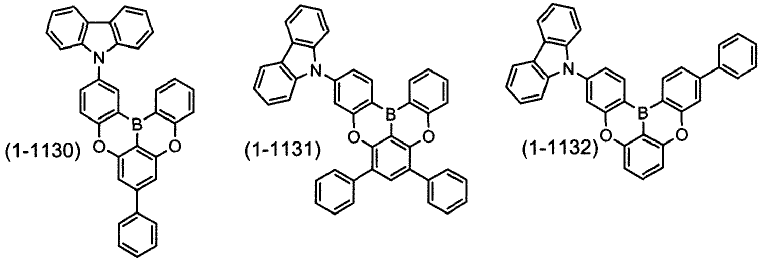

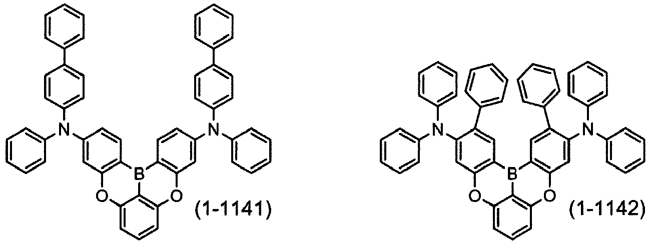

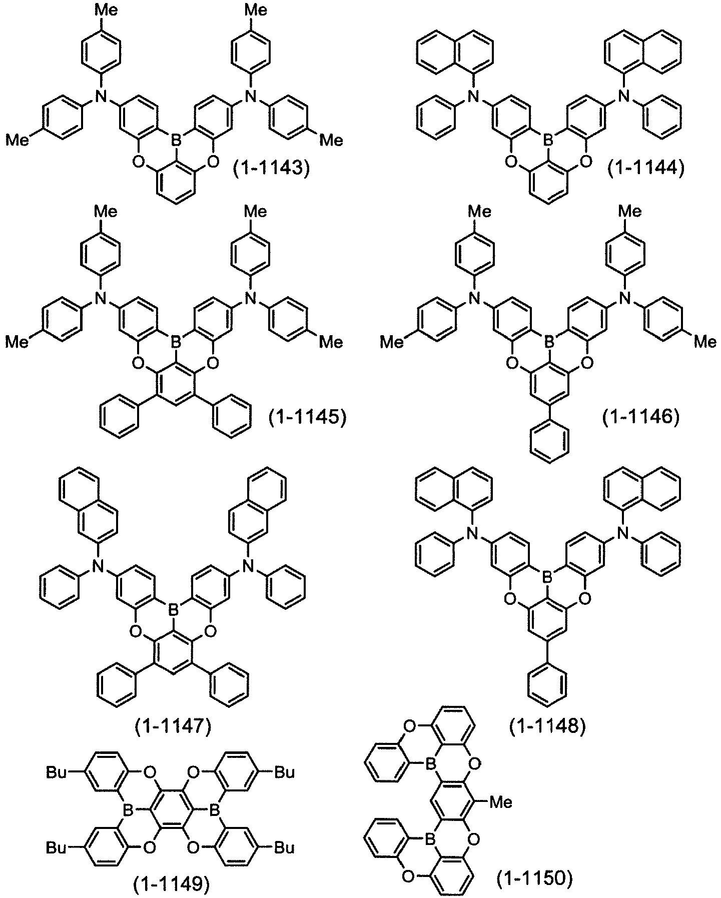

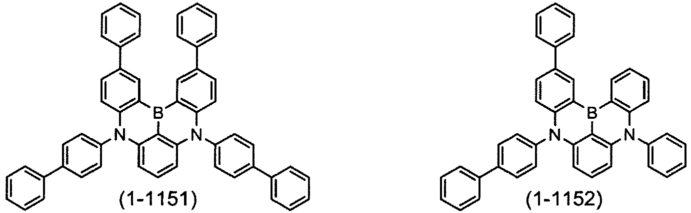

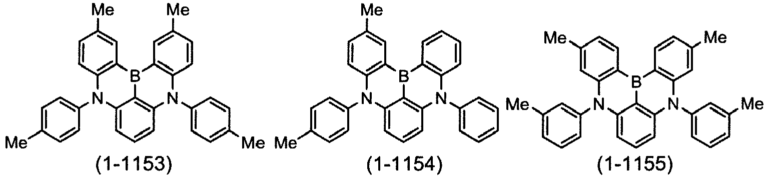

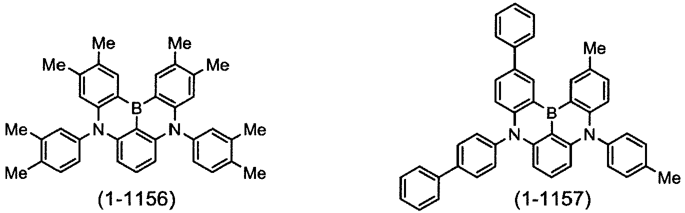

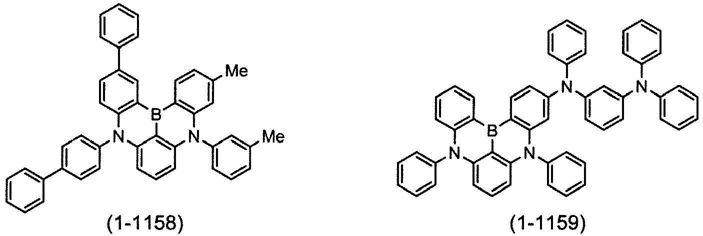

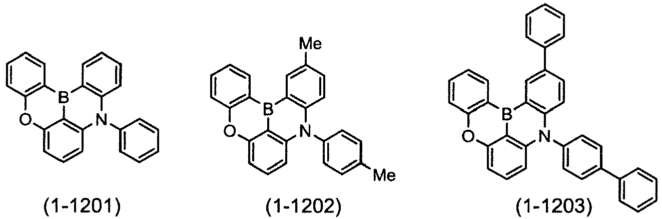

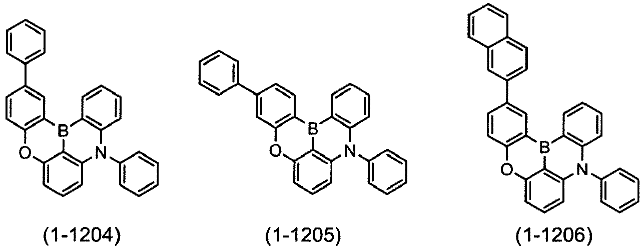

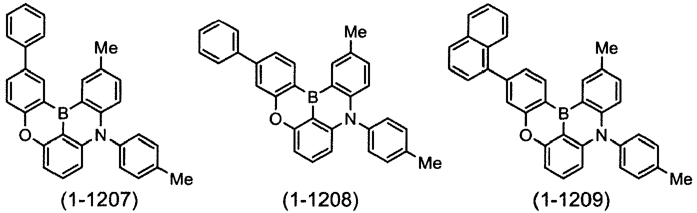

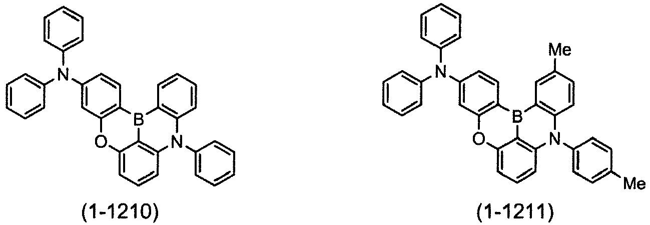

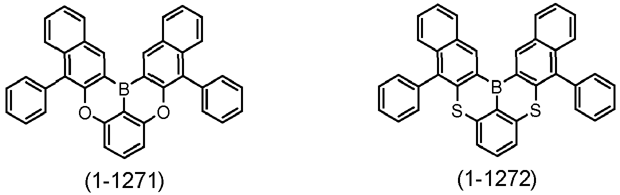

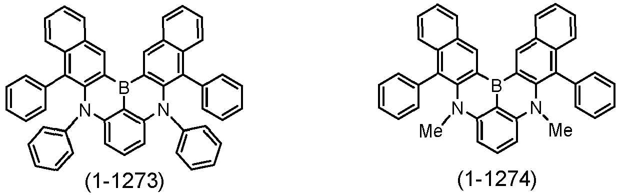

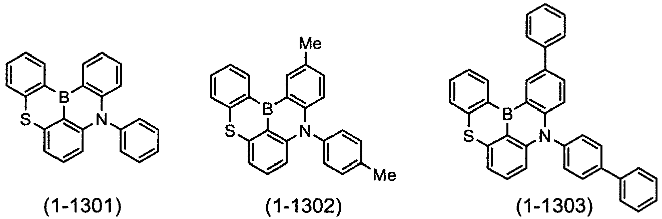

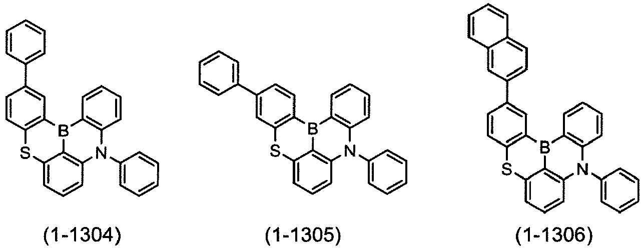

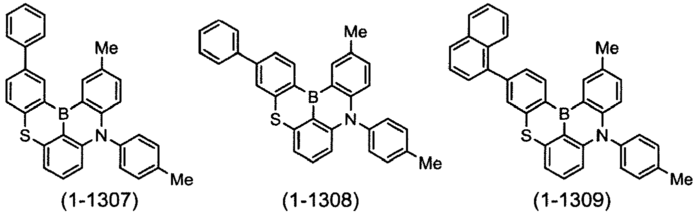

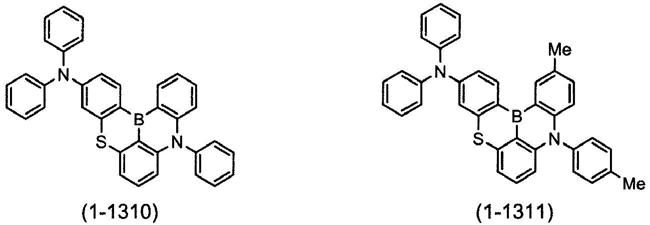

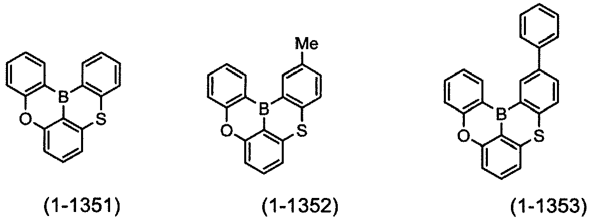

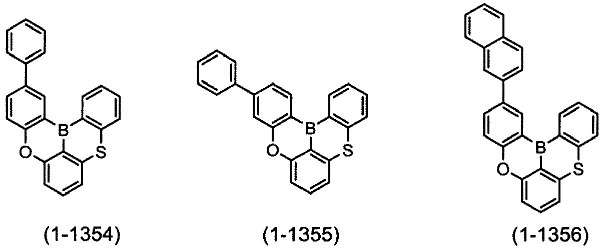

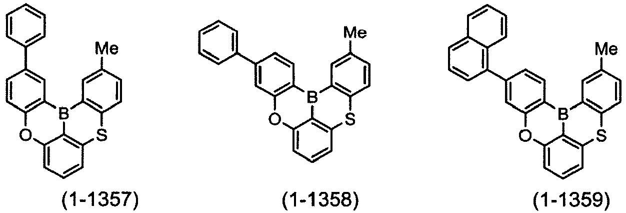

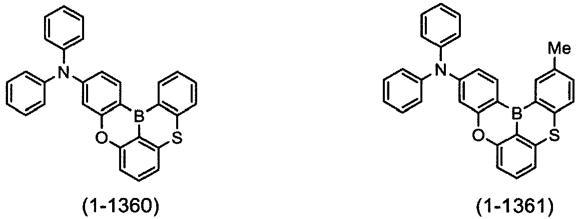

More specific examples of the polycyclic aromatic compound of the invention and oligomers thereof include, for example, compounds represented by the following formulas (1-2001) to (1-2299), compounds represented by the following formulas (1-2301) to (1-2619), compounds represented by the following formulas (1-2621) to (1-2705), compounds represented by the following formulas (1-3831) to (1-4033), and compounds represented by the following formulas (1-4301) to (1-4315).

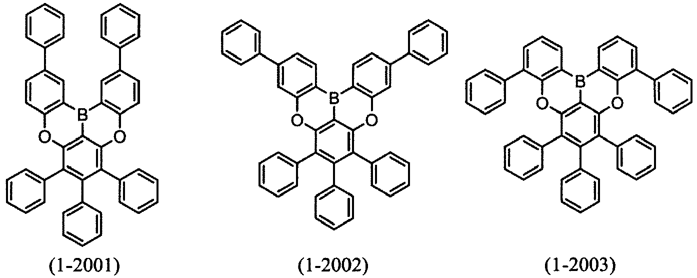

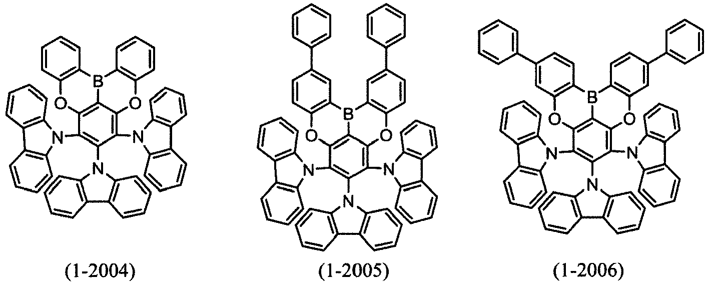

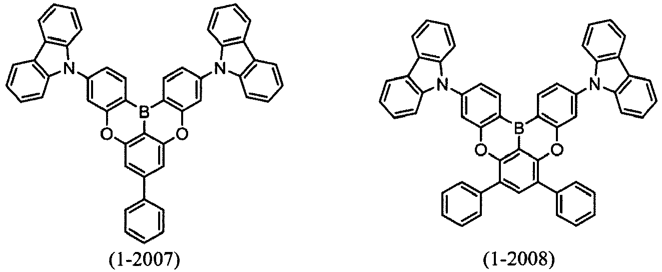

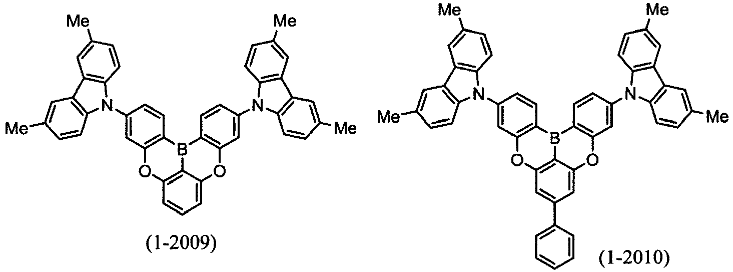

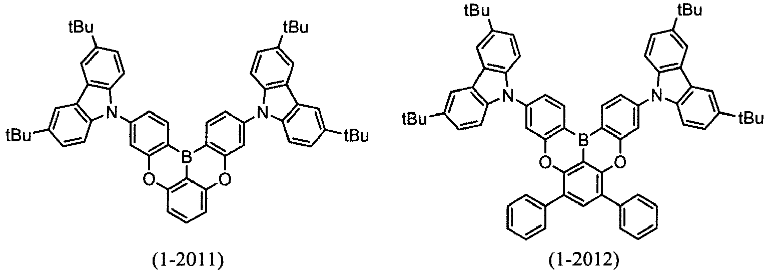

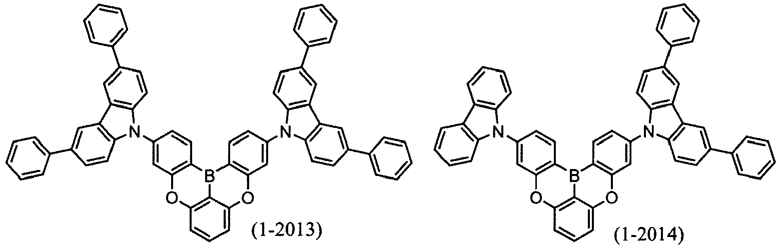

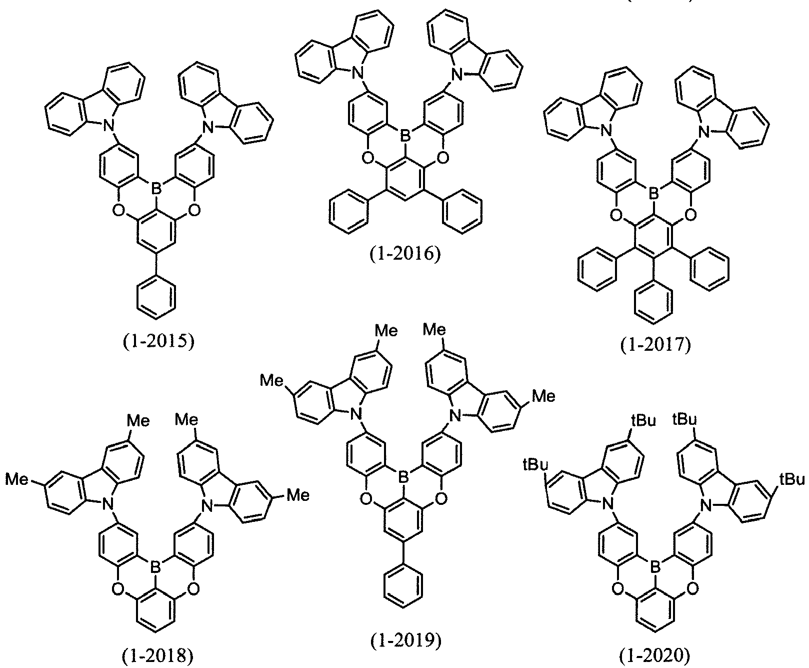

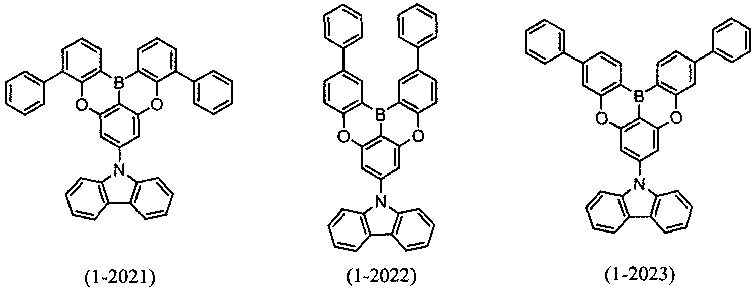

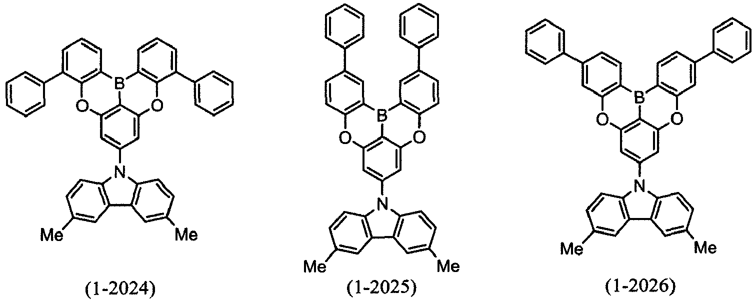

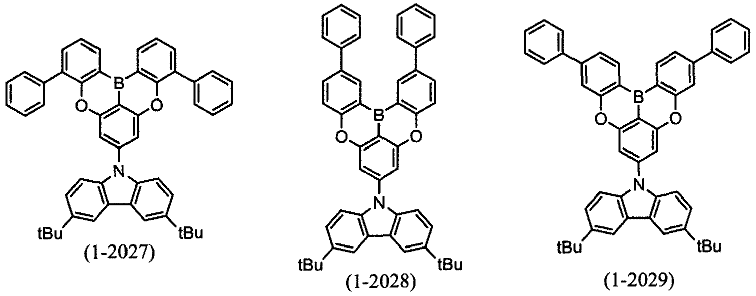

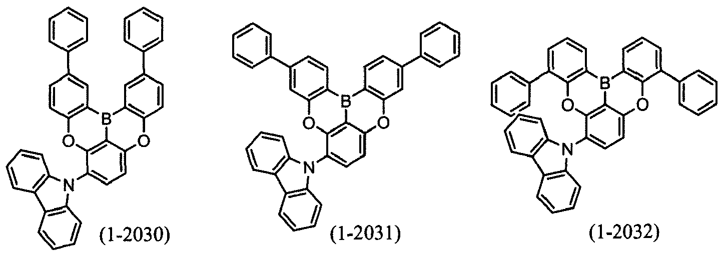

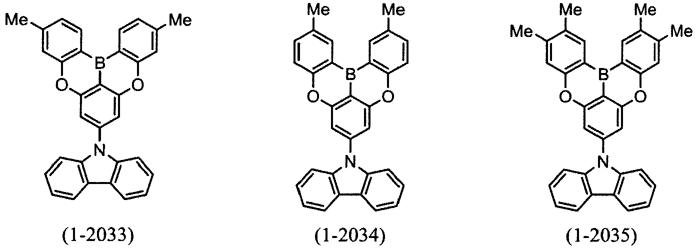

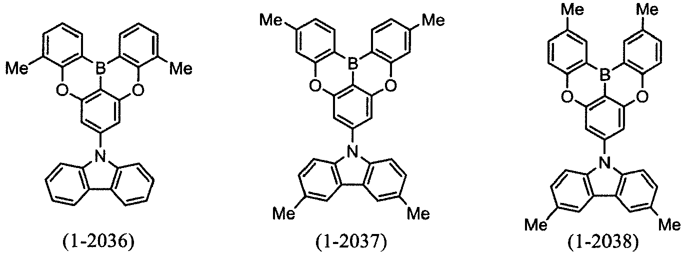

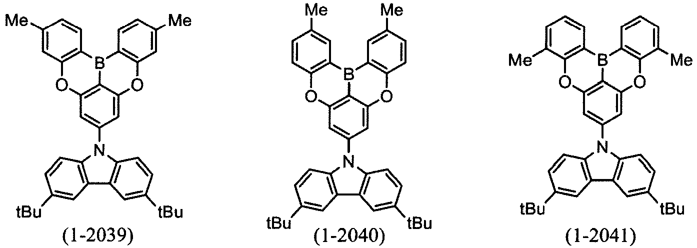

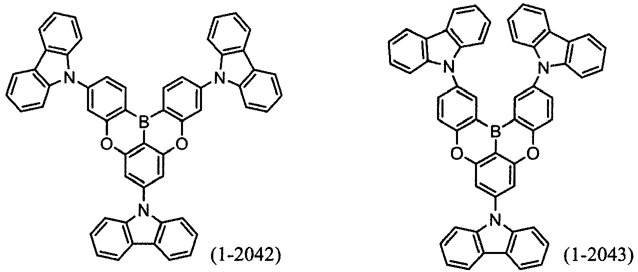

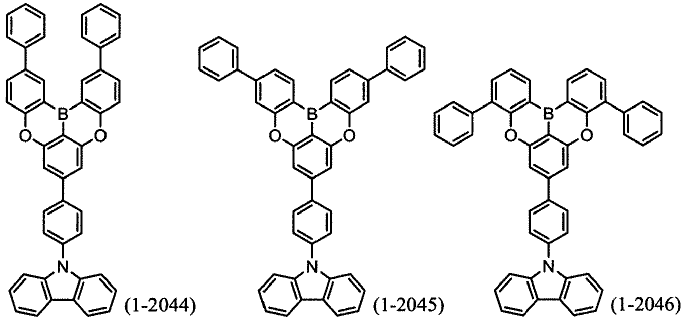

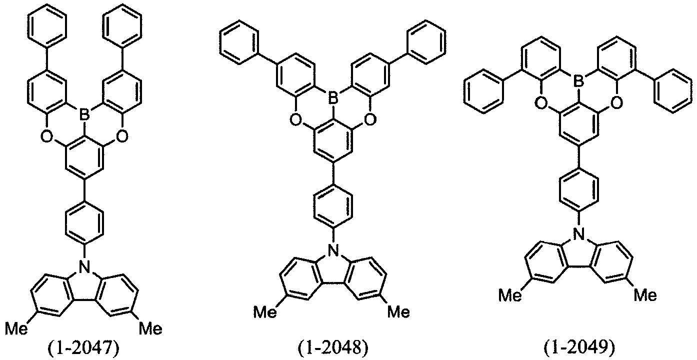

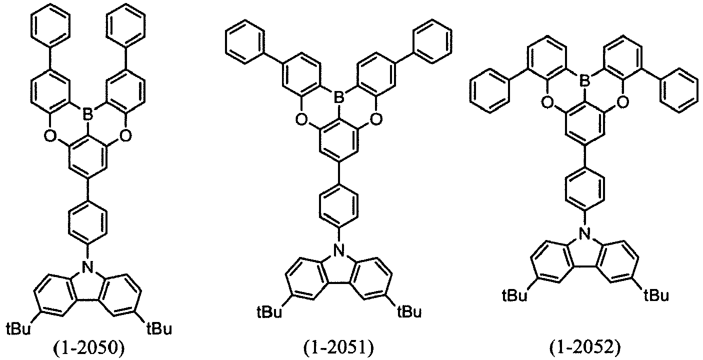

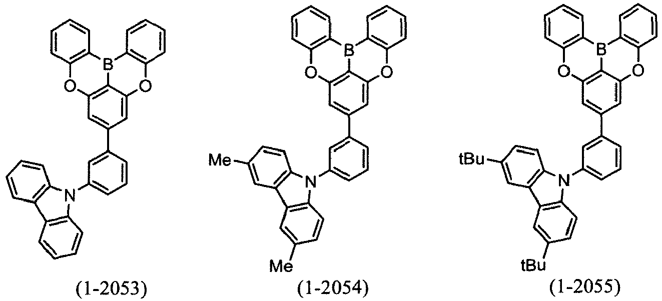

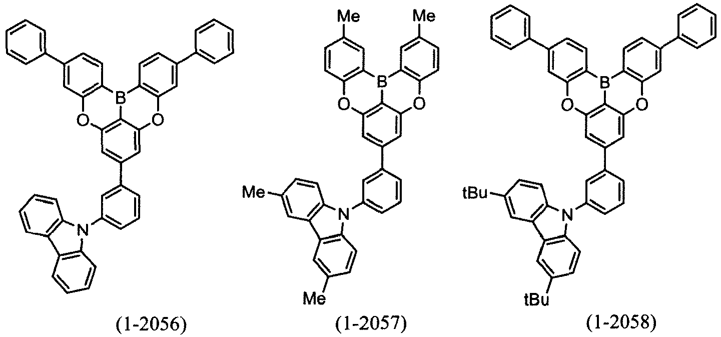

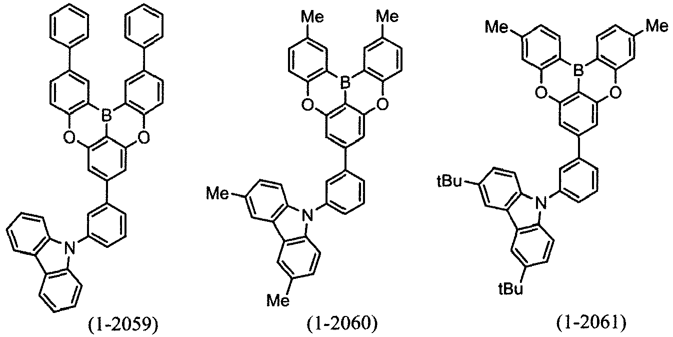

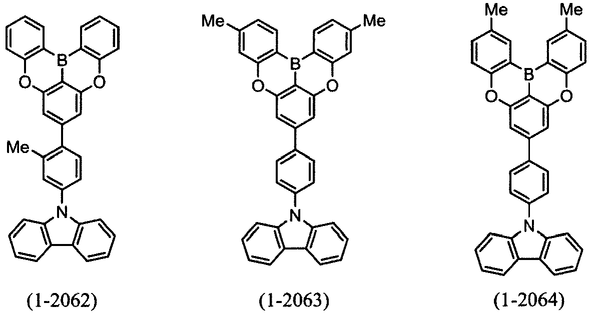

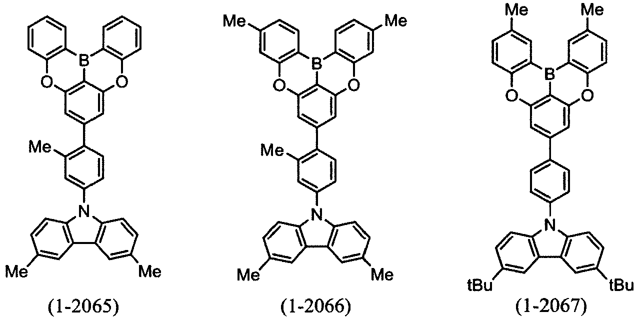

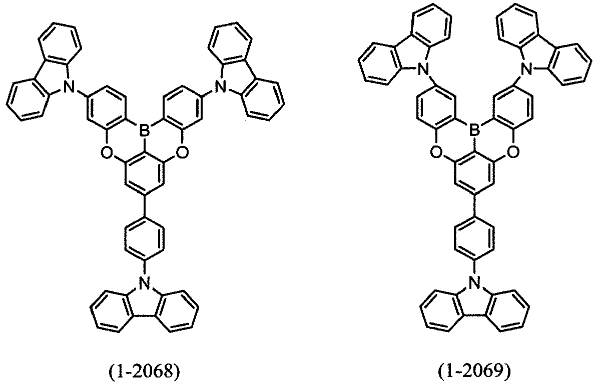

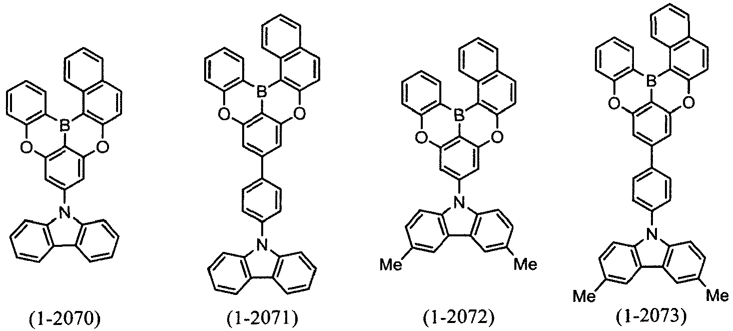

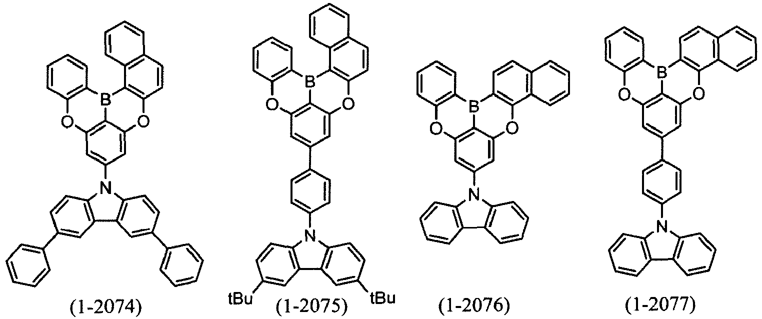

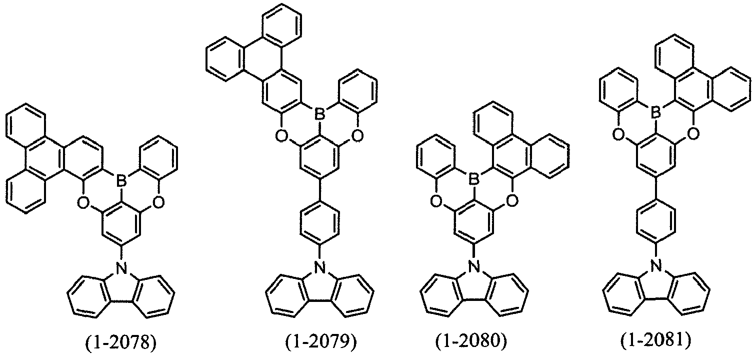

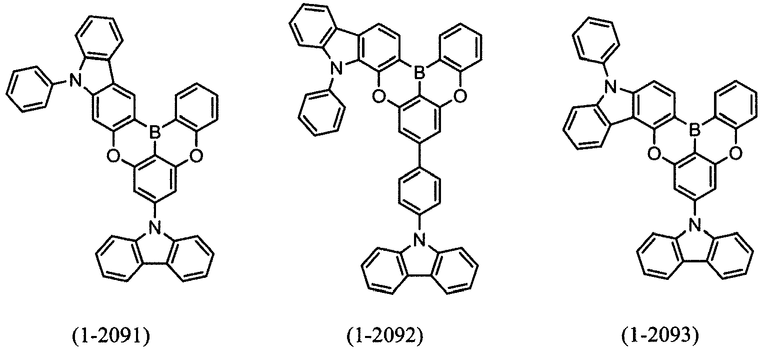

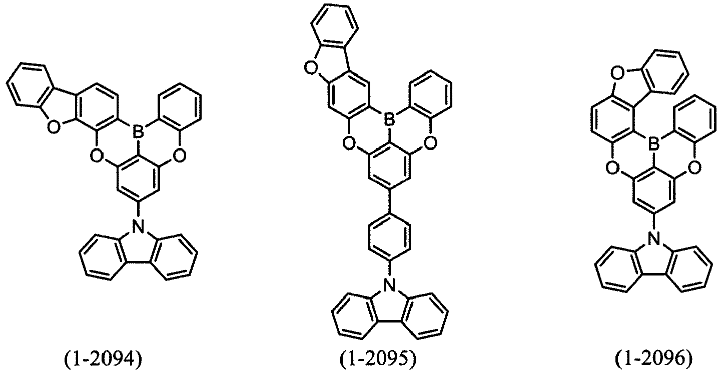

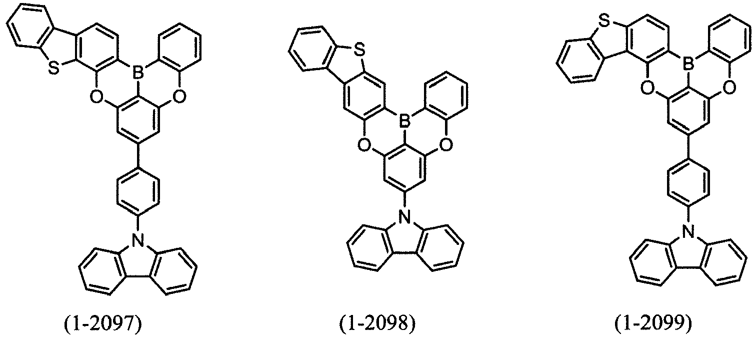

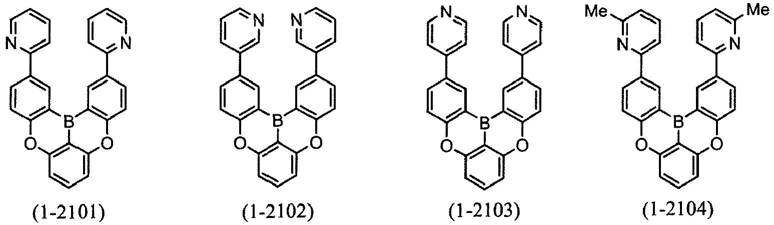

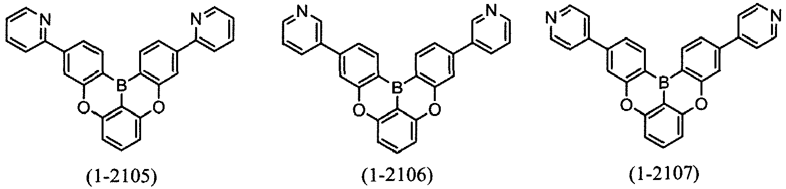

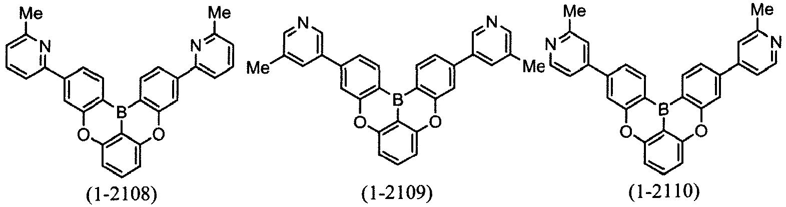

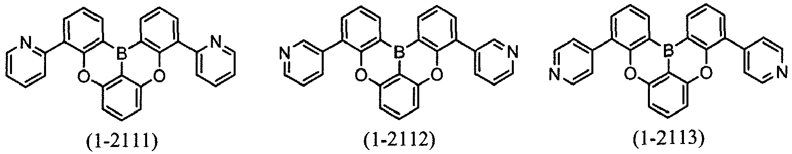

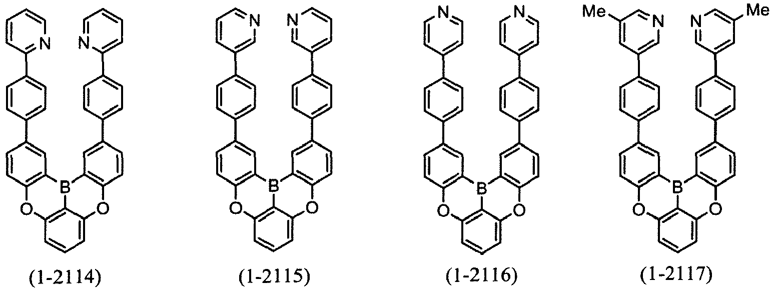

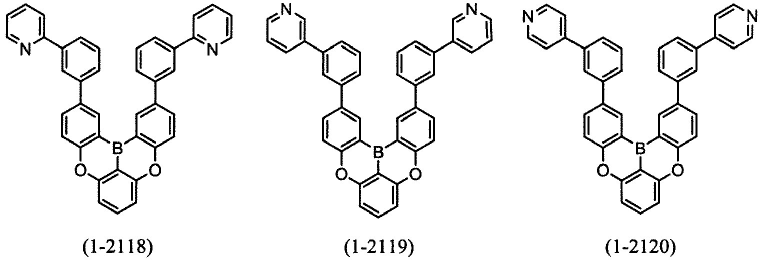

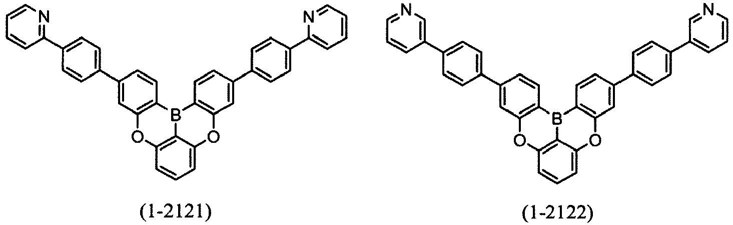

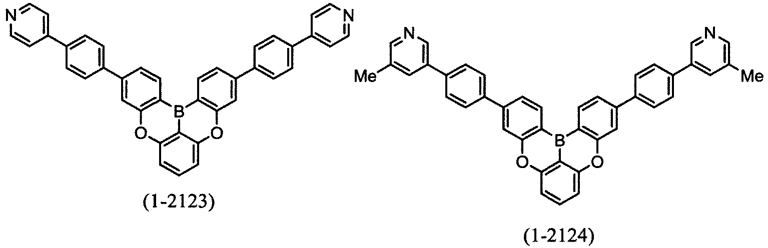

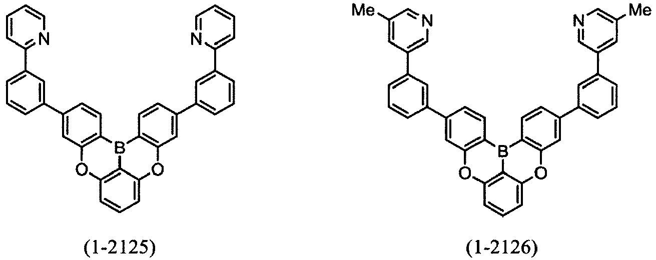

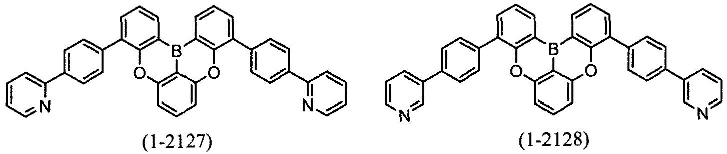

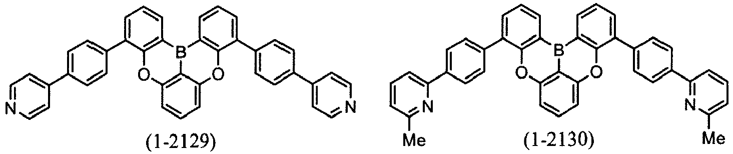

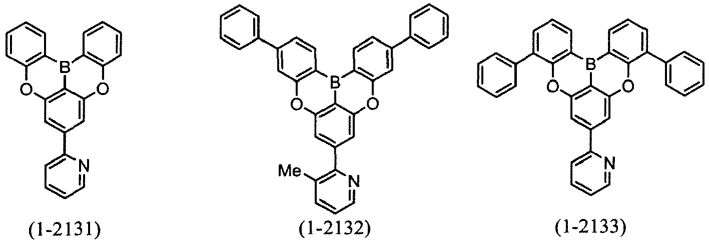

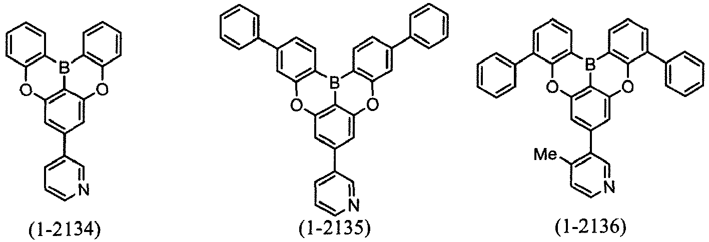

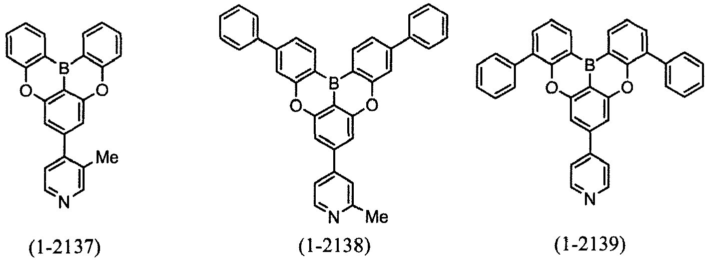

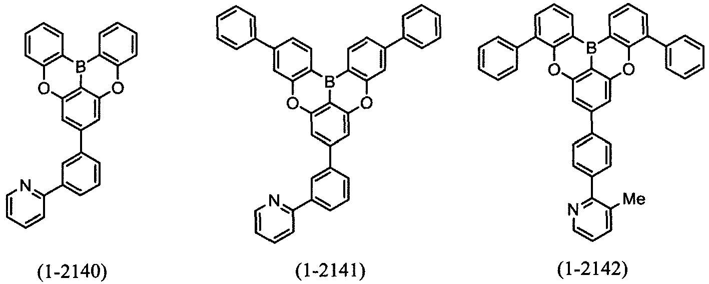

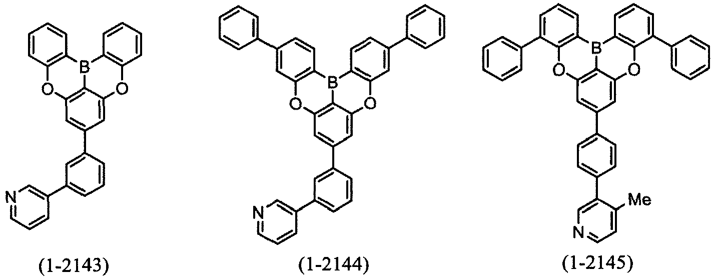

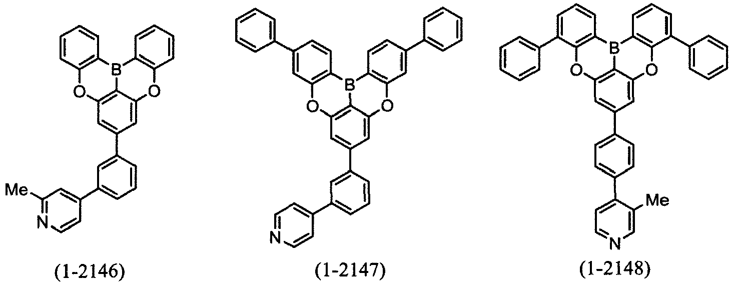

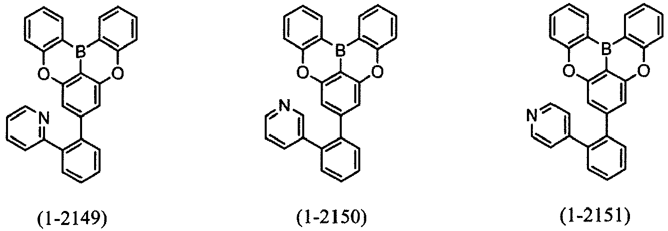

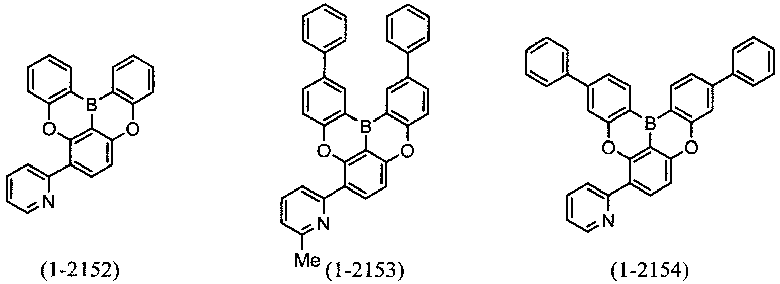

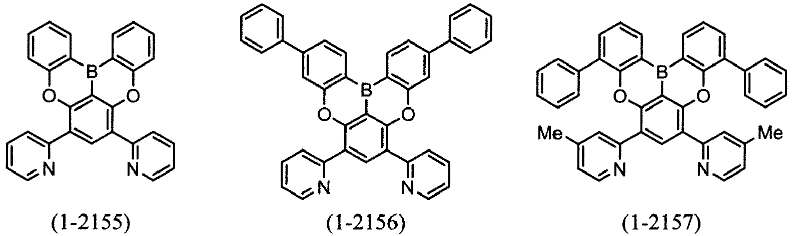

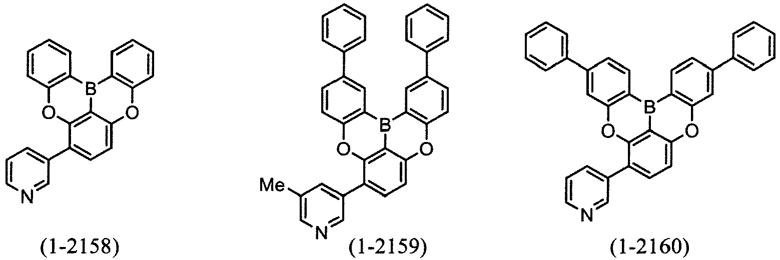

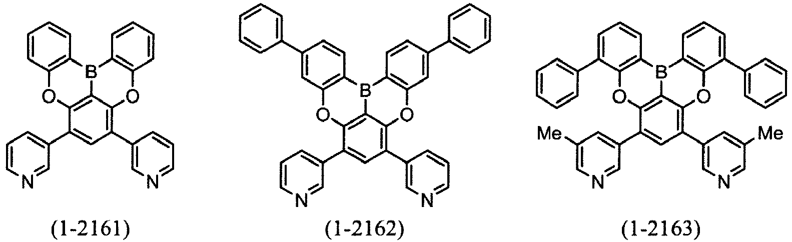

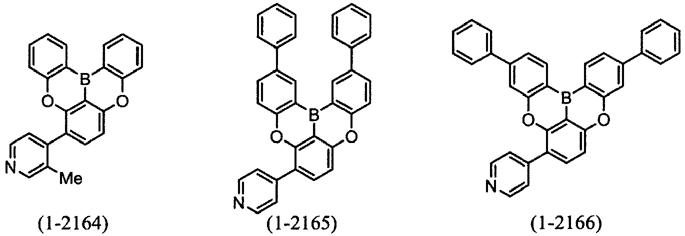

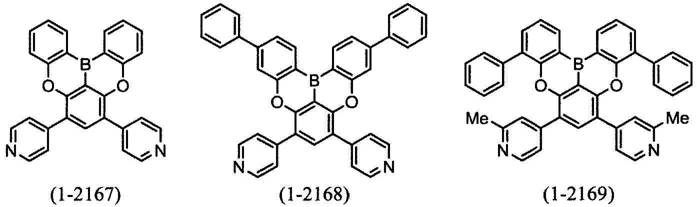

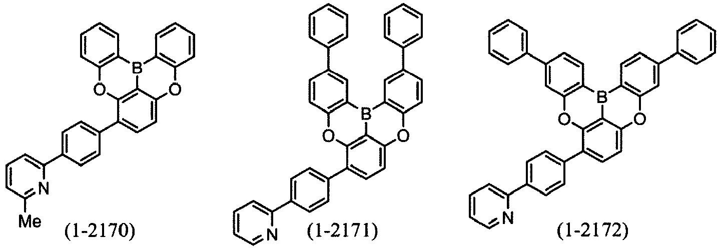

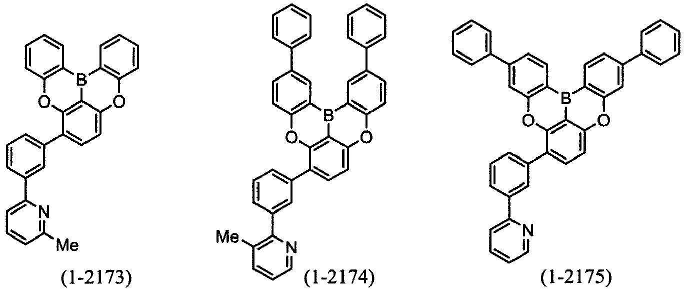

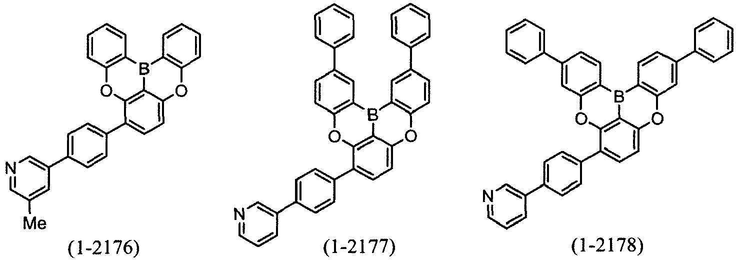

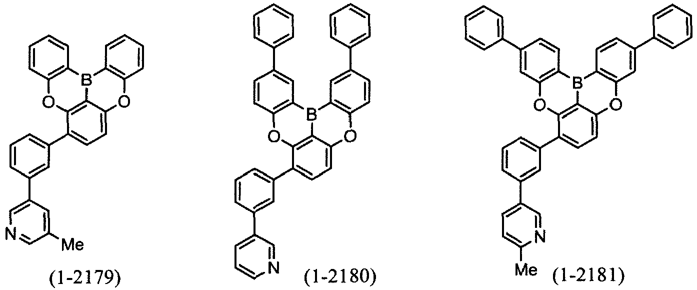

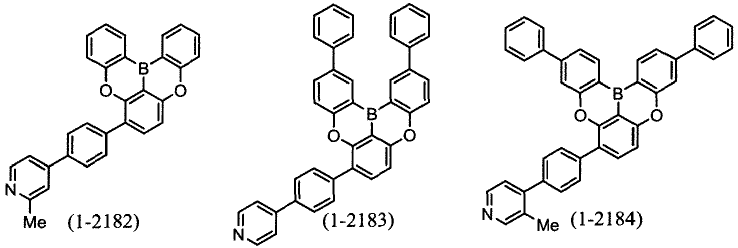

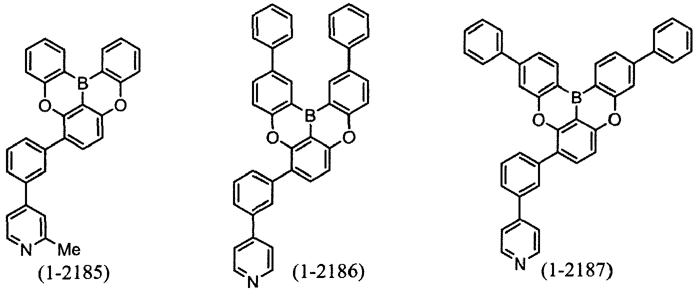

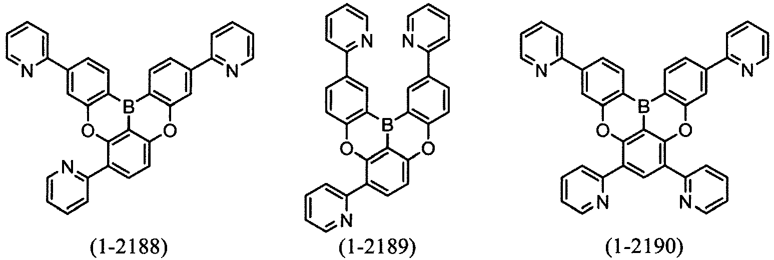

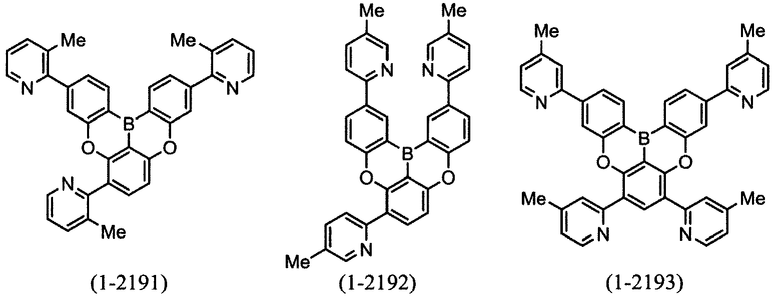

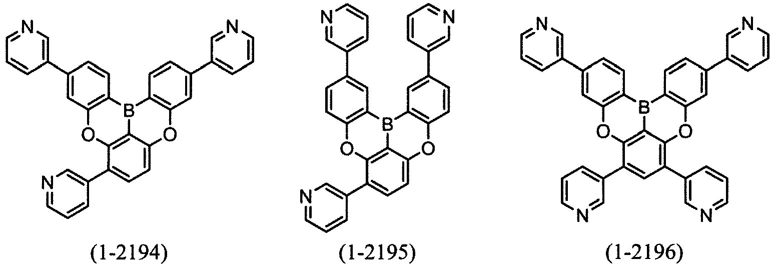

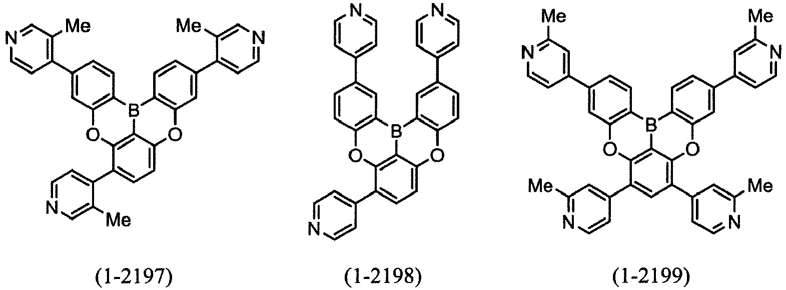

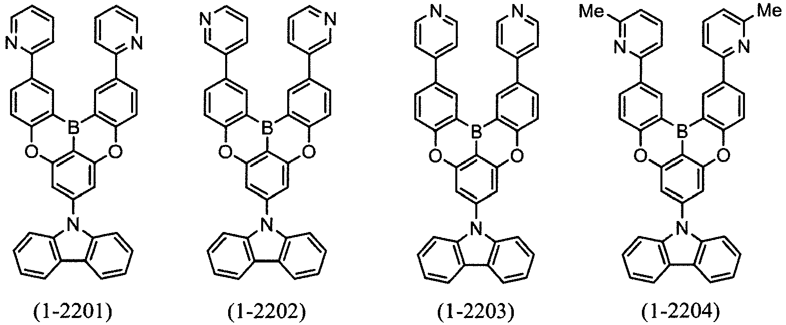

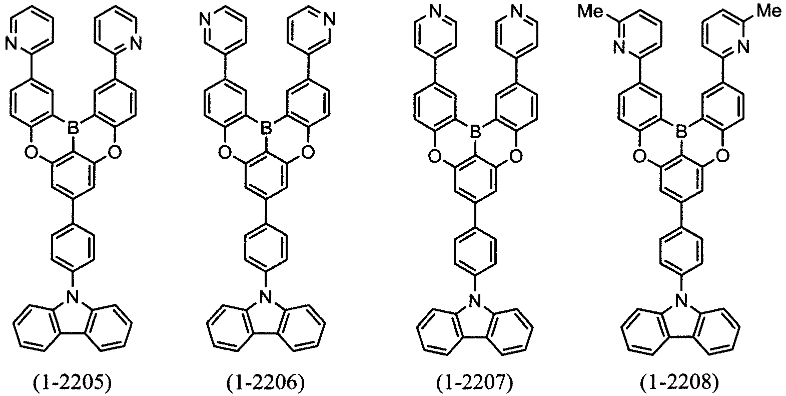

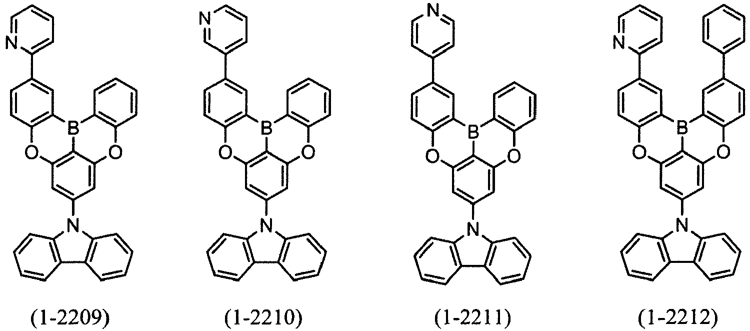

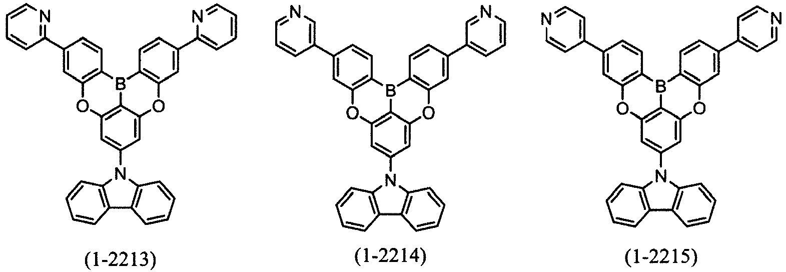

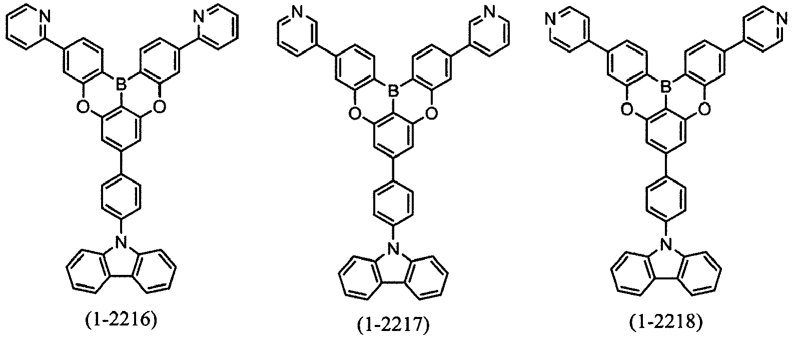

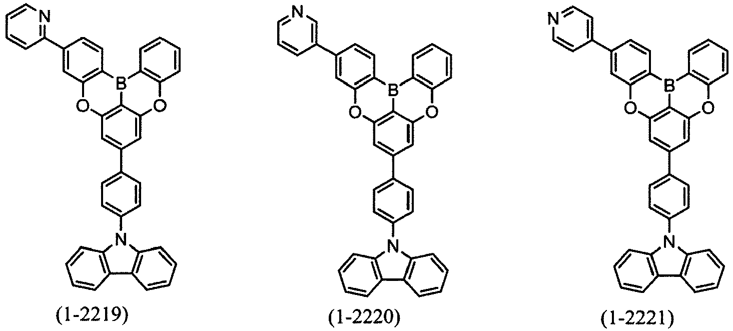

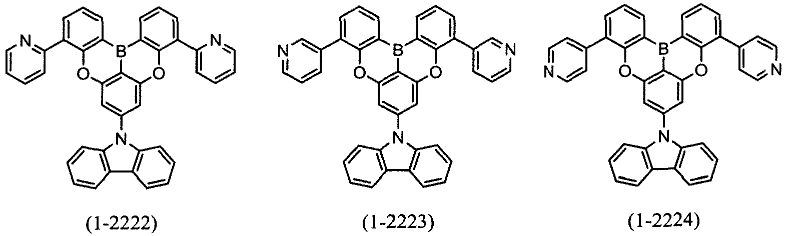

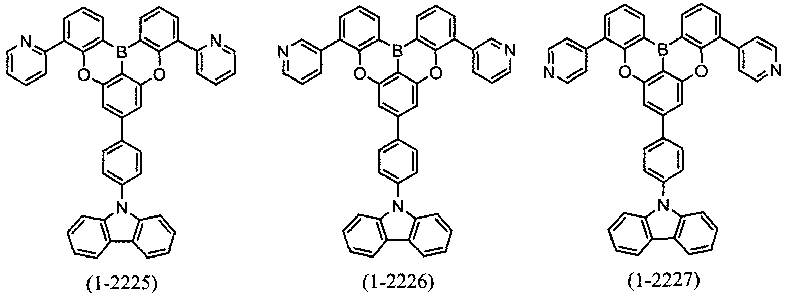

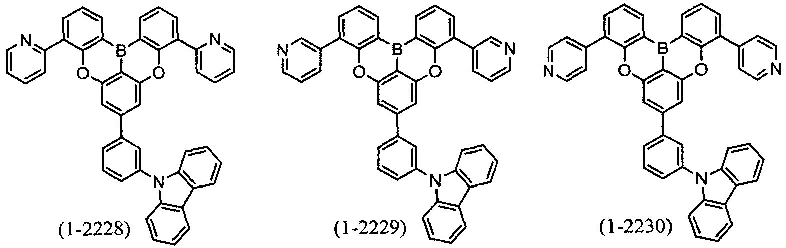

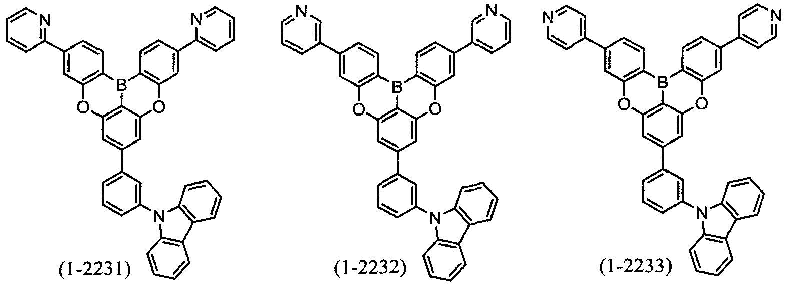

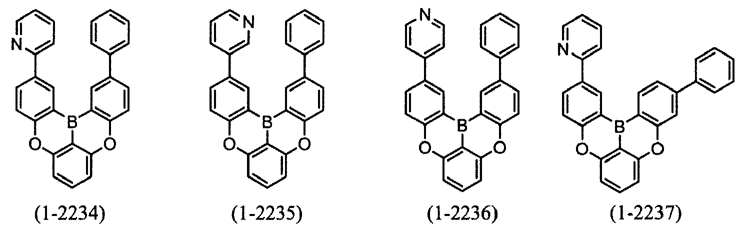

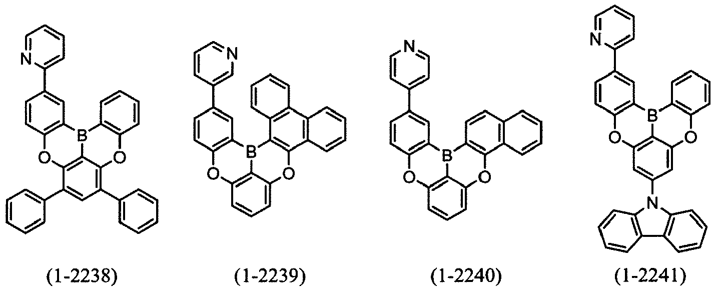

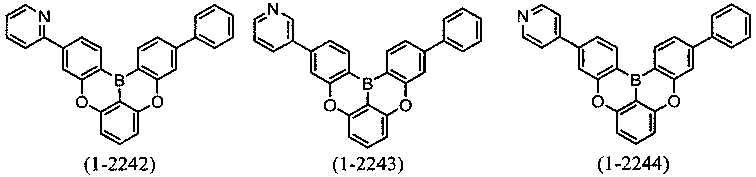

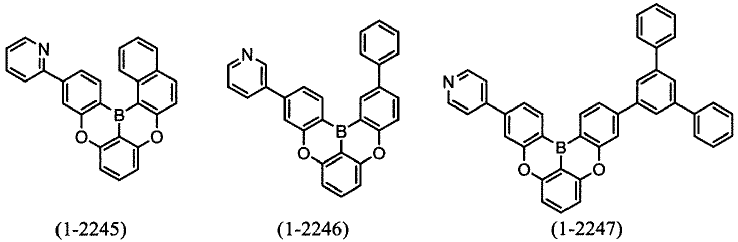

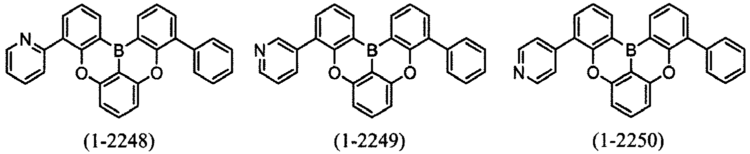

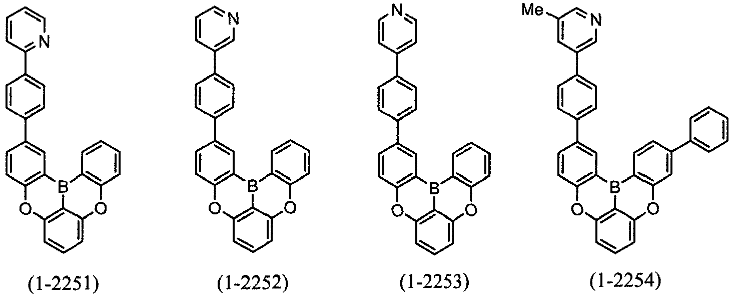

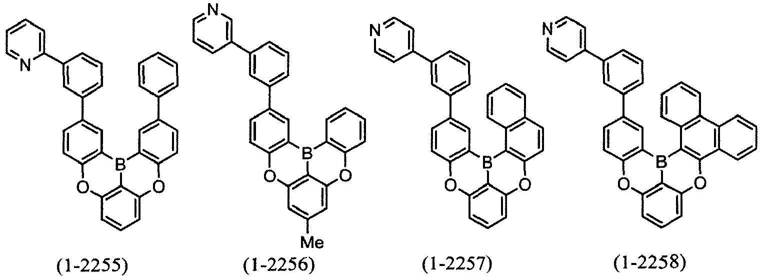

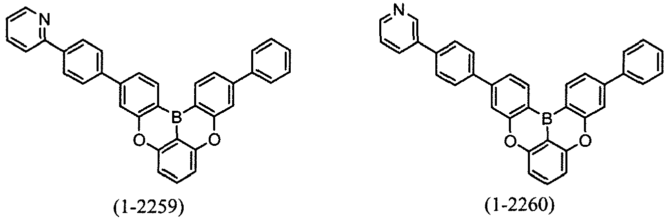

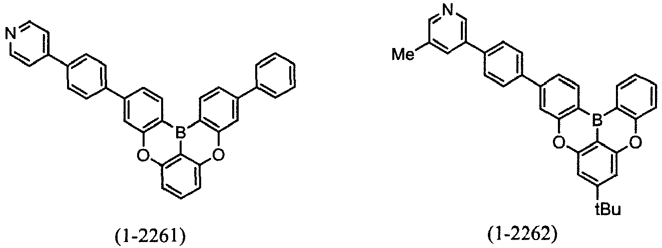

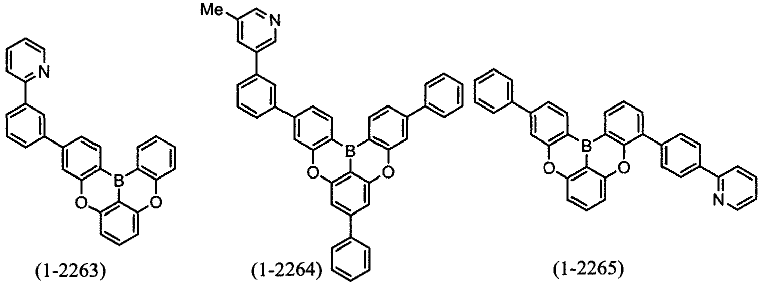

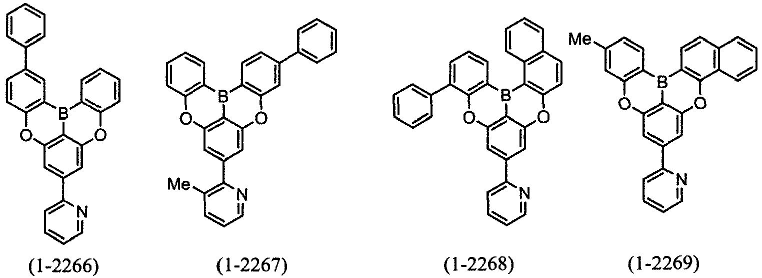

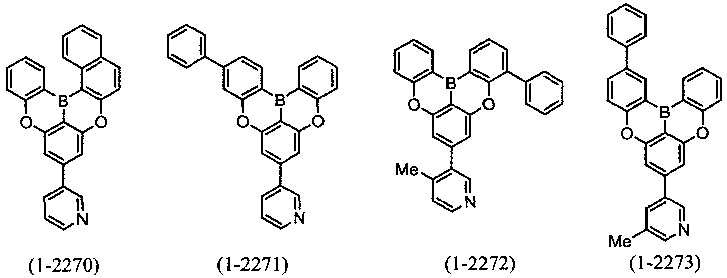

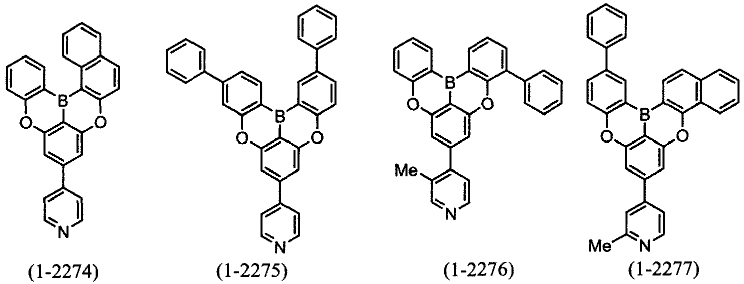

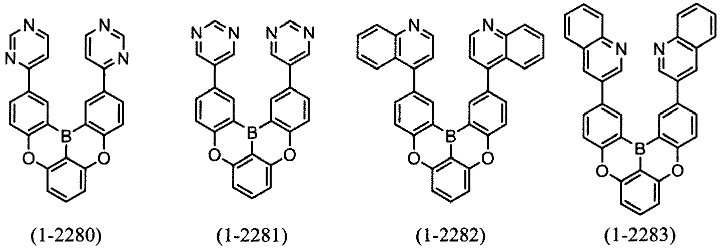

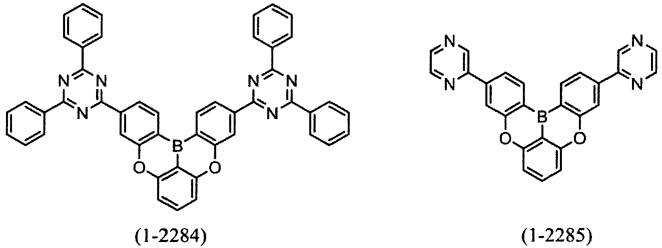

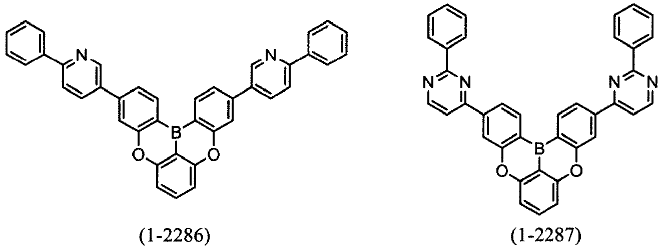

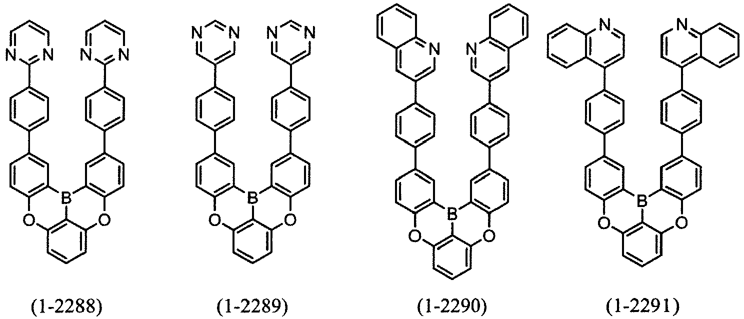

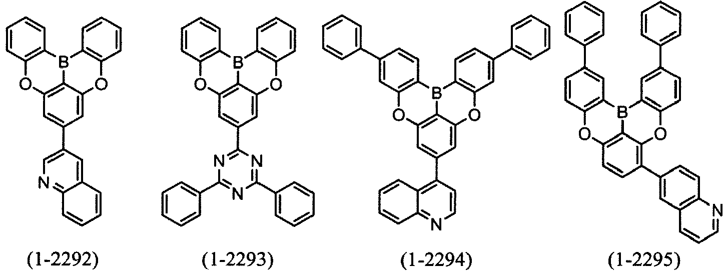

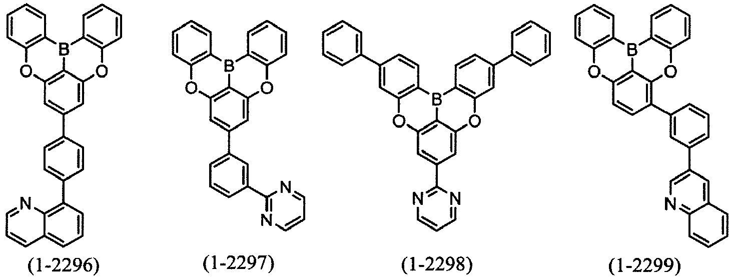

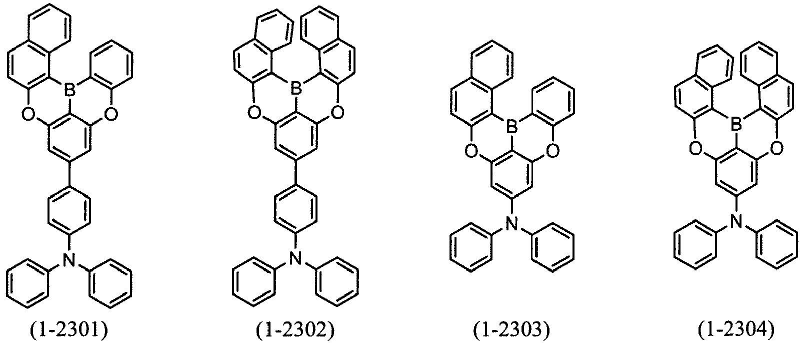

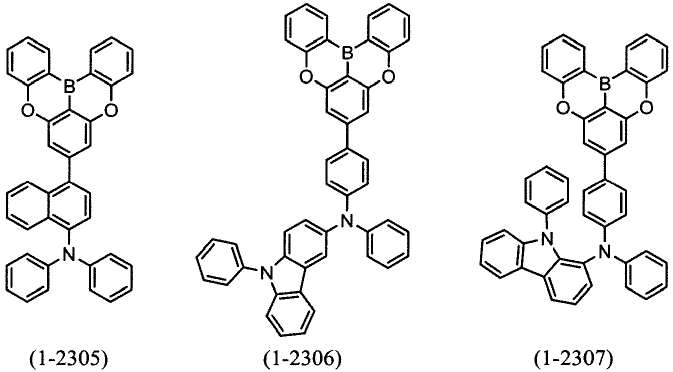

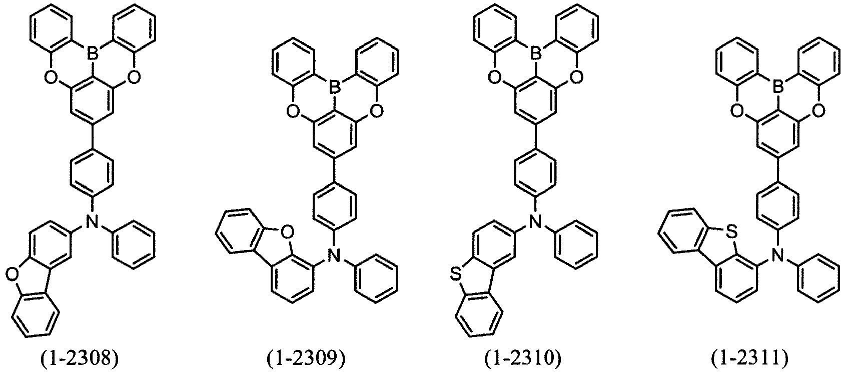

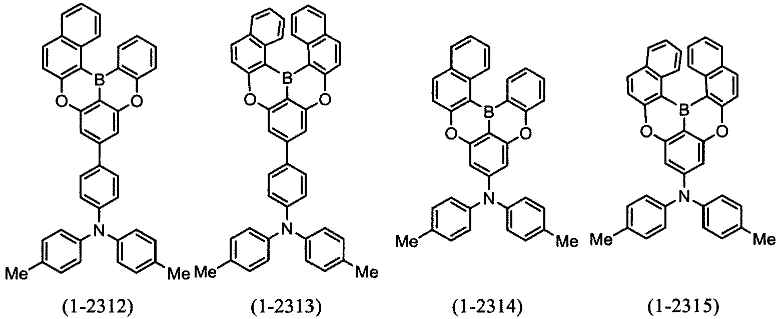

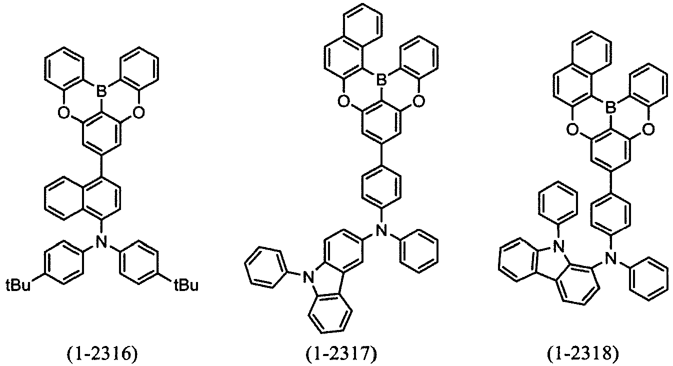

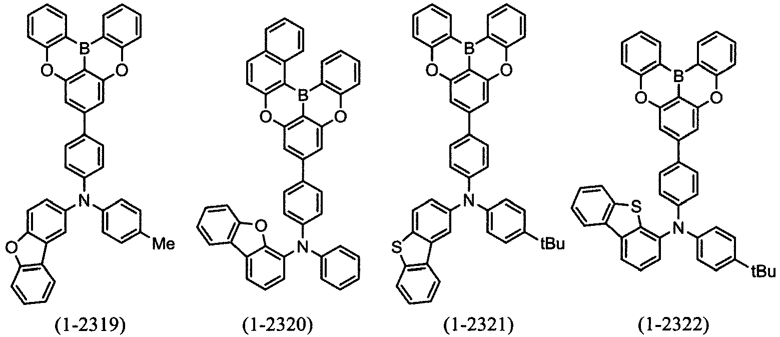

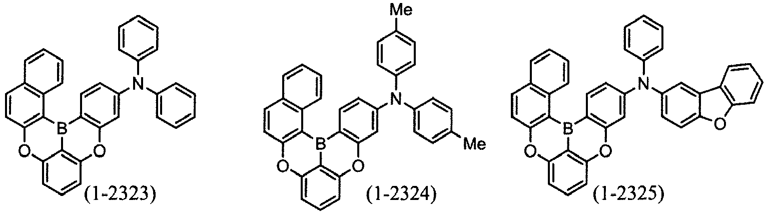

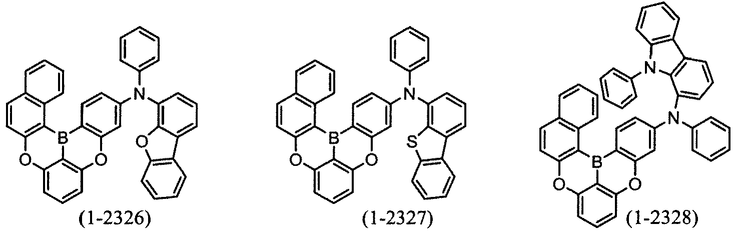

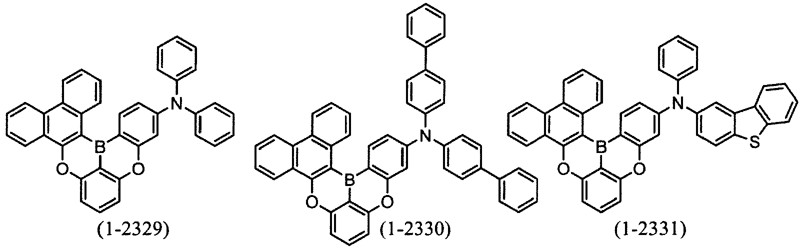

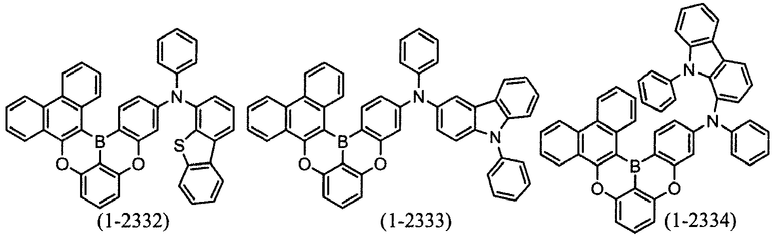

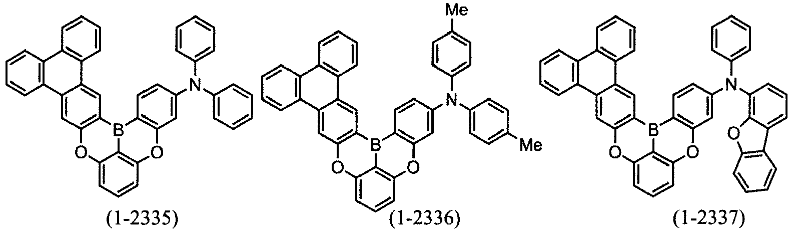

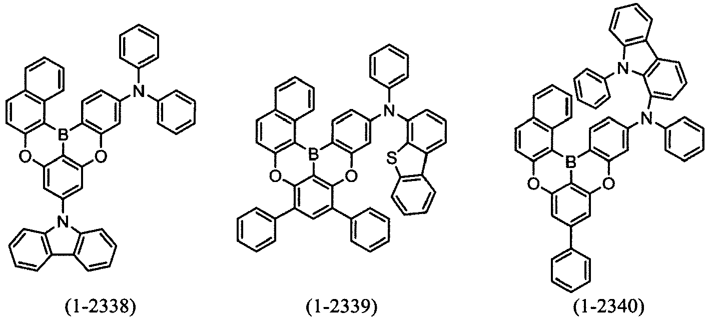

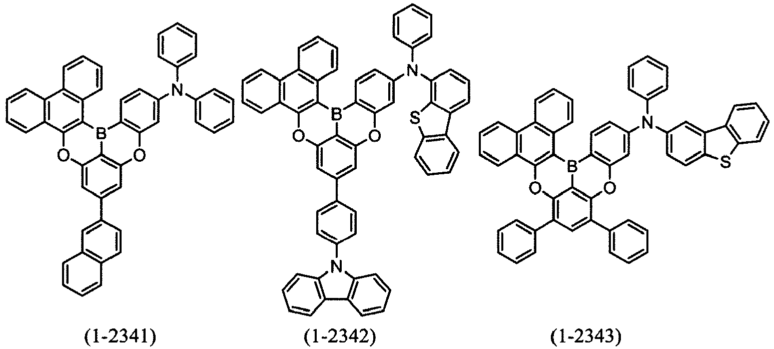

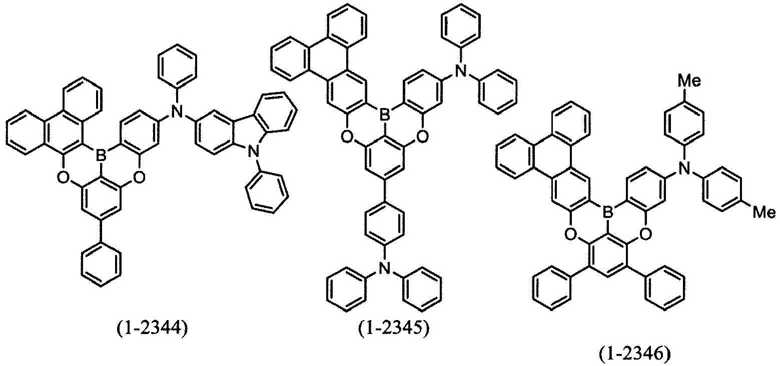

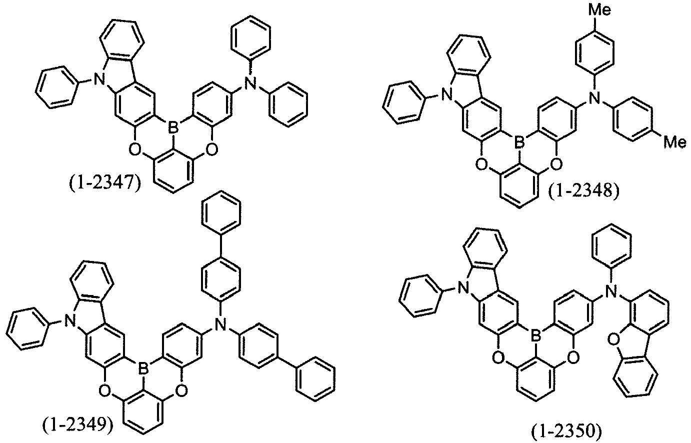

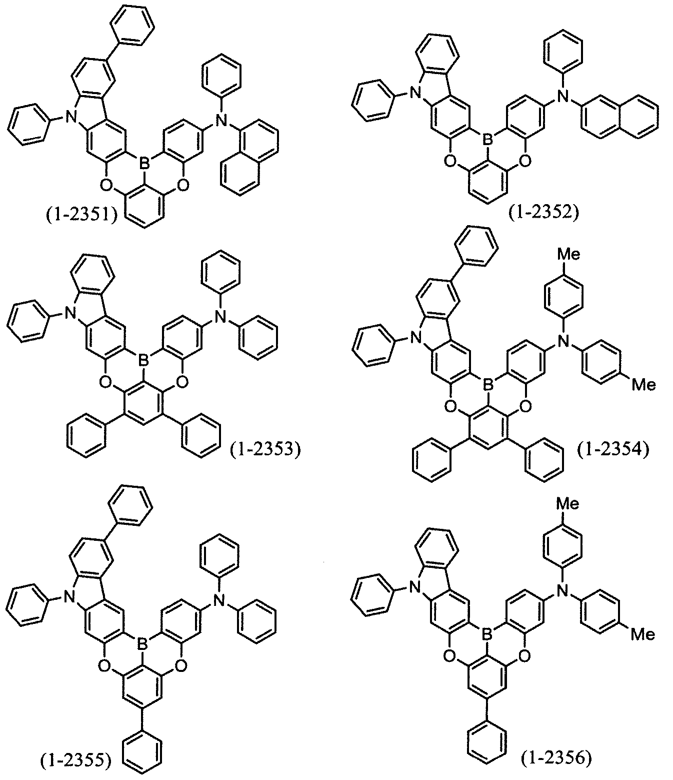

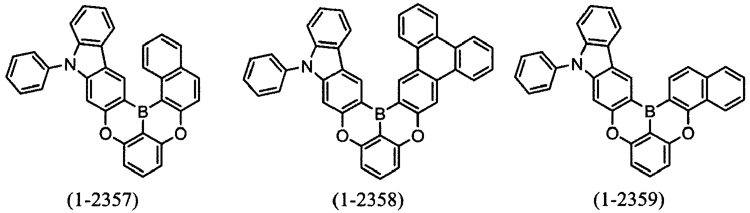

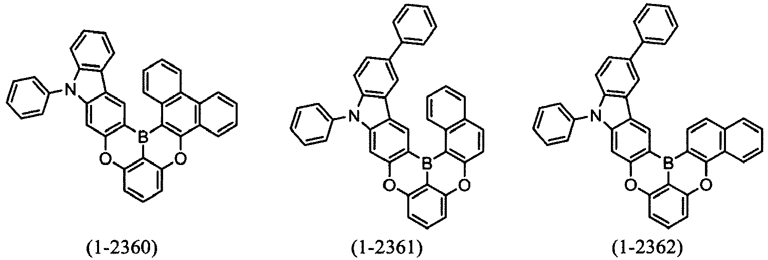

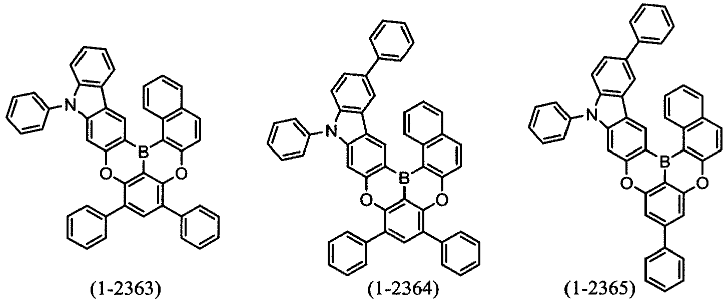

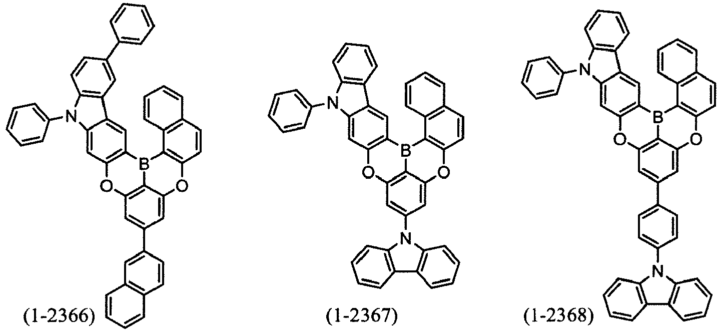

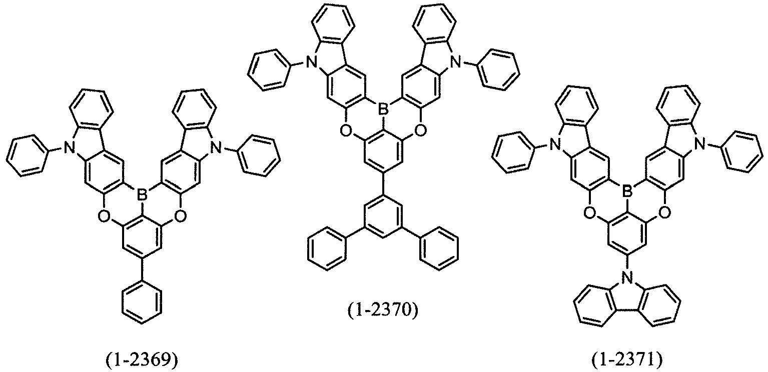

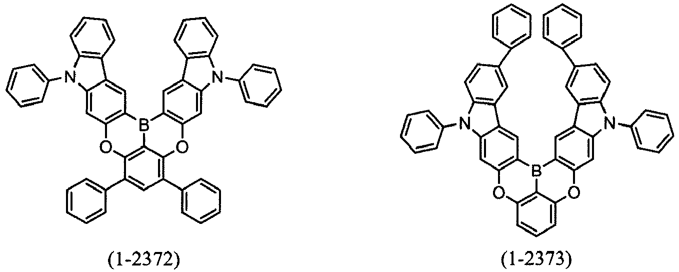

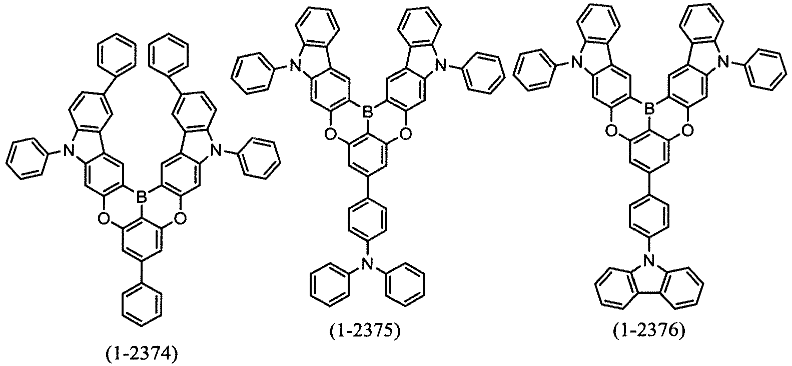

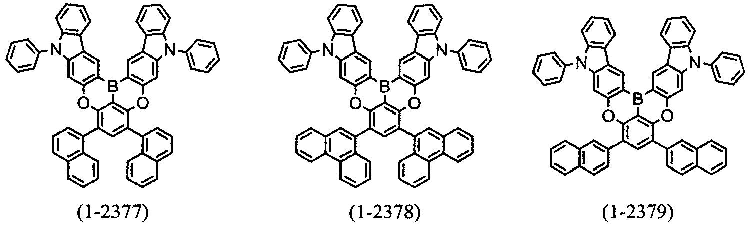

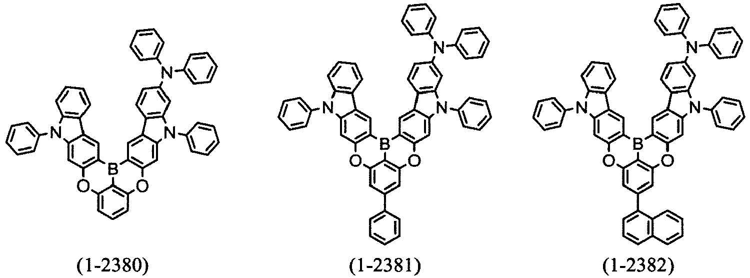

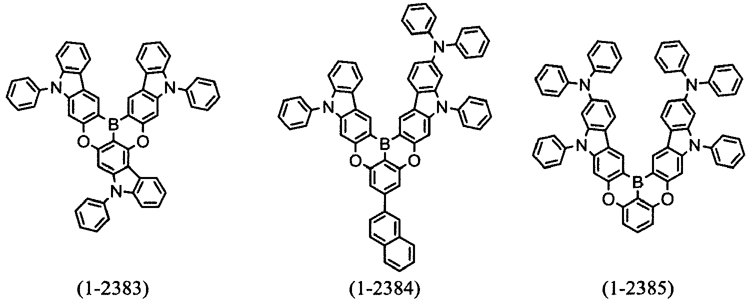

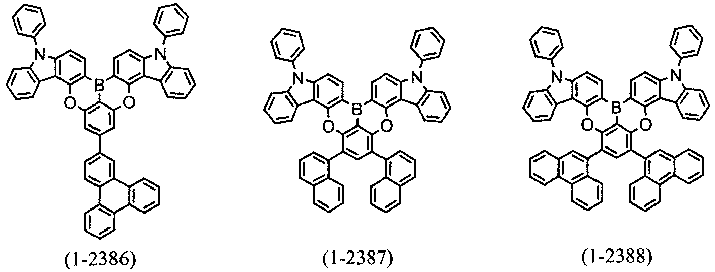

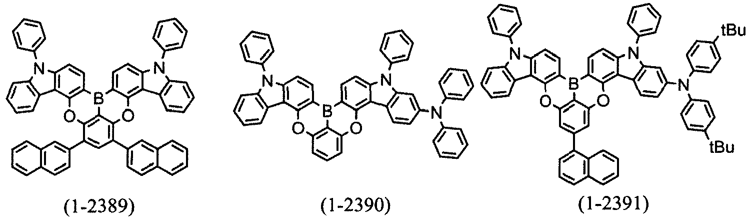

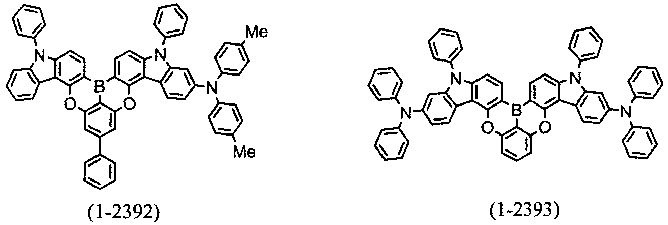

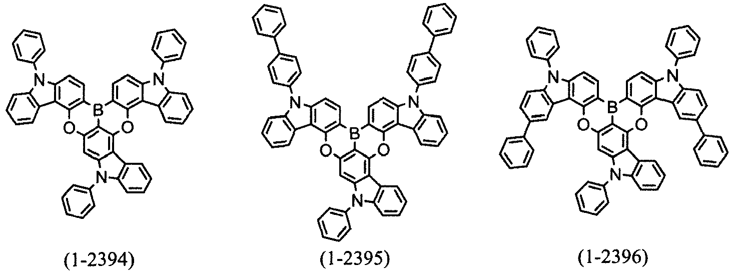

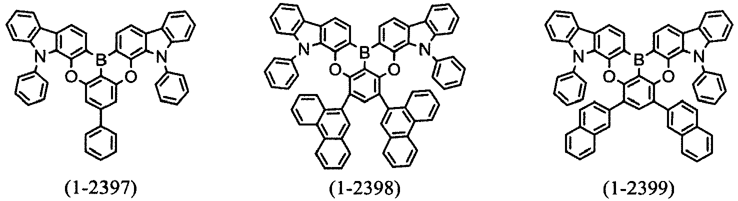

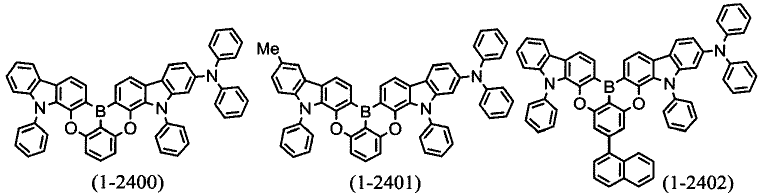

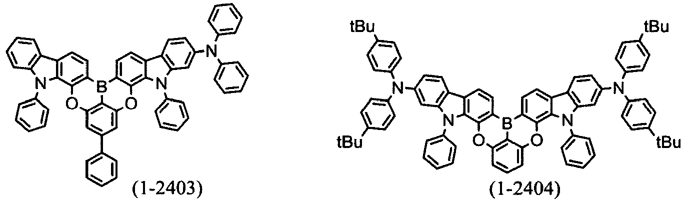

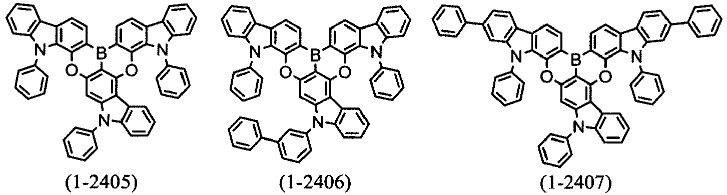

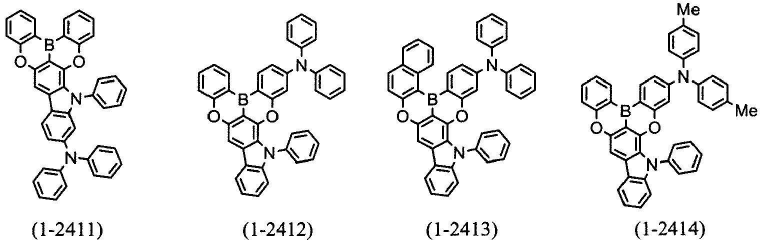

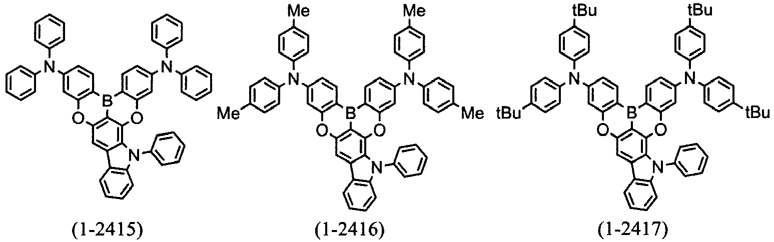

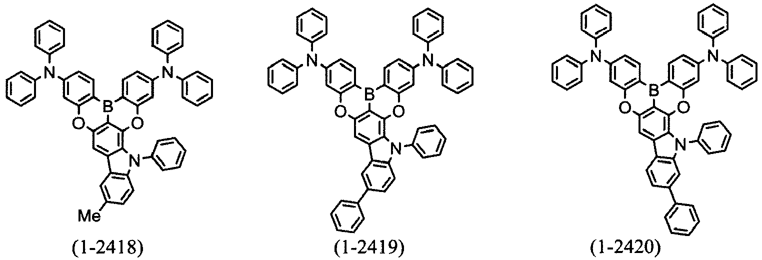

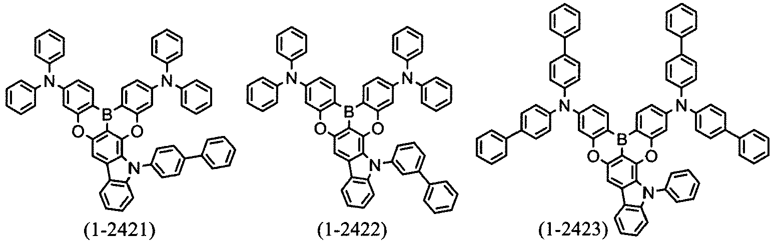

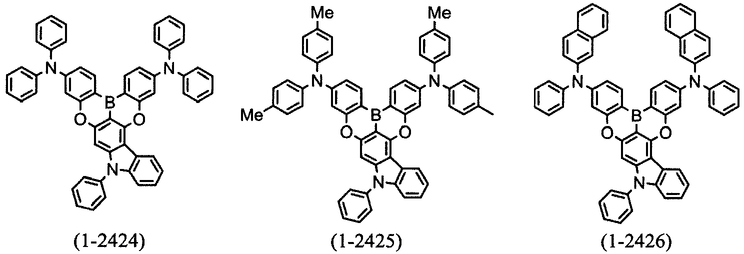

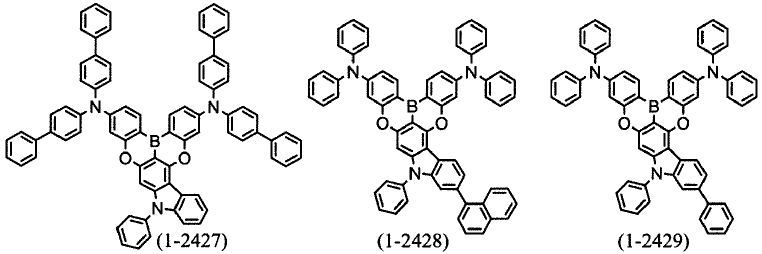

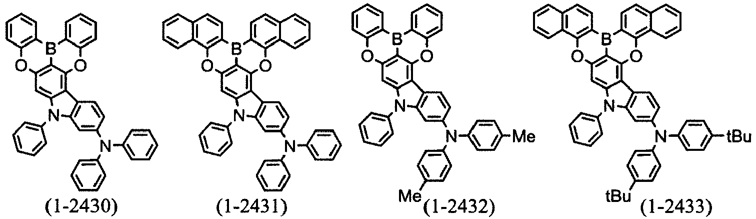

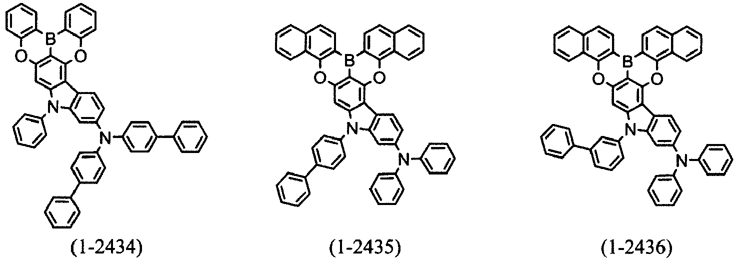

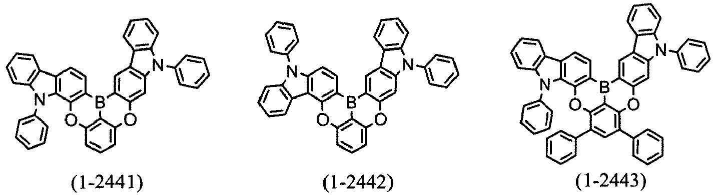

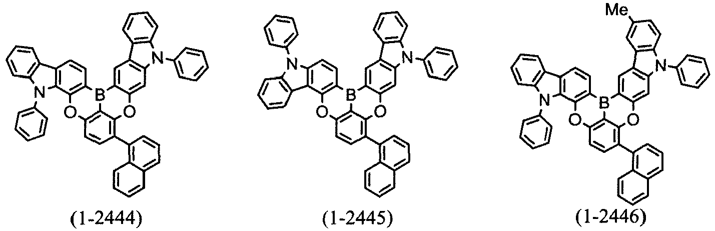

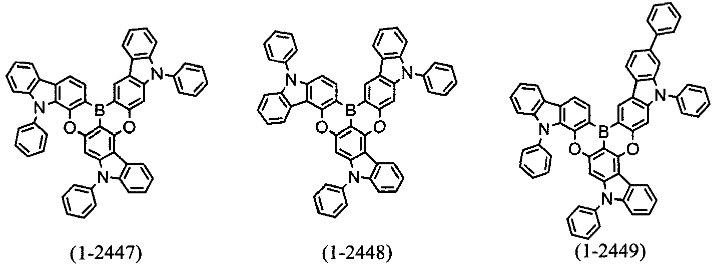

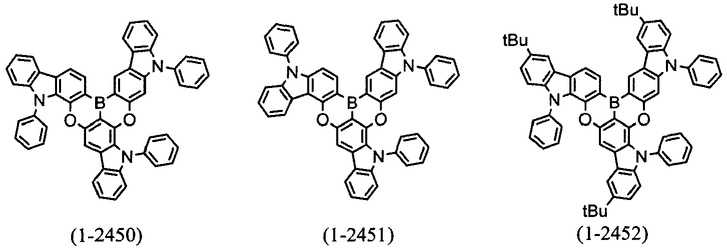

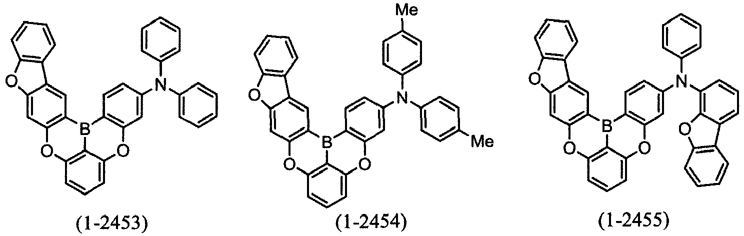

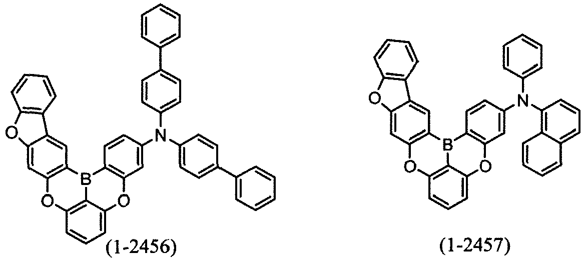

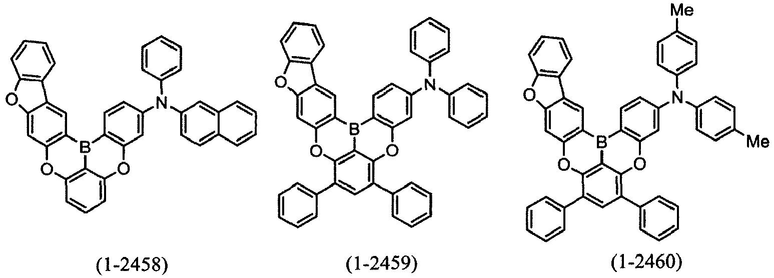

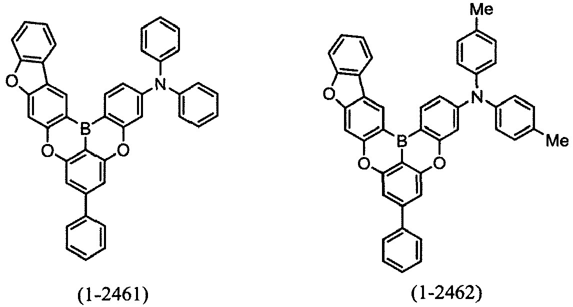

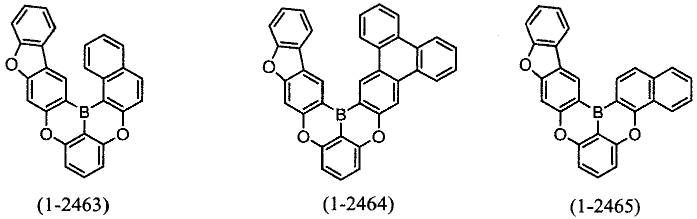

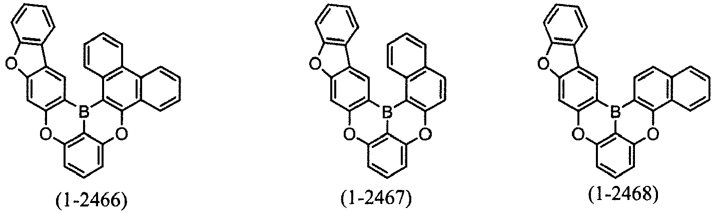

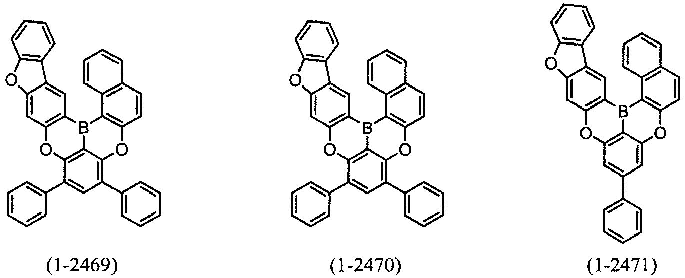

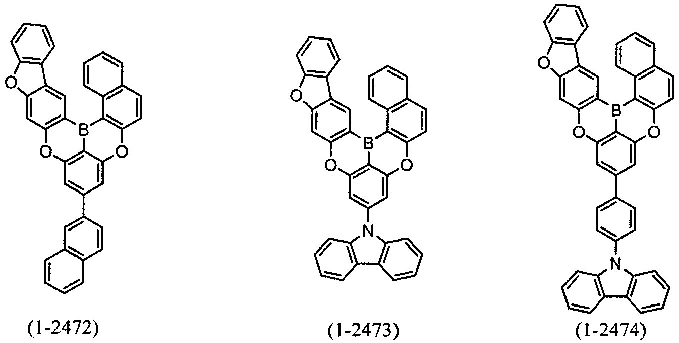

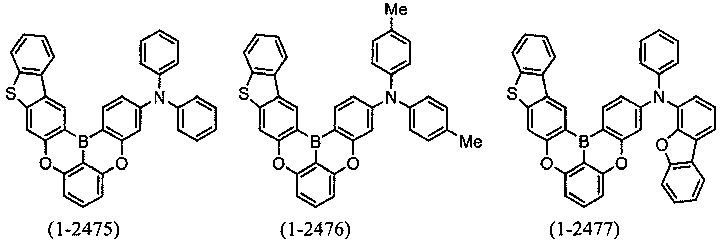

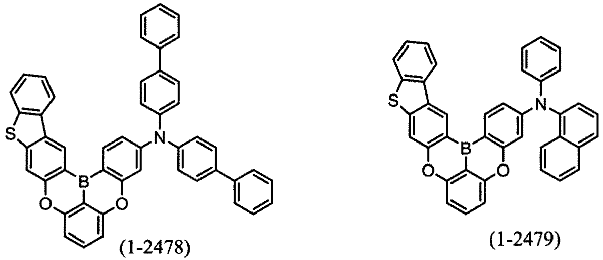

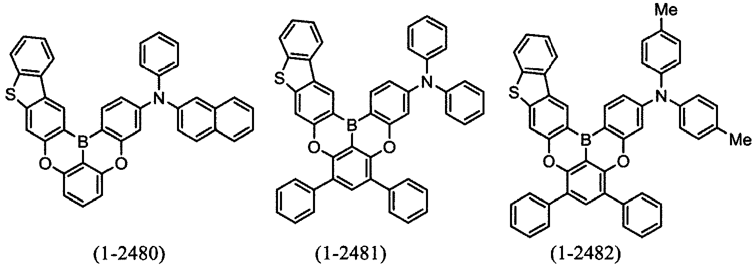

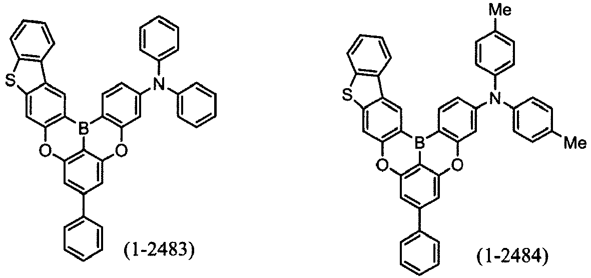

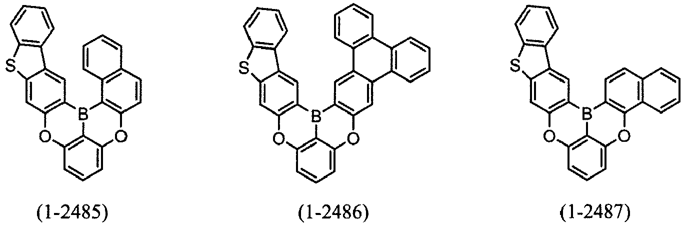

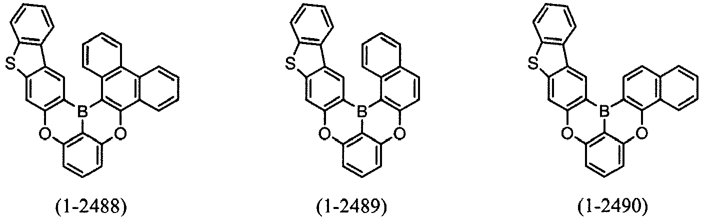

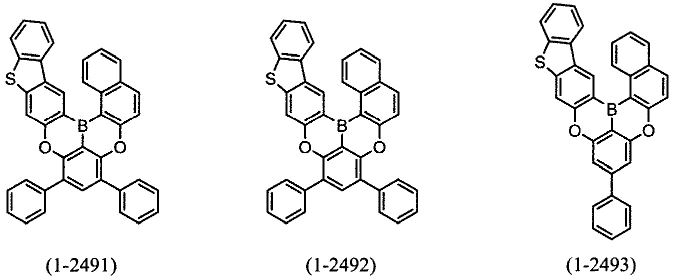

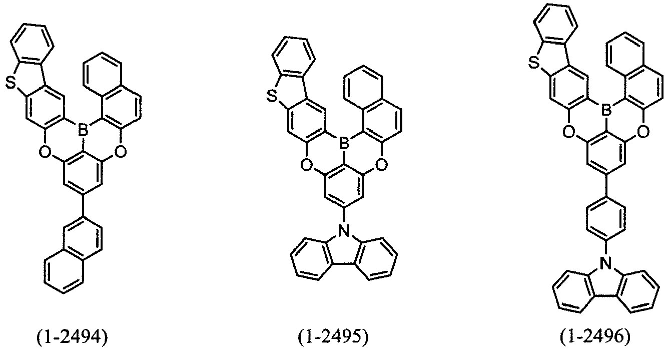

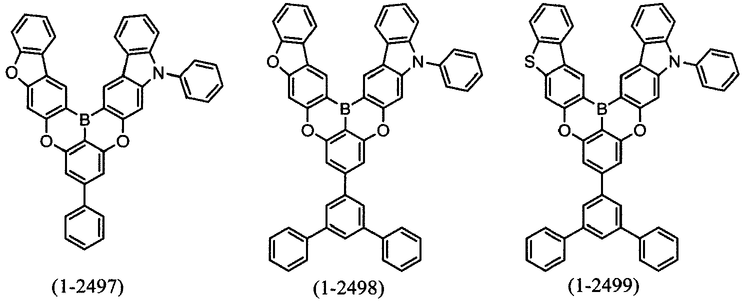

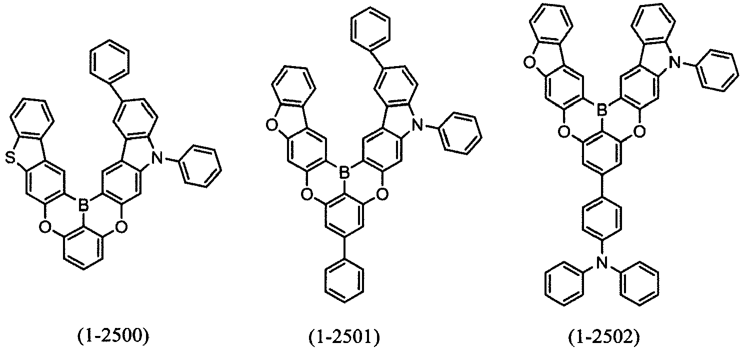

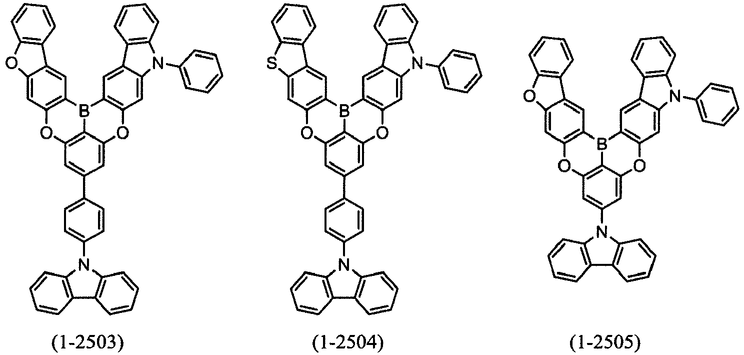

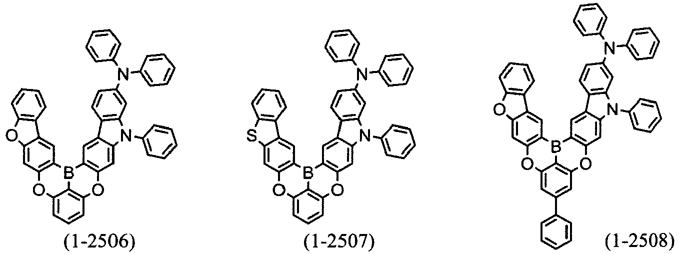

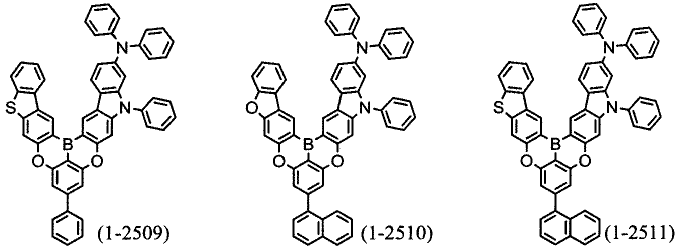

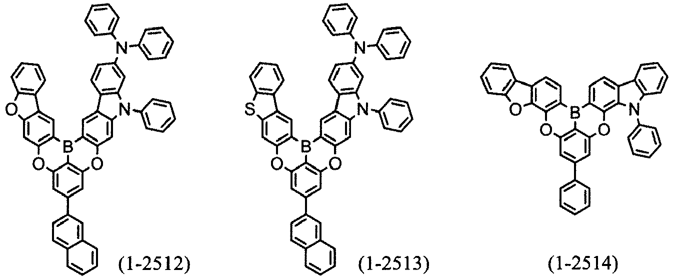

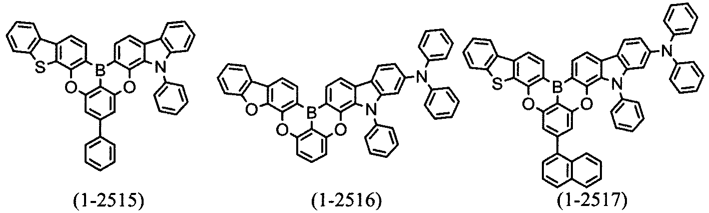

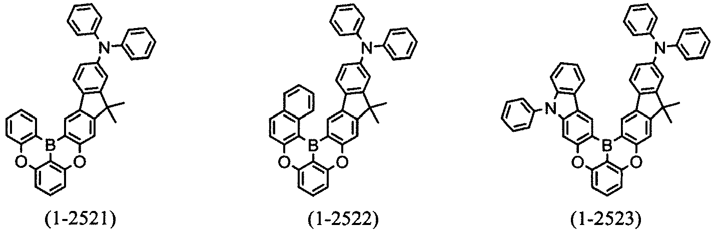

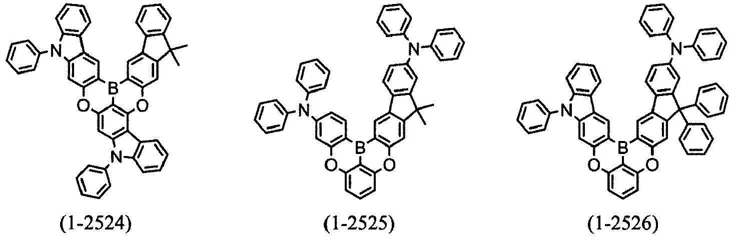

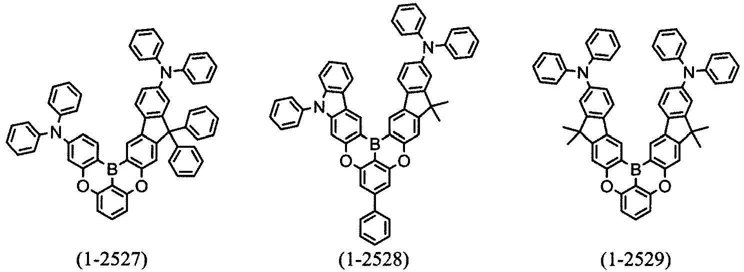

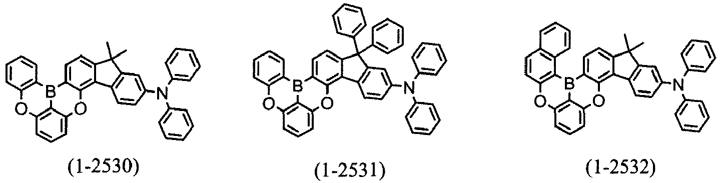

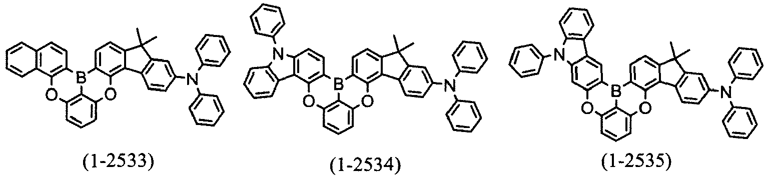

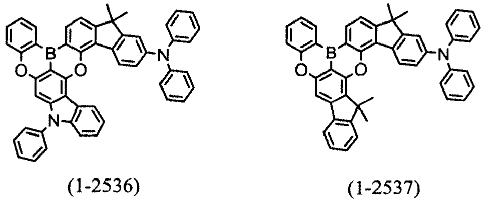

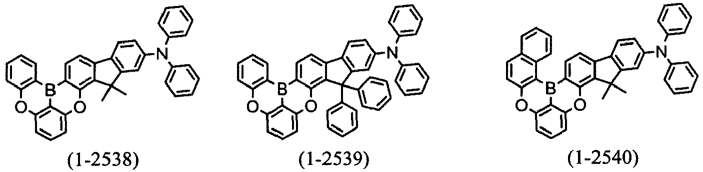

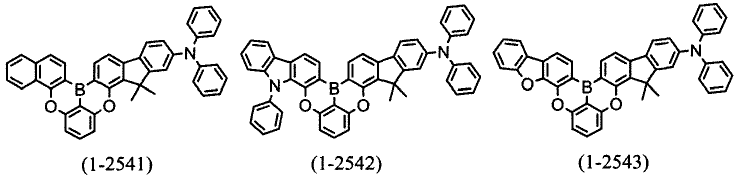

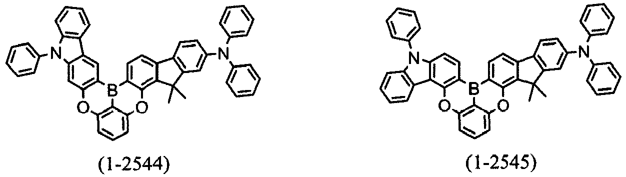

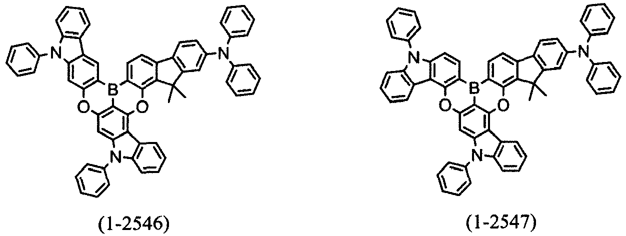

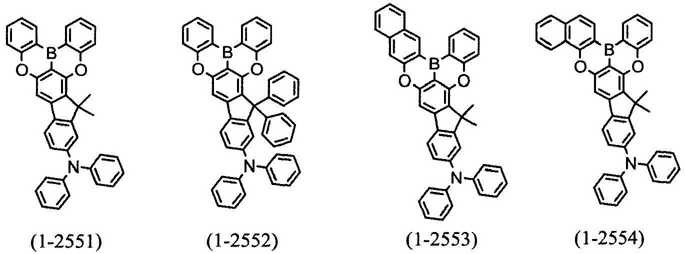

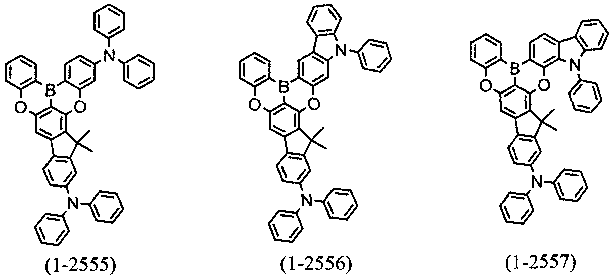

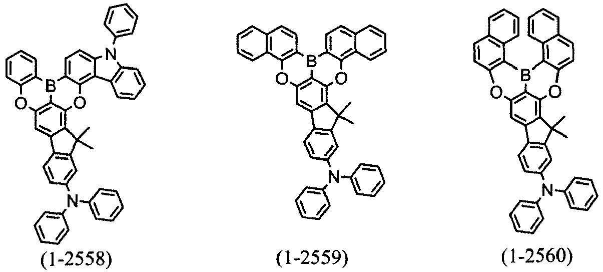

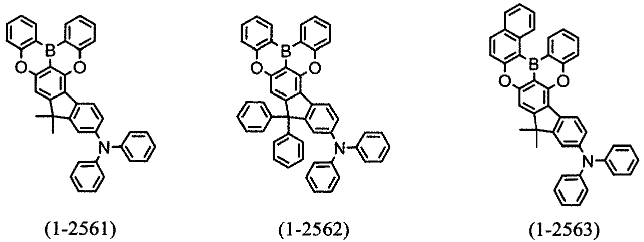

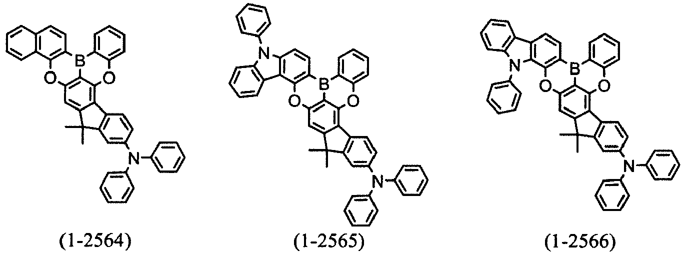

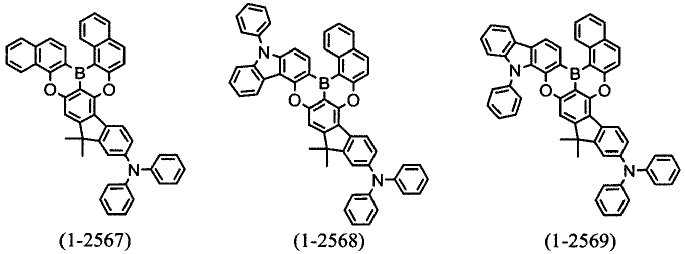

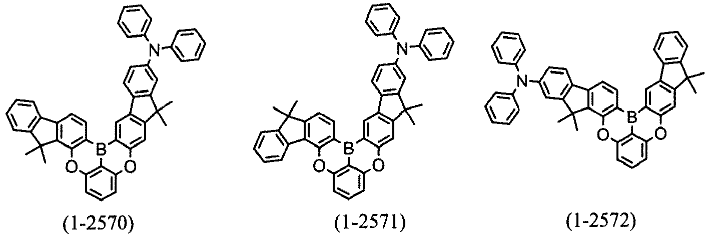

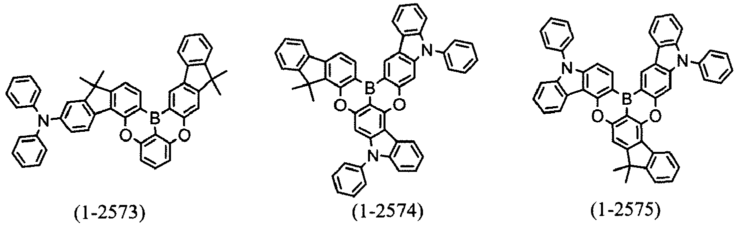

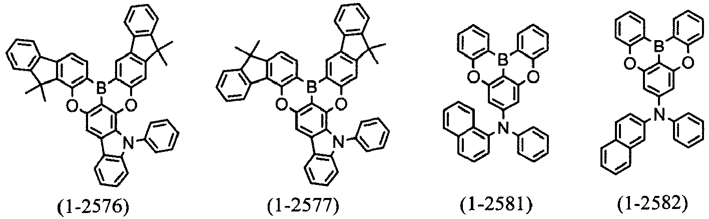

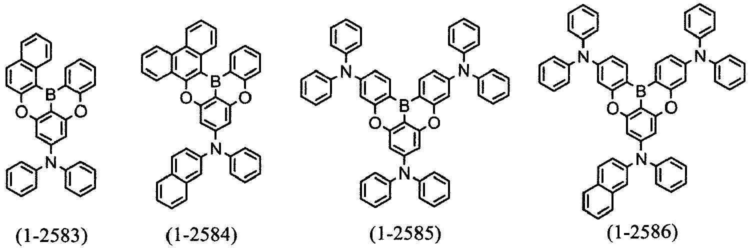

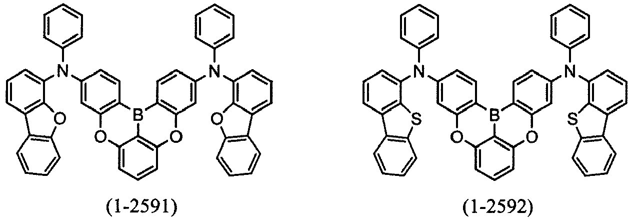

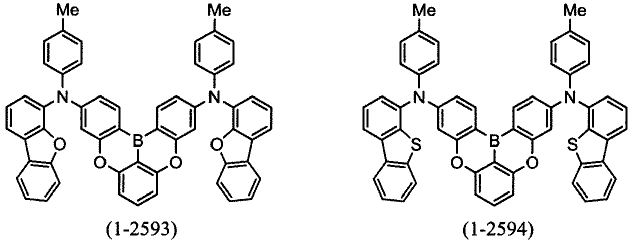

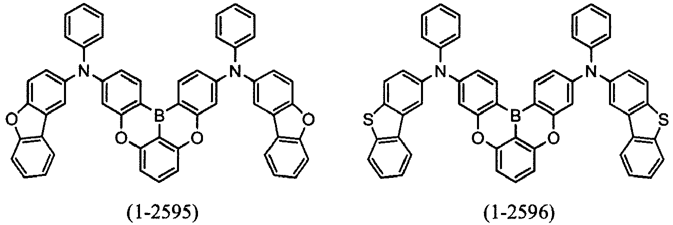

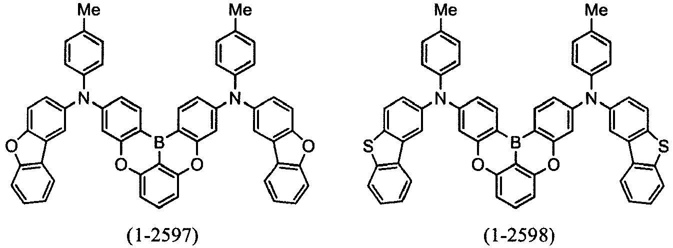

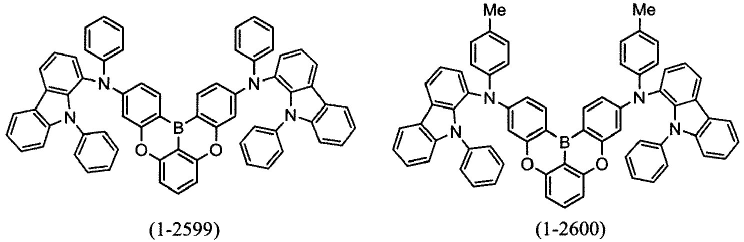

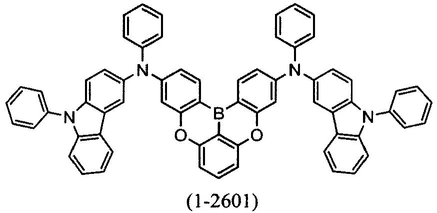

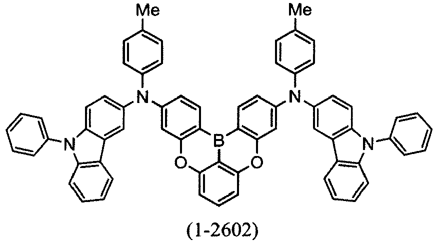

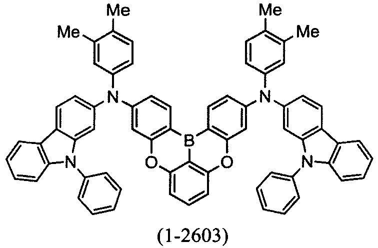

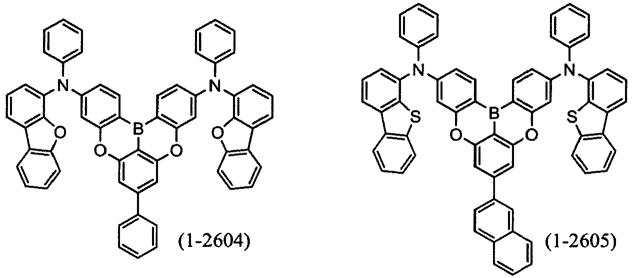

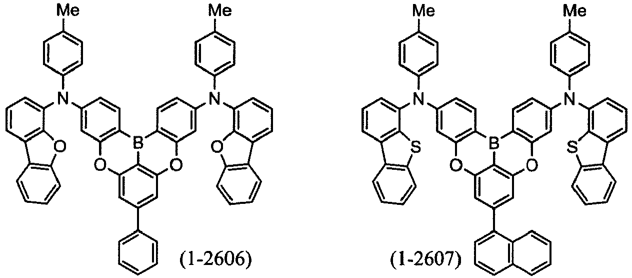

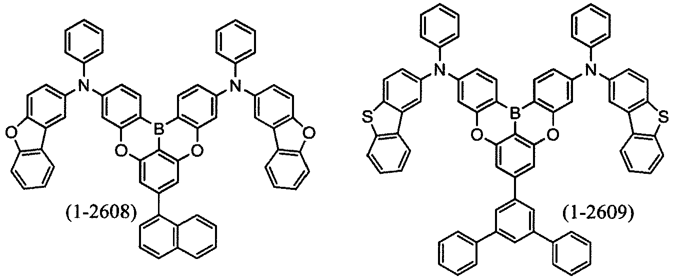

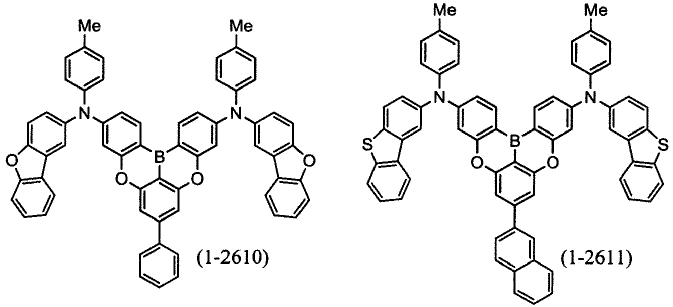

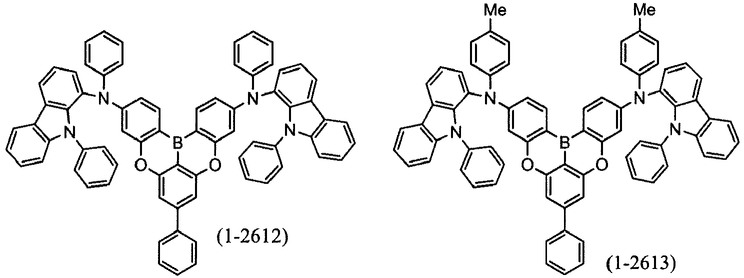

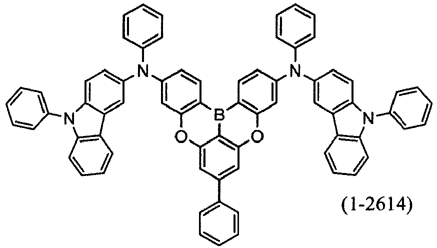

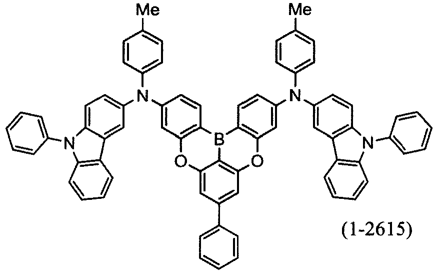

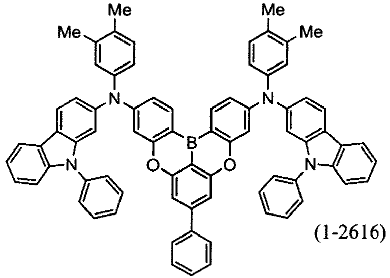

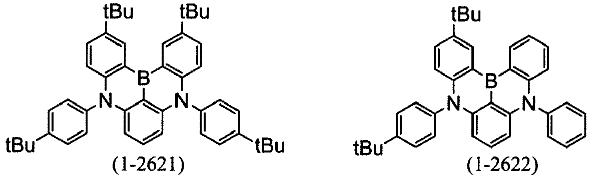

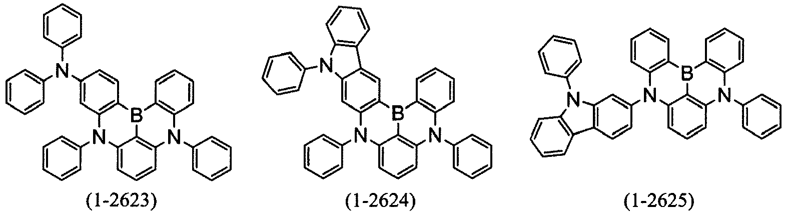

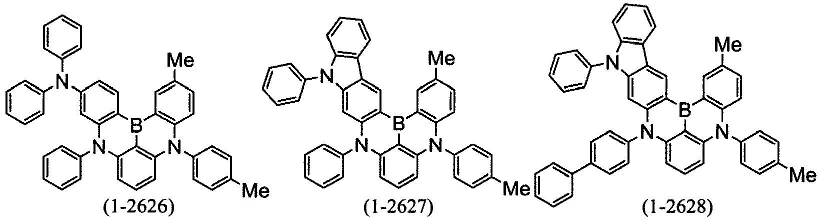

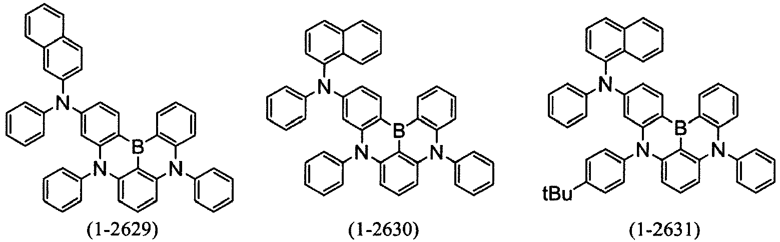

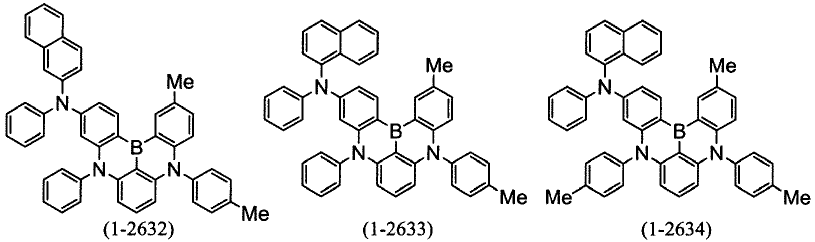

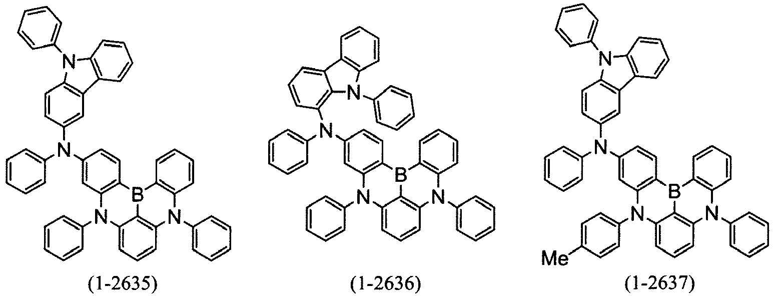

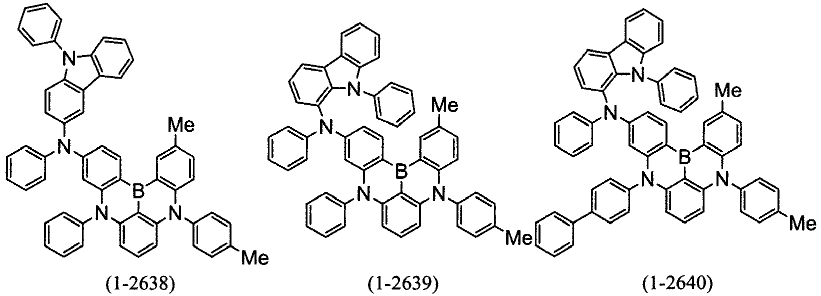

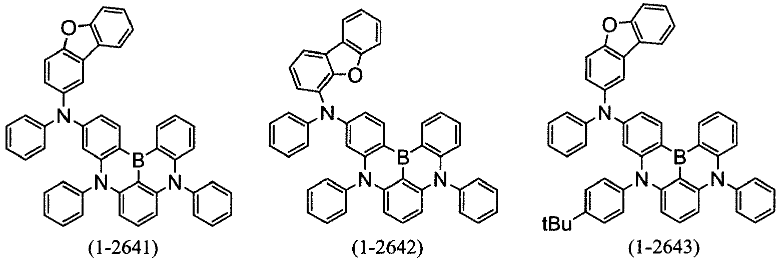

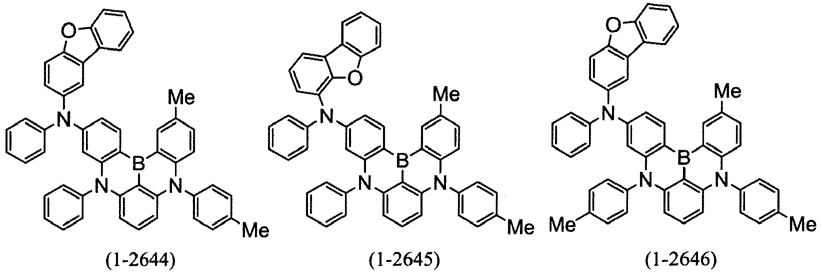

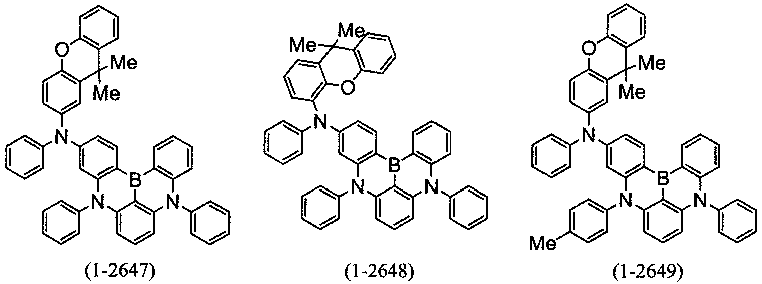

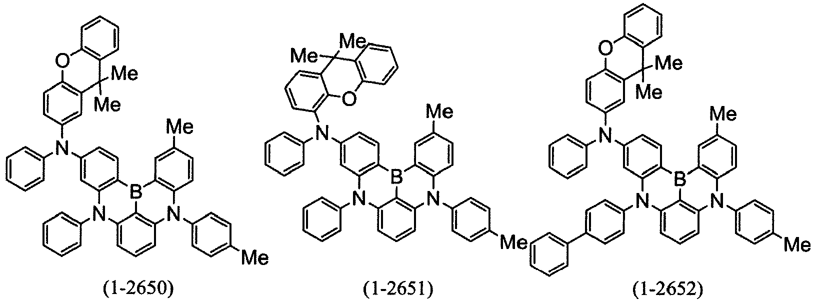

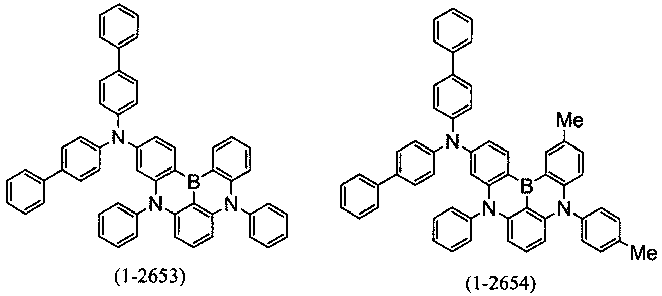

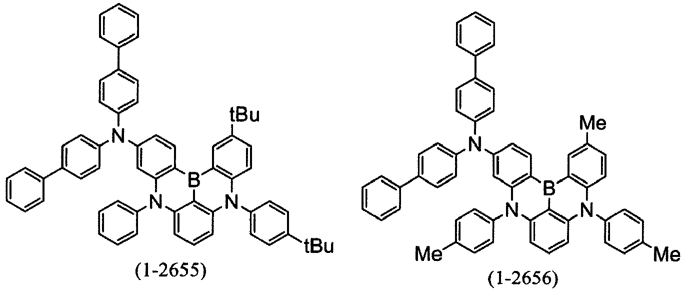

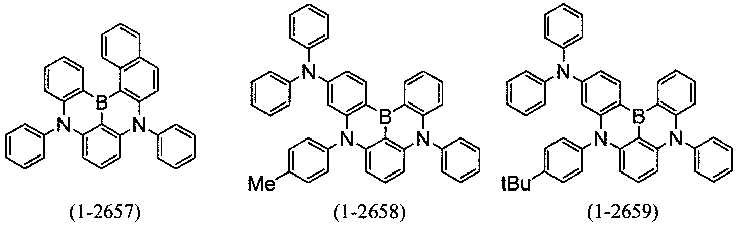

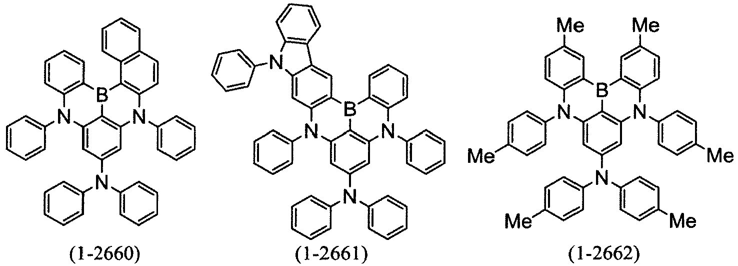

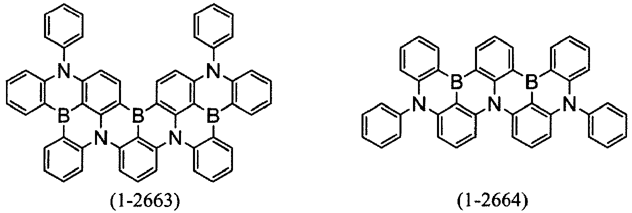

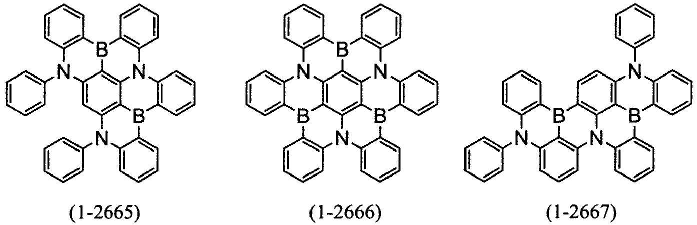

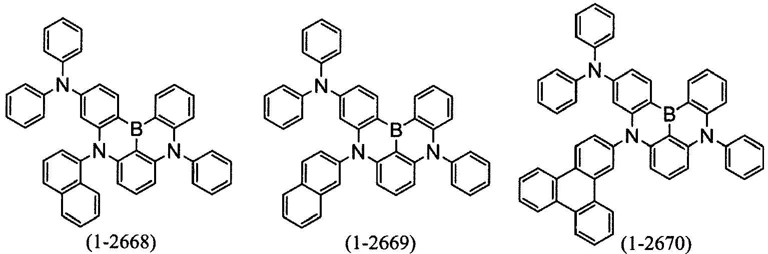

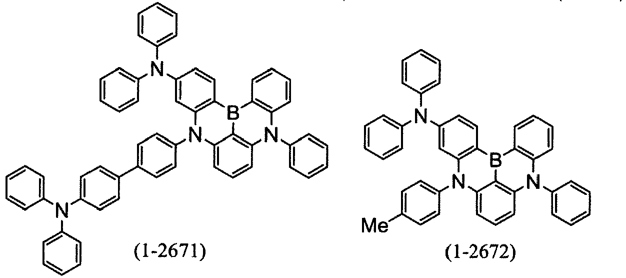

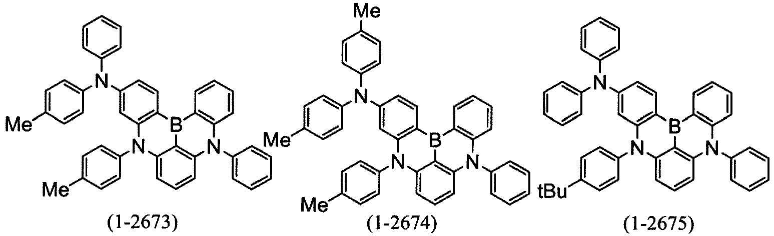

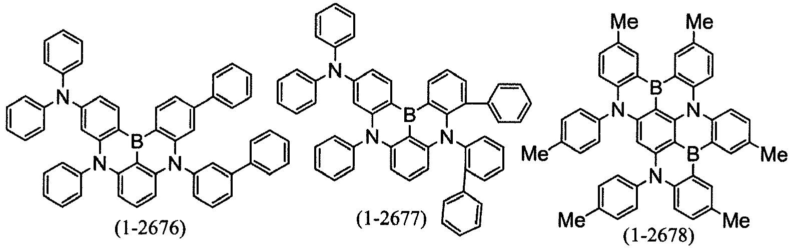

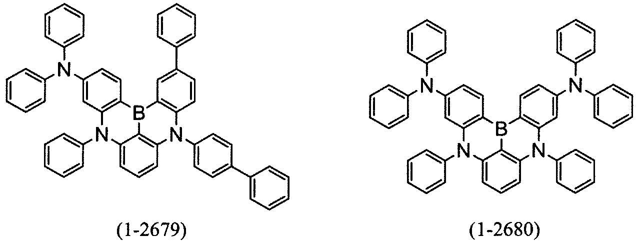

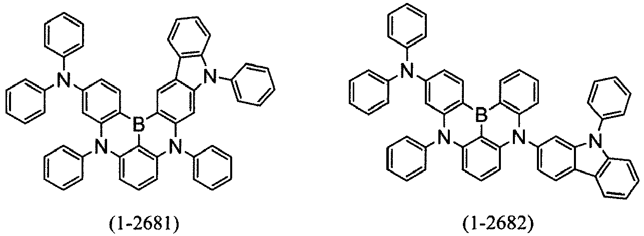

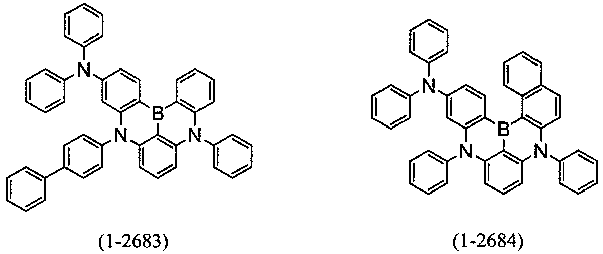

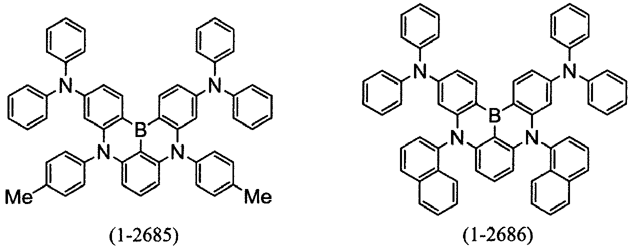

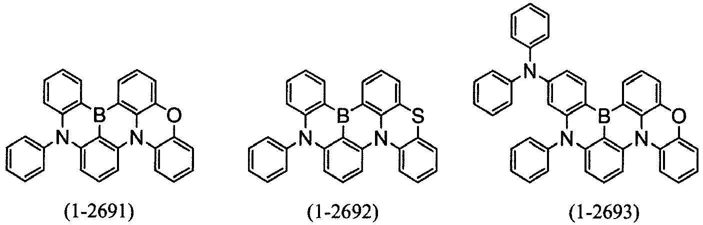

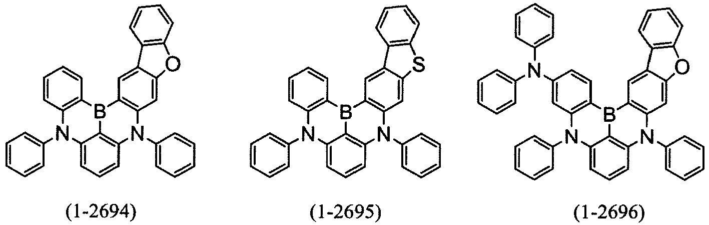

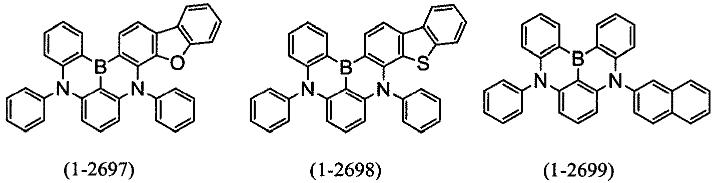

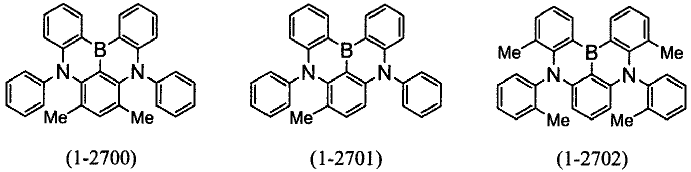

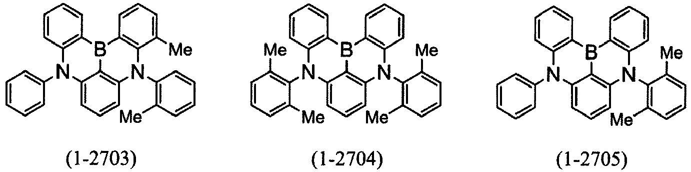

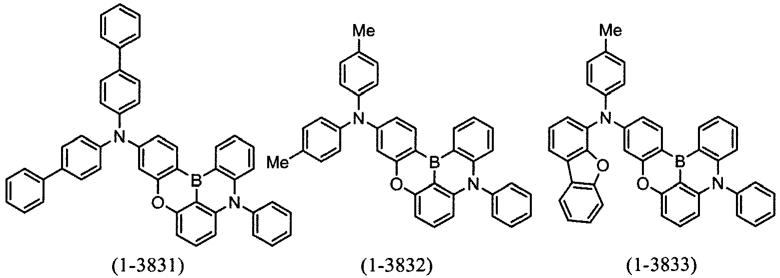

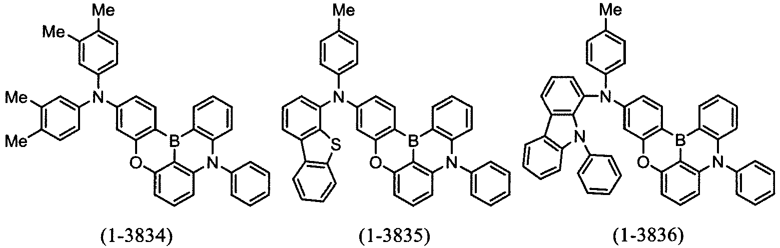

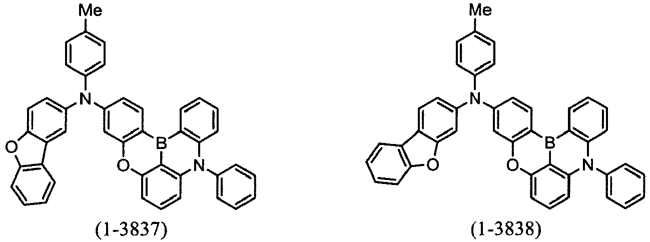

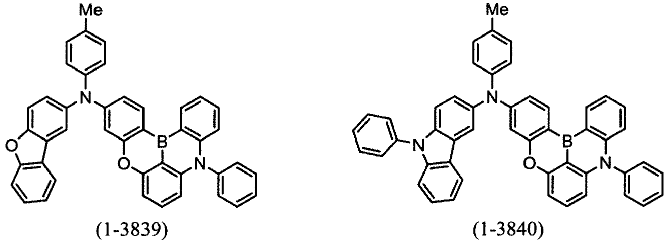

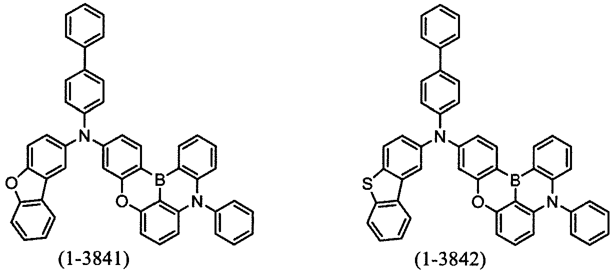

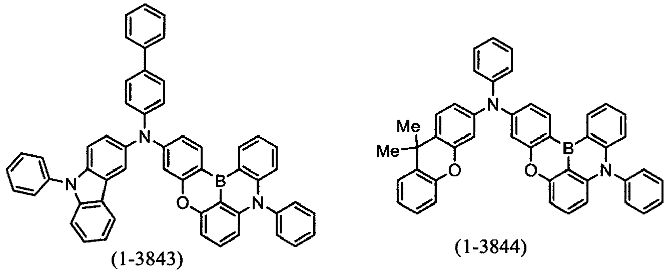

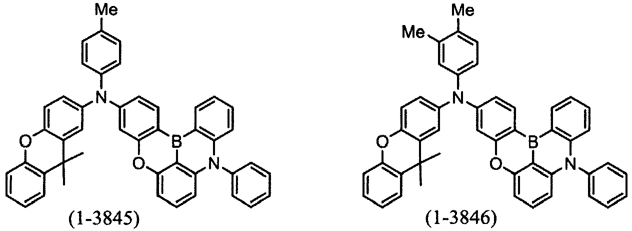

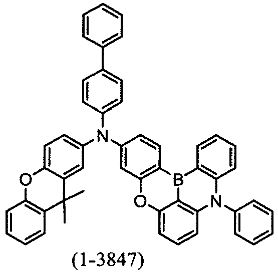

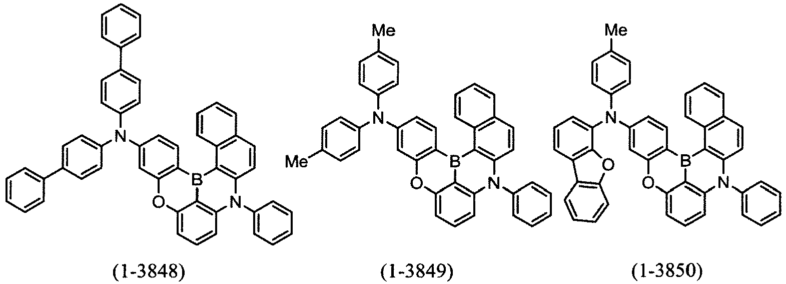

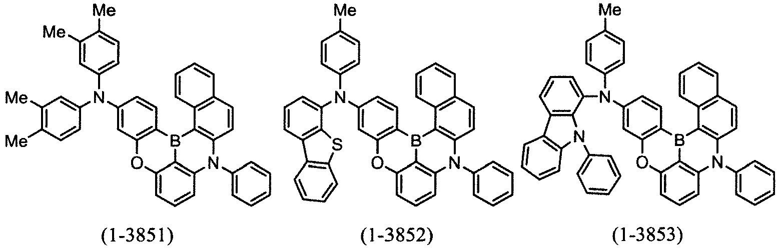

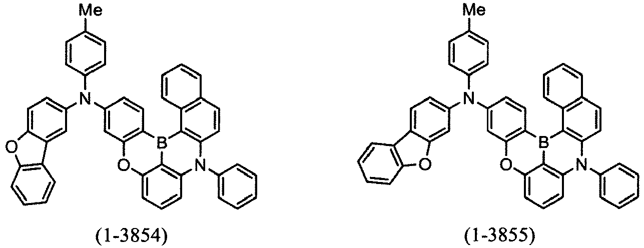

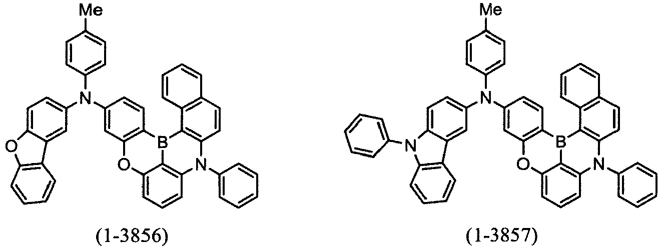

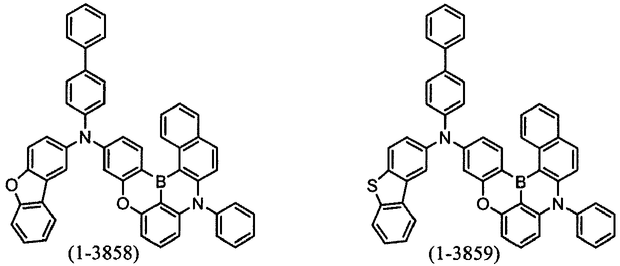

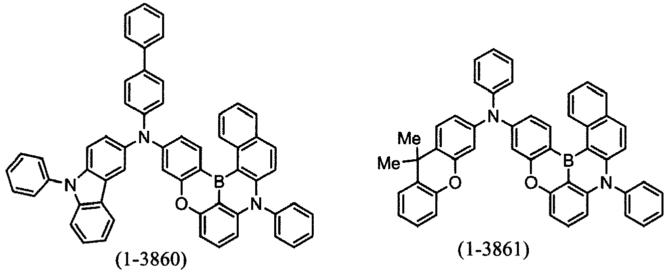

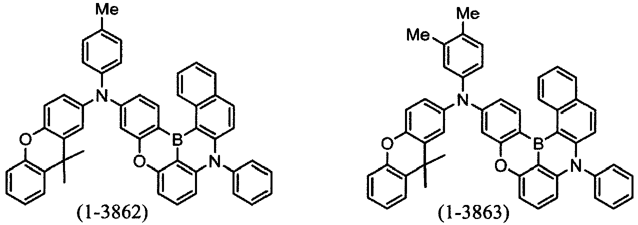

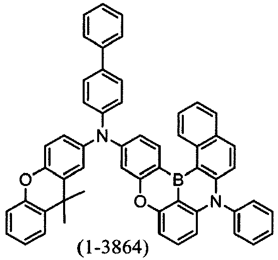

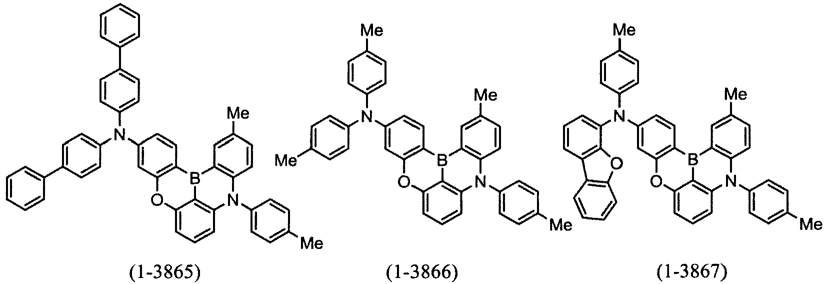

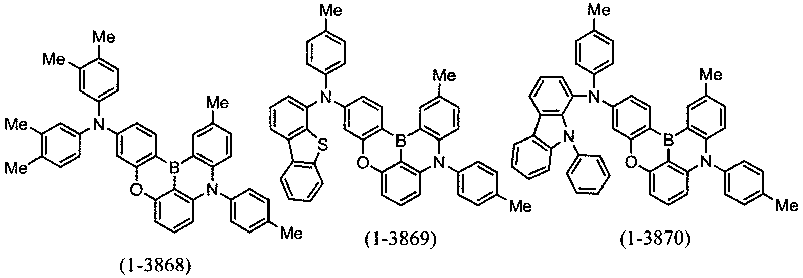

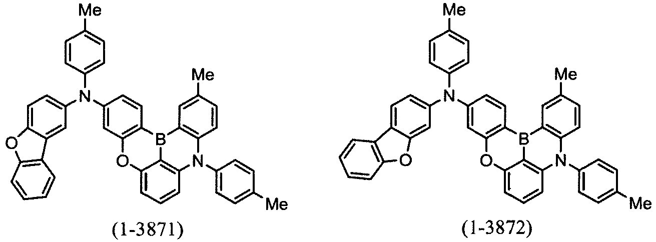

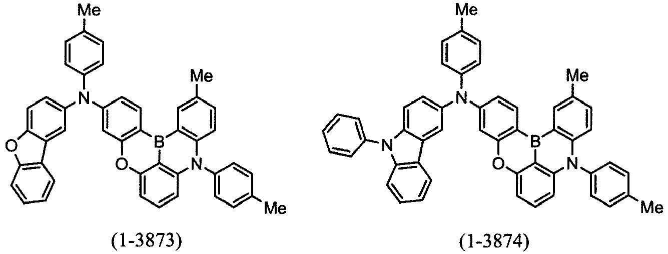

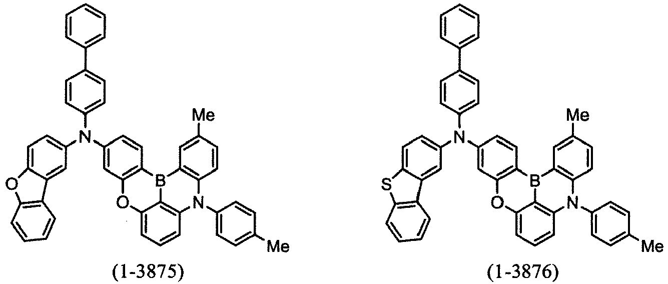

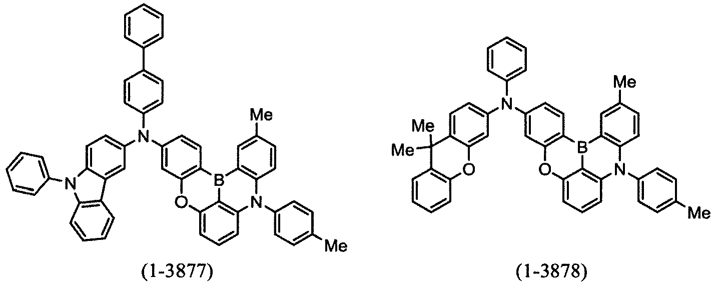

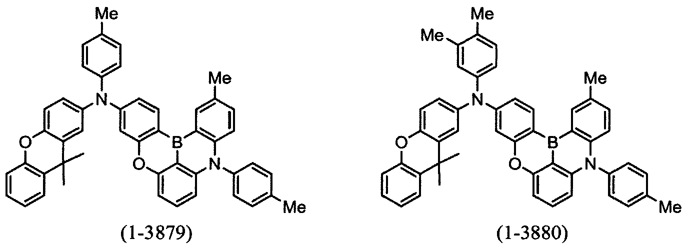

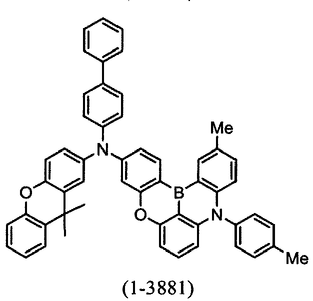

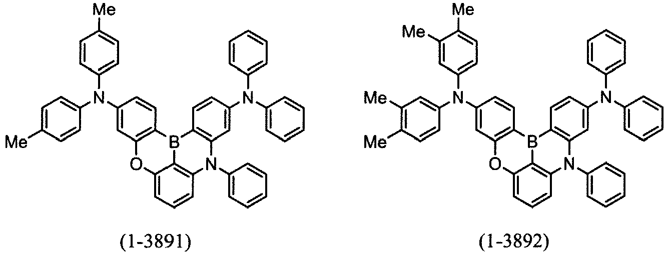

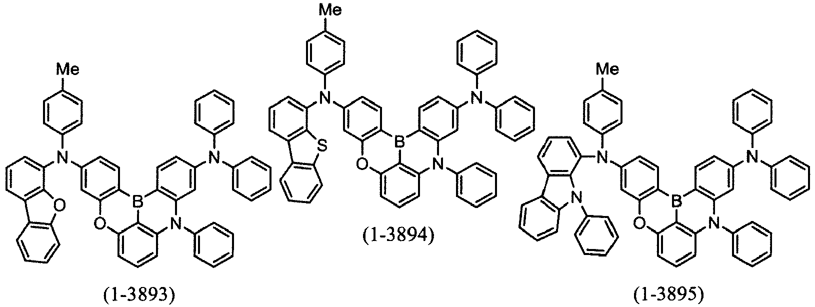

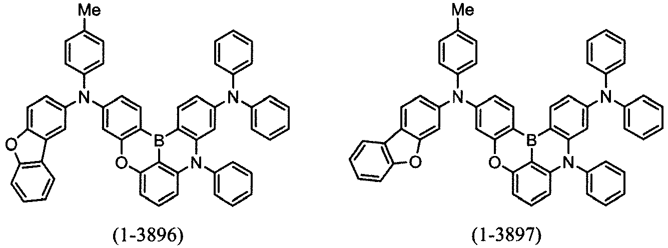

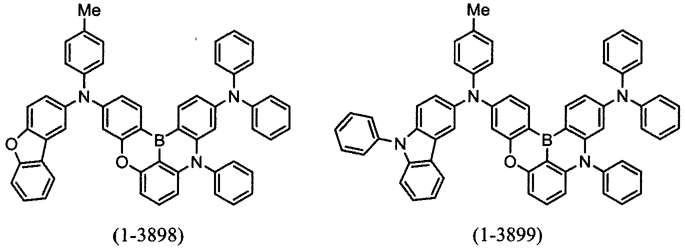

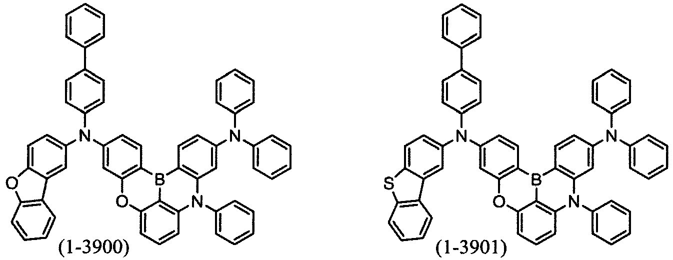

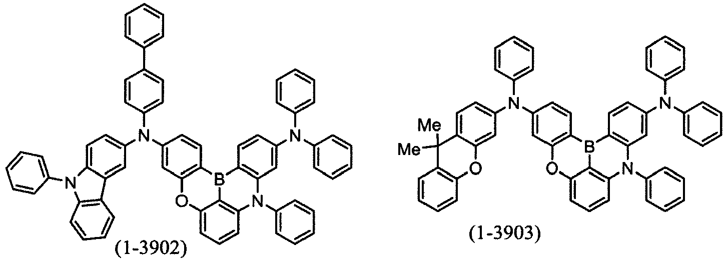

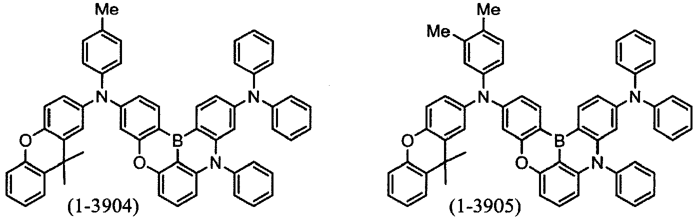

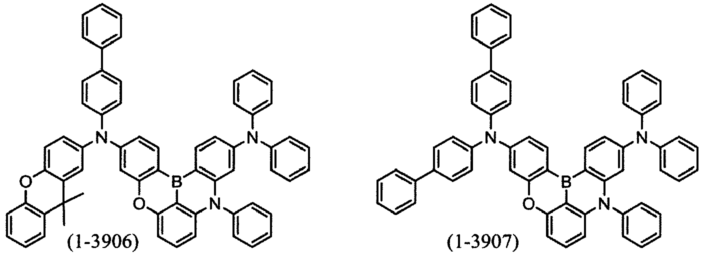

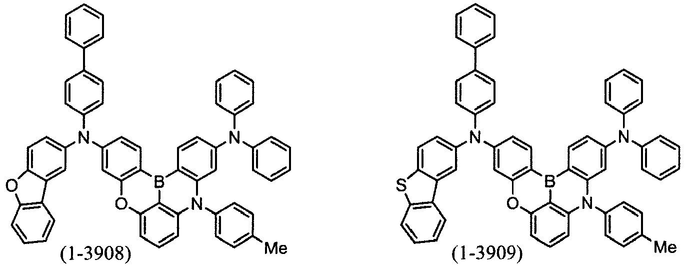

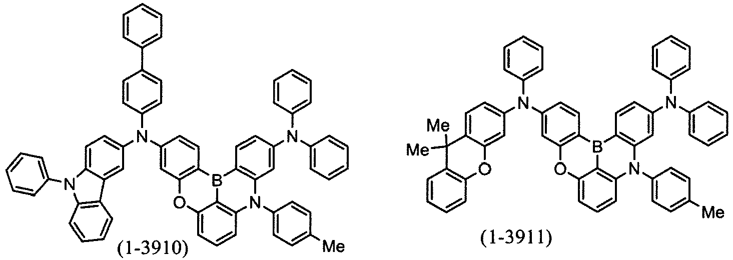

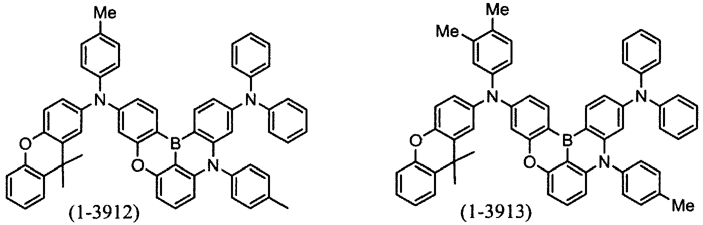

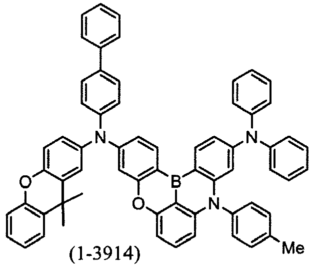

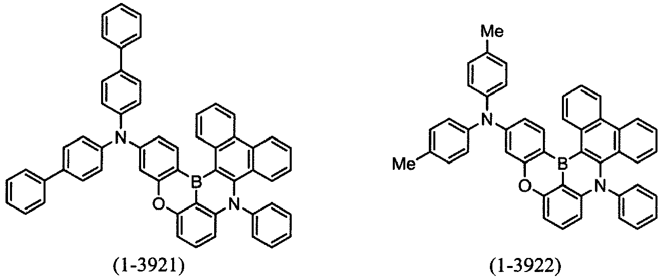

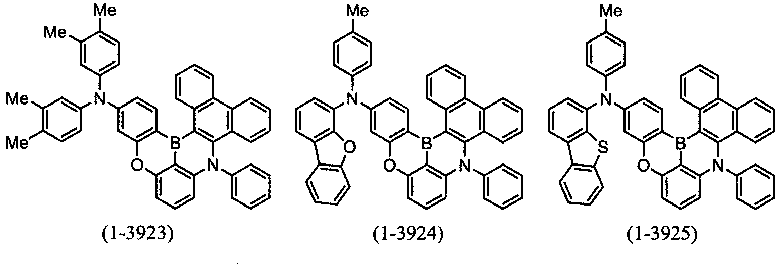

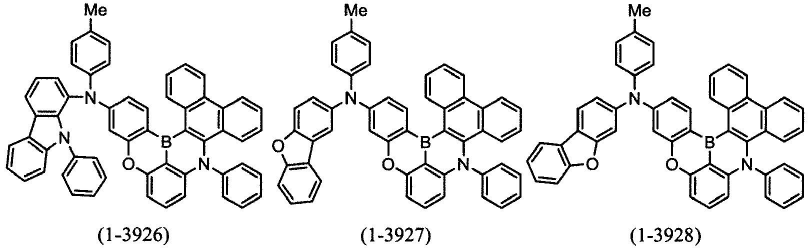

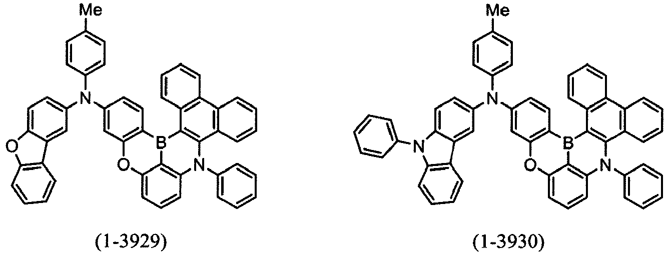

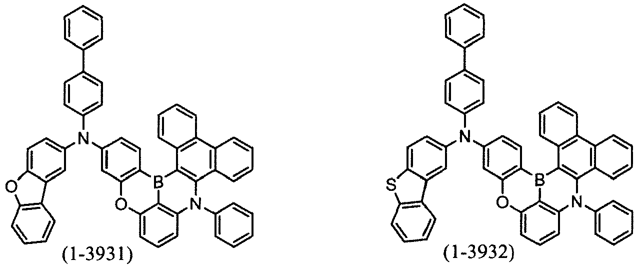

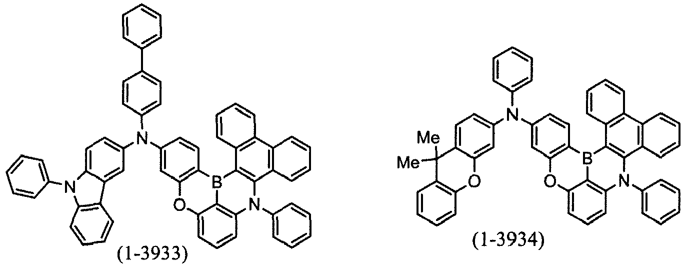

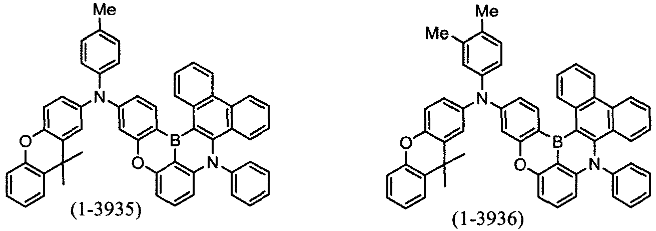

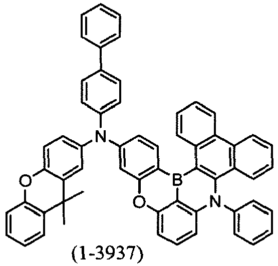

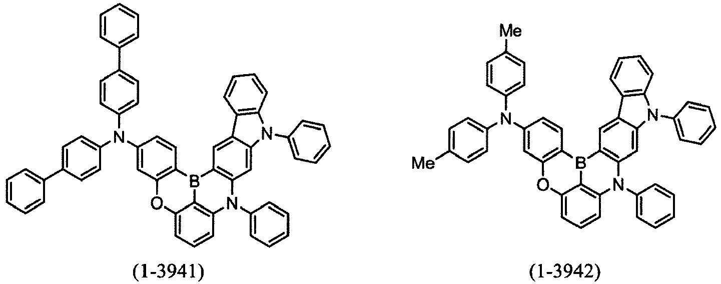

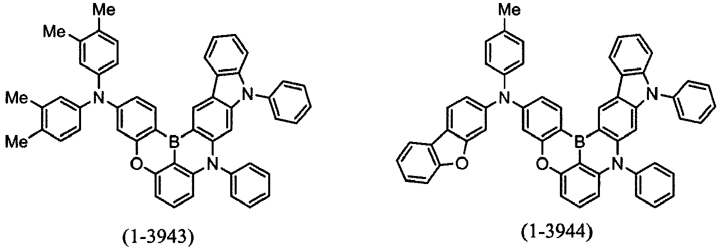

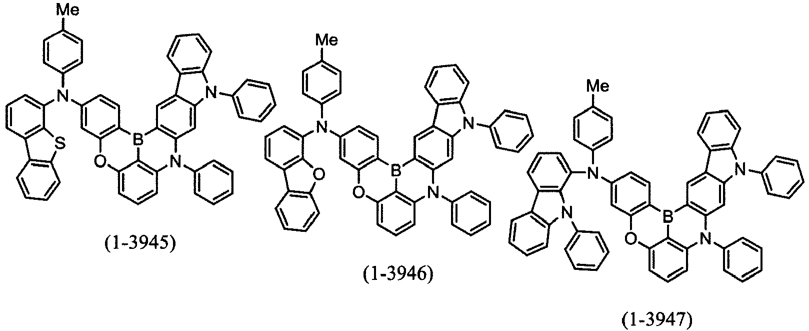

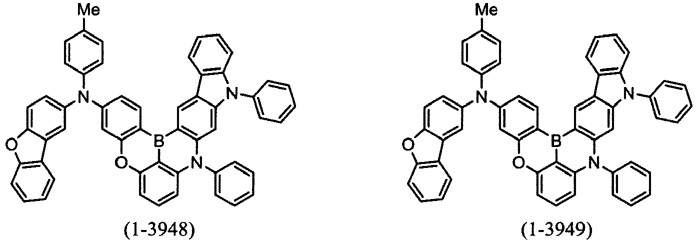

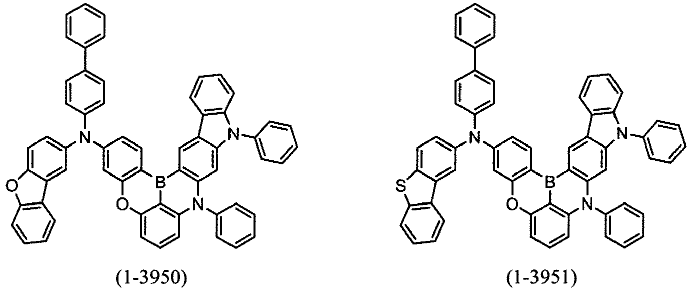

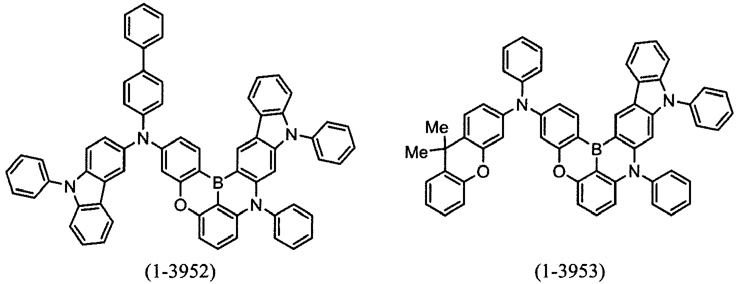

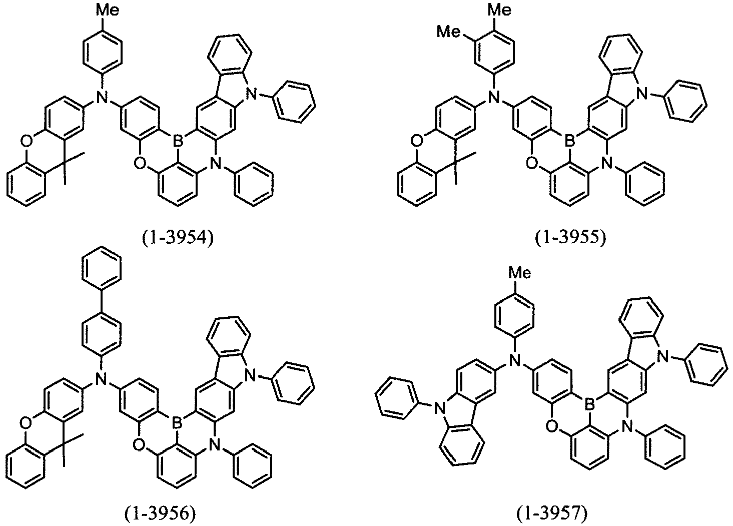

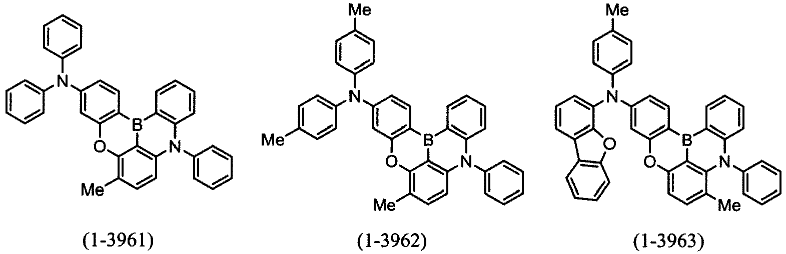

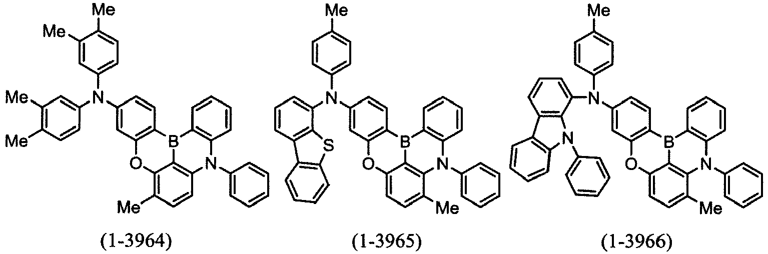

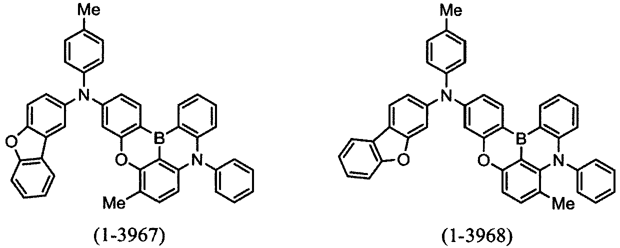

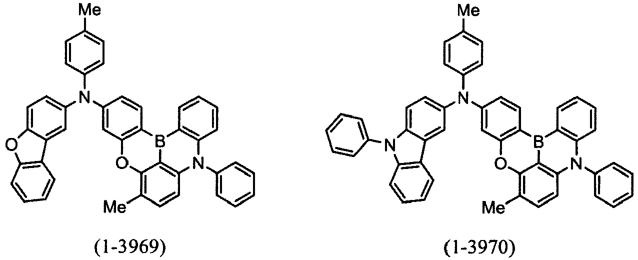

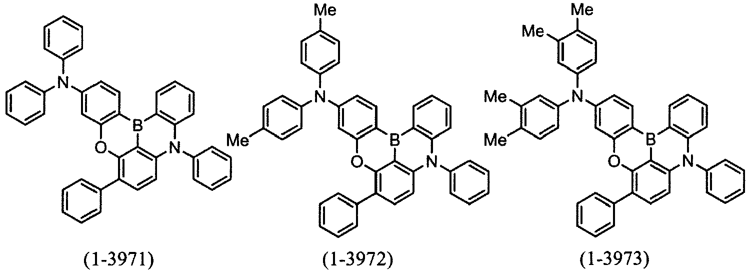

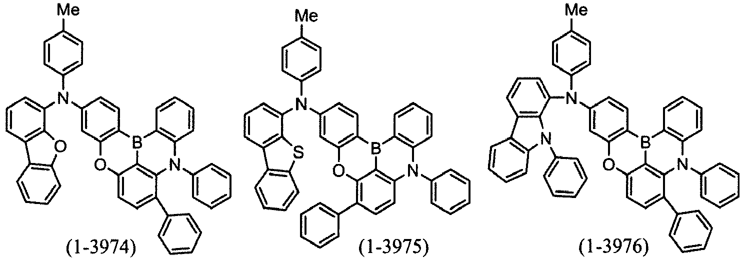

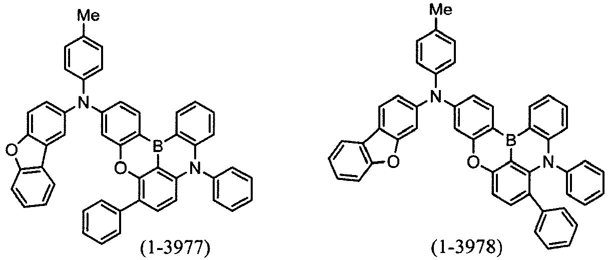

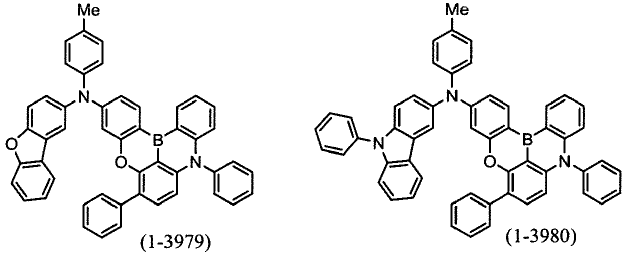

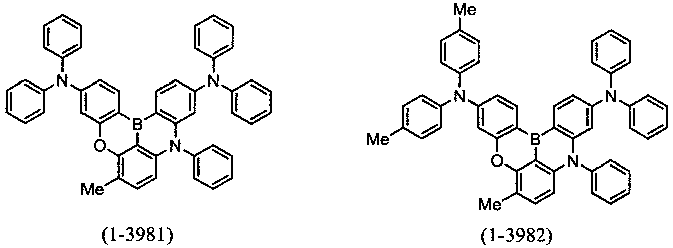

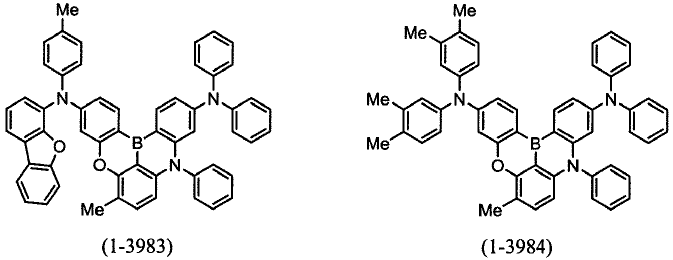

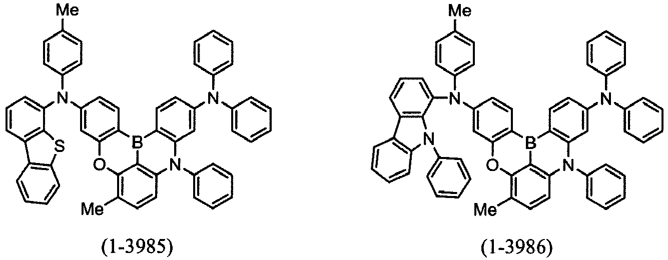

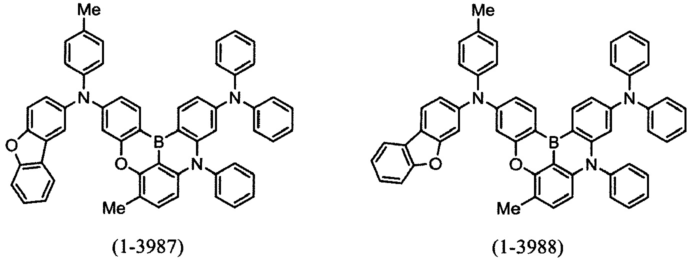

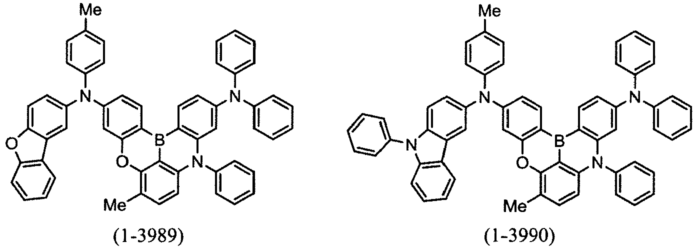

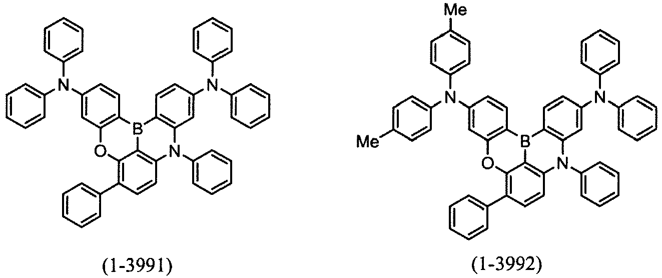

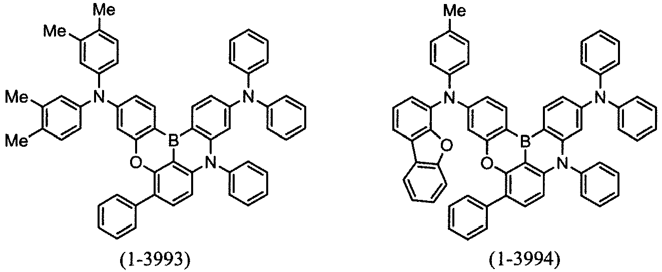

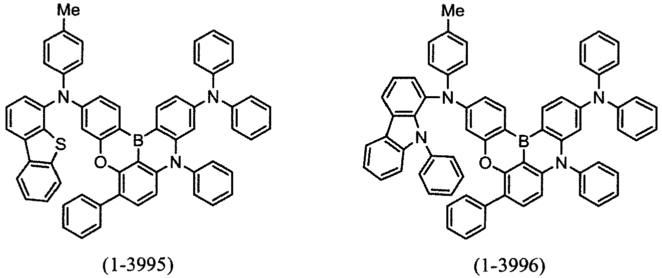

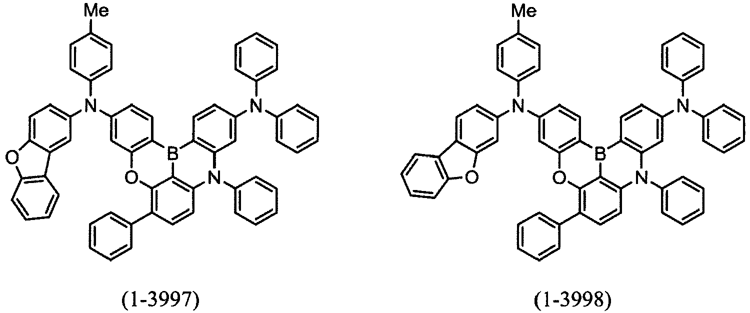

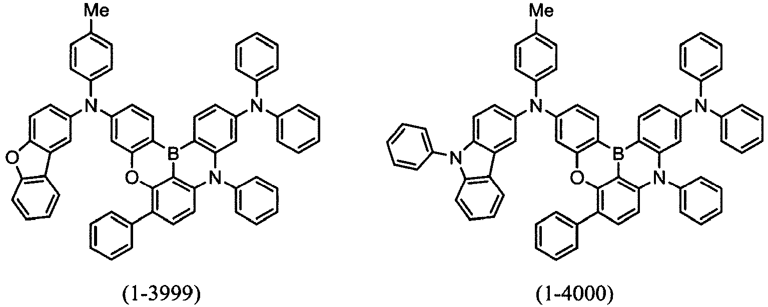

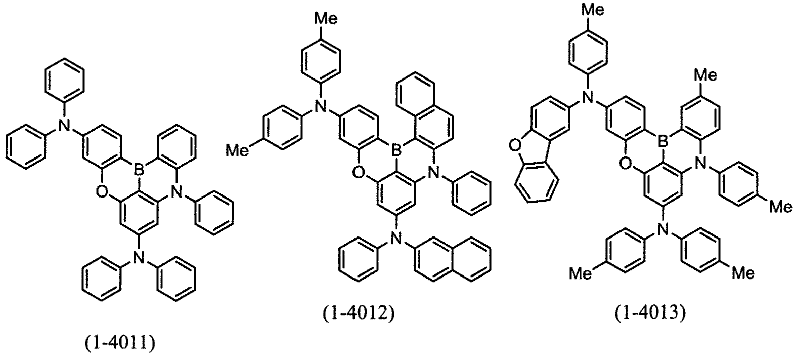

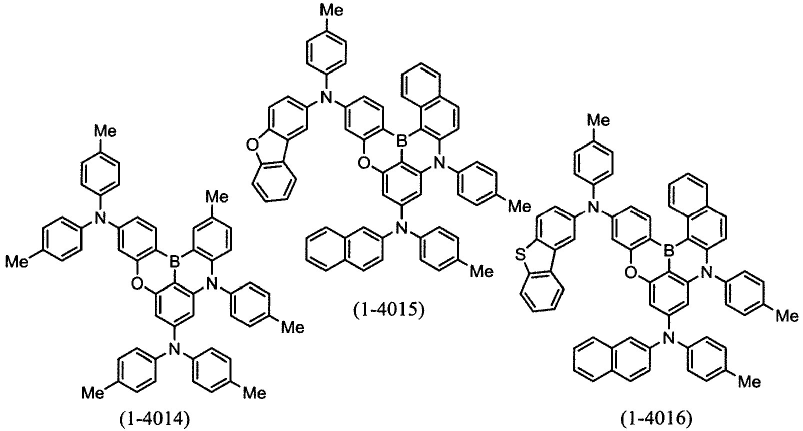

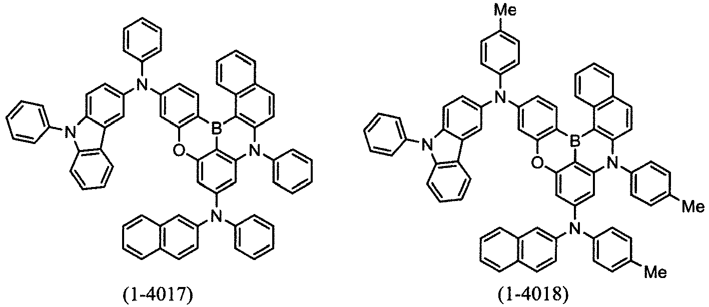

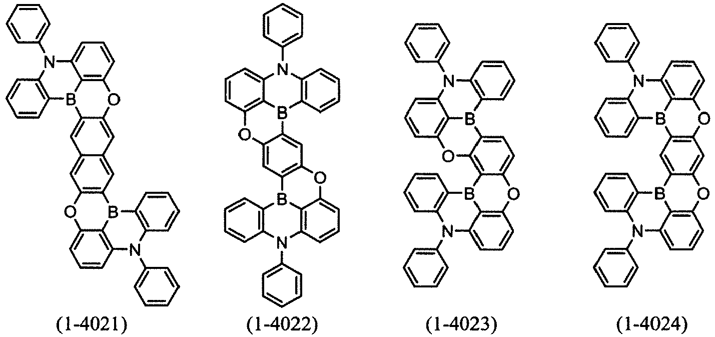

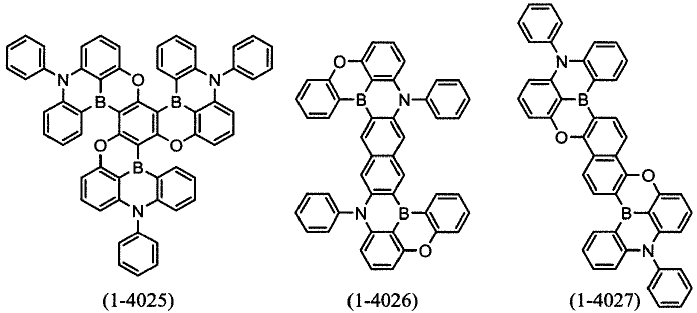

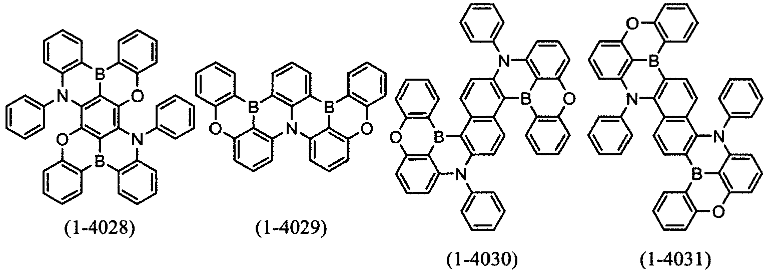

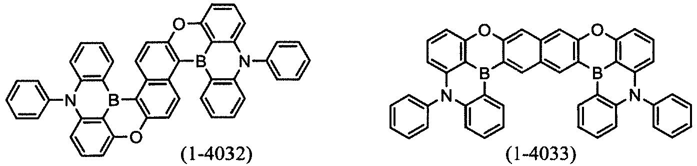

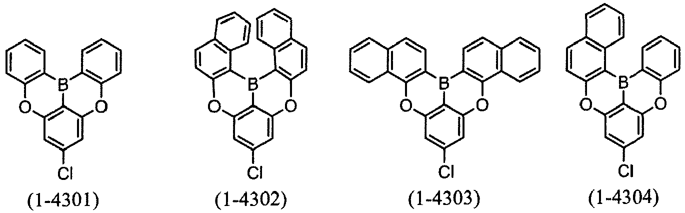

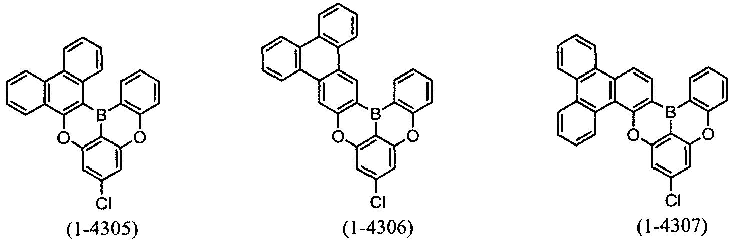

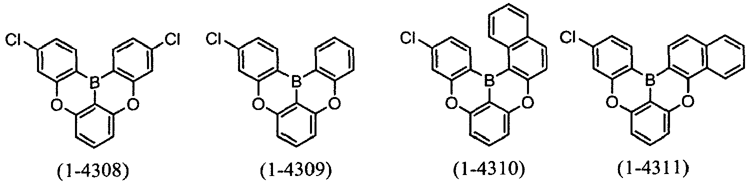

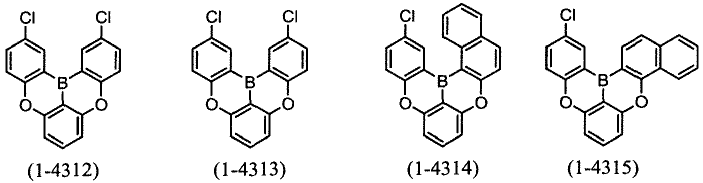

In regard to the polycyclic aromatic compound of the present invention and oligomers thereof, an increase in the T1 energy (an increase by approximately 0.01 to 0.1 eV) can be expected by introducing a phenyloxy group, a carbazolyl group or a diphenylamino group into the para-position with respect to Y¹ in at least one of ring a, ring b and ring c. Particularly, in a case in which Y¹ represents B (boron), and X¹ and X² each represent O or N-R (wherein R is as described above), when a phenyloxy group is introduced into the para-position with respect to B (boron), the HOMO on the benzene rings, which are ring a, ring b and ring c is more localized to the meta-position with respect to the boron, while the LUMO is localized to the ortho-position and the para-position with respect to the boron. Therefore, particularly, an increase in the T1 energy can be expected.

Specific examples thereof include, for example, compounds represented by the following formulas (1-4401) to (1-4422), and compounds represented by the following formulas (1-4501) to (1-4522) .

Meanwhile, R in the formulas represents an alkyl, and may be any of a linear or a branched alkyl. Examples thereof include a linear alkyl having 1 to 24 carbon atoms or a branched alkyl having 3 to 24 carbon atoms. An alkyl having 1 to 18 carbon atoms (a branched alkyl having 3 to 18 carbon atoms) is preferred, an alkyl having 1 to 12 carbon atoms (a branched alkyl having 3 to 12 carbon atoms) is more preferred, an alkyl having 1 to 6 carbon atoms (a branched alkyl having 3 to 6 carbon atoms) is even more preferred, and an alkyl having 1 to 4 carbon atoms (a branched alkyl having 3 or 4 carbon atoms) is particularly preferred. Also, other examples of R include a phenyl.

Furthermore, "PhO-" represents a phenyloxy group, and this phenyl may be substituted by, for example, a linear or branched alkyl as in formula (1-4421-1). For example, the phenyl may be substituted by a linear alkyl having 1 to 24 carbon atoms or a branched alkyl having 3 to 24 carbon atoms, an alkyl having 1 to 18 carbon atoms (a branched alkyl having 3 to 18 carbon atoms), an alkyl having 1 to 12 carbon atoms (a branched alkyl having 3 to 12 carbon atoms), an alkyl having 1 to 6 carbon atoms (a branched alkyl having 3 to 6 carbon atoms), or an alkyl having 1 to 4 carbon atoms (a branched alkyl having 3 or 4 carbon atoms).

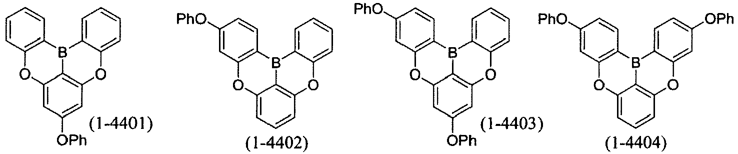

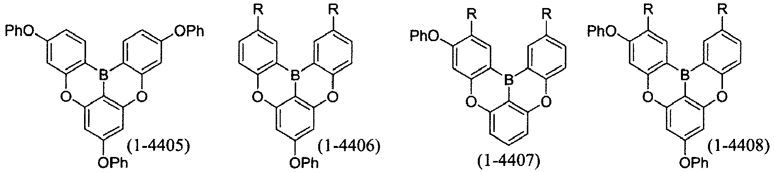

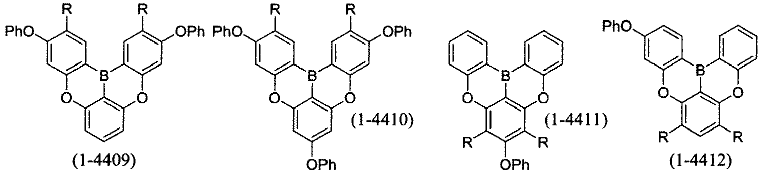

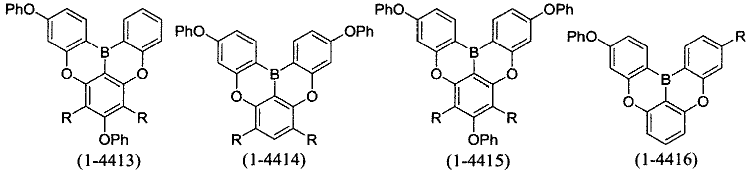

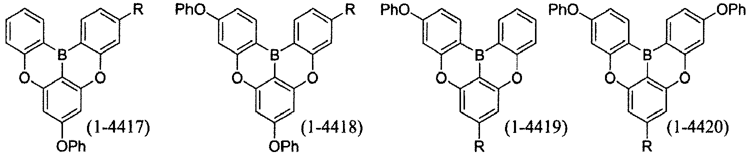

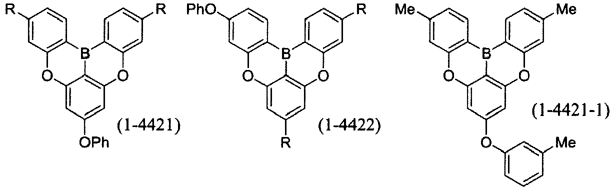

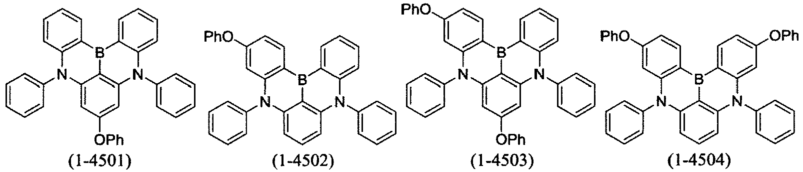

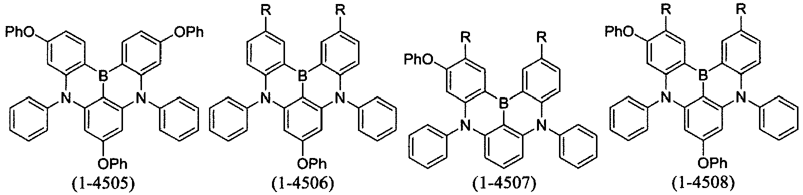

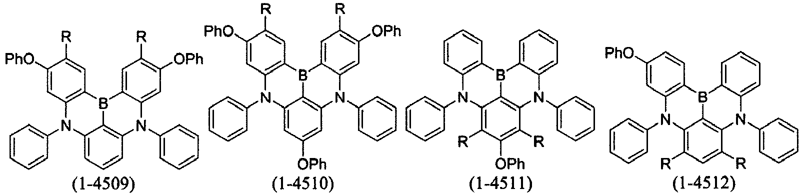

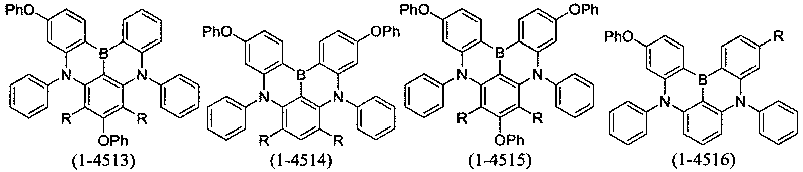

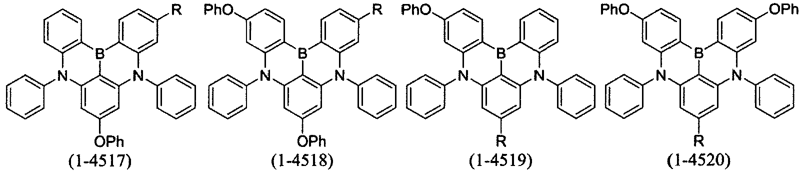

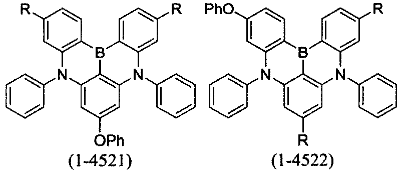

Furthermore, specific examples of the polycyclic aromatic compound of the present invention and oligomers thereof include compounds obtained by substituting at least one hydrogen atom on one or plural aromatic rings in the compounds represented by the above formulas (1-1) to (1-825), formulas (1-1001) to (1-1281), formulas (1-1301) to (1-1311), formulas (1-1351) to (1-1361), formulas (1-1401) to (1-1460), formulas (1-2001) to (1-2299), formulas (1-2301) to (1-2619), formulas (1-2621) to (1-2705), formulas (1-3581) to (1-3828), formulas (1-3831) to (1-4033), formulas (1-4041) to (1-4288), formulas (1-4301) to (1-4349), formulas (1-4401) to (1-4422), and formulas (1-4501) to (1-4522), by one or plural alkyls or aryls. More preferably, such compounds substituted by one or two alkyls having 1 to 12 carbon atoms, or by one or two aryls having 6 to 10 carbon atoms, may be mentioned as specific examples.

Specifically, compounds represented by the following formulas (1-1-R) to formula (1-4401-R) may be mentioned as examples. R's in the following formulas each independently represent an alkyl having 1 to 12 carbon atoms or an aryl having 6 to 10 carbon atoms, and preferably an alkyl or phenyl having 1 to 4 carbon atoms; and n's each independently represent 0 to 2, and preferably 1.

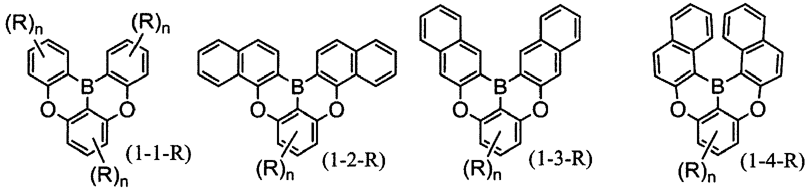

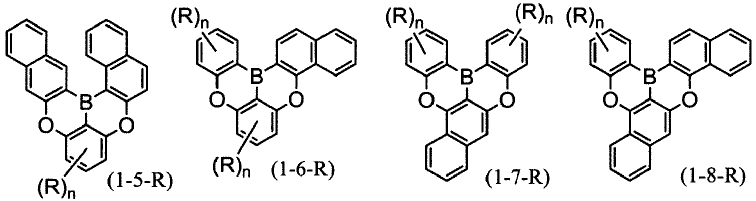

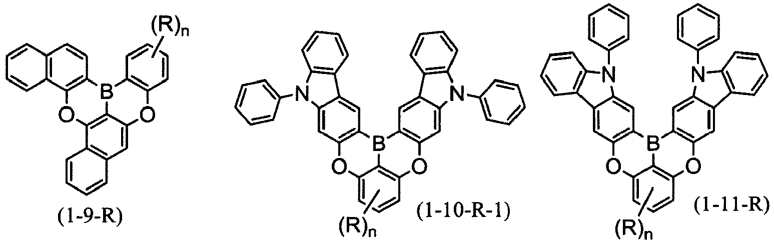

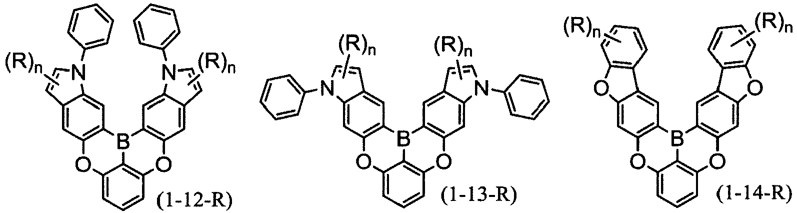

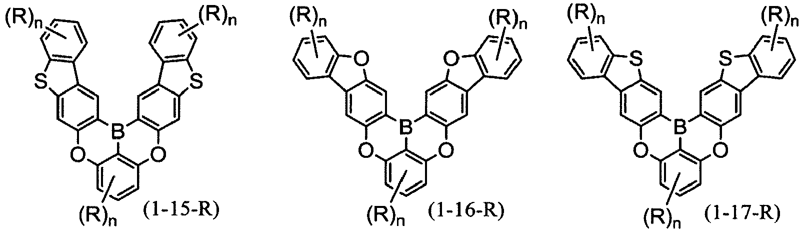

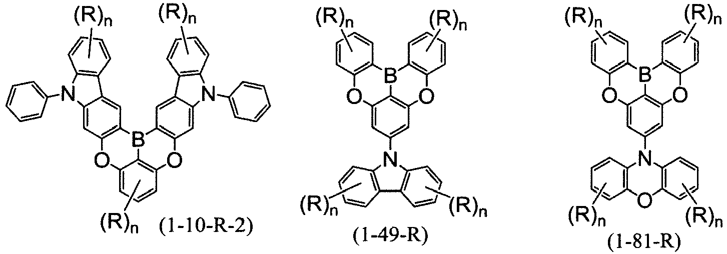

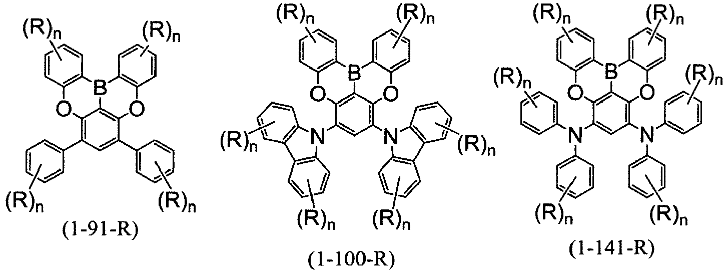

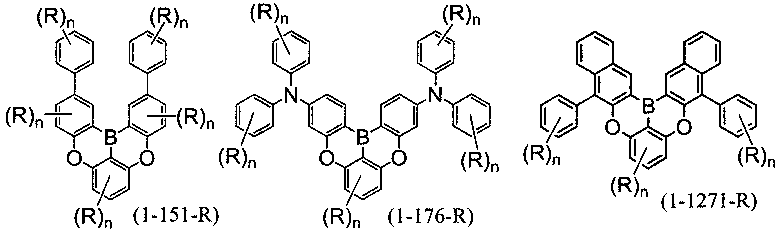

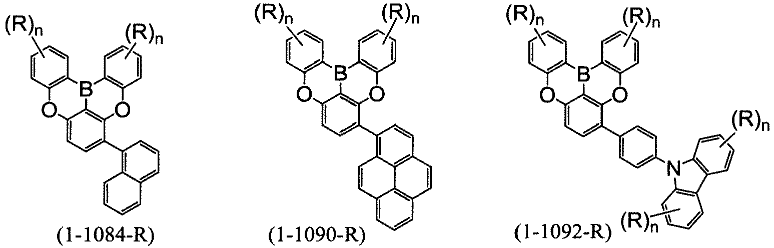

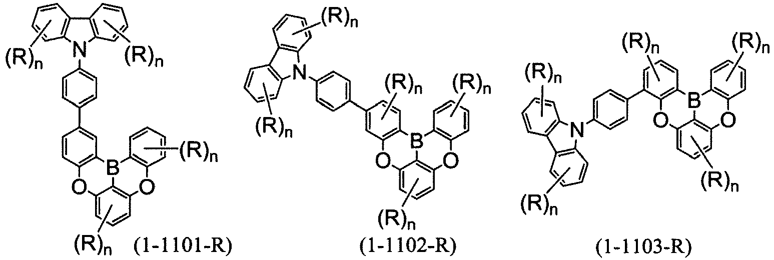

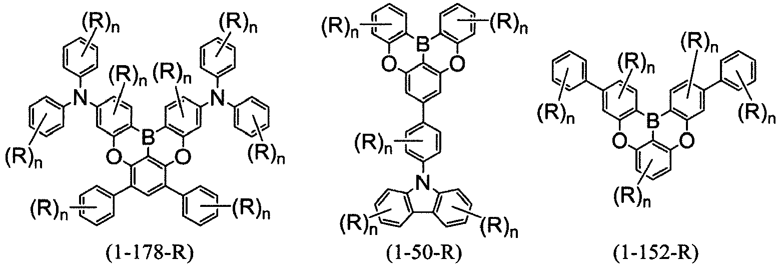

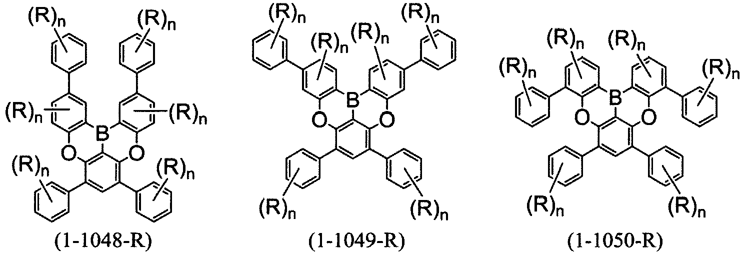

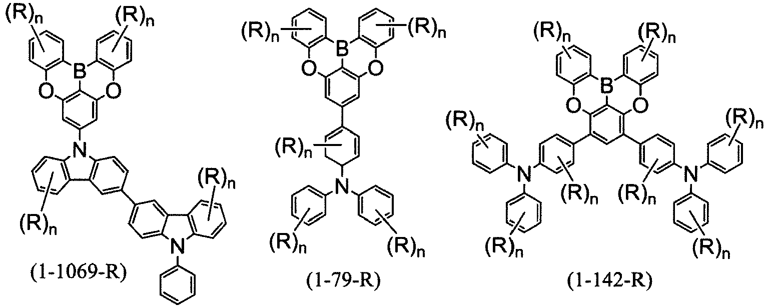

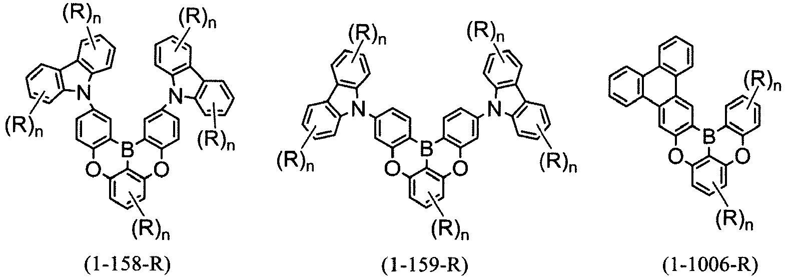

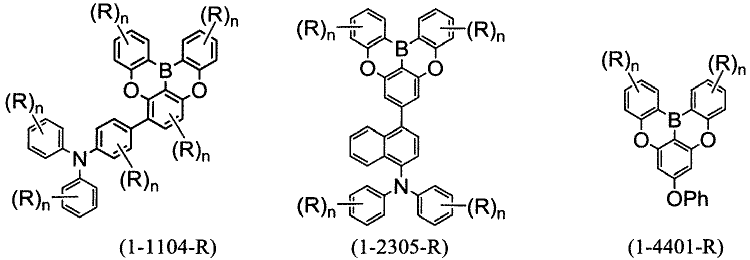

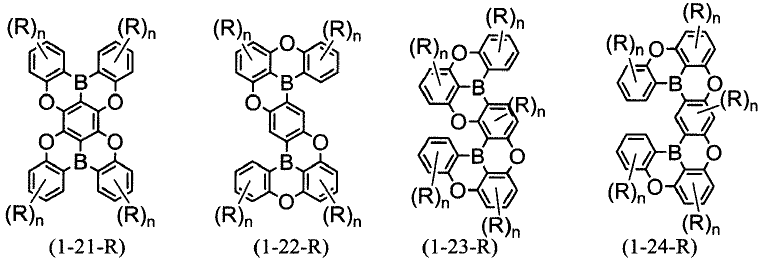

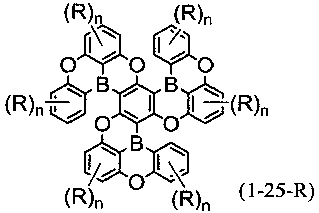

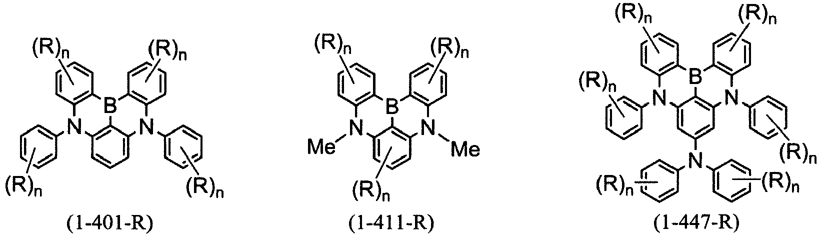

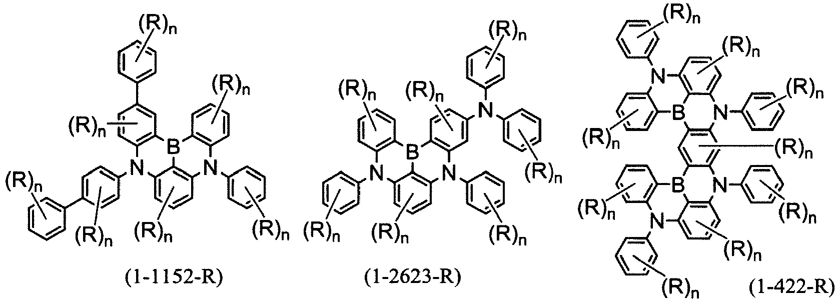

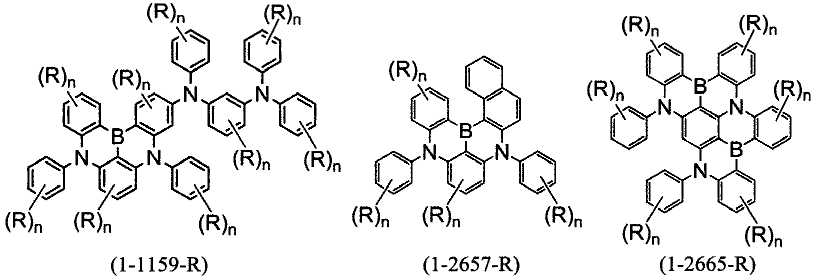

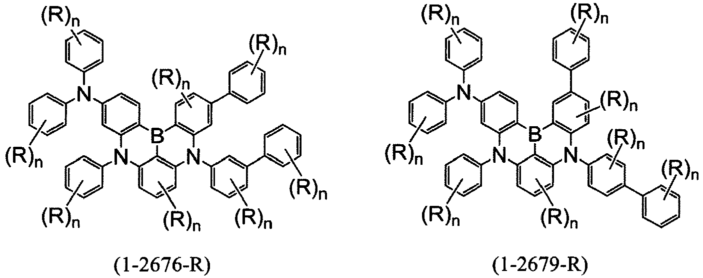

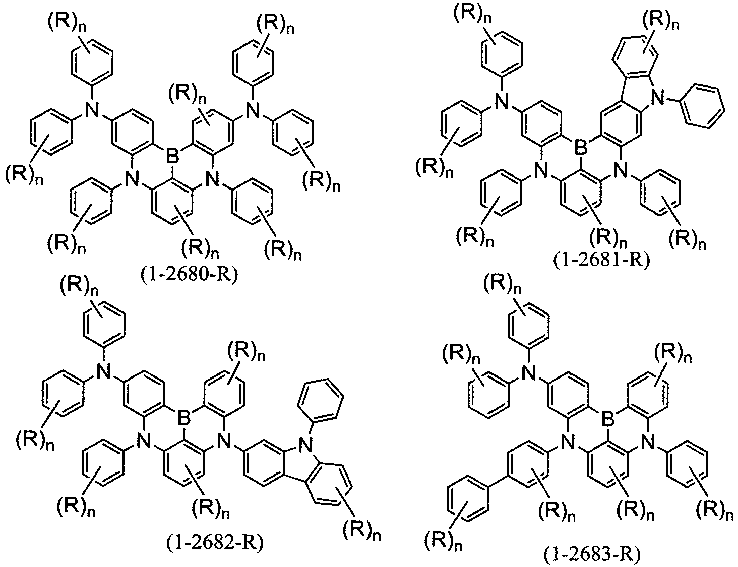

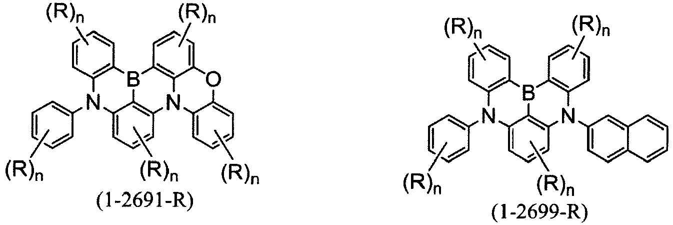

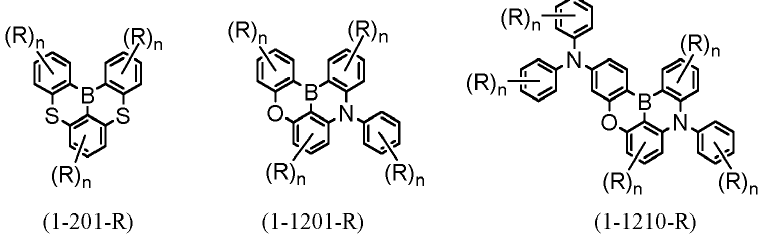

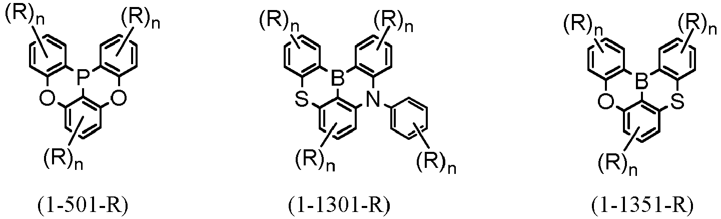

Furthermore, a specific example of the polycyclic aromatic compound of the present invention and oligomers thereof may be a compound in which at least one hydrogen atom in one or plural phenyl groups or one phenylene group in the compound has been substituted by one or plural alkyls each having 1 to 4 carbon atoms, and preferably 1 to 3 carbon atoms (preferably one or plural methyl groups). A more preferred example may be a compound in which the hydrogen atoms at the ortho-positions of one phenyl group (both of the two sites, preferably any one site) or the hydrogen atoms at the ortho-positions of one phenylene group (all of the four sites at maximum, preferably any one site) have been substituted by methyl groups.

Examples of such a compound, even among the compounds represented by the above formulas (1-1) to (1-825), the compounds represented by the above formulas (1-1001) to (1-1281), the compounds represented by the above formulas (1-1301) to (1-1311), the compounds represented by the above formulas (1-1351) to (1-1361), the compounds represented by the above formulas (1-1401) to (1-1460), the compounds represented by the above formulas (1-2001) to (1-2299), the compounds represented by the above formulas (1-2301) to (1-2619), the compounds represented by the above formulas (1-2621) to (1-2705), the compounds represented by the above formulas (1-3581) to (1-3828), the compounds represented by the above formulas (1-3831) to (1-4033), the compounds represented by the above formulas (1-4041) to (1-4288), and the compounds represented by the above formulas (1-4301) to (1-4349), include compounds containing phenyl groups or phenylene groups, in which at least one hydrogen atom in one or plural phenyl groups or one phenylene group has been substituted by one or plural alkyls each having 1 to 4 carbon atoms, and preferably one or plural alkyls each having 1 to 3 carbon atoms (preferably one or plural methyl groups). More preferred examples of such a compound include compounds in which the hydrogen atoms at the ortho-positions of one phenyl group (both of two sites, preferably any one site) or the hydrogen atoms at the ortho-positions of one phenylene group (all of four sites at maximum, preferably any one site) have been substituted by methyl groups.

Particularly, further examples include compounds in which at least one hydrogen atom in one or plural phenyl groups or one phenylene group in the compounds represented by formula (1-1), formula (1-41), formula (1-42), formula (1-45), formula (1-50), formula (1-79), formula (1-83), formula (1-84), formula (1-91), formula (1-94), formula (1-95), formula (1-97), formula (1-151), formula (1-152), formula (1-1021) to formula (1-1036), formula (1-1037), formula (1-1038), formula (1-1039), formula (1-1048), formula (1-1049), formula (1-1050), formula (1-1077), formula (1-1078), formula (1-1079), formula (1-1187), formula (1-1190), formula (1-1191) and formula (1-1192), has been substituted by one or plural alkyls each having 1 to 4 carbon atoms, and preferably one or plural alkyls each having 1 to 3 carbon atoms (preferably one or plural methyl groups). More preferred examples include compounds in which the hydrogen atoms at the ortho-positions of one phenyl group (both of two sites, preferably any one site) or the hydrogen atoms at the ortho-positions of one phenylene group (all of four sites at maximum, preferably any one site) have been substituted by methyl groups.

When at least one hydrogen atom at the ortho-positions of terminal phenyl groups or a p-phenylene group in a compound is substituted by a methyl group or the like, adjoining aromatic rings are likely to intersect each other perpendicularly, and conjugation is weakened. As a result, the triplet excitation energy (E_{T}) can be increased.

Specific examples thereof include compounds represented by the following formula (1-1-1) and compounds represented by the following formula (1-41-1) to formula (1-1050-9).

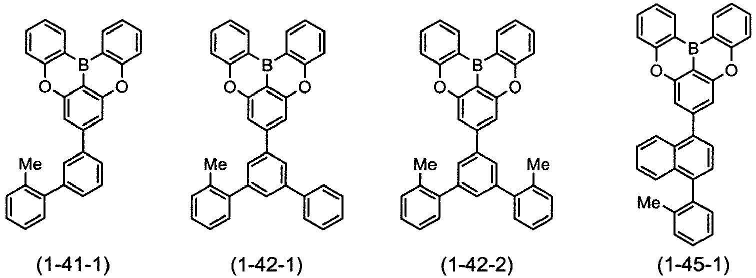

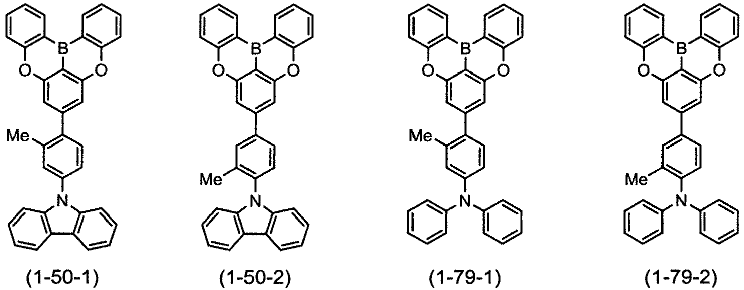

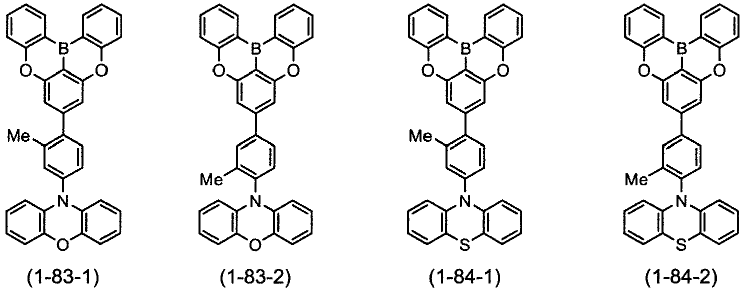

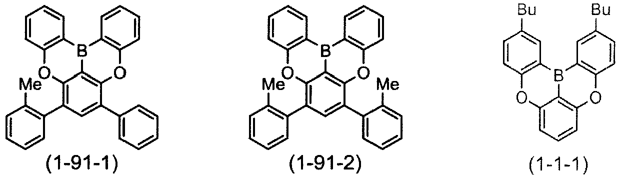

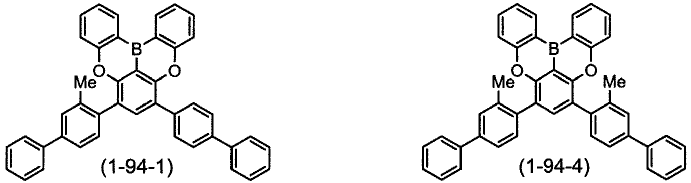

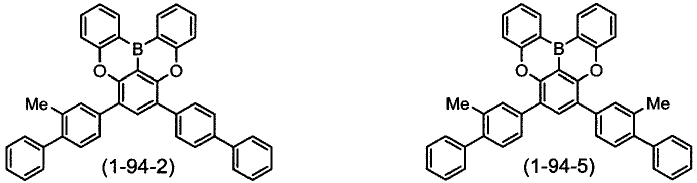

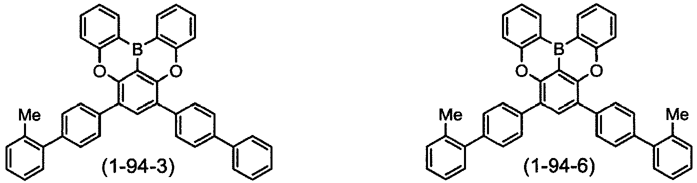

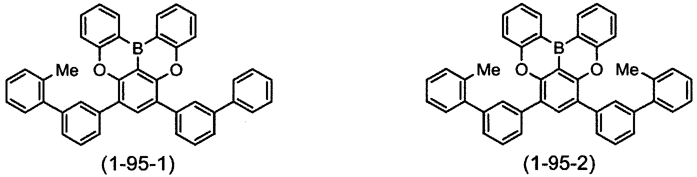

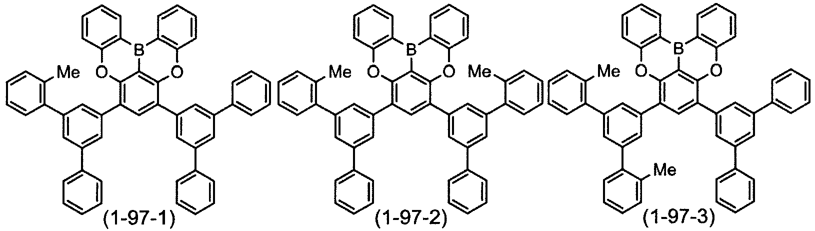

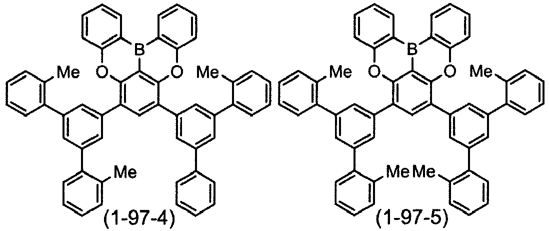

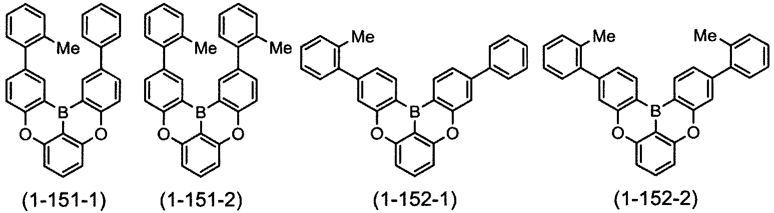

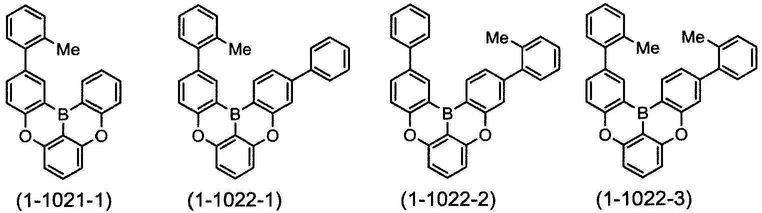

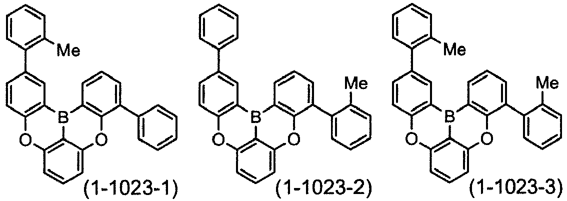

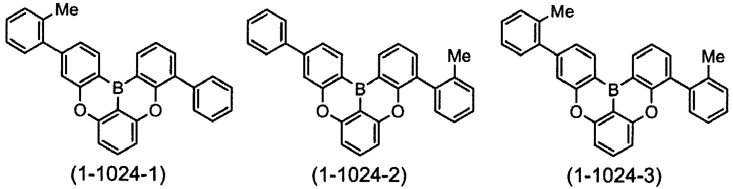

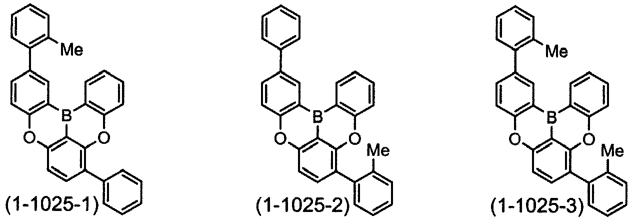

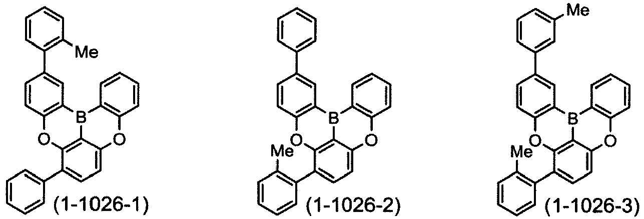

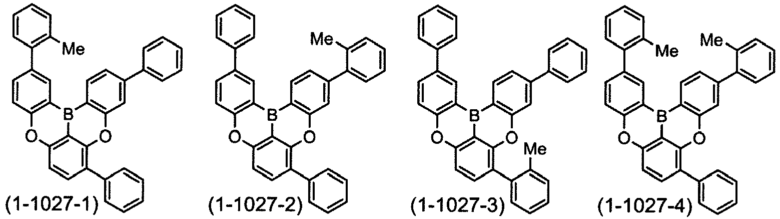

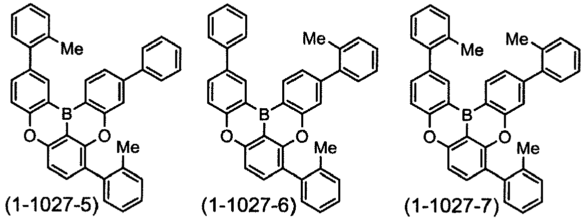

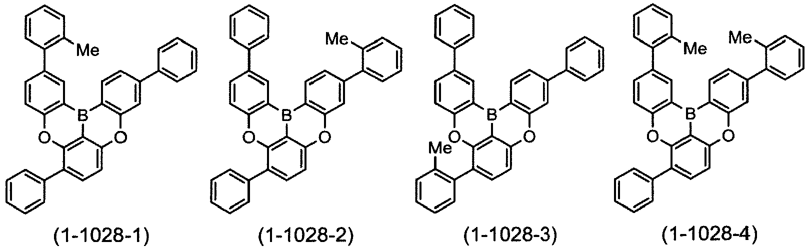

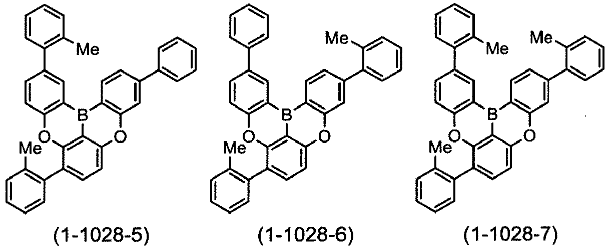

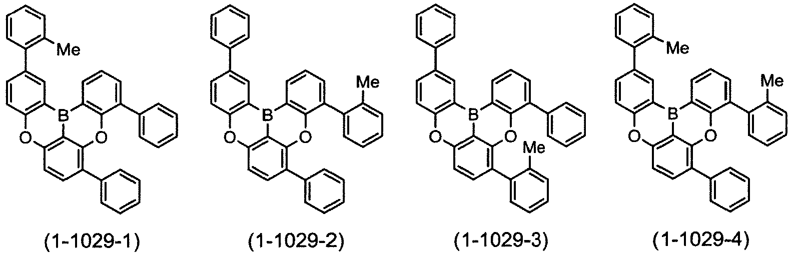

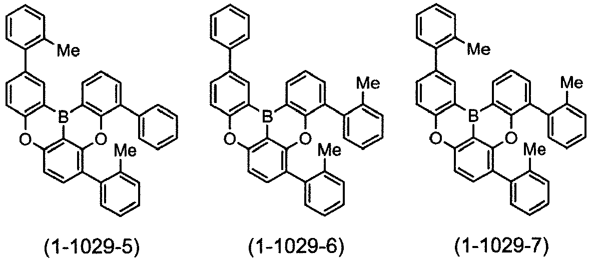

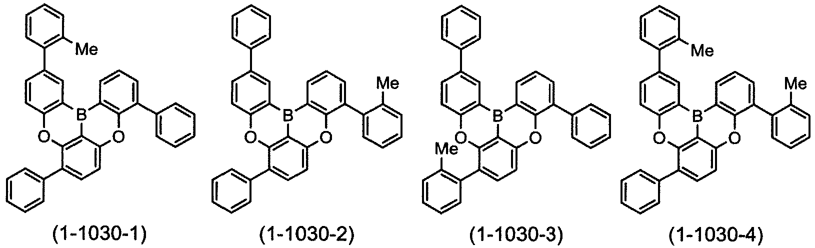

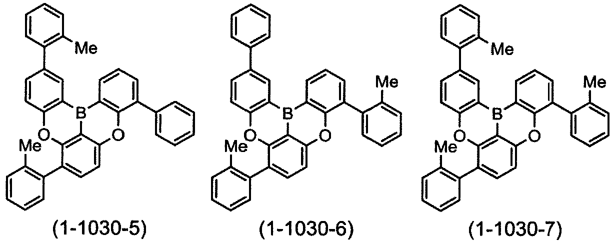

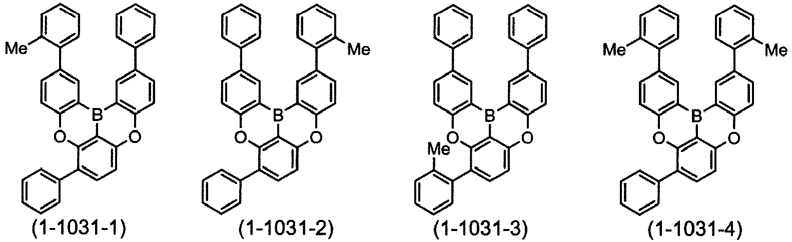

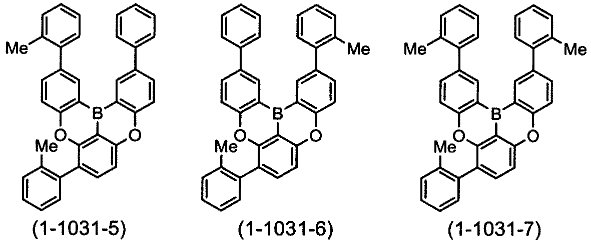

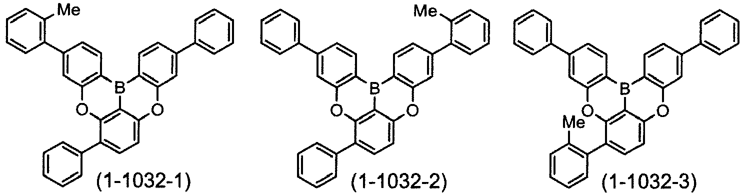

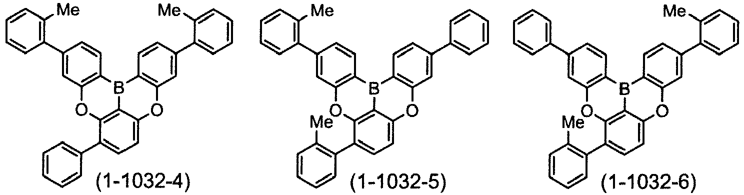

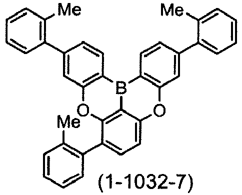

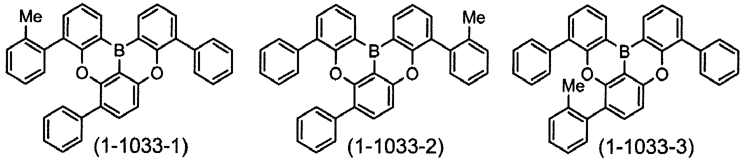

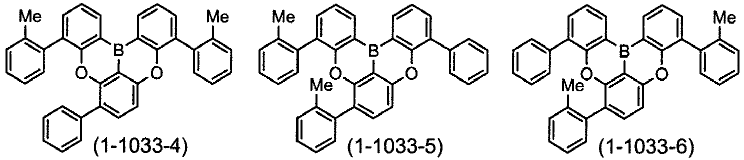

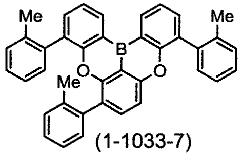

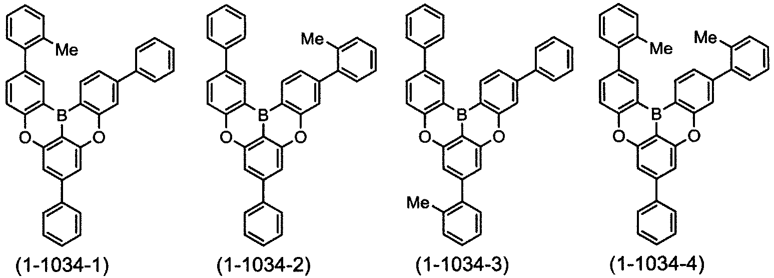

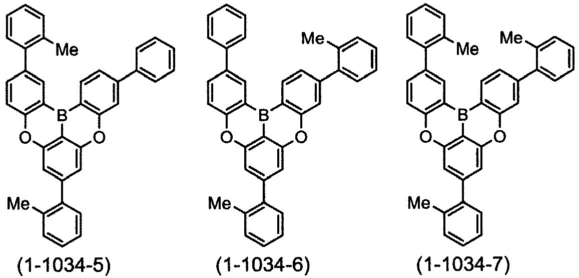

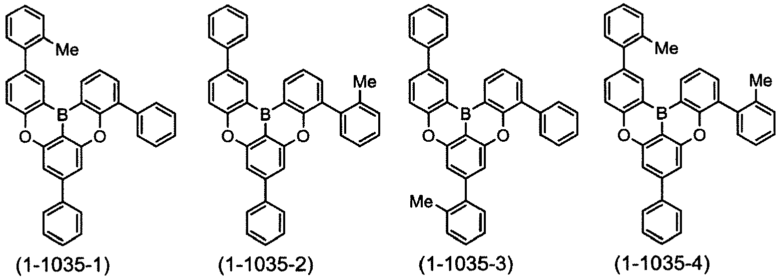

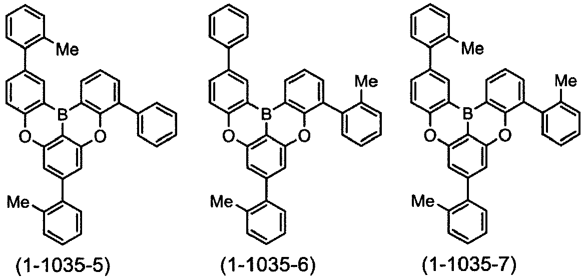

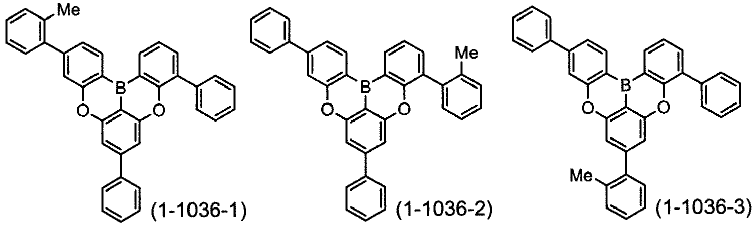

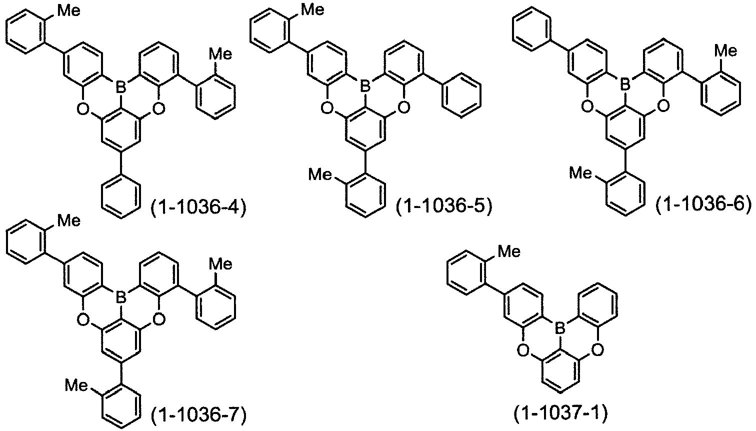

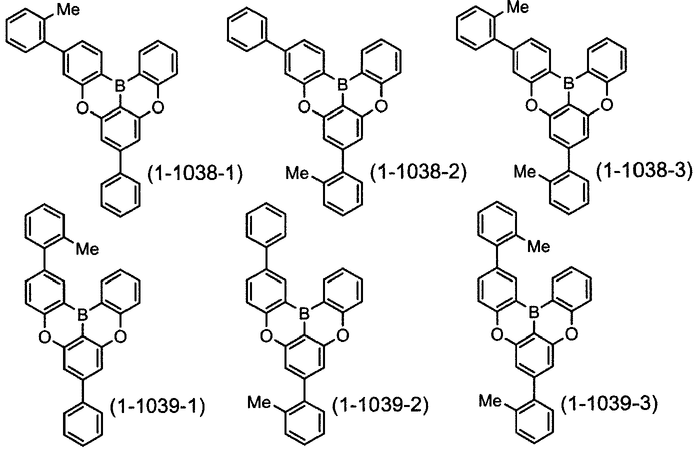

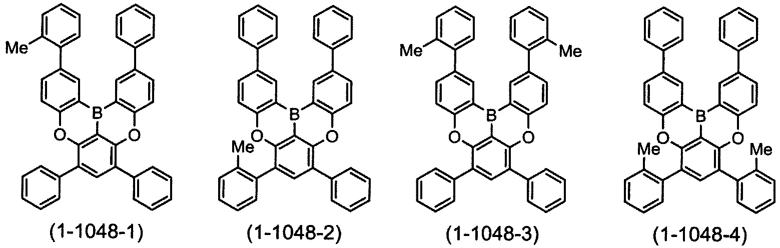

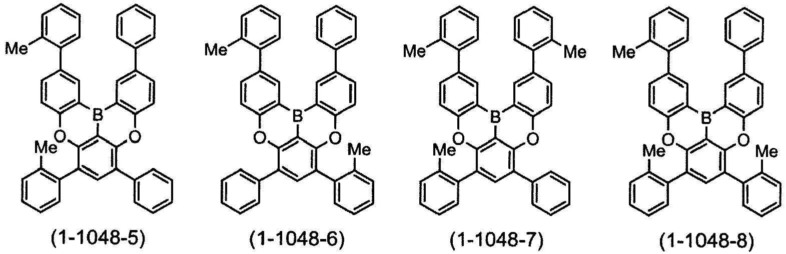

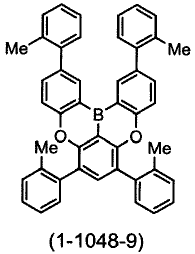

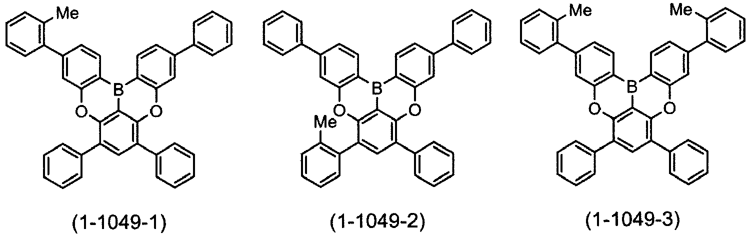

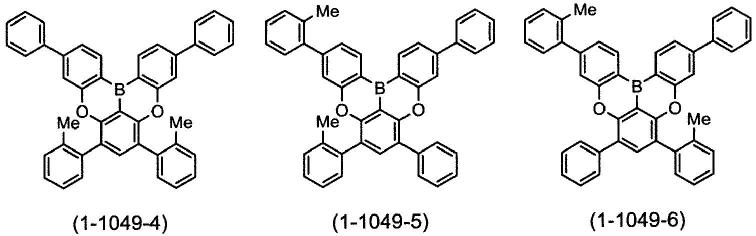

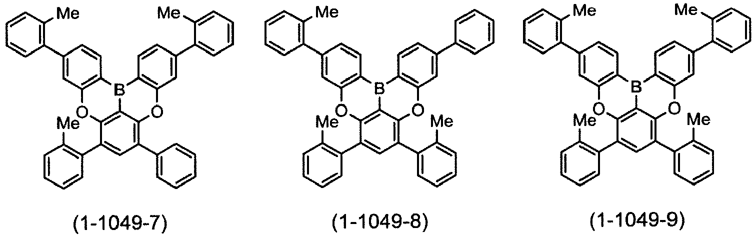

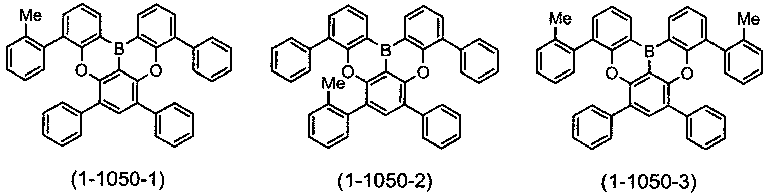

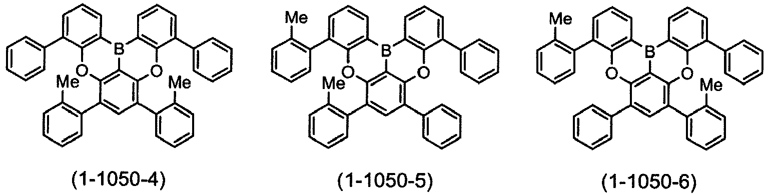

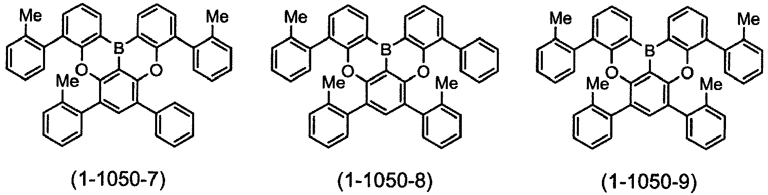

### 2. Method for producing polycyclic aromatic compound and oligomer thereof

In regard to the polycyclic aromatic compound represented by general formula (2) and an oligomer thereof, basically, an intermediate is produced by first linking the ring a, ring b and ring c via linking groups (groups containing X¹ or X²) (first reaction), and then a final product can be produced by linking the ring a, ring b and ring c via linking groups (groups containing Y¹) (second reaction). In the first reaction, for example, in
the case of an etherification reaction, a general reaction such as a nucleophilic substitution reaction, or the Ullmann reaction can be utilized, and in the case of an amination reaction, a general reaction such as the Buchwald-Hartwig reaction can be utilized. Also, in the second reaction, the Tandem Hetero-Friedel-Crafts reaction (a continuous aromatic electrophilic substitution reaction; hereinafter, the same) can be utilized.

The second reaction is a reaction for introducing Y¹ that links the ring a, ring b and ring c as illustrated in the following scheme (2), and as an example, the case in which Y¹ represents a boron atom; and X¹ and X² represent oxygen atoms is shown below. First, the hydrogen atom between X¹ and X² is ortho-metalated with n-butyllithium, sec-butyllithium or t-butyllithium. Subsequently, boron trichloride, boron tribromide or the like is added thereto to conduct lithium-boron metal exchange, and then a Brønsted base such as N,N-diisopropylethylamine is added thereto to induce a Tandem Bora-Friedel-Crafts reaction. Thus, an intended product may be obtained. In the second reaction, a Lewis acid such as aluminum trichloride may also be added in order to accelerate the reaction.

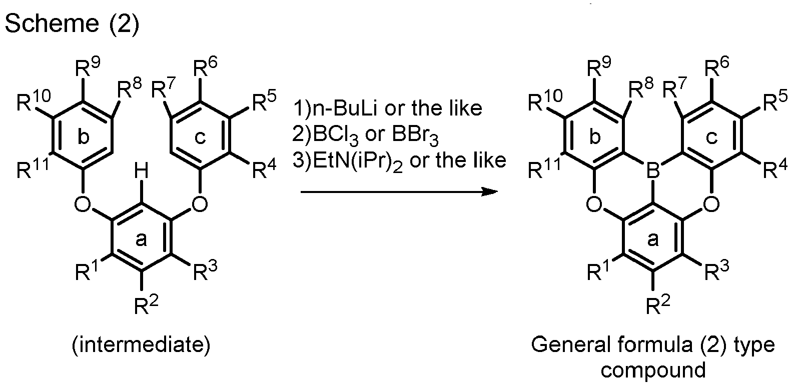

Meanwhile, the scheme (2) mainly illustrates the method for producing a polycyclic aromatic compound represented by general formula (2); however, an oligomer thereof can be produced by using an intermediate having plural ring a's, ring b' s and ring c' s . More specifically, the production method may be explained by the following schemes (3) to (5). In this case, the intended product may be obtained by increasing the amount of the reagent used therein such as butyllithium to a double amount or a triple amount.

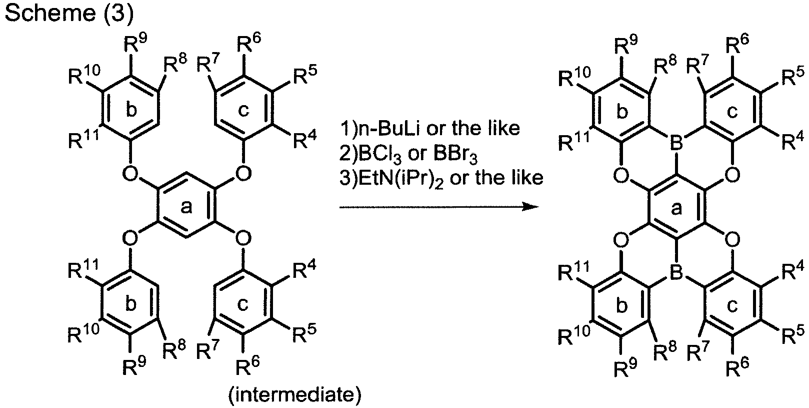

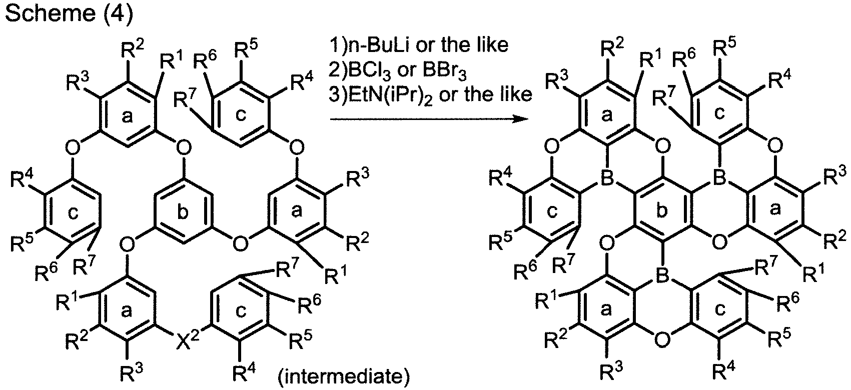

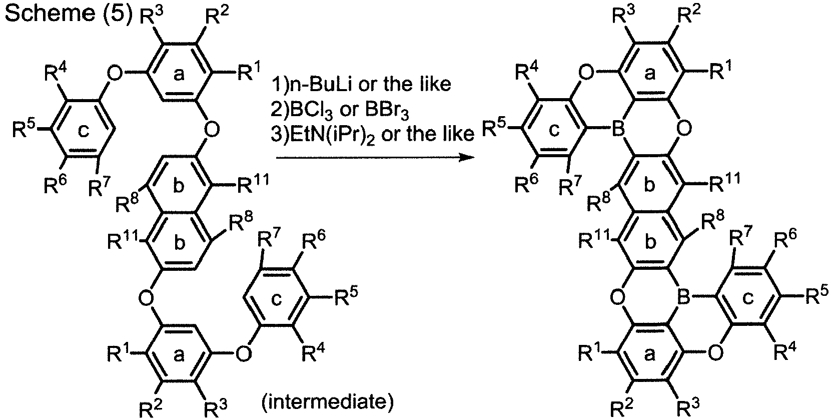

In the above schemes, lithium is introduced into a desired position by ortho-metalation; however, lithium can also be introduced into a desired position by halogen-metal exchange by introducing a bromine atom or the like to a position to which it is wished to introduce lithium, as in the following schemes (6) and (7).

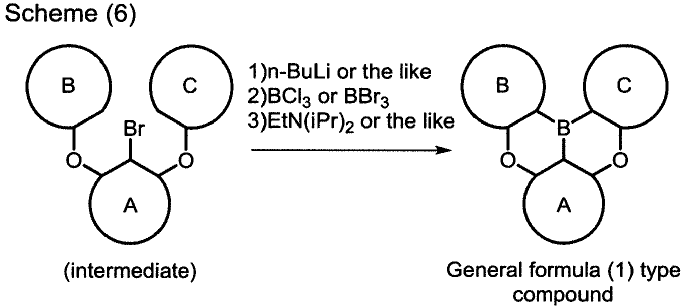

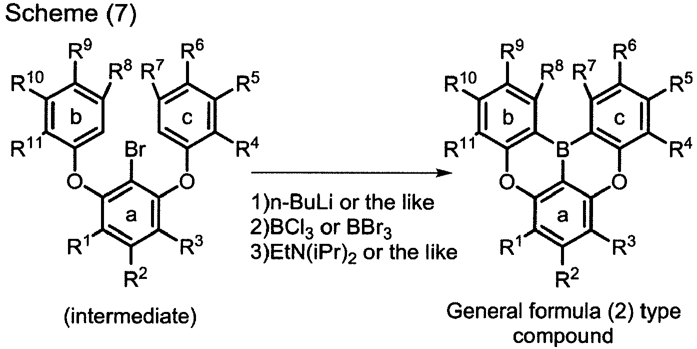

Furthermore, also in regard to the method for producing an oligomer described in the scheme (3), lithium can be introduced to a desired position also by halogen-metal exchange by introducing halogen such as a bromine atom or a chlorine atom to a position to which it is wished to introduce lithium, as in the above schemes (6) and (7) (following schemes (8), (9) and (10)).

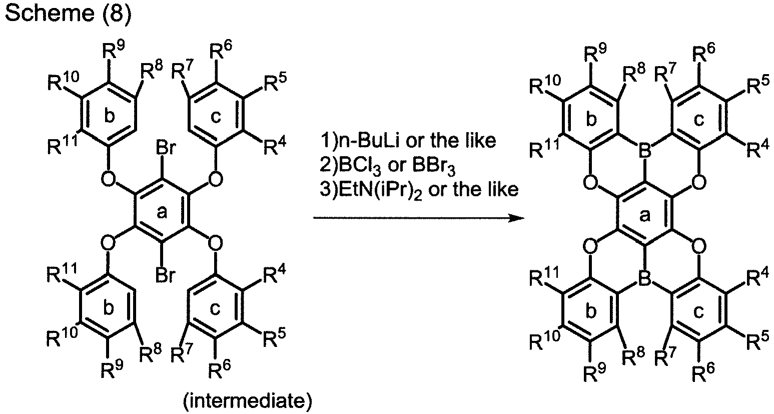

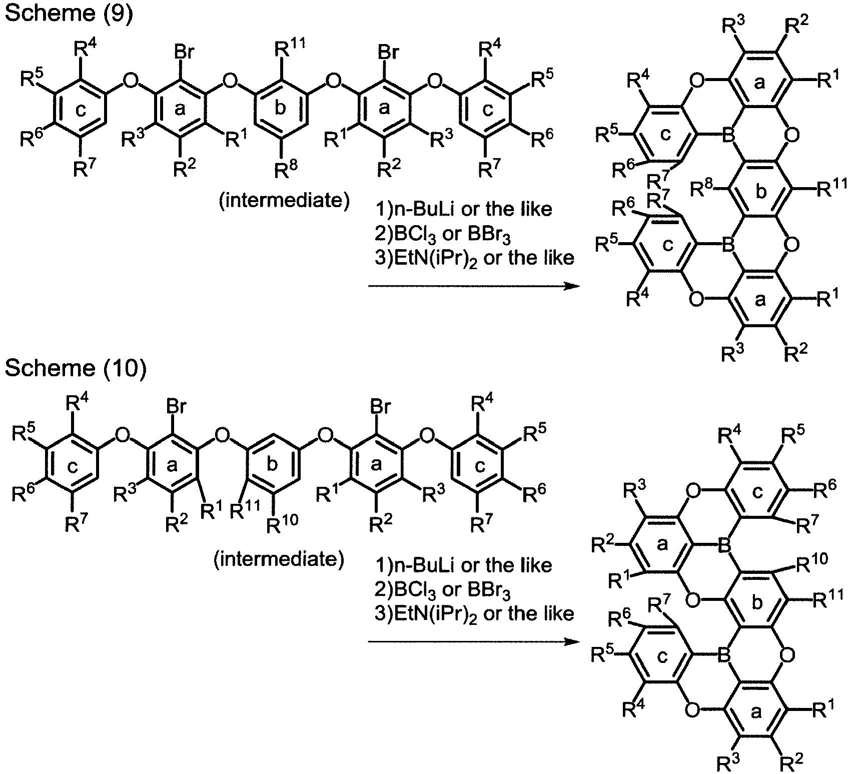

According to this method, an intended product can also be synthesized even in a case in which ortho-metalation cannot be achieved due to the influence of substituents, and therefore, the method is useful.

By appropriately selecting the synthesis method described above and appropriately selecting the raw materials to be used, a polycyclic aromatic compound having substituents at desired positions, with Y¹ being a boron atom and X¹ and X² being oxygen atoms, and an oligomer thereof can be synthesized.

Next, the case in which Y¹ represents a boron atom and X¹ and X² represent nitrogen atoms, is illustrated as an example in the following schemes (11) and (12). Similarly to the case in which X¹ and X² are oxygen atoms, first, the hydrogen atom between X¹ and X² is ortho-metalated with n-butyllithium or the like. Subsequently, boron tribromide or the like is added thereto to induce lithium-boron metal exchange, and then a Brønsted base such as N,N-diisopropylethylamine is added thereto to induce a Tandem Bora-Friedel-Crafts reaction. Thus, an intended product may be obtained. In this reaction, a Lewis acid such as aluminum trichloride may also be added in order to accelerate the reaction.

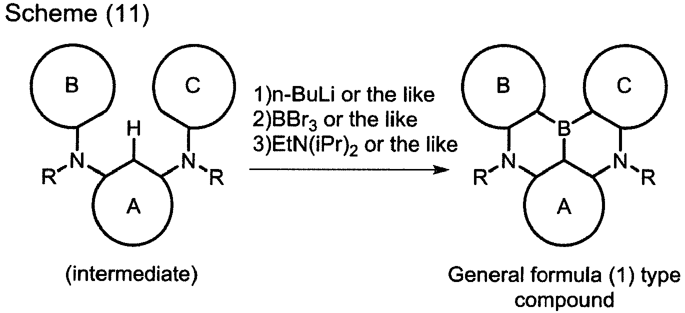

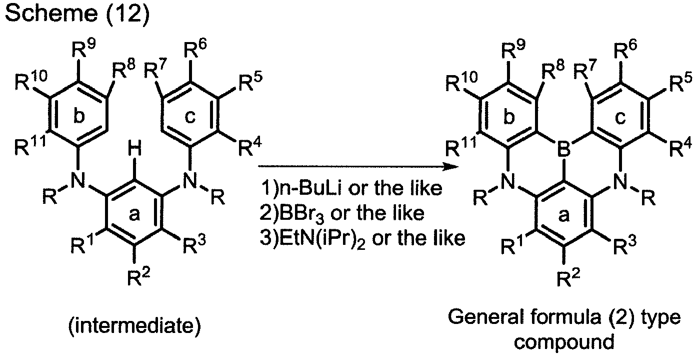

Furthermore, even for an oligomer in the case in which Y¹ represents a boron atom; and X¹ and X² represent nitrogen atoms, lithium can be introduced to a desired position also by halogen-metal exchange by introducing halogen such as a bromine atom or a chlorine atom to a position to which it is wished to introduce lithium, as in the case of the schemes (6) and (7) (following schemes (13), (14) and (15)).

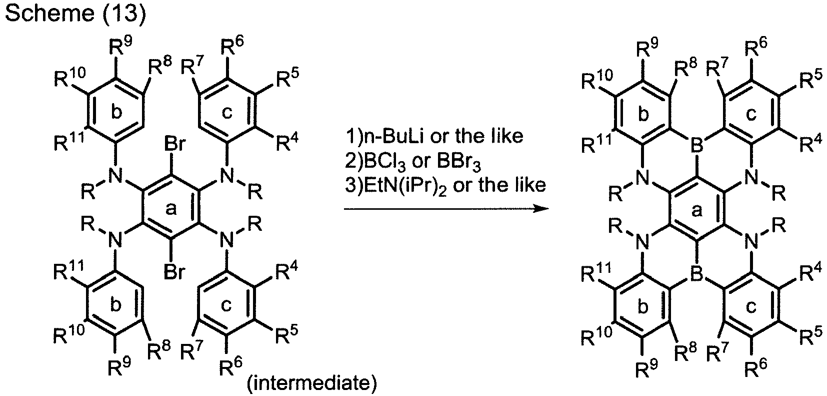

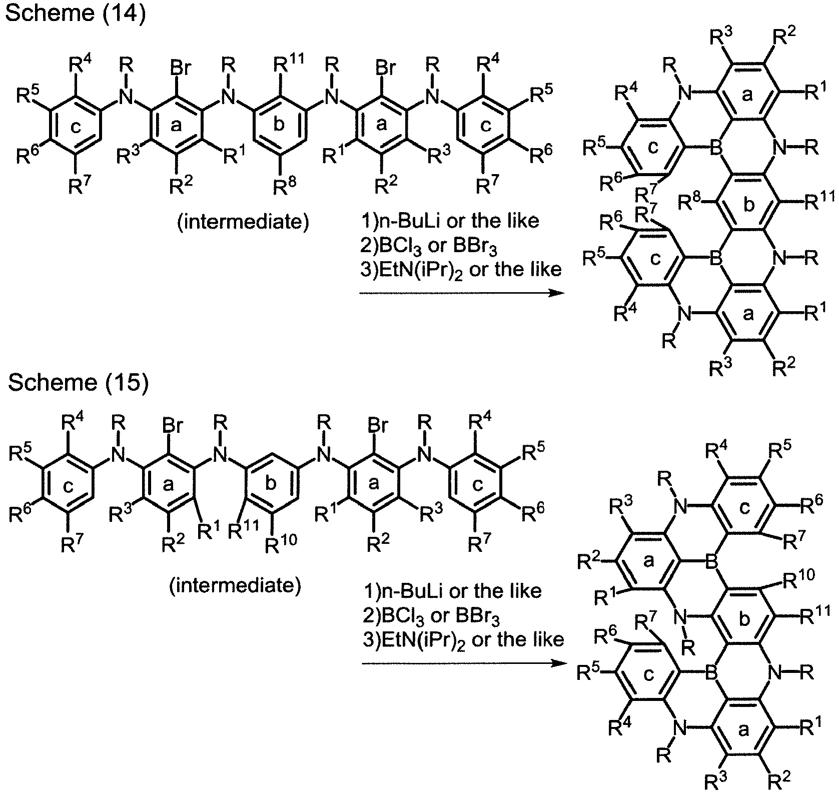

Here, an example in which Y¹ represents B and X¹ and X² represent O or NR is described; however, a compound in which X¹ and X² represent S can also be synthesized by appropriately modifying the raw materials.

Specific examples of the solvent used in the above reactions include t-butylbenzene and xylene.

Furthermore, in general formula (2), adjacent groups among the substituents R¹ to R¹¹ of the ring a, ring b and ring c may be bonded to each other and form an aryl ring or a heteroaryl ring together with the ring a, ring b or ring c, and at least one hydrogen atom in the ring thus formed may be substituted by an aryl or a heteroaryl. Therefore, the polycyclic aromatic compound represented by general formula (2) is such that the ring structure that constitutes the compound changes as represented by formula (2-1) and formula (2-2) of the following schemes (23) and (24), due to the mutual bonding form of substituents in the ring a, ring b and ring c. These compounds can be synthesized by applying the synthesis methods shown in the above schemes (1) to (19) to the intermediates shown in the following schemes (23) and (24).

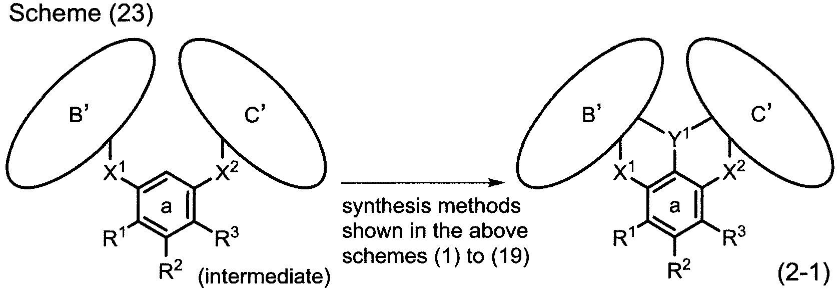

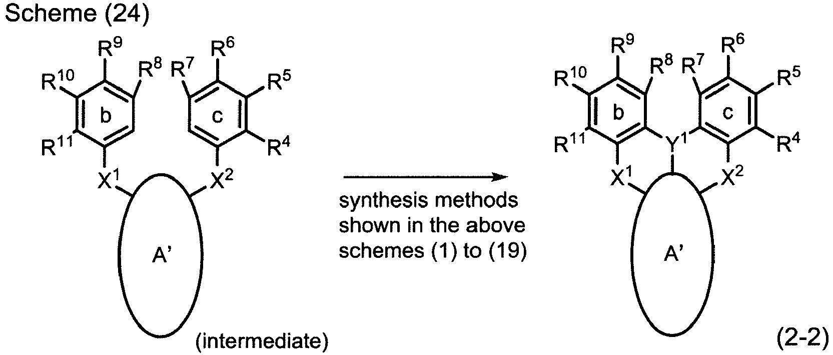

Ring A', ring B' and ring C' in the above formula (2-1) and formula (2-2) represent aryl rings or heteroaryl rings formed by bonding between adjacent groups among the substituents R¹ to R¹¹ together with the ring a, ring b, and ring c, respectively (may also be fused rings obtained as other ring structures are fused to the ring a, ring b or ring c). Meanwhile, although it is not suggested in the formulas, there is also a compound in which all of the ring a, ring b and ring c has been converted to ring A', ring B', and ring C').

Furthermore, the provision that "R of the moiety N-R is linked to the ring a, ring b and/or ring c via -O-, -S-, -C (-R)₂- or a single bond" in general formula (2) can be expressed as a compound having a ring structure represented by formula (2-3-1) of the following scheme (25), in which X¹ or X² is incorporated into the fused ring B' and fused ring C', or a compound having a ring structure represented by formula (2-3-2) or formula (2-3-3), in which X¹ or X² is incorporated into the fused ring A'. Such a compound can be synthesized by applying the synthesis methods illustrated in the schemes (1) to (19) to the intermediate represented by the following scheme (25).

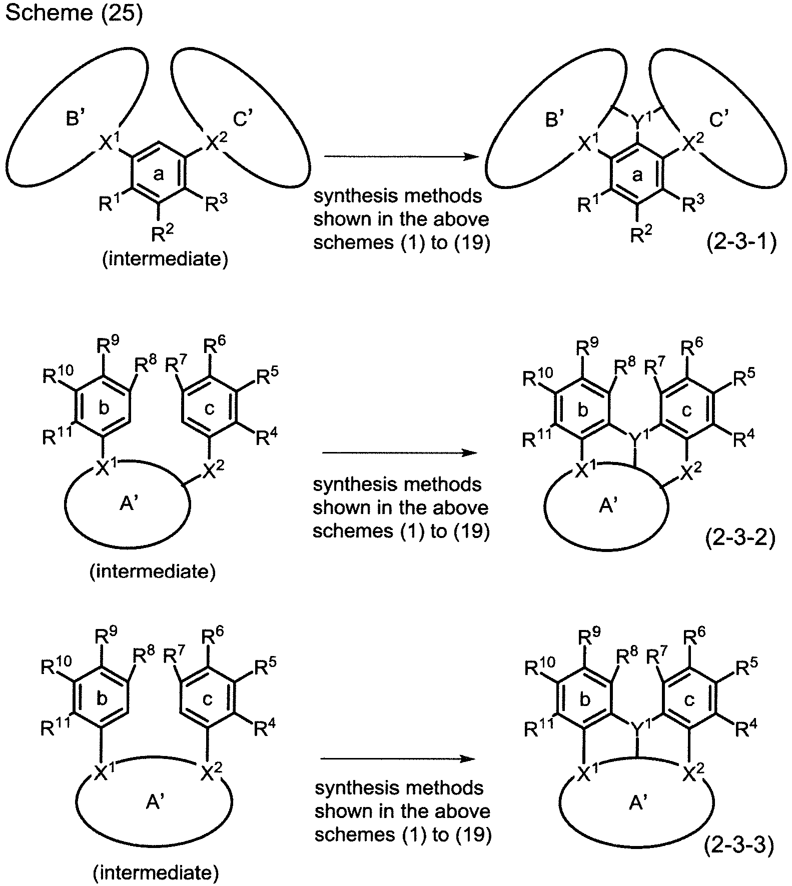

Furthermore, regarding the synthesis methods of the above schemes (1) to (17) and (20) to (25), there is shown an example of carrying out the Tandem Hetero-Friedel-Crafts reaction by ortho-metalating the hydrogen atom (or a halogen atom) between X¹ and X² with butyllithium or the like, before boron trichloride, boron tribromide or the like is added. However, the reaction may also be carried out by adding boron trichloride, boron tribromide or the like without conducting ortho-metalation using buthyllithium or the like.

Additionally, examples of the ortho-metalation reagent used for the schemes (1) to (25) include alkyllithiums such as methyllithium, n-butyllithium, sec-butyllithium, and t-butyllithium; and organic alkali compounds such as lithium diisopropylamide, lithium tetramethylpiperidide, lithium hexamethyldisilazide, and potassium hexamethyldisilazide.

Incidentally, examples of the metal exchanging reagent for metal-Y¹ used for the schemes (1) to (25) include halides of Y¹ such as trifluoride of Y¹, trichloride of Y¹, tribromide of Y¹, and triiodide of Y¹; aminated halides of Y¹ such as CIPN (NEt₂)₂; alkoxylation products of Y¹; and aryloxylation products of Y¹.

Examples of the Brønsted base used for the schemes (1) to (25) include N,N-diisopropylethylamine, triethylamine, 2,2,6,6-tetramethylpiperidine, 1,2,2,6,6-pentamethylpiperidine, N,N-dimethylaniline, N,N-dimethyltoluidine, 2,6-lutidine, sodium tetraphenylborate, potassium tetraphenylborate, triphenylborane, tetraphenylsilane, Ar₄BNa, Ar₄BK, Ar₃B, and Ar₄Si (wherein Ar represents an aryl such as phenyl).

Examples of the Lewis acid used for the schemes (1) to (25) include AlCl₃, AlBr₃, AlF₃, BF₃OEt₂, BCl₃, BBr₃, GaCl₃, GaBr₃, InCl₃, InBr₃, In(OTf)₃, SnCl₄, SnBr₄, AgOTf, ScCl₃, Sc (OTf)₃, ZnCl₂, ZnBr₂, Zn(OTf)₂, MgCl₂, MgBr₂, Mg(OTf)₂, LiOTf, NaOTf, KOTf, Me₃SiOTf, Cu(OTf)₂, CuCl₂, YCl₃, Y(OTf)₃, TiCl₄, TiBr₄, ZrCl₄, ZrBr₄, FeCl₃, FeBr₃, CoCl₃, and CoBr₃.

In the above schemes (1) to (25), a Brønsted base or a Lewis acid may be used in order to accelerate the Tandem Hetero Friedel-Crafts reaction. However, in a case in which a halide of Y¹ such as trifluoride of Y¹, trichloride of Y¹, tribromide of Y¹ or triiodide of Y¹ is used, an acid such as hydrogen fluoride, hydrogen chloride, hydrogen bromide or hydrogen iodide is produced along with the progress of the aromatic electrophilic substitution reaction. Therefore, it is effective to use a Brønsted base that captures acid. On the other hand, in a case in which an aminated halide of Y¹ or an alkoxylation product of Y¹ is used, an amine or an alcohol is produced along with the progress of the aromatic electrophilic substitution reaction. Therefore, in many cases, it is not necessary to use a Brønsted base; however, since the leaving ability of an amino group or an alkoxy group is low, it is effective to use a Lewis acid, which promotes leaving of those groups.

The polycyclic aromatic compound of the present invention or an oligomer thereof also includes compounds in which at least a portion of hydrogen atoms have been substituted by deuterium atoms or substituted by halogen atoms such as fluorine atoms or chlorine atoms; however, these compounds can be synthesized as described above by using raw materials that are deuterated, fluorinated or chlorinated at desired sites.

The polycyclic aromatic compound according to the present invention and an oligomer thereof can be used as a material for organic devices. Examples of the organic devices include an organic electroluminescent element, an organic field effect transistor, and an organic thin film solar cell.

### 3. Organic electroluminescent element

The polycyclic aromatic compound according to the present invention and an oligomer thereof can be used as, for example, a material for an organic electroluminescent element. Hereinafter, an organic EL element related to the present exemplary embodiment will be described in detail based on the drawings. FIG. 1 is an outline cross-sectional diagram illustrating an organic EL element related to the present exemplary embodiment.

### <Structure of organic electroluminescent element>

The organic electroluminescent element 100 illustrated in FIG. 1 includes a substrate 101; a positive electrode 102 provided on the substrate 101; a hole injection layer 103 provided on the positive electrode 102; a hole transport layer 104 provided on the hole injection layer 103; a light emitting layer 105 provided on the hole transport layer 104; an electron transport layer 106 provided on the light emitting layer 105; an electron injection layer 107 provided on the electron transport layer 106; and a negative electrode 108 provided on the electron injection layer 107.

The organic electroluminescent element 100 may also be configured, by reversing the production procedure, to include, for example, a substrate 101; a negative electrode 108 provided on the substrate 101; an electron injection layer 107 provided on the negative electrode 108; an electron transport layer 106 provided on the electron injection layer 107; a light emitting layer 105 provided on the electron transport layer 106; a hole transport layer 104 provided on the light emitting layer 105; a hole injection layer 103 provided on the hole transport layer 104; and a positive electrode 102 provided on the hole injection layer 103.

Not all of the various layers are essential, and the configuration may include a positive electrode 102, a light emitting layer 105, and a negative electrode 108 as the minimum constituent units, while the hole injection layer 103, the hole transport layer 104, the electron transport layer 106, and the electron injection layer 107 are optionally provided layers. Also, each of the various layers described above may be composed of a single layer, or may be composed of plural layers.

Embodiments of the layers that constitute an organic electroluminescent element may include, in addition to the configuration embodiment of "substrate/positive electrode/hole injection layer/hole transport layer/light emitting layer/electron transport layer/electron injection layer/negative electrode" described above, configuration embodiments of "substrate/positive electrode/hole transport layer/light emitting layer/electron transport layer/electron injection layer/negative electrode", "substrate/positive electrode/hole injection layer/light emitting layer/electron transport layer/electron injection layer/negative electrode", "substrate/positive electrode/hole injection layer/hole transport layer/light emitting layer/electron injection layer/negative electrode", "substrate/positive electrode/hole injection layer/hole transport layer/light emitting layer/electron transport layer/negative electrode", "substrate/positive electrode/light emitting layer/electron transport layer/electron injection layer/negative electrode", "substrate/positive electrode/hole transport layer/light emitting layer/electron injection layer/negative electrode", "substrate/positive electrode/hole transport layer/light emitting layer/electron transport layer/negative electrode", "substrate/positive electrode/hole injection layer/light emitting layer/electron injection layer/negative electrode", "substrate/positive electrode/hole injection layer/light emitting layer/electron transport layer/negative electrode", "substrate/positive electrode/light emitting layer/electron transport layer/negative electrode", and "substrate/positive electrode/light emitting layer/electron injection layer/negative electrode".

### <Substrate in organic electroluminescent element>

The substrate 101 serves as a support of the organic electroluminescent element 100, and usually, quartz, glass, metals, plastics and the like are used. The substrate 101 is formed into a plate shape, a film shape or a sheet shape according to the purpose, and for example, a glass plate, a metal plate, a metal foil, a plastic film, and a plastic sheet are used. Among them, a glass plate, and a plate made of a transparent synthetic resin such as polyester, polymethacrylate, polycarbonate or polysulfone are preferred. For the glass substrate, soda lime glass, alkali-free glass and the like are used, and furthermore, the thickness is desirably a thickness sufficient for maintaining the mechanical strength. Therefore, the thickness is desirably 0.2 mm or more. The upper limit value of the thickness is, for example, 2 mm or less, and preferably 1 mm or less. Regarding the material of glass, since a glass having fewer ions eluted from the glass is desirable, alkali-free glass is preferred. However, since soda lime glass provided with a barrier coat of SiO₂ or the like is also commercially available, this can be used. Furthermore, the substrate 101 may be provided with a gas barrier film such as a dense silicon oxide film on at least one surface in order to increase the gas barrier properties, and particularly in the case of using a plate, a film or a sheet made of a synthetic resin having low gas barrier properties as the substrate 101, it is preferable to provide a gas barrier film.

### <Positive electrode in organic electroluminescent element>

The positive electrode 102 is a member that accomplishes the role of injecting holes to the light emitting layer 105. In addition, when a hole injection layer 103 and/or hole transport layer 104 is provided between the positive electrode 102 and the light emitting layer 105, holes are injected into the light emitting layer 105 through these layers.

Examples of the material that forms the positive electrode 102 include inorganic compounds and organic compounds. Examples of the inorganic compounds include metals (aluminum, gold, silver, nickel, palladium, chromium and the like), metal oxides (oxides of indium, oxides of tin, indium tin oxide (ITO), indium zinc oxide (IZO), and the like), metal halides (copper iodide and the like), copper sulfide, carbon black, ITO glass, and Nesa glass. Examples of the organic compounds include electrically conductive polymers such as polythiophene such as poly(3-methylthiophene), polypyrrole, and polyaniline. In addition to them, the material can be appropriately selected for use from the materials used as the positive electrode of organic electroluminescent elements.

The resistance of a transparent electrode is not limited because it is desirable if sufficient electric current can be supplied to the light emission of a light emitting element; however, from the viewpoint of the consumption power of the light emitting element, lower resistance is preferred. For example, an ITO substrate having a resistance of 300 Ω/□ or less functions as an element electrode; however, since substrates having a resistance of about 10 Ω/□ can also be supplied, it is particularly preferable to use a low resistance product having a resistance of, for example, 100 to 5 Ω/□, and preferably 50 to 5 Ω/□. The thickness of ITO can be arbitrarily selected according to the resistance value, but many products having a thickness between 50 nm and 300 nm are usually used.

### <Hole injection layer and hole transport layer in organic electroluminescent element>

The hole injection layer 103 is a layer that accomplishes the role of efficiently injecting holes that migrate from the positive electrode 102 into the light emitting layer 105 or into the hole transport layer 104. The hole transport layer 104 is a layer that accomplishes the role of efficiently transporting the holes injected from the positive electrode 102 or the holes injected from the positive electrode 102 through the hole injection layer 103, to the light emitting layer 105. The hole injection layer 103 and the hole transport layer 104 are respectively formed by laminating and mixing one kind or two or more kinds of hole injecting/transporting materials, or by a mixture of hole injecting/transporting materials and a polymer binder. Furthermore, the layers may also be formed by adding an inorganic salt such as iron(III) chloride to hole injecting/transporting materials.

A hole injecting/transporting substance needs to be capable of efficiently injecting/transporting holes from the positive electrode between electrodes to which an electric field is applied, and a substance having high hole injection efficiency and being capable of efficiently transporting injected holes is desired. For this purpose, a substance which has low ionization potential, large hole mobility, and excellent stability, and in which impurities that serve as traps are not easily generated at the time of production and at the time of use, is preferred.

Regarding the material that forms the hole injection layer 103 and the hole transport layer 104, a polycyclic aromatic compound represented by the above general formula (1) or an oligomer thereof can be used. Furthermore, in regard to photoconductive material, any compound can be selected for use among the compounds that have been conventionally used as charge transporting materials for holes, p-type semiconductors, and known compounds that are used in hole injection layers and hole transport layers of organic electroluminescent elements. Specific examples thereof include heterocyclic compounds, including carbazole derivatives (N-phenylcarbazole, polyvinylcarbazole, and the like); biscarbazole derivatives such as bis(N-arylcarbazole) and bis(N-alkylcarbazole); triarylamine derivatives (a polymer having an aromatic tertiary amino in the main chain or a side chain, 1,1-bis(4-di-p-tolylaminophenyl)cyclohexane, N,N'-diphenyl-N,N'-di(3-methylphenyl)-4,4'-diaminobiphenyl, N,N'-diphenyl-N,N'-dinaphthyl-4,4'-diaminobiphenyl, N,N'-diphenyl-N,N'-di(3-methylphenyl)-4,4'-diphenyl-1,1'-di amine, N,N'-dinaphthyl-N,N'-diphenyl-4,4'-dphenyl-1,1'-diamine, N⁴,N⁴'-diphenyl-N⁴,N⁴'-bis(9-phenyl-9H-carbazol-3-yl)-[1,1'-biphenyl]-4,4'-diamine, N⁴,N⁴,N⁴',N⁴'-tetra[1,1'-biphenyl]-4-yl)-[1,1'-biphenyl]-4,4 '-diamine, triphenylamine derivatives such as 4,4',4"-tris(3-methylphenyl(phenyl)amino)triphenylamine, starburst amine derivatives, and the like); stilbene derivatives; phthalocyanine derivatives (metal-free, copper phthalocyanine, and the like); pyrazoline derivatives; hydrazone-based compounds; benzofuran derivatives; thiophene derivatives; oxadiazole derivatives; quinoxaline derivatives (for example, 1,4,5,8,9,12-hexaazatriphenylene-2,3,6,7,10,11-hexacarbonit rile, and the like) ; and porphyrin derivatives; and polysilanes. In a polymeric system, a polycarbonate, a styrene derivative, a polyvinylcarbazole, a polysilane and the like, which have the above-mentioned monomers in side chains, are preferred; however, there are no particular limitations as long as the compound is capable of forming a thin film that is needed for the production of a light emitting element, injecting holes from a positive electrode, and transporting holes.

Furthermore, it is also known that electroconductivity of an organic semiconductor is strongly affected by doping of the material. Such an organic semiconductor matrix substance is composed of a compound having satisfactory electron donating properties, or a compound having satisfactory electron accepting properties. For the doping of electron-donating substances, there are known strong electron acceptors such as tetracyanoquinonedimethane (TCNQ) and 2,3,5,6-tetrafluorotetracyano-1,4-benzoquinonedimethane (F4TCNQ) (see, for example, "M. Pfeiffer, A. Beyer, T. Fritz, K. Leo, Appl. Phys. Lett., 73(22), 3202-3204 (1998)" and "J. Blochwitz, M. Pfeiffer, T. Fritz, K. Leo, Appl. Phys. Lett., 73(6), 729-731 (1998)"). These compounds produce so-called holes by an electron transfer process in an electron-donating type base substance (hole transporting substance). Electroconductivity of the base substance changes fairly significantly depending on the number and mobility of the holes. Known examples of a matrix substance having hole transporting characteristics include benzidine derivatives (TPD and the like), starburst amine derivatives (TDATA and the like), and particular metal phthalocyanines (particularly, zinc phthalocyanine (ZnPc) and the like) (JP 2005-167175 A).

### <Light emitting layer in organic electroluminescent element>

The light emitting layer 105 is a layer that is disposed between electrodes to which an electric field is applied, and emits light by recombining the holes injected from the positive electrode 102 and the electron injected from the negative electrode 108. The material that forms the light emitting layer 105 may be any compound that is excited by recombination of holes and electrons and emits light (luminescent compound), and is preferably a compound that can form a stable thin film shape, and exhibits strong light emission (fluorescence) efficiency in a solid state. In the present invention, the polycyclic aromatic compound represented by the above general formula (2) or an oligomer thereof can be used as the material for light emitting layer.

The light emitting layer may be any of a single layer or plural layers, and each layer is formed by a material for light emitting layer (a host material and a dopant material). The host material and the dopant material may be respectively composed of a single kind, or may be respectively a combination of plural kinds. The dopant material may be included wholly in the host material, or may be partially included. Regarding the doping method, the light emitting layer can be formed by a co-deposition method with a host material; or alternatively, a dopant material may be mixed in advance with a host material, and then deposition may be carried out simultaneously.

The amount of use of the host material may vary with the kind of the host material, and the amount of use may be determined according to the characteristics of the host material. The reference of the amount of use of the host material is preferably 50 to 99.999% by weight, more preferably 80 to 99.95% by weight, and even more preferably 90 to 99.9% by weight, relative to the total amount of the material for light emitting layer. The polycyclic aromatic compound represented by the above general formula (2) or an oligomer thereof can also be used as the host material.

The amount of use of the dopant material may vary with the kind of the dopant material, and the amount of use may be determined according to the characteristics of the dopant material. The reference of the amount of use of the dopant is preferably 0.001 to 50% by weight, more preferably 0.05 to 20% by weight, and even more preferably 0.1 to 10% by weight, relative to the total amount of the material for light emitting layer. When the amount of use is in the range described above, for example, it is preferable from the viewpoint that a concentration quenching phenomenon can be prevented. The polycyclic aromatic compound represented by the above general formula (2) or an oligomer thereof can also be used as the dopant material.

Examples of the host material that can be used in combination with the polycyclic aromatic compound represented by the above general formula (2) or an oligomer thereof include fused ring derivatives of anthracene, pyrene and the like that have been traditionally known as luminous bodies, bisstyryl derivatives such as bisstyrylanthracene derivatives and distyrylbenzene derivatives, tetraphenylbutadiene derivatives, cyclopentadiene derivatives, fluorene derivatives, and benzofluorene derivatives.

Furthermore, the dopant material that can be used in combination with the polycyclic aromatic compound represented by the above general formula (2) or an oligomer thereof is not particularly limited, and existing compounds can be used. The dopant material can be selected from various materials depending on the desired color of emitted light. Specific examples thereof include fused ring derivatives of phenanthrene, anthracene, pyrene, tetracene, pentacene, perylene, naphthopyrene, dibenzopyrene, rubrene, chrysene and the like; benzoxazole derivatives, benzothiazole derivatives, benzimidazole derivatives, benzotriazole derivatives, oxazole derivatives, oxadiazole derivatives, thiazole derivatives, imidazole derivatives, thiadiazole derivatives, triazole derivatives, pyrazoline derivatives, stilbene derivatives, thiophene derivatives, tetraphenylbutadiene derivatives, cyclopentadiene derivatives, bisstyryl derivatives such as bisstyrylanthracene derivatives and distyrylbenzene derivatives (JP 1-245087 A), bisstyrylarylene derivatives (JP 2-247278 A), diazaindacene derivatives, furan derivatives, benzofuran derivatives; isobenzofuran derivatives such as phenylisobenzofuran, dimesitylisobenzofuran, di(2-methylphenyl)isobenzofuran, di(2-trifluoromethylphenyl)isobenzofuran, and phenylisobenzofuran; dibenzofuran derivatives; coumarin derivatives such as 7-dialkylaminocoumarin derivatives, 7-piperidinocoumarin derivatives, 7-hydroxycoumarin derivatives, 7-methoxycoumarin derivatives, 7-acetoxycoumarin derivatives, 3-benzothiazolylcoumarin derivatives, 3-benzimidazolylcoumarin derivatives, and 3-benzoxazolylcoumarin derivatives; dicyanomethylenepyran derivatives, dicyanomethylenethiopyran derivatives, polymethine derivatives, cyanine derivatives, oxobenzoanthracene derivatives, xanthene derivatives, rhodamine derivatives, fluorescein derivatives, pyrylium derivatives, carbostyryl derivatives, acridine derivatives, oxazine derivatives, phenylene oxide derivatives, quinacridone derivatives, quinazoline derivatives, pyrrolopyridine derivatives, furopyridine derivatives, 1,2,5-thiadiazolopyrene derivatives, pyromethene derivatives, perinone derivatives, pyrrolopyrrole derivatives, squarylium derivatives, violanthrone derivatives, phenazine derivatives, acridone derivatives, deazaflavine derivatives, fluorene derivatives, and benzofluorene derivatives.

To list the examples of each of the light colors, examples of blue to bluish green dopant materials include aromatic hydrocarbon compounds and derivatives thereof, such as naphthalene, anthracene, phenanthrene, pyrene, triphenylene, perylene, fluorene, indene, and chrysene; aromatic heterocyclic compounds and derivatives thereof, such as furan, pyrrole, thiophene, silole, 9-silafluorene, 9,9'-spirobisilafluorene, benzothiophene, benzofuran, indole, dibenzothiophene, dibenzofuran, imidazopyridine, phenanthroline, pyrazine, naphthyridine, quinoxaline, pyrrolopyridine, and thioxanthene; distyrylbenzene derivatives, tetraphenylbutadiene derivatives, stilbene derivatives, aldazine derivatives, coumarin derivatives; azole derivatives such as imidazole, thiazole, thiadiazole, carbazole, oxazole, oxadiazole, and triazole, and metal complexes thereof; and aromatic amine derivatives represented by N,N'-diphenyl-N,N'-di(3-methylphenyl)-4,4'-diphenyl-1,1'-di amine.

Furthermore, examples of green-yellow dopant materials include coumarin derivatives, phthalimide derivatives, naphthalimide derivatives, perinone derivatives, pyrrolopyrrole derivatives, cyclopentadiene derivatives, acridone derivatives, quinacridone derivatives, and naphthacene derivatives such as rubrene. Furthermore, suitable examples thereof include compounds in which substituents capable of shifting to a longer wavelength, such as an aryl, a heteroaryl, an arylvinyl, an amino, and a cyano are introduced to the above compounds listed as an example of blue to bluish green dopant materials.

Furthermore, examples of orange to red dopant materials include naphthalimide derivatives such as bis(diisopropylphenyl)perylene tetracarboxylic acid imide; perinone derivatives; rare earth complexes such as Eu complexes containing acetylacetone, benzoylacetone and phenanthroline as ligands; 4-(dicyanomethylene)-2-methyl-6-(p-dimethylaminostyryl)-4H-pyran and analogues thereof; metal phthalocyanine derivatives such as magnesium phthalocyanine and aluminum chlorophthalocyanine; rhodamine compounds; deazaflavine derivatives; coumarin derivatives; quinacridone derivatives; phenoxazine derivatives; oxazine derivatives; quinazoline derivatives; pyrrolopyridine derivatives; squarylium derivatives; violanthrone derivatives, phenazine derivatives; phenoxazone derivatives, and thiadiazolopyrene derivatives. Furthermore, suitable examples thereof include compounds in which substituents capable of shifting to a longer wavelength, such as an aryl, a heteroaryl, an arylvinyl, an amino, and a cyano are introduced to the above compounds listed as an example of blue to bluish green and green-yellow dopant materials.

In addition to them, dopants can be appropriately selected for used from the compounds described in "Kagaku Kogyo (Chemical Industry) ", June 2004, p. 13, and reference documents described therein.

Among the dopant materials described above, particularly an amine having a stilbene structure, a perylene derivative, a borane derivative, an aromatic amine derivative, a coumarin derivative, a pyran derivative, and a pyrene derivative are preferred.

An amine having a stilbene structure is represented by the following formula: 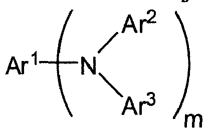 wherein Ar¹ represents an m-valent group derived from an aryl having 6 to 30 carbon atoms; Ar² and Ar³ each independently represent an aryl having 6 to 30 carbon atoms, while at least one of Ar¹ to Ar³ has a stilbene structure; Ar¹ to Ar³ may be substituted; and m represents an integer from 1 to 4.

The amine having a stilbene structure is more preferably a diaminostilbene represented by the following formula: 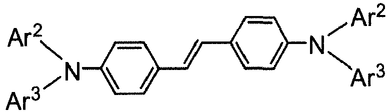 wherein Ar² and Ar³ each independently represent an aryl having 6 to 30 carbon atoms, and Ar² and Ar³ may be substituted.

Specific examples of the aryl having 6 to 30 carbon atoms include benzene, naphthalene, acenaphthylene, fluorene, phenalene, phenanthrene, anthracene, fluoranthene, triphenylene, pyrene, chrysene, naphthacene, perylene, stilbene, distyrylbenzene, distyrylbiphenyl, and distyrylfluorene.

Specific examples of the amine having a stilbene structure include N,N,N',N'-tetra(4-biphenylyl)-4,4'-diaminostilbene, N,N,N',N'-tetra(1-naphthyl)-4,4'-diaminostilbene, N,N,N',N'-tetra(2-naphthyl)-4,4'-diaminostilbene, N,N'-di(2-naphthyl)-N,N'-diphenyl-4,4'-diaminostilbene, N,N'-di(9-phenanthryl)-N,N'-diphenyl-4,4'-diaminostilbene, 4,4'-bis[4"-bis(diphenylamino)styryl]-biphenyl, 1,4-bis[4'-bis(diphenylamino)styryl]-benzene, 2,7-bis[4'-bis(diphenylamino)styryl]-9,9-dimethylfluorene, 4,4'-bis(9-ethyl-3-carbazovinylene)-biphenyl, and 4,4'-bis(9-phenyl-3-carbazovinylene)-biphenyl.

Furthermore, the amines having a stilbene structure described in JP 2003-347056 A, JP 2001-307884 A and the like may also be used.

Examples of the perylene derivative include 3,10-bis(2,6-dimethylphenyl)perylene, 3,10-bis(2,4,6-trimethylphenyl)perylene, 3,10-diphenylperylene, 3,4-diphenylperylene, 2,5,8,11-tetra-t-butylperylene, 3,4,9,10-tetraphenylperylene, 3-(1'-pyrenyl)-8,11-di(t-butyl)perylene, 3-(9'-anthryl)-8,11-di(t-butyl)perylene, and 3,3'-bis(8,11-di(t-butyl)perylenyl).

Furthermore, the perylene derivatives described in JP 11-97178 A, JP 2000-133457 A, JP 2000-26324 A, JP 2001-267079 A, JP 2001-267078 A, JP 2001-267076 A, JP 2000-34234 A, JP 2001-267075 A, JP 2001-217077 A and the like may also be used.

Examples of the borane derivative include 1,8-diphenyl-10-(dimesitylboryl)anthracene, 9-phenyl-10-(dimesitylboryl)anthracene, 4-(9'-anthryl)dimesitylborylnaphthalene, 4-(10'-phenyl-9'-anthryl)dimesitylborylnaphthalene, 9-(dimesitylboryl)anthracene, 9-(4'-biphenylyl)-10-(dimesitylboryl)anthracene, and 9-(4'-(N-carbazolyl)phenyl)-10-(dimesitylboryl)anthracene.

Furthermore, the borane derivatives described in WO 2000/40586 may also be used.

An aromatic amine derivative is represented by, for example, the following formula: 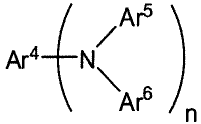 wherein Ar⁴ represents an n-valent group derived from an aryl having 6 to 30 carbon atoms; Ar⁵ and Ar⁶ each independently represent an aryl having 6 to 30 carbon atoms, while Ar⁴ to Ar⁶ may be substituted; and n represents an integer from 1 to 4.

Particularly, an aromatic amine derivative in which Ar⁴ represents a divalent group derived from anthracene, chrysene, fluorene, benzofluorene or pyrene; Ar⁵ and Ar⁶ each independently represent an aryl having 6 to 30 carbon atoms; Ar⁴ to Ar⁶ may be substituted; and n represents 2, is more preferred.

Specific examples of the aryl having 6 to 30 carbon atoms include benzene, naphthalene, acenaphthylene, fluorene phenalene, phenanthrene, anthracene, fluoranthene, triphenylene, pyrene, chrysene, naphthacene, perylene, and pentacene.

Examples of chrysene-based aromatic amine derivatives include N,N,N',N'-tetraphenylchrysene-6,12-diamine, N,N,N',N'-tetra(p-tolyl)chrysene-6,12-diamine, N,N,N',N'-tetra(m-tolyl)chrysene-6,12-diamine, N,N,N',N'-tetrakis(4-isopropylphenyl)chrysene-6,12-diamine, N,N,N',N'-tetra(naphthalen-2-yl)chrysene-6,12-dimine, N,N'-diphenyl-N,N'-di(p-tolyl)chrysene-6,12-diamine, N,N'-diphenyl-N,N'-bis(4-ethylphenyl)chrysene-6,12-diamine, N,N'-diphenyl-N,N'-bis(4-isopropylphenyl)chrysene-6,12-diam ine, N,N'-diphenyl-N,N'-bis(4-t-butylphenyl)chrysene-6,12-diamin e, and N,N'-bis(4-isopropylphenyl)-N,N'-di(p-tolyl)chrysene-6,12-d iamine.

Furthermore, examples of pyrene-based aromatic diamine derivatives include N,N,N',N'-tetraphenylpyrene-1,6-diamine, N,N,N',N'-tetra(p-tolyl)pyrene-1,6-diamine, N,N,N',N'-tetra(m-tolyl)pyrene-1,6-diamine, N,N,N',N'-tetrakis(4-isopropyophenyl)pyrene-1,6-diamine, N,N,N',N'-tetrakis(3,4-dimethylphenyl)pyrene-1,6-diamine, N,N'-diphenyl-N,N'-di(p-tolyl)pyrene-1,6-diamine, N,N'-diphenyl-N,N'-bis(4-ethylphenyl)pyrene-1,6-diamine, N,N'-diphenyl-N,N'-bis(4-isopropylphenyl)pyrene-1,6-diamine, N,N'-diphenyl-N,N'-bis(4-t-butylphenyl)pyrene-1,6-diamine, N,N'-bis(4-isopropylphenyl)-N,N'-di(p-tolyl)pyrene-1,6-diam ine, N,N,N',N'-tetrakis(3,4-dimethylphenyl)-3,8-diphenylpyrene-1 ,6-diamine, N,N,N,N-tetraphenylpyrene-1,8-diamine, N,N'-bis(biphenyl-4-yl)-N,N'-diphenylpyrene-1,8-diamine, and N¹,N⁶-diphenyl-N¹,N⁶-bis(4-trimethylsilanylphenyl)-1H,8H-pyr ene-1,6-diamine.

Furthermore, examples of anthracene-based aromatic amine derivatives include N,N,N,N-tetraphenylanthracene-9,10-diamine, N,N,N',N'-tetra(p-tolyl)anthracene-9,10-diamine, N,N,N',N'-tetra(m-tolyl)anthracene-9,10-diamine, N,N,N',N'-tetrakis(4-isopropylphenyl)anthracene-9,10-diamin e, N,N'-diphenyl-N,N'-di(p-tolyl)anthracene-9,10-diamine, N,N'-diphenyl-N,N'-di(m-tolyl)anthracene-9,10-diamine, N,N'-diphenyl-N,N'-bis(4-ethylphenyl)anthracene-9,10-diamin e, N,N'-diphenyl-N,N'-bis(4-isopropylphenyl)anthracene-9,10-di amine, N,N'-diphenyl-N,N'-bis(4-t-butylphenyl)anthracene-9,10-diam ine, N,N'-bis(4-isopropylphenyl)-N,N'-di(p-tolyl)anthracene-9,10 -diamine, 2,6-di-t-butyl-N,N,N',N'-tetra(p-tolyl)anthracene-9,10-diam ine, 2,6-di-t-butyl-N,N'-diphenyl-N,N'-bis(4-isopropylphenyl)ant hracene-9,10-diamine, 2,6-di-t-butyl-N,N'-bis(4-isopropylphenyl)-N,N'-di(p-tolyl) anthracene-9,10-diamine, 2,6-dicyclohexyl-N,N'-bis(4-isopropylphenyl)-N,N'-di(p-toly 1)anthracene-9,10-diamine, 2,6-dicyclohexyl-N,N'-bis(4-isopropylphenyl)-N,N'-bis(4-t-b utylphenyl)anthracene-9,10-diamine, 9,10-bis(4-diphenylaminophenyl)anthracene-9,10-bis(4-di(1-n aphthylamino)phenyl)anthracene, 9,10-bis(4-di(2-naphthylamino)phenyl)anthracene, 10-di-p-tolylamino-9-(4-di-p-tolylamino-1-naphthyl)anthrace ne, 10-diphenylamino-9-(4-diphenylamino-1-naphthyl)anthracene, and 10-diphenylamino-9-(6-diphenylamino-2-naphthyl)anthracene.

Furthermore, other examples include [4-(4-diphenylaminophenyl)naphthalen-1-yl]-diphenylamine, [6-(4-diphenylaminophenyl)naphthalen-2-yl]-diphenylamine, 4,4'-bis[4-diphenylaminonaphthalen-1-yl]biphenyl, 4,4'-bis[6-diphenylaminonaphthalen-2-yl]biphenyl, 4,4"-bis[4-diphenylaminonaphthalen-1-yl]-p-terphenyl, and 4,4"-bis[6-diphenylaminonaphthalen-2-yl]-p-terphenyl.

Furthermore, the aromatic amine derivatives described in JP 2006-156888 A and the like may also be used.

Examples of the coumarin derivatives include coumarin-6 and coumarin-334.

Furthermore, the coumarin derivatives described in JP 2004-43646 A, JP 2001-76876 A, JP 6-298758 A and the like may also be used.

Examples of the pyran derivatives include DCM and DCJTB described below.

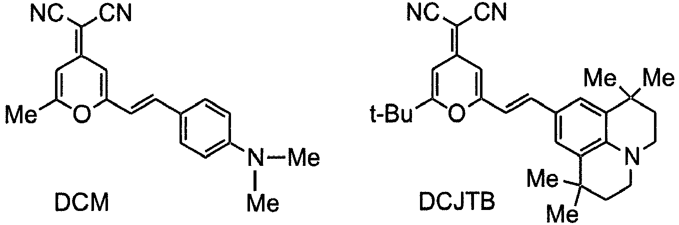

Furthermore, the pyran derivatives described in JP 2005-126399 A, JP 2005-097283 A, JP 2002-234892 A, JP 2001-220577 A, JP 2001-081090 A, JP 2001-052869 A, and the like may also be used.

### <Electron injection layer and electron transport layer in organic electroluminescent element>

The electron injection layer 107 is a layer that accomplishes the role of efficiently injecting the electrons migrating from the negative electrode 108 into the light emitting layer 105 or the electron transport layer 106. The electron transport layer 106 is a layer that accomplishes the role of efficiently transporting the electrons injected from the negative electrode 108, or the electrons injected from the negative electrode 108 through the electron injection layer 107, to the light emitting layer 105. The electron transport layer 106 and the electron injection layer 107 are respectively formed by laminating and mixing one kind or two or more kinds of electron transporting/injecting materials, or by a mixture of an electron transporting/injecting material and a polymeric binder.

An electron injection/transport layer is a layer that manages injection of electrons from the negative electrode and transport of electrons, and is preferably a layer that has high electron injection efficiency and is capable of efficiently transporting injected electrons. In order to do so, a substance which has high electron affinity, large electron mobility, and excellent stability, and in which impurities that serve as traps are not easily generated at the time of production and at the time of use, is preferred. However, when the transport balance between holes and electrons is considered, in a case in which the electron injection/transport layer mainly accomplishes the role of efficiently preventing holes coming from the positive electrode from flowing toward the negative electrode side without being recombined, even if the electron transporting ability is not so high, the effect of enhancing the light emission efficiency is equal to that of a material having high electron transporting ability. Therefore, the electron injection/transport layer according to the present exemplary embodiment may also include the function of a layer that can efficiently prevent migration of holes.

As the material that forms the electron transport layer 106 or the electron injection layer 107 (electron transporting material), the polycyclic aromatic compound represented by the above general formula (2) or an oligomer thereof can be used. Furthermore, the material can be arbitrarily selected for use from compounds that have been conventionally used as electron transferring compounds in photoconducting materials, and known compounds that are used in electron injection layers and electron transport layers of organic electroluminescent elements.

Regarding the material that is used in the electron transport layer or electron injection layer, it is preferable that the material includes at least one selected from compounds formed from aromatic rings or heteroaromatic rings composed of one or more kinds of atoms selected from carbon, hydrogen, oxygen, sulfur, silicon and phosphorus; pyrrole derivatives and fused ring derivatives thereof; and metal complexes having electron-accepting nitrogen. Specific examples thereof include fused ring-based aromatic ring derivatives such as naphthalene and anthracene; styryl-based aromatic ring derivatives represented by 4,4'-bis(diphenylethenyl)biphenyl; perinone derivatives; coumarin derivatives; naphthalimide derivatives; quinone derivatives such as anthraquinone and diphenoquinone; phosphorus oxide derivatives; carbazole derivatives; and indole derivatives. Examples of a metal complex having electron-accepting nitrogen include hydroxyazole complexes such as hydroxyphenyloxazole complexes, azomethine complexes, tropolone-metal complexes, flavonol-metal complexes, and benzoquinoline-metal complexes. These materials are used singly, but may also be used as mixtures with other materials.

Furthermore, specific examples of other electron transferring compounds include pyridine derivatives, naphthalene derivatives, anthracene derivatives, phenanthroline derivatives, perinone derivatives, coumarin derivatives, naphthalimide derivatives, anthraquinone derivatives, diphenoquinone derivatives, diphenylquinone derivatives, perylene derivatives, oxadiazole derivatives (1,3-bis[(4-t-butylphenyl)-1,3,4-oxadiazolyl]phenylene, and the like), thiophene derivatives, triazole derivatives (N-naphthyl-2,5-diphenyl-1,3,4-triazole, and the like), thiadiazole derivatives, metal complexes of oxine derivatives, quinolinol-based metal complexes, quinoxaline derivatives, polymers of quinoxaline derivatives, benzazole compounds, gallium complexes, pyrazole derivatives, perfluorinated phenylene derivatives, triazine derivatives, pyrazine derivatives, benzoquinoline derivatives (2,2'-bis(benzo[h]quinolin-2-yl)-9,9'-spirobifluorene, and the like), imidazopyridine derivatives, borane derivatives, benzimidazole derivatives (tris(N-phenylbenzimidazol-2-yl)benzene, and the like), benzoxazole derivatives, benzothiazole derivatives, quinoline derivatives, oligopyridine derivatives such as terpyridine, bipyridine derivatives, terpyridine derivatives (1,3-bis(4'-(2,2':6'2"-terpyridinyl))benzene, and the like), naphthyridine derivatives (bis(1-naphthyl)-4-(1,8-naphthyridin-2-yl)phenylphosphine oxide, and the like), aldazine derivatives, carbazole derivatives, indole derivatives, phosphorus oxide derivatives, and bisstyryl derivatives.

Furthermore, metal complexes having electron-accepting nitrogen can also be used, and examples thereof include quinolinol-based metal complexes, hydroxyazole complexes such as hydroxyphenyloxazole complexes, azomethine complexes, tropolone-metal complexes, flavonol-metal complexes, and benzoquinoline-metal complexes.

The materials described above are used singly, but may also be used as mixtures with other materials.

Among the materials described above, quinolinol-based metal complexes, bipyridine derivatives, phenanthroline derivatives, and borane derivatives are preferred.

A quinolinol-based metal complex is a compound represented by the following general formula (E-1): 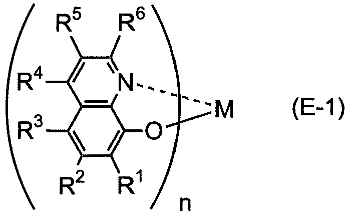 wherein R¹ to R⁶ each represent a hydrogen atom or a substituent; M represents Li, Al, Ga, Be, or Zn; and n represents an integer from 1 to 3.

Specific examples of the quinolinol-based metal complex include 8-quinolinollithium, tris(8-quinolinolato)aluminum, tris(4-methyl-8-quinolinolato)aluminum, tris(5-methyl-8-quinolinolato)aluminum, tris(3,4-dimethyl-8-quiolinolato)aluminum, tris(4,5-dimethyl-8-quinolinolato)aluminum, tris(4,6-dimethyl-8-quinolinolato)aluminum, bis(2-methyl-8-quinolinolato)(phenolato)aluminum, bis(2-methyl-8-quinolinolato)(2-methylphenolato)aluminum, bis(2-methyl-8-quinolinolato)(3-methylphenolato)aluminum, bis(2-methyl-8-quinolinolato)(4-methylphenolato)aluminum, bis(2-methyl-8-quinolinolato) (2-phenylphenolato)aluminum, bis(2-methyl-8-quinolinolato) (3-phenylphenolato)aluminum, bis(2-methyl-8-quinolinolato) (4-phenylphenolato)aluminum, bis(2-methyl-8-quinolinolato) (2,3-dimethylphenolato)aluminu m, bis(2-methyl-8-quinolinolato) (2,6-dimethylphenolato)aluminu m, bis(2-methyl-8-quinolinolato) (3,4-dimethylphenolato)aluminu m, bis(2-methyl-8-quinolinolato) (3,5-dimethylphenolato)aluminu m, bis(2-methyl-8-quinolinolato) (3,5-di-t-butylphenolato)alumi num, bis(2-methyl-8-quinolinolato) (2,6-diphenylphenolato)aluminu m, bis(2-methyl-8-quinolinolato) (2,4,6-triphenylphenolato)alum inum, bis(2-methyl-8-quinolinolato) (2,4, 6-trimethylphenolato)alum inum, bis(2-methyl-8-quinolinolato) (2,4,5,6-tetramethylphenolato) aluminum, bis(2-methyl-8-quinolinolato) (1-naphtholato)aluminum, bis(2-methyl-8-quinolinolato) (2-naphtholato)aluminum, bis(2,4-dimethyl-8-quinolinolato) (2-phenylphenolato)aluminu m, bis(2,4-dimethyl-8-quinolinolato) (3-phenylphenolato)aluminu m, bis(2,4-dimethyl-8-quinolinolato)(4-phenylphenolato)aluminu m, bis(2,4-dimethyl-8-quinolinolato)(3,5-dimethylphenolato)alu minum, bis(2,4-dimethyl-8-quinolinolato)(3,5-di-t-butylphenolato)a luminum, bis(2-methyl-8-quinolinolato)aluminum-µ-oxo-bis(2-methyl-8-quinolinolato)aluminum, bis(2,4-dimethyl-8-quinolinolato)aluminum-µ-oxo-bis(2,4-dim ethyl-8-quinolinolato) aluminum, bis(2-methyl-4-ethyl-8-quinolinolato)aluminum-µ-oxo-bis(2-e thyl-4-ethyl-8-quinolinolato) aluminum, bis(2-methyl-4-methoxy-8-quinolinolato)aluminum-µ-oxo-bis(2 -methyl-4-methoxy-8-quinolinolato)aluminum, bis(2-methyl-5-cyano-8-quinolinolato)aluminum-µ-oxo-bis(2-m ethyl-5-cyano-8-quinolinolato)aluminum, bis(2-methyl-5-trifluoromethyl-8-quinolinolato)aluminum-µ-o xo-bis(2-methy-5-trifluoromethyl-8-quiolinolato)aluminum, and bis(10-hydroxybenzo[h]quinoline)beryllium.

A bipyridine derivative is a compound represented by the following general formula (E-2): 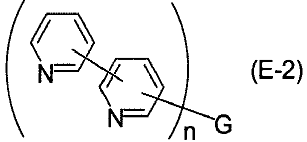 wherein G represents a simple linking bond or an n-valent linking group; n represents an integer from 2 to 8; and the carbon atoms that are not used in the pyridine-pyridine linkage or pyridine-G linkage may be substituted.

Examples of G of the general formula (E-2) include groups represented by the following structural formulas. Meanwhile, R's in the following structural formulas each independently represent a hydrogen atom, methyl, ethyl, isopropyl, cyclohexyl, phenyl, 1-naphthyl, 2-naphthyl, biphenylyl, or terphenylyl.

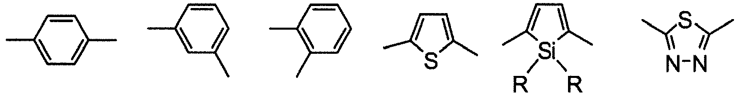

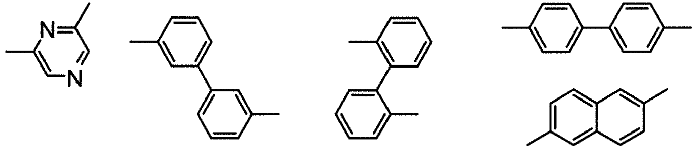

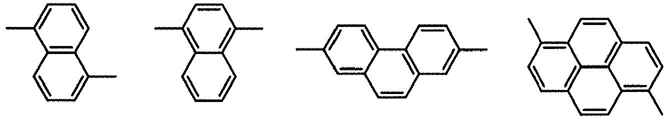

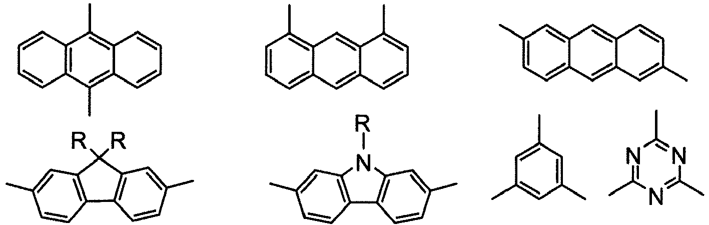

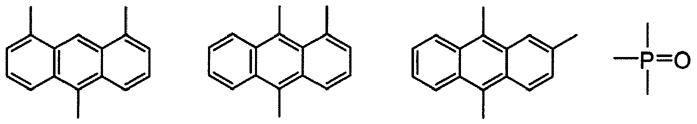

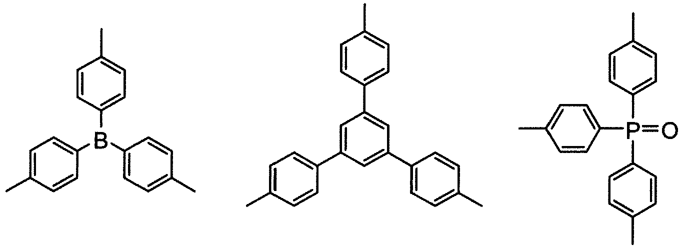

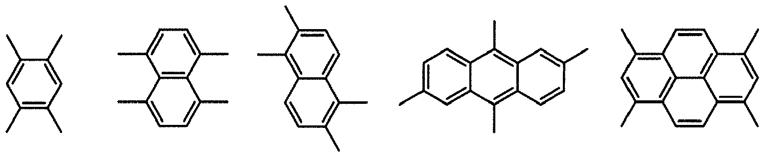

Specific examples of the pyridine derivative include 2,5-bis(2,2'-pyridin-6-yl)-1,1-dimethyl-3,4-diphenylsilole, 2,5-bis(2,2'-pyridin-6-yl)-1,1-dimethyl-3,4-dimesitylsilole, 2,5-bis(2,2'-pyridin-5-yl)-1,1-dimethyl-3,4-diphenylsilole, 2,5-bis(2,2'-pyridin-5-yl)-1,1-dimethyl-3,4-dimesitylsilole, 9,10-di(2,2'-pyridin-6-yl)anthracene, 9,10-di(2,2'-pyridin-5-yl)anthracene, 9,10-di (2,3'-pyridin-6-yl)anthracene, 9,10-di(2,3'-pyridin-5-yl)anthracene, 9,10-di(2,3'-pyridin-6-yl)-2-phenylanthracene, 9,10-di(2,3'-pyridin-5-yl)-2-phenylanthracene, 9,10-di(2,2'-pyridin-6-yl)-2-phenylanthracene, 9,10-di(2,2'-pyridin-5-yl)-2-phenylanthracene, 9,10-di(2,4'-pyridin-6-yl)-2-phenylanthracene, 9,10-di(2,4'-pyridin-5-yl)-2-phenylanthracene, 9,10-di(3,4'-pyridin-6-yl)-2-phenylanthracene, 9,10-di(3,4'-pyridin-5-yl)-2-phenylanthracene, 3,4-diphenyl-2,5-di(2,2'-pyridin-6-yl)thiophene, 3,4-diphenyl-2,5-di(2,3'-pyridin-5-yl)thiophene, and, 6',6"-di(2-pyridyl)-2,2':4',4":2",2"'-quaterpyridine.

A phenanthroline derivative is a compound represented by the following general formula (E-3-1) or (E-3-2): 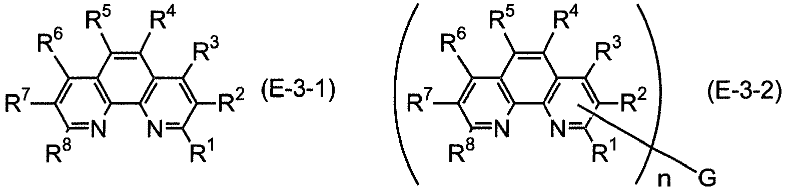 wherein R¹ to R⁸ each represent a hydrogen atom or a substituent; adjacent groups may be bonded to each other and form a fused ring; G represents a simple linking bond or an n-valent linking group; and n represents an integer from 2 to 8. Examples of G of the general formula (E-3-2) include the same groups as those described in the section of the bipyridine derivative.

Specific examples of the phenanthroline derivative include 4,7-diphenyl-1,10-phenanthroline, 2,9-dimethyl-4,7-diphenyl-1,10-phenanthroline, 9,10-di(1,10-phenanthrolin-2-yl)anthracene, 2, 6-di (1,10-phenanthrolin-5-yl) pyridine, 1,3,5-tri(1,10-phenanthrolin-5-yl)benzene, 9,9'-difluoro-bis(1,10-phenanthrolin-5-yl), bathocuproine, and 1,3-bis(2-phenyl-1,10-phenanthrolin-9-yl)benzene.

Particularly, the case of using a phenanthroline derivative in an electron transport layer or an electron injection layer will be explained. In order to obtain stable light emission over a long time, a material having excellent thermal stability or thin film formability is preferred, and among phenanthroline derivatives, a phenanthroline derivative in which a substituent itself has a three-dimensional steric structure, or the derivative has a three-dimensional steric structure as a result of steric repulsion between a substituent and the phenanthroline skeleton or between a substituent and an adjacent substituent, or a phenanthroline derivative having plural phenanthroline skeletons linked together, is preferred. Furthermore, in the case of linking plural phenanthroline skeletons, a compound containing conjugated bonds, a substituted or unsubstituted aromatic hydrocarbon, or a substituted or unsubstituted heterocyclic aromatic ring in the linked units, is more preferred.

A borane derivative is a compound represented by the following general formula (E-4), and specific examples are disclosed in JP 2007-27587 A. 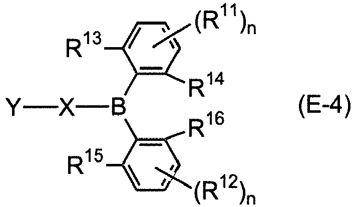 wherein R¹¹ and R¹² each independently represent at least one of a hydrogen atom, an alkyl, an aryl which may be substituted, a silyl which may be substituted, a nitrogen-containing heterocyclic ring which may be substituted, and cyano; R¹³ to R¹⁶ each independently represent an alkyl which may be substituted, or an aryl which may be substituted; X represents an arylene which may be substituted; Y represents an aryl having 16 or fewer carbon atoms which may be substituted, a boryl which may be substituted, or a carbazolyl which may be substituted; and n's each independently represent an integer from 0 to 3.

Among compounds represented by the above general formula (E-4), compounds represented by the following general formula (E-4-1), and compounds represented by the following general formulas (E-4-1-1) to (E-4-1-4), are preferred. Specific examples thereof include 9-[4-(4-dimesitylborylnaphthalen-1-yl)phenyl]carbazole and 9-[4-(4-dimesitylborylnaphthalen-1-yl)naphthalen-1-yl]carba zole. 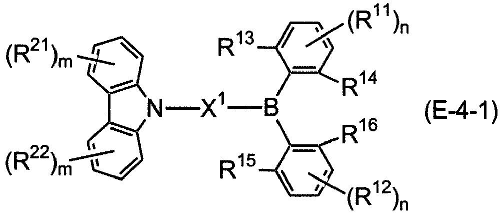 wherein R¹¹ and R¹² each independently represent at least one of a hydrogen atom, an alkyl, an aryl which may be substituted, a silyl which may be substituted, a nitrogen-containing heterocyclic ring which may be substituted, and cyano; R¹³ to R¹⁶ each independently represent an alkyl which may be substituted, or an aryl which may be substituted; R²¹ and R²² each independently represent at least one of a hydrogen atom, an alkyl, an aryl which may be substituted, a silyl which may be substituted, a nitrogen-containing heterocyclic ring which may be substituted, and cyano; X¹ represents an arylene having 20 or fewer carbon atoms which may be substituted; n's each independently represent an integer from 0 to 3; and m's each independently represent an integer from 0 to 4. 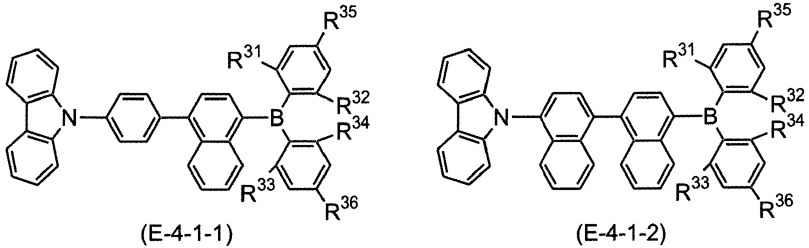 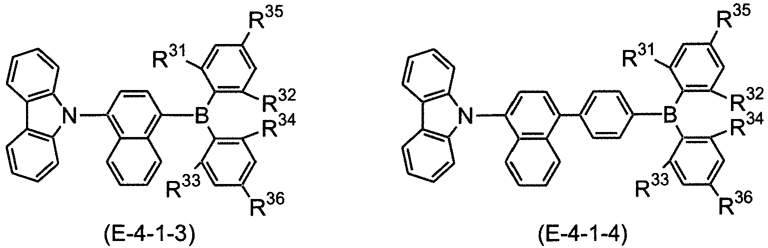 wherein in the respective formulas, R³¹ to R³⁴ each independently represent any one of methyl, isopropyl or phenyl; and R³⁵ and R³⁶ each independently represent any one of a hydrogen atom, methyl, isopropyl or phenyl.

Among compounds represented by the above general formula (E-4), compounds represented by the following general formula (E-4-2), and a compound represented by the following general formula (E-4-2-1) are preferred. 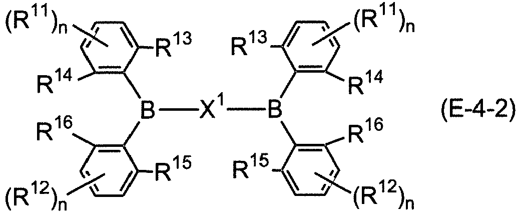 wherein R¹¹ and R¹² each independently represent at least one of a hydrogen atom, an alkyl, an aryl which may be substituted, a silyl which may be substituted, a nitrogen-containing heterocyclic ring which may be substituted, and cyano; R¹³ to R¹⁶ each independently represent an alkyl which may be substituted, or an aryl which may be substituted; X¹ represents an arylene having 20 or fewer carbon atoms which may be substituted; and n's each independently represent an integer from 0 to 3. 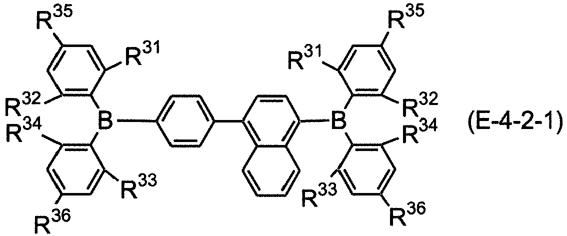 wherein R³¹ to R³⁴ each independently represent any one of methyl, isopropyl, or phenyl; and R³⁵ and R³⁶ each independently represent any one of a hydrogen atom, methyl, isopropyl, or phenyl.

Among compounds represented by the above general formula (E-4), compounds represented by the following general formula (E-4-3), and compounds represented by the following general formulas (E-4-3-1) and (E-4-3-2) are preferred. 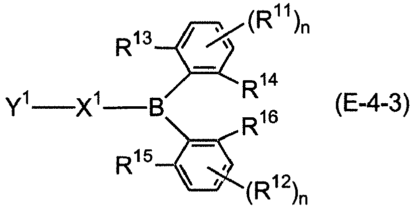 wherein R¹¹ and R¹² each independently represent at least one of a hydrogen atom, an alkyl, an aryl which may be substituted, a silyl which may be substituted, a nitrogen-containing heterocyclic ring which may be substituted, or cyano; R¹³ to R¹⁶ each independently represent an alkyl which may be substituted, or an aryl which may be substituted; X¹ represents an arylene having 10 or fewer carbon atoms which may be substituted; Y¹ represents an aryl having 14 or fewer carbon atoms which may be substituted; and n's each independently represent an integer from 0 to 3. 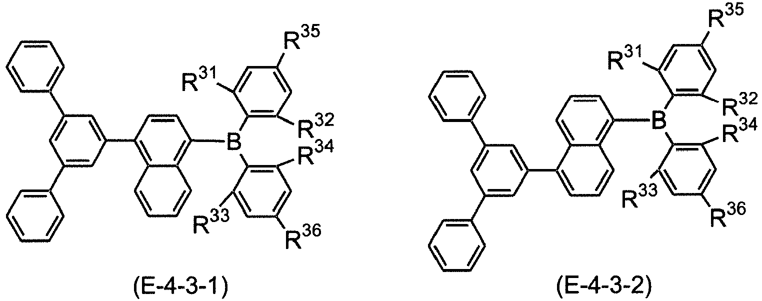 wherein R³¹ to R³⁴ each independently represent any one of methyl, isopropyl, or phenyl; and R³⁵ and R³⁶ each independently represent any one of a hydrogen atom, methyl, isopropyl, or phenyl.

A benzimidazole derivative is a compound represented by the following general formula (E-5): 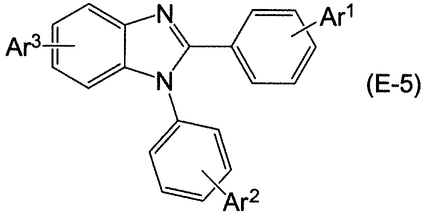 wherein Ar¹ to Ar³ each independently represent a hydrogen atom or an aryl having 6 to 30 carbon atoms which may be substituted. Particularly, a benzimidazole derivative in which Ar¹ represents an anthryl which may be substituted is preferred.

Specific examples of the aryl having 6 to 30 carbon atoms include phenyl, 1-naphthyl, 2-naphthyl, acenaphthylen-1-yl, acenaphthylen-3-yl, acenaphthylen-4-yl, acenaphthylen-5-yl, fluoren-1-yl, fluoren-2-yl, fluoren-3-yl, fluoren-4-yl, fluoren-9-yl, phenalen-1-yl, phenalen-2-yl, 1-phenanthryl, 2-phenanthryl, 3-phenanthryl, 4-phenanthryl, 9-phenanthryl, 1-anthryl, 2-anthryl, 9-anthryl, fluoranthen-1-yl, fluoranthen-2-yl, fluoranthen-3-yl, fluoranthen-7-yl, fluoranthen-8-yl, triphenylen-1-yl, triphenylen-2-yl, pyren-1-yl, pyren-2-yl, pyren-4-yl, chrysen-1-yl, chrysen-2-yl, chrysen-3-yl, chrysen-4-yl, chrysen-5-yl, chrysen-6-yl, naphthacen-1-yl, naphthacen-2-yl, naphthacen-5-yl, perylen-1-yl, perylen-2-yl, perylen-3-yl, pentacen-1-yl, pentacen-2-yl, pentacen-5-yl, and pentacen-6-yl.

Specific examples of the benzimidazole derivative include 1-phenyl-2-(4-(10-phenylanthracen-9-yl)phenyl)-1H-benzo[d]i midazole, 2-(4-(10-(naphthalen-2-yl)anthracen-9-yl)phenyl)-1-phenyl-1 H-benzo[d]imidazole, 2-(3-(10-(naphthalen-2-yl)anthracen-9-yl)phenyl)-1-phenyl-1 H-benzo[d]imidazole, 5-(10-(naphthlen-2-yl)anthracen-9-yl)-1,2-diphenyl-1H-benzo [d]imidazole, 1-(4-(10-(naphthalen-2-yl)anthracen-9-yl)phenyl)-2-phenyl-1 H-benzo[d]imidazole, 2-(4-(9,10-di(naphthalen-2-yl)anthracen-2-yl)phenyl)-1-phen yl-1H-benzo[d]imidazole, 1-(4-(9,10-di(naphthalen-2-yl)anthracen-2-yl)phenyl)-2-phen yl-1H-benzo[d]imidazole, and 5-(9,10-di(naphthalen-2-yl)anthracen-2-yl)-1,2-diphenyl-1H-benzo[d]imidazole.

The electron transport layer or the electron injection layer may further contain a substance that can reduce the material that forms the electron transport layer or electron injection layer. Regarding this reducing substance, various substances may be used as long as they have reducibility to a certain extent. For example, at least one selected from the group consisting of alkali metals, alkaline earth metals, rare earth metals, oxides of alkali metals, halides of alkali metals, oxides of alkaline earth metals, halides of alkaline earth metals, oxides of rare earth metals, halides of rare earth metals, organic complexes of alkali metals, organic complexes of alkaline earth metals, and organic complexes of rare earth metals, can be suitably used.

Preferred examples of the reducing substance include alkali metals such as Na (work function 2.36 eV), K (work function 2.28 eV), Rb (work function 2.16 eV), and Cs (work function 1.95 eV); and alkaline earth metals such as Ca (work function 2.9 eV), Sr (work function 2.0 to 2.5 eV), and Ba (work function 2.52 eV). A reducing substance having a work function of 2. 9 eV or less is particularly preferred. Among these, more preferred examples of the reducing substance include alkali metals such as K, Rb and Cs; even more preferred examples include Rb and Cs; and the most preferred example is Cs. These alkali metals have particularly high reducing ability, and can promote an enhancement of the emission luminance or lengthening of the service life in organic EL elements when the alkali metals are added in a relatively small amount to the material that forms the electron transport layer or electron injection layer. Furthermore, as the reducing substance having a work function of 2.9 eV or less, a combination of two or more kinds of these alkali metals is also preferred, and particularly, a combination including Cs, for example, a combination of Cs with Na, a combination of Cs with K, a combination of Cs with Rb, or a combination of Cs with Na and K, is preferred. When Cs is incorporated, the reducing ability can be efficiently manifested, and an enhancement of the emission luminance or lengthening of the service life in organic EL elements can be promoted by adding Cs to the material that forms the electron transport layer or electron injection layer.

### <Negative electrode in organic electroluminescent element>

The negative electrode 108 is a member that accomplishes the role of injecting electrons to the light emitting layer 105 through the electron injection layer 107 and the electron transport layer 106.

The material that forms the negative electrode 108 is not particularly limited as long as it is a substance capable of efficiently injecting electrons to an organic layer; however, the same materials as the materials that form the positive electrode 102 can be used. Among them, preferred examples include metals such as tin, indium, calcium, aluminum, silver, copper, nickel, chromium, gold, platinum, iron, zinc, lithium, sodium, potassium, cesium and magnesium, and alloys thereof (a magnesium-silver alloy, a magnesium-indium alloy, an aluminum-lithium alloy such as lithium fluoride/aluminum, and the like). In order to enhance the element characteristics by increasing the electron injection efficiency, lithium, sodium, potassium, cesium, calcium, magnesium, or alloys thereof containing low work function-metals are effective. However, many of these low work function-metals are generally unstable in air. In order to ameliorate this, for example, a method of using an electrode having high stability obtained by doping a trace amount of lithium, cesium or magnesium to an organic layer, is known. Other examples of the dopant that can be used include inorganic salts such as lithium fluoride, cesium fluoride, lithium oxide, and cesium oxide. However, the present invention is not intended to be limited to these.

Furthermore, in order to protect the electrode, a metal such as platinum, gold, silver, copper, iron, tin, aluminum or indium; an alloy using these metals; an inorganic substance such as silica, titania or silicon nitride; polyvinyl alcohol, vinyl chloride, a hydrocarbon-based polymer compound; or the like may be laminated thereon according to a preferred embodiment. The method for producing these electrodes is not particularly limited as long as the method is capable of conduction, such as resistance heating, electron beam, sputtering, ion plating and coating.

### <Binder that may be used in various layers>

The materials used in the above-described hole injection layer, hole transport layer, light emitting layer, electron transport layer, and electron injection layer can form the various layers by being used singly; however, it is also possible to use the materials after dispersing them in a solvent-soluble resin such as polyvinyl chloride, polycarbonate, polystyrene, poly(N-vinylcarbazole), polymethyl methacrylate, polybutyl methacrylate, polyester, polysulfone, polyphenylene oxide, polybutadiene, a hydrocarbon resin, a ketone resin, a phenoxy resin, polyamide, ethyl cellulose, a vinyl acetate resin, an ABS resin, or a polyurethane resin; or a curable resin such as a phenolic resin, a xylene resin, a petroleum resin, a urea resin, a melamine resin, an unsaturated polyester resin, an alkyd resin, an epoxy resin, or a silicone resin.

### <Method for producing organic electroluminescent element>

The various layers that constitute an organic electroluminescent element can be formed by forming thin films of the materials that will constitute the various layers, by methods such as a vapor deposition method, resistance heating deposition, electron beam deposition, sputtering, a molecular lamination method, a printing method, a spin coating method, a casting method, and a coating method. There are no particular limitations on the film thickness of the various layers thus formed, and the film thickness can be appropriately set depending on the properties of the material, but the film thickness is usually in the range of 2 nm to 5000 nm. The film thickness can be usually measured using a crystal oscillation type film thickness analyzer or the like. In the case of forming a thin film using a vapor deposition method, the deposition conditions vary with the kind of the material, the intended crystal structure and association structure of the film, and the like. It is preferable to appropriately set the vapor deposition conditions generally in the ranges of a boat heating temperature of +50°C to +400°C, a degree of vacuum of 10⁻⁶ to 10⁻³ Pa, a rate of deposition of 0.01 to 50 nm/second, a substrate temperature of -150°C to +300°C, and a film thickness of 2 nm to 5 µm.

Next, a method for producing an organic electroluminescent element configured to include positive electrode/hole injection layer/hole transport layer/light emitting layer formed from a host material and a dopant material/electron transport layer/electron injection layer/negative electrode, is explained as an example of the method for producing an organic electroluminescent element. On an appropriate substrate, a positive electrode is produced by forming a thin film of a positive electrode material by a vapor deposition method or the like, and then thin films of a hole injection layer and a hole transport layer are formed on this positive electrode. A thin film is formed thereon by co-depositing a host material and a dopant material, and thereby a light emitting layer is obtained. An electron transport layer and an electron injection layer are formed on this light emitting layer, and a thin film formed from a substance for negative electrode is formed by a vapor deposition method or the like as a negative electrode. Thereby, an intended organic electroluminescent element is obtained. Furthermore, in regard to the production of the organic electroluminescent element described above, it is also possible to produce the element by reversing the order of production, that is, in the order of a negative electrode, an electron injection layer, an electron transport layer, a light emitting layer, a hole transport layer, a hole injection layer, and a positive electrode.

In a case in which a direct current voltage is applied to an organic electroluminescent element obtained in this manner, it is desirable to apply the positive polarity to the positive electrode and the negative polarity to the negative electrode, and when a voltage of 2 to 40 V is applied, light emission can be observed from a transparent or semitransparent electrode side (the positive electrode or the negative electrode, or both). Also, this organic electroluminescent element also emits light even when a pulse current or an alternating current is applied. The waveform of the alternating current applied may be any waveform.

### <Application examples of organic electroluminescent element>

Furthermore, the present invention can also be applied to a display apparatus including an organic electroluminescent element, or a lighting apparatus including an organic electroluminescent element.

A display apparatus or lighting apparatus including an organic electroluminescent element can be produced according to a known method such as connecting the organic electroluminescent element according to the present exemplary embodiment and a known driving apparatus. The organic electroluminescent element can be driven by appropriately using a known driving method such as direct current driving, pulse driving or alternating current driving.

Examples of the display apparatus include panel displays such as color flat panel displays; and flexible displays such as flexible organic electroluminescent (EL) displays (see, for example, JP 10-335066 A, JP 2003-321546 A, JP 2004-281086 A, and the like). Furthermore, the display mode of the display may be, for example, a matrix and/or segment mode. Meanwhile, the matrix display and the segment display may co-exist in the same panel.

A matrix refers to a system in which pixels for display are arranged two-dimensionally as in a lattice form or a mosaic form, and characters or images are displayed by collections of pixels. The shape or size of the pixel is determined according to the use. For example, in the display of images and characters of personal computers, monitors and televisions, square pixels each having a size of 300 µm or less on each side are usually used, and in the case of large-sized displays such as display panels, pixels having a size in the order of millimeters on each side are used. In the case of monochromic display, it is desirable to arrange pixels of the same color; however, in the case of color display, display is achieved by arranging pixels of red, green and blue colors. In this case, typically, there are available delta type displays and stripe type displays. Regarding this matrix driving method, any of a line sequential driving method or an active matrix method may be employed. Line sequential driving has an advantage of having a simpler structure; however, there are occasions in which the active matrix method is superior when the operation characteristics are taken into consideration. Therefore, it is necessary to use the driving method appropriately according to the use.

In the segment mode (type), a pattern is formed so as to display predetermined information, and the determined regions are induced to emit light. Examples thereof include the display of time or temperature in a digital clock or a digital thermometer, the display of the state of operation in an audio instrument or an electronic cooker, and the panel display in an automobile.

Examples of the lighting apparatus include the light apparatuses for indoor lighting or the like, and the backlight of a liquid crystal display apparatus (see, for example, JP 2003-257621 A, JP 2003-277741 A, and JP 2004-119211 A). A backlight is mainly used for the purpose of enhancing visibility of a display apparatus that is not self-luminous, and is used in liquid crystal display apparatuses, timepieces, audio apparatuses, automotive panels, display panels, signs, and the like. Particularly, regarding the backlight for the use in liquid crystal display apparatuses, among others, for the use in personal computers where thickness reduction has been a problem to be solved, when it is considered that thickness reduction is difficult because the backlights of conventional types are constructed from fluorescent lamps or light waveguides, a backlight employing the luminescent element according to the present exemplary embodiment is characterized by its thinness and lightweightness.

### 4. Other organic devices

The polycyclic aromatic compound according to the present invention and an oligomer thereof can be used in the production of an organic field effect transistor, an organic thin film solar cell or the like, in addition to the organic electroluminescent element described above.

An organic field effect transistor is a transistor that controls the electric current by means of an electric field generated by voltage input, and is provided with a source electrode, a drain electrode, and a gate electrode. When a voltage is applied to the gate electrode, an electric field is generated, and the field effect transistor can control the electric current by arbitrarily damming the flow of electrons (or holes) that flow between the source electrode and the drain electrode. The field effect transistor can be easily miniaturized compared with simple transistors (bipolar transistors), and can be effectively used as elements that constitute an integrated circuit or the like.

The structure of an organic field effect transistor is usually such that a source electrode and a drain electrode are provided in contact with an organic semiconductor active layer that is formed using the polycyclic aromatic compound according to the present invention and an oligomer thereof, and it is desirable if a gate electrode is provided so as to interpose an insulating layer (dielectric layer) that is in contact with the organic semiconductor active layer. Examples of the element structure include the following structures.
(1) Substrate/gate electrode/insulator layer/source elctrode·drain electrode/organic semiconductor active layer
(2) Substrate/gate electrode/insulator layer/organic semiconductor active layer/source electrode·drain electrode
(3) Substrate/organic semiconductor active layer/source electrode·drain electrode/insulator layer/gate electrode
(4) Substrate/source electrode·drain electrode/organic semiconductor active layer/insulator layer/gate electrode.

An organic field effect transistor configured as such can be applied as a pixel driving switching element of a liquid crystal display or organic electroluminescent display of active matrix-driven type, or the like.

An organic thin film solar cell has a structure in which a positive electrode such as ITO, a hole transport layer, a photoelectric conversion layer, an electron transport layer, and a negative electrode are laminated on a transparent substrate of glass or the like. The photoelectric conversion layer has a p-type semiconductor layer on the positive electrode side, and has an n-type semiconductor layer on the negative electrode side. The polycyclic aromatic compound according to the present invention and an oligomer thereof can be used as the materials of a hole transport layer, a p-type semiconductor layer, an n-type semiconductor layer, or an electron transport layer, depending on the properties. The polycyclic aromatic compound according to the present invention and an oligomer thereof can function as a hole transporting material or an electron transporting material in an organic thin film solar cell. The organic thin film solar cell may appropriately include a hole blocking layer, an electron blocking layer, an electron injection layer, a hole injection layer, a smoothing layer and the like, in addition to the members described above. In the organic thin film solar cell, existing materials that are conventionally used in organic thin film solar cells can be appropriately selected and used in combination.

### EXAMPLES

Hereinafter, the present invention will be explained more specifically by way of Examples, but the present invention is not intended to be limited to these. First, Synthesis Examples of polycyclic aromatic compounds are described below.

### Synthesis Example (1)

### Synthesis of 5,9-dioxa-13b-boranaphtho[3,2,1-de]anthracene

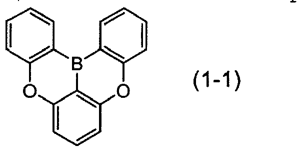

First, a 1.6 M n-butyllithium hexane solution (0.75 ml) was introduced at 0°C into a flask containing diphenoxybenzene (0.26 g) and ortho-xylene (3.0 ml) in a nitrogen atmosphere. After the contents were stirred for 30 minutes, the temperature was increased to 70°C, and the mixture was further stirred for 4 hours. Hexane was distilled off by heating and stirring the mixture at 100°C under a nitrogen gas stream, and then the mixture was cooled to -20°C. Boron tribromide (0.114 ml) was added thereto, and the mixture was stirred for one hour. The temperature of the mixture was raised to room temperature, the mixture was stirred for one hour, subsequently N,N-diisopropylethylamine (0.342 ml) was added thereto, and the resulting mixture was heated and stirred at 120°C for 5 hours. Thereafter, N,N-diisopropylethylamine (0.171 ml) was added thereto, and the mixture was filtered using a Florisil short pass column. The solvent was distilled off under reduced pressure, and thus a crude purification product was obtained. The crude product was washed using methanol, and thus a compound (0.121 g) represented by formula (1-1) was obtained as a white solid.

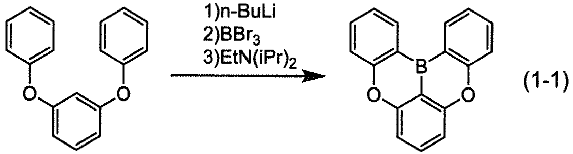

The structure of the compound thus obtained was identified by an NMR analysis.
¹H-NMR (400 MHz, CDCl₃): δ = 8.69 (dd, 2H), 7.79 (t, 1H), 7.70 (ddd, 2H), 7.54 (dt, 2H), 7.38 (ddd, 2H), 7.22 (d, 2H).

### Synthesis Example (2)

### Synthesis of 15b-bora-5,9-dioxaphenanthro[1,2,3-ij]tetraphene

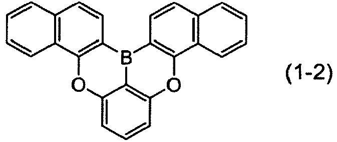

First, 1-bromonaphthalene (0.154 ml) was introduced into a flask containing copper (I) iodide (19.7 mg), α-picolinic acid (26.2 mg), potassium phosphate (0.429 g), resorcinol (57.5 mg) and dimethyl sulfoxide (2.0 ml), at room temperature in a nitrogen atmosphere. The contents were heated and stirred for 33.5 hours at 90°C, 1 Normal aqueous ammonia (3.0 ml) was subsequently added thereto at room temperature, and the aqueous layer was extracted three times with toluene. Subsequently, the solvent was distilled off under reduced pressure. A solid thus obtained was purified by silica gel column chromatography (developing liquid: toluene), and thus 1,3-bis(1-naphthyloxy)benzene (0.155 g) was obtained as a white solid.

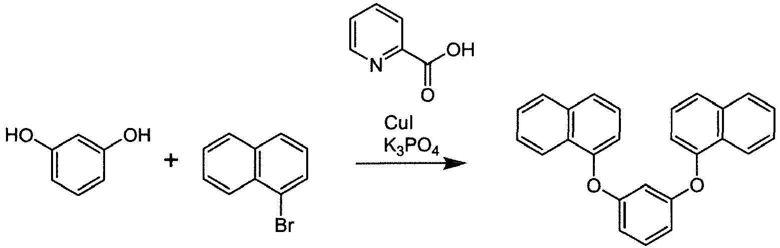

A 1.6 M n-butyllithium hexane solution (9.0 ml) was added dropwise to a flask containing 1,3-bis(1-naphthyloxy)benzene (4.45 g) and ortho-xylene (36 ml), at 0°C in a nitrogen atmosphere. The temperature was increased to 70°C, and the contents were stirred for 4 hours. Subsequently, the temperature was increased to 100°C, and hexane was distilled off. The residue was cooled to 0°C, boron tribromide (1.37 ml) was added thereto, and the mixture was stirred for 2 hours. Subsequently, the temperature of the mixture was increased to room temperature, and the mixture was stirred for 12 hours. The mixture as cooled again to 0°C, N,N-diisopropylethylamine (6.16 ml) was added thereto, subsequently the temperature of the mixture was increased to 120°C, and the mixture was stirred for 8 hours. N,N-diisopropylethylamine (3.08 ml) was added to the mixture at 0°C, and then the mixture was filtered using a Florisil short pass column. The solvent was distilled off under reduced pressure, and thus a crude product was obtained. The crude product was washed using methanol and acetonitrile, and thereby a compound (0.405 g) represented by formula (1-2) was obtained as a white solid.

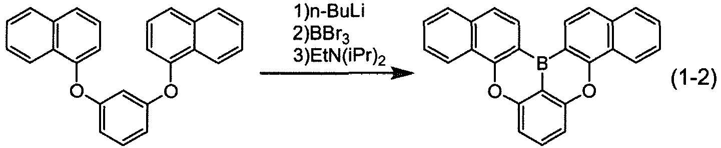

The structure of the compound thus obtained was identified by an NMR analysis.
¹H-NMR (400 MHz, CDCl₃): δ = 8.82 - 8.85 (m, 2H), 8.71 (d, 2H), 7.94 - 7.97 (m, 2H), 7.89 (t, 1H), 7.78 (d, 2H), 7.66 - 7.71 (m, 4H), 7.48 (d, 2H).

### Synthesis Example (3)

### Synthesis of 2,12-diphenyl-5,9-dioxa-13b-boranaphtho[3,2,1-de]anthracene

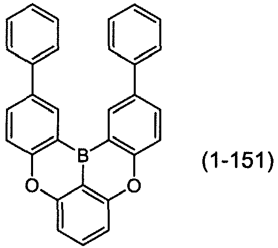

Copper(I) iodide (1.0 g) and iron(III) acetylacetonate (3.7 g) were added to an NMP (120 ml) solution of 1,3-dibromobenzene (25 g), [1,1'-biphenyl]-4-ol (39.7 g) and potassium carbonate (58.6 g) in a nitrogen atmosphere, the temperature of the mixture was increased to 150°C, and the mixture was stirred for 4 hours. The reaction liquid was cooled to room temperature, and a salt precipitated by adding ethyl acetate and aqueous ammonia thereto was removed by suction filtration using a Hirsch funnel covered with Celite. The filtrate was partitioned, and the solvent of the organic layer was distilled off under reduced pressure. Subsequently, the residue was dissolved in ethyl acetate, and the residue was reprecipitated by adding heptane thereto. The precipitate was further passed through a silica gel short pass column (developing liquid: heated chlorobenzene), and a solid obtained by distilling off the solvent under reduced pressure was reprecipitated from ethyl acetate/heptane. Thus, 1,3-bis([1,1'-biphenyl]-4-yloxy)benzene (33.0 g) was obtained.

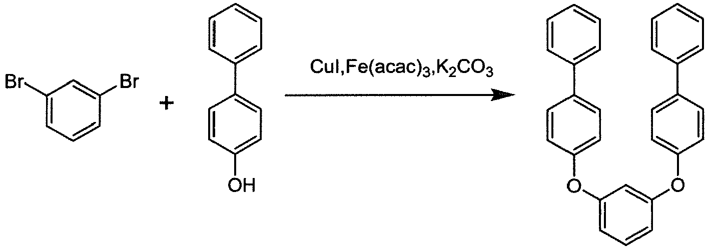

A 2.6 M n-butyllithium hexane solution (29.2 ml) was introduced into a flask containing 1,3-bis([1,1'-biphenyl]-4-yloxy)benzene (30.0 g) and ortho-xylene (500 ml), at 0°C in a nitrogen atmosphere. After completion of dropwise addition, the temperature of the mixture was increased to 70°C, and the mixture was stirred for one hour. The temperature of the mixture was further increased to 100°C, and hexane was distilled off. The mixture was stirred overnight at room temperature, and then the mixture was cooled to -30°C. Boron tribromide (8.4 ml) was added thereto, the temperature of the mixture was increased to room temperature, and the mixture was stirred for one hour. Thereafter, the mixture was cooled to 0°C again, N,N-diisopropylethylamine (25.0 ml) was added thereto, and the mixture was stirred at room temperature until heat generation was settled, and then was heated and stirred for 4 hours at 120°C. The reaction liquid was cooled to room temperature, and crystals thus precipitated were collected by suction filtration and washed with an aqueous solution of sodium acetate. Furthermore, the crystals were washed with heptane, ethyl acetate and methanol in this order, and thereby a compound (16.6 g) represented by formula (1-151) was obtained.

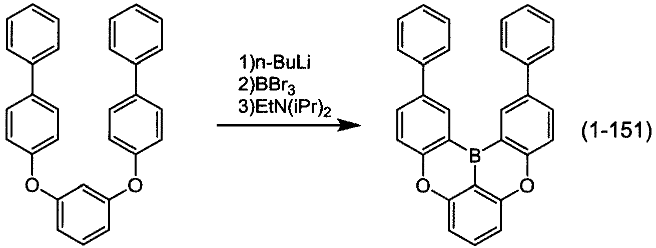

The structure of a compound thus obtained was identified by an NMR analysis.
¹H-NMR (400 MHz, CDCl₃) : δ = 8.96 (m, 2H), 7.97 (dd, 2H), 7.83 (t, 1H), 7.74 (m, 4H), 7.64 (d, 2H), 7.51 (t, 4H), 7.40 (t, 2H), 7.28 (d, 2H).

### Synthesis Example (4)

### Synthesis of 6,8-diphenyl-5,9-dioxa-13b-boranaphtho[3,2,1-de]anthracene

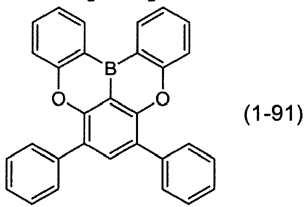

A flask containing 1,5-dibromo-2,4-difluorobenzene (30.0 g), phenol (31.2 g), potassium carbonate (45.7 g) and NMP (150 ml) was heated with stirring at 160°C. The reaction liquid was cooled to room temperature, and NMP was distilled off under reduced pressure. Subsequently, water and toluene were added thereto, and the reaction liquid was partitioned. The solvent was distilled off under reduced pressure, and then the residue was purified using a silica gel short pass column (developing liquid: heptane/toluene = 1 (volume ratio)). Thus, ((4,6-dibromo-1,3-phenylene)bis(oxy))dibenzene (44.0 g) was obtained.

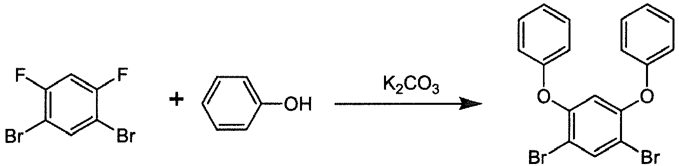

In a nitrogen atmosphere, Pd(PPh₃)₄ (5.5 g) was added to a suspension solution of ((4,6-dibromo-1,3-phenylene)bis(oxy))dibenzene (44.0 g), phenylboronic acid (34.8 g), sodium carbonate (60.6 g), toluene (500 ml), isopropanol (100 ml) and water (100 ml), and the mixture was stirred for 8 hours at the reflux temperature. The reaction liquid was cooled to room temperature, water and toluene were added thereto, and then the mixture was partitioned. The solvent of the organic layer was distilled off under reduced pressure. A solid thus obtained was dissolved in heated chlorobenzene, and the solution was passed through a silica gel short pass column (developing liquid: toluene). An appropriate amount of the solvent was distilled off, and then reprecipitation was carried out by adding heptane to the residue. Thus, 4',6'-diphenoxy-1,1':3',1"-terphenyl (41.0 g) was obtained.

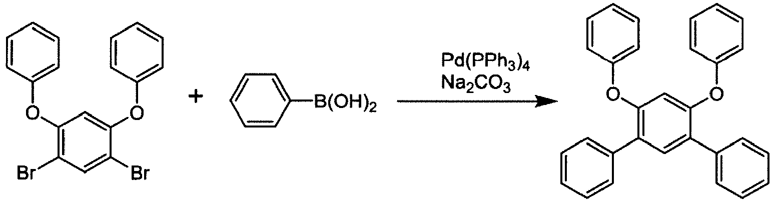

A 2.6 M n-butyllithium hexane solution (29.0 ml) was introduced into a flask containing 4',6'-diphenoxy-1,1':3',1"-terphenyl (30.0 g) and ortho-xylene (300 ml), at 0°C in a nitrogen atmosphere. After completion of dropwise addition, the temperature of the mixture was increased to 70°C, and the mixture was stirred for 4 hours. The temperature of the mixture was further increased to 100°C, and hexane was distilled off. The mixture was cooled to -50°C, and boron tribromide (8.4 ml) was added thereto. The temperature of the mixture was increased to room temperature, and the mixture was stirred for one hour. Thereafter, the mixture was cooled again to 0°C, N,N-diisopropylethylamine (25.0 ml) was added thereto, and the mixture was stirred at room temperature until heat generation was settled, and then was heated and stirred for 4 hours at 120°C. The reaction liquid was cooled to room temperature, and an organic material was extracted with toluene. Water was added to the toluene solution thus obtained, the mixture was partitioned, and the solvent was distilled off under reduced pressure. A solid thus obtained was dissolved in chlorobenzene, subsequently an appropriate amount was distilled off under reduced pressure, and reprecipitation was carried out by adding heptane thereto. Reprecipitation was further carried out in the same manner except that heptane was replaced with ethyl acetate. Thus, a compound (4.2 g) represented by formula (1-91) was obtained.

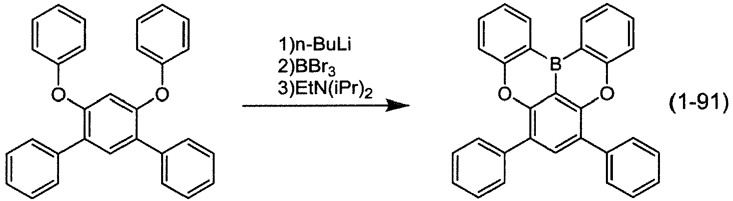

The structure of the compound thus obtained was identified by an NMR analysis. ¹H-NMR (400 MHz, CDCl₃): δ = 8.74 (d, 2H), 8.00 (s, 1H), 7.81 (d, 4H), 7.69 (t, 2H), 7.54 (t, 4H), 7.49 (m, 2H), 7.37 - 7.46 (m, 4H).

### Synthesis Example (5)

### Synthesis of 6,8-di(9H-carbazol-9-yl)-5,9-dioxa-13b-boranaphtho[3,2,1-de ]anthracene

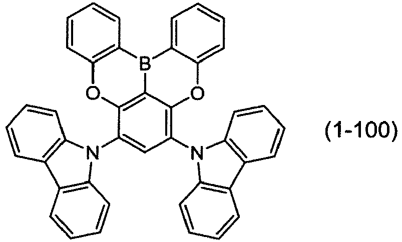

In a nitrogen atmosphere, a solution of 1,5-dibromo-2,4-difluorobenzene (600.0 g), carbazole (81.1 g), potassium carbonate (91.0 g) and NMP (300 ml) was heated to 155°C, and the mixture was stirred for 4 hours. The reaction liquid was cooled to room temperature, water was added thereto to dissolve inorganic salts, and an organic material was collected by suction filtration. The organic material was washed with ethyl acetate, and then was dissolved in heated ortho-dichlorobenzene. The solution was passed through a silica gel short pass column (developing liquid: ortho-dichlorobenzene). The solvent was distilled off under reduced pressure, and then the residue was further washed with ethyl acetate. Thus, 9,9'-(4,6-dibromo-1,3-phenylene)bis(9H-carbazole) (108.0 g) was obtained.

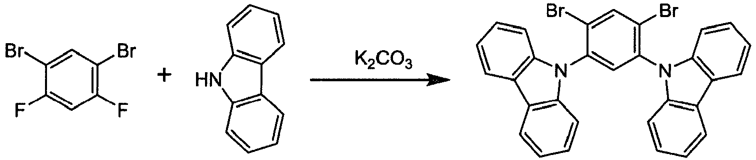

Copper (I) iodide (0.84 g) and iron(III) acetylacetonate (3.1 g) were added to an NMP (200 ml) solution of 9,9'-(4,6-dibromo-1,3-phenylene)bis(9H-carbazole) (50.0 g), phenol (10.0 g) and potassium carbonate (49.0 g) in a nitrogen atmosphere, and the temperature of the mixture was increased to 150°C. The mixture was stirred for 4 hours. The reaction liquid was cooled to room temperature, ethyl acetate and aqueous ammonia were added thereto, and then the mixture was partitioned. The solvent of the organic layer was distilled off under reduced pressure. Subsequently, the residue was purified by silica gel column chromatography (developing liquid: toluene/heptane = 1 (volume ratio)), and then a solid obtained by distilling off the solvent under reduced pressure was washed with heptane. Thus, 9,9'-(4,6-diphenoxy-1,3-phenylene)bis(9H-carbazole) (16.8 g) was obtained.

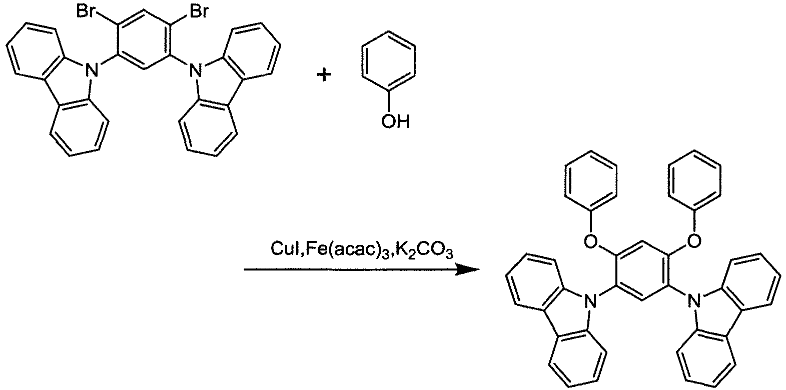

A 2.6 M n-butyllithium hexane solution (11.2 ml) was introduced into a flask containing 9,9'-(4,6-diphenoxy-1,3-phenylene)bis(9H-carbazole) (16.5 g) and ortho-xylene (150 ml), at 0°C in a nitrogen atmosphere. After completion of dropwise addition, the temperature of the mixture was increased to 70°C, and the mixture was stirred for 4 hours. The temperature of the mixture was further increased to 100°C, and hexane was distilled off under reduced pressure. The mixture was cooled to -50°C, boron tribromide (3.2 ml) was added thereto, the temperature of the mixture was increased to room temperature, and the mixture was stirred for one hour. Thereafter, the mixture was cooled again to 0°C, and N,N-diisopropylethylamine (25.0 ml) was added thereto. The mixture was stirred at room temperature until heat generation was settled, and then the mixture was heated and stirred for 4 hours at 120°C. The reaction liquid was cooled to room temperature, an aqueous solution of sodium acetate and ethyl acetate were added thereto, and then the mixture was partitioned. A solid precipitated by distilling off the solvent under reduced pressure was collected by suction filtration, and the solid was washed with heptane . From a chlorobenzene solution of the solid thus obtained, an appropriate amount of the solvent was distilled off under reduced pressure, and the solid was reprecipitated by further adding ethyl acetate. Thus, a compound (9.5 g) represented by formula (1-100) was obtained.

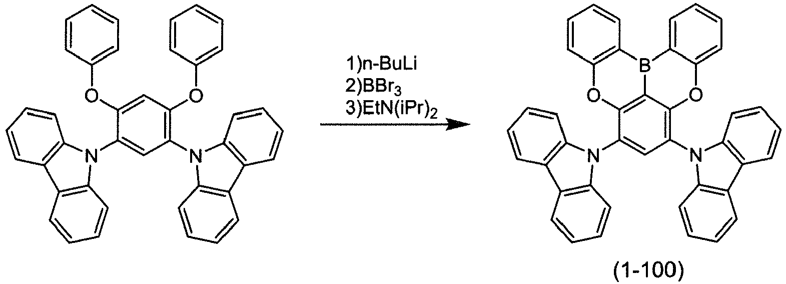

The structure of the compound thus obtained was identified by an NMR analysis.
¹H-NMR (400 MHz, CDCl₃) : δ = 8.77 (d, 2H), 8.25 (s, 1H), 8.21 (d, 4H), 7.61 (t, 2H), 7.42 (m, 6H), 7.33 (m, 8H), 7.10 (d, 2H).

### Synthesis Example (6)

### Synthesis of N⁶,N⁶,N⁸,N⁸-tetraphenyl-5,9-dioxa-13b-boranaphtho[3,2,1-de]a nthracene-6,8-diamine

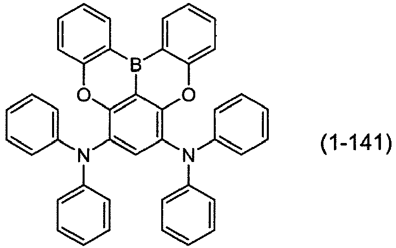

A flask containing ((4,6-dibromo-1,3-phenylene)bis(oxy))dibenzene (45.0 g), diphenylamine (45.0 g), Pd(dba)₂ (1.2 g), (4-(N,N-dimethylamino)phenyl)-di-t-butylphosphine (A-^{ta}Phos) (1.1 g), NaOtBu (25.7 g) and toluene (250 ml) was heated to 100°C and stirred for 4 hours. The reaction liquid was cooled to room temperature, water and ethyl acetate were added thereto, the mixture was partitioned, and then the solvent was distilled off under reduced pressure. Subsequently, the residue was purified by silica gel column chromatography (developing liquid: toluene/heptane = 1 (volume ratio)), and was dissolved in ethyl acetate. The residue was reprecipitated by adding heptane thereto. Thus, 4,6-diphenoxy-N¹,N¹,N³,N³-tetrapheylbenzene-1,3-diamine (17.6 g) was obtained.

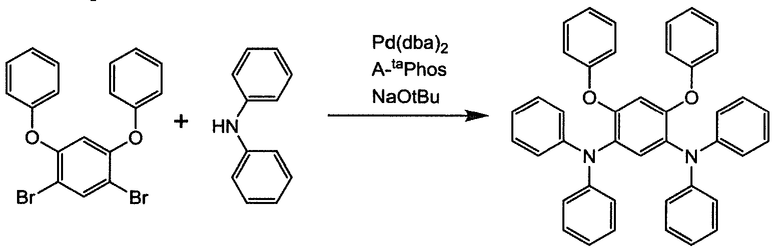

A 2.6 M n-butyllithium hexane solution (11.8 ml) was introduced into a flask containing 4,6-diphenoxy-N¹,N¹,N³,N³-tetraphenylbenzene-1,3-diamine (17.5 g) and ortho-xylene (130 ml), at 0°C in a nitrogen atmosphere. After completion of dropwise addition, the temperature of the mixture was increased to 70°C, and the mixture was stirred for 4 hours. Furthermore, the temperature of the mixture was increased to 100°C, and hexane was distilled off. The mixture was cooled to -50°C, boron tribromide (3.4 ml) was added thereto, the temperature of the mixture was increased to room temperature, and the mixture was stirred for one hour. Thereafter, the mixture was cooled again to 0°C, N,N-diisopropylethylamine (10.0 ml) was added thereto, and the mixture was stirred at room temperature until heat generation was settled. Subsequently, the mixture was heated and stirred for 4 hours at 120°C. The reaction liquid was cooled to room temperature, an aqueous solution of sodium acetate and ethyl acetate were added thereto, and then the mixture was partitioned. Precipitation was induced by distilling off the solvent under reduced pressure, and then the precipitate was purified by silica gel column chromatography (developing liquid: heptane/toluene = 3/2 (volume ratio)). Furthermore, the product was dissolved in chlorobenzene, and then was reprecipitated by distilling off an appropriate amount of the solvent under reduced pressure. Thus, a compound (5.5 g) represented by formula (1-141) was obtained.

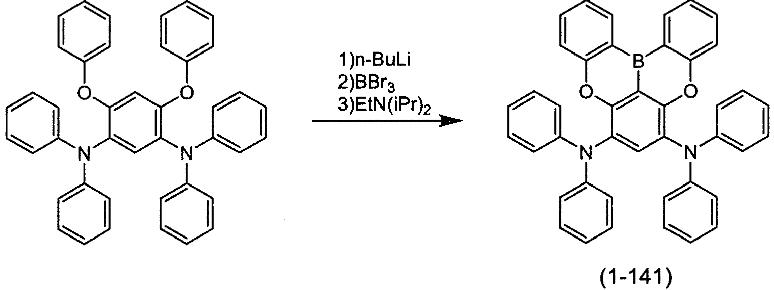

The structure of the compound thus obtained was identified by an NMR analysis.
¹H-NMR (400 MHz, CDCl₃): δ = 8.60 (d, 2H), 7.80 (s, 1H), 7.55 (t, 2H), 7.30 (t, 2H), 7.22 (m, 8H), 7.12 (m, 8H), 7.02 (d, 2H), 6.94 (t, 4H).

### Synthesis Example (7)

### Synthesis of 5,13-diphenyl-5,13-dihydro-7,11-dioxa-18b-boraphenaleno[2,1 -b:8,9-b']dicarbazole

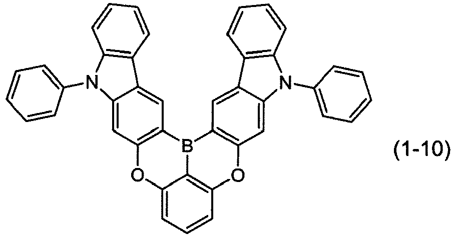

In a nitrogen atmosphere, a flask containing 9H-carbazol-2-ol (25.0 g), iodobenzene (30.6 g), Pd(dba)₂ (2.4 g), a 1 M tri-t-butylphosphine toluene solution (8.2 ml), NaOtBu (33.0 g), and 1,2,4-trimethylbenzene (250 ml) was heated to 120°C and stirred for 6 hours. The reaction liquid was cooled to room temperature, water and ethyl acetate were added thereto, and the mixture was neutralized by adding dilute hydrochloric acid. The solvent was distilled off under reduced pressure, and then the residue was purified by silica gel column chromatography (developing liquid: toluene/heptane = 1 (volume ratio)) and was further washed with heptane. Thus, 9-phenyl-9H-carbazol-2-ol (30.8 g) was obtained.

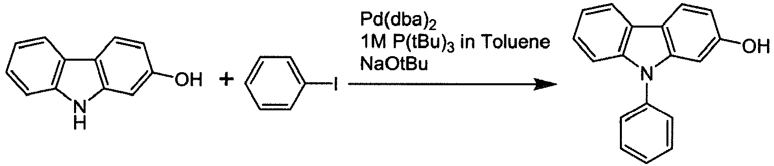

Copper(I) iodide (0.51 g) and iron(III) acetylacetonate (1.9 g) were added to an NMP (150 ml) solution of 9-phenyl-9H-carbazol-2-ol (30.7 g), 1,3-dibromobenzene (12.7 g) and potassium carbonate (30.0 g) in a nitrogen atmosphere, and the temperature of the mixture was increased to 150°C and stirred for 8 hours. The reaction liquid was cooled to room temperature, ethyl acetate and aqueous ammonia were added thereto, and then the mixture was partitioned. The solvent of the organic layer was distilled off under reduced pressure. Subsequently, the residue was purified by silica gel column chromatography (developing liquid: toluene/heptane = 4/6 (volume ratio)), and thus 1,3-bis((9-phenyl-9H-carbazol-2-yl)oxy)benzene (22.0 g) was obtained.

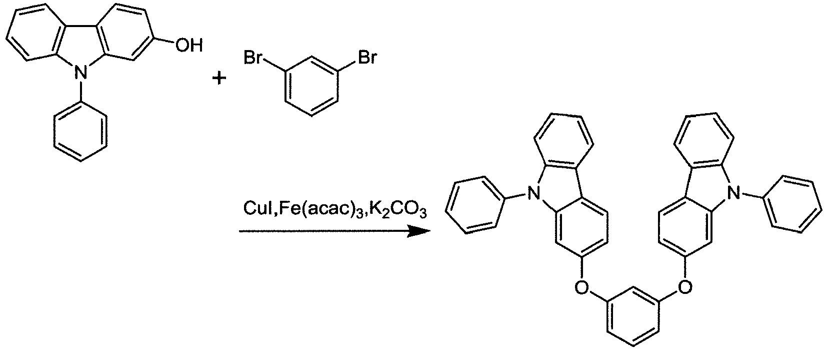

A 2.6 M n-butyllithium hexane solution (15.0 ml) was introduced into a flask containing 1,3-bis((9-phenyl-9H-carbazol-2-yl)oxy)benzene (22.0 g) and t-butylbenzene (120 ml), at 0°C in a nitrogen atmosphere. After completion of dropwise addition, the temperature of the mixture was increased to 70°C, and the mixture was stirred for 4 hours. The temperature of the mixture was further increased to 100°C, and hexane was distilled off. The residue was cooled to -50°C, boron tribromide (11 g) was added thereto, and the temperature of the mixture was increased to room temperature. The mixture was stirred for one hour. Thereafter, the mixture was cooled again to 0°C, N,N-diisopropylethylamine (9.6 g) was added thereto, and the mixture was stirred at room temperature until heat generation was settled. Subsequently, the mixture was heated and stirred for 2 hours at 120°C. The reaction liquid was cooled to room temperature, and a precipitate generated by adding an aqueous solution of sodium acetate thereto was collected by suction filtration. The precipitate was washed with heptane, ethyl acetate and methanol in this order, and was further washed with refluxed chlorobenzene. Thus, a compound (6.8 g) represented by formula (1-10) was obtained.

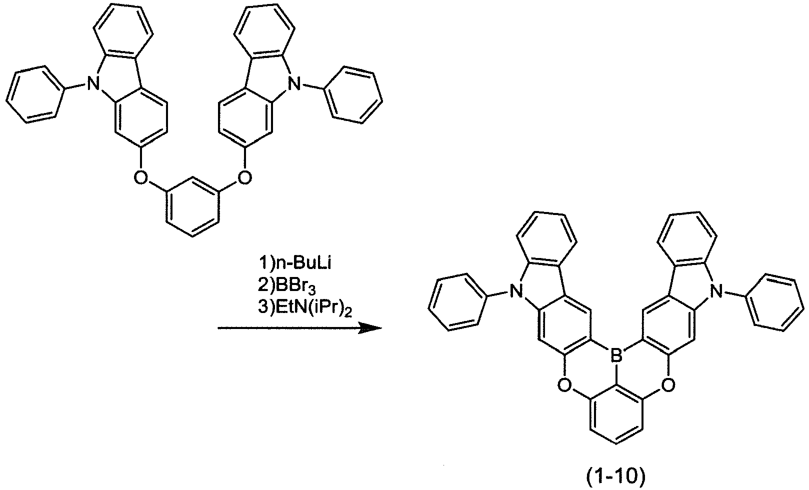

The structure of the compound thus obtained was identified by an NMR analysis.
¹H-NMR (400 MHz, CDCl₃): δ = 9.61 (s, 2H), 8.42 (m, 2H), 7.64 - 7.77 (m, 9H), 7.52 - 7.58 (m, 2H), 7.42 - 7.51 (m, 8H), 7.13 (d, 2H).

### Synthesis Example (8)

### Synthesis of N³,N³,N¹¹,N¹¹-tetraphenyl-5,9-dioxa-13b-boranaphtho[3,2,1-de] anthracene-3,11-diamine

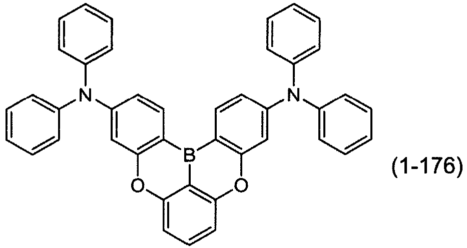

A flask containing diphenylamine (41.0 g), 3-bromophenol (40.0 g), Pd(dba)₂ (0.7 g), A-^{ta}Phos (0.6 g), NaOtBu (56.0 g), and toluene (400 ml) was heated to 80°C and stirred for one hour. The reaction liquid was cooled to room temperature, subsequently water and ethyl acetate were added thereto, and then the mixture was partitioned. The solvent was distilled off under reduced pressure. The residue was purified by silica gel column chromatography (developing liquid: toluene/heptane = 1 (volume ratio)), and a solid thus obtained was washed with heptane. Thus, 3-(diphenylamino)phenol (69.5 g) was obtained.

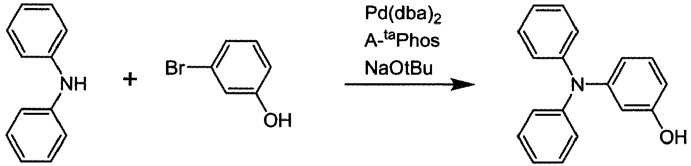

Copper (I) iodide (0.56 g) and iron (III) acetylacetonate (2.1 g) were added to an NMP (150 ml) solution of 3-(diphenylamino)phenol (34.1 g), 1,3-dibromobenzene (14.0 g) and potassium carbonate (33.0 g) in a nitrogen atmosphere. The temperature of the mixture was increased to 150°C, and the mixture was stirred for 10 hours. The reaction liquid was cooled to room temperature, ethyl acetate and aqueous ammonia were added thereto, and then the mixture was partitioned. The solvent of the organic layer was distilled off under reduced pressure. Subsequently, the residue was purified by silica gel column chromatography (developing liquid: toluene/heptane = 4/6 (volume ratio)), and 3,3'-(1,3-phenylenebis(oxy))bis(N,N-diphenylaniline) (27.0 g was obtained.

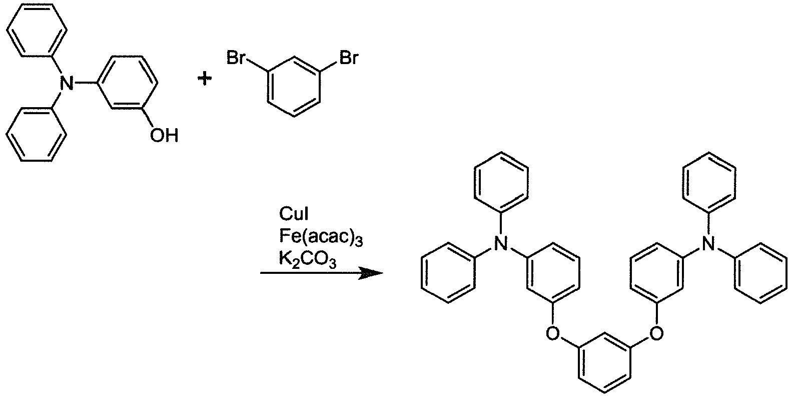

A 2.6 M n-butyllithium hexane solution (18.3 ml) was introduced into a flask containing 3,3'-(1,3-phenylenebis(oxy))bis(N,N-diphenylaniline) (27.0 g) and xylene (150 ml), at 0°C in a nitrogen atmosphere. After completion of dropwise addition, the temperature of the mixture was increased to 70°C, and the mixture was stirred for 4 hours. The temperature of the mixture was further increased to 100°C, and hexane was distilled off. The mixture was cooled to -50°C, boron tribromide (13.6 g) was added thereto, the temperature of the mixture was increased to room temperature, and the mixture was stirred for one hour. Thereafter, the mixture was cooled again to 0°C, N,N-diisopropylethylamine (11.7 g) was added thereto, and the mixture was stirred at room temperature until heat generation was settled. Subsequently, the mixture was heated and stirred for 2 hours at 120°C. The reaction liquid was cooled to room temperature, and a precipitate generated by adding an aqueous solution of sodium acetate was collected by suction filtration. The solid thus obtained was dissolved in ortho-dichlorobenzene, and reprecipitation was carried out by concentrating the solution. Thus, a compound (6.2 g) represented by formula (1-176) was obtained.

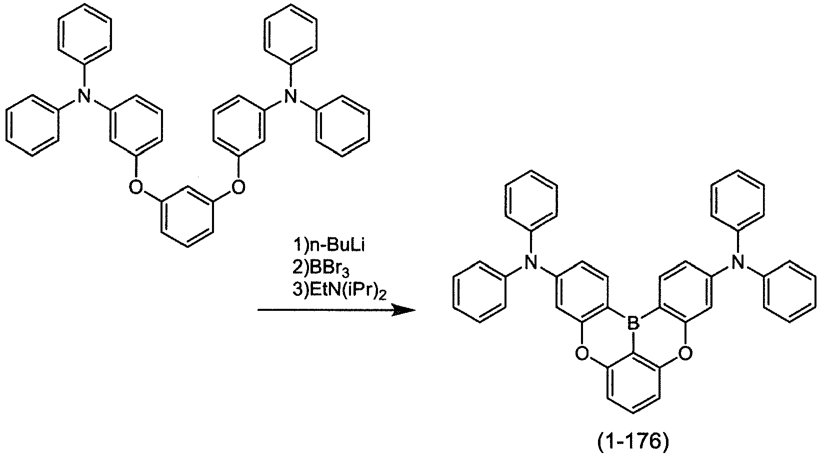

The structure of the compound thus obtained was identified by an NMR analysis.
¹H-NMR (400 MHz, CDCl₃) : δ = 8.35 (d, 2H), 7.61 (t, 1H), 7.34 (t, 8H), 7.23 (d, 8H), 7.15 (t, 4H), 7.02 (m, 4H), 6.98 (m, 2H).

### Synthesis Example (9)

### Synthesis of 9-(5,9-dioxa-13b-boranaphtho[3,2,1-de]anthracen-7-yl)-9H-ca rbazole

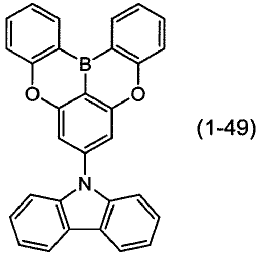

In a nitrogen atmosphere, a flask containing 1,3-dibromo-5-fluorobenzene (50.0 g), carbazole (39.5 g), cesium carbonate (96.2 g) and DMSO (500 ml) was heated to 150°C and stirred for 10 hours. The reaction liquid was cooled to room temperature, and a precipitate precipitated by adding water thereto was collected by suction filtration. A solid thus obtained was purified by silica gel column chromatography (developing liquid: toluene/heptane = 1/10 (volume ratio)), and then the solid was recrystallized from a mixed solvent of toluene/heptane. Thus, 9-(3,5-dibromophenyl)-9H-carbazole (49.0 g) was obtained.

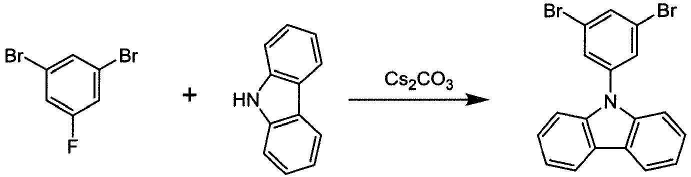

Copper (I) iodide (0.71 g) and iron(III) acetylacetonate (2.6 g) were added to an NMP (240 ml) solution of phenol (21.1 g), 9-(3,5-dibromophenyl)-9H-carbazole (30.0 g) and potassium carbonate (41.3 g) in a nitrogen atmosphere. The temperature of the mixture was increased to 150°C, and the mixture was stirred for 6 hours. The reaction liquid was cooled to room temperature, subsequently toluene was added thereto, and the mixture was suction filtered using a Hirsch funnel covered with Celite. A saturated sodium chloride solution was added to the filtrate, and the mixture was partitioned. The organic layer was distilled off under reduced pressure, and the residue was purified by silica gel column chromatography (developing liquid: toluene/heptane = 2/1 (volume ratio)). Thus, 9-(3,5-diphenoxyphenyl)-9H-carbazole (27.3 g) was obtained.

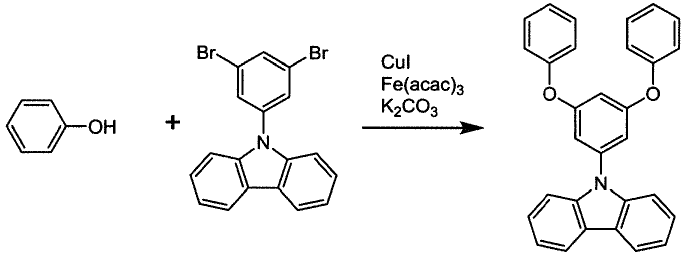

A 1.6 M n-butyllithium hexane solution (16.1 ml) was introduced into a flask containing 9-(3,5-diphenoxyphenyl)-9H-carbazole (10.0 g) and xylene (100 ml), at 0°C in a nitrogen atmosphere. After completion of dropwise addition, the temperature of the mixture was increased to 70°C, and the mixture was stirred for 4 hours. The temperature of the mixture was further increased to 100°C, and hexane was distilled off. The mixture was cooled to -50°C, boron tribromide (2.7 ml) was added thereto, the temperature of the mixture was increased to room temperature, and the mixture was stirred for one hour. Thereafter, the mixture was cooled again to 0°C, N,N-diisopropylethylamine (8.1 ml) was added thereto, and the mixture was stirred at room temperature until heat generation was settled. Subsequently, the mixture was heated and stirred for 8 hours at 120°C. The reaction liquid was cooled to room temperature, an aqueous solution of sodium acetate and toluene were added thereto, and then the mixture was partitioned. Subsequently, the solvent was distilled off under reduced pressure. A solid thus obtained was recrystallized from toluene, and thus a compound (1.7 g) represented by formula (1-49) was obtained.

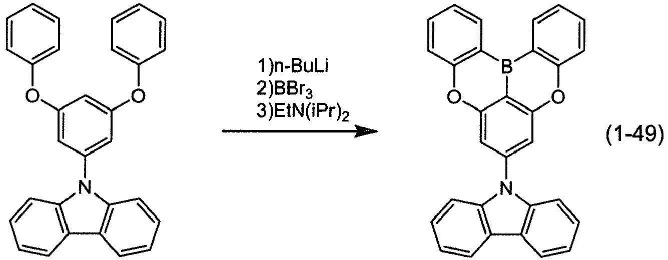

The structure of the compound thus obtained was identified by an NMR analysis. ¹H-NMR (400 MHz, CDCl₃): δ = 8.75 (d, 2H), 8.18 (d, 2H), 7.75 (t, 2H), 7.71 (d, 2H), 7.58 (d, 2H), 7.50 (s, 2H), 7.42 - 7.49 (m, 4H), 7.35 (t, 2H).

### Synthesis Example (10)

### Synthesis of 10-(5,9-dioxa-13b-boranaphtho[3,2,1-de]anthracen-7-yl)-10H-phenoxazine

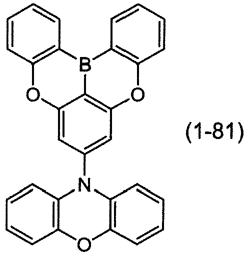

In a nitrogen atmosphere, a solution of 1-bromo-3,5-difluorobenzene (23.0 g), phenol (33.6 g), potassium carbonate (49.4 g) and NMP (150 ml) was heated to 170°C and was stirred for 10 hours. The reaction liquid was cooled to room temperature, toluene and a saturated aqueous solution of sodium chloride were added thereto, and then the mixture was partitioned. The solvent was distilled off under reduced pressure. Subsequently, the residue was purified by silica gel column chromatography (developing liquid: heptane), and ((5-bromo-1,3-phenylene)bis(oxy))dibenzene (35.9 g) was obtained.

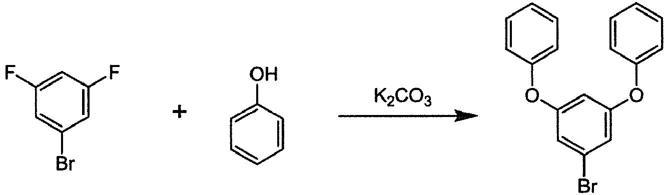

In a nitrogen atmosphere, a flask containing ((5-bromo-1,3-phenylene)bis(oxy))dibenzene (14.0 g), phenoxazine (8.3 g), Pd(dba)₂ (0.71 g), A-^{ta}Phos (0.98 g), NaOtBu (5.9 g), and ortho-xylene (100 ml) was heated to 120°C and stirred for one hour. The reaction liquid was cooled to room temperature, subsequently water and toluene were added thereto, and then the mixture was partitioned. The solvent was distilled off under reduced pressure. A solid thus obtained was purified by silica gel column chromatography (developing liquid: toluene/heptane = 1/5 (volume ratio)) was purified, and thus 10-(3,5-diphenoxyphenyl)-10H-phenoxazine (18.0 g) was obtained.

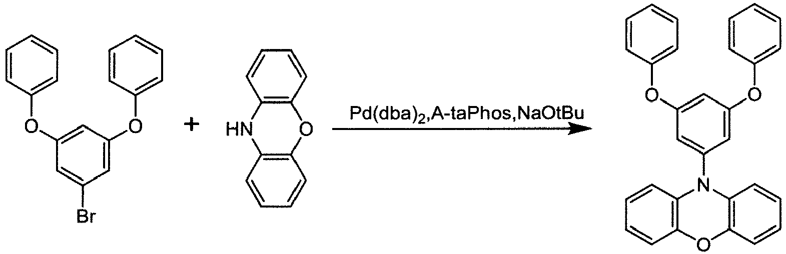

A 1.6 M n-butyllithium hexane solution (15.5 ml) was introduced into a flask containing 10-(3,5-diphenoxyphenyl)-10H-phenoxazine (10.0 g) and xylene (100 ml), at 0°C in a nitrogen atmosphere. After completion of dropwise addition, the temperature was increased to 70°C, and the mixture was stirred for 4 hours. The temperature of the mixture was further increased to 100°C, and hexane was distilled off. The mixture was cooled to -50°C, boron tribromide (2.6 ml) was added thereto, the temperature of the mixture was increased to room temperature, and the mixture was stirred for one hour. Thereafter, the mixture was cooled again to 0°C, N,N-diisopropylethylamine (7.8 ml) was added thereto, and the mixture was stirred at room temperature until heat generation was settled. Subsequently, the mixture was heated and stirred for 8 hours at 120°C. The reaction liquid was cooled to room temperature, an aqueous solution of sodium acetate and toluene were added thereto, and then the mixture was partitioned. Subsequently, the solvent was distilled off under reduced pressure. A solid thus obtained was purified by silica gel column chromatography (developing liquid: toluene/heptane = 1/10 (volume ratio)) and was recrystallized from toluene. Thus, a compound (1.8 g) represented by formula (1-81) was obtained.

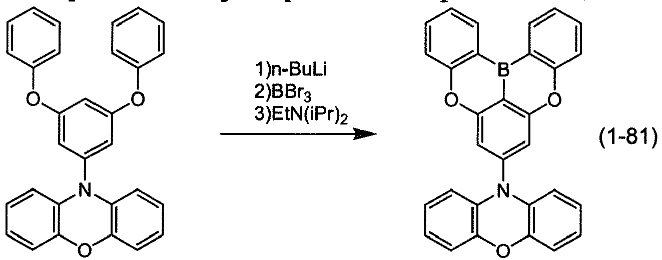

The structure of the compound thus obtained was identified by an NMR analysis.
¹H-NMR (400 MHz, CDCl₃): δ = 8.73 (d, 2H), 7.75 (t, 2H), 7.56 (d, 2H), 7.44 (t, 2H), 7.25 (s, 2H), 6.57 - 6.80 (m, 6H), 6.13 (br, 2H).

### Synthesis Example (11)

### Synthesis of 5,9-dimethyl-5,9-dihydro-5,9-diaza-13b-boranaphtho[3,2,1-de ]anthracene

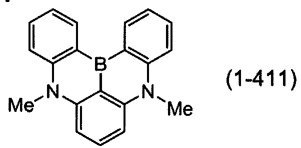

A 1. 6 M n-butyllithium hexane solution (25.0 ml) was added to a t-butylbenzene (20 ml) solution of N¹,N³-dimethyl-N¹,N³-diphenylbenzene-1,3-diamine (2.9 g) at 0°C in a nitrogen atmosphere. The temperature of the mixture was increased to 100°C, hexane was distilled off, and the residue was further heated and stirred for 21 hours. The mixture was cooled to -40°C, THF (10 ml) was added thereto, and then boron tribromide (1.9 ml) was added thereto. The temperature of the mixture was increased to room temperature over one hour, and then the mixture was cooled to 0°C. N,N-diisopropylamine (5.2 ml) was added thereto, and the mixture was filtered using a Florisil short pass column. The solvent was distilled off under reduced pressure, and then the residue was washed with acetonitrile. Thus, a compound (0.96 g) represented by formula (1-411) was obtained as a yellowish green solid.

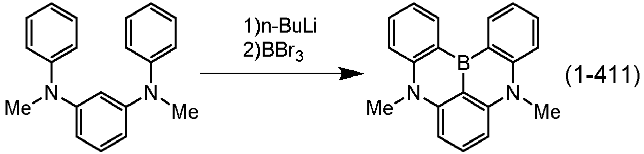

The structure of the compound thus obtained was identified by an NMR analysis.
¹H-NMR (400 MHz, CDCl₃) : δ = 8.73 (dd, 2H), 7.75 (t, 1H), 7.67 (m, 2H), 7.57 (dd, 2H), 7.29 (m, 2H), 7.00 (d, 2H), 3.91 (s, 6H).

### Synthesis Example (15)

### Synthesis of 7,11-dioxa-17c-boraphenanthro[2,3,4-no]tetraphene

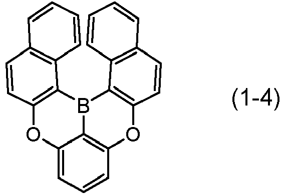

First, 2-bromonaphthalene (50.6 g) was added to a flask containing copper iodide (4.9 g), α-picolinic acid (6.3 g), potassium phosphate (101.9 g), resorcinol (12.8 g) and dimethyl sulfoxide (DMSO) (400 ml) in a nitrogen atmosphere, and the mixture was heated and stirred for 17 hours at 130°. After the reaction was terminated, the reaction liquid was cooled to 0°C, 1 Normal aqueous ammonia (160 ml) was added thereto, toluene was added thereto, and then the mixture was partitioned. The solvent was distilled off under reduced pressure, and a solid thus obtained was washed with methanol. Thus, 1,3-bis (2-naphthyloxy) benzene (34.5 g) was obtained as a white solid.

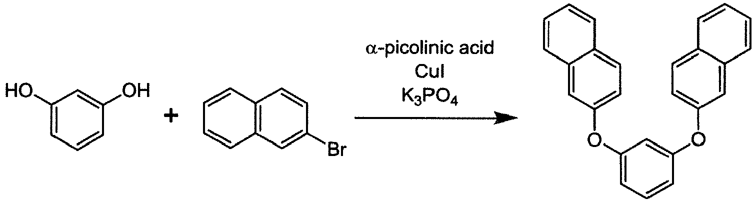

In a nitrogen atmosphere, a flask containing 1,3-bis(2-naphthyloxy)benzene (1.8 g) and t-butylbenzene (15 ml) was cooled at 0°C, and a 1.6 M n-butyllithium hexane solution (4.7 ml) was added dropwise thereto. After completion of dropwise addition, hexane was distilled off by heating and stirring the mixture for 0.5 hours at 90°C, and the residue was further heated and stirred for 3.5 hours at this temperature. Thereafter, the reaction liquid was cooled to -40°C, boron tribromide (0.95 ml) was added thereto, and the mixture was stirred for 2 hours. Furthermore, the mixture was stirred for 13 hours at room temperature, and then was cooled to 0°C. N,N-diisopropylethylamine (1.74 ml) was added thereto. Furthermore, the mixture was heated and stirred for 24 hours at 100°C, and then the mixture was filtered using a Florisil short pass column. The solvent was distilled off under reduced pressure. A solid thus obtained was washed using acetonitrile, and thus a compound (0.6 g) represented by formula (1-4) was obtained.

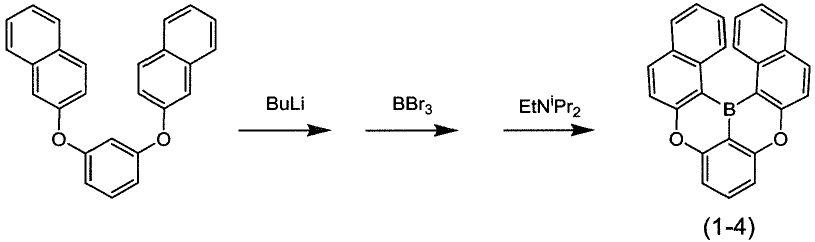

The structure of the compound thus obtained was identified by an NMR analysis.
¹H-NMR (400 MHz, CDCl₃) : δ = 8.16 (d, 2H), 7.91 (d, 2H), 7.80 (t, 1H), 7.76 (d, 2H), 7.74 (d, 2H), 7.42 (dd, 2H), 7.39 (d, 2H), 7.09 (dd, 2H).

### Synthesis Example (16)

### Synthesis of N,N,5,9-tetraphenyl-5,9-dihydro-5,9-diaza-13b-boranaphtho[3 ,2,1-de]anthracen-7-amine

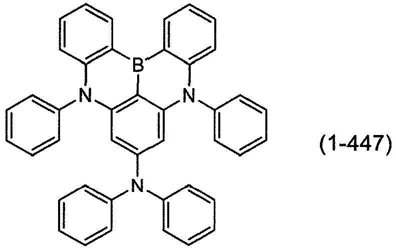

In a nitrogen atmosphere, boron tribromide (3.78 ml, 40 mmol) was introduced at room temperature into a flask containing N¹,N¹,N³,N³,N⁵,N⁵-hexaphenyl-1,3,5-benzenetriamine (11.6 g, 20 mmol) and o-dichlorobenzene (120 ml), and then the mixture was heated and stirred for 48 hours at 170°C. Subsequently, the reaction solution was distilled off at 60°C under reduced pressure. The reaction solution was filtered using a Florisil short pass column, and the solvent was distilled off under reduced pressure. Thus, a crude product was obtained. The crude product was washed using hexane, and thus a compound (11.0 g) represented by formula (1-447) was obtained as a yellow solid.

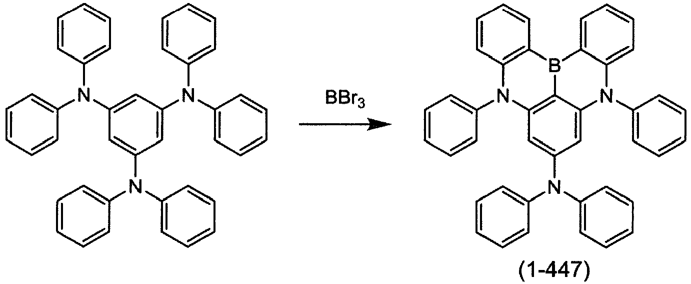

The structure of the compound thus obtained was identified by an NMR analysis.
¹H-NMR (400 MHz, CDCl₃) : δ = 8.89 (dd, 2H), 7.47 (t, 4H), 7.39 (m, 4H), 7.24 (m, 6H), 7.10 (m, 4H), 6.94 (m, 6H), 6.72 (d, 2H), 5.22 (m, 2H).

Furthermore, boron tribromide (3.78 mL, 40 mmol) was added to N¹,N¹,N³,N³,N⁵,N⁵-hexaphenylbenzene-1,3,5-triamine (11.6 g, 20 mmol) and ortho-dichlorobenzene (ODCB, 120 mL) at room temperature in a nitrogen atmosphere, and then the mixture was heated and stirred for 48 hours at 170°C. Thereafter, the reaction solution was distilled off under reduced pressure at 60°C. The reaction solution was filtered using a Florisil short pass column, the solvent was distilled off under reduced pressure, and a crude product was obtained. The crude product was washed using hexane, and thus a compound represented by formula (1-447) was obtained as a yellow solid (11.0 g, yield 94%) .

The structure of the compound thus obtained was identified by an NMR analysis.
¹H NMR (400 MHz, CDCl₃) δ 5.62 (brs, 2H), 6.71 (d, 2H), 6.90 - 6.93 (m, 6H), 7.05 - 7.09 (m, 4H), 7.20 - 7.27 (m, 6H), 7.33 - 7.38 (m, 4H), 7.44 - 7.48 (m, 4H), 8.90 (dd, 2H).
¹³C NMR (101 MHz, CDCl₃) δ 98.4 (2C), 116.8 (2C), 119.7 (2C), 123.5 (2C), 125.6 (4C), 128.1 (2C), 128.8 (4C), 130.2 (4C), 130.4 (2C), 130.7 (4C), 134.8 (2C), 142.1 (2C), 146.6 (2C), 147.7 (2C), 147.8 (2C), 151.1.

### Synthesis Example (17)

### Synthesis of 3,11-diphenyl-5,9-dioxa-13b-boranaphtho[3,2,1-de]anthracene

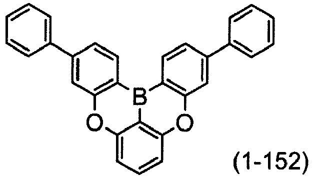

A flask containing 2-bromo-1,3-difluorobenzene (12.0 g), [1,1'-biphenyl]-3-ol (23.0 g), potassium carbonate (34.0 g) and NMP (130 ml) was heated and stirred for 10 hours at 170°C in a nitrogen atmosphere. After the reaction was terminated, the reaction liquid was cooled to room temperature, water and toluene were added thereto, and then the mixture was partitioned. The solvent was distilled off under reduced pressure, and then the residue was purified by silica gel column chromatography (developing liquid: heptane/toluene = 7/3 (volume ratio)). Thus, 3,3"-((2-bormo-1,3-phenylene)bis(oxy))di-1,1'-biphenyl (26.8 g) was obtained.

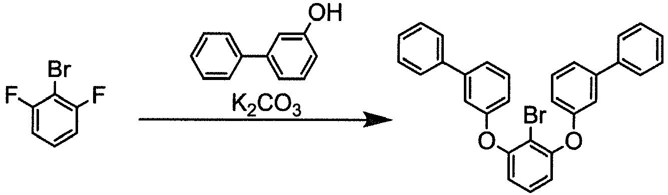

In a nitrogen atmosphere, a flask containing 3,3"-((2-bromo-1,3-phenylene)bis(oxy))di-1,1'-biphenyl (14.0 g) and xylene (100 ml) was cooled to -40°C, and a 2.6 M n-butyllithium hexane solution (11.5 ml) was added dropwise thereto. After completion of the dropwise addition, the temperature of the mixture was increased to room temperature, and then was decreased again to -40°C. Boron tribromide (3.3 ml) was added thereto. The temperature of the mixture was increased to room temperature, the mixture was stirred for 13 hours, and then the mixture was cooled to 0°C. N,N-diisopropylethylamine (9.7 ml) was added thereto, and the mixture was heated and stirred for 5 hours at 130°C. The reaction liquid was cooled to room temperature, an aqueous solution of sodium acetate that had been cooled in an ice bath was added thereto, and the mixture was stirred. A solid thus precipitated was collected by suction filtration. The solid thus obtained was washed with water, methanol, and heptane in this order, and was further recrystallized from chlorobenzene. Thus, a compound (8.9 g) represented by formula (1-152) was obtained.

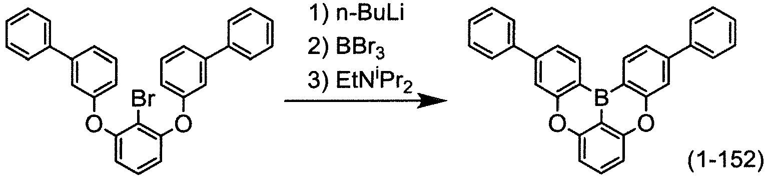

The structure of the compound thus obtained was identified by an NMR analysis.
¹H-NMR (400 MHz, CDCl₃) : δ = 8.75 (d, 2H), 7.75 - 7.84 (m, 7H), 7.65 (d, 2H), 7.53 (t, 4H), 7.44 (t, 2H), 7.25 (d, 2H).

### Synthesis Example (18)

### Synthesis of 2,6,8,12-tetraphenyl-5,9-dioxa-13b-boranaphtho[3,2,1-de]ant hracene

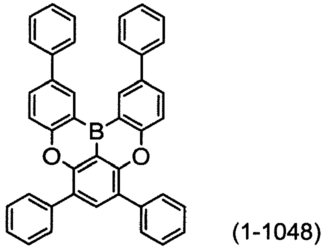

A flask containing 1,5-bromo-2,4-difluorobenzene (90.0 g), phenylboronic acid (88.6 g), tripotassium phosphate (154.0 g), Pd-132 (Johnson Matthey) (1.6 g), toluene (900 ml), isopropanol (300 ml) and water (150 ml) was heated and stirred for one hour at the reflux temperature in a nitrogen atmosphere. After the reaction was terminated, the reaction liquid was cooled to room temperature, water was added thereto, and then the mixture was partitioned. The solvent was distilled off under reduced pressure, and then the residue was purified using a silica gel short pass column (developing liquid: heptane/toluene = 1 (volume ratio)), and thus 4',6'-difluoro-1,1':3',1"-terphenyl (86.0 g) was obtained.

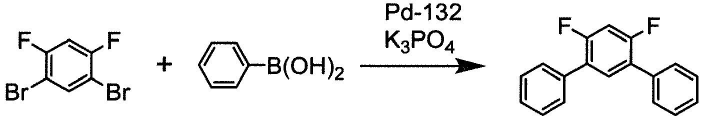

In a nitrogen atmosphere, a flask containing 4' , 6'-difluoro-1,1':3',1"-terphenyl (35.0 g) and THF (200 ml) was cooled to -78°C, and a 1 M sec-butyllithium cyclohexane solution (138 ml) was added dropwise thereto. The mixture was stirred for 30 minutes, and then bromine (23.0 g) was added dropwise. After completion of the dropwise addition, an aqueous solution of sodium sulfite was added thereto, and the mixture was stirred at room temperature. Water and toluene were added thereto, and then the mixture was partitioned. The solvent was distilled off under reduced pressure, and an oily crude purification product thus obtained was reprecipitated by adding heptane thereto. Thus, 5'-bromo-4',6'-difluoro-1,1':3',1"-terphenyl (41.7 g) was obtained.

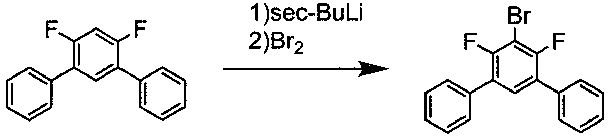

A flask containing 5'-bromo-4',6'-difluoro-1,1':3',1"-terphenyl (23.0 g), [1,1'-biphenyl]-4-ol (25.0 g), potassium carbonate (37.0 g) and NMP (120 ml) was heated and stirred for 2 hours at 200°C in a nitrogen atmosphere. After the reaction was terminated, the reaction liquid was cooled to room temperature, NMP was distilled off under reduced pressure, subsequently water and toluene were added thereto, and then the mixture was partitioned. The solvent was distilled off under reduced pressure, and then the residue was purified by silica gel column chromatography (developing liquid: heptane/toluene = 7/3 (volume ratio)). The residue was dissolved in ethyl acetate, and then was reprecipitated by adding heptane thereto. Thus, 4',6'-bis([1,1'-biphenyl]-4-yloxy)-5'-bromo-1,1':3',1"-terp henyl (38.2 g) was obtained.

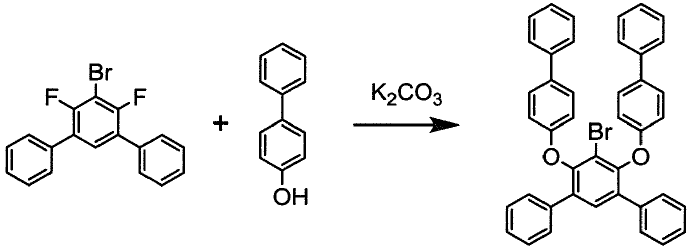

In a nitrogen atmosphere, a flask containing 4',6'-bis([1,1'-biphenyl]-4-yloxy)-5'-bromo-1,1':3',1"-terp henyl (19.0 g) and xylene (200 ml) was cooled to -40°C, and a 1.0 M sec-butyllithium cyclohexane solution (31.0 ml) was added dropwise thereto. After completion of the dropwise addition, the temperature of the mixture was increased to about 60°C, and distillation was carried out under reduced pressure. The reaction liquid was cooled again to -40°C, and boron tribromide (3.3 ml) was added thereto. The temperature of the mixture was increased to room temperature, and the mixture was stirred for 0.5 hours. Subsequently, the mixture was cooled to 0°C, N,N-diisopropylethylamine (9.7 ml) was added thereto, the temperature of the mixture was increased to 130°C, and the mixture was heated and stirred for 3 hours. The reaction liquid was cooled to room temperature, an aqueous solution of sodium acetate that had been cooled in an ice bath was added thereto, and the mixture was stirred. A solid thus precipitated was collected by suction filtration. The solid thus obtained was washed with water, methanol and heptane in this order, and was further washed with toluene that had been heated to the reflux temperature, and with chlorobenzene that had been heated to the reflux temperature. Thus, a compound (9.2 g) represented by formula (1-1048) was obtained.

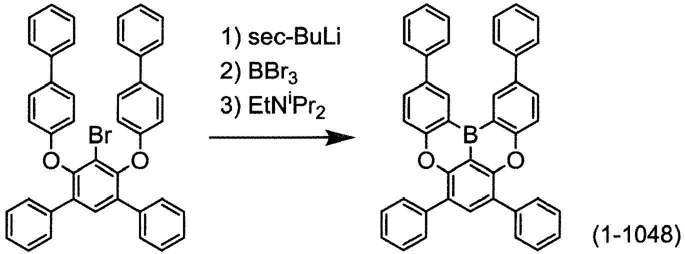

The structure of the compound thus obtained was identified by an NMR analysis.
¹H-NMR (400 MHz, CDCl₃): δ = 9.00 (m, 2H), 8.03 (s, 1H), 7.96 (dd, 2H), 7.84 (d, 4H), 7.75 (d, 4H), 7.50 - 7.60 (m, 10H), 7.46 (t, 2H), 7.40 (t, 2H).

### Synthesis Example (19)

### Synthesis of 3,6,8,11-tetraphenyl-5,9-dioxa-13b-boranaphtho[3,2,1-de]ant hracene

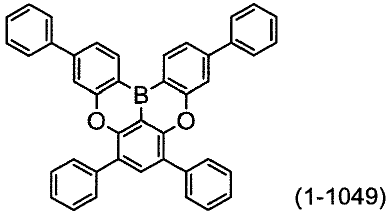

A flask containing 5'-bromo-4',6'-difluoro-1,1':3',1"-terphenyl (23.0 g), [1,1'-biphenyl]-3-ol (25.0 g), potassium carbonate (37.0 g) and NMP (120 ml) was heated and stirred for 2 hours at 200°C in a nitrogen atmosphere. After the reaction was terminated, the reaction liquid was cooled to room temperature, NMP was distilled off under reduced pressure, water and toluene were added thereto, and then the mixture was partitioned. The solvent was distilled off under reduced pressure, and then the residue was purified by silica gel column chromatography (developing liquid: heptane/toluene = 7/3 (volume ratio)). The purification product was further washed with heptane, and thus 4',6'-bis([1,1'-biphenyl]-3-yloxy)-5'-bromo-1,1':3',1"-terp henyl (40.0 g) was obtained.

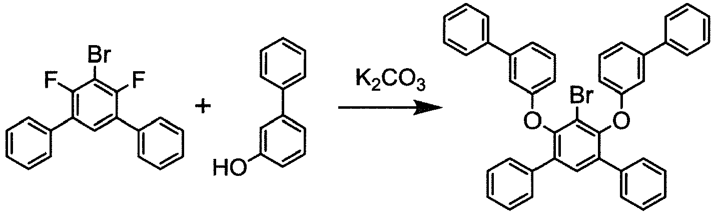

In a nitrogen atmosphere, a flask containing 4',6'-bis([1,1'-biphenyl]-3-yloxy)-5'-bromo-1,1':3',1"-terp henyl (20.0 g) and xylene (150 ml) was cooled to -40°C, and a 1.0 M sec-butyllithium cyclohexane solution (33.0 ml) was added dropwise thereto. After completion of the dropwise addition, the temperature of the mixture was increased to about 60°C, and distillation was carried out under reduced pressure. The resultant was cooled again to -40°C, and boron tribromide (3.5 ml) was added thereto. The temperature of the mixture was increased to room temperature, and the mixture was stirred for 0.5 hours. Subsequently, the mixture was cooled to 0°C, N,N-diisopropylethylamine (10.8 ml) was added thereto, the temperature of the mixture was increased to 120°C, and the mixture was heated and stirred for 3 hours. The reaction liquid was cooled to room temperature, an aqueous solution of sodium acetate that had been cooled in an ice bath was added thereto, and then the mixture was stirred. A solid thus precipitated was collected by suction filtration. The solid thus obtained was washed with water, methanol and heptane in this order, and was further washed with ethyl acetate that had been heated to the reflux temperature, and with chlorobenzene that had been heated to the reflux temperature. Thus, a compound (10.0 g) represented by formula (1-1049) was obtained.

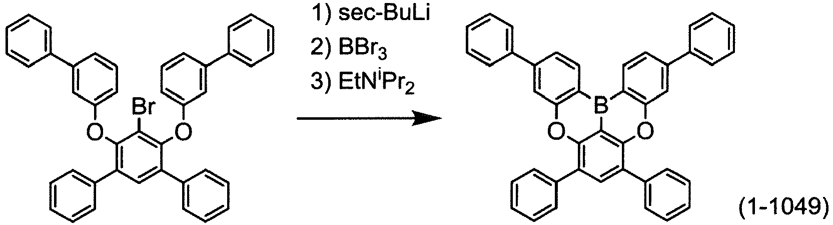

The structure of the compound thus obtained was identified by an NMR analysis.
¹H-NMR (400 MHz, CDCl₃): δ = 8.76 (d, 2H), 7.98 (s, 1H), 7.82 (d, 4H), 7.71 (d, 4H), 7.64 (m, 4H), 7.55 (t, 4H), 7.50 (t, 4H), 7.40 - 7.47 (m, 4H).

### Synthesis Example (20)

### Synthesis of 3,6,8,11-tetraphenyl-5,9-dioxa-13b-boranaphtho[3,2,1-de]ant hracene

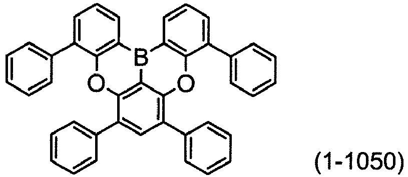

A flask containing 5'-bromo-4',6'-difluoro-1,1':3',1"-terphenyl (23.0 g), [1,1'-biphenyl]-2-ol (25.0 g), potassium carbonate (37.0 g) and NMP (120 ml) was heated and stirred for 4 hours at 200°C in a nitrogen atmosphere. After the reaction was terminated, the reaction liquid was cooled to room temperature, NMP was distilled off under reduced pressure, subsequently water and toluene were added thereto, and then the mixture was partitioned. The solvent was distilled off under reduced pressure, and then the residue was purified by silica gel column chromatography (developing liquid: heptane/toluene = 7/3 (volume ratio)). Thus, 4',6'-bis([1,1'-biphenyl]-2-yloxy)-5'-bromo-1,1':3',1"-terp henyl (38.2 g) was obtained.

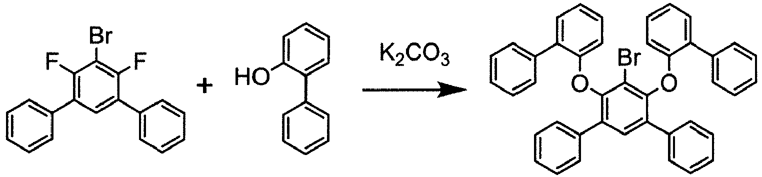

In a nitrogen atmosphere, a flask containing 4',6'-bis([1,1'-biphenyl]-2-yloxy)-5'-bromo-1,1':3',1"-terp henyl (20.0 g) and xylene (150 ml) was cooled to -40°C, and a 1.0 M sec-butyllithium cyclohexane solution (33.0 ml) was added dropwise thereto. After completion of the dropwise addition, the temperature of the mixture was increased to about 60°C, and components having boiling points lower than that of xylene were distilled off under reduced pressure. The residue was cooled again to -40°C, and boron tribromide (3.5 ml) was added thereto. The temperature of the mixture was increased to room temperature, the mixture was stirred for 0.5 hours, and then the mixture was cooled to 0°C. N,N-diisopropylethylamine (10.8 ml) was added thereto, the temperature of the mixture was increased to 130°C, and the mixture was heated and stirred for 4 hours . The reaction liquid was cooled to room temperature, an aqueous solution of sodium acetate that had been cooled in an ice bath was added thereto, and the mixture was stirred. A solid thus precipitated was collected by suction filtration. The solid thus obtained was washed with water, methanol and heptane in this order, and was further recrystallized from toluene. Thus, a compound (14.1 g) represented by formula (1-1050) was obtained.

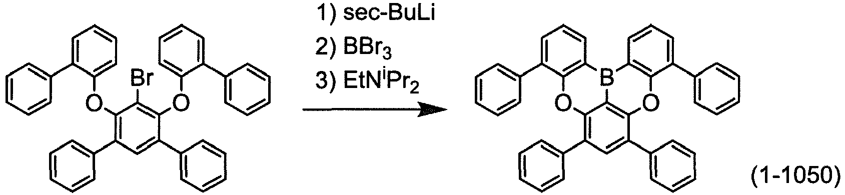

The structure of the compound thus obtained was identified by an NMR analysis.
¹H-NMR (400 MHz, CDCl₃) : δ = 8.78 (d, 2H), 7.81 (s, 1H), 7.68 (d, 2H), 7.48 (t, 2H), 7.38 (d, 4H), 7.35 (d, 4H), 7.27 (m, 2H), 7.19 (m, 6H), 7.10 (t, 4H).

### Synthesis Example (21)

### Synthesis of 6,8-diphenyl-N³,N³,N¹¹,N¹¹-tetra-p-tolyl-5,9-dioxa-13b-borana phtho[3,2,1-de]anthracene-3,11-diamine

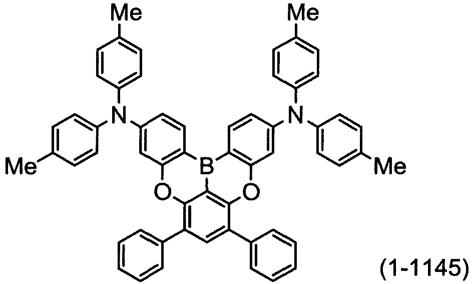

A flask containing di-p-tolylamine (36.0 g), 3-bromophenol (30.0 g), Pd-132 (Johnson Matthey) (0.6 g), NaOtBu (42.0 g), and toluene (300 ml) was heated to 90°C and stirred for one hour. The reaction liquid was cooled to room temperature, subsequently water and ethyl acetate were added thereto, and the mixture was partitioned. Furthermore, the resultant was purified by silica gel column chromatography (developing liquid: toluene/heptane = 1/1 (volume ratio)), and a solid thus obtained was washed with heptane. Thus, 3-(di-p-tolylamino)phenol (60.0 g) was obtained.

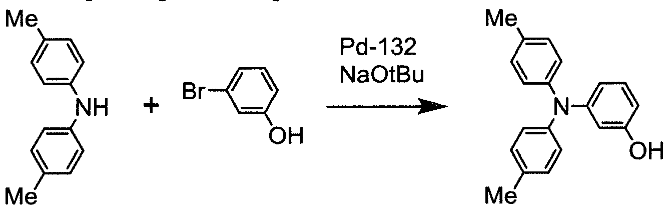

In a nitrogen atmosphere, a flask containing 1,5-dibromo-2,4-difluorobenzene (30.0 g), phenylboronic acid (29.6 g), Pd(PPh3)4 (2.6 g), tripotassium phosphate (51.0 g), toluene (400 ml), isopropanol (100 ml) and water (50 ml) was heated and stirred for 5 hours at the reflux temperature. The reaction liquid was cooled to room temperature, water and toluene were added to the mixture, and the mixture was partitioned. Subsequently, the resultant was purified by silica gel column chromatography (developing liquid: heptane), and thus 4',6'-difluoro-1,1':3',1"-terphenyl (25.0 g) was obtained.

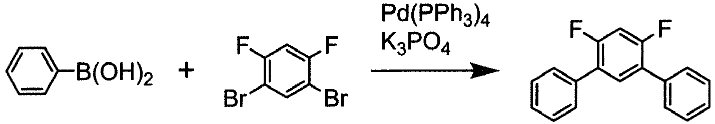

In a nitrogen atmosphere, a flask containing 3-(di-p-tolylamino)phenol (28.7 g), 4',6'-difluoro-1,1':3',1"-terphenyl (12.0 g), potassium carbonate (19.0 g), and NMP (120 ml) was heated and stirred for 5 hours at 200°C. The reaction liquid was cooled to room temperature, water and ethyl acetate were added to the reaction liquid, and the mixture was partitioned. Subsequently, the resultant was purified by silica gel column chromatography (developing liquid: toluene/heptane = 4/6 (volume ratio)), and thus 3,3'-([1,1':3',1"-terphenyl]-4',6'-diylbis(oxy))bis(N,N-dip-tolylaniline) (33.0 g) was obtained.

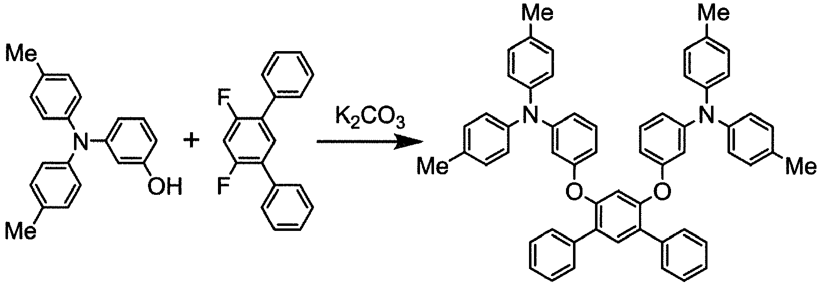

A 2.6 M n-butyllithium hexane solution (18.3 ml) was introduced into a flask containing 3,3'-([1,1':3',1"-terphenyl]-4',6'-diylbis(oxy))bis(N,N-dip-tolylaniline) (27.0 g) and xylene (150 ml), at 0°C in a nitrogen atmosphere. After completion of dropwise addition, the temperature of the mixture was increased to 70°C, and the mixture was stirred for 4 hours. The temperature of the mixture was further increased to 100°C, and hexane was distilled off. The mixture was cooled to -50°C, boron tribromide (13.6 g) was added thereto, the temperature of the mixture was increased to room temperature, and the mixture was stirred for one hour. Thereafter, the mixture was cooled again to 0°C, N,N-diisopropylethylamine (11.7 g) was added thereto, and the mixture was stirred at room temperature until heat generation was settled. Subsequently, the temperature of the mixture was increased to 120°C, and the mixture was heated and stirred for one hour. The reaction liquid was cooled to room temperature, an aqueous solution of sodium acetate and ethyl acetate were added thereto, and the mixture was partitioned. Subsequently, the resultant was purified by silica gel column chromatography (developing liquid: toluene/heptane = 3/7 (volume ratio)), and was further purified by activated carbon column chromatography (developing liquid: toluene). A solid obtained by distilling off the solvent under reduced pressure was dissolved in chlorobenzene, and was reprecipitated by adding heptane thereto. Thus, a compound (2.5 g) represented by formula (1-1145) was obtained.

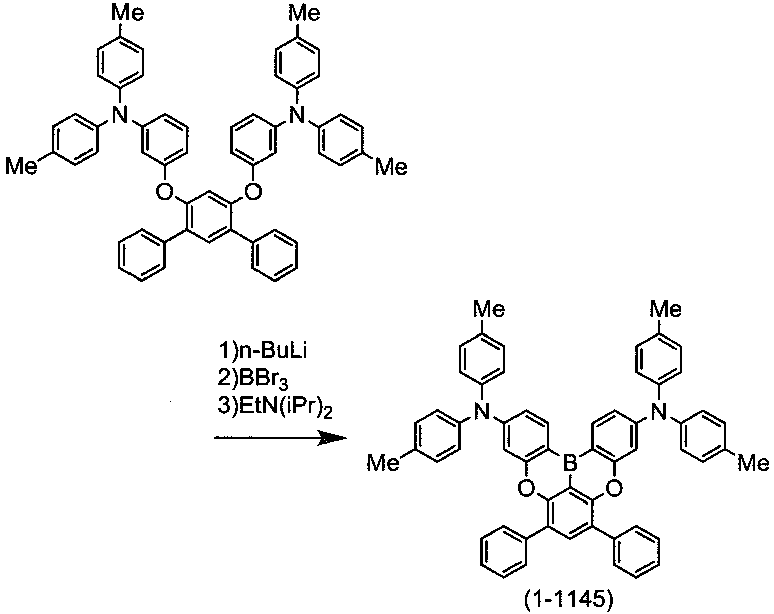

The structure of the compound thus obtained was identified by an NMR analysis.
¹H-NMR (400 MHz, CDCl₃) : δ = 8.34 (d, 2H), 7.79 (s, 1H), 7.71 (d, 4H), 7.43 (t, 4H), 7.34 (t, 2H), 7.05 - 7.15 (m, 16H), 6.90 (m, 4H), 2.34 (s, 12H) .

### Synthesis Example (22)

### Synthesis of 9-(4-(5,9-dioxa-13b-boranaphtho[3,2,1-de]anthracen-7-yl)phe nyl)-9H-carbazole

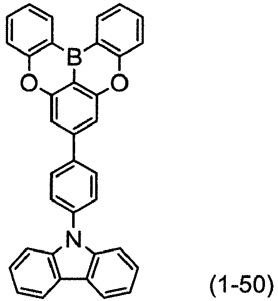

In a nitrogen atmosphere, a flask containing ((5-bromo-1,3-phenylene)bis(oxy))dibenzene (27.0 g), (4-(9H-carbazol-9-yl)phenyl)boronic acid (25.0 g), tripotassium phosphate (34.0 g), Pd-132 (Johnson Matthey) (0.3 g), toluene (400 ml), isopropanol (100 ml) and water (50 ml) was heated and stirred for one hour at the reflux temperature. After the reaction was terminated, the reaction liquid was cooled to room temperature, water was added thereto, and the mixture was partitioned. The solvent was distilled off under reduced pressure, and then the residue was purified using a silica gel short pass column (developing liquid: toluene). Thus, 9-(3',5'-diphenoxy[1,1'-biphenyl]-4-yl)-9H-carbazole (38.0 g) was obtained.

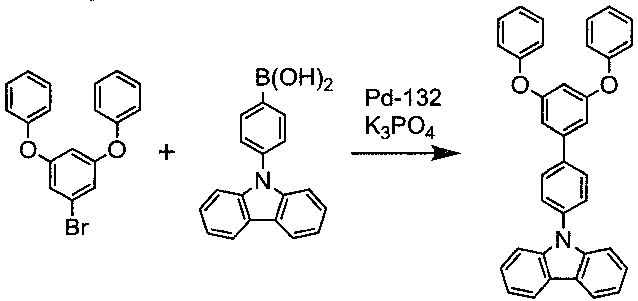

A 1.0 M sec-butyllithium cyclohexane solution (39.6 ml) was introduced to a flask containing 9-(3',5'-diphenoxy[1,1'-biphenyl]-4-yl)-9H-carbazole (19.0 g) and xylene (130 ml), at 0°C in a nitrogen atmosphere. After completion of dropwise addition, the temperature of the mixture was increased to 70°C, the mixture was stirred for 3 hours, and then components having boiling points lower than that of xylene were distilled off under reduced pressure. The mixture was cooled to -50°C, boron tribromide (4.3 ml) was added thereto, the temperature of the mixture was increased to room temperature, and the mixture was stirred for 0.5 hours. Thereafter, the mixture was cooled again to 0°C, N,N-diisopropylethylamine (13.1 ml) was added thereto, and the mixture was stirred at room temperature until heat generation was settled. Subsequently, the temperature of the mixture was increased to 120°C, and the mixture was heated and stirred for 2 hours. The reaction liquid was cooled to room temperature, and a solid produced by adding an aqueous solution of sodium acetate that had been cooled in an ice bath and then adding heptane thereto was collected by suction filtration. The solid thus obtained was washed with water and then with toluene, and then was washed with refluxed ethyl acetate. The solid was further recrystallized from chlorobenzene, and thus a compound (15.6 g) represented by formula (1-50) was obtained.

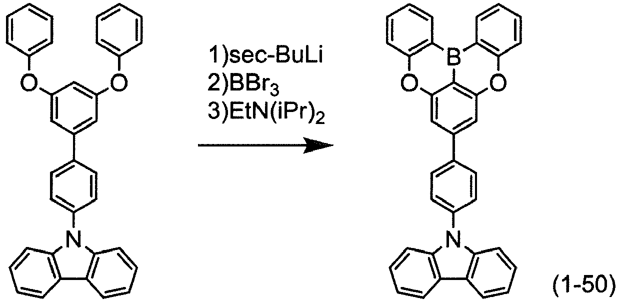

The structure of the compound thus obtained was identified by an NMR analysis.
¹H-NMR (400 MHz, CDCl₃): δ = 8.73 (d, 2H), 8.17 (d, 2H), 8.01 (d, 2H), 7.74 (m, 4H), 7.60 (d, 2H), 7.58 (s, 2H), 7.53 (d, 2H), 7.40 - 7.48 (m, 4H), 7.32 (t, 2H).

### Synthesis Example (23)

### Synthesis of 9-(4-(5,9-dioxa-13b-boranaphtho[3,2,1-de]anthracen-2-yl)phe nl)-9H-carbazole

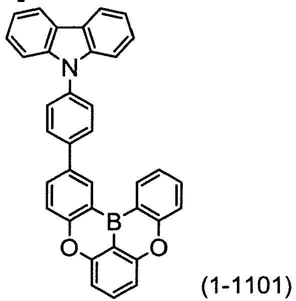

In a nitrogen atmosphere, copper(I) iodide (1.6 g) and iron (III) acetylacetonate (6.1 g) were added to an NMP (300 ml) solution of 1-bromo-3-fluorobenzene (50.0 g), phenol (30.0 g) and potassium carbonate (79.0 g) in a nitrogen atmosphere. The temperature of the mixture was increased to 150°C, and the mixture was stirred for 4 hours. The reaction liquid was cooled to room temperature, and a salt precipitated by adding ethyl acetate and aqueous ammonia thereto was removed by suction filtration using a Hirsch funnel covered with Celite. The filtrate was partitioned, and the solvent of the organic layer was distilled off under reduced pressure. Subsequently, the residue was purified using a silica gel short pass column (developing liquid: toluene/heptane = 2/8 (volume ratio)), and thus 1-fluoro-3-phenoxybenzene (41.0 g) was obtained.

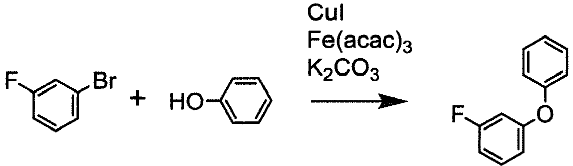

A flask containing 4'-bromo-[1,1'-biphenyl]-4-ol (25.0 g), carbazole (18.5 g), Pd(dba)₂, a 1 M tri-t-butylphosphine toluene solution (4.0 ml), NaOtBu (24.0 g) and 1,2,4-trimethylbenzene (300 ml) was heated and stirred for 2 hours at 150°C. The reaction liquid was cooled to room temperature, and then a solid precipitated by adding dilute hydrochloric acid was collected by suction filtration. The solid thus obtained was washed with water, and was purified using a silica gel short pass column (chlorobenzene/ethyl acetate/ethanol = 5/4/1 (volume ratio)). The solvent was distilled off under reduced pressure, and a solid thus obtained was washed with chlorobenzene. Furthermore, the solid was dissolved in chlorobenzene, and was reprecipitated by adding ethyl acetate and ethanol thereto. Thus, 4'-(9H-carbazol-9-yl)-[1,1'-biphenyl]-4-ol (29.3 g) was obtained.

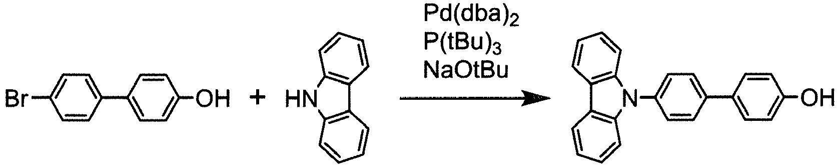

A flask containing 1-fluoro-3-phenoxybenzene (16.3 g), 4'-(9H-carbazol-9-yl)-[1,1'-biphenyl]-4-ol (29.0 g), potassium carbonate (29.0 g), and NMP (150 ml) was heated and stirred for 4 hours at 200°C in a nitrogen atmosphere. Since the progress of the reaction was slow at this time point, cesium carbonate (31.0 g) was added thereto, and the mixture was further heated and stirred for 8 hours. After the reaction was terminated, the reaction liquid was cooled to room temperature, NMP was distilled off under reduced pressure, subsequently water and ethyl acetate were added to the residue, and the mixture was partitioned. The solvent was distilled off under reduced pressure, and then the residue was purified by silica gel column chromatography (developing liquid: heptane/toluene = 8/2 (volume ratio)). Thus, 9-(4'-(3-phenoxyphenoxy)-[1,1'-biphenyl]-4-yl)-9H-carbazole (37.1 g) was obtained.

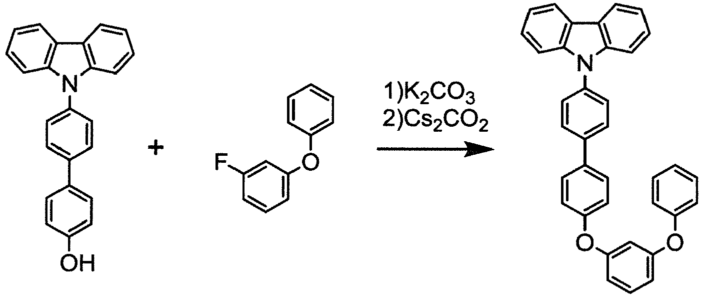

A 1.0 M sec-butyllithium cyclohexane solution (37.5 ml) was introduced into a flask containing 9-(4'-(3-phenoxyphenoxy)-[1,1'-biphenyl]-4-yl)-9H-carbazole (18.0 g) and xylene (130 ml), at 0°C in a nitrogen atmosphere. After completion of dropwise addition, the temperature of the mixture was increased to 70°C, the mixture was stirred for 4 hours, and then components having boiling points lower than that of xylene were distilled off under reduced pressure. The mixture was cooled to -50°C, boron tribromide (4.0 ml) was added thereto, the temperature of the mixture was increased to room temperature, and the mixture was stirred for 0.5 hours. Thereafter, the mixture was cooled again to 0°C, N,N-diisopropylethylamine (13.4 ml) was added thereto, and the mixture was stirred at room temperature until heat generation was settled. Subsequently, the temperature of the mixture was increased to 120°C, and the mixture was heated and stirred for 2 hours. The reaction liquid was cooled to room temperature, and a solid produced by adding an aqueous solution of sodium acetate that had been cooled in an ice bath and then ethyl acetate was collected by suction filtration. The solid thus obtained was washed with refluxed ethyl acetate, and then was purified using a silica gel short pass column (developing liquid: heated chlorobenzene). The solid was further recrystallized from chlorobenzene, and thus a compound (6.9 g) represented by formula (1-1101) was obtained.

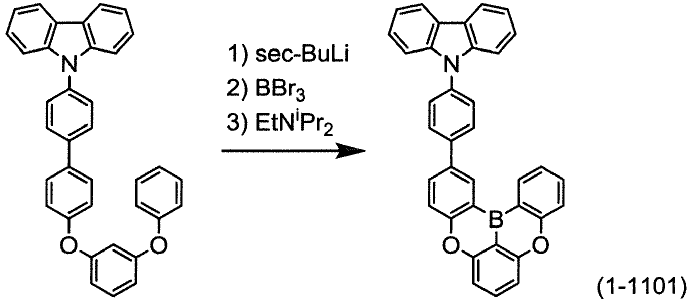

The structure of the compound thus obtained was identified by an NMR analysis.
¹H-NMR (400 MHz, CDCl₃): δ = 8.98 (m, 1H), 8.80 (d, 1H), 8.18 (d, 2H), 8.04 (dd, 1H), 7.96 (d, 2H), 7.84 (t, 1H), 7.72 - 7.78 (m, 3H), 7.70 (d, 1H), 7.60 (d, 1H), 7.54 (d, 2H), 7.43 - 7.48 (m, 3H), 7.26 - 7.34 (m, 4H).

### Synthesis Example (24)

### Synthesis of 9-(4-(5,9-dioxa-13b-boranaphtho[3,2,1-de]anthracen-3-yl)phe nyl)-9H-carbazole

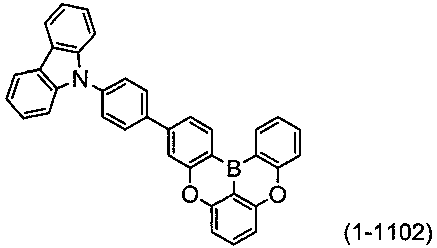

In a nitrogen atmosphere, a flask containing 1-bromo-3-fluorobenzene (50.0 g), phenol (30.0 g), potassium carbonate (80.0 g) and NMP (300 ml) was heated and stirred for 12 hours at 200°C. The reaction liquid was cooled to room temperature, NMP was distilled off under reduced pressure, subsequently water and ethyl acetate were added thereto, and the mixture was partitioned. The solvent of the organic layer was distilled off under reduced pressure, and then the residue was purified using a silica gel short pass column (developing liquid: toluene/heptane = 2/8 (volume ratio)). Thus, 1-bromo-3-henoxbenzene (58.2 g) was obtained.

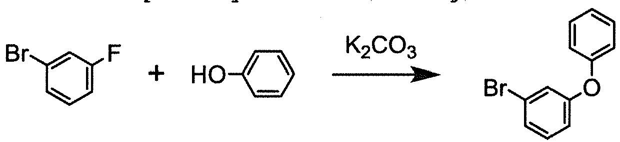

A flask containing 3-bromophenol (10.0 g), (4-(9H-carbazol-9-yl)phenyl)boronic acid (18.5 g), Pd-132 (Johnson Matthey) (0.2 g), tripotassium phosphate (25.0 g), toluene (200 ml), isopropanol (50 ml), and water (25 ml) was heated and stirred for one hour at the reflux temperature. The reaction liquid was cooled to room temperature, subsequently water and toluene were added thereto, and the mixture was partitioned. Subsequently, the reaction liquid was purified using a silica gel short pass column (developing liquid: heated chlorobenzene), and a solid obtained by distilling off the solvent under reduced pressure was washed with refluxed heptane. Thus, 4'-(9H-carbazol-9-yl)-[1,1'-biphenyl]-3-ol (18.5 g) was obtained.

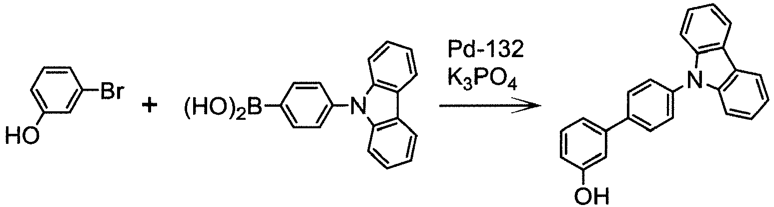

Copper(I) iodide (0.3 g) and iron(III) acetylacetonate (1.1 g) were added to an NMP (100 ml) solution of 1-bromo-3-phenoxybenzene (12.5 g), 4'-(9H-carbazol-9-yl)-[1,1'-biphenyl]-3-ol (18.5 g) and potassium carbonate (14.0 g) in a nitrogen atmosphere. The temperature of the mixture was increased to 160°C, and the mixture was stirred for 6 hours. The reaction liquid was cooled to room temperature, NMP was distilled off under reduced pressure, and then a solid precipitated by adding ethyl acetate and aqueous ammonia thereto was removed by suction filtration using a Hirsch filter covered with Celite. The filtrate was partitioned, the solvent of the organic layer was distilled off under reduced pressure, and then the residue was purified by silica gel column chromatography (developing liquid: toluene/heptane = 3/7 (volume ratio)). Thus, 9-(3'-(3-phenoxyphenoxy)-[1,1'-biphenyl]-4-yl)-9H-carbazole (21.0 g) was obtained.

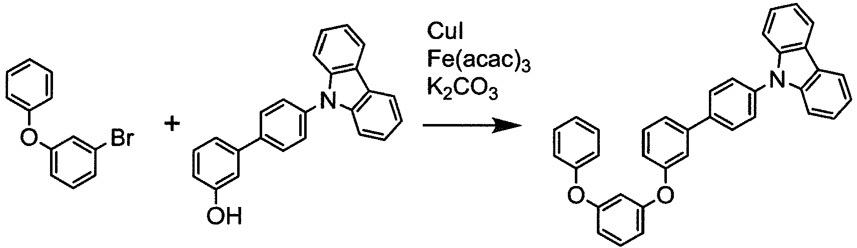

A 1.0 M sec-butyllithium cyclohexane solution (43.8 ml) was introduced into a flask containing 9-(3'-(3-phenoxyphenoxy)-[1,1'-biphenyl]-4-yl)-9H-carbazole (21.0 g) and xylene (130 ml), at 0°C in a nitrogen atmosphere. After completion of dropwise addition, the temperature of the mixture was increased to 70°C, the mixture was stirred for 3 hours, and then components having boiling points lower than that of xylene were distilled off under reduced pressure. The reaction liquid was cooled to -50°, boron tribromide (4.7 ml) was added thereto, the temperature of the mixture was increased to room temperature, and the mixture was stirred for 0.5 hours. Thereafter, the mixture was cooled again to 0°C, N,N-diisopropylethylamine (14.6 ml) was added thereto, and the mixture was stirred at room temperature until heat generation was settled. Subsequently, the temperature of the mixture was increased to 130°C, and the mixture was heated and stirred for 2 hours. The reaction liquid was cooled to room temperature, and a solid produced by adding an aqueous solution of sodium acetate that had been cooled in an ice bath and then adding heptane thereto was collected by suction filtration. The solid thus obtained was washed with refluxed ethyl acetate, and then was recrystallized from chlorobenzene. Thus, a compound (13.6 g) represented by formula (1-1102) was obtained.

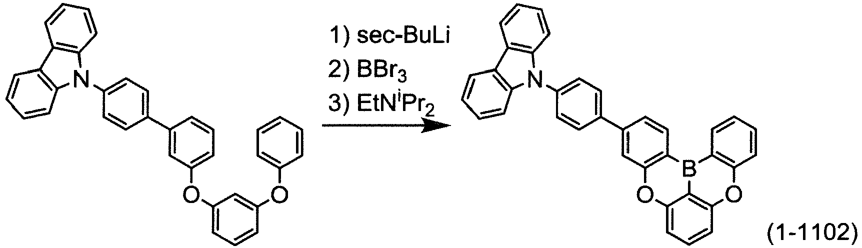

The structure of the compound thus obtained was identified by an NMR analysis. ¹H-NMR (400 MHz, CDCl₃): δ = 8.81 (d, 1H), 8.75 (d, 1H), 8.18 (d, 2H), 8.00 (d, 2H), 7.89 (m, 1H), 7.83 (t, 1H), 7.71 - 7.77 (m, 4H), 7.58 (d, 1H), 7.53 (d, 2H), 7.41 - 7.48 (m, 3H), 7.26 - 7.34 (m, 4H).

### Synthesis Example (25)

### Synthesis of 9-(4-(5,9-dioxa-13b-boranaphtho[3,2,1-de]anthracen-4-yl)phe nyl)-9H-carbazole

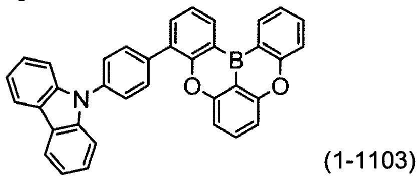

A flask containing 2-bromophenol (10.0 g), (4-(9H-carbazol-9-yl)phenyl)boronic acid (18.2 g), Pd-132 (Johnson Matthey) (0.2 g), tripotassium phosphate (25.0 g), toluene (200 ml), isopropanol (50 ml), and water (25 ml) was heated and stirred for one hour at the reflux temperature. The reaction liquid was cooled to room temperature, subsequently water and toluene were added thereto, and the mixture was partitioned. Subsequently, the reaction liquid was purified using a silica gel short pass column (developing liquid: heated toluene), and then a solid obtained by distilling off the solvent under reduced pressure was washed with refluxed heptane. Thus, 4'-(9H-carbazol-9-yl)-[1,1'-biphenyl]-2-ol (18.7 g) was obtained.

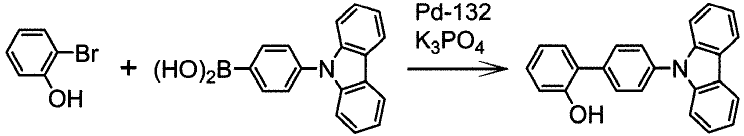

Copper (I) iodide (0.5 g) and iron (III) acetylacetonate (1.8 g) were added to an NMP (100 ml) solution of 1-bromo-3-phenoxybenzene (12.6 g), 4'-(9H-carbazol-9-yl)-[1,1'-biphenyl]-2-ol (18.7 g) and potassium carbonate (14.0 g) in a nitrogen atmosphere. The temperature of the mixture was increased to 150°C, and the mixture was stirred for 6 hours. The reaction liquid was cooled to room temperature, NMP was distilled off under reduced pressure, and then a solid precipitated by adding ethyl acetate and aqueous ammonia thereto was removed by suction filtration using a Hirsch funnel covered with Celite. The filtrate was partitioned, and the solvent of the organic layer was distilled off under reduced pressure. Subsequently, the residue was purified by silica gel column chromatography (developing liquid: toluene/heptane = 3/7 (volume ratio)), and thus 9-(2'-(3-phenoxyphenoxy)-[1,1'-biphenyl]-4-yl)-9H-carbazole (20.0 g) was obtained.

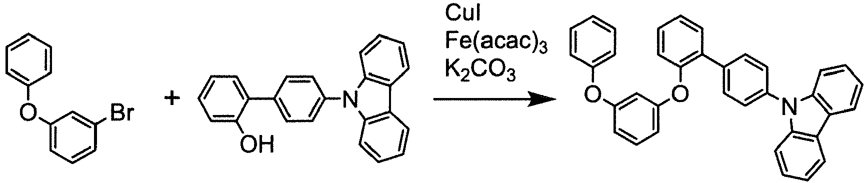

A 1.0 M sec-butyllithium cyclohexane solution (41.7 ml) was introduced into a flask containing 9-(2'-(3-phenoxyphenoxy)-[1,1'-biphenyl]-4-yl)-9H-carbazole (20.0 g) and xylene (130 ml), at 0°C in a nitrogen atmosphere. After completion of dropwise addition, the temperature of the mixture was increased to 70°C, the mixture was stirred for 3 hours, and then components having boiling points lower than that of xylene were distilled off under reduced pressure. The mixture was cooled to -50°C, boron tribromide (4.5 ml) was added thereto, the temperature of the mixture was increased to room temperature, and the mixture was stirred for 0.5 hours. Thereafter, the mixture was cooled again to 0°C, N,N-diisopropylethylamine (13.9 ml) was added thereto, and the mixture was stirred at room temperature until heat generation was settled. Subsequently, the temperature of the mixture was increased to 130°C, and the mixture was heated and stirred for 3 hours. The reaction liquid was cooled to room temperature, and a solid produced by adding an aqueous solution of sodium acetate that had been cooled in an ice bath and then adding heptane was collected by suction filtration. The solid thus obtained was washed with refluxed ethyl acetate, and then was dissolved in chlorobenzene. Reprecipitation was carried out by adding heptane to the solution, and thus a compound (8.5 g) represented by formula (1-1103) was obtained.

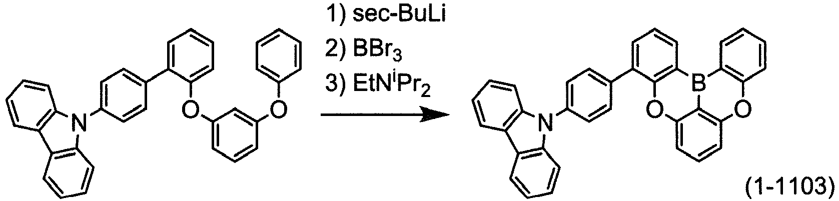

The structure of the compound thus obtained was identified by an NMR analysis.
¹H-NMR (400 MHz, CDCl₃): δ = 8.77 (t, 2H), 8.19 (d, 2H), 7.96 (d, 2H), 7.86 (d, 1H), 7.80 (t, 1H), 7.72 - 7.77 (m, 3H), 7.59 (d, 3H), 7.54 (t, 1H), 7.47 (t, 2H), 7.44 (t, 1H), 7.33 (t, 2H), 7.26 (m, 1H), 7.19 (d, 1H).

### Synthesis Example (26)

### Synthesis of 9-(4-(5,9-dioxa-13b-boranaphtho[3,2,1-de]anthracen-8-yl)phe nyl)-9H-carbazole

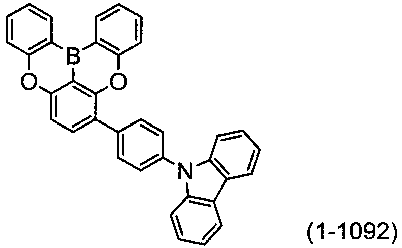

In a nitrogen atmosphere, a flask containing 1-bromo-2,4-difluorobenzene (46.6 g), phenol (50.0 g), potassium carbonate (133.0 g) and NMP (300 ml) was heated and stirred for 8 hours at 200°C. The reaction liquid was cooled to room temperature, NMP was distilled off under reduced pressure, subsequently water and ethyl acetate were added thereto, and the mixture was partitioned. The solvent of the organic layer was distilled off under reduced pressure, and then the residue was purified by silica gel column chromatography (developing liquid: toluene/heptane = 2/8 (volume ratio)). Thus, ((4-bromo-1,3-phenylene)bis(oxy))dibenzene (58.2 g) was obtained.

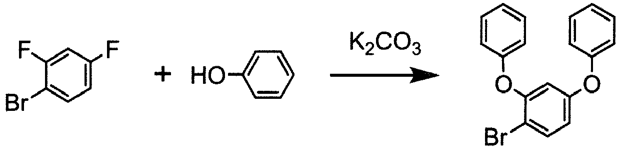

A flask containing ((4-bromo-1,3-phenylene)bis(oxy))dibenzene (15.0 g), (4-(9H-carbazol-9-yl)phenyl)boronic acid (13.9 g), Pd-132 (Johnson Matthey) (0.2 g), tripotassium phosphate (19.0 g), toluene (200 ml), isopropanol (50 ml) and water (25 ml) was heated and stirred for 2 hours at the reflux temperature. The reaction liquid was cooled to room temperature, subsequently water and toluene were added thereto, and the mixture was partitioned. Subsequently, the resultant was purified by silica gel column chromatography (developing liquid: toluene/heptane mixed solvent), and thus 9-(2',4'-diphenoxy[1,1'-biphenyl]-4-yl)-9H-carbazole (20.0 g) was obtained. At this time, the proportion of toluene in the developing liquid was gradually increased by making reference to the method described in "Introduction to Organic Chemical Experiments (1) - Handling of Materials and Separation/Purification", published by Kagaku-Dojin Publishing Co., Inc., p. 94, and thereby the target substance was eluted.

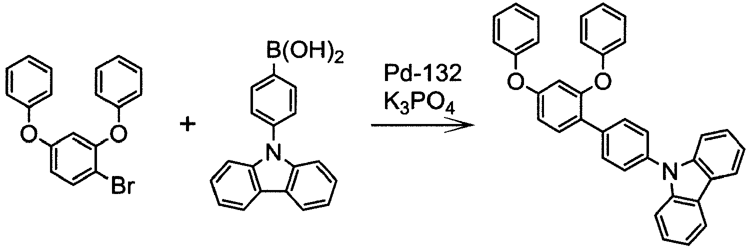

A 1.0 M sec-butyllithium cyclohexane solution (41.7 ml) was introduced into a flask containing 9- (2',4'-diphenoxy[1,1'-biphenyl]-4-yl)-9H-carbazole (20.0 g) and xylene (130 ml), at 0°C in a nitrogen atmosphere. After completion of dropwise addition, the temperature of the mixture was increased to 70°C, the mixture was stirred for 3 hours, and then components having boiling points lower than that of xylene were distilled off under reduced pressure. The mixture was cooled to -50°C, boron tribromide (4.5 ml) was added thereto, the temperature of the mixture was increased to room temperature, and the mixture was stirred for 0.5 hours. Thereafter, the mixture was cooled again to 0°C, N,N-diisopropylethylamine (13.9 ml) was added thereto, and the mixture was stirred at room temperature until heat generation was settled. Subsequently, the temperature of the mixture was increased to 130°C, and the mixture was heated and stirred for 3 hours. The reaction liquid was cooled to room temperature, and a solid produced by adding an aqueous solution of sodium acetate that had been cooled in an ice bath and then adding heptane thereto was collected by suction filtration. The solid thus obtained was washed with refluxed ethyl acetate, and then was recrystallized from chlorobenzene. Thus, a compound (12.9 g) represented by formula (1-1092) was obtained.

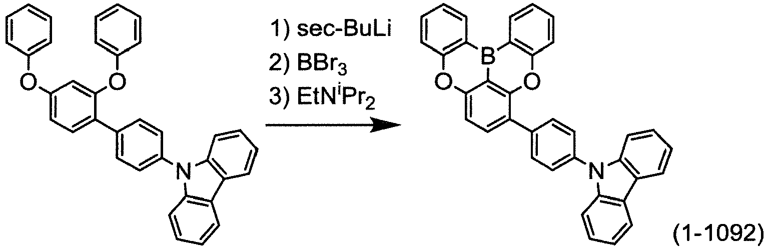

The structure of the compound thus obtained was identified by an NMR analysis.
¹H-NMR (400 MHz, CDCl₃): δ = 8.75 (d, 2H), 8.19 (d, 2H), 8.02 (m, 3H), 7.70 - 7.78 (m, 4H), 7.54 - 7.62 (m, 4H), 7.38 - 7.50 (m, 5H), 7.32 (t, 2H).

### Synthesis Example (27)

### Synthesis of 9-(5,9-dioxa-13b-boranaphtho[3,2,1-de]anthracen-7-yl)-9'-ph enyl-9H,9'H-3,3'-bicarbazole

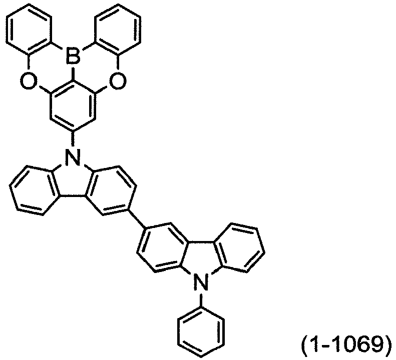

A flask containing (9-phenyl-9H-carbazol-3-yl)boronic acid (50.0 g), 3-bromo-9H-carbazole (39.0 g), Pd-132 (Johnson Matthey) (1.2 g), sodium carbonate (46.1 g), toluene (400 ml), ethanol (100 ml) and water (100 ml) was heated and stirred for 2 hours at the reflux temperature. The reaction liquid was cooled to room temperature, subsequently water and toluene were added thereto, and the mixture was partitioned. Subsequently, the resultant was purified by amino group-modified silica gel (NH DM1020: manufactured by Fuji Silysia Chemical, Ltd.) column chromatography (developing liquid: toluene). Thus, 9-phenyl-9H,9'H-3,3'-bicarbazole (52.0 g) was obtained.

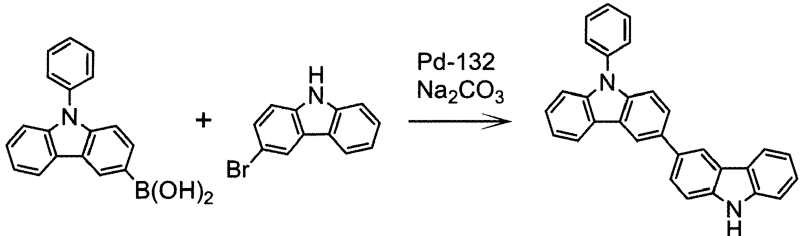

A flask containing ((5-bromo-1,3-phenylene)bis(oxy))dibenzene (29.2 g), 9-phenyl-9H,9'H-3,3'-bicarbazole (35.0 g), Pd(dba)₂ (0.5 g), dicyclohexyl(1-methyl-2,2-diphenylcyclopropyl)phosphine (Cy-cBRIDP) (0.9 g), NaOtBu (24.7 g), and xylene (300 ml) was heated to 150°C, and the mixture was stirred for 17 hours. The reaction liquid was cooled to room temperature, water was added thereto, and the mixture was partitioned. Subsequently, the solvent was distilled off under reduced pressure. Subsequently, the residue was purified by silica gel column chromatography (developing liquid: toluene/heptane = 1/4 (volume ratio)), and thus 9-(3,5-diphenoxyphenyl)-9'-phenyl-9H,9'H-3,3'-bicarbazole (46.5 g) was obtained.

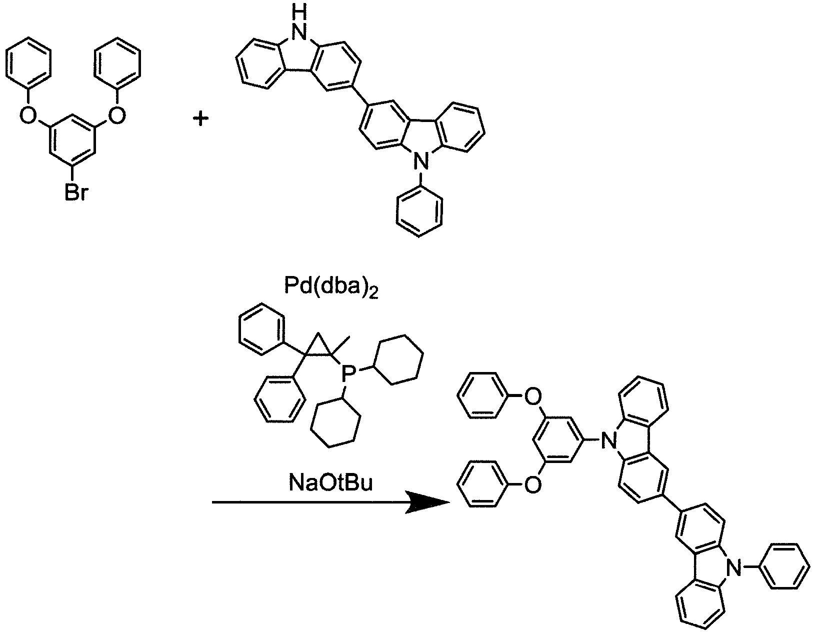

A 1.0 M sec-butyllithium cyclohexane solution (28.5 ml) was introduced into a flask containing 9-(3,5-diphenoxyphenyl)-9'-phenyl-9H,9'H-3,3'-bicarbazole (20.0 g) and xylene (100 ml), at 0°C in a nitrogen atmosphere. After completion of dropwise addition, the temperature of the mixture was increased to 70°C, the mixture was stirred for 3 hours, and then components having boiling points lower than that of xylene were distilled off under reduced pressure. The mixture was cooled to -50°C, boron tribromide (3.4 ml) was added thereto, the temperature of the mixture was increased to room temperature, and the mixture was stirred for 0.5 hours. Thereafter, the mixture was cooled again to 0°C, N,N-diisopropylethylamine (10.4 ml) was added thereto, and the mixture was stirred at room temperature until heat generation was settled. Subsequently, the temperature of the mixture was increased to 130°C, and the mixture was heated and stirred for 4 hours. The reaction liquid was cooled to room temperature, an aqueous solution of sodium acetate that had been cooled in an ice bath and then toluene were added thereto, and the mixture was partitioned. The resultant was purified by silica gel column chromatography (developing liquid: toluene/heptane = 1/1 (volume ratio)), and then a solid obtained by distilling off the solvent under reduced pressure was dissolved in toluene. The solid was reprecipitated by adding heptane to the solution, and thus a compound (1.0 g) represented by formula (1-1069) was obtained.

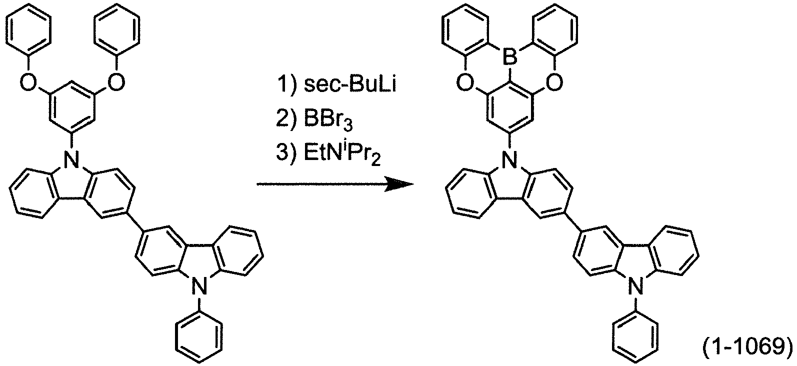

The structure of the compound thus obtained was identified by an NMR analysis.
¹H-NMR (400 MHz, CDCl₃): δ = 8. 76 (dd, 2H), 8.48 (s, 2H), 8.26 (t, 2H), 7.73 - 7.86 (m, 6H), 7.58 - 7.67 (m, 6H), 7.41 - 7.57 (m, 9H), 7.38 (t, 1H), 7.33 (m, 1H).

### Synthesis Example (28)

### Synthesis of 8-(naphthalen-1-yl)-5,9-dioxa-13b-boranaphtho[3,2,1-de]anth racene

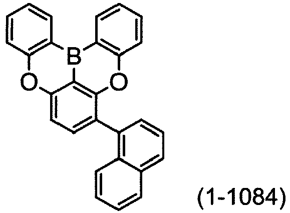

A flask containing ((4-bromo-1,3-phenylene)bis(oxy))dibenzene (25.0 g), 1-naphthaleneboronic acid (13.9 g), Pd-132 (Johnson Matthey) (0.1 g), potassium carbonate (20.2 g), tetrabutylammonium bromide (TBAB) (0.7 g), SOLMIX A-11 (200 ml) and water (50 ml) was heated and stirred for 2 hours at the reflux temperature. The reaction liquid was cooled to room temperature, subsequently water and toluene were added thereto, and the mixture was partitioned. Subsequently, the resultant was purified by silica gel column chromatography (developing liquid: toluene/heptane mixed solvent). At this time, the proportion of toluene in the developing liquid was gradually increased, and thereby the target substance was eluted. The target substance was further recrystallized from a SOLMIX A-11/toluene mixed solvent, and thus 1-(2,4-diphenoxyphenyl)naphthalene (22.9 g) was obtained.

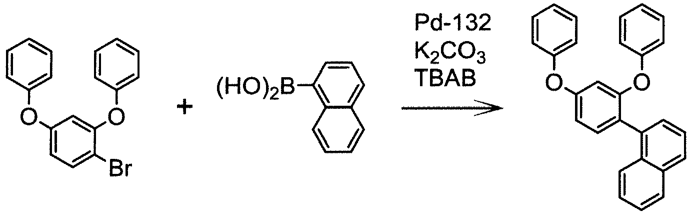

A 1.6 M n-butyllithium hexane solution (22.6 ml) was introduced into a flask containing 1-(2,4-diphenoxyphenyl)naphthalene (13.0 g) and xylene (100 ml), at 0°C in a nitrogen atmosphere. After completion of dropwise addition, the temperature of the mixture was increased to 80°C, the mixture was stirred for 4 hours, and then components having boiling points lower than that of xylene were distilled off under reduced pressure. The mixture was cooled to -50°C, boron tribromide (3.8 ml) was added thereto, the temperature of the mixture was increased to room temperature, and the mixture was stirred for 0.5 hours. Thereafter, the mixture was cooled again to 0°C, N,N-diisopropylethylamine (11.7 ml) was added thereto, and the mixture was stirred at room temperature until heat generation was settled. Subsequently, the temperature of the mixture was increased to 120°C, and the mixture was heated and stirred for 4 hours . The reaction liquid was cooled to room temperature, an aqueous solution of sodium acetate that had been cooled in an ice bath and then toluene were added thereto, and the mixture was partitioned. Subsequently, recrystallization from toluene/heptane was carried out, and then a compound (4.0 g) represented by formula (1-1084) was obtained.

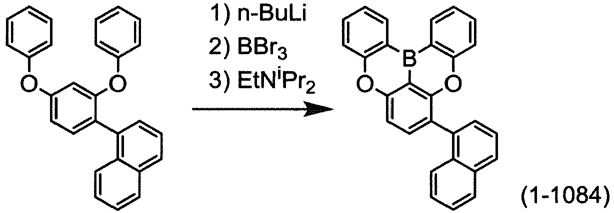

The structure of the compound thus obtained was identified by an NMR analysis.
¹H-NMR (400 MHz, CDCl₃): δ = 8.87 (m, 2H), 7.98 (d, 2H), 7.85 (d, 1H), 7.75 (t, 1H), 7.67 (d, 1H), 7.62 (m, 3H), 7.51 (m, 2H), 7.30 - 7.43 (m, 4H), 7.02 (d, 1H).

### Synthesis Example (29)

### Synthesis of 8-(pyren-1-yl)-5,9-dioxa-13b-boranaphtho[3,2,1-de]anthracen e

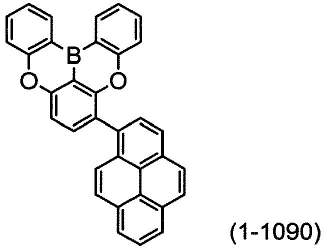

A flask containing ((4-bromo-1,3-phenylene)bis(oxy))dibenzene (12.0 g), 1-pyreneboronic acid (9.5 g), Pd-132 (Johnson Matthey) (0.03 g), potassium carbonate (9.7 g), TBAB (3.4 g), SOLMIX A-11 (60 ml) and water (24 ml) was heated and stirred for one hour at the reflux temperature. The reaction liquid was cooled to room temperature, subsequently water and toluene were added thereto, and the mixture was partitioned. Subsequently, the reaction liquid was purified using a silica gel short pass column (developing liquid: toluene), and was recrystallized from a SOLMIX A-11/ethyl acetate mixed solvent. Thus, 1-(2,4-diphenoxyphenyl)pyrene (13.3 g) was obtained.

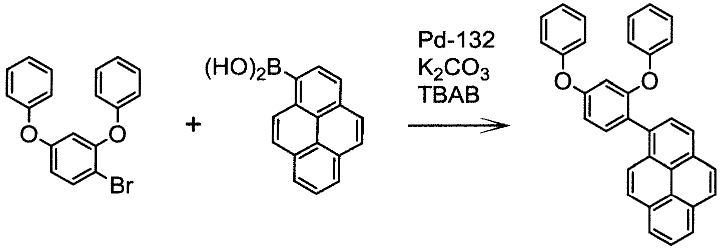

A 1.6 M n-butyllithium hexane solution (18.2 ml) was introduced into a flask containing 1-(2,4-diphenoxyphenyl) pyrene (12.5 g) and xylene (100 ml), at 0°C in a nitrogen atmosphere. After completion of dropwise addition, the temperature of the mixture was increased to 80°C, the mixture was stirred for 4 hours, and then components having boiling points lower than that of xylene were distilled off under reduced pressure. The mixture was cooled to -50°C, boron tribromide (3.1 ml) was added thereto, the temperature of the mixture was increased to room temperature, and the mixture was stirred for 0.5 hours. Thereafter, the mixture was cooled again to 0°C, N,N-diisopropylethylamine (9.4 ml) was added thereto, and the mixture was stirred at room temperature until heat generation was settled. Subsequently, the temperature of the mixture was increased to 120°, and the mixture was heated and stirred for 4 hours. The reaction liquid was cooled to room temperature, and a solid precipitated by adding an aqueous solution of sodium acetate that had been cooled in an ice bath and then adding heptane was collected by suction filtration. The solid was washed with water and SOLMIX A-11 in this order, and then was recrystallized from xylene. The resultant was further recrystallized from chlorobenzene, and thus a compound (3.3 g) represented by formula (1-1090) was obtained.

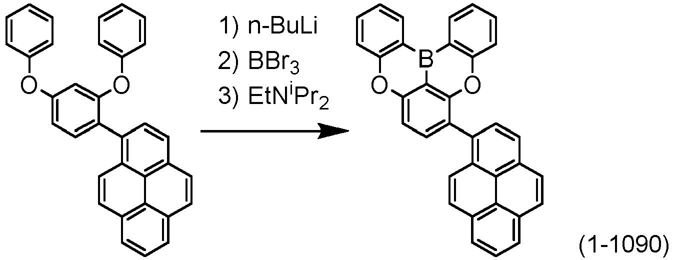

The structure of the compound thus obtained was identified by an NMR analysis.
¹H-NMR (400 MHz, CDCl₃): δ = 8.76 (d, 1H), 8.71 (d, 1H), 8.32 (d, 1H), 8.23 (d, 1H), 8.18 (m, 4H), 7.95 - 8.05 (m, 4H), 7.79 (t, 1H), 7.64 (d, 1H), 7.45 (m, 3H), 7.35 (t, 1H), 6.97 (d, 1H).

### Synthesis Example (32)

### Synthesis of 5,9-diphenyl-5,9-dihydro-5,9-diaza-13b-boranaphtho[3,2,1-de ]anthracene

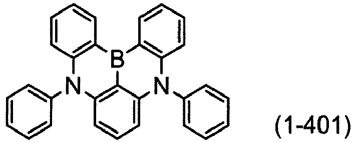

In a nitrogen atmosphere, a flask containing diphenylamine (66.0 g), 1-bromo-2,3-dichlorobenzene (40.0 g), Pd-132 (Johnson Matthey) (1.3 g), NaOtBu (43.0 g) and xylene (400 ml) was heated and stirred for 2 hours at 80°C. Subsequently, the temperature of the mixture was increased to 120°C, and the mixture was heated and stirred for 3 hours. The reaction liquid was cooled to room temperature, and then a solid precipitated by adding water and ethyl acetate was collected by suction filtration. Subsequently, the solid was purified using a silica gel short pass column (developing liquid: heated toluene) . The solvent was distilled off under reduced pressure, and a solid thus obtained was washed with heptane. Thus, 2-chloro-N¹,N¹,N³,N³-tetraphenylbenzene-1,3-diamine (65.0 g) was obtained.

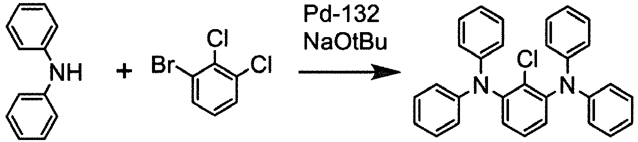

A 1.7 M tert-butyllithium pentane solution (27.6 ml) was introduced into a flask containing 2-chloro-N¹,N¹,N³,N³-tetraphenylbenzene-1,3-diamine (20.0 g) and tert-butylbenzene (150 ml), at -30°C in a nitrogen atmosphere. After completion of dropwise addition, the temperature of the mixture was increased to 60°C, the mixture was stirred for 2 hours, and then components having boiling points lower than that of tert-butylbenzene were distilled off under reduced pressure. The mixture was cooled to -30°C, boron tribromide (5.1 ml) was added thereto, the temperature of the mixture was increased to room temperature, and the mixture was stirred for 0.5 hours. Thereafter, the mixture was cooled again to 0°C, N,N-diisopropylethylamine (15.6 ml) was added thereto, and the mixture was stirred at room temperature until heat generation was settled. Subsequently, the temperature of the mixture was increased to 120°C, and the mixture was heated and stirred for 3 hours. The reaction liquid was cooled to room temperature, an aqueous solution of sodium acetate that had been cooled in an ice bath and then heptane were added thereto, and the mixture was partitioned. Subsequently, the reaction liquid was purified using a silica gel short pass column (additive liquid: toluene), and then a solid obtained by distilling off the solvent under reduced pressure was dissolved in toluene and reprecipitated by adding heptane thereto. Thus, a compound (6.0 g) represented by formula (1-401) was obtained.

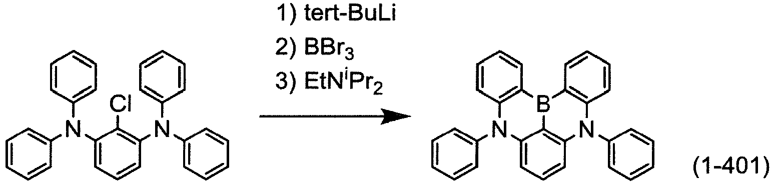

The structure of the compound thus obtained was identified by an NMR analysis.
¹H-NMR (400 MHz, CDCl₃): δ = 8.94 (d, 2H), 7.70 (t, 4H), 7.60 (t, 2H), 7.42 (t, 2H), 7.38 (d, 4H), 7.26 (m, 3H), 6.76 (d, 2H), 6.14 (d, 2H) .

### Synthesis Example (33)

### Synthesis of 9-([1,1'-biphenyl]-4-yl)-5,12-diphenyl-5,9-dihydro-5,9-diaz a-13b-boranaphtho[3,2,1-de]anthracene

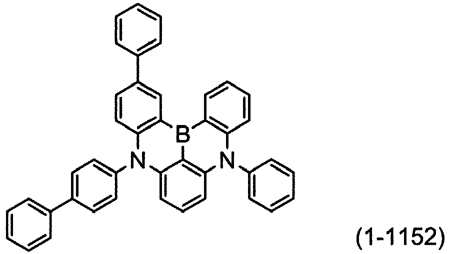

In a nitrogen atmosphere, a flask containing diphenylamine (37.5 g), 1-bromo-2,3-dichlorobenzene (50.0 g), Pd-132 (Johnson Matthey) (0.8 g), NaOtBu (32.0 g) and xylene (500 ml) was heated and stirred for 4 hours at 80°C, subsequently the temperature of the mixture was increased to 120°C, and the mixture was heated and stirred for 3 hours. The reaction liquid was cooled to room temperature, water and ethyl acetate were added thereto, and the mixture was partitioned. Subsequently, the resultant was purified by silica gel column chromatography (developing liquid: toluene/heptane = 1/20 (volume ratio)), and thus 2,3-dichloro-N,N-diphenylaniline (63.0 g) was obtained.

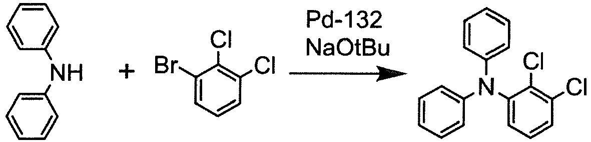

In a nitrogen atmosphere, a flask containing 2,3-dichloro-N,N-diphenylaniline (16.2 g), di([1,1'-biphenyl]-4-yl)amine (15.0 g), Pd-132 (Johnson Matthey) (0.3 g), NaOtBu (6.7 g) and xylene (150 ml) was heated and stirred for one hour at 120°C. The reaction liquid was cooled to room temperature, subsequently water and ethyl acetate were added thereto, and the mixture was partitioned. Subsequently, the reaction liquid was purified using a silica gel short pass column (developing liquid: heated toluene) and was further washed with a heptane/ethyl acetate = 1 (volume ratio) mixed solvent. Thus, N¹,N¹-di([1,1'-bipheyl]-4-yl)-2-chloro-N³,N³-diphenylbenzene -1,3-diamine (22.0 g) was obtained.

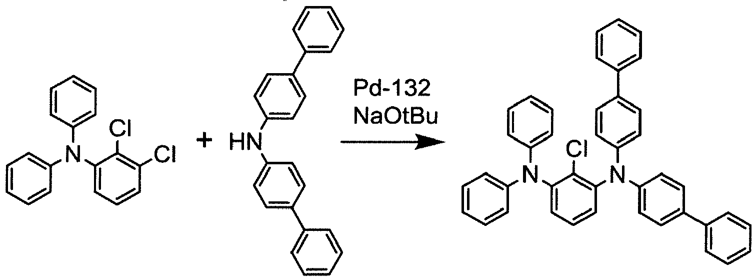

A 1.6 M tert-butyllithium pentane solution (37.5 ml) was introduced into a flask containing N¹,N¹-di([1,1'-biphenyl]-4-yl)-2-chloro-N³,N³-diphenylbenzen e-1,3-diamine (22.0 g) and tert-butylbenzene (130 ml), at -30°C in a nitrogen atmosphere. After completion of dropwise addition, the temperature of the mixture was increased to 60°C, the mixture was stirred for one hour, and then components having boiling points lower than that of tert-butylbenzene were distilled off under reduced pressure. The mixture was cooled to -30°C, boron tribromide (6.2 ml) was added thereto, the temperature of the mixture was increased to room temperature, and the mixture was stirred for 0.5 hours. Thereafter, the mixture was cooled again to 0°C, N,N-diisopropylethylamine (12.8 ml) was added thereto, and the mixture was stirred at room temperature until heat generation was settled. Subsequently, the temperature of the mixture was increased to 120°C, and the mixture was heated and stirred for 2 hours. The reaction liquid was cooled to room temperature, an aqueous solution of sodium acetate that had been cooled in an ice bath and then ethyl acetate were added thereto, and the mixture was partitioned. Subsequently, the reaction liquid was purified using a silica gel short pass column (developing liquid: heated chlorobenzene) . The resultant was washed with refluxed heptane and refluxed ethyl acetate, and then was reprecipitated from chlorobenzene. Thus, a compound (5.1 g) represented by formula (1-1152) was obtained.

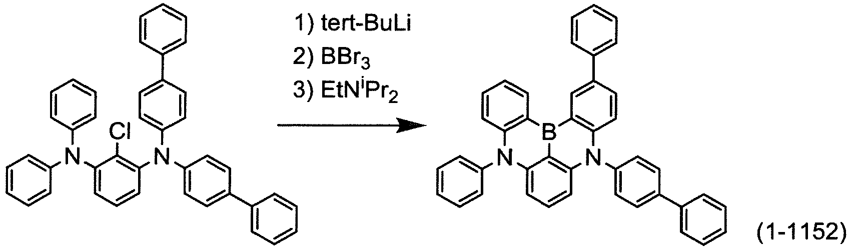

The structure of the compound thus obtained was identified by an NMR analysis.
¹H-NMR (400 MHz, CDCl₃): δ = 9.17 (s, 1H), 8.99 (d, 1H), 7.95 (d, 2H), 7.68 - 7.78 (m, 7H), 7.60 (t, 1H), 7.40 - 7.56 (m, 10H), 7.36 (t, 1H), 7.30 (m, 2H), 6.95 (d, 1H), 6.79 (d, 1H), 6.27 (d, 1H), 6.18 (d, 1H).

### Synthesis Example (34)

### Synthesis of 5,9,11,15-tetraphenyl-5,9,11,15-tetrahydro-5,9,11,15-tetraa za-19b,20b-diboranaphtho[3,2,1-de:1',2',3'-jk]pentacene

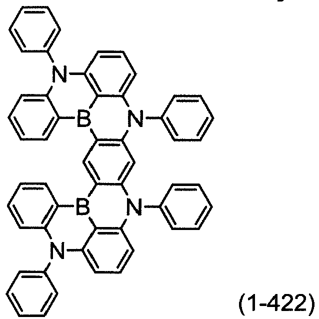

In a nitrogen atmosphere, a flask containing 2,3-dichloro-N,N-diphenylaniline (36.0 g), N¹,N³-diphenylbenzene-1,3-diamine (12.0 g), Pd-132 (Johnson Matthey) (0.3 g), NaOtBu (11.0 g) and xylene (150 ml) was heated and stirred for 3 hours at 120°C. The reaction liquid was cooled to room temperature, subsequently water and ethyl acetate were added thereto, and the mixture was partitioned. Subsequently, the resultant was purified by silica gel column chromatography (developing liquid: toluene/heptane mixed solvent). At this time, the proportion of toluene in the developing liquid was gradually increased, and thereby the intended substance was eluted. The intended substance was further purified by activated carbon column chromatography (developing liquid: toluene), and thus N¹,N¹'-(1,3-phenylene)bis(2-chloro-N¹,N³,N³-triphenylbenzene-1,3-diamine) (22.0 g) was obtained.

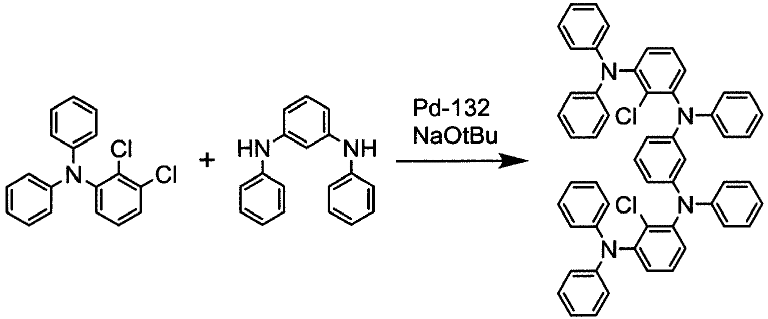

A 1.6 M tert-butyllithium pentane solution (42.0 ml) was introduced into a flask containing N¹,N¹'-(1,3-phenylene)bis(2-chloro-N¹,N³,N³-triphenylbenzene-1,3-diamine) (22.0 g) and tert-butylbenzene (150 ml), at -30°C in a nitrogen atmosphere. After completion of dropwise addition, the temperature of the mixture was increased to 60°C, the mixture was stirred for 5 hours, and components having boiling points lower than that of tert-butylbenzene were distilled off under reduced pressure. The mixture was cooled to -30°C, boron tribromide (7.6 ml) was added thereto, the temperature of the mixture was increased to room temperature, and the mixture was stirred for 0.5 hours. Thereafter, the mixture was cooled again to 0°C, N,N-diisopropylethylamine (18.9 ml) was added thereto, and the mixture was stirred at room temperature until heat generation was settled. Subsequently, the temperature of the mixture was increased to 120°C, and the mixture was heated and stirred for 2 hours . The reaction liquid was cooled to room temperature, an aqueous solution of sodium acetate that had been cooled in an ice bath was added thereto, and a solid thus precipitated was separated by filtration. A filtrate was partitioned, and the organic layer was purified by silica gel column chromatography (developing liquid: toluene/heptane = 1 (volume ratio)). The solvent was distilled off under reduced pressure, a solid thus obtained was dissolved in chlorobenzene, and the solid was reprecipitated by adding ethyl acetate. Thus, a compound (0.6 g) represented by formula (1-422) was obtained.

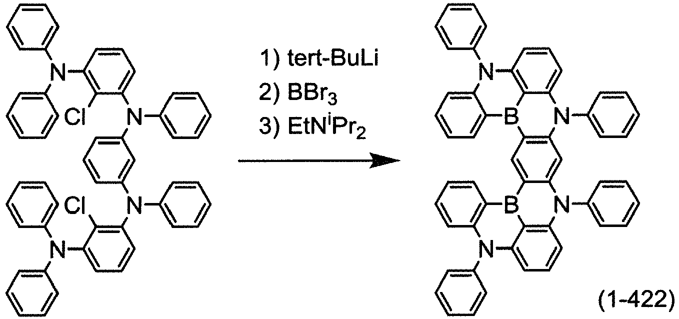

The structure of the compound thus obtained was identified by an NMR analysis.
¹H-NMR (400 MHz, DMSO - d6): δ = 10.38 (s, 1H), 9.08 (d, 2H), 7.81 (t, 4H), 7.70 (t, 2H), 7.38 - 7.60 (m, 14H), 7.30 (t, 2H), 7.18 (d, 4H), 6.74 (d, 2H), 6.07 (d, 2H), 6.02 (d, 2H), 5.78 (s, 1H).

### Synthesis Example (35)

### Synthesis of N¹-(5,9-diphenyl-5,9-dihydro-5,9-diaza-13b-boranaphtho[3,2, 1-de]anthracen-3-yl)-N¹,N³,N³-triphenylbenzene-1,3-diamine

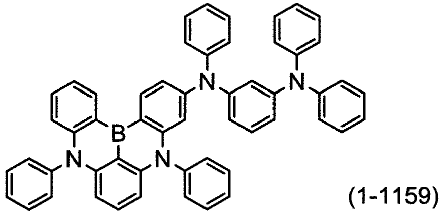

During the silica gel column chromatographic purification of the compound (0.6 g) represented by formula (1-422), a fraction containing the relevant derivative was fractionated. The fraction was further washed with refluxed heptane, and then was reprecipitated from chlorobenzene/ethyl acetate. Thus, a compound (1.1 g) represented by formula (1-1159) was obtained.

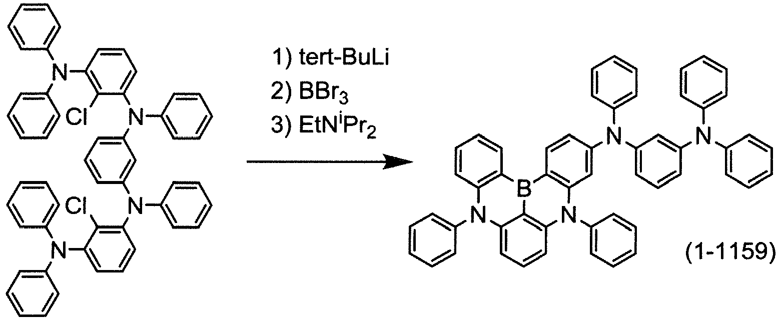

The structure of the compound thus obtained was identified by an NMR analysis.
¹H-NMR (400 MHz, DMSO - d6): δ = 8.78 (d, 1H), 8.66 (d, 1H), 7.69 (t, 2H), 7.59 (t, 1H), 7.59 (t, 2H), 7.49 (m, 2H), 7.40 (d, 2H), 7.22 - 7.32 (m, 10H), 7.18 (t, 1H), 6.97 - 7.07 (m, 9H), 6.89 (d, 1H), 6.60 - 6.70 (m, 4H), 6.11 (s, 1H), 5.96 (m, 2H).

### Synthesis Example (36)

### Synthesis of 9-phenyl-9H-5-oxa-9-aza-13b-boranaphtho[3,2,1-de]anthracene

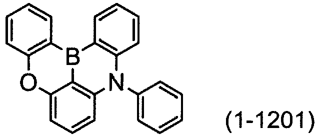

In a nitrogen atmosphere, a flask containing 1-bromo-2-chloro-3-fluorobenzene (25.0 g), phenol (12.3 g), potassium carbonate (33.0 g) and NMP (150 ml) was heated and stirred for 4 hours at 180°C. The reaction liquid was cooled to room temperature, NMP was distilled off under reduced pressure, subsequently water and ethyl acetate were added thereto, and the mixture was partitioned. Subsequently, the reaction liquid was purified using a silica gel short pass column (developing liquid: toluene/heptane = 1/1 (volume ratio)), and thus 1-bromo-2-chloro-3-phenoxybenzene (32.0 g) was obtained.

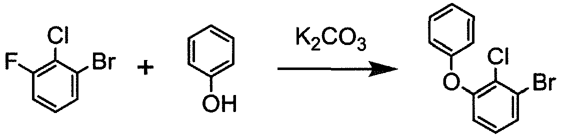

In a nitrogen atmosphere, a flask containing diphenylamine (21.0 g), 1-bromo-2-chloro-3-phenoxybenzene (32.0 g), Pd-132 (Johnson Matthey) (0.4 g), NaOtBu (16.0 g) and xylene (200 ml) was heated and stirred for 4 hours at 80°C. The reaction liquid was cooled to room temperature, subsequently water and ethyl acetate were added thereto, and the mixture was partitioned. Subsequently, the resultant was purified by silica gel column chromatography (developing liquid: toluene/heptane = 2/8 (volume ratio), and was further reprecipitated from heptane. Thus, 2-chloro-3-phenoxy-N,N-diphenylaniline (35.0 g) was obtained.

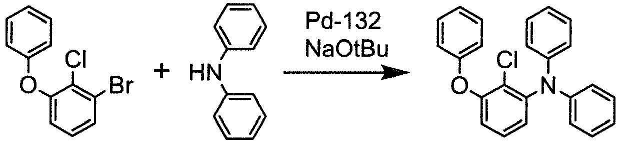

A 1.7 M tert-butyllithium pentane solution (26.5 ml) was introduced into a flask containing 2-chloro-3-phenoxy-N,N-diphenylaniline (16.0 g) and tert-butylbenzene (150 ml), at -30°C in a nitrogen atmosphere. After completion of dropwise addition, the temperature of the mixture was increased to 15°C, and the mixture was stirred for 2 hours. The mixture was cooled again to -30°C, and boron tribromide (4.9 ml) was added thereto. Subsequently, the temperature of the mixture was increased to 60°C while pressure was reduced, and components having boiling points lower than that of tert-butylbenzene were distilled off under reduced pressure. Thereafter, the mixture was cooled to 0°C, N,N-diisopropylethylamine (15.0 ml) was added thereto, and the mixture was stirred at room temperature until heat generation was settled. Subsequently, the temperature of the mixture was increased to 120°C, and the mixture was heated and stirred for one hour. The reaction liquid was cooled to room temperature, an aqueous solution of sodium acetate that had been cooled in an ice bath and then ethyl acetate were added thereto, and the mixture was partitioned. The resultant was purified by silica gel column chromatography (developing liquid: toluene/heptane mixed solvent) . At this time, the proportion of toluene in the developing liquid was gradually increased, and thereby the intended substance was eluted. The intended substance was further purified by activated carbon column chromatography (developing liquid: toluene), and thus a compound (0.8 g) represented by formula (1-1201) was obtained.

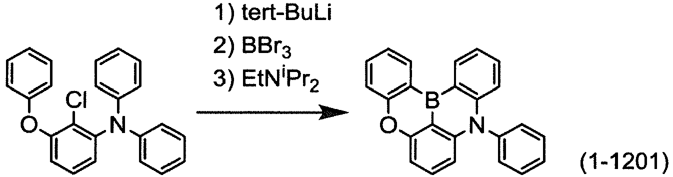

The structure of the compound thus obtained was identified by an NMR analysis.
¹H-NMR (400 MHz, CDCl₃): δ = 8.92 (d, 1H), 8.78 (d, 1H), 7.70 (t, 2H), 7.66 (t, 1H), 7.61 (t, 1H), 7.53 (m, 2H), 7.47 (t, 1H), 7.37 (m, 3H), 7.27 (t, 1H), 7.11 (d, 1H), 6.80 (d, 1H), 6.31 (d, 1H).

### Synthesis Example (37)

### Synthesis of N,N,9-triphenyl-9H-5-oxa-9-aza-13b-boranaphtho[3,2,1-de]ant hracene-3-amine

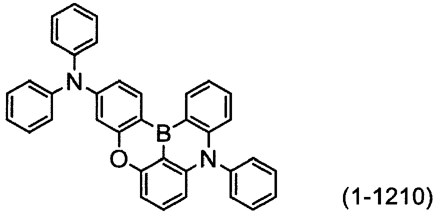

In a nitrogen atmosphere, a flask containing 1-bromo-2-chloro-3-fluorobenzene (20.0 g), 3-(diphenylamino) phenol (27.4 g), potassium carbonate (26.4 g) and NMP (150 ml) was heated and stirred for 6 hours at 180°C. The reaction liquid was cooled to room temperature, NMP was distilled off under reduced pressure, subsequently water and toluene were added thereto, and the mixture was partitioned. Subsequently, the resultant was purified by silica gel column chromatography (developing liquid: toluene/heptane = 2/1 (volume ratio)), and thus 3-(3-bromo-2-chlorophenoxy)-N,N'-diphenylaniline (31.6 g) was obtained.

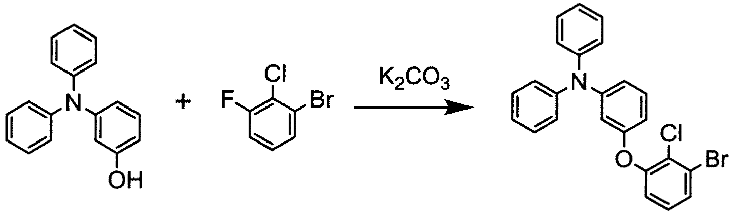

In a nitrogen atmosphere, a flask containing diphenylamine (13.0 g), 3-(3-bromo-2-chlorophenoxy)-N,N'-diphenylaniline (31.6 g), Pd-132 (Johnson Matthey) (0.5 g), NaOtBu (10.1 g), and 1,2,4-trimethylbenzene (150 ml) was heated and stirred for one hour at the reflux temperature. The reaction liquid was cooled to room temperature, and then insoluble salts were removed by suction filtration. Subsequently, the filtrate was purified using an activated carbon short pass column (developing liquid: toluene), and was further purified by silica gel column chromatography (developing liquid: toluene/heptane = 1/6 (volume ratio)). Thus, 2-chloro-3-(3-diphenylamino)phenoxy-N,N-diphenylaniline (26.3 g) was obtained.

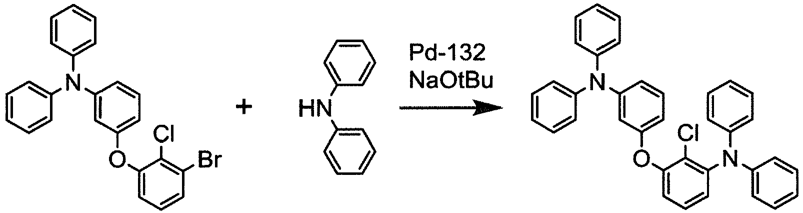

A 1.6 M tert-butyllithium pentane solution (31.4 ml) was introduced into a flask containing 2-chloro-3-(3-diphenylamino)phenoxy-N,N-diphenylaniline (26.3 g) and tert-butylbenzene (150 ml), at -30°C in a nitrogen atmosphere. After completion of dropwise addition, the temperature of the mixture was increased to room temperature, and the mixture was stirred overnight. The mixture was cooled again to -30°C, and boron tribromide (5.4 ml) was added thereto. Subsequently, the temperature of the mixture was increased to 60°C while pressure was reduced, and components having boiling points lower than that of tert-butylbenzene were distilled off under reduced pressure. Thereafter, the mixture was cooled to 0°C, N,N-diisopropylethylamine (17.0 ml) was added thereto, and the mixture was stirred at room temperature until heat generation was settled. Subsequently, the temperature of the mixture was increased to 120°C, and the mixture was heated and stirred for 5.5 hours. The reaction liquid was cooled to room temperature, an aqueous solution of sodium acetate that had been cooled in an ice bath and then ethyl acetate were added thereto, and the mixture was partitioned. The mixture was purified by silica gel column chromatography (developing liquid: toluene), and recrystallization from toluene was carried out. Thus, a compound (0.6 g) represented by formula (1-1210) was obtained.

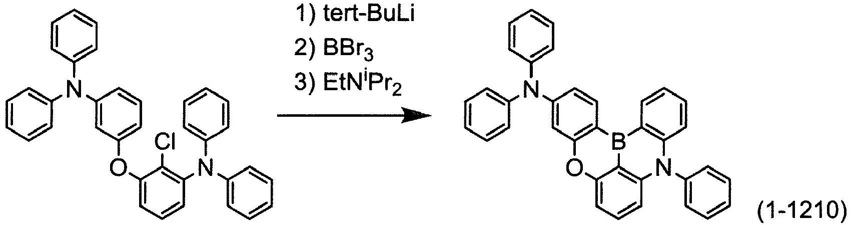

The structure of the compound thus obtained was identified by an NMR analysis.
¹H-NMR (400 MHz, CDCl₃): δ = 8.81 (d, 1H), 8.57 (d, 1H), 7.70 (t, 2H), 7.61 (t, 1H), 7.44 (m, 2H), 7.37 (t, 6H), 7.12 - 7.30 (m, 7H), 7.03 (m, 2H), 6.92 (d, 1H), 6.76 (d, 1H), 6.26 (d, 1H).

### Synthesis Example (38)

### Synthesis of 5,11-diphenl-6,10-dioxa-16b-boraanthra[3,2,1-de]tetracene

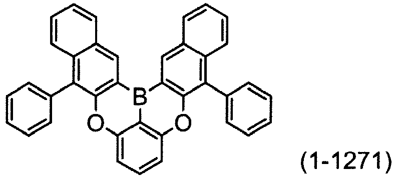

Copper(I) iodide (0.8 g) and iron (III) acetylacetonate (3.0 g) were added to an NMP (100 ml) solution of 1-phenylnaphthalen-2-ol (20.0 g) synthesized by the method described in Angew. Chem. Int. Ed. 2013, 52, 10598-10601, 1,3-dibromobenzene (9.7 g) and potassium carbonate (23.0 g) in a nitrogen atmosphere. The temperature of the mixture was increased to 150°C, and the mixture was stirred for 6 hours. The reaction liquid was cooled to room temperature, and a salt precipitated by adding aqueous ammonia thereto was removed by suction filtration using a Hirsch funnel covered with Celite. Ethyl acetate was added to the filtrate, and the mixture was partitioned. Subsequently, the resultant was purified by silica gel column chromatography (developing liquid: toluene/heptane = 3/7), and thus 1,3-bis((1-phenylnaphthalen-2-yl)oxy)benzene (12.0 g) was obtained.

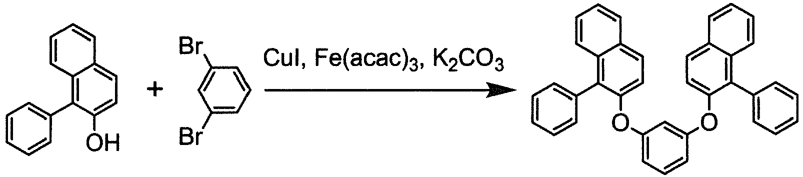

A 2.6 M n-butyllithium hexane solution (24.5 ml) was introduced into a flask containing 1,3-bis((1-phenylnaphthalen-2-yl)oxy)benzene (12.0 g) and ortho-xylene (100 ml), at 0°C in a nitrogen atmosphere. After completion of dropwise addition, the temperature of the mixture was increased to 70°C, the mixture was stirred for 2 hours, and then components having boiling points lower than that of xylene were distilled off under reduced pressure. The mixture was cooled to -50°C, boron tribromide (4.9 ml) was added thereto, the temperature of the mixture was increased to room temperature, and the mixture was stirred for 0.5 hours. Thereafter, the mixture was cooled again to 0°C, N,N-diisopropylethylamine (8.1 ml) was added thereto, and the mixture was stirred at room temperature until heat generation was settled. Subsequently, the temperature of the mixture was increased to 120°C, and the mixture was heated and stirred for 3 hours. In order to further accelerate the reaction, aluminum chloride (6.2 g) was added thereto, and the mixture was heated and stirred for 2 hours at 130°C. The reaction liquid was cooled to room temperature, and a suspension produced by adding an aqueous solution of sodium acetate that had been cooled in an ice bath was directly partitioned. Subsequently, a solid produced by adding heptane to the organic layer was collected by suction filtration. The solid thus obtained was washed with refluxed ethyl acetate, toluene and chlorobenzene in this order, and thus a compound (5.3 g) represented by formula (1-1271) was obtained.

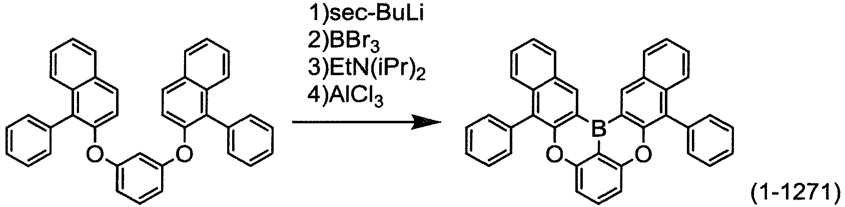

The structure of the compound thus obtained was identified by an NMR analysis.
¹H-NMR (400 MHz, CDCl₃): δ = 9.56 (s, 2H), 8.28 (d, 2H), 7.74 (m, 2H), 7.50 - 7.66 (m, 15H), 6.90 (d, 2H).

### Synthesis Example (39)

### Synthesis of 5,9-dithia-13b-boranahtho[3,2,1-de]anthracene

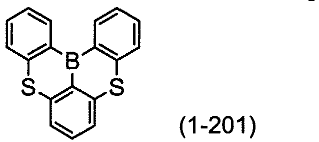

In a nitrogen atmosphere, a solution of 2-bromo-1,3-difluorobenzene (23.6 g), benzenethiol (27.2 g), potassium carbonate (67.0 g) and NMP (150 ml) was heated to 180°C and stirred for 12 hours. The reaction liquid was cooled to room temperature, NMP was distilled off under reduced pressure, subsequently water and ethyl acetate were added thereto, and the mixture was partitioned. Subsequently, the resultant was purified by silica gel column chromatography (developing liquid: toluene/heptane = 1/9 (volume ratio)). A crude purification product thus obtained was dissolved in toluene and was reprecipitated by adding heptane. Thus, (2-bromo-1,3-phenylene)bis(phenylsulfane) (9.5 g) was obtained.

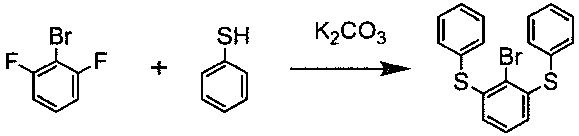

In a nitrogen atmosphere, a flask containing (2-bromo-1,3-phenylene)bis(phenylsulfane) (9.5 g) and xylene (100 ml) was cooled to -40°C, and a 1.0 M sec-butyllithium cyclohexane solution (26.7 ml) was added dropwise thereto. After completion of dropwise addition, the temperature of the mixture was increased to about 60°C, and components having boiling points lower than that of xylene were distilled off under reduced pressure. The mixture was cooled again to -40°C, and boron tribromide (2.9 ml) was added thereto. The temperature of the mixture was increased to room temperature, and the mixture was stirred for 0.5 hours. Subsequently, the mixture was cooled to 0°C, and N,N-diisopropylethylamine (8.9 ml) was added thereto. The temperature of the mixture was increased to 120°C, and the mixture was heated and stirred for 2 hours. The reaction liquid was cooled to room temperature, an aqueous solution of sodium acetate that had been cooled in an ice bath and ethyl acetate were added thereto, and the mixture was partitioned. The solvent was distilled off under reduced pressure, and reprecipitation was carried out by adding heptane to an oily substance thus obtained. A solid thus obtained was washed with ethyl acetate, and thus a compound (4.6 g) represented by formula (1-201) was obtained.

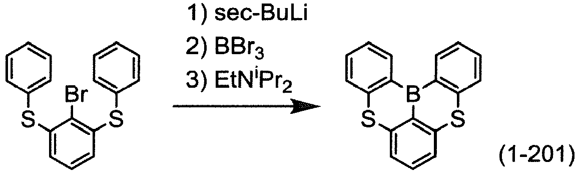

The structure of the compound thus obtained was identified by an NMR analysis.
¹H-NMR (400 MHz, CDCl₃): δ = 8.30 (d, 2H), 7.72 (d, 2H), 7.54 - 7.62 (m, 4H), 7.50 (t, 1H), 7.43 (t, 2H).

### Synthesis Example (40)

### Synthesis of 9,10,19,20-tetraoxa-4b,14b-diboradinaphtho[1,2,3-fg:1',2',3 '-qr]pentacene

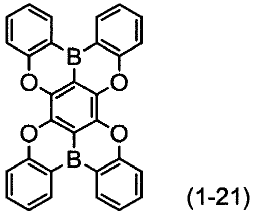

In a nitrogen atmosphere, a flask containing 1,4-dibromo-2,3,5,6-tetrafluorobenzene (6.24 g), phenol (9.53 g), potassium carbonate (14.0 g) and NMP (20 ml) was heated and stirred for 18 hours at 140°C. The reaction liquid was cooled to room temperature, saturated brine and toluene were added thereto, and the mixture was partitioned. The solvent was distilled off under reduced pressure, and then the residue was purified using a silica gel short pass column (developing liquid: toluene) . The solvent was distilled off under reduced pressure, and a crude purification product was washed using methanol. Thus, 1,4-dibromo-2,3,5,6-tetraphenoxybenzene (9.64 g) was obtained.

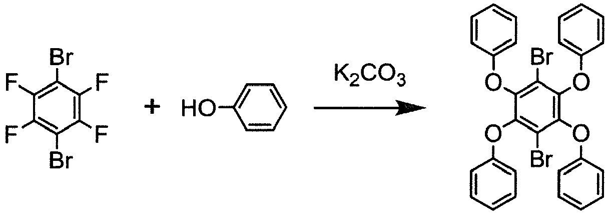

A 1.6 M n-butyllithium hexane solution (0.610 ml) was added to a t-butylbenzene (3.0 ml) solution of 1,4-dibromo-2,3,5,6-tetraphenoxybenzene (0.604 g), at 0°C in a nitrogen atmosphere. The mixture was stirred for one hour, subsequently the temperature of the mixture was increased to room temperature, and t-butylbenzene (4.0 ml) was added thereto. The mixture was cooled to -50°C, boron tribromide (0.105 ml) was added thereto, and the mixture was stirred for 30 minutes. The temperature of the mixture was increased to 0°C, the mixture was stirred for 30 minutes, subsequently the temperature of the mixture was increased to 60°C, and the mixture was stirred for 10 hours. Thereafter, the mixture was cooled to 0°C, N,N-diisopropylethylamine (0.350 ml) was added thereto, and the mixture was heated and stirred for 17 hours at the reflux temperature. The reaction liquid was cooled to room temperature, and was filtered using a Florisil short pass column . The solvent was distilled off under reduced pressure, and then the residue was washed with hexane. Thus, 7-bromo-6,8-diphenoxy-5,9-dioxa-13b-boranaphtho[3,2,1-de]an thracene (0.106 g) was obtained as a pale orange-colored product.

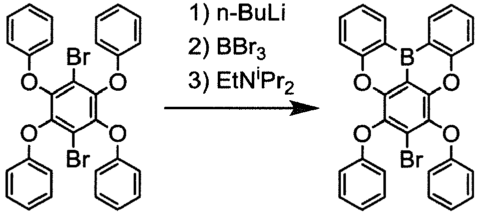

A 1.1 M sec-butyllithium hexane solution (1.98 ml) was added to a t-butylbenzene (2.5 ml) solution of 7-bromo-6,8-diphenoxy-5,9-dioxa-13b-boranaphtho[3,2,1-de]an thracene (0.103 g), at -50°C in a nitrogen atmosphere. After the mixture was stirred for 30 minutes, the temperature of the mixture was increased to 0°C, and the mixture was stirred for 2 hours. The mixture was cooled again to -50°C, boron tribromide (0.220 ml) was added thereto, the temperature of the mixture was increased to room temperature, and the mixture was stirred for 30 minutes. Thereafter, N,N-diisopropylethylamine (65.9 µl) was added thereto, and the mixture was heated and stirred for 11 hours at the reflux temperature. The reaction liquid was cooled to room temperature, and was suction filtered using a glass filter covered with Celite. The solvent was distilled off under reduced pressure, and a crude product was obtained. The crude product was washed using hexane and chloroform, and thereby a compound (4.10 mg) represented by formula (1-21) was obtained as an orange-colored solid.

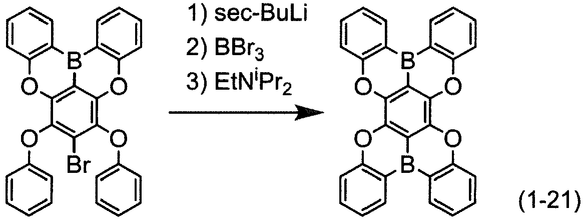

The structure of the compound thus obtained was identified by an NMR analysis.
¹H NMR (δ ppm in CDCl₃); 8.80 (dd, J = 1.6, 7.8 Hz, 4H), 7.83 (ddd, J = 1.6, 6.0, 8.4 Hz, 4H), 7.81 (dd, J = 2.0, 8.4 Hz, 4H), 7.46 (ddd, J = 2.0, 6.0, 7.8 Hz, 4H).
LRMS(EI+) m/z 462(M⁺)

### Synthesis Examples (41) and (42)

### Synthesis of 19b,20b-dibora-5,9,11,15-tetraoxadinaphtho[3,2,1-de:1',2',3 '-jk]pentacene

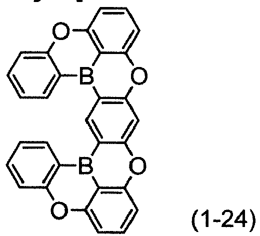

### Synthesis of 4b,13b-dibora-5,9,16,20-tetraoxadinaphtho[3,2,1-de:3',2',1' -pq]pentaphene

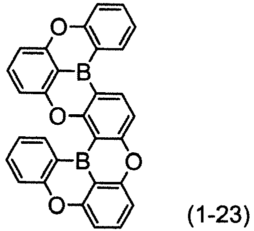

1-Bromo-2,6-difluorobenzene (25.2 g, 0.130 mol) was added to phenol (12.3 g, 0.130 mol), potassium carbonate (18.0 g, 0.130 mol) and N-methylpyrrolidone (NMP, 250 mL) at room temperature in a nitrogen atmosphere, and the mixture was heated and stirred for 160 hours at 120°C. Thereafter, NMP was distilled off under reduced pressure, and then toluene was added thereto. The mixture was filtered using a silica gel short pass column, and the solvent was distilled off under reduced pressure. Thus, 2-bromo-1-fluoro-3-phenoxybenzene was obtained as a pale red liquid (26.4 g, yield 76%).

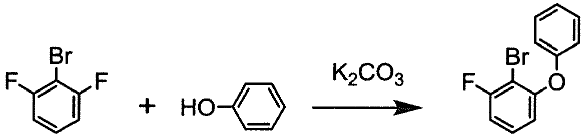

2-Bromo-1-fluoro-3-phenoxybenzene (7.67 g, 28.7 mmol) was added to resorcinol (14.4 g, 14.4 mmol), potassium carbonate (3.97 g, 28.7 mmol), and NMP (57.4 mL) at room temperature in a nitrogen atmosphere, and the mixture was heated and stirred for 160 hours at 150°C and then heated and stirred for 22 hours at 160°C. Thereafter, NMP was distilled off under reduced pressure, and then toluene was added thereto. The mixture was filtered using a Florisil short pass column, the solvent was distilled off under reduced pressure, and a crude product was obtained. The crude product was recrystallized using toluene, and thus 1,3-bis(2-bromo-3-phenoxyphenoxy)benzene was obtained as a white solid (5.35 g, yield 62%).

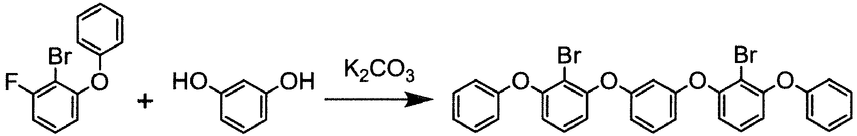

A hexane solution of butyllithium (0.688 mL, 1.64 M, 1.1 mmol) was added to 1,3-bis(2-bromo-3-phenoxyphenoxy)benzene (0.302 g, 0.50 mmol) and tert-butylbenzene (5.0 mL), at -42°C in a nitrogen atmosphere, and then the mixture was stirred for 22 hours at room temperature. Boron tribromide (0.142 mL, 1.5 mmol) was added thereto at -42°C, and the mixture was stirred for 3 hours at 50°C. The mixture was stirred for another 17 hours at 70°C, and then 10% of the reaction solution was distilled off at 0°C under reduced pressure. N,N-diisopropylethylamine (0.348 mL, 2.0 mmol) was added thereto at 0°C, and the mixture was heated and stirred for 20 hours at 150°C. Subsequently, the mixture was filtered using a Florisil short pass column, the solvent was distilled off under reduced pressure, and a crude product was obtained. The crude product was washed using dichloromethane and acetonitrile, and thereby a white solid was obtained. Next, the white solid was recrystallized using ethyl acetate, and thereby a compound represented by formula (1-24) was obtained as a white solid (19.2 mg, yield 8.3%). Furthermore, the solvent of the filtrate was distilled off under reduced pressure, and thereby a compound represented by formula (1-24) as a pale yellow-colored solid and a compound represented by formula (1-23) was obtained as a mixture at a ratio of 1 : 5 (30.8 mg, yield 13%). From these results, the yield of the compound represented by formula (1-24) was calculated to be 11% (24.3 mg), and the yield of the compound represented by formula (1-23) was calculated to be 11% (25.7 mg) .

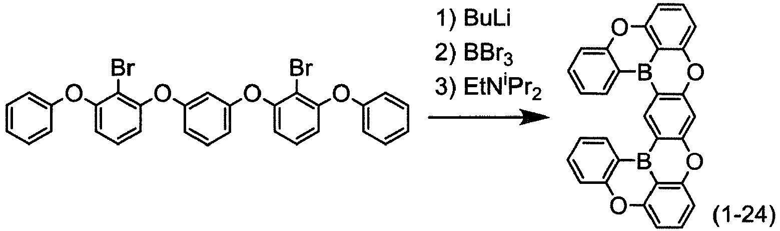

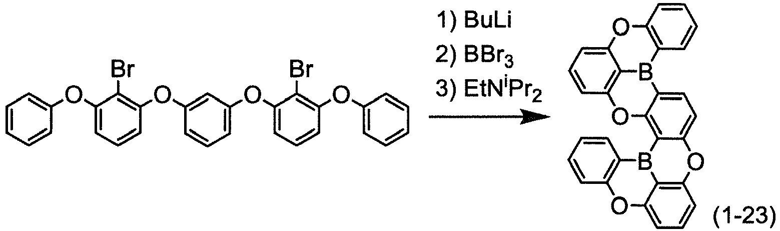

The structure of the compound represented by formula (1-24) was identified by an NMR analysis.
¹H NMR (δ ppm in CDCl₃) ; 10.13 (s, 1H), 8.92 (dd, J = 1.6, 8.0 Hz, 2H), 7.82 (t, J = 8.0 Hz, 2H), 7.78 (ddd, J = 1.6, 6.8, 8.0 Hz, 2H), 7.62 (d, J = 7.6 Hz, 4H), 7.51 - 7.54 (m, 4H), 6.98 (s, 1H).
LRMS (EI+) m/z 462 (M⁺)

The structure of the compound represented by formula (1-23) was identified by an NMR analysis.
¹H NMR (δ ppm in DMSO - D6); 8.92 (d, J = 8.8 Hz, 1H), 8.77 (dd, J = 1.6, 7.6 Hz, 1H), 8.57 (d, J = 8.4 Hz, 1H), 7.93 (t, J = 8.0 Hz, 1H), 7.81 (ddd, J = 1.6, 7.2, 8.4 Hz, 1H), 7.67 (t, J = 8.0 Hz, 1H), 7.58 - 7.63 (m, 2H), 7.47 - 7.50 (m, 3H), 7.35 (dd, J = 1.6, 8.4 Hz, 1H), 7.31 (t, J = 8.0 Hz, 1H), 7.28 (d, J = 8.4 Hz, 1H), 7.19 (t, J = 8.0 Hz, 2H).
LRMS (EI+) m/z 462 (M⁺)

### Synthesis Example (49)

### Synthesis of 4-(5,9-dioxa-13b-boranaphtho[3,2,1-de]anthracen-7-yl)-N,N-d iphenylaniline

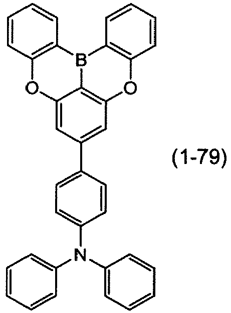

In a nitrogen atmosphere, a flask containing ((5-bromo-1,3-phenylene)bis(oxy))dibenzene (5.0 g), N,N-diphenyl-4-(4,4,5,5-tetramethyl-1,3,2-dioxaborolan-2-yl ) aniline (5.7 g), Pd-132 (0.31 g), potassium carbonate (4.1 g), tetrabutylammonium bromide (TBAB) (0.24 g), toluene (40 ml), and water (5 ml) was heated to a reflux temperature and then was stirred for 4 hours. The reaction liquid was cooled to room temperature, subsequently water and toluene were added thereto, the reaction liquid was thereby partitioned, and the solvent was distilled off under reduced pressure. A solid thus obtained was dissolved in toluene and was subjected to a silica gel short pass column. The solution was further purified by silica gel column chromatography (developing liquid: toluene/heptane = 1/2 (volume ratio), and thereby 3,5-diphenoxy-N,N-diphenyl-[1,1'-biphenyl]-4-amine (7.2 g) was obtained.

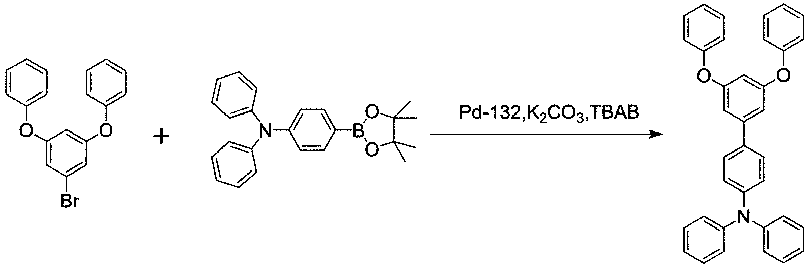

A 1.6 M n-butyllithium hexane solution (9.8 ml) was introduced into a flask containing 3,5-diphenoxy-N,N-diphenyl-[1,1'-biphenyl]-4-amine (7.2 g) and xylene (72 ml) at 0°C in a nitrogen atmosphere. After completion of dropwise addition, the temperature was increased to 70°C, and the mixture was stirred for 3 hours. Subsequently, components having boiling points that were lower than that of xylene were distilled off under reduced pressure. The residue was cooled to -30°C, boron tribromide (1.6 ml) was added thereto, the temperature was increased to room temperature, and the mixture was stirred for 30 minutes. Subsequently, the mixture was cooled again to 0°C, N,N-diisopropylethylamine (5.0 ml) was added thereto, and the mixture was stirred at room temperature until heat generation was settled. Subsequently, the mixture was heated and stirred for 2 hours at 120°C. The reaction liquid was cooled to room temperature, water and toluene were added thereto, and then the reaction liquid was partitioned. Subsequently, the solvent was distilled off under reduced pressure. A solid thus obtained was dissolved in toluene and was subjected to a silica gel short pass column. Subsequently, the solution was purified by silica gel column chromatography (developing liquid: toluene/heptane = 1/4 (volume ratio)), reprecipitation was carried out by adding heptane thereto, and thus a compound (1.5 g) represented by formula (1-79) was obtained.

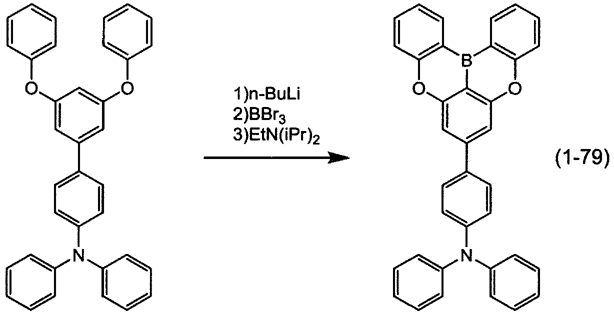

The structure of the compound thus obtained was identified by an NMR analysis.
¹H-NMR (400 MHz, CDCl₃): δ = 8.70 (dd, 2 H), 7.72 (t, 2H), 7.66 (d, 2H), 7.56 (d, 2H), 7.46 (s, 2H), 7.40 (t, 2H), 7.30 (t, 4H), 7.19 (m, 6H), 7.08 (t, 2H).

### Synthesis Example (50)

### Synthesis of 4-(5,9-dioxa-13b-boranaphtho[3,2,1-de]anthracen-7-yl)-N,N-d iphenylnaphthalene-1-amine

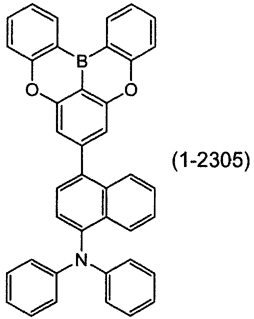

In a nitrogen atmosphere, a flask containing 4-bromo-N,N-diphenylnaphthalene-1-amine (30.0 g), bispinacolatodiboron (24.4 g), (1,1'-bis(diphenylphosphino)ferrocene)dichloropalladium(II) (PdCl₂ (dppf) · CH₂Cl₂) (2.0 g), potassium acetate (23.6 g), and cyclopentyl methyl ether (300 ml) was heated to a reflux temperature and then was stirred for 4 hours. The reaction liquid was cooled to room temperature, subsequently water and ethyl acetate were added thereto, and then the reaction liquid was partitioned. The solvent was distilled off under reduced pressure. A solid thus obtained was dissolved in toluene and was subjected to an activated carbon short pass column. Reprecipitation was further carried out by adding heptane thereto, and thus N,N-diphenyl-4-(4,4,5,5-tetramethyl-1,3,2-dioxaborolan-2-yl )naphthalene-1-amine (33.0 g) was obtained.

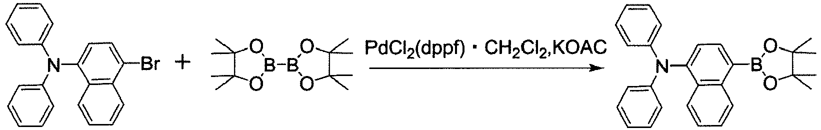

In a nitrogen atmosphere, a flask containing ((5-bromo-1,3-phenylene)bis(oxy))dibenzene (5.0 g), N,N-diphenyl-4-(4,4,5,5-tetramethyl-1,3,2-dioxaborolan-2-yl )naphthalene-1-amine (7.4 g), Pd-132 (0.31 g), potassium carbonate (4.1 g), tetrabutylammonium bromide (TBAB) (0.24 g), toluene (40 ml), and water (5 ml) was heated to a reflux temperature and then was stirred for 4 hours. The reaction liquid was cooled to room temperature, subsequently water and toluene were added thereto, and then the reaction liquid was partitioned. The solvent was distilled off under reduced pressure. A solid thus obtained was dissolved in toluene and was subjected to a silica gel short pass column. The solution was further purified by silica gel column chromatography (developing liquid: toluene/heptane = 1/2 (volume ratio)), and thus 4-(3,5-diphenoxy-N,N-diphenylnaphthalene-1-amine (7.7 g) was obtained.

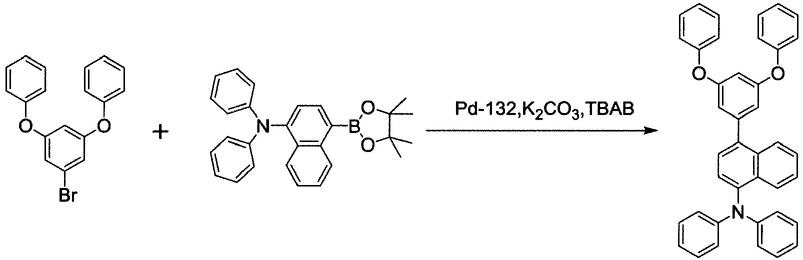

A 1.6 M n-butyllithium hexane solution (8.7 ml) was introduced into a flask containing 4-(3,5-diphenoxy)-N,N-diphenylnaphthalene-1-amine (7.0 g) and xylene (105 ml) at 0°C in a nitrogen atmosphere. After completion of dropwise addition, the temperature was increased to 70°C, the mixture was stirred for 3 hours, and then components having boiling points that were lower than that of xylene were distilled off under reduced pressure. The residue was cooled to -30°C, boron tribromide (1.4 ml) was added thereto, the temperature was increased to room temperature, and the mixture was stirred for 30 minutes. Thereafter, the mixture was cooled again to 0°C, N,N-diisopropylethylamine (5.3 ml) was added thereto, and the mixture was stirred at room temperature until heat generation was settled. Subsequently, the mixture was heated and stirred for 2 hours at 120°C. The reaction liquid was cooled to room temperature, water and toluene were added thereto, and then the reaction liquid was partitioned. Subsequently, the solvent was distilled off under reduced pressure. A solid thus obtained was dissolved in toluene and was subjected to a silica gel short pass column. Subsequently, the solution was purified by silica gel column chromatography (developing liquid: toluene/heptane = 1/4 (volume ratio)), and reprecipitation was further carried out by adding heptane thereto. Thus, a compound (0.9 g) represented by formula (1-2305) was obtained.

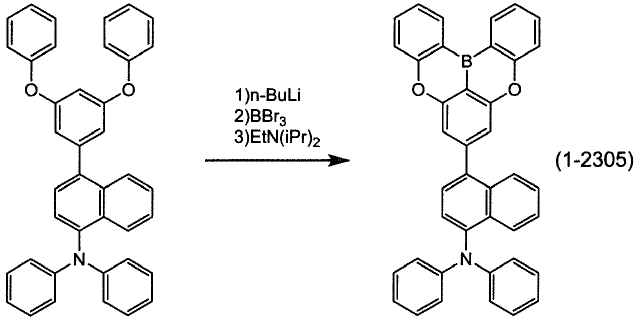

The structure of the compound thus obtained was identified by an NMR analysis.
¹H-NMR (400 MHz, CDCl₃): δ = 8.73 (dd, 2H), 8.08 (m, 2H), 7.73 (t, 2H), 7.57 (d, 2H), 7.54 (d, 1H), 7.37 - 6.46 (m, 7H), 7.24 (m, 4H), 7.11 (d, 4H), 6.97 (t, 2H) .

### Synthesis Example (51)

### Synthesis of 4-(5,9-dioxa-13b-boranaphtho[3,2,1-de]anthracen-6-yl)-N,N-d iphenylaniline

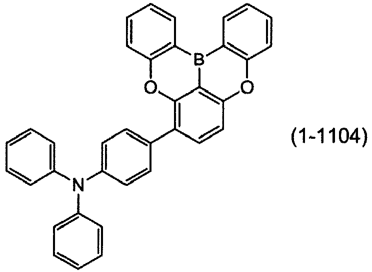

In a nitrogen atmosphere, a flask containing 5,9-dioxa-13b-boranaphtho[3,2,1-de]anthracene (9.0 g), N-bromosuccinimide (6.5 g) and THF (180 ml) was stirred for 3 hours at room temperature. The reaction liquid was cooled to room temperature, subsequently salts were dissolved by adding water thereto, and an intended product was collected by suction filtration. The product was further washed with methanol, and thus a mixture (10.9 g) of a bromo-form and a dibromo-form of 5,9-dioxa-13b-boranaphtho[3,2,1-de]anthracene was obtained.

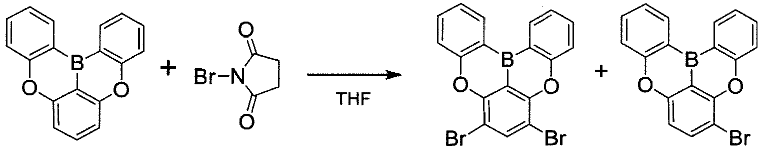

In a nitrogen atmosphere, a flask containing a mixture of a bromo-form and a dibromo-form of 5,9-dioxa-13b-boranaphtho[3,2,1-de]anthracene (2.0 g), N,N-diphenyl-4-(4,4,5,5-tetramethyl-1,3,2-dioxaborolan-2-yl )aniline (2.1 g), Pd-132 (0.12 g), potassium carbonate (1.6 g), tetrabutylammonium bromide (TBAB) (0.09 g), toluene (24 ml) and water (4 ml) was heated to a reflux temperature and then was stirred for 5 hours. The reaction liquid was cooled to room temperature, subsequently water and toluene were added thereto, and then the reaction liquid was partitioned. The solvent was distilled off under reduced pressure. A solid thus obtained was dissolved in toluene and was subjected to a silica gel short pass column. Subsequently, the solution was purified by silica gel column chromatography (developing liquid: toluene/heptane = 1/4 (volume ratio)) and was recrystallized from toluene. Thus, a compound (0.9 g) represented by formula (1-1104) was obtained.

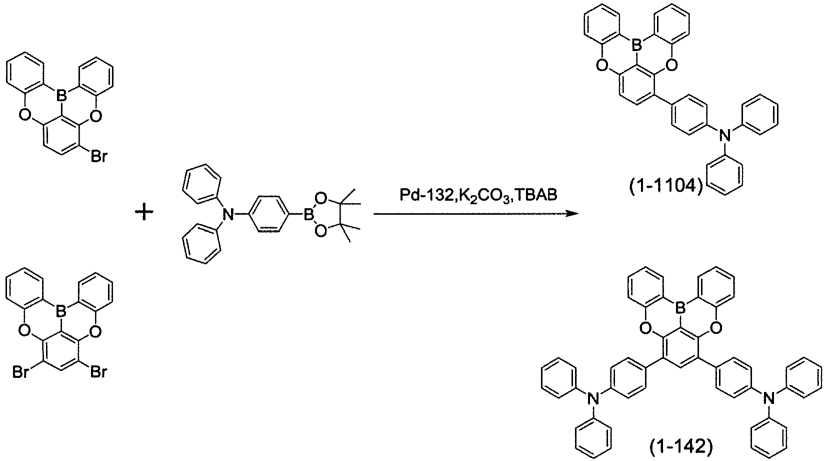

The structure of the compound thus obtained was identified by an NMR analysis.
¹H-NMR (400 MHz, CDCl₃): δ = 8.72 (m, 2H), 7.91 (d, 1H), 7.65 - 7.75 (m, 4H), 7.57 (d, 1H), 7.50 (d, 1H), 7.39 (m, 2H), 7.30 (m, 5H), 7.22 (m, 6H), 7.25 (t, 2H).

### Synthesis Example (52)

### Synthesis of 4,4'-(5,9-dioxa-13b-boranaphtho[3,2,1-de]anthracene-6,8-diy 1)bis(N,N-diphenylaniline)

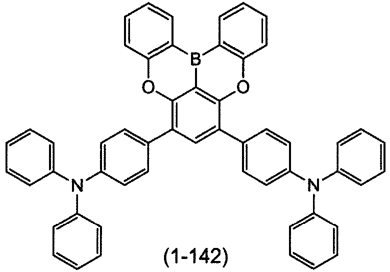

In regard to the above-described Synthesis Example (51), the solution was purified by silica gel column chromatography (developing liquid: toluene/heptane = 1/4 (volume ratio)), a band corresponding to the relevant compound was preparatively separated, and the separated fraction was recrystallized from toluene. Thus, a compound (0.2 g) represented by formula (1-142) was obtained.

The structure of the compound thus obtained was identified by an NMR analysis.
¹H-NMR (400 MHz, CDCl₃): δ = 8.73 (d, 2H), 8.01 (s, 1H), 7.70 (m, 6H), 7.52 (d, 2H), 7.40 (t, 2H), 7.19 - 7.35 (m, 20H), 7.06 (t, 4H).

### Synthesis Example (53)

### Synthesis of 2,12-di(9H-carbazolyl-9-yl)-5,9-dioxa-13b-boranaphtho[3,2,1 -de]anthracene

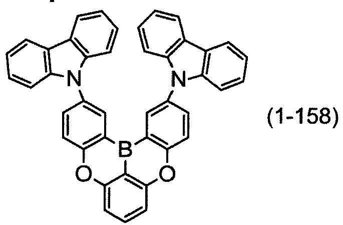

In a nitrogen atmosphere, a flask containing 9-(4-bromophenyl)-9H-carbazole (109.7 g), resorcinol (15.0 g), copper iodide (2.6 g), Fe(acac)₃ (57.7 g), potassium carbonate (75.3 g) and NMP (150 ml) was heated and stirred for 56 hours at 130°C. The reaction liquid was cooled to room temperature, ethyl acetate was added thereto, and then filtration was performed using a Kiriyama funnel having the bottom covered with Celite, so as to remove a solid fraction. Water was added to the filtrate, the filtrate was partitioned, and then the resultant was purified by silica gel column chromatography (developing liquid: toluene/heptane = 1/10 (volume ratio)). The purification product was further recrystallized from a toluene/heptane mixed solvent, and thus 1,3-bis(4-(9H-carbazol-9-yl)phenoxy)benzene (15.0 g) was obtained.

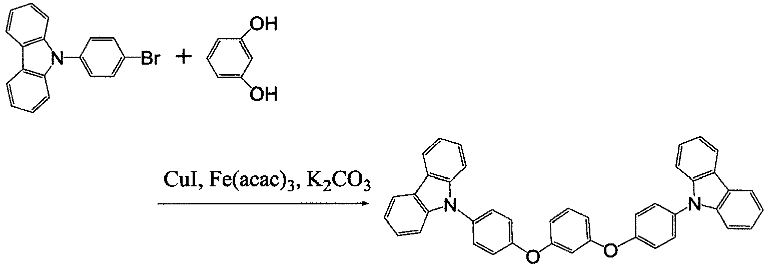

A 1.6 M n-butyllithium hexane solution (16.0 ml) was introduced into a flask containing 1,3-bis(4-(9H-carbazol-9-yl)phenoxy)benzene (13.5 g) and xylene (105 ml) at 0°C in a nitrogen atmosphere. After completion of dropwise addition, the temperature was increased to 80°C, the mixture was stirred for 4 hours, and then components having boiling points that were lower than that of xylene were distilled off under reduced pressure. The residue was cooled to -60°C, boron tribromide (2.6 ml) was added thereto, the temperature of the mixture was increased to room temperature, and the mixture was stirred for 30 minutes. Thereafter, the mixture was cooled again to 0°C, N,N-diisopropylethylamine (7.9 ml) was added thereto, and the mixture was stirred at room temperature until heat generation was settled. Subsequently, the mixture was heated and stirred for 3 hours at 120°C. The reaction liquid was cooled to room temperature, an aqueous solution of potassium acetate and heptane were added thereto, and then suction filtration was performed. A solid thus obtained was washed with water and then with SOLMIX, and the solid was recrystallized from chlorobenzene. Thus, a compound (5.6 g) represented by formula (1-158) was obtained.

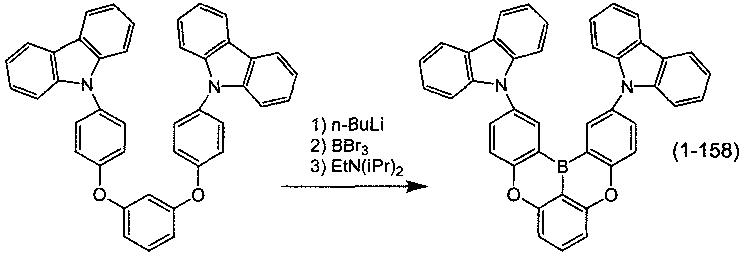

The structure of the compound thus obtained was identified by an NMR analysis.
¹H-NMR (400 MHz, CDCl₃): δ = 8.68 (m, 2H), 8.06 (m, 4H), 7.92 (t, 1H), 7.89 (dd, 2H), 7.80 (d, 2H), 7.38 (m, 6H), 7.20 (m, 8H).

### Synthesis Example (54)

### Synthesis of 3,11-di(9H-carbazolyl-9-yl)-5,9-dioxa-13b-boranaphtho[3,2,1 -de]anthracene

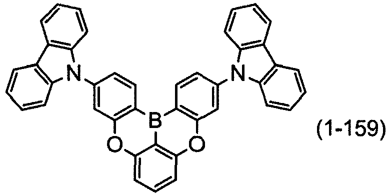

In a nitrogen atmosphere, a flask containing 9-(3-bromophenyl)-9H-carbazole (131.7 g), resorcinol (15.0 g), copper iodide (2.6 g), Fe(acac)₃ (115.4 g), potassium carbonate (75.3 g) and NMP (350 ml) was heated and stirred for 30 hours at 130°C. The reaction liquid was cooled to room temperature, water and ethyl acetate were added thereto, and then filtration was performed using a Kiriyama funnel having the bottom covered with Celite, so as to remove a solid fraction. Water was added to the filtrate, the filtrate was partitioned, and then the resultant was purified by silica gel column chromatography (developing liquid: toluene/heptane = 1/10 (volume ratio)). Thus, 1,3-bis(3-(9H-carbazol-9-yl)phenoxy)benzene (11.6 g) was obtained.

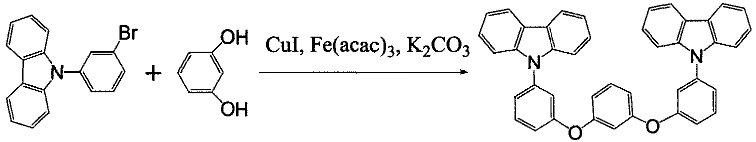

A 1.6 M n-butyllithium hexane solution (13.5 ml) was introduced into a flask containing 1,3-bis(3-(9H-carbazol-9-yl)phenoxy)benzene (11.6 g) and xylene (100 ml) at 0°C in a nitrogen atmosphere. After completion of dropwise addition, the temperature was increased to 80°C, the mixture was stirred for 4 hours, and then components having boiling points that were lower than that of xylene were distilled off under reduced pressure. The residue was cooled to -60°C, boron tribromide (2.2 ml) was added thereto, the temperature of the mixture was increased to room temperature, and the mixture was stirred for 30 minutes. Thereafter, the mixture was cooled again to 0°C, N,N-diisopropylethylamine (6.8 ml) was added thereto, and the mixture was stirred at room temperature until heat generation was settled. Subsequently, the mixture was heated and stirred for 3 hours at 120°C. The reaction liquid was cooled to room temperature, an aqueous solution of potassium acetate and heptane were added thereto, and suction filtration was performed. A solid thus obtained was washed with water and then with SOLMIX, and the solid was recrystallized from chlorobenzene. Thus, a compound (3.0 g) represented by formula (1-159) was obtained.

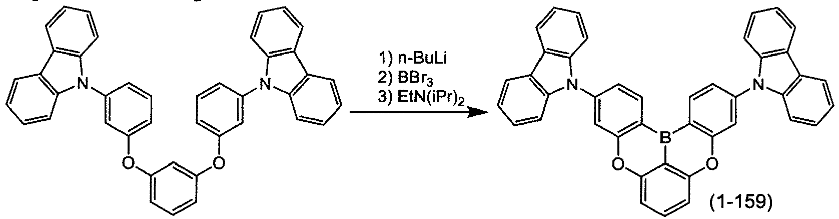

The structure of the compound thus obtained was identified by an NMR analysis.
¹H-NMR (400 MHz, CDCl₃): δ = 8.96 (d, 2H), 8.19 (d, 4H), 7.87 (m, 3H), 7.70 (m, 6H), 7.49 (t, 4H), 7.36 (t, 4H), 7.33 (d, 2H).

### Synthesis Example (55)

### Synthesis of 3,11-di-o-tolyl-(5,9-dioxa-13b-boranaphtho[3,2,1-de]anthrac ene

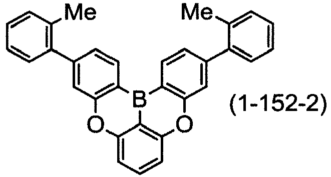

A flask containing 3-iodophenol (25.0 g), ortho-tolylboric acid (18.5 g), Pd(PPh₃)₄ (3.9 g), potassium carbonate (47.1 g), toluene (150 ml), t-butanol (30 ml) and water (10 ml) was heated and stirred for 1 hour at a reflux temperature. The reaction liquid was cooled to room temperature, subsequently toluene was added thereto, and suction filtration was performed so as to remove inorganic salts . Dilute hydrochloric acid was added to the filtrate, the mixture was partitioned, and then the mixture was purified using an activated carbon short pass column (developing liquid: toluene) . The residue was further purified by silica gel column chromatography (developing liquid: toluene/ethyl acetate = 1/1 (volume ratio)), and thus 2'-methyl-[1,1'-biphenyl-3-ol (14.8 g) was obtained.

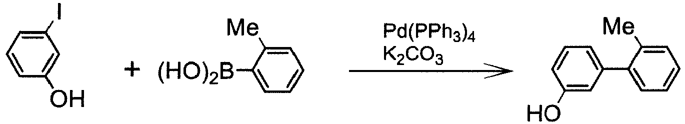

Copper (I) iodide (0.4 g) and iron(III) acetylacetonate (1.5 g) were added to a NMP (30 ml) solution of 1,3-dibromobenzene (10.0 g), 2'-methyl-[1,1'-biphenyl]-3-ol (18.0 g) and potassium carbonate (23.4 g) in a nitrogen atmosphere, the temperature was increased to 200°C, and then the mixture was stirred for 6 hours. The reaction liquid was cooled to room temperature, NMP was distilled off under reduced pressure, subsequently water and toluene were added thereto, and the mixture was partitioned. Subsequently, the resultant was purified by silica gel column chromatography (developing liquid: toluene/heptane = 1/5 (volume ratio)), and thus 1,3-bis(2'-methyl-[1,1'-biphenyl]-3-yl)oxy)benzene (8.4 g) was obtained.

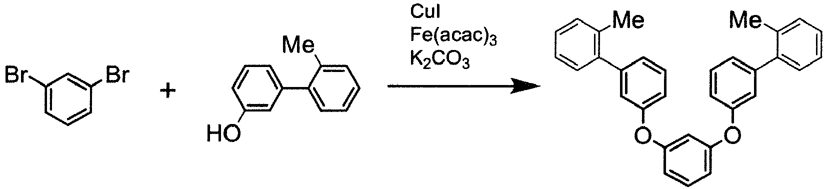

A 1.6 M n-butyllithium hexane solution (13.1 ml) was added to a flask containing 1,3-bis(2'-methyl-[1,1'-biphenyl]-3-yl)oxy)benzene (8.4 g) and xylene (50 ml) at 0°C in a nitrogen atmosphere. After completion of dropwise addition, the temperature was increased to 70°C, the mixture was stirred for 3 hours, and then components having boiling points that were lower than that of xylene were distilled off under reduced pressure. The residue was cooled to -50°C, boron tribromide (2.2 ml) was added thereto, the temperature of the mixture was increased to room temperature, and the mixture was stirred for 0.5 hours. Thereafter, the mixture was cooled again to 0°C, N,N-diisopropylethylamine (6.6 ml) was added thereto, and the mixture was stirred at room temperature until heat generation was settled. Subsequently, the temperature was increased to 130°C, and the mixture was heated and stirred for 3 hours. The reaction liquid was cooled to room temperature, and a solid generated by adding an aqueous solution of sodium acetate that had been cooled by means of an ice bath, and then heptane to the reaction liquid, was collected by suction filtration. The solid thus obtained was washed with heptane and was further recrystallized from toluene. Thus, a compound (1.0 g) represented by formula (1-152-2) was obtained.

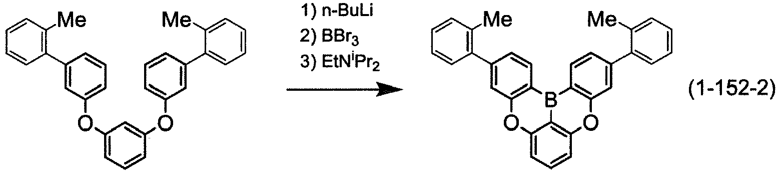

The structure of the compound thus obtained was identified by an NMR analysis.
¹H-NMR (400 MHz, CDCl₃): δ = 8.75 (d, 2H), 7.81 (t, 1H), 7.54 (m, 2H), 7.28 - 7.40 (m, 8H), 7.25 (m, 4H), 2.39 (s, 6H).

### Synthesis Example (56)

### Synthesis of 5,9-dioxa-19b-boranadibenzo[a,c]naphtha[1,2,3-hi]tetracene

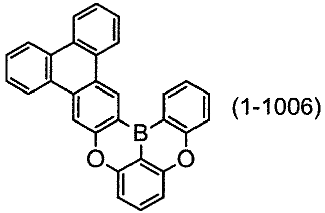

Copper(I) iodide (0.8 g) and iron(III) acetylacetonate (5.8) were added to a NMP (150 ml) solution of 2-bromotriphenylene (25.0 g), 3-phenoxyphenol (19.7 g) and potassium carbonate (45.0 g) in a nitrogen atmosphere, and the mixture was heated and stirred for 6 hours at 180°C. NMP was distilled off under reduced pressure, subsequently water and toluene were added thereto, and the mixture was partitioned. Subsequently, the resultant was purified by silica gel column chromatography (developing liquid: toluene/heptane = 1/5 (volume ratio)), and thus 2-(3-phenoxyphenoxy)triphenylene (23.3 g) was obtained.

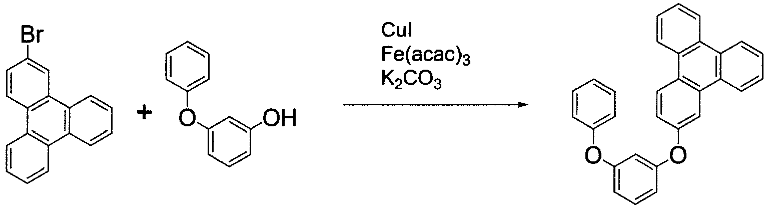

A 1.6 M n-butyllithium hexane solution (38.8 ml) was introduced into a flask containing 2- (3-phenoxyphenoxy) triphenylene (23.3 g) and xylene (200 ml) at 0°C in a nitrogen atmosphere. After completion of dropwise addition, the temperature was increased to 70°C, the mixture was stirred for 3 hours, and then components having boiling points that were lower than that of xylene were distilled off under reduced pressure. The residue was cooled to -50°C, boron tribromide (11.6 ml) was added thereto, the temperature was increased to room temperature, and the mixture was stirred for 0.5 hours. Thereafter, the mixture was cooled again to 0°C, N,N-diisopropylethylamine (19.3 ml) was added thereto, and the mixture was stirred at room temperature until heat generation was settled. Subsequently, the temperature was increased to 130°C, and then the mixture was heated and stirred for 3 hours. The reaction liquid was cooled to room temperature, and a solid generated by adding an aqueous solution of sodium acetate that had been cooled by means of an ice bath was collected by suction filtration. The solid thus obtained was recrystallized from an ortho-dichlorobenzene solution of the solid, and thus a compound (4.8 g) represented by formula (1-1006) was obtained.

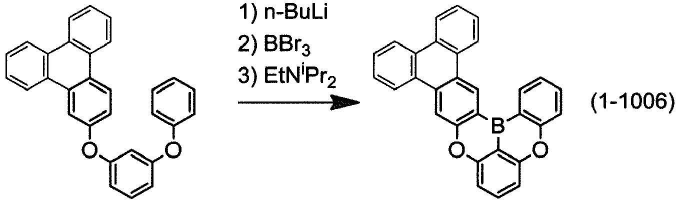

The structure of the compound thus obtained was identified by an NMR analysis.
¹H-NMR (400 MHz, CDCl₃): δ = 10.00 (s, 1H), 8.97 (d, 1H), 8.86 (d, 1H), 8.75 (d, 1H), 8.72 (s, 1H), 8.67 (m, 2H), 7.86 (t, 1H), 7.67 - 7.83 (m, 5H), 7.63 (d, 1H), 7.56 (t, 1H), 7.31 (d, 1H), 7.28 (d, 1H).

### Synthesis Examples (64) and (65)

### Synthesis of 3,7-diphenyl-3,7-dihydro-3,7-diaza-11b-boranaphtho[3,2,1-no ]tetraphene

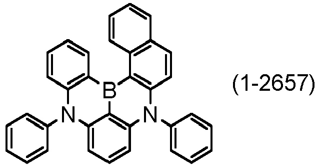

### Synthesis of 9-(naphthalen-2-yl)-5-phenyl-5,9-dihydro-5,9-diaza-13b-bora naphtho[3,2,1-de]anthracene

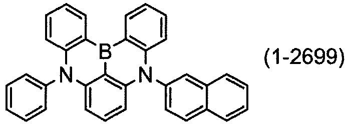

In a nitrogen atmosphere, a flask containing 2,3-dichloro-N,N-diphenylaniline (15.0 g), N-phenylnaphthalene-1-amine (10.0 g), Pd-132 (0.3 g), NaOtBu (6.9 g) and xylene (100 ml) was heated and stirred for 1 hour at 120°C. The reaction liquid was cooled to room temperature, subsequently water and ethyl acetate were added thereto, and then the mixture was partitioned. Subsequently, the resultant was purified using a silica gel short pass column (developing liquid: toluene/heptane = 1/1 (volume ratio)), and was further reprecipitated with a heptane solvent. Thus, 2-chloro-N¹-(naphthalen-2-yl)-N¹,N³,N³-triphenylbenzene-1,3-diamine (18.0 g) was obtained.

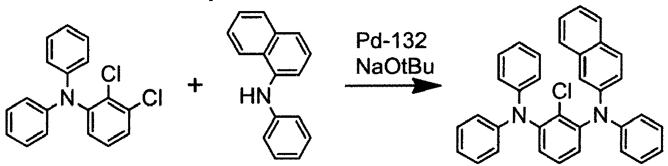

A 1.6 M t-butyllithium pentane solution (45.3 ml) was introduced into a flask containing 2-chloro-N¹-(naphthalen-2-yl)-N¹,N³,N³-triphenylbenzene-1,3-diamine (18.0 g) and t-butylbenzene (150 ml) in a nitrogen atmosphere, while the flask was cooled in an ice bath. After completion of dropwise addition, the temperature was increased to 60°C, the mixture was stirred for 2 hours, and then the components having boiling points that were lower than that of t-butylbenzene were distilled off under reduced pressure. The residue was cooled to -50°C, boron tribromide (6.8 ml) was added thereto, the temperature of the mixture was increased to room temperature, and the mixture was stirred for 0.5 hours. Thereafter, the mixture was cooled again in an ice bath, and N,N-diisopropylethylamine (12.5 ml) was added thereto. The mixture was stirred at room temperature until heat generation was settled, subsequently the temperature of the mixture was increased to 120°C, and the mixture was heated and stirred for 1 hour. The reaction liquid was cooled to room temperature, an aqueous solution of sodium acetate that had been cooled in an ice bath and then ethyl acetate were added thereto, and the mixture was partitioned. Subsequently, the resultant was purified by silica gel column chromatography (developing liquid: toluene/heptane = 3/7). The purification product was further washed with hot heptane, and then was reprecipitated with a toluene/ethyl acetate mixed solution. Thus, a compound (3.2 g) represented by formula (1-2657) was obtained. Furthermore, this reprecipitated liquid was purified by activated carbon column chromatography (developing liquid: toluene/heptane = 1/1), and then was reprecipitated with a heptane/ethyl acetate mixed solvent. Thus, a compound (0.1 g) represented by formula (1-2699) was obtained.

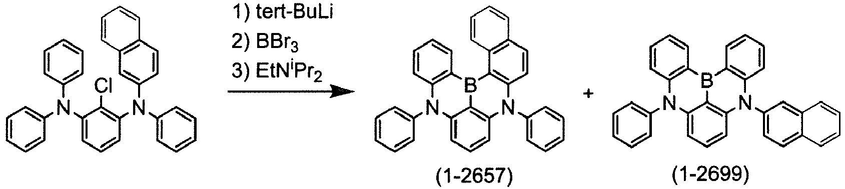

The structure of the compound (1-2657) thus obtained was identified by an NMR analysis.
¹H-NMR (400 MHz, CDCl₃): δ = 8.94 (m, 1H), 8.50 (d, 1H), 7.80 (m, 1H), 7.77 (d, 1H), 7.70 (m, 4H), 7.61 (m, 2H), 7.46 (m, 2H), 7.35 - 7.44 (m, 5H), 7.25 (m, 1H), 7.03 (t, 1H), 6.95 (d, 1H), 6.77 (d, 1H), 6.23 (d, 1H), 6.18 (d, 1H).

The structure of the compound (1-2699) thus obtained was identified by an NMR analysis.
¹H-NMR (400 MHz, CDCl₃): δ = 8.97 (m, 2H), 8.18 (d, 1H), 8.03 (d, 1H), 7.92 (m, 2H), 7.70 (t, 2H), 7.56 - 66 (m, 3H), 7.36 - 48 (m, 5H), 7.20 - 7.32 (m, 3H), 6.78 (t, 2H), 6.15 (m, 2H) .

### Synthesis Example (66)

### Synthesis of N³,N³,N¹¹,N¹¹,5,9-hexaphenyl-5,9-diaza-13b-boranaphtho[3,2,1-de]anthracene-3,11-diamine

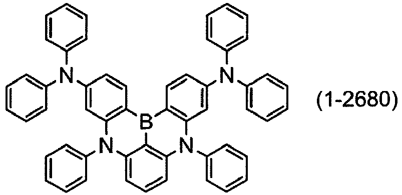

In a nitrogen atmosphere, a flask containing 3-nitroaniline (25.0 g), iodobenzene (81.0 g), copper iodide (3.5 g), potassium carbonate (100.0 g) and ortho-dichlorobenzene (250 ml) was heated and stirred for 14 hours at a reflux temperature. The reaction liquid was cooled to room temperature, subsequently aqueous ammonia was added thereto, and the mixture was partitioned. Subsequently, the resultant was purified by silica gel column chromatography (developing liquid: toluene/heptane =3/7 (volume ratio)), and thus 3-nitro-N,N-diphenylaniline (44.0 g) was obtained.

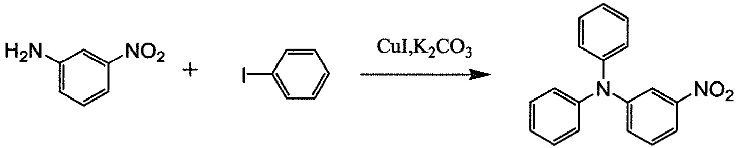

In a nitrogen atmosphere, acetic acid that had been cooled in an ice bath was added to the product, and the mixture was stirred. 3-Nitro-N,N-diphenylaniline (44.0 g) was added to this solution in divided portions such that the reaction temperature would not noticeably increase. After completion of the addition, the mixture was stirred for 30 minutes at room temperature, and any loss of the raw material was checked. After completion of the reaction, a supernatant was collected by decantation and was neutralized with sodium carbonate, and the resultant was extracted with ethyl acetate. Subsequently, the extract was purified by silica gel column chromatography (developing liquid: toluene/heptane = 9/1 (volume ratio)). A fraction containing an intended product was reprecipitated by distilling off the solvent under reduced pressure and adding heptane thereto. Thus, N¹,N¹-diphenylbenzene-1,3-diamine (36.0 g)was obtained.

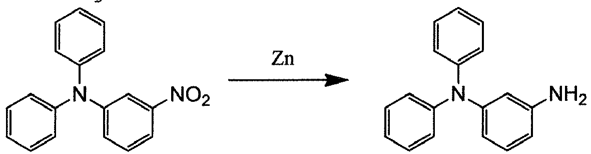

In a nitrogen atmosphere, a flask containing N1,N1-diphenylbenzene-1,3-diamine (60.0 g), Pd-132 (1.3 g), NaOtBu (33.5 g) and xylene (300 ml) was heated and stirred at 120°C. To this solution, a xylene (50 ml) solution of bromobenzene (36.2 g) was slowly added dropwise, and after completion of the dropwise addition, the mixture was heated and stirred for 1 hour. The reaction liquid was cooled to room temperature, subsequently water and ethyl acetate were added thereto, and the mixture was partitioned. Subsequently, the resultant was purified by silica gel column chromatography (developing liquid: toluene/heptane = 5/5 (volume ratio)), and thus N¹,N¹,N³-triphenylbenzene-1,3-diamine (73.0 g) was obtained.

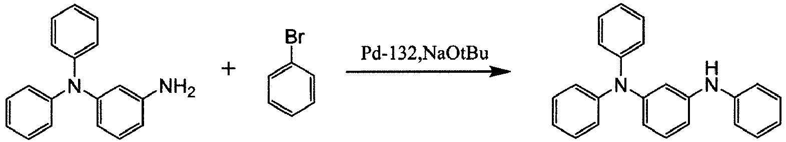

In a nitrogen atmosphere, a flask containing N¹,N¹,N³-triphenylbenzene-1,3-diamine (20.0 g), 1-bromo-2,3-dichlorobenzene (6.4 g), Pd-132 (0.2 g), NaOtBu (6.8 g) and xylene (70 ml) was heated and stirred for 2 hours at 120°C. The reaction liquid was cooled to room temperature, subsequently water and ethyl acetate were added thereto, and the mixture was partitioned. Subsequently, the resultant was purified by silica gel column chromatography (developing liquid: toluene/heptane = 4/6 (volume ratio)), and thus N¹,N^{1'}-(2-chloro-1,3-phenylene)bis(N¹,N³,N³-triphenylbenzene-1,3-diamine) (15.0 g) was obtained.

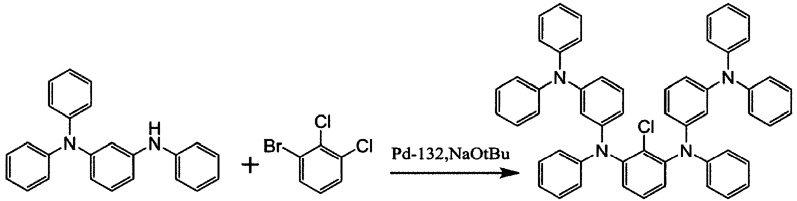

A 1.7 M t-butyllithium pentane solution (18.1 ml) was introduced into a flask containing N1,N1'-(2-chloro-1,3-phenylene)bis(N1,N3,N3-triphenylbenzen e-1,3-diamine) (12.0 g) and t-butylbenzene (100 ml) in a nitrogen atmosphere, while the flask was cooled in an ice bath. After completion of dropwise addition, the temperature was increased to 60°C, the mixture was stirred for 2 hours, and then components having boiling points that were lower than that of t-butylbenzene were distilled off under reduced pressure. The residue was cooled to -50°C, boron tribromide (2.9 ml) was added thereto, the temperature of the mixture was increased to room temperature, and the mixture was stirred for 0.5 hours. Thereafter, the mixture was cooled again in an ice bath, and N,N-diisopropylethylamine (5.4 ml) was added thereto. The mixture was stirred at room temperature until heat generation was settled, subsequently the temperature of the mixture was increased to 120°C, and the mixture was heated and stirred for 3 hours. The reaction liquid was cooled to room temperature, and an aqueous solution of sodium acetate that had been cooled in an ice bath and then ethyl acetate were added to the reaction liquid. An insoluble solid was separated by filtration, and then the liquid was partitioned. Subsequently, the resultant was purified by silica gel column chromatography (developing liquid: toluene/heptane = 5/5). The purification product was further washed with hot heptane and ethyl acetate, and then was reprecipitated with a toluene/ethyl acetate mixed solvent. Thus, a compound (2.0 g) represented by formula (1-2680) was obtained.

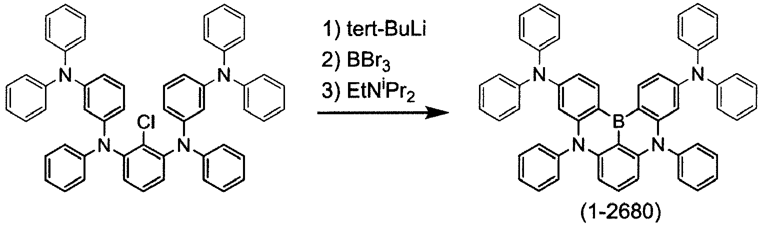

The structure of the compound thus obtained was identified by an NMR analysis.
¹H-NMR (400 MHz, CDCl₃): δ = 8.65 (d, 2H), 7.44 (t, 4H), 7.33 (t, 2H), 7.20 (m, 12H), 7.13 (t, 1H), 7.08 (m, 8H), 7.00 (t, 4H), 6.89 (dd, 2H), 6.16 (m, 2H), 6.03 (d, 2H).

### Synthesis Example (67)

### Synthesis of 9-([1,1'-biphenyl]-4-yl)-N,N,5,12-tetraphenyl-5,9-dihydro-5 ,9-diaza-13b-boranaphtho[3,2,1-de]anthracene-3-amine

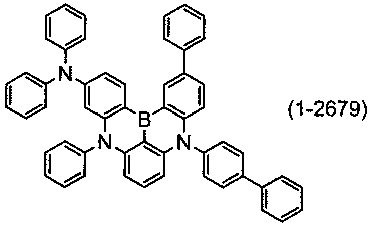

In a nitrogen atmosphere, a flask containing N¹,N¹,N³-triphenylbenzene-1,3-diamine (51.7 g), 1-bromo-2,3-dichlorobenzene (35.0 g), Pd-132 (0.6 g), NaOtBu (22.4 g) and xylene (350 ml) was heated and stirred for 2 hours at 90°C. The reaction liquid was cooled to room temperature, subsequently water and ethyl acetate were added thereto, and the mixture was partitioned. Subsequently, the resultant was purified by silica gel column chromatography (developing liquid: toluene/heptane = 5/5 (volume ratio)), and thus N¹-(2,3-dichlorophenyl)-N¹,N³,N³-triphenylbenzene-1,3-diamin e (61.8 g) was obtained.

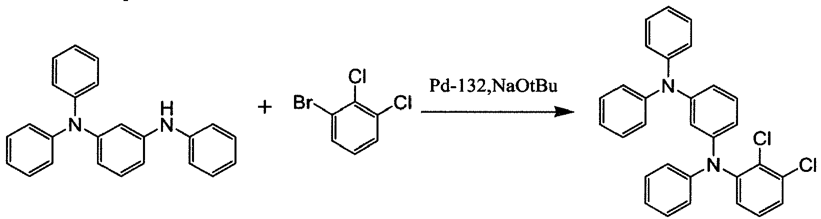

In a nitrogen atmosphere, a flask containing N¹-(2,3-dichlorophenyl)-N¹,N³,N³-triphenylbenzene-1,3-diamin e (15.0 g), di([1,1'-biphenyl]-4-yl)amine (10.0 g), Pd-132 (0.2 g), NaOtBu (4.5 g) and xylene (70 ml) was heated and stirred for 1 hour at 120°C. The reaction liquid was cooled to room temperature, subsequently water and toluene were added thereto, and the mixture was partitioned. Subsequently, the resultant was purified using a silica gel short pass column (developing liquid: toluene). An oily material thus obtained was reprecipitated with an ethyl acetate/heptane mixed solvent, and thus N¹,N¹-di([1,1'-biphenyl]-4-yl)-2chloro-N³-(3-(diphenylamino) phenyl)-N³-phenylbenzene-1,3-diamine (18.5 g) was obtained.

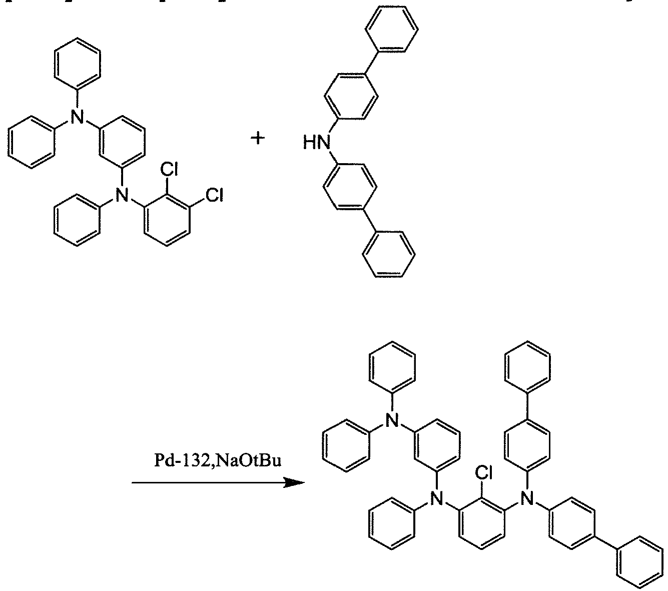

A 1.7 M t-butyllithium pentane solution (27.6 ml) was introduced into a flask containing N¹,N¹-di([1,1'-biphenyl]-4-yl)-2chloro-N³-(3-(diphenylamino) phenyl)-N³-phenylbenzene-1,3-diamine (18.0 g) and t-butylbenzene (130 ml) in a nitrogen atmosphere, while the flask was cooled in an ice bath. After completion of dropwise addition, the temperature was increased to 60°C, the mixture was stirred for 3 hours, and then components having boiling points that were lower than that of t-butylbenzene were distilled off under reduced pressure. The residue was cooled to -50°C, boron tribromide (4.5 ml) was added thereto, the temperature of the mixture was increased to room temperature, and the mixture was stirred for 0.5 hours. Thereafter, the mixture was cooled again in an ice bath, and N,N-diisopropylethylamine (8.2 ml) was added thereto. The mixture was stirred at room temperature until heat generation was settled, subsequently the temperature was increased to 120°C, and the mixture was heated and stirred for 1 hour. The reaction liquid was cooled to room temperature, an aqueous solution of sodium acetate that had been cooled in an ice bath and then ethyl acetate were added to the reaction liquid, and the mixture was partitioned. Subsequently, the resultant was dissolved in hot chlorobenzene and was purified using a silica gel short pass column (developing liquid: hot toluene). The purification product was further recrystallized from chlorobenzene, and thus a compound (3.0 g) represented by formula (1-2679) was obtained.

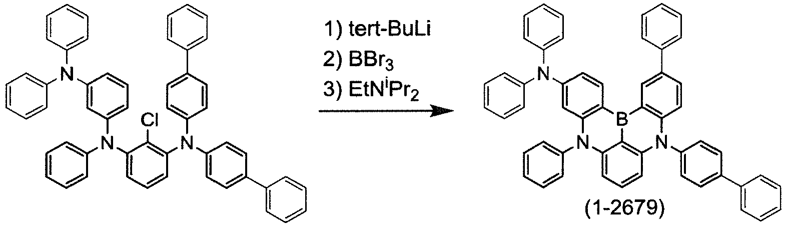

The structure of the compound thus obtained was identified by an NMR analysis.
¹H-NMR (400 MHz, CDCl₃): δ = 9.09 (m, 1H), 8.79 (d, 1H), 7.93 (d, 2H), 7.75 (d, 2H), 7.72 (d, 2H), 7.67 (m, 1H), 7.52 (t, 2H), 7.40 - 7.50 (m, 7H), 7.27 - 7.38 (m, 2H), 7.19 - 7.26 (m, 7H), 7.11 (m, 4H), 7.03 (t, 2H), 6.96 (dd, 1H), 6.90 (d, 1H), 6.21 (m, 2H), 6.12 (d, 1H).

### Synthesis Examples (68) and (69)

### Synthesis of N,N,5,9,11-pentaphenyl-9,11-dihydro-5H-5,9,11-triaza-16b-bo raindeno[2,1-b]naphtho[1,2,3-fg]anthracene-3-amine

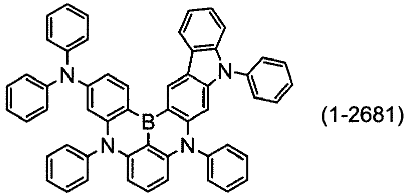

### Synthesis of N,N,5-triphenyl-9-(9-phenyl-9H-carbazol-2-yl)-5,9-dihydro-5 H-5,9-diaza-13b-boranaphtho[3,2,1-de]anthracene-3-amine

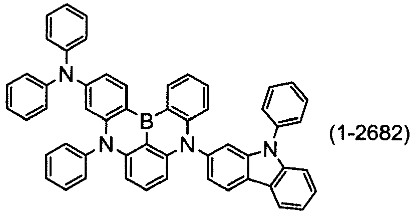

In a nitrogen atmosphere, a flask containing 2-bromo-9-phenyl-9H-carbazole (10.0 g), aniline (3.5 g), Pd-132 (0.2 g), NaOtBu (4.5 g) and xylene (100 ml) was heated and stirred for 4 hours at 120°C. The reaction liquid was cooled to room temperature, subsequently water and ethyl acetate were added thereto, and the mixture was partitioned. The organic layer was further washed with dilute hydrochloric acid, and unreacted aniline was removed. Subsequently, the resultant was purified by silica gel column chromatography (developing liquid: toluene/heptane = 4/6 (volume ratio)), and thus N,9-diphenyl-9H-carbazole-2-amine (10.4 g) was obtained.

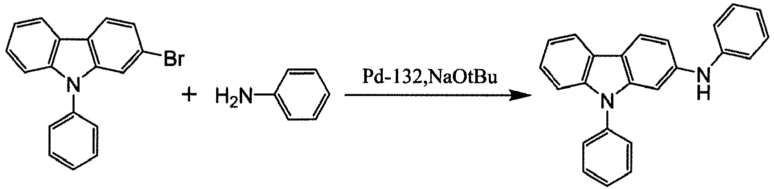

In a nitrogen atmosphere, a flask containing N¹-(2,3-dichlorophenyl)-N¹,N³,N³-triphenylbenzene-1,3-diamin e (14.0 g), N,9-diphenyl-9H-carbazole-2-amine (10.4 g), Pd-132 (0.2 g), NaOtBu (4.1 g) and xylene (90 ml) was heated and stirred for 1 hour at 120°C. The reaction liquid was cooled to room temperature, subsequently water and toluene were added thereto, and the mixture was partitioned. Subsequently, the resultant was purified by silica gel column chromatography (developing liquid: toluene/heptane = 4/6 (volume ratio)), and thus 2-chloro-N¹-(3-(diphenylamino)phenyl)-N¹,N³-diphenyl-N³-(9-p henyl-9H-carbazol-2-yl)benzene-1,3-diamine (18.5 g) was obtained.

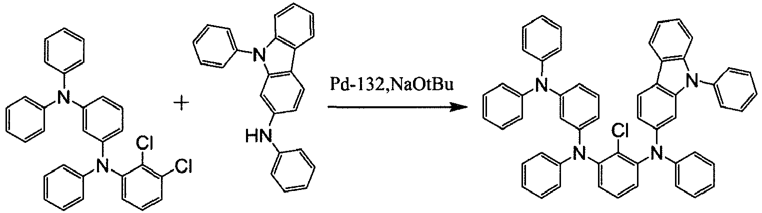

A 1.7 M t-butyllithium pentane solution (27.2 ml) was introduced into a flask containing 2-chloro-N¹-(3-(diphenylamino)phenyl)-N¹,N³-diphenyl-N³-(9-p henyl-9H-carbazol-2-yl)benzene-1,3-diamine (18.0 g) and t-butylbenzene (100 ml) in a nitrogen atmosphere, while the flask was cooled in an ice bath. After completion of dropwise addition, the temperature was increased to 60°C, the mixture was stirred for 3 hours, and then components having boiling points that were lower than that of t-butylbenzene were distilled off under reduced pressure. The residue was cooled to -50°C, boron tribromide (4.4 ml) was added thereto, the temperature of the mixture was increased to room temperature, and the mixture was stirred for 0.5 hours. Thereafter, the mixture was cooled again in an ice bath, and N,N-diisopropylethylamine (8.1 ml) was added thereto. The mixture was stirred at room temperature until heat generation was settled, subsequently the temperature of the mixture was increased to 120°C, and then the mixture was heated and stirred for 1 hour. The reaction liquid was cooled to room temperature, and a precipitate generated by adding an aqueous solution of sodium acetate that had been cooled in an ice bath and ethyl acetate thereto was collected by suction filtration. Subsequently, the precipitate was dissolved in hot chlorobenzene, and was purified using a silica gel short pass column (developing liquid: hot toluene). The purification product was washed with hot heptane, and then was reprecipitated using a chlorobenzene/ethyl acetate mixed solvent. Thus, a compound (3.0 g) represented by formula (1-2681) was obtained.

The reaction liquid was cooled to room temperature, and a filtrate obtained at the time of collecting a precipitated generated by adding an aqueous solution of sodium acetate that had been cooled in an ice bath and ethyl acetate thereto, was purified by activated carbon column chromatography (developing liquid: toluene/heptane = 5/5 (volume ratio)) and then by silica gel column chromatography (toluene/heptane = 4/6 (volume ratio)). The purification product was further reprecipitated using a heptane/ethyl acetate mixed solvent and then using a heptane/toluene mixed solvent, and thus a compound (0.6 g) represented by formula (1-2682) was obtained.

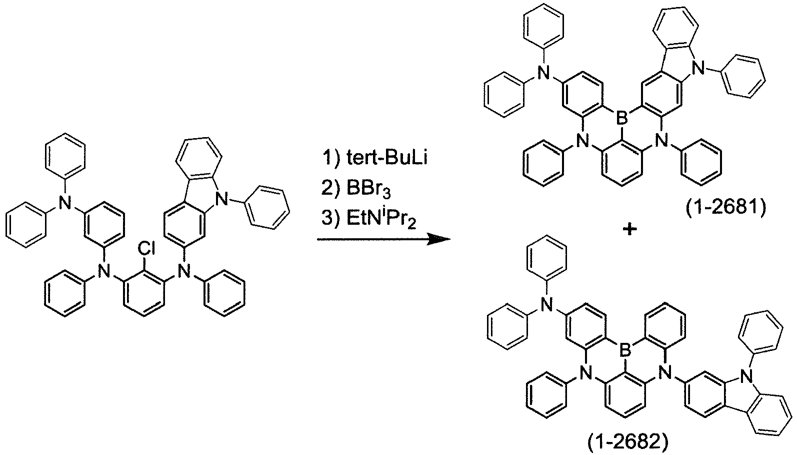

The structure of the compound (1-2681) thus obtained was identified by an NMR analysis.
¹H-NMR (400 MHz, CDCl₃): δ = 9.57 (s, 1H), 8.93 (d, 1H), 8.26 (d, 1H), 7.61 (t, 2H), 7.10 - 7.50 (m, 25H), 7.04 (m, 3H), 6.59 (s, 1H), 6.25 (m, 1H), 6.10 (t, 2H).

The structure of the compound (1-2682) thus obtained was identified by an NMR analysis.
¹H-NMR (400 MHz, CDCl₃): δ = 8.86 (d, 1H), 8.73 (d, 1H), 8.43 (d, 1H), 8.24 (d, 1H), 7.31 - 7.56 (m, 13H), 7.29 (dd, 1H), 7.12 - 24 (m, 8H), 7.10 (m, 4H), 7.02 (t, 2H), 6.94 (dd, 1H), 6.79 (d, 1H), 6.16 (m, 2H), 6.07 (d, 1H).

### Synthesis Example (70)

### Synthesis of 12-methyl-N,N,5-triphenyl-9-(p-tolyl)-5,9-dihydro-5,9-diaza -13b-boranaphtho[3,2,1-de]anthracene-3-amine

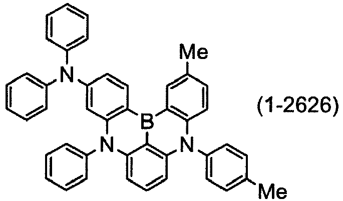

In a nitrogen atmosphere, a flask containing N¹-(2,3-dichlorophenyl)-N¹,N³,N³-triphenylbenzene-1,3-diamin e (15.0 g), di-p-tolylamine (6.1 g), Pd-132 (0.2 g), NaOtBu (4.5 g) and xylene (70 ml) was heated and stirred for 1 hour at 120°C. The reaction liquid was cooled to room temperature, subsequently water and ethyl acetate were added thereto, and the mixture was partitioned. Subsequently, the resultant was purified by silica gel column chromatography (developing liquid: toluene/heptane = 4/6 (volume ratio)). A fraction containing an intended product was reprecipitated by distilling off the solvent under reduced pressure, and thus 2-chloro-N¹-(3-(diphenylamino)phenyl)-N¹-phenyl-N³,N³-di-p-t olylbenzene-1,3-diamine (15.0 g) was obtained.

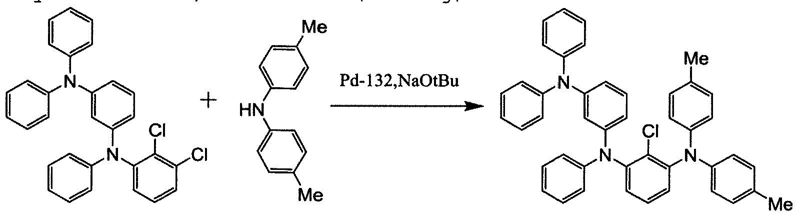

A 1.6 M t-butyllithium pentane solution (29.2 ml) was introduced into a flask containing 2-chloro-N¹-(3-(diphenylamino)phenyl)-N¹-phenyl-N³,N³-di-p-t olylbenzene-1,3-diamine (15.0 g) and t-butylbenzene (100 ml) in a nitrogen atmosphere, while the flask was cooled in an ice bath. After completion of dropwise addition, the temperature was increased to 60°C, the mixture was stirred for 2 hours, and then components having boiling points that were lower than that of t-butylbenzene were distilled off under reduced pressure. The residue was cooled to -50°C, boron tribromide (4.4 ml) was added thereto, the temperature of the mixture was increased to room temperature, and the mixture was stirred for 0.5 hours. Thereafter, the mixture was cooled again in an ice bath, and N,N-diisopropylethylamine (8.1 ml) was added thereto. The mixture was stirred at room temperature until heat generation was settled, subsequently the temperature of the mixture was increased to 120°C, and the mixture was heated and stirred for 2 hours. The reaction liquid was cooled to room temperature, an aqueous solution of sodium acetate that had been cooled in an ice bath and then ethyl acetate were added thereto, and the mixture was partitioned. Subsequently, the resultant was purified by silica gel column chromatography (developing liquid: toluene/heptane = 4/6). The purification product was further washed with hot heptane, and then was reprecipitated with a toluene/ethyl acetate mixed solvent. Thus, a compound (2.0 g) represented by formula (1-2626) was obtained.

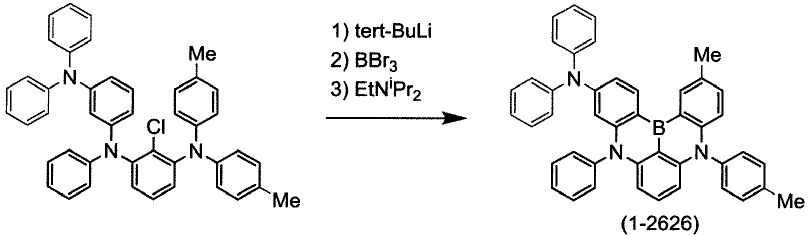

The structure of the compound thus obtained was identified by an NMR analysis.
¹H-NMR (400 MHz, CDCl₃): δ = 8.74 (d, 1H), 8.64 (m, 1H), 7.42 - 7.50 (m, 4H), 7.35 (t, 1H), 7.15 - 7.25 (m, 10H), 7.10 (d, 4H), 7.02 (t, 2H), 7.94 (dd, 1H), 6.68 (d, 1H), 6.20 (m, 1H), 6.11 (d, 1H), 6.04 (d, 1H), 2.52 (s, 3H), 2.48 (s, 3H).

### Synthesis Example (71)

### Synthesis of 5-([1,1'-biphenyl]-4-yl)-N,N,9-triphenyl-5,9-dihydro-5,9-di aza-13b-boranahtho[3,2,1-de]anthracene-3-amine

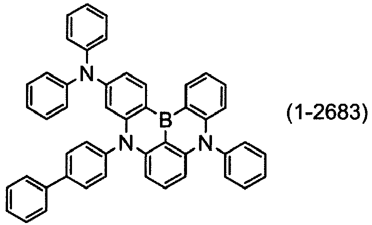

In a nitrogen atmosphere, a flask containing N¹,N¹-diphenylbenzene-1,3-diamine (12.0 g), 4-bromo-1,1'-biphenyl (30.2 g), Pd-132 (0.3 g), NaOtBu (6.6 g) and xylene (100 ml) was heated and stirred for 2 hours at 100°C. The reaction liquid was cooled to room temperature, subsequently water and ethyl acetate were added thereto, and the mixture was partitioned. Subsequently, the resultant was purified by silica gel column chromatography (developing liquid: toluene/heptane = 4/6 (volume ratio)). A solid obtained by distilling off the solvent under reduced pressure was washed with heptane, and thus N¹, ([1,1'-biphenyl]-4-yl)-N³,N³-diphenylbenzene-1,3-diamine (17.4 g) was obtained.

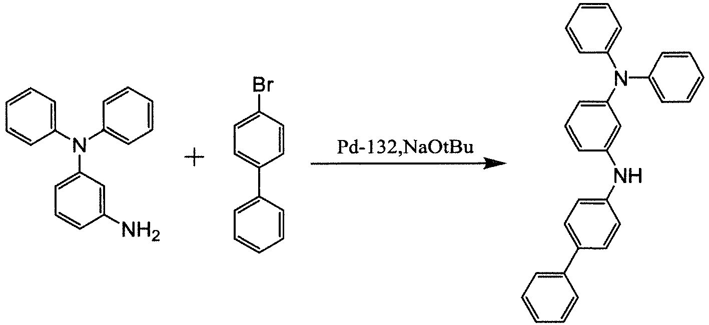

In a nitrogen atmosphere, a flask containing 2,3-dichloro-N,N-diphenylaniline (12.0 g), N¹,([1,1'-biphenyl]-4-yl)-N³,N³-diphenylbenzene-1,3-diamine (15.0 g), Pd-132 (0.3 g), NaOtBu (5.5 g) and xylene (100 ml) was heated and stirred for 1 hour at 120°C. The reaction liquid was cooled to room temperature, subsequently water and ethyl acetate were added thereto, and the mixture was partitioned. Subsequently, the resultant was purified by silica gel column chromatography (developing liquid: toluene/heptane = 4/6 (volume ratio)), and thus N¹-([1,1'-biphenyl]-4-yl)-2-chloro-N¹-(3-(diphenylamino)phe nyl)-N³,N³-diphenylbenzene-1,3-diamine (20.2 g) was obtained.

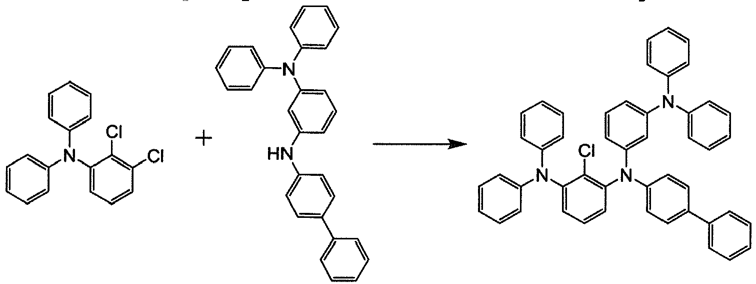

A 1.6 M t-butyllithium pentane solution (26.1 ml) was introduced into a flask containing N¹-([1,1'-biphenyl]-4-yl)-2-chloro-N¹-(3-(diphenylamino)phe nyl)-N³,N³-diphenylbenzene-1,3-diamine (16.0 g) and t-butylbenzene (100 ml) in a nitrogen atmosphere, while the flask was cooled in an ice bath. After completion of dropwise addition, the temperature was increased to 60°C, the mixture was stirred for 2 hours, and then components having boiling points that were lower than that of t-butylbenzene were distilled off under reduced pressure. The residue was cooled to -50°C, boron tribromide (4.0 ml) was added thereto, the temperature of the mixture was increased to room temperature, and the mixture was stirred for 0.5 hours. Thereafter, the mixture was cooled again in an ice bath, and N,N-diisopropylethylamine (8.1 ml) was added thereto. The mixture was stirred at room temperature until heat generation was settled, subsequently the temperature was increased to 120°C, and the mixture was heated and stirred for 2 hours. The reaction liquid was cooled to room temperature, and a precipitated produced by adding an aqueous solution of sodium acetate that had been cooled in an ice bath and then ethyl acetate thereto, was collected by suction filtration. Subsequently, the precipitate was purified by silica gel column chromatography (developing liquid: toluene/heptane = 4/6). The purification product was washed with hot heptane, and then was reprecipitated with a chlorobenzene/ethyl acetate mixed solvent. Thus, a compound (2.7 g) represented by formula (1-2683) was obtained.

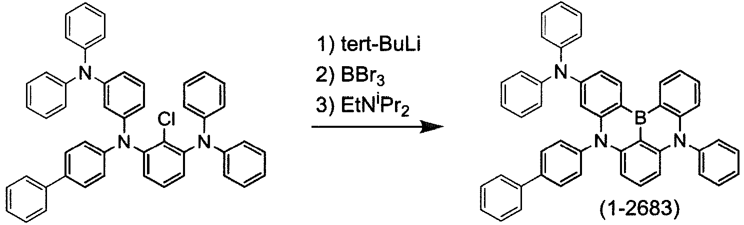

The structure of the compound thus obtained was identified by an NMR analysis. ¹H-NMR (400 MHz, CDCl₃): δ = 8.87 (d, 1H), 8.74 (d, 1H), 7.68 (t, 2H), 7.64 (d, 2H), 7.58 (m, 3H), 7.50 (t, 2H), 7.36 -7.44 (m, 4H), 7.16 - 7.28 (m, 8H), 7.10 (m, 4H), 6.97 (m, 3H), 6.72 (d, 1H), 6.22 (m, 2H), 6.10 (d, 1H).

### Synthesis Example (72)

### Synthesis of 16-phenyl-16H-8-oxa-12b,16-diaza-4b-boradibenzo[a,j]perylen e

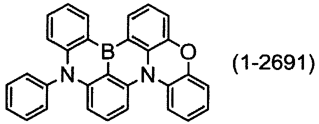

In a nitrogen atmosphere, a flask containing 2,3-dichloro-N,N-diphenylaniline (18.0 g), 10H-phenoxazine (15.0 g), Pd-132 (0.4 g), NaOtBu (8.3 g) and xylene (100 ml) was heated and stirred for 1 hour at 120°C. The reaction liquid was cooled to room temperature, subsequently water and ethyl acetate were added thereto, and the mixture was partitioned. Subsequently, the resultant was purified by silica gel column chromatography (developing liquid: toluene). A fraction containing an intended product was reprecipitated by distilling off the solvent under reduced pressure and adding heptane thereto. Thus, 2-chloro-3-(10H-phenoxazin-10-yl)-N,N-diphenylaniline (23.0 g) was obtained.

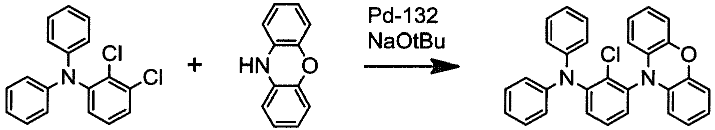

A 1.6 M t-butyllithium pentane solution (54.0 ml) was introduced into a flask containing 2-chloro-3-(10H-phenoxazin-10-yl)-N,N-diphenylaniline (20.0 g) and t-butylbenzene (150 ml) in a nitrogen atmosphere, while the flask was cooled in an ice bath. After completion of dropwise addition, the temperature was increased to 60°C, the mixture was stirred for 3 hours, and then components having boiling points that were lower than that of t-butylbenzene were distilled off under reduced pressure. The residue was cooled to -50°C, boron tribromide (8.2 ml) was added thereto, the temperature of the mixture was increased to room temperature, and the mixture was stirred for 0.5 hours. Thereafter, the mixture was cooled again in an ice bath, and N,N-diisopropylethylamine (15.1 ml) was added thereto. The mixture was stirred at room temperature until heat generation was settled, subsequently the temperature of the mixture was increased to 120°C, and the mixture was heated and stirred for 2 hours. The reaction liquid was cooled to room temperature, an aqueous solution of sodium acetate that had been cooled in an ice bath and then ethyl acetate were added thereto, and the mixture was partitioned. Subsequently, the resultant was purified by silica gel column chromatography (developing liquid: toluene/heptane = 3/7), and was further purified by activated carbon chromatography (developing liquid: toluene/heptane = 5/5 (volume ratio)). The purification product was reprecipitated using a chlorobenzene/ethyl acetate mixed solvent, and thus a compound (2.8 g) represented by formula (1-2691) was obtained.

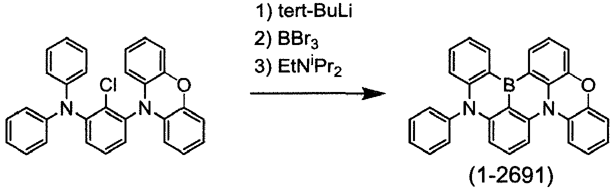

The structure of the compound thus obtained was identified by an NMR analysis.
¹H-NMR (400 MHz, CDCl₃): δ = 8.73 (d, 1H), 8.20 (d, 1H), 7.65 - 7.80 (m, 3H), 7.56 - 7.64 (d, 2H), 7.38 - 7.54 (m, 3H), 7.20 - 7.37 (m, 3H), 7.16 (m, 1H), 7.11 (m, 1H), 7.05 (t, 1H), 6.97 (t, 1H), 6.77 (d, 1H), 6.27 (d, 1H)).

### Synthesis Example (73)

### Synthesis of 9-([1,1'-biphenyl]-3-yl)-N,N,5,11-tetraphenyl-5,9-dihydro-5 ,9-diaza-13b-boranaphtho[3,2,1-de]anthracene-3-amine

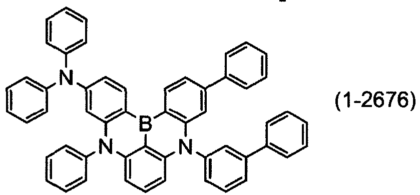

In a nitrogen atmosphere, a flask containing [1,1'-biphenyl]-3-amine (19.0 g), 4-bromo-1,1'-biphenyl (25.0 g), Pd-132 (0.8 g), NaOtBu (15.5 g) and xylene (200 ml) was heated and stirred for 6 hours at 120°C. The reaction liquid was cooled to room temperature, subsequently water and ethyl acetate were added thereto, and the mixture was partitioned. Subsequently, the resultant was purified by silica gel column chromatography (developing liquid: toluene/heptane = 5/5 (volume ratio)). A solid obtained by distilling off the solvent under reduced pressure was washed with heptane, and thus di([1,1'-biphenyl]-3-yl)amine (30.0 g) was obtained.

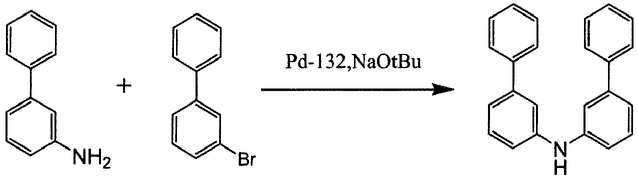

In a nitrogen atmosphere, a flask containing N¹-(2,3-dichlorophenyl)-N¹,N³,N³-triphenylbenzene-1,3-diamin e (15.0 g), di ([1,1'-biphenyl]-3-yl)amine (10.0 g), Pd-132 (0.2 g), NaOtBu (4.5 g) and xylene (70 ml) was heated and stirred for 1 hour at 120°C. The reaction liquid was cooled to room temperature, subsequently water and ethyl acetate were added thereto, and the mixture was partitioned. Subsequently, the resultant was purified by silica gel column chromatography (developing liquid: toluene/heptane = 5/5 (volume ratio)). A fraction containing an intended product was reprecipitated by distilling off the solvent under reduced pressure, and thus N¹,N¹-di([1,1'-biphenyl]-3-yl)-2-chloro-N³-(3-(diphenylamino )phenyl)-N³-phenylbenzene-1,3-diamine (20.3 g) was obtained.

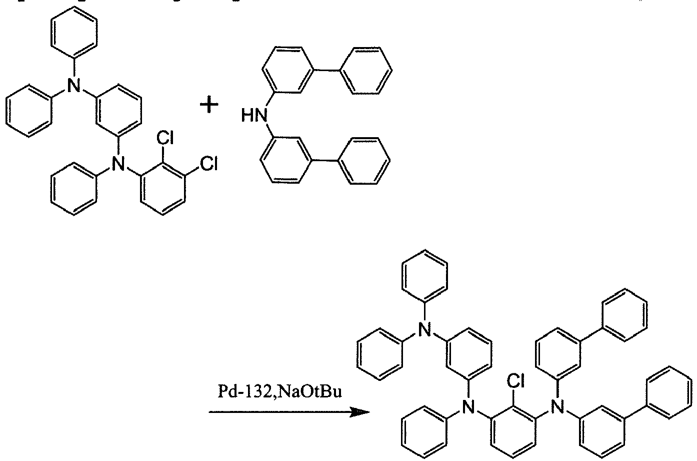

A 1.6 M t-butyllithium pentane solution (32.6 ml) was introduced into a flask containing N¹,N¹-di([1,1'-biphenyl]-3-yl)-2-chloro-N³-(3-(diphenylamino )phenyl)-N³-phenylbenzene-1,3-diamine (20.0 g) and t-butylbenzene (150 ml) in a nitrogen atmosphere, while the flask was cooled in an ice bath. After completion of dropwise addition, the temperature was increased to 60°C, the mixture was stirred for 2 hours, and then components having boiling points that were lower than that of t-butylbenzene were distilled off under reduced pressure. The residue was cooled to -50°C, boron tribromide (5.0 ml) was added thereto, the temperature of the mixture was increased to room temperature, and the mixture was stirred for 0.5 hours. Thereafter, the mixture was cooled again in an ice bath, and N,N-diisopropylethylamine (9.0 ml) was added thereto. The mixture was stirred at room temperature until heat generation was settled, subsequently the temperature was increased to 120°C, and the mixture was heated and stirred for 1.5 hours. The reaction liquid was cooled to room temperature, an aqueous solution of sodium acetate that had been cooled in an ice bath and then ethyl acetate were added thereto, and the mixture was partitioned. Subsequently, the resultant was purified by silica gel column chromatography (developing liquid: toluene/heptane = 5/5). Furthermore, the purification product was reprecipitated using a toluene/heptane mixed solvent and a chlorobenzene/ethyl acetate mixed solvent, and thus a compound (5.0 g) represented by formula (1-2676) was obtained.

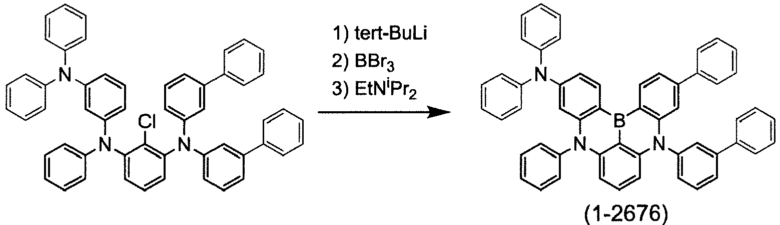

The structure of the compound thus obtained was identified by an NMR analysis.
¹H-NMR (400 MHz, CDCl₃): δ = 8.93 (d, 1H), 8.77 (d, 1H), 7.84 (m, 1H), 7.77 (t, 1H), 7.68 (m, 3H), 7.33 - 7.50 (m, 12H), 7.30 (t, 1H), 7.22 (m, 7H), 7.11 (m, 4H), 7.03 (m, 3H), 6.97 (dd, 1H), 6.20 (m, 2H), 6.11 (d, 1H)).

### Synthesis Example (74)

### Synthesis of 5-oxa-9-thia-13b-boranaphtho[3,2,1-de]anthracene

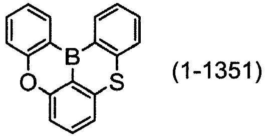

In a nitrogen atmosphere, a flask containing 1-bromo-3-phenoxybenzene (28.5 g), benzenethiol (11.7 ml), copper (I) iodide (2.2 g), potassium carbonate (32.0 g) and NMP (120 ml) was heated to 170°C, and was stirred for 6 hours. The reaction liquid was cooled to room temperature, NMP was distilled off under reduced pressure, subsequently aqueous ammonia and ethyl acetate were added thereto, and the mixture was partitioned. Subseqeuntly, the resultant was purified by silica gel column chromatography (developing liquid: toluene/heptane = 1/9 (volume ratio)), and thus (3-phenoxyphenyl)(phenyl)sulfane (23.0 g) was obtained.

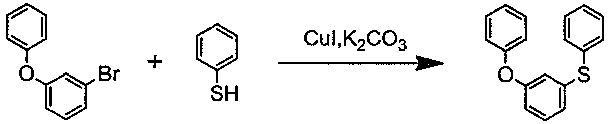

A 1.0 M sec-butyllithium cyclohexane solution (75.0 ml) was added to a flask containing (3-phenoxyphenyl) (phenyl) sulfane (20.0 g) and xylene (250 ml) at 0°C in a nitrogen atmosphere. After completion of dropwise addition, the temperature was increased to 70°C, the mixture was stirred for 2 hours, and then components having boiling points that were lower than that of xylene were distilled off under reduced pressure. The residue was cooled to -50°C, boron tribromide (8.2 ml) was added thereto, the temperature of the mixture was increased to room temperature, and the mixture was stirred for 0.5 hours. Thereafter, the mixture was cooled again to 0°C, and N,N-diisopropylethylamine (24.9 ml) was added thereto. The mixture was stirred at room temperature until heat generation was settled, subsequently the temperature of the mixture was increased to 120°C, and the mixture was heated and stirred for 2 hours. The reaction liquid was cooled to room temperature, an aqueous solution of sodium acetate that had been cooled in an ice bath and then ethyl acetate were added thereto, and the mixture was partitioned. Subsequently, the resultant was purified by silica gel column chromatography (developing liquid: toluene/heptane = 1/9). The purification product was reprecipitated by adding heptane to an oily material thus obtained, and then was reprecipitated using an ethyl acetate/heptane mixed solvent. Thus, a compound (4.4 g) represented by formula (1-1351) was obtained.

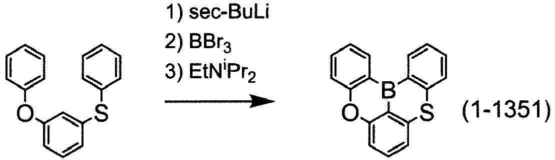

The structure of the compound thus obtained was identified by an NMR analysis.
¹H-NMR (400 MHz, CDCl₃): δ = 8.72 (d, 1H), 8.58 (d, 1H), 7.65 - 7.75 (m, 3H), 7.53 - 7.61 (m, 2H), 7.47 (m, 2H), 7.38 (t, 1H), 7.34 (d, 1H).

### Synthesis Example (75)

### Synthesis of 9-phenyl-9H-5-thia-9-aza-13b-boranaphtho[3,2,1-de]anthracen e

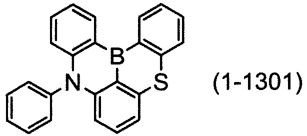

In a nitrogen atmosphere, 1-bromo-2-chloro-3-fluorobenzene (27.4 g), benzenethiol (13.3 ml), potassium carbonate (36.0 g), and NMP (150 ml) were heated to 120°C, and then the mixture was stirred for 2 hours. The reaction liquid was cooled to room temperature, NMP was distilled off under reduced pressure, subsequently aqueous ammonia and ethyl acetate were added to the residue, and the mixture was partitioned. Subsequently, the resultant was purified by silica gel column chromatography (developing liquid: heptane), and thus (3-bromo-2-chlorophenyl)(phenyl)sulfane (27.4 g) was obtained.

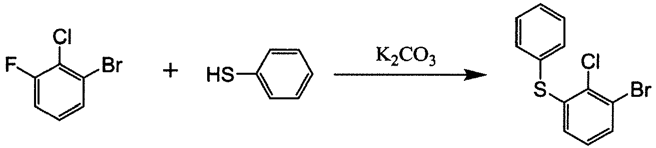

In a nitrogen atmosphere, a flask containing (3-bromo-2-chlorophenyl)(phenyl)sulfane (27.4 g), diphenylamine (11.0 g), Pd-132 (0.4 g), NaOtBu (8.0 g) and xylene (120 ml) was heated and stirred for 1.5 hours at 90°C. The reaction liquid was cooled to room temperature, subsequently water and ethyl actate were added thereto, and the mixture was partitioned. Subsequently, the resultant was purified by silica gel column chromatography (developing liquid: toluene/heptane = 1/9 (volume ratio)), and thus 2-chloro-N,N-diphenyl-3-(phenylthio)aniline (19.0 g) was obtained.

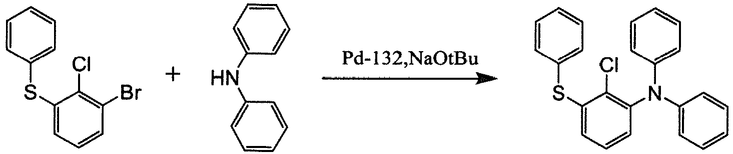

A 1.7 M t-butyllithium pentane solution (30.0 ml) was introduced into a flask containing 2-chloro-N,N-diphenyl-3-(phenylthio)aniline (19.0 g) and t-butylbenzene (150 ml) in a nitrogen atmosphere, while the flask was cooled in an ice bath. After completion of dropwise addition, the temperature was increased to 25°C, the mixture was stirred for 1 hour, and then components having boiling points that were lower than that of t-butylbenzene were distilled off under reduced pressure. The residue was cooled to -50°C, boron tribromide (5.6 ml) was added thereto, the temperature of the mixture was increased to room temperature, and the mixture was stirred for 0.5 hours. Thereafter, the mixture was cooled again in an ice bath, and N,N-diisopropylethylamine (19.8 ml) was added thereto. The mixture was stirred at room temperature until heat generation was settled, subsequently the temperature of the mixture was increased to 120°C, and the mixture was heated and stirred for 2 hours. The reaction liquid was cooled to room temperature, an aqueous solution of sodium acetate that had been cooled in an ice bath and then ethyl acetate were added thereto, and the mixture was partitioned. Subseqeuntly, the resultant was purified by silica gel column chromatography (developing liquid: toluene/heptane = 3/7). Furthermore, the purification product was purified by activated carbon column chromatography (developing liquid: toluene/heptane = 5/5 (volume ratio)), and thus a compound (0.1 g) represented by formula (1-1301) was obtained.

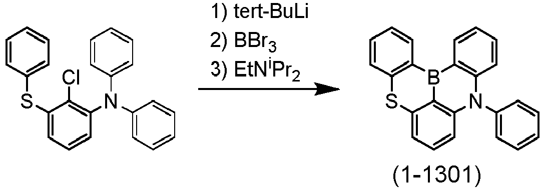

The structure of the compound thus obtained was identified by an NMR analysis.
¹H-NMR (400 MHz, CDCl₃): δ = 8.66 (d, 1H), 8.59 (d, 1H), 7.70 (m, 3H), 7.62 (t, 1H), 7.42 - 7.54 (m, 3H), 7.37 (m, 3H), 7.32 (d, 1H), 7.27 (m, 1H), 6.80 (d, 1H), 6.51 (d, 1H).

### Synthesis Example (79)

### Synthesis of 3,6,13,16-tetrabutyl-9,10,19,20-tetraoxa-4b,14b-diboranapht ho[1,2,3-fg:1',2',3'-qr]pentacene

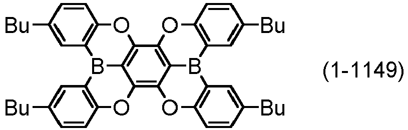

In a nitrogen atmosphere, a flask containing 1,4-dibromo-2,3,5,6-tetrafluorobenzene (3.08 g), 4-butylphenol (7.70 ml), potassium carbonate (6.91 g) and NMP (20 ml) was heated and stirred for 33 hours at 140°C. The reaction liquid was cooled to room temperature, saturated brine and toluene were added thereto, and the mixture was partitioned. The solvent was distilled off under reduced pressure, and then the residue was purified using a silica gel short pass column (developing liquid: toluene). The solvent was distilled off under reduced pressure, and the crude purification product was washed using methanol. Thus, 1,4-dibromo-2,3,5,6-tetra(4-butylphenoxy)benzene (4.13 g) was obtained.

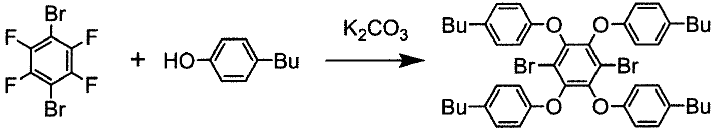

A 1.6 M n-butyllithium hexane solution (0.612 ml) was added to a toluene (3.0 ml) solution of 1,4-dibromo-2,3,5,6-tetra(4-butylphenoxy)benzene (0.414 g) at 0°C in a nitrogen atmosphere. The temperature was increased to room temperature, the mixture was stirred for 1 hour, and the solvent was distilled off under reduced pressure. The residue was cooled to 0°C, o-dichlorobenzene (4.0 ml) and boron tribromide (0.118 ml) were added thereto, the temperature of the mixture was increased to 60°C, and the mixture was stirred for 3 hours. The mixture was cooled to 0°C, N,N-diisopropylethylamine (0.350 ml) was added thereto, and then the mixture was heated and stirred for 16 hours at 140°C. The reaction liquid was cooled to room temperature and was poured into an aqueous solution of sodium acetate that had been cooled in an ice bath. Subsequently, chloroform was added thereto, and the mixture was partitioned. The solvent was distilled off under reduced pressure, and then the residue was recrystallized using chloroform. Thus, a compound (67.9 mg) represented by formula (1-1149) was obtained as an orange-colored solid.

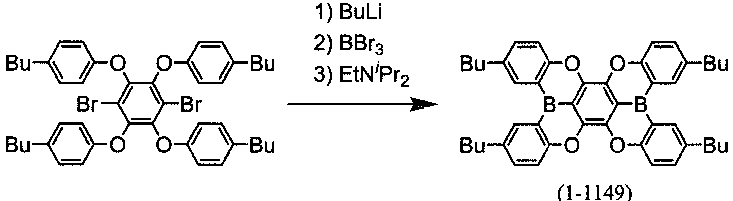

The structure of the compound thus obtained was identified by an NMR analysis.
¹H NMR (δ ppm in CDCl₃); 8.37 (d, J = 2.0 Hz, 4H), 7.54 (d, J = 8.4 Hz, 4H), 7.48 (dd, J = 2.0 Hz, 8.4 Hz, 4H), 2.78 (t, J = 7.6 Hz, 8H), 1.77 (m, 8H), 1.50 (sex, J = 7.3 Hz, 8H), 1.03 (t, J = 7.3 Hz, 12H).
LRMS (DART) m/z 686 (M⁺)

### Synthesis Example (80)

### Synthesis of 10-methyl-5,9,11,15-tetraoxa-19b,20b-diboranaphtho[3,2,1-de :1',2',3'-jk]pentacene

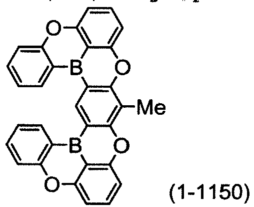

1-Bromo-2,6-difluorobenzene (25.2 g, 0.130 mol) was added to phenol (12.3 g, 0.130 mol), potassium carbonate (18.0 g, 0.130 mol) and N-methylpyrrolidone (NMP, 250 mL) at room temperature in a nitrogen atmosphere. The mixture was heated and stirred for 160 hours at 120°C. Thereafter, NMP was distilled off under reduced pressure, and then toluene was added to the residue. The mixture was filtered using a silica gel short pass column, and the solvent was distilled off under reduced pressure. Thus, 2-bromo-1-fluoro-3-phenoxybenzene was obtained as a pale red liquid (26.4 g, yield: 76%).

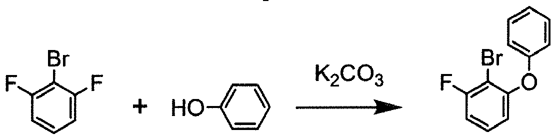

2-Bromo-1-fluoro-3-phenoxybenzene (27.3 g, 97.1 mmol) was added to 2-methylresorcinol (6.03 g, 49 mmol), potassium carbonate (53.7 g, 0.39 mol) and NMP (0.400 L) at room temperature in a nitrogen atmosphere. The mixture was heated and stirred for 30 hours at 150°C, and then was heated and stirred for 18 hours at 160°C and for 26 hours at 170°C. Thereafter, NMP was distilled off under reduced pressure, subsequently water and toluene were added thereto, and the mixture was partitioned. An organic layer was filtered using a silica gel short pass column, the solvent was distilled off under reduced pressure, and thus a crude product was obtained. The crude product was recrystallized using toluene, and thus 1,3-bis(2-bromo-3-phenoxyphenoxy)-2-methylbenzene was obtained as a white solid (crystal No. 1: 10.44 g, 71% purity; crystal No. 2: 3.73 g, 68% purity, total yield: 33%).

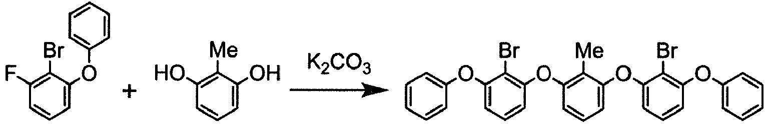

A hexane solution of butyllithium (0.335 mL, 1.64 M, 0.55 mmol) was added to 1,3-bis(2-bromo-3-phenoxyphenoxy)-2-methylbenzene (0.228 g, 0.25 mmol, purity 68%) and o-dichlorobenzene (4.0 mL) at 0°C in a nitrogen atmosphere, and then the mixture was stirred for 21 hours at room temperature. Thereafter, a hexane solution of butyllithium (0.152 mL, 1.64 M, 0.25 mmol) was further added thereto at 0°C, and then the mixture was stirred for 4 hours at room temperature. Boron tribromide (99.2 µL, 1.05 mmol) was added thereto at 0°C, the mixture was stirred for 5 hours at room temperature, and then N,N-diisopropylethylamine (0.174 mL, 1.0 mmol) was added thereto at 0°C. Hexane was distilled off by heating and stirring the mixture for 1 hour at 100°C under a nitrogen gas stream, and then the residue was heated and stirred for 24 hours at 170°C. The solvent was distilled off under reduced pressure, and the residue was washed using toluene and acetonitrile. Thus, a compound represented by formula (1-1150) was obtained as a white solid (24.0 mg, yield 20%).

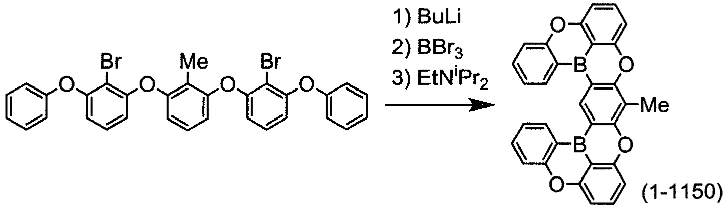

The structure of the compound thus obtained was identified by an NMR analysis.
¹H-NMR (δppm in CDCl₃); 10.03 (s, 1H), 8.93 (d, 2H), 7.82 (t, 2H), 7.76 (t, 2H), 7.61 (d, 2H), 7.51 (t, 2H), 7.33 (d, 2H), 7.28 (d, 2H), 2.84 (s, 3H).
LRMS (DART) calcd for C₃₁H₁₈B₂O₄ [(M+H)⁺]: 477.1, found: 477.2

### Synthesis Example (81)

### Synthesis of 2,12-dimethyl-N,N,5,9-tetra-p-tolyl-5,13-dihydro-5,9-diaza-13b-boranaphtho[3,2,1-de]anthracene-7-amine

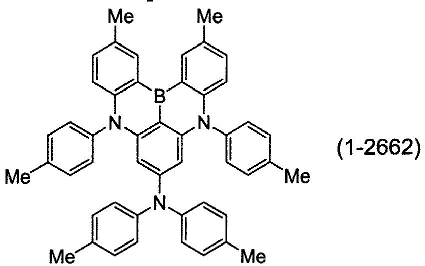

First, boron tribromide (4.73 ml, 50 mmol) was added to N¹,N¹,N³,N³,N⁵,N⁵-hexakis(4-methylphenyl)-1,3,5-benzenetriami ne (16.6 g, 25 mmol) and o-dichlorobenzene (150 ml) at room temperature in a nitrogen atmosphere, and then the mixture was heated and stirred for 20 hours at 170°C. Thereafter, the reaction solution was distilled off under reduced pressure at 60°C under reduced pressure. The residue was filtered using a Florisil short pass column, the solvent was distilled off under reduced pressure, and thus a crude product was obtained. The crude product was washed using hexane, and the solid thus obtained was washed using toluene. Thus, a compound (8.08 g) represented by formula (1-2662) was obtained as a yellow solid.

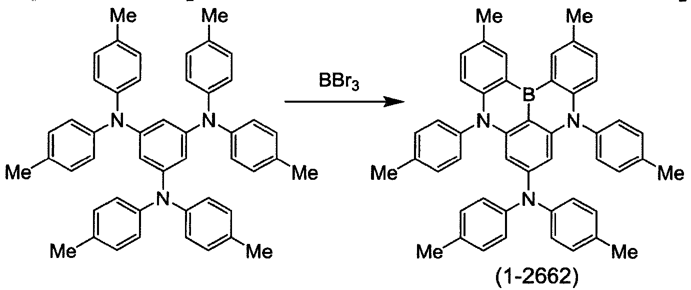

The structure of the compound thus obtained was identified by an NMR analysis.
¹H-NMR (400 MHz, CDCl₃): δ = 2.27 (s, 6H), 2.39 (s, 6H), 2.50 (s, 6H), 5.48 (brs, 2H), 6.68 (d, 2H), 6.83 (ddd, 4H), 6.89 (ddd, 4H), 7.07 (ddd, 4H), 7.17 (dd, 2H), 7.25 (ddd, 4H), 8.68 (sd, 2H).
¹³C-NMR (101 MHz, CDCl₃): δ = 20.78 (2C), 21.06 (2C), 21.11 (2C), 96.5 (2C), 116.7 (2C), 126.0 (4C), 128.2 (2C), 129.3 (4C), 129.9 (4C), 131.1 (4C), 131.3 (2C), 133.0 (2C), 134.6 (2C), 137.6 (2C), 139.8 (2C), 143.9 (2C), 145.9 (2C), 148.0 (2C), 151.0.

### Synthesis Example (82)

### Synthesis of 9,11-diphenyl-4b,11,15b,19b-tetrahydro-9H-9,11,19b-triaza-4 b,15b-diborabenzo[3,4]phenanthro[2,1,10,9-fghi]pentacene

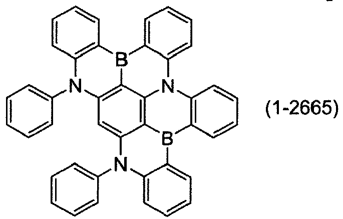

First, boron tribromide (0.142 ml, 1.5 mmol) was added to N,N,5,9-tetraphenyl-5,13-dihydro-5,9-diaza-13b-boranaphtho[ 3,2,1-de]anthracene-7-amine (0.294 g, 0.5 mmol) and o-dichlorobenzene (3.0 ml) at room temperature in a nitrogen atmosphere in an autoclave, and then the mixture was heated and stirred for 48 hours at 260°C. Thereafter, N,N-diisopropylethylamine (0.775 ml, 4.5 mmol) was added thereto, and the mixture was filtered using a Florisil short pass column. The solvent was distilled off under reduced pressure, and thus a crude product was obtained. The crude product was washed using ethyl acetate, and thus a compound (0.118 g) represented by formula (1-2665) was obtained.

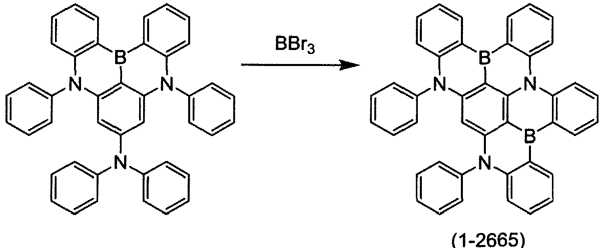

The structure of the compound thus obtained was identified by an NMR analysis.
¹H-NMR (400 MHz, CDCl₃): δ = 5.24 (s, 1H), 6.81 (d, 2H), 7.12 - 7.18 (m, 6H), 7.34 (td, 2H), 7.41 - 7.49 (m, 8H), 7.45 (ddd, 2H), 8.31 (dd, 2H), 8.81 (dd, 2H), 8.91 (dd, 2H).
HRMS (DART) m/z [M+H]⁺ Calcd for C₄₂H₂₈B₂N₃ 596.2483, observed 596.2499.

### Synthesis Example (83)

### Synthesis of 3,6,14,17-tetramethyl-9,11-di-p-tolyl-4b,11,15b,19b-tetrahy dro-9H-9,11,19b-triaza-4b,15b-diborabenzo[3,4]phenanthro[2, 1,10,9-fghi]pentacene

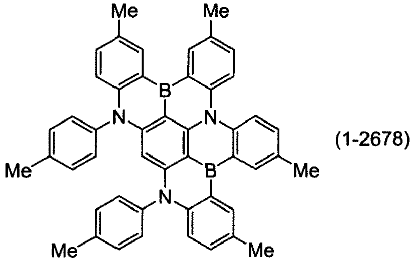

First, triphenylborane (0.730 g, 3.0 mmol) and boron tribromide (0.284 ml, 3.0 mmol) were added to N¹,N¹,N³,N³,N⁵,N⁵-hexakis(4-methylphenyl)-1,3,5-benzenetriami ne (0.322 g, 0.5 mmol) and o-dichlorobenzene (3.0 ml) at room temperature in a nitrogen atmosphere in an autoclave, and then the mixture was heated and stirred for 20 hours at 260°C. Thereafter, N,N-diisopropylethylamine (1.55 ml, 9.1 mmol) was added thereto, and the mixture was filtered using a Florisil short pass column. The solvent was distilled off under reduced pressure, and a crude product was obtained. The crude product was washed using hexane, and a solid thus obtained was washed using ethyl acetate. Thus, a compound (0.188 g) represented by formula (1-2678) was obtained as a yellow solid.

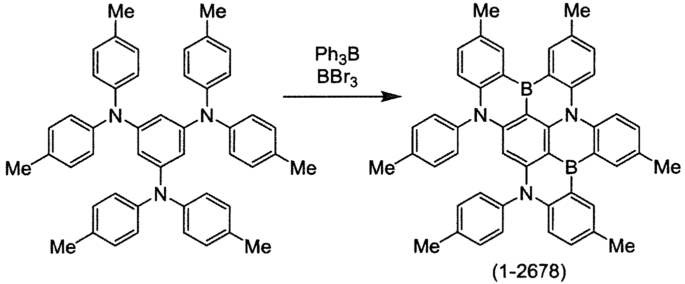

The structure of the compound thus obtained was identified by an NMR analysis.
¹H-NMR (400 MHz, CDCl₃): δ = 2.45 (s, 6H), 2.65 (s, 6H), 2.58 (s, 6H), 5.24 (brs, 1H), 6.74 (d, 2H), 6.97 (d, 4H), 7.15 - 7.27 (m, 6H), 7.34 (dd, 2H), 8.18 (d, 2H), 8.58 (d, 2H), 8.68 (d, 2H).
HRMS (DART) m/z [M+H]⁺ Calcd for C₄₈H₄₀B₂N₃ 680.3424, observed 680.3404.

### Synthesis Example (84)

### Synthesis of 7-phenoxy-5,9-dioxa-13b-boranaphtho[3,2,1-de]anthracene

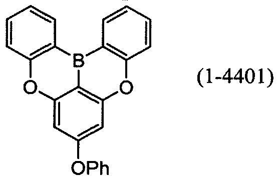

1-Bromo-2,4,6-trifluorobenzene (1.77 mL, 15.0 mol) was added to phenol (6.35 g, 67.5 mmol), potassium carbonate (9.33 g, 67.5 mmol) and N-ethylpyrrolidone (NMP, 80 mL) at room temperature in a nitrogen atmosphere, and the mixture was heated and stirred for 20 hours at 150°C. Water and toluene were added thereto, and the mixture was partitioned. Subsequently, the organic layer was filtered using a silica gel short pass column. The solvent was distilled off under reduced pressure, and the residue was washed with methanol. Thus, 1-bromo-2,4,6-triphenoxybenzene was obtained as a white solid (5.33 g, yield: 82%).

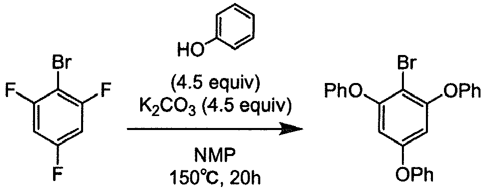

A hexane solution of butyllithium (0.335 mL, 1.64 M, 0.55 mol) was added to 1-bromo-2,4,6-triphenoxybenzene (0.217 g, 0.5 mmol) and t-butylbenzene (2.0 mL) at 0°C in a nitrogen atmosphere, and then the mixture was stirred for 3.5 hours at room temperature. Thereafter, boron tribromide (71.1 µL, 0.75 mmol) was added thereto at 0°C, and the mixture was stirred for 12.5 hours at room temperature. Subsequently, N,N-diisopropylethylamine (0.174 mL, 1.0 mmol) was added thereto at 0°C. Hexane was distilled off by heating and stirring the mixture for 1 hour at 100°C under a nitrogen gas stream, and then the residue was heated and stirred for 5 hours at 120°C. The residue was heated and stirred for 16.5 hours at 150°C, and then the solvent was distilled off under reduced pressure. Toluene was added to the residue, and the mixture was filtered using a silica gel short pass column. The solvent was distilled off under reduced pressure, and a crude product was obtained. The crude product was washed using acetonitrile, and thus a compound represented by formula (1-4401) was obtained as a white solid (0.101 g, yield: 56%).

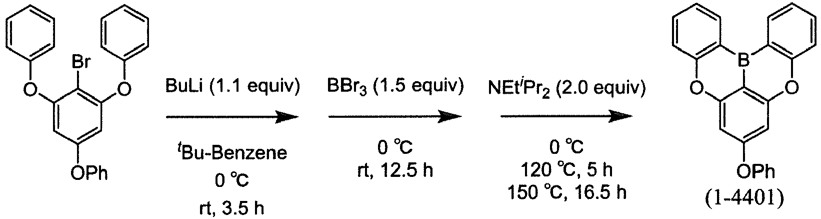

The structure of the compound thus obtained was identified by an NMR analysis.
¹H-NMR (δ ppm in CDCl₃); δ = 8.67 (dd, 2H), 7.68 (ddd, 2H), 7.50 - 7.66 (m, 4H), 7.38 (ddd, 2H), 7.25 (td, 1H), 7.19 (dd, 2H), 7.19 (S, 2H).
LRMS (DART) calcd for C₂₄H₁₆B₁O₃ [ (M+H)⁺]: 363.1, found: 363.1

### Synthesis Example (85)

### Synthesis of 3,11-dimethyl-7-(m-tolyloxy)-5,9-dioxa-13b-boranaphtho[3,2, 1-de]anthracene

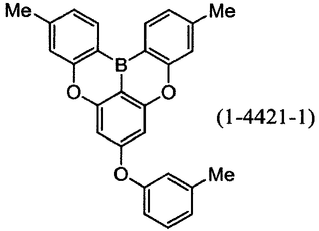

1-Bromo-2,4,6-trifluorobenzene (1.50 g, 7.1 mmol) was added to m-cresol (5.76 g, 32 mmol), potassium carbonate (4.42 g, 32 mmol) and N-methylpyrrolidone (NMP, 30 mL) at room temperature in a nitrogen atmosphere, and the mixture was heated and stirred for 48 hours at 150°C. Water and toluene were added thereto, and the mixture was partitioned. The organic layer was filtered using a silica gel short pass column. The solvent was distilled off under reduced pressure, and thus 1-bromo-,4,6-tris(m-tolyloxy)benzene was obtained as a colorless liquid (3.29 g, yield: 97%).

The structure of the compound thus obtained was identified by an NMR analysis.
¹H-NMR (δ ppm in CDCl₃); δ = 7.21 (t, 2H), 7.15 (t, 1H), 6.93 (d, 2H), 6.80 - 6.88 (m, 5H), 6.74 (s, 1H), 6.73 (d, 1H), 6.36 (s, 2H), 2.33 (s, 6H), 2.28 (s, 3H).

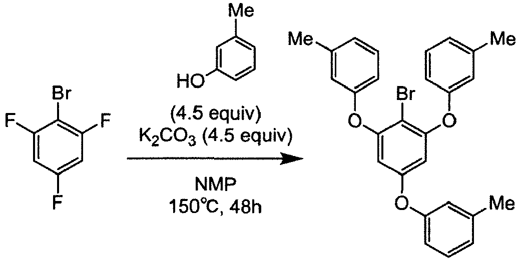

A hexane solution of butyllithium (0.205 mL, 1.64 M, 0.34 mmol) was added to 1-bromo-2,4,6-tris(m-tolyloxy)benzene (0.146 g, 0.31 mmol) and t-butylbenzene (1.0 mL) at 0°C in a nitrogen atmosphere, and then the mixture was stirred for 10 hours at room temperature. Thereafter, boron tribromide (44.1 µL, 0.47 mmol) was added thereto at 0°C, the mixture was stirred for 5 hours at room temperature, and then N,N-diisopropylethylamine (0.108 mL, 0.62 mmol) was added thereto at 0°C. The mixture was heated and stirred for 27 hours at 150°C, and then N,N-diisopropylethylamine (0.108 mL, 0.62 mmol) was added thereto at 0°C. Toluene was added thereto, and then the mixture was filtered using a Florisil short pass column. The solvent was distilled off under reduced pressure, and thus a crude product was obtained. The crude product was washed using acetonitrile, and thus a compound represented by formula (1-4421-1) was obtained as a white solid (57.0 mg, yield: 45%) .

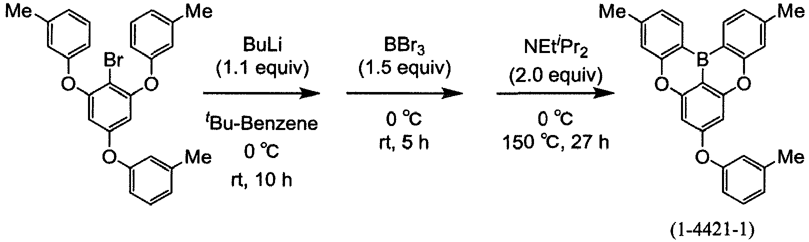

The structure of the compound thus obtained was identified by an NMR analysis.
¹H-NMR (δ ppm in CDCl₃); δ = 8.51 (d, 2H), 7.26 - 7.33 (m, 3H), 7.18 (d, 2H), 6.97 - 7.06 (m, 3H), 6.76 (s, 2H), 2.50 (s, 6H), 2.39 (s, 3H).
LRMS (EI+) m/z 404 (M⁺)

### Synthesis Example (86)

### Synthesis of 2,12-dibutyl-5,9-dioxa-13b-boranaphtho[3,2,1-de]anthracene

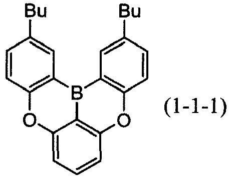

1-Bromo-2, 6-difluorobenzene (3.36 mL, 30 mmol) was added to p-butylphenol (13.8 mL, 90 mmol), potassium carbonate (12.4 g, 90 mmol) and N-methylpyrrolidone (NMP, 120 mL) at room temperature in a nitrogen atmosphere, and the mixture was heated and stirred for 84 hours at 150°C. Water and toluene were added thereto, the mixture was partitioned, and the organic layer was filtered using a silica gel short pass column. The solvent was distilled off under reduced pressure, and thus 1-bromo-2,6-bis(p-butylphenoxy)benzene was obtained as a brown liquid (9.46 g, yield: 70%).

The structure of the compound thus obtained was identified by an NMR analysis.
¹H-NMR (δ ppm in CDCl₃); δ = 7.16 (d, 4H), 7.11 (t, 1H), 6.95 (d, 4H), 6.63 (d, 2H), 2.60 (t, 4H), 1.60 (m, 4H), 1.36 (m, 4H), 0.93 (t, 6H).

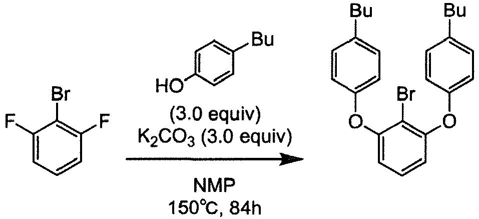

A hexane solution of butyllithium (0.671 mL, 1.64 M, 1.1 mmol) was added to 1-bromo-2,6-bis(p-butylphenoxy)benzene (0.453 g, 1.0 mmol) and t-butylbenzene (4.0 mL) at 0°C in a nitrogen atmosphere, and then the mixture was stirred for 2 hours at room temperature. Thereafter, boron tribromide (0.142 mL, 1.5 mmol) was added thereto at 0°C, and the mixture was stirred for 20 hours at room temperature. N,N-diisopropylethylamine (0.348 mL, 2.0 mmol) was added thereto at 0°C. Hexane was distilled off by heating and stirring the mixture for 2 hours at 100°C under a nitrogen gas stream, and then the residue was heated and stirred for 8 hours at 130°C. The residue was heated and stirred for 20 hours at 150°C, and then N,N-diisopropylethylamine (0.348 mL, 2.0 mmol) was added thereto at 0°C. Toluene was added thereto, and then the mixture was filtered using a Florisil short pass column. The solvent was distilled off under reduced pressure, and a crude product was obtained. The crude product was washed using acetonitrile, and thus a compound represented by formula (1-1-1) was obtained as a white solid (0.130 mg, yield: 34%).

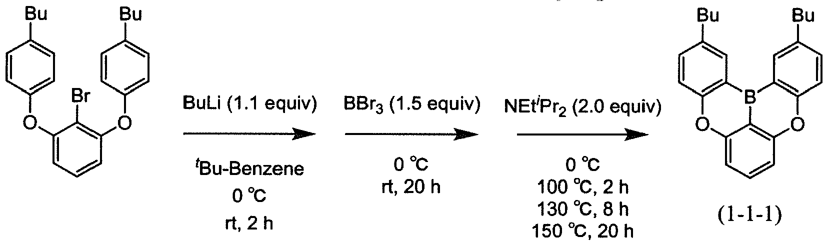

The structure of the compound thus obtained was identified by an NMR analysis.
¹H-NMR (δ ppm in CDCl₃); δ = 8.46 (s, 2H), 7.76 (t, 1H), 7.54 (d, 2H), 7.47 (d, 2H), 7.19 (d, 2H), 2.82 (t, 4H), 1.75 (m, 4H), 1.46 (m, 4H), 1.00 (t, 6H).
LRMS (EI+) m/z 382 (M⁺)

Other polycyclic aromatic compounds of the present invention can be synthesized by methods according to the Synthesis Examples described above, by appropriately changing the compounds of raw materials.

Hereinafter, various Examples will be described in order to explain the present invention in more detail, but the present invention is not intended to be limited to these.

Organic EL elements related to Examples 1 and 2 were produced, and the external quantum efficiency obtainable when each of the organic EL elements was driven at a current density capable of giving a luminance of 100 cd/m² was measured. The material configurations of the various layers in the organic EL elements thus produced are shown in the following Table 1.

**[Table 1]**

| | Hole Injection Layer 1 (65nm) | Hole Injection Layer 2 (5nm) | Hole Transport Layer (60nm) | Light Emitting Layer (25nm) | | Electron Transport Layer 2 (20nm) | Electron Transport Layer 1 (10nm) | Negative Electrode (1nm/100nm) |
|---|---|---|---|---|---|---|---|---|
| | | | | Host | Dopant | | | |
| Ex. 1 | HI | HAT-CN | HT | BH1 | Compound (1-176) | ET-2 | ET-1 | LiF/Al |
| Ex. 2 | HI | HAT-CN | HT | BH1 | Compound (1-100) | ET-2 | ET-1 | LiF/Al |

In Table 1, "HI" means N⁴,N⁴'-diphenyl-N⁴,N⁴'-bis(9-phenyl-9H-carbazol-3-yl)-[1,1¹-biphenyl]-4,4'-diamine; "HAT-CN" means 1,4,5,8,9,12-hexaazatriphenylenehexacarbonitrile; "HT" means N-([1,1'-biphenyl]-4-yl)-N-(4-(9-phenyl-9H-carbazol-3-yl)ph enyl)-[1,1'-biphenyl]-4-amine; "BH1" means 9-phenyl-10-(4-phenylnaphthalen-1-yl)anthracene; "ET-2" means 9-(4'-(dimesitylboryl)-[1,1'-binaphthalen]-4-yl)-9H-carbazo le; and "ET-1" means 5,5"-(2-phenylanthracene-9,10-diyl) di-2,2'-bipyridine (the same in the following tables). Chemical structures thereof are shown below.

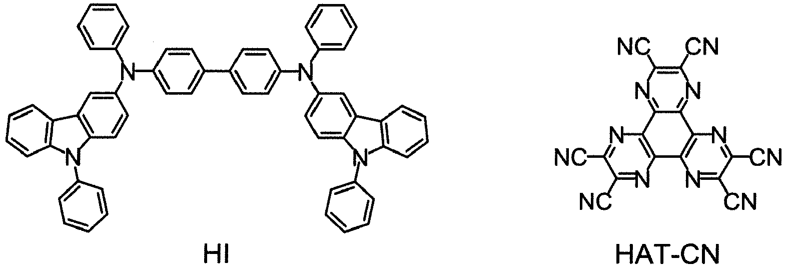

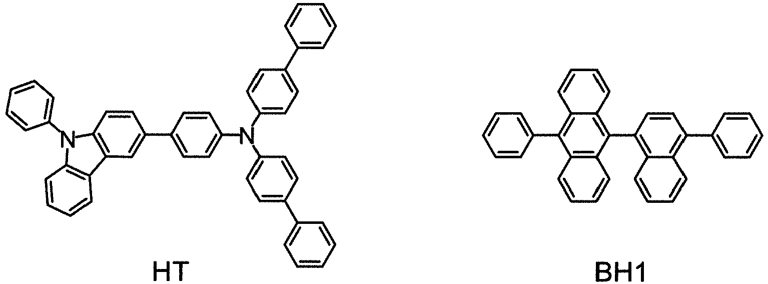

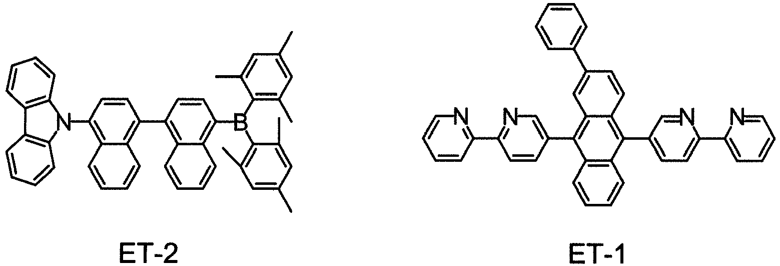

### <Example 1>

### <Element using compound (1-176) as dopant material of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Showa Shinku Co., Ltd.), and a vapor deposition boat made of molybdenum and containing HI, a vapor deposition boat made of molybdenum and containing HAT-CN, a vapor deposition boat made of molybdenum and containing HT, a vapor deposition boat made of molybdenum and containing BH1, a vapor deposition boat made of molybdenum and containing compound (1-176) of the present invention, a vapor deposition boat made of molybdenum and containing ET-2, a vapor deposition boat made of molybdenum and containing ET-1, a vapor deposition boat made of molybdenum and containing LiF, and a vapor deposition boat made of tungsten and containing aluminum, were mounted in the apparatus.

Various layers as described below were formed sequentially on the ITO film of the transparent supporting substrate. The pressure in a vacuum chamber was reduced to 5 × 10⁻⁴ Pa, and first, a hole injection layer 1 was formed by heating the vapor deposition boat containing HI and thereby performing vapor deposition to obtain a film thickness of 65 nm. Subsequently, a hole injection layer 2 was formed by heating the vapor deposition boat containing HAT-CN and thereby performing deposition to obtain a film thickness of 5 nm. Furthermore, a hole transport layer was formed by heating the vapor deposition boat containing HT and thereby performing deposition to obtain a film thickness of 60 nm. Next, a light emitting layer was formed by simultaneously heating the vapor deposition boat containing BH1 and the vapor deposition boat containing compound (1-176) and thereby performing deposition to obtain a film thickness of 25 nm. The rate of deposition was regulated such that the weight ratio of BH1 and the compound (1-176) would be approximately 80 : 20. Next, an electron transport layer 2 was formed by heating the vapor deposition boat containing ET-2 and thereby conducting deposition to obtain a film thickness of 20 nm, and an electron transport layer 1 was formed by heating the vapor deposition boat containing ET-1 and thereby performing deposition to obtain a film thickness of 10 nm. The rate of deposition for each layer was 0.01 to 1 nm/second.

Thereafter, the vapor deposition boat containing LiF was heated, and thereby vapor deposition was conducted at a rate of deposition of 0.01 to 0.1 nm/second so as to obtain a film thickness of 1 nm. Subsequently, a negative electrode was formed by heating the vapor deposition boat containing aluminum and thereby performing deposition at a rate of deposition of 0.01 to 2 nm/second so as to obtain a film thickness of 100 nm. Thus, an organic EL element was obtained.

When a direct current voltage was applied to the ITO electrode as the positive electrode and the LiF/aluminum electrode as the negative electrode, blue light emission having a peak top at about 437 nm was obtained. The external quantum efficiency at a luminance of 100 cd/m² was 3.39%.

### <Example 2>

### <Element using compound (1-100) as dopant material of light emitting layer>

An organic EL element was obtained by a method equivalent to that of Example 1, except that the compound (1-176) as the dopant material of the light emitting layer was changed to compound (1-100). When a direct current voltage was applied to the two electrodes, blue light emission having a peak top at about 457 nm was obtained. The external quantum efficiency at a luminance of 100 cd/m² was 2.78%.

Furthermore, organic EL elements related to Examples 3 and 4 were produced, and the external quantum efficiency obtainable when each element was driven at a current density that could give a luminance of 100 cd/m², was measured. The material configurations of the various layers in the organic EL elements thus produced are shown in the following Table 2.

**[Table 2]**

| | Hole Injection Layer (10nm) | Hole Transport Layer (30nm) | Light Emitting Layer (30mn) | | Electron Transport Layer (50nm) | Negative Electrode (1nm/100nm) |
|---|---|---|---|---|---|---|
| | | | Host | Dopant | | |
| Ex.3 | HAT-CN | TBB | CBP | Compound (1-141) | TPBi | LiF/Al |
| Ex.4 | HAT-CN | TBB | CBP | Compound (1-81) | TPBi | LiF/Al |

In Table 2, "TBB" means N⁴,N⁴,N⁴',N⁴'-tetra([1,1'-biphenyl]-4-yl)-[1,1'-biphenyl]-4, 4'-diamine; "CBP" means 4,4'-di(9H-carbazolyl-9-yl)-1,1'-biphenyl; and "TPBi" means 1,3,5-tris(1-phenyl-1H-benzo[d]imidazol-2-yl)benzene. The chemical structures thereof are shown below.

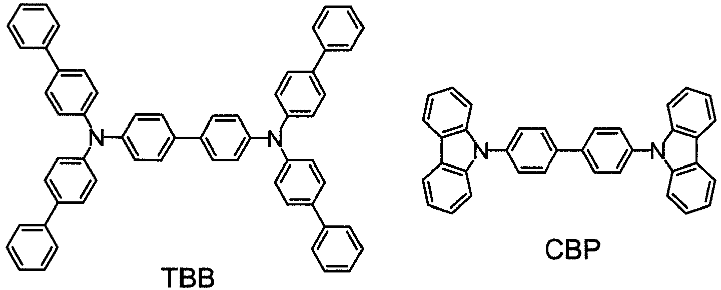

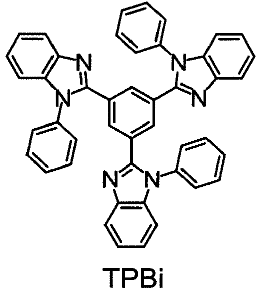

### <Example 3>

### <Element using compound (1-141) as dopant material of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Showa Shinku Co., Ltd.), and a vapor deposition boat made of molybdenum and containing HAT-CN, a vapor deposition boat made of molybdenum and containing TBB, a vapor deposition boat made of molybdenum and containing CBP, a vapor deposition boat made of molybdenum and containing compound (1-141) of the present invention, a vapor deposition boat made of molybdenum and containing TPBi, a vapor deposition boat made of molybdenum and containing LiF, and a vapor deposition boat made of tungsten and containing aluminum, were mounted in the apparatus.

Various layers as described below were formed sequentially on the ITO film of the transparent supporting substrate. The pressure in a vacuum chamber was reduced to 5 × 10⁻⁴ Pa, and first, a hole injection layer was formed by heating the vapor deposition boat containing HAT-CN and thereby performing vapor deposition to obtain a film thickness of 10 nm. Subsequently, a hole transport layer was formed by heating the vapor deposition boat containing TBB and thereby performing deposition to obtain a film thickness of 30 nm. Next, a light emitting layer was formed by simultaneously heating the vapor deposition boat containing CBP and the vapor deposition boat containing compound (1-141) and thereby performing deposition to obtain a film thickness of 30 nm. The rate of deposition was regulated such that the weight ratio of CBP and the compound (1-141) would be approximately 80 : 20. Next, an electron transport layer was formed by heating the vapor deposition boat containing TPBi and thereby performing deposition to obtain a film thickness of 50 nm. The rate of deposition for each layer was 0.01 to 1 nm/second.

Thereafter, the vapor deposition boat containing LiF was heated, and thereby vapor deposition was conducted at a rate of deposition of 0.01 to 0.1 nm/second so as to obtain a film thickness of 1 nm. Subsequently, a negative electrode was formed by heating the vapor deposition boat containing aluminum and thereby performing deposition at a rate of deposition of 0.01 to 2 nm/second so as to obtain a film thickness of 100 nm. Thus, an organic EL element was obtained.

When a direct current voltage was applied to the ITO electrode as the positive electrode and the LiF/aluminum electrode as the negative electrode, green light emission having a peak top at about 534 nm was obtained. The external quantum efficiency at a luminance of 100 cd/m² was 6.29%.

### <Example 4>

### <Element using compound (1-81) as dopant material of light emitting layer>

An organic EL element was obtained by a method equivalent to that of Example 3, except that the compound (1-141) as the dopant material of the light emitting layer was changed to compound (1-81) . When a direct current voltage was applied to the two electrodes, green light emission having a peak top at about 512 nm was obtained. The external quantum efficiency at a luminance of 100 cd/m² was 8.37%.

Furthermore, an organic EL element related to Example 5 was produced, and the external quantum efficiency obtainable when the organic EL element was driven at a current density that could give a luminance of 1000 cd/m² or 100 cd/m², was measured. The material configurations of the various layers in the organic EL element thus produced are shown in the following Table 3.

**[Table 3]**

| | Hole Injection Layer (10nm) | Hole Transport Layer (30nm) | Light Emitting Layer (30nm) | | Electron Transport Layer (50nm) | Negative Electrode (1nm/100nm) |
|---|---|---|---|---|---|---|
| | | | Host | Dopant | | |
| Ex.5 | HAT-CN | TBB | Compound (1-91) | Ir(PPy)₃ | TPBi | LiF/Al |

In Table 3, "Ir(PPy)₃" means tris(2-phenylpyridine)iridium(III). The chemical structure thereof is shown below.

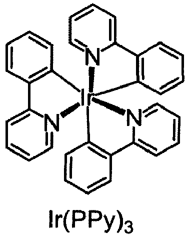

### <Example 5>

### <Element using compound (1-91) as host material of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Showa Shinku Co., Ltd.), and a vapor deposition boat made of molybdenum and containing HAT-CN, a vapor deposition boat made of molybdenum and containing TBB, a vapor deposition boat made of molybdenum and containing compound (1-91) of the present invention, a vapor deposition boat made of molybdenum and containing Ir(PPy)₃, a vapor deposition boat made of molybdenum and containing TPBi, a vapor deposition boat made of molybdenum and containing LiF, and a vapor deposition boat made of tungsten and containing aluminum, were mounted in the apparatus.

Various layers as described below were formed sequentially on the ITO film of the transparent supporting substrate. The pressure in a vacuum chamber was reduced to 5 × 10⁻⁴ Pa, and first, a hole injection layer was formed by heating the vapor deposition boat containing HAT-CN and thereby performing vapor deposition to obtain a film thickness of 10 nm. Subsequently, a hole transport layer was formed by heating the vapor deposition boat containing TBB and thereby performing deposition to obtain a film thickness of 30 nm. Next, a light emitting layer was formed by simultaneously heating the vapor deposition boat containing compound (1-91) and the vapor deposition boat containing Ir(PPy)₃ and thereby performing deposition to obtain a film thickness of 30 nm. The rate of deposition was regulated such that the weight ratio of the compound (1-91) and Ir(PPy)₃ would be approximately 95 : 5. Next, an electron transport layer was formed by heating the vapor deposition boat containing TPBi and thereby performing deposition to obtain a film thickness of 50 nm. The rate of deposition for each layer was 0.01 to 1 nm/second.

Thereafter, the vapor deposition boat containing LiF was heated, and thereby vapor deposition was conducted at a rate of deposition of 0.01 to 0.1 nm/second so as to obtain a film thickness of 1 nm. Subsequently, a negative electrode was formed by heating the vapor deposition boat containing aluminum and thereby performing deposition at a rate of deposition of 0.01 to 2 nm/second so as to obtain a film thickness of 100 nm. Thus, an organic EL element was obtained.

When a direct current voltage was applied to the ITO electrode as the positive electrode and the LiF/aluminum electrode as the negative electrode, green light emission having a peak top at about 512 nm was obtained. The external quantum efficiency at a luminance of 1000 cd/m² was 10.88%. Also, the external quantum efficiency at a luminance of 100 cd/m² was 14.76%.

Furthermore, organic EL elements related to Examples 6 to 14 were produced, and the external quantum efficiency obtainable when each of the organic EL elements was driven at a current density that could give a luminance of 1000 cd/m² or 100 cd/m², was measured. The material configurations of the various layers in the organic EL elements thus produced are shown in the following Table 4.

**[Table 4]**

| | Hole Injection Layer (10nm) | Hole Transport Layer (30nm) | Light Emitting Layer (30nm) | | Electron Transport Layer (50nm) | Negative Electrode (1nm/100nm) |
|---|---|---|---|---|---|---|
| | | | Host | Dopant | | |
| Ex.6 | HAT-CN | TBB | Compound (1-152) | Ir(PPy)₃ | TPBi | LiF/Al |
| Ex.7 | HAT-CN | TBB | Compound (1-1048) | Ir(PPy)₃ | TPBi | LiF/Al |
| Ex.8 | HAT-CN | TBB | Compound (1-1049) | Ir(PPy)₃ | TPBi | LiF/Al |
| Ex.9 | HAT-CN | TBB | Compound (1-1050) | Ir(PPy)₃ | TPBi | LiF/Al |
| Ex.10 | HAT-CN | TBB | Compound (1-100) | Ir(PPy)₃ | TPBi | LiF/Al |
| Ex.11 | HAT-CN | TBB | Compound (1-49) | Ir(PPy)₃ | TPBi | LiF/Al |
| Ex.12 | HAT-CN | TBB | Compound (1-176) | Ir(PPy)₃ | TPBi | LiF/Al |
| Ex.13 | HAT-CN | TBB | Compound (1-1069) | Ir(PPy)₃ | TPBi | LiF/Al |
| Ex.14 | HAT-CN | TBB | Compound (1-1201) | Ir(PPy)₃ | TPBi | LiF/Al |

### <Example 6>

### <Element using compound (1-152) as host material of light emitting layer>

An organic EL element was obtained by a method equivalent to that of Example 5, except that the compound (1-91) as the host material of the light emitting layer was changed to compound (1-152). When a direct current voltage was applied to the two electrodes, green light emission having a peak top at about 512 nm was obtained. The external quantum efficiency at a luminance of 1000 cd/m² was 9.36%. The external quantum efficiency at a luminance of 100 cd/m² was 13.26%.

### <Example 7>

### <Element using compound (1-1048) as host material of light emitting layer>

An organic EL element was obtained by a method equivalent to that of Example 5, except that the compound (1-91) as the host material of the light emitting layer was changed to compound (1-1048). When a direct current voltage was applied to the two electrodes, green light emission having a peak top at about 512 nm was obtained. The external quantum efficiency at a luminance of 1000 cd/m² was 9.50%. The external quantum efficiency at a luminance of 100 cd/m² was 12.43%.

### <Example 8>

### <Element using compound (1-1049) as host material of light emitting layer>

An organic EL element was obtained by a method equivalent to that of Example 5, except that the compound (1-91) as the host material of the light emitting layer was changed to compound (1-1049). When a direct current voltage was applied to the two electrodes, green light emission having a peak top at about 512 nm was obtained. The external quantum efficiency at a luminance of 1000 cd/m² was 6.54%. The external quantum efficiency at a luminance of 100 cd/m² was 7.44%.

### <Example 9>

### <Element using compound (1-1050) as host material of light emitting layer>

An organic EL element was obtained by a method equivalent to that of Example 5, except that the compound (1-91) as the host material of the light emitting layer was changed to compound (1-1050). When a direct current voltage was applied to the two electrodes, green light emission having a peak top at about 512 nm was obtained. The external quantum efficiency at a luminance of 1000 cd/m² was 10.98%. The external quantum efficiency at a luminance of 100 cd/m² was 12.32%.

### <Example 10>

### <Element using compound (1-100) as host material of light emitting layer>

An organic EL element was obtained by a method equivalent to that of Example 5, except that the compound (1-91) as the host material of the light emitting layer was changed to compound (1-100). When a direct current voltage was applied to the two electrodes, green light emission having a peak top at about 512 nm was obtained. The external quantum efficiency at a luminance of 1000 cd/m² was 5.73%. The external quantum efficiency at a luminance of 100 cd/m² was 8.75%.

### <Example 11>

### <Element using compound (1-49) as host material of light emitting layer>

An organic EL element was obtained by a method equivalent to that of Example 5, except that the compound (1-91) as the host material of the light emitting layer was changed to compound (1-49) . When a direct current voltage was applied to the two electrodes, green light emission having a peak top at about 512 nm was obtained. The external quantum efficiency at a luminance of 1000 cd/m² was 7.33%. The external quantum efficiency at a luminance of 100 cd/m² was 10.36%.

### <Example 12>

### <Element using compound (1-176) as host material of light emitting layer>

An organic EL element was obtained by a method equivalent to that of Example 5, except that the compound (1-91) as the host material of the light emitting layer was changed to compound (1-176). When a direct current voltage was applied to the two electrodes, green light emission having a peak top at about 512 nm was obtained. The external quantum efficiency at a luminance of 1000 cd/m² was 10.74%. The external quantum efficiency at a luminance of 100 cd/m² was 11.77%.

### <Example 13>

### <Element using compound (1-1069) as host material of light emitting layer>

An organic EL element was obtained by a method equivalent to that of Example 5, except that the compound (1-91) as the host material of the light emitting layer was changed to compound (1-1069) . When a direct current voltage was applied to the two electrodes, green light emission having a peak top at about 512 nm was obtained. The external quantum efficiency at a luminance of 1000 cd/m² was 8.96%. The external quantum efficiency at a luminance of 100 cd/m² was 11.80%.

### <Example 14>

### <Element using compound (1-1201) as host material of light emitting layer>

An organic EL element was obtained by a method equivalent to that of Example 5, except that the compound (1-91) as the host material of the light emitting layer was changed to compound (1-1201). When a direct current voltage was applied to the two electrodes, green light emission having a peak top at about 512 nm was obtained. The external quantum efficiency at a luminance of 1000 cd/m² was 10.14%. The external quantum efficiency at a luminance of 100 cd/m² was 12.17%.

Furthermore, organic EL elements related to Examples 15 and 16 were produced, and the external quantum efficiency obtainable when each of the organic EL elements was driven at a current density that could give a luminance of 1000 cd/m², was measured. The material configurations of the various layers in the organic EL elements thus produced are shown in the following Table 5.

**[Table 5]**

| | Hole Injection Layer 1 (40nm) | Hole Injection Layer 2 (5nm) | Hole Transport Layer (25nm) | Light Emitting Layer (20nm) | | Electron Transport Layer 2 (20nm) | Electron Transport Layer 1 (10nm) | Negative Electrode (1nm/100nm) |
|---|---|---|---|---|---|---|---|---|
| | | | | Host | Dopant | | | |
| Ex. 15 | HI | HAT-CN | HT | BH1 | Compound (1-1145) | ET-2 | ET-1 | LiF /Al |
| Ex. 16 | HI | HAT-CN | HT | BH1 | Compound (1-401) | ET-2 | ET-1 | LiF /Al |

### <Example 15>

### <Element using compound (1-1145) as dopant material of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Showa Shinku Co., Ltd.), and a vapor deposition boat made of molybdenum and containing HI, a vapor deposition boat made of molybdenum and containing HAT-CN, a vapor deposition boat made of molybdenum and containing HT, a vapor deposition boat made of molybdenum and containing BH1, a vapor deposition boat made of molybdenum and containing compound (1-1145) of the present invention, a vapor deposition boat made of molybdenum and containing ET-2, a vapor deposition boat made of molybdenum and containing ET-1, a vapor deposition boat made of molybdenum and containing LiF, and a vapor deposition boat made of tungsten and containing aluminum, were mounted in the apparatus.

Various layers as described below were formed sequentially on the ITO film of the transparent supporting substrate. The pressure in a vacuum chamber was reduced to 5 × 10⁻⁴ Pa, and first, a hole injection layer 1 was formed by heating the vapor deposition boat containing HI and thereby performing vapor deposition to obtain a film thickness of 40 nm. Subsequently, a hole injection layer 2 was formed by heating the vapor deposition boat containing HAT-CN and thereby performing deposition to obtain a film thickness of 5 nm. Furthermore, a hole transport layer was formed by heating the vapor deposition boat containing HT and thereby performing deposition to obtain a film thickness of 25 nm. Next, a light emitting layer was formed by simultaneously heating the vapor deposition boat containing BH1 and the vapor deposition boat containing compound (1-1145) and thereby performing deposition to obtain a film thickness of 20 nm. The rate of deposition was regulated such that the weight ratio of BH1 and the compound (1-1145) would be approximately 95 : 5. Next, an electron transport layer 2 was formed by heating the vapor deposition boat containing ET-2 and thereby performing deposition to obtain a film thickness of 20 nm, and an electron transport layer 1 was formed by heating the vapor deposition boat containing ET-1 and thereby performing deposition to obtain a film thickness of 10 nm. The rate of deposition for each layer was 0.01 to 1 nm/second.

Thereafter, the vapor deposition boat containing LiF was heated, and thereby vapor deposition was conducted at a rate of deposition of 0.01 to 0.1 nm/second so as to obtain a film thickness of 1 nm. Subsequently, a negative electrode was formed by heating the vapor deposition boat containing aluminum and thereby performing deposition at a rate of deposition of 0.01 to 2 nm/second so as to obtain a film thickness of 100 nm. Thus, an organic EL element was obtained.

When a direct current voltage was applied to the ITO electrode as the positive electrode and the LiF/aluminum electrode as the negative electrode, blue light emission having a peak top at about 449 nm was obtained. The external quantum efficiency at a luminance of 1000 cd/m² was 4.75%.

### <Example 16>

### <Element using compound (1-401) as dopant material of light emitting layer>

An organic EL element was obtained by a method equivalent to that of Example 15, except that the compound (1-1145) as the dopant material of the light emitting layer was changed to compound (1-401). When a direct current voltage was applied to the two electrodes, blue light emission having a peak top at about 458 nm was obtained. The external quantum efficiency at a luminance of 1000 cd/m² was 4.33%.

Furthermore, organic EL elements related to Examples 17 to 19 were produced, and the external quantum efficiency obtainable when each of the organic EL elements was driven at a current density that could give a luminance of 1000 cd/m², was measured. The material configurations of the various layers in the organic EL elements thus produced are shown in the following Table 6.

**[Table 6]**

| | Hole Injection Layer (10nm) | Hole Transport Layer 1 (20nm) | Hole Transport Layer 2 (10nm) | Light Emitting Layer (30nm) | | Electron Transport Layer (50nm) | Negative Electrode (1nm/100nm) |
|---|---|---|---|---|---|---|---|
| | | | | Host | Dopant | | |
| Ex.17 | HAT-CN | TBB | TcTa | Compound (1-1101) | Ir(PPy)₃ | TPBi | LiF/Al |
| Ex.18 | HAT-CN | TBB | TcTa | Compound (1-1102) | Ir(PPy)₃ | TPBi | LiF/Al |
| Ex.19 | HAT-CN | TBB | TcTa | Compound (1-1103) | Ir(PPy)₃ | TPBi | LiF/Al |

In Table 6, "TcTa" means tris(4-carbazolyl-9-ylphenyl)amine. The chemical structure thereof is shown below.

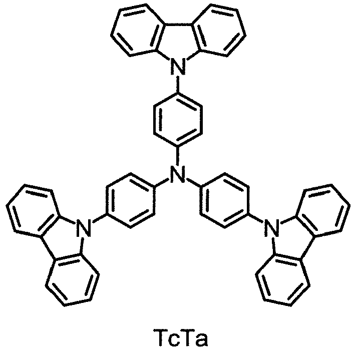

### <Example 17>

### <Element using compound (1-1101) as host material of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Choshu Industry Co., Ltd.), and a vapor deposition crucible made of tantalum and containing HAT-CN, a vapor deposition crucible made of tantalum and containing TBB, a vapor deposition crucible made of tantalum and containing TcTa, a vapor deposition crucible made of tantalum and containing compound (1-1101) of the present invention, a vapor deposition crucible made of tantalum and containing Ir(PPy)₃, a vapor deposition crucible made of tantalum and containing TPBi, a vapor deposition crucible made of tantalum and containing LiF, and a vapor deposition crucible made of aluminum nitride and containing aluminum, were mounted in the apparatus.

Various layers as described below were formed sequentially on the ITO film of the transparent supporting substrate. The pressure in a vacuum chamber was reduced to 2.0 × 10⁻⁴ Pa. First, the vapor deposition crucible containing HAT-CN was heated, and thereby vapor deposition was performed so as to obtain a film thickness of 10 nm. Subsequently, the vapor deposition crucible containing TBB was heated, and thereby vapor deposition was performed so as to obtain a film thickness of 20 nm. Further, the vapor deposition crucible containing TcTa was heated, and thereby vapor deposition was performed so as to obtain a film thickness of 20 nm. Thus, hole injection layers and hole transport layers composed of three layers were formed. Next, the vapor deposition crucible containing compound (1-1101) of the present invention and the vapor deposition crucible containing Ir(PPy)₃ were simultaneously heated, and thereby vapor deposition was performed so as to obtain a film thickness of 30 nm. Thus, a light emitting layer was formed. The rate of deposition was regulated such that the weight ratio of the compound (1-1101) of the present invention and Ir(PPy)₃ would be approximately 95 : 5. Next, the vapor deposition crucible containing TPBi was heated, and thereby vapor deposition was performed so as to obtain a film thickness of 50 nm. Thus, an electron transport layer was formed. The rate of deposition for each layer was 0.01 to 1 nm/second.

Thereafter, the vapor deposition crucible containing LiF was heated, and thereby vapor deposition was performed at a rate of deposition of 0.01 to 0.1 nm/second so as to obtain a film thickness of 1 nm. Subsequently, the vapor deposition crucible containing aluminum was heated, and thereby vapor deposition was performed so as to obtain a film thickness of 100 nm. Thus, a negative electrode was formed. At this time, the negative electrode was formed by performing vapor deposition at a rate of deposition of 0.1 nm/sec to 2 nm/sec, and thus an organic electroluminescent element was obtained.

When a direct current voltage was applied to the ITO electrode as the positive electrode and the LiF/aluminum electrode as the negative electrode, green light emission having a peak top at about 512 nm was obtained. The external quantum efficiency at a luminance of 1000 cd/m² was 10.09%.

### <Example 18>

### <Element using compound (1-1102) as host material of light emitting layer>

An organic EL element was obtained by a method equivalent to that of Example 17, except that the compound (1-1101) as the host material of the light emitting layer was changed to compound (1-1102). When a direct current voltage was applied to the two electrodes, green light emission having a peak top at about 512 nm was obtained. The external quantum efficiency at a luminance of 1000 cd/m² was 7.99%.

### <Example 19>

### <Element using compound (1-1103) as host material of light emitting layer>

An organic EL element was obtained by a method equivalent to that of Example 17, except that the compound (1-1101) as the host material of the light emitting layer was changed to compound (1-1103). When a direct current voltage was applied to the two electrodes, green light emission having a peak top at about 512 nm was obtained. The external quantum efficiency at a luminance of 1000 cd/m² was 9.05%.

Furthermore, organic EL elements related to Examples 20 and 21 were produced, and the external quantum efficiency obtainable when each of the organic EL elements was driven at a current density that could give a luminance of 1000 cd/m², was measured. The material configurations of the various layers in the organic EL elements thus produced are shown in the following Table 7.

**[Table 7]**

| | Hole Injection Layer (10nm) | Hole Transport Layer 1 (20nm) | Hole Transport Layer 2 (10nm) | Light Emitting Layer (30nm) | | Electron Transport Layer 1 | Electron Transport Layer 2 | Negative Electrode (1nm/100nm) |
|---|---|---|---|---|---|---|---|---|
| | | | | Host | Dopant | | | |
| Ex. 20 | HAT-CN | TBB | TcTa | CBP | Ir(PPy)₃ | Compound (1-1192) 50nm | - | LiF/Al |
| Ex. 21 | HAT-CN | TBB | TcTa | CBP | Ir(PPy)₃ | Compound (1-1192) 10nm | ET-3 40nm | LiF/Al |

In Table 7, "ET-3" means 3-(3-10-(naphthalen-2-yl)anthracen-9-yl)phenyl)pyridine. The chemical structure thereof is shown below.

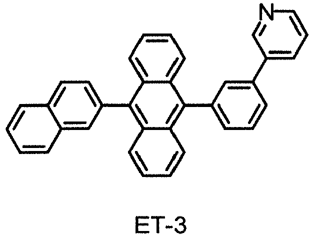

### <Example 22>

### <Element using compound (1-447) as dopant of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Choshu Industry Co., Ltd.), and a vapor deposition crucible made of tantalum and containing HI, a vapor deposition crucible made of tantalum and containing HAT-CN, a vapor deposition crucible made of tantalum and containing HT, a vapor deposition crucible made of tantalum and containing BH2, a vapor deposition crucible made of tantalum and containing compound (1-447) of the present invention, a vapor deposition crucible made of tantalum and containing ET-4, a vapor deposition crucible made of tantalum and containing ET-3, a vapor deposition crucible made of tantalum and containing LiF, and a vapor deposition crucible made of aluminum nitride and containing aluminum, were mounted in the apparatus.

Various layers as described below were formed sequentially on the ITO film of the transparent supporting substrate. The pressure in a vacuum chamber was reduced to 2.0 × 10⁻⁴ Pa. First, the vapor deposition crucible containing HI was heated, and thereby vapor deposition was performed so as to obtain a film thickness of 40 nm. Subsequently, the vapor deposition crucible containing HAT-CN was heated, and thereby vapor deposition was performed so as to obtain a film thickness of 5 nm. Further, the vapor deposition crucible containing HT was heated, and thereby vapor deposition was performed so as to obtain a film thickness of 25 nm. Thus, hole injection layers and hole transport layers composed of three layers were formed. Next, the vapor deposition crucible containing BH2 and the vapor deposition crucible containing the compound (1-447) of the present invention were simultaneously heated, and thereby vapor deposition was performed so as to obtain a film thickness of 20 nm. Thus, a light emitting layer was formed. The rate of deposition was regulated such that the weight ratio of BH2 and compound (1-447) of the present invention would be approximately 95 : 5. Next, the vapor deposition crucible containing ET-4 was heated, and thereby vapor deposition was performed so as to obtain a film thickness of 20 nm. Subsequently, the vapor deposition crucible containing ET-3 was heated, and thereby vapor deposition was performed so as to obtain a film thickness of 10 nm. Thus, an electron transport layer composed of two layers was formed. The rate of deposition for each layer was 0.01 to 1 nm/second.

Thereafter, the vapor deposition crucible containing LiF was heated, and thereby vapor deposition was performed at a rate of deposition of 0.01 to 0.1 nm/second so as to obtain a film thickness of 1 nm. Subsequently, the vapor deposition crucible containing aluminum was heated, and thereby vapor deposition was performed so as to obtain a film thickness of 100 nm. Thus, a negative electrode was formed. At this time, the negative electrode was formed by performing vapor deposition at a rate of deposition of 0.1 nm/sec to 2 nm/sec, and thus an organic electroluminescent element was obtained.

When a direct current voltage was applied to the ITO electrode as the positive electrode and the LiF/aluminum electrode as the negative electrode, blue light emission having a peak top at about 457 nm was obtained. The external quantum efficiency at a luminance of 1000 cd/m² was 6.15%.

Furthermore, organic EL elements related to Examples 23 to 27 were produced, and the external quantum efficiency obtainable when each of the organic EL elements was driven at a current density that could give a luminance of 1000 cd/m², was measured. The material configurations of the various layers in the organic EL elements thus produced are shown in the following Table 9.

**[Table 9]**

| | Hole Injection Layer 1 (40nm) | Hole Injection Layer 2 (5nm) | Hole Transport Layer (25nm) | Light Emitting Layer (20nm) | | Electron Transport Layer 1 (10nm) | Electron Transport Layer 2 (20nm) | Negative Electrode (1nm /100nm) |
|---|---|---|---|---|---|---|---|---|
| | | | | Host | Dopant | | | |
| Ex. 23 | HI | HAT-CN | HT | BH1 | BD1 | Compound (1-50) | ET-1 | LiF/Al |
| Ex. 24 | HI | HAT-CN | HT | BH1 | BD1 | Compound (1-49) | ET-1 | LiF/Al |
| Ex. 25 | HI | HAT-CN | HT | BH1 | BD1 | Compound (1-50) | ET-3 | LiF/Al |
| Ex. 26 | HI | HAT-CN | HT | BH1 | BD1 | Compound (1-49) | ET-3 | LiF/Al |
| Ex. 27 | HI | HAT-CN | HT | BH1 | BD1 | Compound (1-50) (30nm) | - | LiF/Al |
| Ex. 28 | HI | HAT-CN | HT | BH1 | BD1 | Compound (1-1050) (30nm) | - | LiF/Al |
| Ex. 29 | HI | HAT-CN | HT | BH1 | BD1 | Compound (1-1102) (30nm) | - | LiF/Al |
| Ex. 30 | HI | HAT-CN | HT | BH1 | BD1 | Compound (1-1050) | ET-1 | LiF/Al |
| Ex. 31 | HI | HAT-CN | HT | BH1 | BD1 | Compound (1-1102) | ET-1 | LiF/Al |

In Table 9, "BD1" means 7,7-dimethyl-N⁵,N⁹-diphenyl-N⁵,N⁹-bis(4-(trimethylsilyl)phen yl)-7H-benzo[c]fluorene-5,9-diamine. The chemical structure thereof is shown below.

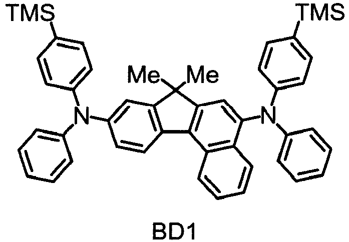

### <Example 23>

### <Element using compound (1-50) in electron transport layer 1 and ET-1 in electron transport layer 2>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Choshu Industry Co., Ltd.), and a vapor deposition crucible made of tantalum and containing HI, a vapor deposition crucible made of tantalum and containing HAT-CN, a vapor deposition crucible made of tantalum and containing HT, a vapor deposition crucible made of tantalum and containing BH1, a vapor deposition crucible made of tantalum and containing BD1, a vapor deposition crucible made of tantalum and containing the compound (1-50) of the present invention, a vapor deposition crucible made of tantalum and containing ET-1, a vapor deposition crucible made of tantalum and containing ET-3, a vapor deposition crucible made of tantalum and containing LiF, and a vapor deposition crucible made of aluminum nitride and containing aluminum, were mounted in the apparatus.

Various layers as described below were formed sequentially on the ITO film of the transparent supporting substrate. The pressure in a vacuum chamber was reduced to 2.0 × 10⁻⁴ Pa. First, the vapor deposition crucible containing HI was heated, and thereby vapor deposition was performed so as to obtain a film thickness of 40 nm. Subsequently, the vapor deposition crucible containing HAT-CN was heated, and thereby vapor deposition was performed so as to obtain a film thickness of 5 nm. Further, the vapor deposition crucible containing HT was heated, and thereby vapor deposition was performed so as to obtain a film thickness of 25 nm. Thus, hole injection layers and hole transport layers composed of three layers were formed. Next, the vapor deposition crucible containing BH1 and the vapor deposition crucible containing BD1 were simultaneously heated, and thereby vapor deposition was performed so as to obtain a film thickness of 20 nm. Thus, a light emitting layer was formed. The rate of deposition was regulated such that the weight ratio of BH1 and BD1 would be approximately 95 : 5. Next, the vapor deposition crucible containing the compound (1-50) of the present invention was heated, and thereby vapor deposition was performed so as to obtain a film thickness of 10 nm. Subsequently, the vapor deposition crucible containing ET-1 was heated, and thereby vapor deposition was performed so as to obtain a film thickness of 20 nm. Thus, an electron transport layer composed of two layers was formed. The rate of deposition for each layer was 0.01 to 1 nm/second.

Thereafter, the vapor deposition crucible containing LiF was heated, and thereby vapor deposition was performed at a rate of deposition of 0.01 to 0.1 nm/second so as to obtain a film thickness of 1 nm. Subsequently, the vapor deposition crucible containing aluminum was heated, and thereby vapor deposition was performed so as to obtain a film thickness of 100 nm. Thus, a negative electrode was formed. At this time, the negative electrode was formed by performing vapor deposition at a rate of deposition of 0.1 nm/sec to 2 nm/sec, and thus an organic electroluminescent element was obtained.

When a direct current voltage was applied to the ITO electrode as the positive electrode and the LiF/aluminum electrode as the negative electrode, blue light emission having a peak top at about 456 nm was obtained. The external quantum efficiency at a luminance of 1000 cd/m² was 8.08%.

### <Example 24>

### <Element using compound (1-49) in electron transport layer 1 and ET-1 in electron transport layer 2>

An organic EL element was obtained by a method equivalent to that of Example 23, except that the material of the electron transport layer 1 was changed to compound (1-49) . When a direct current voltage was applied to the two electrodes, blue light emission having a peak top at about 456 nm was obtained. The external quantum efficiency at a luminance of 1000 cd/m² was 8.86%.

### <Example 25>

### <Element using compound (1-50) in electron transport layer 1 and ET-3 in electron transport layer 2>

An organic EL element was obtained by a method equivalent to that of Example 23, except that the material of the electron transport layer 2 was changed to ET-3. When a direct current voltage was applied to the two electrodes, blue light emission having a peak top at about 456 nm was obtained. The external quantum efficiency at a luminance of 1000 cd/m² was 8.16%.

### <Example 26>

### <Element using compound (1-49) in electron transport layer 1 and ET-3 in electron transport layer 2>

An organic EL element was obtained by a method equivalent to that of Example 23, except that the material of the electron transport layer 1 was changed to the compound (1-49), and the material of the electron transport layer 2 to ET-3. When a direct current voltage was applied to the two electrodes, blue light emission having a peak top at about 456 nm was obtained. The external quantum efficiency at a luminance of 1000 cd/m² was 8.94%.

### <Example 27>

### <Element using compound (1-50) in electron transport layer 1>

An organic EL element was obtained by a method equivalent to that of Example 23, except that the electron transport layer 2 was removed, and the film thickness of the electron transport layer 1 was changed to 30 nm. When a direct current voltage was applied to the two electrodes, blue light emission having a peak top at about 456 nm was obtained. The external quantum efficiency at a luminance of 1000 cd/m² was 4.63%.

### <Example 28>

### <Element using compound (1-1050) in electron transport layer 1>

An organic EL element was obtained by a method equivalent to that of Example 23, except that the electron transport layer 2 was removed, and the film thickness of the electron transport layer 1 was changed to 30 nm. When a direct current voltage was applied to the two electrodes, blue light emission having a peak top at about 456 nm was obtained. The external quantum efficiency at a luminance of 1000 cd/m² was 3.39%.

### <Example 29>

### <Element using compound (1-1102) in electron transport layer 1>

An organic EL element was obtained by a method equivalent to that of Example 23, except that the electron transport layer 2 was removed, and the film thickness of the electron transport layer 1 was changed to 30 nm. When a direct current voltage was applied to the two electrodes, blue light emission having a peak top at about 456 nm was obtained. The external quantum efficiency at a luminance of 1000 cd/m² was 4.54%.

### <Example 30>

### <Element using compound (1-1050) in electron transport layer 1 and ET-1 in electron transport layer 2>

An organic EL element was obtained by a method equivalent to that of Example 23, except that the material of the electron transport layer 1 was changed to compound (1-1050). When a direct current voltage was applied to the two electrodes, blue light emission having a peak top at about 456 nm was obtained. The external quantum efficiency at a luminance of 1000 cd/m² was 7.88%.

### <Example 31>

### <Element using compound (1-1102) in electron transport layer 1 and ET-1 in electron transport layer 2>

An organic EL element was obtained by a method equivalent to that of Example 23, except that the material of the electron transport layer 1 was changed to compound (1-1102). When a direct current voltage was applied to the two electrodes, blue light emission having a peak top at about 456 nm was obtained. The external quantum efficiency at a luminance of 1000 cd/m² was 8.54%.

Furthermore, organic EL elements related to Examples 32 to 34 were produced, and the external quantum efficiency obtainable when each of the organic EL elements was driven at a current density that could give a luminance of 1000 cd/m², was measured. The material configurations of the various layers in the organic EL elements thus produced are shown in the following Table 10.

**[Table 10]**

| | Hole injection layer 1 (40nm) | Hole injection layer 2 (5nm) | Hole transport layer (25nm) | Light emitting layer (20nm) | | Electron transport layer 1 (10nm) | Electron transport layer 2 (20nm) | Negative electrode (1nm /100nm) |
|---|---|---|---|---|---|---|---|---|
| | | | | Host | Dopant | | | |
| Ex. 32 | HI | HAT-CN | HT | BH1 | Compound 1-422 | Compound 1-49 | ET-1 | LiF/Al |
| Ex. 33 | HI | HAT-CN | HT | BH1 | Compound 1-1152 | Compound 1-49 | ET-1 | LiF/Al |
| Ex. 34 | HI | HAT-CN | HT | BH1 | Compound 1-1159 | Compound 1-49 | ET-1 | LiF/Al |

### <Example 32>

### <Element using compound (1-422) as dopant for light emitting layer and compound (1-49) in electron transport layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Choshu Industry Co., Ltd.), and a vapor deposition crucible made of tantalum and containing HI, a vapor deposition crucible made of tantalum and containing HAT-CN, a vapor deposition crucible made of tantalum and containing HT, a vapor deposition crucible made of tantalum and containing BH1, a vapor deposition crucible made of tantalum and containing compound (1-422) of the present invention, a vapor deposition crucible made of tantalum and containing compound (1-49) of the present invention, a vapor deposition crucible made of tantalum and containing ET-1, a vapor deposition crucible made of tantalum and containing LiF, and a vapor deposition crucible made of aluminum nitride and containing aluminum, were mounted in the apparatus.

Various layers as described below were formed sequentially on the ITO film of the transparent supporting substrate. The pressure in a vacuum chamber was reduced to 2.0 × 10⁻⁴ Pa. First, the vapor deposition crucible containing HI was heated, and thereby vapor deposition was performed so as to obtain a film thickness of 40 nm. Subsequently, the vapor deposition crucible containing HAT-CN was heated, and thereby vapor deposition was performed so as to obtain a film thickness of 5 nm. Further, the vapor deposition crucible containing HT was heated, and thereby vapor deposition was performed so as to obtain a film thickness of 25 nm. Thus, hole injection layers and hole transport layers composed of three layers were formed. Next, the vapor deposition crucible containing BH1 and the vapor deposition crucible containing compound (1-422) of the present invention were simultaneously heated, and thereby vapor deposition was performed so as to obtain a film thickness of 20 nm. Thus, a light emitting layer was formed. The rate of deposition was regulated such that the weight ratio of BH1 and the compound (1-422) of the present invention would be approximately 95 : 5. Next, the vapor deposition crucible containing compound (1-49) of the present invention was heated, and thereby vapor deposition was performed so as to obtain a film thickness of 10 nm. Subsequently, the vapor deposition crucible containing ET-1 was heated, and thereby vapor deposition was performed so as to obtain a film thickness of 20 nm. Thus, electron transport layers composed of two layers were formed. The rate of deposition for each of the layers was 0.01 to 1 nm/second.

Thereafter, the vapor deposition crucible containing LiF was heated, and thereby vapor deposition was performed at a rate of deposition of 0.01 to 0.1 nm/second so as to obtain a film thickness of 1 nm. Subsequently, the vapor deposition crucible containing aluminum was heated, and thereby vapor deposition was performed so as to obtain a film thickness of 100 nm. Thus, a negative electrode was formed. At this time, the negative electrode was formed by performing vapor deposition at a rate of deposition of 0.1 nm/sec to 2 nm/sec, and thus an organic electroluminescent element was obtained.

When a direct current voltage was applied to the ITO electrode as the positive electrode and the LiF/aluminum electrode as the negative electrode, blue light emission having a peak top at about 479 nm was obtained. The CIE chromaticity at that time was (x, y) = (0.096, 0.189), and the external quantum efficiency at a luminance of 1000 cd/m² was 4.74%.

### <Example 33>

### <Element using compound (1-1152) as dopant material for light emitting layer and using compound (1-49) in electron transport layer>

An organic EL element was obtained by a method equivalent to that of Example 32, except that the compound (1-422), which was a dopant material for the light emitting layer, was changed to compound (1-1152). When a direct current voltage was applied to the two electrodes, blue light emission having a peak top at about 465 nm was obtained. The CIE chromaticity was (x, y) = (0.127, 0.099), and the external quantum efficiency at a luminance of 1000 cd/m² was 5.47%.

### <Example 34>

### <Element using compound (1-1159) as dopant material of light emitting layer and compound (1-49) in electron transport layer>

An organic EL element was obtained by a method equivalent to that of Example 32, except that the compound (1-422), which was a dopant material for the light emitting layer, was changed to compound (1-1159). When a direct current voltage was applied to the two electrodes, blue light emission having a peak top at about 456 nm was obtained. The CIE chromaticity was (x, y) = (0.140, 0.057), and the external quantum efficiency at a luminance of 1000 cd/m² was 6.92%.

Furthermore, organic EL elements related to Examples 35 to 53 were produced, and the external quantum efficiency obtainable when each of the organic EL elements was driven at a current density that could give a luminance of 1000 cd/m², was measured. The material configurations of the various layers in the organic EL elements thus produced are shown in the following Table 11.

**[Table 11]**

| | Hole injection layer 1 (40nm) | Hole injection layer 2 (5nm) | Hole transport layer (25nm) | Light emitting layer (20nm) | | Electron transport layer 1 (5nm) | Electron transport layer 2 (25nm) | Negative electrode (1nm /100nm) |
|---|---|---|---|---|---|---|---|---|
| | | | | Host | Dopant | | | |
| Ex. 35 | HI | HAT-CN | HT | BH1 | Compound 1-79 | ET-5 | ET-6 | Liq/MgAg |
| Ex. 36 | HI | HAT-CN | HT | BH1 | Compound 1-2305 | ET-5 | ET-6 | Liq/MgAg |
| Ex. 37 | HI | HAT-CN | HT | BH1 | Compound 1-2680 | ET-5 | ET-6 | Liq/MgAg |
| Ex. 38 | HI | HAT-CN | HT | BH1 | Compound 1-2679 | ET-5 | ET-6 | Liq/MgAg |
| Ex. 39 | HI | HAT-CN | HT | BH1 | Compound 1-422 | ET-5 | ET-6 | Liq/MgAg |
| Ex. 40 | HI | HAT-CN | HT | BH1 | Compound 1-447 | ET-5 | ET-6 | Liq/MgAg |
| Ex. 41 | HI | HAT-CN | HT | BH1 | Compound 1-1145 | ET-5 | ET-6 | Liq/MgAg |
| Ex. 42 | HI | HAT-CN | HT | BH1 | Compound 1-1104 | ET-5 | ET-6 | Liq/MgAg |
| Ex. 43 | HI | HAT-CN | HT | BH1 | Compound 1-142 | ET-5 | ET-6 | Liq/MgAg |
| Ex. 44 | HI | HAT-CN | HT | BH1 | Compound 1-2681 | ET-5 | ET-6 | Liq/MgAg |
| Ex. 45 | HI | HAT-CN | HT | BH1 | Compound 1-2682 | ET-5 | ET-6 | Liq/MgAg |
| Ex. 46 | HI | HAT-CN | HT | BH1 | Compound 1-422 | ET-5 | ET-6 | Liq/MgAg |
| Ex. 47 | HI | HAT-CN | HT | BH1 | Compound 1-1210 | ET-5 | ET-6 | Liq/MgAg |
| Ex. 48 | HI | HAT-CN | HT | BH1 | Compound 1-1201 | ET-5 | ET-6 | Liq/MgAg |
| Ex. 49 | HI | HAT-CN | HT | BH1 | Compound 1-2626 | ET-5 | ET-6 | Liq/MgAg |
| Ex. 50 | HI | HAT-CN | HT | BH1 | Compound 1-2683 | ET-5 | ET-6 | Liq/MgAg |
| Ex. 51 | HI | HAT-CN | HT | BH1 | Compound 1-2657 | ET-5 | ET-6 | Liq/MgAg |
| Ex. 52 | HI | HAT-CN | HT | BH1 | Compound 1-2699 | ET-5 | ET-6 | Liq/MgAg |
| Ex. 53 | HI | HAT-CN | HT | BH1 | Compound 1-2676 | ET-5 | ET-6 | Liq/MgAg |
| Comp. Ex. 1 | HI | HAT-CN | HT | BH1 | Comparative Compound 1 | ET-5 | ET-6 | Liq/MgAg |

In Table 11, "ET-5" means 9-(7-(dimesitylboryl)-9,9-dimethyl-9H-fluoren-2-yl)-3,6-dim ethyl-9H-carbazole, and "ET-6" means 5,5'-((2-phenylanthracene-9,10-diyl)bis(3,1-phenylene))bis( 3-methylpyridine). The chemical structures thereof as well as the chemical structure of "Liq" used in the negative electrode are shown below.

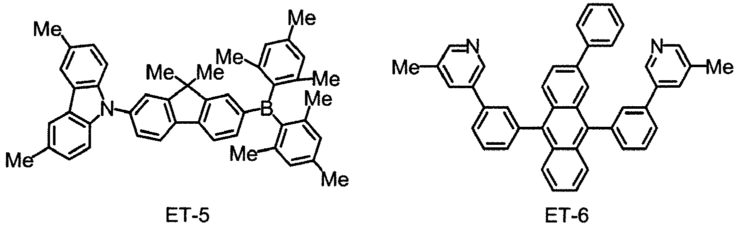

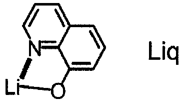

### <Example 35>

### <Element using compound (1-79) as dopant of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Choshu Industry Co., Ltd.), and a vapor deposition crucible made of tantalum and containing HI, a vapor deposition crucible made of tantalum and containing HAT-CN, a vapor deposition crucible made of tantalum and containing HT, a vapor deposition crucible made of tantalum and containing BH1, a vapor deposition crucible made of tantalum and containing compound (1-79) of the present invention, a vapor deposition crucible made of tantalum and containing ET-5, a vapor deposition crucible made of tantalum and containing ET-6, a vapor deposition crucible made of aluminum nitride and containing Liq, a crucible made of aluminum nitride and containing magnesium, and a vapor deposition crucible made of aluminum nitride and containing silver, were mounted in the apparatus.

Various layers as described below were formed sequentially on the ITO film of the transparent supporting substrate. The pressure in a vacuum chamber was reduced to 2.0 × 10⁻⁴ Pa. First, the vapor deposition crucible containing HI was heated, and thereby vapor deposition was performed so as to obtain a film thickness of 40 nm. Subsequently, the vapor deposition crucible containing HAT-CN was heated, and thereby vapor deposition was performed so as to obtain a film thickness of 5 nm. Further, the vapor deposition crucible containing HT was heated, and thereby vapor deposition was performed so as to obtain a film thickness of 25 nm. Thus, hole injection layers and hole transport layers composed of three layers were formed. Next, the vapor deposition crucible containing BH1 and the vapor deposition crucible containing compound (1-79) of the present invention were simultaneously heated, and thereby vapor deposition was performed so as to obtain a film thickness of 20 nm. Thus, a light emitting layer was formed. The rate of deposition was regulated such that the weight ratio of BH1 and the compound (1-79) of the present invention would be approximately 95 : 5. Next, the vapor deposition crucible containing ET-5 was heated, and thereby vapor deposition was performed so as to obtain a film thickness of 5 nm. Subsequently, the vapor deposition crucible containing ET-6 was heated, and thereby vapor deposition was performed so as to obtain a film thickness of 25 nm. Thus, electron transport layers composed of two layers were formed. The rate of deposition for each of the layers was 0.01 to 1 nm/second.

Thereafter, the vapor deposition crucible containing Liq was heated, and thereby vapor deposition was performed at a rate of deposition of 0.01 to 0.1 nm/second so as to obtain a film thickness of 1 nm. Subsequently, the boat containing magnesium and the boat containing silver were simultaneously heated, and thereby vapor deposition was performed so as to obtain a film thickness of 100 nm. Thus, a negative electrode was formed, and an organic electroluminescent element was obtained. At this time, the rate of deposition was regulated to be in the range between 0.1 nm/sec to 10 nm/sec so that the ratio of the numbers of atoms of magnesium and silver would be 10 : 1.

When a direct current voltage was applied to the ITO electrode as the positive electrode and the magnesium/silver electrode as the negative electrode, blue light emission having a peak top at about 445 nm was obtained. The CIE chromaticity at that time was (x, y) = (0.148, 0.065), and the external quantum efficiency at a luminance of 1000 cd/m² was 3.54%.

### <Example 36>

### <Element using compound (1-2305) as dopant material of light emitting layer>

An organic EL element was obtained by a method equivalent to that of Example 35, except that the compound (1-79), which was a dopant material for the light emitting layer, was changed to compound (1-2305) . When a direct current voltage was applied to the two electrodes, blue light emission having a peak top at about 459 nm was obtained. The CIE chromaticity was (x, y) = (0.142, 0.113), and the external quantum efficiency at a luminance of 1000 cd/m² was 4.50%.

### <Example 37>

### <Element using compound (1-2680) as dopant material of light emitting layer>

An organic EL element was obtained by a method equivalent to that of Example 35, except that the compound (1-79), which was a dopant material for the light emitting layer, was changed to compound (1-2680). When a direct current voltage was applied to the two electrodes, blue light emission having a peak top at about 455 nm was obtained. The CIE chromaticity was (x, y) = (0.142, 0.051), and the external quantum efficiency at a luminance of 1000 cd/m² was 6.14%.

### <Example 38>

### <Element using compound (1-2679) as dopant material of light emitting layer>

An organic EL element was obtained by a method equivalent to that of Example 35, except that the compound (1-79), which was a dopant material for the light emitting layer, was changed to compound (1-2679). When a direct current voltage was applied to the two electrodes, blue light emission having a peak top at about 463 nm was obtained. The CIE chromaticity was (x, y) = (0.129, 0.084), and the external quantum efficiency at a luminance of 1000 cd/m² was 6.42%.

### <Example 39>

### <Element using compound (1-422) as dopant material of light emitting layer>

An organic EL element was obtained by a method equivalent to that of Example 35, except that the compound (1-79), which was a dopant material for the light emitting layer, was changed to compound (1-422). When a direct current voltage was applied to the two electrodes, blue light emission having a peak top at about 464 nm was obtained. The CIE chromaticity was (x, y) = (0.127, 0.094), and the external quantum efficiency at a luminance of 1000 cd/m² was 5.66%.

### <Example 40>

### <Element using compound (1-447) as dopant material of light emitting layer>

An organic EL element was obtained by a method equivalent to that of Example 35, except that the compound (1-79), which was a dopant material for the light emitting layer, was changed to compound (1-447). When a direct current voltage was applied to the two electrodes, blue light emission having a peak top at about 449 nm was obtained. The CIE chromaticity was (x, y) = (0.148, 0.041), and the external quantum efficiency at a luminance of 1000 cd/m² was 4.49%.

### <Example 41>

### <Element using compound (1-1145) as dopant material of light emitting layer>

An organic EL element was obtained by a method equivalent to that of Example 35, except that the compound (1-79), which was a dopant material for the light emitting layer, was changed to compound (1-1145) . When a direct current voltage was applied to the two electrodes, blue light emission having a peak top at about 451 nm was obtained. The CIE chromaticity was (x, y) = (0.146, 0.059), and the external quantum efficiency at a luminance of 1000 cd/m² was 6.50%.

### <Example 42>

### <Element using compound (1-1104) as dopant material of light emitting layer>

An organic EL element was obtained by a method equivalent to that of Example 35, except that the compound (1-79), which was a dopant material for the light emitting layer, was changed to compound (1-1104) . When a direct current voltage was applied to the two electrodes, blue light emission having a peak top at about 462 nm was obtained. The CIE chromaticity was (x, y) = (0.145, 0.144), and the external quantum efficiency at a luminance of 1000 cd/m² was 2.75%.

### <Example 43>

### <Element using compound (1-142) as dopant material of light emitting layer>

An organic EL element was obtained by a method equivalent to that of Example 35, except that the compound (1-79), which was a dopant material for the light emitting layer, was changed to compound (1-142). When a direct current voltage was applied to the two electrodes, blue light emission having a peak top at about 470 nm was obtained. The CIE chromaticity was (x, y) = (0.140, 0.196), and the external quantum efficiency at a luminance of 1000 cd/m² was 3.85%.

### <Example 44>

### <Element using compound (1-2681) as dopant material of light emitting layer>

An organic EL element was obtained by a method equivalent to that of Example 35, except that the compound (1-79), which was a dopant material for the light emitting layer, was changed to compound (1-2681) . When a direct current voltage was applied to the two electrodes, blue light emission having a peak top at about 465 nm was obtained. The CIE chromaticity was (x, y) = (0.127, 0.091), and the external quantum efficiency at a luminance of 1000 cd/m² was 5.25%.

### <Example 45>

### <Element using compound (1-2682) as dopant material of light emitting layer>

An organic EL element was obtained by a method equivalent to that of Example 35, except that the compound (1-79), which was a dopant material for the light emitting layer, was changed to compound (1-2682) . When a direct current voltage was applied to the two electrodes, blue light emission having a peak top at about 457 nm was obtained. The CIE chromaticity was (x, y) = (0.139, 0.059), and the external quantum efficiency at a luminance of 1000 cd/m² was 5.83%.

### <Example 46>

### <Element using compound (1-422) as dopant material of light emitting layer>

An organic EL element was obtained by a method equivalent to that of Example 35, except that the compound (1-79), which was a dopant material for the light emitting layer, was changed to compound (1-422). When a direct current voltage was applied to the two electrodes, blue light emission having a peak top at about 478 nm was obtained. The CIE chromaticity was (x, y) = (0.096, 0.184), and the external quantum efficiency at a luminance of 1000 cd/m² was 5.53%.

### <Example 47>

### <Element using compound (1-1210) as dopant material of light emitting layer>

An organic EL element was obtained by a method equivalent to that of Example 35, except that the compound (1-79), which was a dopant material for the light emitting layer, was changed to compound (1-1210). When a direct current voltage was applied to the two electrodes, blue light emission having a peak top at about 439 nm was obtained. The CIE chromaticity was (x, y) = (0.155, 0.029), and the external quantum efficiency at a luminance of 1000 cd/m² was 4.38%.

### <Example 48>

### <Element using compound (1-1201) as dopant material of light emitting layer>

An organic EL element was obtained by a method equivalent to that of Example 35, except that the compound (1-79), which was a dopant material for the light emitting layer, was changed to compound (1-1201). When a direct current voltage was applied to the two electrodes, blue light emission having a peak top at about 439 nm was obtained. The CIE chromaticity was (x, y) = (0.153, 0.042), and the external quantum efficiency at a luminance of 1000 cd/m² was 3.67%.

### <Example 49>

### <Element using compound (1-2626) as dopant material of light emitting layer>

An organic EL element was obtained by a method equivalent to that of Example 35, except that the compound (1-79), which was a dopant material for the light emitting layer, was changed to compound (1-2626) . When a direct current voltage was applied to the two electrodes, blue light emission having a peak top at about 462 nm was obtained. The CIE chromaticity was (x, y) = (0.131, 0.078), and the external quantum efficiency at a luminance of 1000 cd/m² was 5.66%.

### <Example 50>

### <Element using compound (1-2683) as dopant material of light emitting layer>

An organic EL element was obtained by a method equivalent to that of Example 35, except that the compound (1-79), which was a dopant material for the light emitting layer, was changed to compound (1-2683). When a direct current voltage was applied to the two electrodes, blue light emission having a peak top at about 456 nm was obtained. The CIE chromaticity was (x, y) = (0.140, 0.057), and the external quantum efficiency at a luminance of 1000 cd/m² was 5.64%.

### <Example 51>

### <Element using compound (1-2657) as dopant material of light emitting layer>

An organic EL element was obtained by a method equivalent to that of Example 35, except that the compound (1-79), which was a dopant material for the light emitting layer, was changed to compound (1-2657). When a direct current voltage was applied to the two electrodes, blue light emission having a peak top at about 466 nm was obtained. The CIE chromaticity was (x, y) = (0.124, 0.125), and the external quantum efficiency at a luminance of 1000 cd/m² was 5.28%.

### <Example 52>

### <Element using compound (1-2699) as dopant material of light emitting layer>

An organic EL element was obtained by a method equivalent to that of Example 35, except that the compound (1-79), which was a dopant material for the light emitting layer, was changed to compound (1-2699). When a direct current voltage was applied to the two electrodes, blue light emission having a peak top at about 459 nm was obtained. The CIE chromaticity was (x, y) = (0.133, 0.091), and the external quantum efficiency at a luminance of 1000 cd/m² was 5.18%.

### <Example 53>

### <Element using compound (1-2676) as dopant material of light emitting layer>

An organic EL element was obtained by a method equivalent to that of Example 35, except that the compound (1-79), which was a dopant material for the light emitting layer, was changed to compound (1-2676). When a direct current voltage was applied to the two electrodes, blue light emission having a peak top at about 459 nm was obtained. The CIE chromaticity was (x, y) = (0.124, 0.111), and the external quantum efficiency at a luminance of 1000 cd/m² was 6.82%.

### <Comparative Example 1>

### <Element using Comparative Compound 1 as dopant material of light emitting layer>

Comparative Compound 1 is disclosed as compound 1 on page 63 of WO 2012/118164. An organic EL element was obtained by a method equivalent to that of Example 35, except that the compound (1-79), which was a dopant material for the light emitting layer, was changed to (Comparative Compound 1). When a direct current voltage was applied to the two electrodes, blue light emission having a peak top at about 471 nm was obtained. The CIE chromaticity was (x, y) = (0.145, 0.170), and the external quantum efficiency at a luminance of 1000 cd/m² was 3.67%.

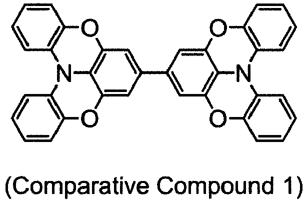

Furthermore, organic EL elements related to Examples 54 to 61 were produced, and the external quantum efficiency obtainable when each of the organic EL elements was driven at a current density that could give a luminance of 1000 cd/m², was measured. The material configurations of the various layers in the organic EL elements thus produced are shown in the following Table 12.

**[Table 12]**

| | Hole inj ection layer 1 (5nm) | Hole injection layer 2 (55nm) | Hole transport layer (10nm) | Light emitting layer (30nm) | | Electron transport layer 1 (5nm) | Electron transport layer 2 (35nm) | Negative electrode /100nm) |
|---|---|---|---|---|---|---|---|---|
| | | | | Host | Dopant | | | |
| Ex. 54 | HAT-CN | TBB | TcTa | CBP | Ir(PPy)₃ | Compound 1-3588 | ET-1 | LiF/Al |
| Ex. 55 | HAT-CN | TBB | TcTa | CBP | Ir(PPy)₃ | Compound 1-1192 | ET-1 | LiF/Al |
| Ex. 56 | HAT-CN | TBB | TcTa | CBP | Ir(PPy)₃ | Compound 1-3824 | ET-1 | LiF/Al |
| Ex. 57 | HAT-CN | TBB | TcTa | CBP | Ir(PPy)₃ | Compound 1-3806 | ET-1 | LiF/Al |
| Ex. 58 | HAT-CN | TBB | TcTa | CBP | Ir(PPy)₃ | Compound 1-601 | ET-1 | LiF/Al |
| Ex. 59 | HAT-CN | TBB | TcTa | Compound 1-152 | Ir(PPy)₃ | Compound 1-601 | ET-1 | LiF/Al |
| Ex. 60 | HAT-CN | TBB | TcTa | CBP | Ir(PPy)₃ | Compound 1-49 | ET-1 | LiF/Al |
| Ex. 61 | HAT-CN | TBB | TcTa | Compound 1-152 | Ir(PPy)₃ | Compound 1-49 | ET-1 | LiF/Al |
| Comp. Ex. | HAT-CN | TBB | TcTa | CBP | Ir(PPy)₃ | Comparative Compound 1 | ET-1 | LiF/Al |

### <Example 59>

### <Phosphorescent light emitting element using compound (1-152) as host of light emitting layer and compound (1-601) in electron transport layer 1>

An organic EL element was obtained by a method equivalent to that of Example 54, except that CBP, which was a host of the light emitting layer, was changed to compound (1-152), and the compound (1-3588), which was the electron transport layer 1, was changed to compound (1-601). When a direct current voltage was applied to the two electrodes, green light emission having a peak top at about 510 nm was obtained. The external quantum efficiency at a luminance of 1000 cd/m² was 17.24%.

### <Example 60>

### <Phosphorescent light emitting element using compound (1-49) in electron transport layer 2>

An organic EL element was obtained by a method equivalent to that of Example 54, except that the compound (1-3588), which was the electron transport layer 1, was changed to compound (1-49). When a direct current voltage was applied to the two electrodes, green light emission having a peak top at about 510 nm was obtained. The external quantum efficiency at a luminance of 1000 cd/m² was 12.63%.

### <Example 61>

### <Phosphorescent light emitting element using compound (1-152) as host of light emitting layer and compound (1-49) in electron transport layer 1>

An organic EL element was obtained by a method equivalent to that of Example 54, except that CBP, which was a host of the light emitting layer, was changed to compound (1-152), and the compound (1-3588), which was the electron transport layer 1, was changed to compound (1-49). When a direct current voltage was applied to the two electrodes, green light emission having a peak top at about 510 nm was obtained. The external quantum efficiency at a luminance of 1000 cd/m² was 12.55%.

### <Comparative Example 2>

### <Phosphorescent light emitting element using Comparative Compound 1 in electron transport layer 1>

An organic EL element was obtained by a method equivalent to that of Example 54, except that the compound (1-3588), which was the electron transport layer 1, was changed to Comparative Compound 1. When a direct current voltage was applied to the two electrodes, green light emission having a peak top at about 510 nm was obtained. The external quantum efficiency at a luminance of 1000 cd/m² was 7.50%.

Furthermore, organic EL elements related to Examples 62 to 64 were produced, and the external quantum efficiency obtainable when each of the organic EL elements was driven at a current density that could give a luminance of 1000 cd/m², was measured. The material configurations of the various layers in the organic EL elements thus produced are shown in the following Table 13.

**[Table 13]**

| | Hole injection layer 1 (5nm) | Hole injection layer 2 (55nm) | Hole transport layer (10nm) | Light emitting layer (20nm) | | Electron transport layer 1 (5nm) | Electron transport layer 2 (25nm) | Negative electrode (1nm /100nm) |
|---|---|---|---|---|---|---|---|---|
| | | | | Host | Dopant | | | |
| Ex. 62 | HAT-CN | TBB | TcTa | Compound 1-152 | 4CzIPN | T2T | ET-1 | LiF/Al |
| Ex. 63 | HAT-CN | TBB | TcTa | Compound 1-152 | 4CzIPN | Compound 1-49 | ET-1 | LiF/Al |
| Ex. 64 | HAT-CN | TBB | TcTa | Compound 1-152 | 4CzIPN | ET-5 | ET-1 | LiF/Al |

In Table 13, "4CzIPN" means 2,4,5,6-tetra(9H-carbazol-9-yl)isophthalonitrile, and "T2T" means 2,4,6-tri([1,1'-biphenyl]-3-yl)-1,3,5-triazine. The chemical structures thereof are shown below.

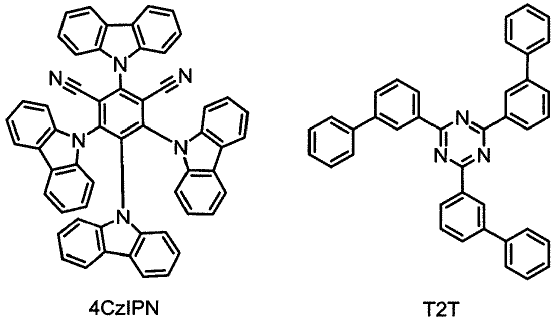

### <Example 62>

### <TADF (thermally activated delayed fluorescence) organic EL element using compound (1-152) as host material of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Choshu Industry Co., Ltd.), and a vapor deposition crucible made of tantalum and containing HAT-CN, a vapor deposition crucible made of tantalum and containing TBB, a vapor deposition crucible made of tantalum and containing TcTa, a vapor deposition crucible made of tantalum and containing compound (1-152) of the present invention, a vapor deposition crucible made of tantalum and containing 4CzIPN, a vapor deposition crucible made of tantalum and containing T2T, a vapor deposition crucible made of tantalum and containing ET-1, a vapor deposition crucible made of tantalum and containing LiF, and a vapor deposition crucible made of aluminum nitride and containing aluminum, were mounted in the apparatus.

Various layers as described below were formed sequentially on the ITO film of the transparent supporting substrate. The pressure in a vacuum chamber was reduced to 2.0 × 10⁻⁴ Pa. First, the vapor deposition crucible containing HAT-CN was heated, and thereby vapor deposition was performed so as to obtain a film thickness of 5 nm. Subsequently, the vapor deposition crucible containing TBB was heated, and thereby vapor deposition was performed so as to obtain a film thickness of 55 nm. Further, the vapor deposition crucible containing TcTa was heated, and thereby vapor deposition was performed so as to obtain a film thickness of 10 nm. Thus, hole injection layers and hole transport layers composed of three layers were formed. Next, the vapor deposition crucible containing compound (1-152) of the present invention and the vapor deposition crucible containing 4CzIPN were simultaneously heated, and thereby vapor deposition was performed so as to obtain a film thickness of 20 nm. Thus, a light emitting layer was formed. The rate of deposition was regulated such that the weight ratio of the compound (1-152) and 4CzIPN would be approximately 95 : 5. Next, the vapor deposition crucible containing T2T was heated, and thereby vapor deposition was performed so as to obtain a film thickness of 5 nm. Subsequently, the vapor deposition crucible containing ET-1 was heated, and thereby vapor deposition was performed so as to obtain a film thickness of 25 nm. Thus, electron transport layers composed of two layers were formed. The rate of deposition for each of the layers was 0.01 to 1 nm/second.

Thereafter, the vapor deposition crucible containing LiF was heated, and thereby vapor deposition was performed at a rate of deposition of 0.01 to 0.1 nm/second so as to obtain a film thickness of 1 nm. Subsequently, the vapor deposition crucible containing aluminum was heated, and thereby vapor deposition was performed so as to obtain a film thickness of 100 nm. Thus, a negative electrode was formed. At this time, the negative electrode was formed by performing vapor deposition such that the rate of deposition was regulated to be in the range of 0.1 nm/sec to 2 nm/sec, and thus an organic electroluminescent element was obtained.

When a direct current voltage was applied to the ITO electrode as the positive electrode and the LiF/aluminum electrode as the negative electrode, green light emission having a peak top at about 508 nm was obtained. The external quantum efficiency at a luminance of 1000 cd/m² was 15.02%.

### <Example 63>

### <TADF (thermally activated delayed fluorescence) organic EL element using compound (1-152) as host material of light emitting layer and compound (1-49) in electron transport layer 1>

An organic EL element was obtained by a method equivalent to that of Example 62, except that T2T, which was the electron transport layer 1, was changed to compound (1-49). When a direct current voltage was applied to the two electrodes, green light emission having a peak top at about 508 nm was obtained. The external quantum efficiency at a luminance of 1000 cd/m² was 13.25%.

### <Example 64>

### <TADF (thermally activated delayed fluorescence) organic EL element using compound (1-152) as host material of light emitting layer>

An organic EL element was obtained by a method equivalent to that of Example 62, except that T2T, which was the electron transport layer 1, was changed to ET-5. When a direct current voltage was applied to the two electrodes, green light emission having a peak top at about 508 nm was obtained. The external quantum efficiency at a luminance of 1000 cd/m² was 11.5%.

Furthermore, an organic EL element related to Example 65 was produced, and the external quantum efficiency obtainable the organic EL element was driven at a current density that could give a luminance of 100 cd/m², was measured. The material configurations of the various layers in the organic EL element thus produced are shown in the following Table 14.

**[Table 14]**

| | Hole Injection layer 1 (10nm) | Hole injection layer 2 (60nm) | Hole transport layer (10nm) | Light emitting layer (30nm) | | Electron transport layer (50nm) | Negative electrode (1nm /100nm) |
|---|---|---|---|---|---|---|---|
| | | | | Host | Dopant | | |
| Ex. 65 | HAT-CN | TBB | TcTa | mCP | Compound 1-81 | TPBi | LiF/Al |

In Table 14, "mCP" means 1,3-di(9H-carbazol-9-yl)benzene. The chemical structure thereof is shown below.

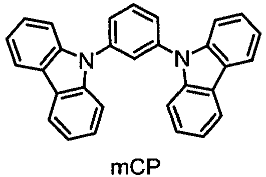

### <Example 65>

### <TADF organic EL element using compound (1-81) as dopant material of light emitting layer>

A glass substrate (manufactured by Opto Science, Inc.) having a size of 26 mm × 28 mm × 0.7 mm, which was obtained by forming a film of ITO having a thickness of 180 nm by sputtering, and polishing the ITO film to 150 nm, was used as a transparent supporting substrate. This transparent supporting substrate was fixed to a substrate holder of a commercially available vapor deposition apparatus (manufactured by Showa Shinku Co., Ltd.), and a vapor deposition boat made of molybdenum and containing HAT-CN, a vapor deposition boat made of molybdenum and containing TBB, a vapor deposition boat made of molybdenum and containing TcTa, a vapor deposition boat made of molybdenum and containing mCP, a vapor deposition boat made of molybdenum and containing compound (1-81) of the present invention, a vapor deposition boat made of molybdenum and containing TPBi, a vapor deposition boat made of molybdenum and containing LiF, and a vapor deposition boat made of tungsten and containing aluminum, were mounted in the apparatus.

Various layers as described below were formed sequentially on the ITO film of the transparent supporting substrate. The pressure in a vacuum chamber was reduced to 5 × 10⁻⁴ Pa. First, the vapor deposition crucible containing HAT-CN was heated, and thereby vapor deposition was performed so as to obtain a film thickness of 10 nm. Subsequently, the vapor deposition crucible containing TBB was heated, and thereby vapor deposition was performed so as to obtain a film thickness of 60 nm. Further, the vapor deposition crucible containing TcTa was heated, and thereby vapor deposition was performed so as to obtain a film thickness of 10 nm. Thus, hole injection layers and hole transport layers composed of three layers were formed. Next, the vapor deposition boat containing mCP and the vapor deposition boat containing compound (1-81) were simultaneously heated, and thereby vapor deposition was performed so as to obtain a film thickness of 30 nm. Thus, a light emitting layer was formed. The rate of deposition was regulated such that the weight ratio of mCP and compound (1-81) would be approximately 80 : 20. Next, the vapor deposition boat containing TPBi was heated, and thereby vapor deposition was performed so as to obtain a film thickness of 50 nm. Thus, an electron transport layer was formed. The rate of deposition for each of the layers was 0.01 to 1 nm/second.

Thereafter, the vapor deposition boat containing LiF was heated, and thereby vapor deposition was performed at a rate of deposition of 0.01 to 0.1 nm/second so as to obtain a film thickness of 1 nm. Subsequently, the vapor deposition boat containing aluminum was heated, and thereby vapor deposition was performed so as to obtain a film thickness of 100 nm. Thus, a negative electrode was formed. At this time, the negative electrode was formed by performing vapor deposition such that the rate of deposition was regulated to be in the range of 0.01 to 2 nm/sec, and thus an organic EL element was obtained.

When a direct current voltage was applied to the ITO electrode as the positive electrode and the LiF/aluminum electrode as the positive electrode and the LiF/aluminum electrode as the negative electrode, green light emission having a peak top at about 506 nm was obtained. The external quantum efficiency at a luminance of 100 cd/m² was 13.66%.

Furthermore, organic EL elements related to Examples 66 to 69 were produced, and the external quantum efficiency obtainable when each of the organic EL elements was driven at a current density that could give a luminance of 1000 cd/m², was measured. The material configurations of the various layers in the organic EL elements thus produced are shown in the following Table 15.

**[Table 15]**

| | Hole injection layer 1 (40nm) | Hole injection layer 2 (5nm) | Hole transport layer (25nm) | Light emitting layer (20nm) | | Electron transport layer 1 (5nm) | Electron transport layer 2 (25nm) | Negative electrode (1nm /100nm) |
|---|---|---|---|---|---|---|---|---|
| | | | | Host | Dopant | | | |
| Ex. 66 | HI | HAT-CN | HT | BH1 | BD1 | Compound 1-3824 | ET-1 | LiF/Al |
| Ex. 67 | HI | HAT-CN | HT | BH1 | BD1 | Compound 1-3806 | ET-1 | LiF/Al |
| Ex. 68 | HI | HAT-CN | HT | BH1 | BD1 | Compound 1-601 | ET-1 | LiF/Al |
| Ex. 69 | HI | HAT-CN | HT | BH1 | BD1 | Compound 1-701 | ET-1 | LiF/Al |

**[Table 16]**

| | Hole injection layer 1 (40nm) | Hole inj ection layer 2 (5nm) | Hole transport layer (25nm) | Light emitting layer (20nm) | | Electron transport layer 1 (5nm) | Electron transport layer 2 (25nm) | Negative electrode (1nm /100nm) |
|---|---|---|---|---|---|---|---|---|
| | | | | Host | Dopant | | | |
| Ex. 73 | HI | HAT-CN | HT | BH1 | BD1 | Compound 1-1006 | ET-6 | Liq/MgAg |
| Ex. 74 | HI | HAT-CN | HT | BH1 | BD1 | Compound 1-152-2 | ET-6 | Liq/MgAg |
| Ex. 77 | HI | HAT-CN | HT | BH1 | BD1 | Compound 1-49 | ET-6 | Liq/MgAg |
| Ex. 78 | HI | HAT-CN | HT | BH1 | BD2 | Compound 1-49 | ET-6 | Liq/MgAg |
| Ex. 79 | HI | HAT-CN | HT | BH1 | BD3 | Compound 1-49 | ET-6 | Liq/MgAg |
| Comp. Ex. 3 | HI | HAT-CN | HT | BH1 | BD1 | Comparative Compound 2 | ET-6 | Liq/MgAg |

In Table 16, "BD2" means N¹,N⁶-bis(dibenzo[b,d]furan-4-yl)-N¹,N⁶-diphenylpyrene-1,6-d iamine, "BD3" means N¹,N⁶-bis(5'-fluoro-[1,1':3',1"-terphenyl]-4'-yl)-N¹,N⁶-diph enylpyrene-1,6-diamine, and "ET-7" means 3-methyl-(5-(3-(10-naphthalen-1-yl)anthracen-9-yl)phenyl)py ridine. The chemical structures thereof are shown below.

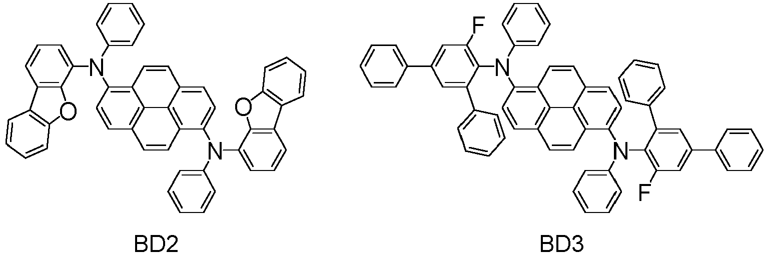

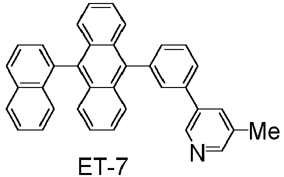

### <Example 73>

### <Element using compound (1-1006) in electron transport layer 1>

An organic EL element was obtained by a method equivalent to that of Example 70, except that the compound (1-3690), which was the electron transport layer 1, was changed to compound (1-1006) . When a direct current voltage was applied to the two electrodes, blue light emission having a peak top at about 456 nm was obtained. The external quantum efficiency at a luminance of 1000 cd/m² was 6.68%.

### <Example 74>

### <Element using compound (1-152-2) in electron transport layer 1>

An organic EL element was obtained by a method equivalent to that of Example 70, except that the compound (1-3690), which was the electron transport layer 1, was changed to compound (1-152-2). When a direct current voltage was applied to the two electrodes, blue light emission having a peak top at about 456 nm was obtained. The external quantum efficiency at a luminance of 1000 cd/m² was 7.56%.

### <Example 77>

### <Element using compound (1-49) in electron transport layer 1>

An organic EL element was obtained by a method equivalent to that of Example 70, except that the compound (1-3690), which was the electron transport layer 1, was changed to compound (1-49). When a direct current voltage was applied to the two electrodes, blue light emission having a peak top at about 456 nm was obtained. The external quantum efficiency at a luminance of 1000 cd/m² was 6.73%.

### <Example 78>

### <Element using compound (1-49) in electron transport layer 1>

An organic EL element was obtained by a method equivalent to that of Example 77, except that BD1, which was the dopant material of the light emitting layer, was changed to BD2. When a direct current voltage was applied to the two electrodes, blue light emission having a peak top at about 454 nm was obtained. The external quantum efficiency at a luminance of 1000 cd/m² was 6.10%.

### <Example 79>

### <Element using compound (1-49) in electron transport layer 1>

An organic EL element was obtained by a method equivalent to that of Example 77, except that BD1, which was the dopant material of the light emitting layer, was changed to BD3. When a direct current voltage was applied to the two electrodes, blue light emission having a peak top at about 456 nm was obtained. The external quantum efficiency at a luminance of 1000 cd/m² was 6.28%.

### <Comparative Example 3>

### <Element using Comparative Compound 2 in electron transport layer 1>

Comparative Compound 2 is disclosed as compound (H10) on page 99 of WO 2011/107186. An organic EL element was obtained by a method equivalent to that of Example 70, except that the compound (1-3690), which was the electron transport layer 1, was changed to (Comparative Compound 2). When a direct current voltage was applied to the two electrodes, blue light emission having a peak top at about 456 nm was obtained. The external quantum efficiency at a luminance of 1000 cd/m² was 5.10%.

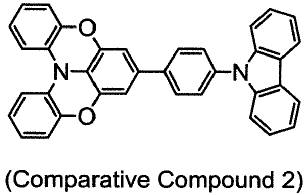

### Industrial applicability

According to the present invention, since a novel polycyclic aromatic compound is provided, the range of selection of the material for organic EL elements can be widened. Also, when a novel polycyclic aromatic compound is used as a material for an organic electroluminescent element, an excellent organic EL element, a display apparatus including the EL element, and a lighting apparatus including the EL element can be provided.

### Reference Signs List

- 100: Organic electroluminescent element
- 101: Substrate
- 102: Positive electrode
- 103: Hole injection layer
- 104: Hole transport layer
- 105: Light emitting layer
- 106: Electron transport layer
- 107: Electron injection layer
- 108: Negative electrode

## Claims

1. A polycyclic aromatic compound represented by the following general formula (2), or an oligomer of a polycyclic aromatic compound having plural structures each represented by the following general formula (2): 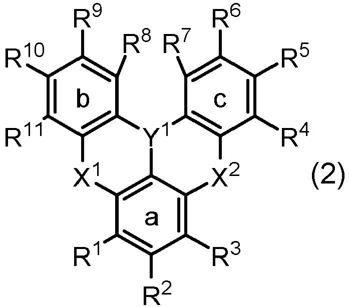 wherein in formula (2),
R¹, R², R³, R⁴, R⁵, R⁶, R⁷, R⁸, R⁹, R¹⁰ and R¹¹ each independently represent a hydrogen atom, an aryl, a heteroaryl, a diarylamino, a diheteroarylamino, an arylheteroarylamino, an alkyl, an alkoxy or an aryloxy, while at least one hydrogen atom in these may be substituted by an aryl, a heteroaryl or an alkyl, adjacent groups among R¹ to R¹¹ may be bonded to each other and form an aryl ring or a heteroaryl ring together with the ring a, ring b or ring c, at least one hydrogen atom in the ring thus formed may be substituted by an aryl, a heteroaryl, a diarylamino, a diheteroarylamino, an arylheteroarylamino, an alkyl, an alkoxy or an aryloxy, and at least one hydrogen atom in these substituents may be substituted by an aryl, a heteroaryl or an alkyl wherein all the aryls are aryl having 6 to 30 carbon atoms, all the heteroaryls are heteroaryl having 2 to 30 carbon atoms, all the alkyls are a linear alkyl having 1 to 24 carbon atoms or a branched alkyl having 3 to 24 carbon atoms, all the alkoxys are a linear alkoxy having 1 to 24 carbon atoms or a branched alkoxy having 3 to 24 carbon atoms, the aryl ring is aryl ring having 9 to 30 carbon atoms, and the heteroaryl ring is heteroaryl ring having 6 to 30 carbon atoms;
Y¹ represents B;
X¹ and X² each independently represent O, N-R or S, wherein R of the moiety N-R represents an aryl having 6 to 12 carbon atoms which may be substituted by an alkyl having 1 to 6 carbon atoms, a heteroaryl having 2 to 15 carbon atoms, or an alkyl having 1 to 6 carbon atoms, R of the moiety N-R may be bonded to the ring a, ring b and/or ring c by -O-, -S-, -C(-R)₂- or a single bond, and R of the moiety -C(-R)₂- represents an alkyl having 1 to 6 carbon atoms; and
at least one hydrogen atom in the compound represented by formula (2) may be substituted by a halogen atom or a deuterium atom.

2. The polycyclic aromatic compound or the oligomer thereof described in Claim 1, wherein
R¹, R², R³, R⁴, R⁵, R⁶, R⁷, R⁸, R⁹, R¹⁰ and R¹¹ each independently represent a hydrogen atom, an aryl having 6 to 30 carbon atoms, a heteroaryl having 2 to 30 carbon atoms, or a diarylamino (provided that the aryl is an aryl having 6 to 12 carbon atoms), while adjacent groups among R¹ to R¹¹ are bonded to each other and form an aryl ring having 9 to 16 carbon atoms or a heteroaryl ring having 6 to 15 carbon atoms together with the ring a, ring b or ring c, and at least one hydrogen atom in the ring thus formed may be substituted by an aryl having 6 to 10 carbon atoms;
Y¹ represents B;
X¹ and X² each independently represent O, N-R or S, wherein R in the moiety N-R represents an aryl having 6 to 10 carbon atoms which may be substituted by an alkyl having 1 to 4 carbon atoms, or an alkyl having 1 to 4 carbon atoms; and
at least one hydrogen atom in the compound represented by formula (2) may be substituted by a halogen atom or a deuterium atom; and
the oligomer is a dimer or a trimer, which has two or three of the structure represented by general formula (2).

3. The polycyclic aromatic compound or the oligomer thereof described in Claim 1 or 2, wherein the halogen atom is a fluorine atom.

4. The polycyclic aromatic compound described in Claim 1, which is represented by the following formula (1-1), the following formula (1-2), the following formula (1-4), the following formula (1-10), the following formula (1-49), the following formula (1-81), the following formula (1-91), the following formula (1-100), the following formula (1-141), the following formula (1-151), the following formula (1-176), the following formula (1-411), or the following formula (1-447):

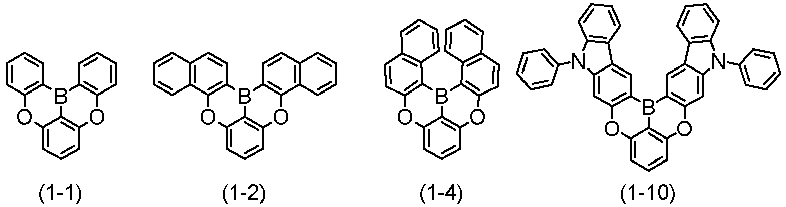

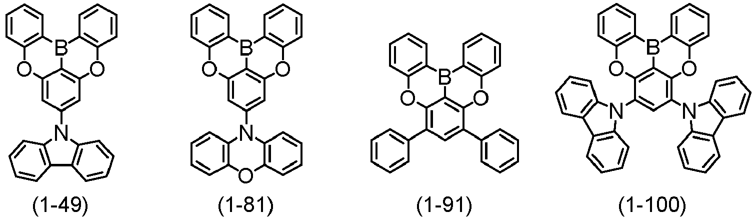

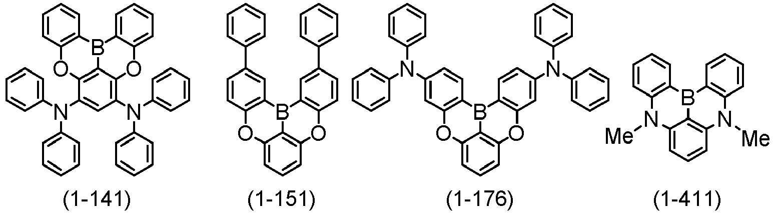

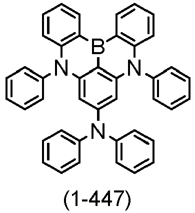

5. The polycyclic aromatic compound described in Claim 1, which is represented by the following formula (1-21), the following formula (1-23), the following formula (1-24), the following formula (1-50), the following formula (1-152), the following formula (1-201), the following formula (1-401), the following formula (1-422), the following formula (1-1048), the following formula (1-1049), the following formula (1-1050), the following formula (1-1069), the following formula (1-1084), the following formula (1-1090), the following formula (1-1092), the following formula (1-1101), the following formula (1-1102), the following formula (1-1103), the following formula (1-1145), the following formula (1-1152), the following formula (1-1159), the following formula (1-1201), the following formula (1-1210), or the following formula (1-1271):

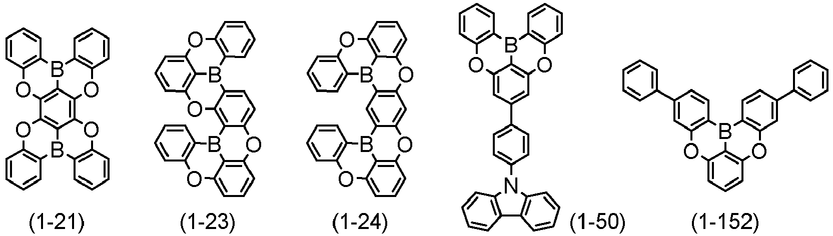

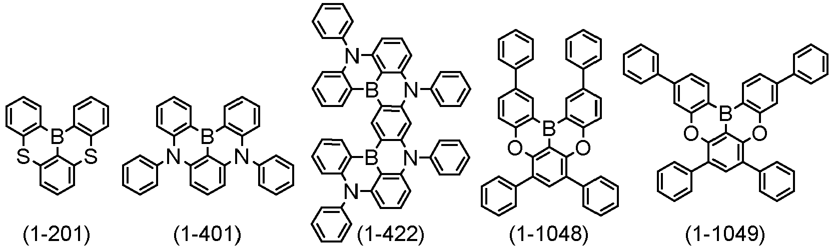

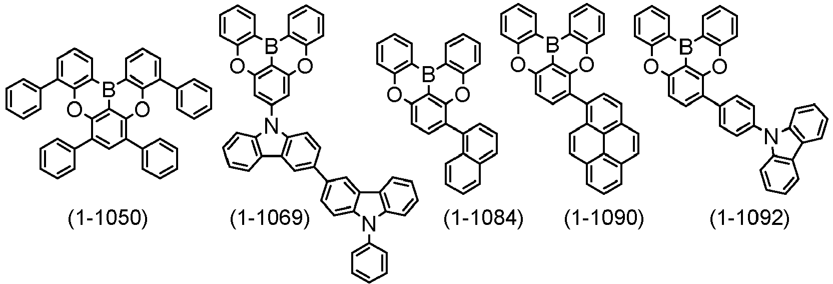

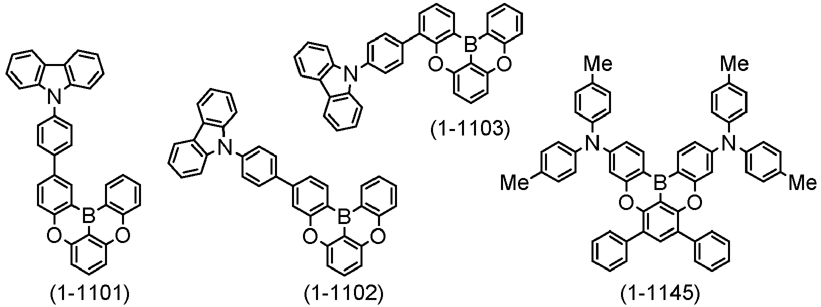

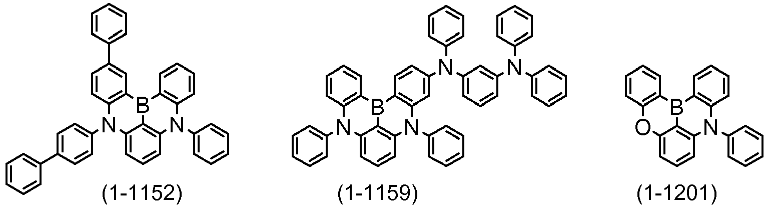

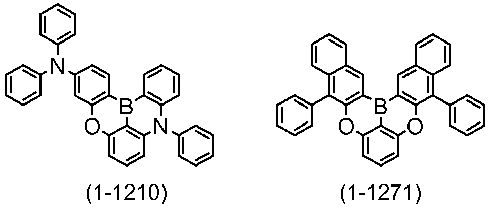

6. The polycyclic aromatic compound described in Claim 1, which is represented by the following formula (1-1-1), the following formula (1-79), the following formula (1-142), the following formula (1-152-2), the following formula (1-158), the following formula (1-159), the following formula (1-1006), the following formula (1-1104), the following formula (1-1149), the following formula (1-1150), the following formula (1-1301), the following formula (1-1351), the following formula (1-2305), the following formula (1-2626), the following formula (1-2657), the following formula (1-2662), the following formula (1-2665), the following formula (1-2676), the following formula (1-2678), the following formula (1-2679), the following formula (1-2680), the following formula (1-2681), the following formula (1-2682), the following formula (1-2683), the following formula (1-2691), the following formula (1-2699), the following formula (1-4401), or the following formula (1-4421-1):

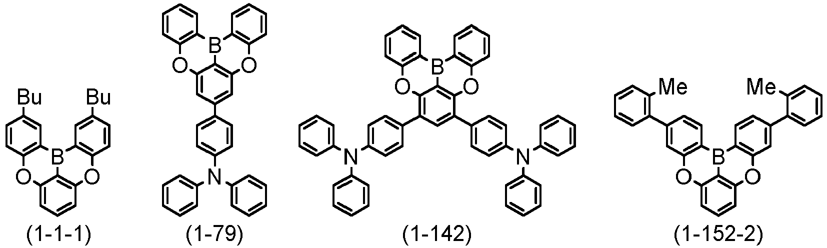

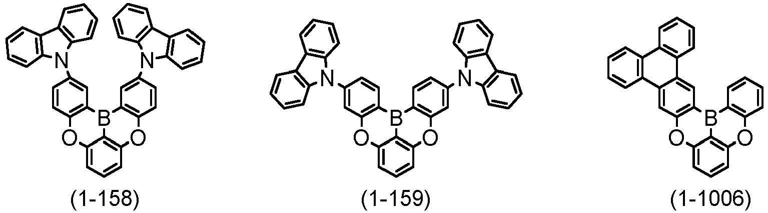

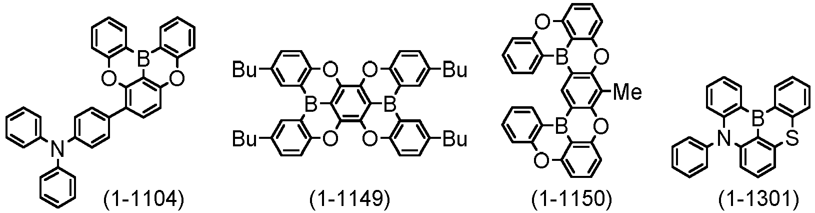

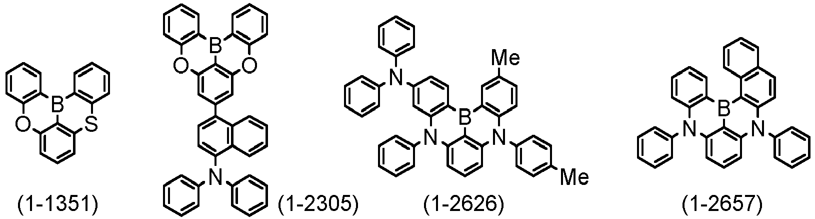

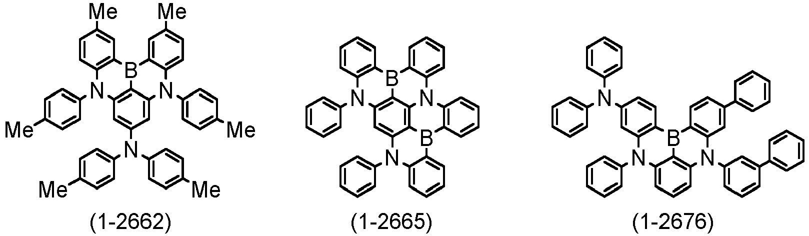

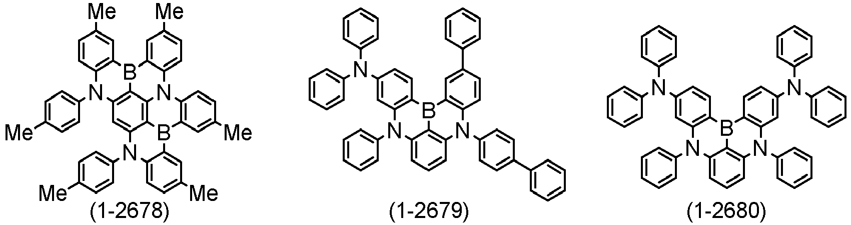

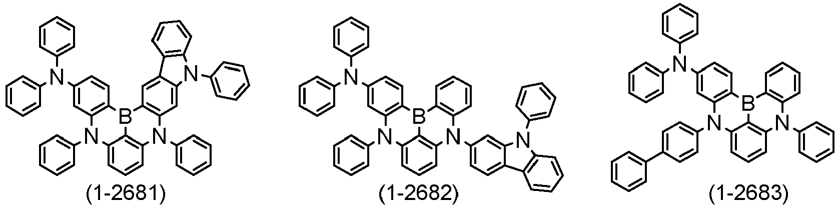

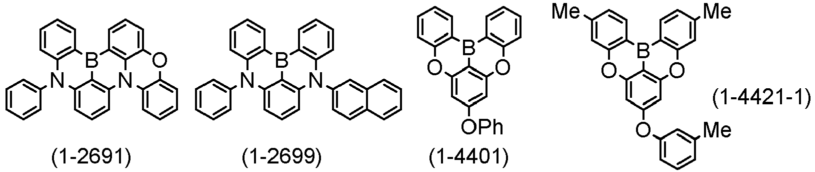

7. A material for an organic device, comprising the polycyclic aromatic compound or the oligomer thereof described in any one of Claims 1 to 6.

8. The material for an organic device described in Claim 7, wherein the material for an organic device is a material for an organic electroluminescent element, a material for an organic field effect transistor, or a material for an organic thin film solar cell.

9. The material for an organic electroluminescent element described in Claim 8, which is a material for a light emitting layer.

10. The material for an organic electroluminescent element described in Claim 8, which is a material for an electron injection layer or a material for an electron transport layer.

11. The material for an organic electroluminescent element described in Claim 8, which is a material for a hole injection layer or a material for a hole transport layer.

12. An organic electroluminescent element, comprising a pair of electrodes composed of a positive electrode and a negative electrode; and a light emitting layer that is disposed between the pair of electrodes and contains the material for a light emitting layer described in Claim 9, or
comprising a pair of electrodes composed of a positive electrode and a negative electrode; a light emitting layer that is disposed between the pair of electrodes; and an electron injection layer and/or an electron transport layer that is disposed between the negative electrode and the light emitting layer and contains the material for an electron injection layer and/or material for an electron transport layer described in Claim 10, or
comprising a pair of electrodes composed of a positive electrode and a negative electrode; a light emitting layer that is disposed between the pair of electrodes; and a hole injection layer and/or a hole transport layer that is disposed between the positive electrode and the light emitting layer and contains the material for a hole injection layer and/or the material for a hole transport layer described in Claim 11.

13. The organic electroluminescent element described in Claim 12, further comprising an electron transport layer and/or an electron injection layer that is disposed between the negative electrode and the light emitting layer, wherein at least one of the electron transport layer and the electron injection layer contains at least one selected from the group consisting of a quinolinol-based metal complex, a pyridine derivative, a phenanthroline derivative, a borane derivative, and a benzimidazole derivative.

14. The organic electroluminescent element described in Claim 13, wherein the electron transport layer and/or electron injection layer further contains at least one selected from the group consisting of an alkali metal, an alkaline earth metal, a rare earth metal, an oxide of an alkali metal, a halide of an alkali metal, an oxide of an alkaline earth metal, a halide of an alkaline earth metal, an oxide of a rare earth metal, a halide of a rare earth metal, an organic complex of an alkali metal, an organic complex of an alkaline earth metal, and an organic complex of a rare earth metal.

15. A display apparatus comprising the organic electroluminescent element described in any one of Claims 12 to 14.

16. A lighting apparatus comprising the organic electroluminescent element described in any one of Claims 12 to 14.

17. A method for producing the polycyclic aromatic compound represented by the following general formula (2) or the oligomer of a polycyclic aromatic compound having plural structures each represented by the following general formula (2) described in Claim 1,
the method comprising a reaction step of linking ring a, ring b and ring c in the following intermediate via Y¹ through a continuous aromatic electrophilic substitution reaction, using a reagent selected from the group consisting of a halide of Y¹, an amination halide of Y¹, an alkoxylation product of Y¹ and an aryloxylation product of Y¹, and optionally a Brønsted base: 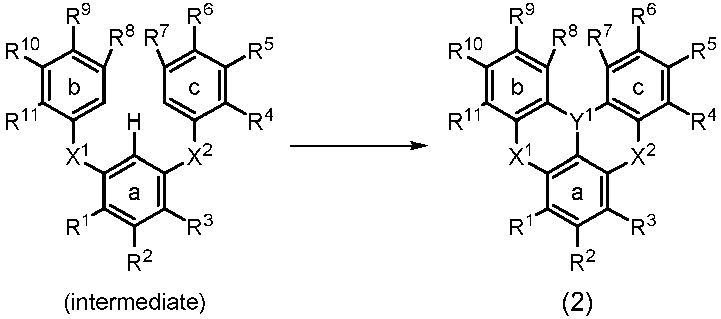 or the method comprising:
a reaction step of ortho-metalating a hydrogen atom present between X¹ and X² in the following intermediate using an organic alkali compound;
a reaction step of exchanging the metal for Y¹ using a reagent selected from the group consisting of a halide of Y¹, an aminated halide of Y¹, an alkoxylation product of Y¹, and an aryloxylation product of Y¹; and
a reaction step of linking ring b and ring c via Y¹ through a continuous aromatic electrophilic substitution reaction using a Brønsted base:

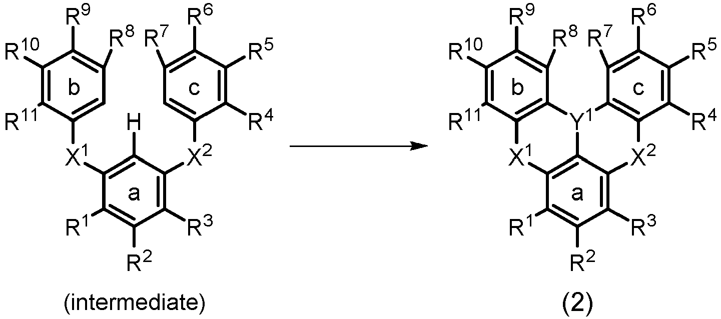

18. The production method described in Claim 17, wherein the reactions are accelerated by further adding a Lewis acid to the reaction system.

19. The production method described in Claim 17 or 18, further comprising a reaction step of halogenating in advance a hydrogen atom present between X¹ and X² in the intermediate.

## Patentansprüche

1. Polycyclische aromatische Verbindung mit der folgenden allgemeinen Formel (2) oder ein Oligomer einer polycyclischen aromatischen Verbindung mit mehreren Strukturen, die jeweils durch die folgende allgemeine Formel (2) dargestellt sind: 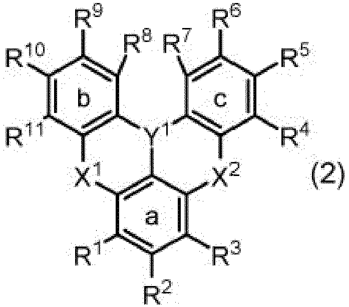 worin in der Formel (2)
R¹, R², R³, R⁴, R⁵, R⁶, R⁷, R⁸, R⁹, R¹⁰ und R¹¹ jeweils unabhängig ein Wasserstoffatom, Aryl, Heteroaryl, Diarylamino, Diheteroarylamino, Arylheteroarylamino, Alkyl, Alkoxy oder Aryloxy sind, während zumindest ein Wasserstoffatom in diesen durch ein Aryl, Heteroaryl oder Alkyl substituiert sein kann, wobei benachbarte Gruppen unter R¹ bis R¹¹ aneinander gebunden sein können und einen Arylring oder Heteroarylring zusammen mit dem Ring a, Ring b oder Ring c bilden können, wobei zumindest ein Wasserstoffatom in den somit gebildeten Ring durch ein Aryl, Heteroaryl, Diarylamino, Diheteroarylamino, Arylheteroarylamino, Alkyl, Alkoxy oder Aryloxy substituiert sein kann und zumindest ein Wasserstoffatom in diesen Substituenten durch ein Aryl, Heteroaryl oder Alkyl substituiert sein kann, worin alle Aryle Aryl mit 6 bis 30 Kohlenstoffatomen, alle Heteroaryle Heteroaryl mit 2 bis 30 Kohlenstoffatomen, alle Alkyle ein lineares Alkyl mit 1 bis 24 Kohlenstoffatomen oder verzweigtes Alkyl mit 3 bis 24 Kohlenstoffatomen, alle Alkoxygruppen lineares Alkoxy mit 1 bis 24 Kohlenstoffatomen oder verzweigtes Alkoxy mit 3 bis 24 Kohlenstoffatomen sind, der Arylring ein Arylring mit 9 bis 30 Kohlenstoffatomen ist und der Heteroarylring Heteroarylring mit 6 bis 30 Kohlenstoffatomen ist,
Y¹ B ist,
X¹ und X² jeweils unabhängig O, N-R oder S sind, worin R des Anteils N-R ein Aryl mit 6 bis 12 Kohlenstoffatomen ist, der mit einem Alkyl mit 1 bis 6 Kohlenstoffatomen, Heteroaryl mit 2 bis 15 Kohlenstoffatomen oder Alkyl mit 1 bis 6 Kohlenstoffatomen substituiert sein kann, R des Anteils N-R an den Ring a, Ring b und/oder Ring c durch -O-, -S-, -C(-R)₂- oder eine Einfachbindung gebunden sein kann und R des Anteils -C(-R)₂- ein Alkyl mit 1 bis 6 Kohlenstoffatomen ist, und
zumindest ein Wasserstoffatom in der Verbindung mit der Formel (2) durch ein Halogenatom oder Deuteriumatom substituiert sein kann.

2. Polycyclische aromatische Verbindung oder Oligomer davon gemäß Anspruch 1, worin
R¹, R², R³, R⁴, R⁵, R⁶, R⁷, R⁸, R⁹, R¹⁰ und R¹¹ jeweils unabhängig ein Wasserstoffatom, Aryl mit 6 bis 30 Kohlenstoffatomen, Heteroaryl mit 2 bis 30 Kohlenstoffatomen oder Diarylamino (vorgesetzt, dass das Aryl ein Aryl mit 6 bis 12 Kohlenstoffatomen ist) sind, während benachbarte Gruppe von R¹ bis R¹¹ aneinander gebunden sind und einen Arylring mit 9 bis 16 Kohlenstoffatomen oder Heteroarylring mit 6 bis 15 Kohlenstoffatomen zusammen mit dem Ring a, Ring b oder Ring c bilden und zumindest ein Wasserstoffatom im somit gebildeten Ring durch ein Aryl mit 6 bis 10 Kohlenstoffatomen substituiert sein kann,
Y¹ B ist,
X¹ und X² jeweils unabhängig O, N-R oder S sind, worin R in dem Anteil N-R ein Aryl mit 6 bis 10 Kohlenstoffatomen, das durch ein Alkyl mit 1 bis 4 Kohlenstoffatomen substituiert sein kann, oder Alkyl mit 1 bis 4 Kohlenstoffatomen ist; und
zumindest ein Wasserstoffatom in der Verbindung mit der Formel (2) durch ein Halogenatom oder Deuteriumatom substituiert sein kann, und
das Oligomer ein Dimer oder ein Trimer ist, das zwei oder drei der Strukturen mit der allgemeinen Formel (2) aufweist.

3. Polycyclische aromatische Verbindung oder Oligomer davon gemäß Anspruch 1 oder 2, worin das Halogenatom ein Fluoratom ist.

4. Polycyclische aromatische Verbindung gemäß Anspruch 1, dargestellt durch die folgende Formel (1-1), die folgende Formel (1-2), die folgende Formel (1-4), die folgende Formel (1-10), die folgende Formel (1-49), die folgende Formel (1-81), die folgende Formel (1-91), die folgende Formel (1-100), die folgende Formel (1-141), die folgende Formel (1-151), die folgende Formel (1-176), die folgende Formel (1-411) oder die folgende Formel (1-447):

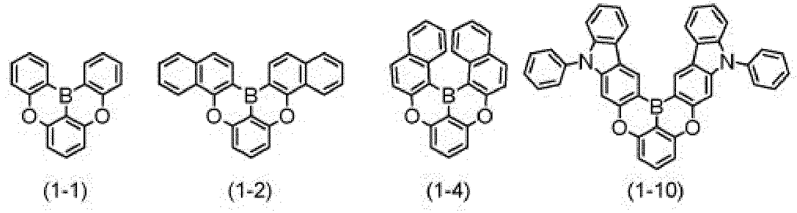

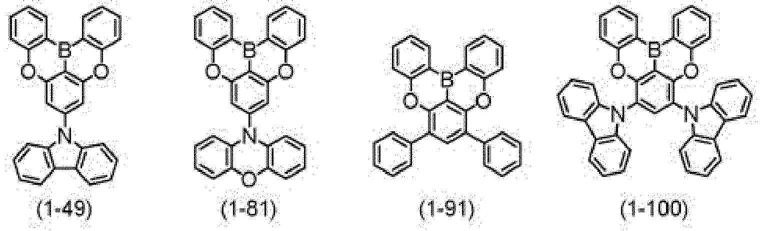

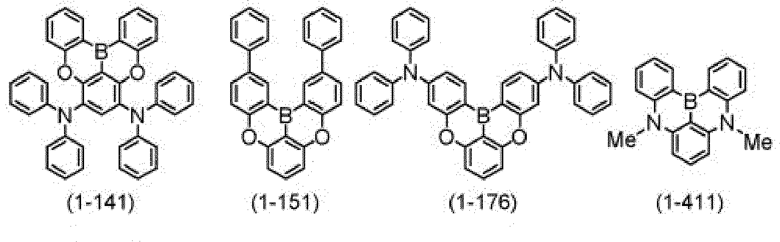

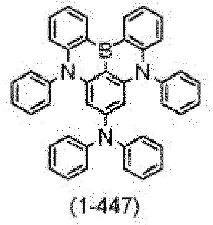

5. Polycyclische aromatische Verbindung gemäß Anspruch 1, dargestellt durch die folgende Formel (1-21), die folgende Formel (1-23), die folgende Formel (1-24), die folgende Formel (1-50), die folgende Formel (1-152), die folgende Formel (1-201), die folgende Formel (1-401), die folgende Formel (1-422), die folgende Formel (1-1048), die folgende Formel (1-1049), die folgende Formel (1-1050), die folgende Formel (1-1069), die folgende Formel (1-1084) oder die folgende Formel (1-1090), die folgende Formel (1-1092), die folgende Formel (1-1101), die folgende Formel (1-1102), die folgende Formel (1-1103), die folgende Formel (1-1145), die folgende Formel (1-1152), die folgende Formel (1-1159), die folgende Formel (1-1201), die folgende Formel (1-1210) oder die folgende Formel (1-1271):

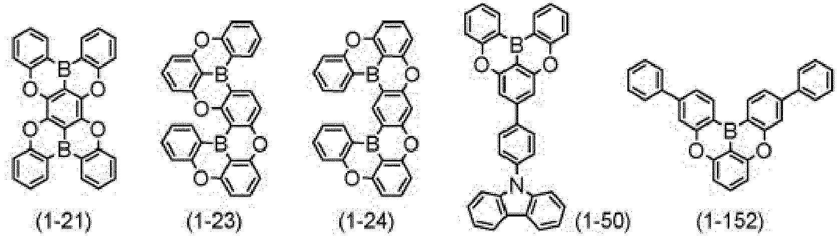

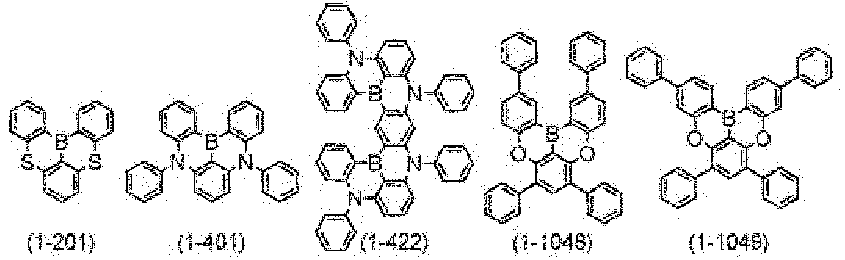

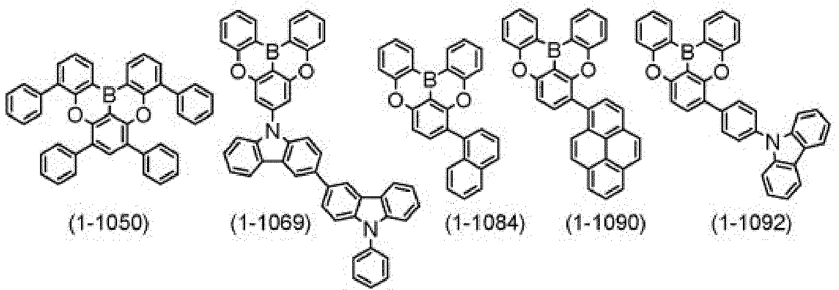

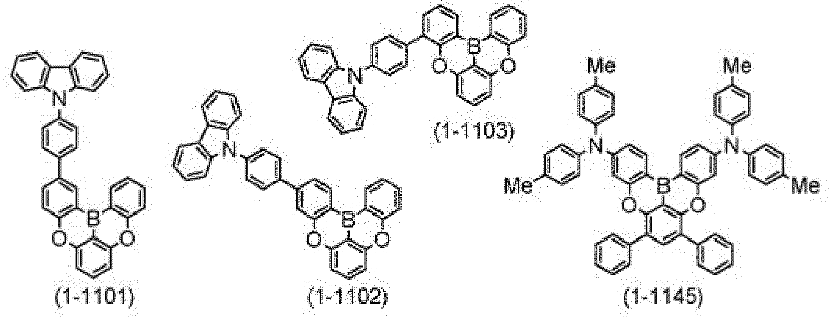

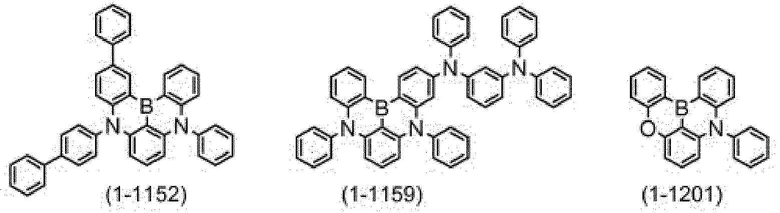

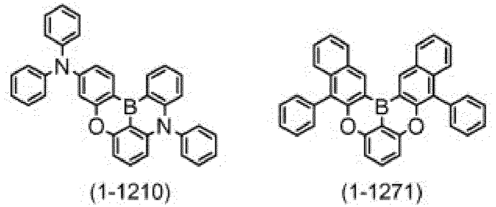

6. Polycyclische aromatische Verbindung gemäß Anspruch 1, dargestellt durch die folgende Formel (1-1-1), die folgende Formel (1-79), die folgende Formel (1-142), die folgende Formel (1-152-2), die folgende Formel (1-158), die folgende Formel (1-159), die folgende Formel (1-1006), die folgende Formel (1-1104), die folgende Formel (1-1149), die folgende Formel (1-1150), die folgende Formel (1-1301), die folgende Formel (1-1351), die folgende Formel (1-2305) oder die folgende Formel (1-2626), die folgende Formel (1-2657), die folgende Formel (1-2662), die folgende Formel (1-2665), die folgende Formel (1-2676), die folgende Formel (1-2678), die folgende Formel (1-2679), die folgende Formel (1-2680), die folgende Formel (1-2681), die folgende Formel (1-2682), die folgende Formel (1-2683), die folgende Formel (1-2691), die folgende Formel (1-2699), die folgende Formel (1-4401) oder die folgende Formel (1-4421-1):

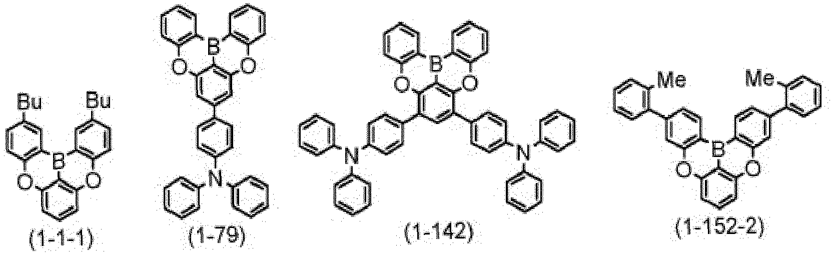

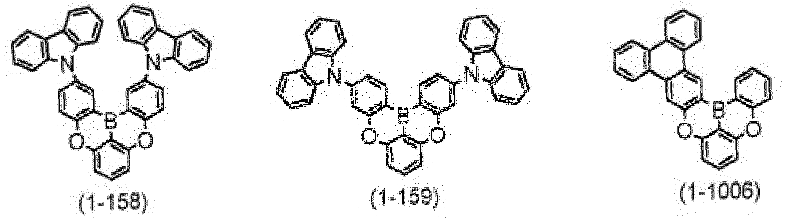

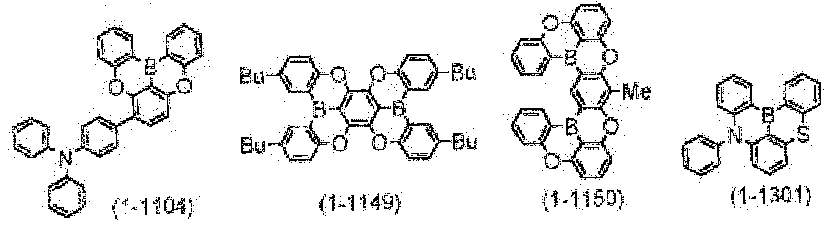

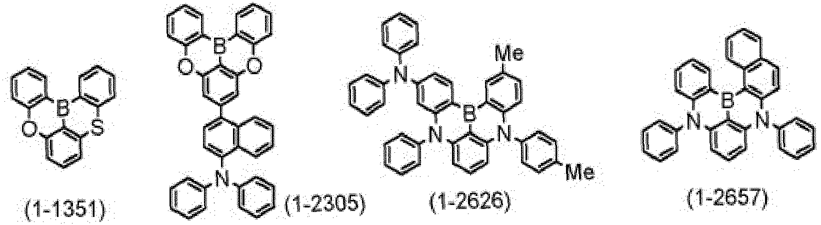

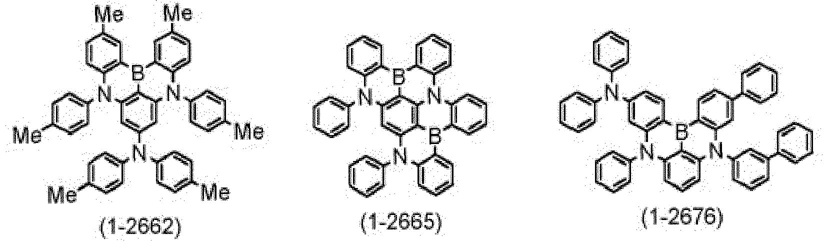

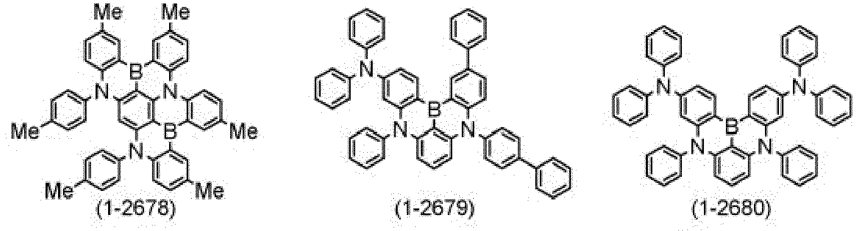

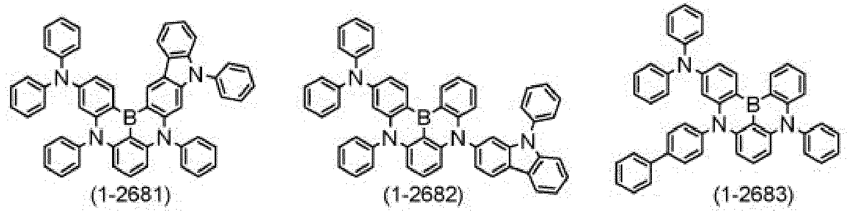

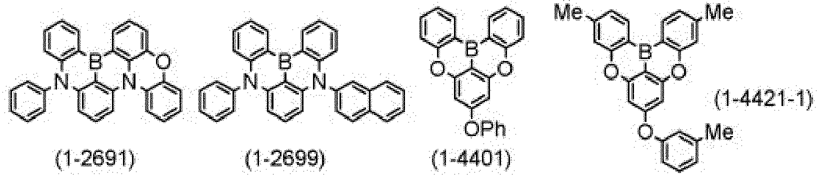

7. Material für eine organische Vorrichtung, enthaltend die polycyclische aromatische Verbindung oder das Oligomer davon wie in einem der Ansprüche 1 bis 6 beschrieben.

8. Material für eine organische Vorrichtung gemäß Anspruch 7, worin das Material für eine organische Vorrichtung ein Material für ein organisches Elektrolumineszenzelement, ein Material für einen organischen Feldeffekttransistor oder ein Material für eine organische Dünnfilmsolarzelle ist.

9. Material für ein organisches Elektrolumineszenzelement gemäß Anspruch 8, das ein Material für eine lichtemittierende Schicht ist.

10. Material für ein organisches Elektrolumineszenzelement gemäß Anspruch 8, das ein Material für eine Elektroneninjektionsschicht oder ein Material für eine Elektronentransportschicht ist.

11. Material für ein organisches Elektrolumineszenzelement gemäß Anspruch 8, das ein Material für eine Lochinjektionsschicht oder ein Material für eine Lochtransportschicht ist.

12. Organisches Elektrolumineszenz-Element, enthaltend ein Paar von Elektroden, die sich aus einer positiven Elektrode und einer negativen Elektrode zusammensetzen; und eine lichtemittierende Schicht, die zwischen dem Paar von Elektroden angeordnet ist und das Material für eine lichtemittierende Schicht gemäß Anspruch 9 enthält, oder
enthaltend ein Paar von Elektroden, die sich aus einer positiven Elektrode und einer negativen Elektrode zusammensetzen; eine lichtemittierende Schicht, die zwischen dem Paar von Elektroden angeordnet ist; und eine Elektroneninjektionsschicht und/oder eine Elektronentransportschicht, die zwischen der negativen Elektrode und der lichtemittierenden Schicht angeordnet ist und das Material für eine ElektronenInjektionsschicht und/oder ein Material für eine Elektronen-Transportschicht gemäß Anspruch 10 enthält, oder
enthaltend ein Paar von Elektroden, die sich aus einer positiven Elektrode und einer negativen Elektrode zusammensetzen; eine lichtemittierende Schicht, die zwischen dem Paar von Elektroden angeordnet ist; und eine Lochinjektionsschicht und/oder Lochtransportschicht, die zwischen der positiven Elektrode und der lichtemittierenden Schicht angeordnet ist und das Material für eine Loch-Injektionsschicht und/oder das Material für eine Loch-Transportschicht gemäß Anspruch 11 enthält.

13. Organisches Elektrolumineszenzelement gemäß Anspruch 12, weiterhin enthaltend eine Elektronentransportschicht und/oder eine Elektroneninjektionsschicht, die zwischen der negativen Elektrode und der lichtemittierenden Schicht angeordnet ist, worin zumindest eine von der Elektronentransportschicht und der Elektroneninjektionsschicht zumindest eines enthält, ausgewählt aus der Gruppe, bestehend aus einem Metallkomplex auf Chinolinolbasis, einem Pydridinderivat, Phenanthrolinderivat, Boranderivat und Benzimidazolderivat.

14. Organisches Elektrolumineszenzelement gemäß Anspruch 13, worin die Elektronentransportschicht und/oder Elektroneninjektionsschicht weiterhin zumindest eines enthält, ausgewählt aus der Gruppe, bestehend aus einem Alkalimetall, Erdalkalimetall, Seltenerdmetall, einem Oxid aus einem Alkalimetall, Halogenid aus einem Alkalimetall, Oxid eines Erdalkalimetalls, Halogenid eines Erdalkalimetalls, einem Oxid eines Seltenerdmetall, Halogenid eines Seltenerdmetalls, einem organischen Komplex eines Alkalimetalls, einem organischen Komplex eines Erdalkalimetalls und einem organischen Komplex eines Seltenerdmetalls.

15. Anzeigevorrichtung, enthaltend das organische Elektrolumineszenzelement gemäß einem der Ansprüche 12 bis 14.

16. Beleuchtungsanlage, enthaltend das organische Elektrolumineszenzelement gemäß einem der Ansprüche 12 bis 14.

17. Verfahren zur Erzeugung der polycyclischen aromatischen Verbindung, dargestellt durch die folgende allgemeine Formel (2) oder das Oligomer einer polycyclischen aromatischen Verbindung mit mehreren Strukturen, die jeweils durch die folgende allgemeine Formel (2) dargestellt sind, gemäß Anspruch 1,
wobei das Verfahren einen Reaktionsschritt der Verbindung des Rings a, des Rings b und des Rings c in dem folgenden Zwischenprodukt über Y¹ durch eine kontinuierliche aromatische elektrophile Substitutionsreaktion unter Verwendung eines Reagens, ausgewählt aus der Gruppe, bestehend aus einem Halogenid von Y¹, einem Aminierungshalogenid von Y¹, einem Alkoxylierungsprodukt von Y¹ und einem Aryloxylierungsprodukt von Y¹ und wahlweise einer Brønsted-Base enthält: 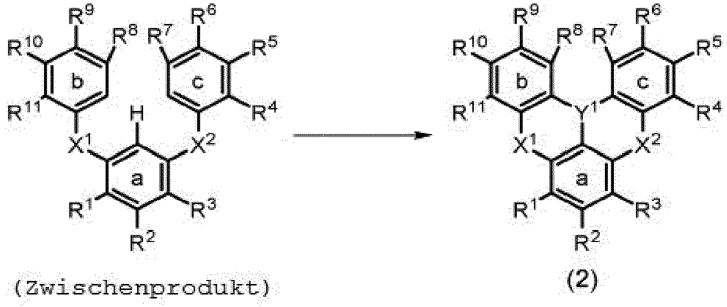 oder das Verfahren enthält:
einen Reaktionsschritt zum Ortho-Metallisieren eines Wasserstoffatoms, das zwischen X¹ und X² in dem folgenden Zwischenprodukt vorhanden ist, unter Verwendung der organischen Alkaliverbindung;
einen Reaktionsschritt zum Austausch des Metalls von Y¹ unter Verwendung eines Reagens, ausgewählt aus der Gruppe, bestehend aus einem Halogenid von Y¹, einem aminierten Halogenid von Y¹, einem Alkoxylierungsprodukt von Y¹ und einem Aryloxylierungsprodukt von Y¹, und einen Reaktionsschritt zum Verbinden des Rings b und des Rings c über Y¹ durch eine kontinuierliche aromatische elektrophile Substitutionsreaktion unter Verwendung einer Brønsted-Base :

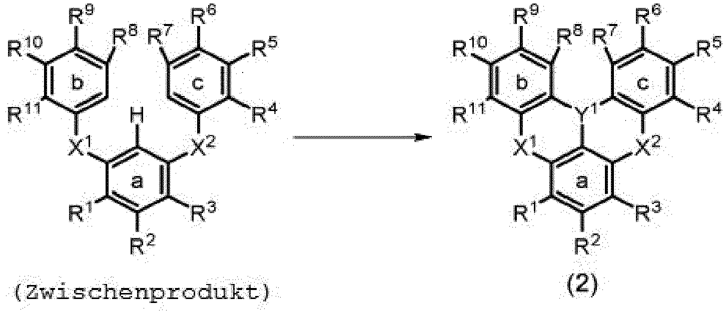

18. Produktionsverfahren gemäß Anspruch 17, worin die Reaktionen durch weitere Zugabe einer Lewis-Säure zum Reaktionssystem beschleunigt werden.

19. Produktionsverfahren gemäß Anspruch 17 oder 18, weiterhin enthaltend einen Reaktionsschritt zum vorhergehenden Halogenieren eines Wasserstoffatoms, das zwischen X¹ und X² in dem Zwischenprodukt vorhanden ist.

## Revendications

1. Composé aromatique polycyclique représenté par la formule générale (2) suivante, ou oligomère d'un composé aromatique polycyclique ayant plusieurs structures représentées chacune par la formule générale (2) suivante: 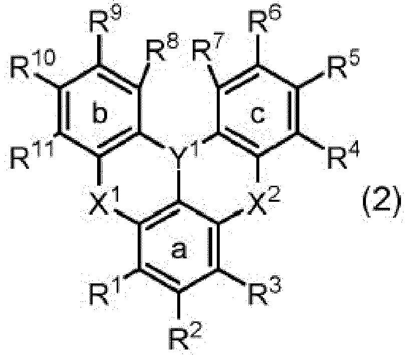 dans laquelle dans la formule (2),
R¹, R², R³, R⁴, R⁵, R⁶, R⁷, R⁸, R⁹, R¹⁰ et R¹¹ représentent chacun indépendamment un atome d'hydrogène, un aryle, un hétéroaryle, un diarylamino, un dihétéroarylamino, un arylhétéroarylamino, un alkyle, un alcoxy ou un aryloxy, tandis qu'au moins un atome d'hydrogène dans ceux-ci peut être remplacé par un aryle, un hétéroaryle ou un alkyle, des groupes adjacents parmi R¹ à R¹¹ peuvent être liés les uns aux autres et former un cycle aryle ou un cycle hétéroaryle conjointement avec le cycle a, le cycle b ou le cycle c, au moins un atome d'hydrogène dans le cycle ainsi formé peut être remplacé par un aryle, un hétéroaryle, un diarylamino, un dihétéroarylamino, un arylhétéroarylamino, un alkyle, un alcoxy ou un aryloxy, et au moins un atome d'hydrogène dans ces substituants peut être remplacé par un aryle, un hétéroaryle ou un alkyle dans lequel tous les aryles sont un aryle contenant 6 à 30 atomes de carbone, tous les hétéroaryles sont un hétéroaryle contenant 2 à 30 atomes de carbone, tous les alkyles sont un alkyle linéaire contenant 1 à 24 atomes de carbone ou un alkyle ramifié contenant 3 à 24 atomes de carbone, tous les alcoxys sont un alcoxy linéaire contenant 1 à 24 atomes de carbone ou un alcoxy ramifié contenant 3 à 24 atomes de carbone, le cycle aryle est un cycle aryle contenant 9 à 30 atomes de carbone, et le cycle hétéroaryle est un cycle hétéroaryle contenant 6 à 30 atomes de carbone ;
Y¹ représente B ;
X¹ et X² représentent chacun indépendamment O, N-R ou S, dans lequel R du fragment N-R représente un aryle contenant 6 à 12 atomes de carbone qui peut être remplacé par un alkyle contenant 1 à 6 atomes de carbone, un hétéroaryle contenant 2 à 15 atomes de carbone, ou un alkyle contenant 1 à 6 atomes de carbone, R du fragment N-R peut être lié au cycle a, au cycle b et/ou au cycle c par -O-, -S-, -C(-R)₂- ou une liaison simple, et R du fragment -C(-R)₂- représente un alkyle contenant 1 à 6 atomes de carbone ; et
au moins un atome d'hydrogène dans le composé représenté par la formule (2) peut être remplacé par un atome d'halogène ou un atome de deutérium.

2. Composé aromatique polycyclique ou oligomère de celui-ci décrit dans la revendication 1, dans lequel
R¹, R², R³, R⁴, R⁵, R⁶, R⁷, R⁸, R⁹, R¹⁰ et R¹¹ représentent chacun indépendamment un atome d'hydrogène, un aryle contenant 6 à 30 atomes de carbone, un hétéroaryle contenant 2 à 30 atomes de carbone, ou un diarylamino (à condition que l'aryle soit un aryle contenant 6 à 12 atomes de carbone), tandis que des groupes adjacents parmi R¹ à R¹¹ sont liés les uns aux autres et forment un cycle aryle contenant 9 à 16 atomes de carbone ou un cycle hétéroaryle contenant 6 à 15 atomes de carbone conjointement avec le cycle a, le cycle b ou le cycle c, et au moins un atome d'hydrogène dans le cycle ainsi formé peut être remplacé par un aryle contenant 6 à 10 atomes de carbone ;
Y¹ représente B ;
X¹ et X² représentent chacun indépendamment O, N-R ou S, dans lequel R dans le fragment N-R représente un aryle contenant 6 à 10 atomes de carbone qui peut être remplacé par un alkyle contenant 1 à 4 atomes de carbone, ou un alkyle contenant 1 à 4 atomes de carbone ; et
au moins un atome d'hydrogène dans le composé représenté par la formule (2) peut être remplacé par un atome d'halogène ou un atome de deutérium ; et
l'oligomère est un dimère ou un trimère, qui contient deux ou trois de la structure représentée par la formule (2).

3. Composé aromatique polycyclique ou oligomère de celui-ci décrit dans la revendication 1 ou 2, dans lequel l'atome d'halogène est un atome de fluor.

4. Composé aromatique polycyclique décrit dans la revendication 1, qui est représenté par la formule (1-1) suivante, la formule (1-2) suivante, la formule (1-4) suivante, la formule (1-10) suivante, la formule (1-49) suivante, la formule (1-81) suivante, la formule (1-91) suivante, la formule (1-100) suivante, la formule (1-141) suivante, la formule (1-151) suivante, la formule (1-176) suivante, la formule (1-411) suivante, ou la formule (1-447) suivante:

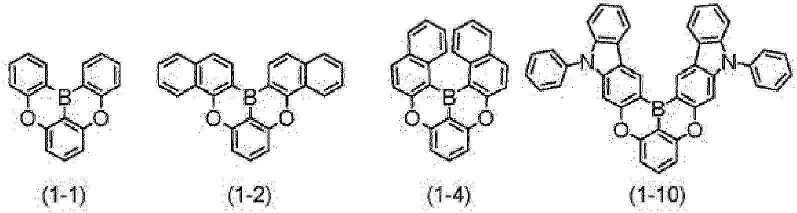

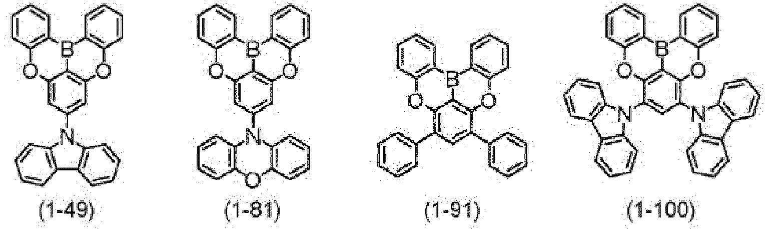

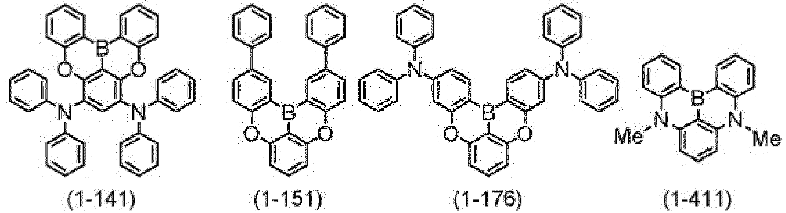

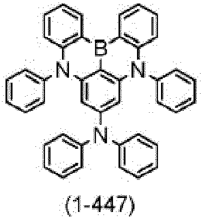

5. Composé aromatique polycyclique décrit dans la revendication 1, qui est représenté par la formule (1-21) suivante, la formule (1-23) suivante, la formule (1-24) suivante, la formule (1-50) suivante, la formule (1-152) suivante, la formule (1-201) suivante, la formule (1-401) suivante, la formule (1-422) suivante, la formule (1-1048) suivante, la formule (1-1049) suivante, la formule (1-1050) suivante, la formule (1-1069) suivante, la formule (1-1084) suivante, la formule (1-1090) suivante, la formule (1-1092) suivante, la formule (1-1101) suivante, la formule (1-1102) suivante, la formule (1-1103) suivante, la formule (1-1145) suivante, la formule (1-1152) suivante, la formule (1-1159) suivante, la formule (1-1201) suivante, la formule (1-1210) suivante, ou la formule (1-1271) suivante:

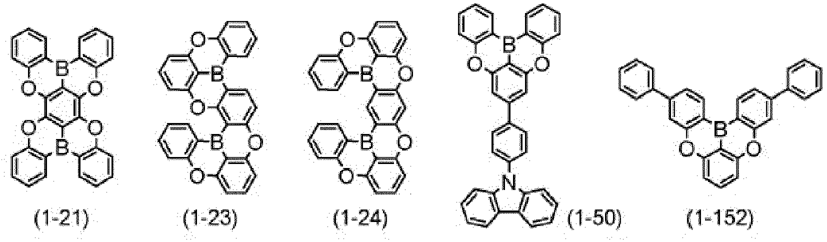

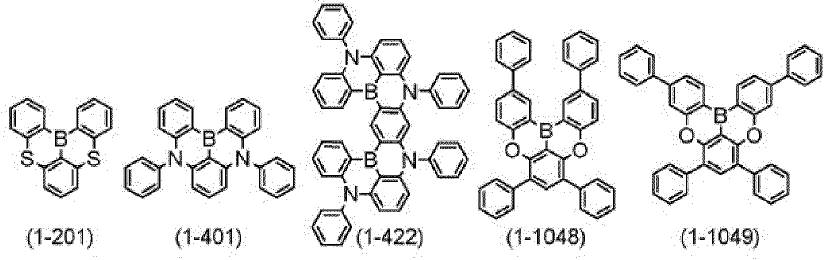

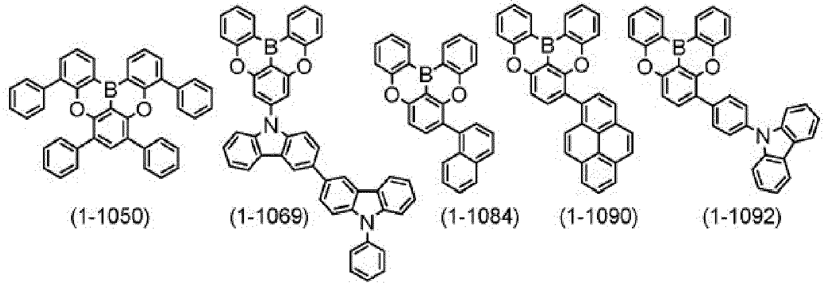

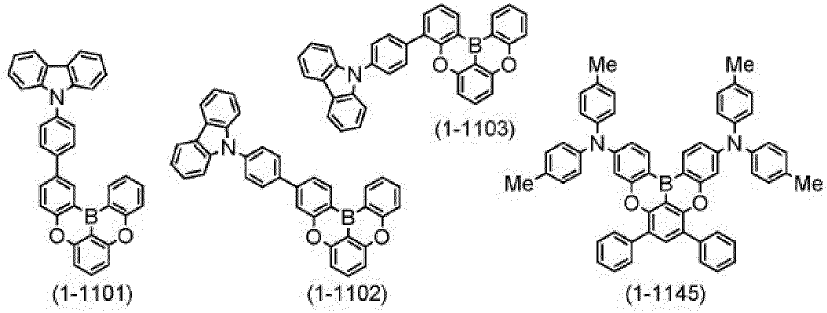

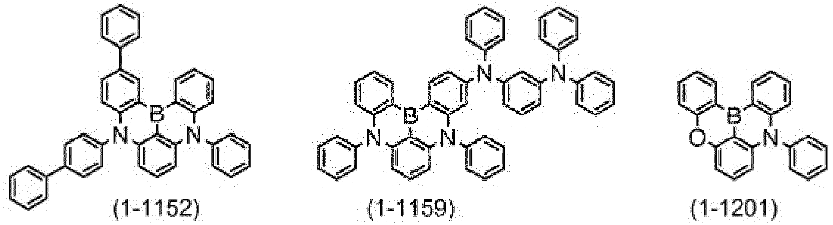

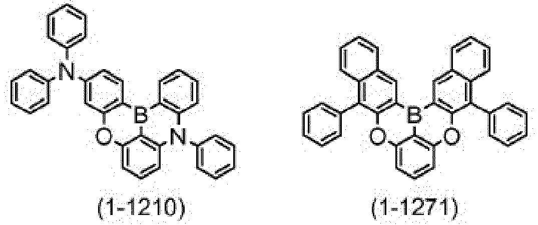

6. Composé aromatique polycyclique décrit dans la revendication 1, qui est représenté par la formule (1-1-1) suivante, la formule (1-79) suivante, la formule (1-142) suivante, la formule (1-152-2) suivante, la formule (1-158) suivante, la formule (1-159) suivante, la formule (1-1006) suivante, la formule (1-1104) suivante, la formule (1-1149) suivante, la formule (1-1150) suivante, la formule (1-1301) suivante, la formule (1-1351) suivante, la formule (1-2305) suivante, la formule (1-2626) suivante, la formule (1-2657) suivante, la formule (1-2662) suivante, la formule (1-2665) suivante, la formule (1-2676) suivante, la formule (1-2678) suivante, la formule (1-2679) suivante, la formule (1-2680) suivante, la formule (1-2681) suivante, la formule (1-2682) suivante, la formule (1-2683) suivante, la formule (1-2691) suivante, la formule (1-2699) suivante, la formule (1-4401) suivante, ou la formule (1-4421-1) suivante :

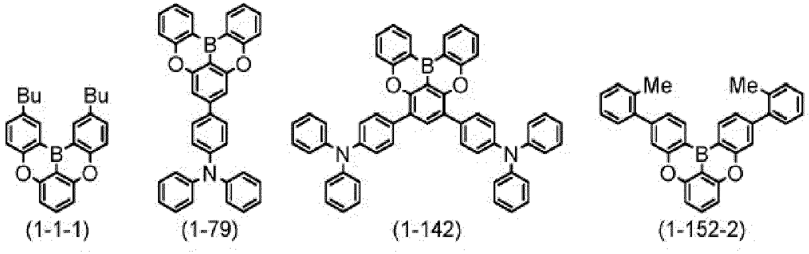

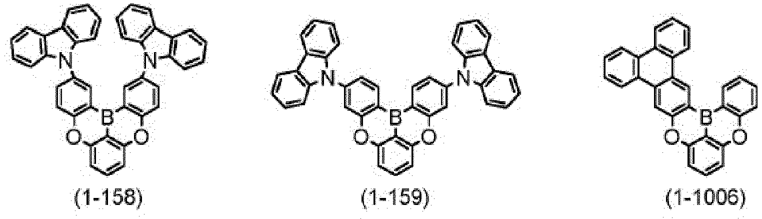

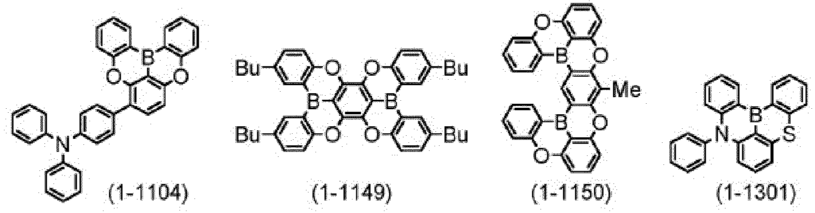

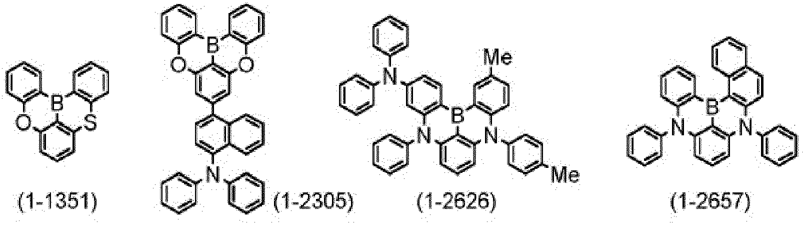

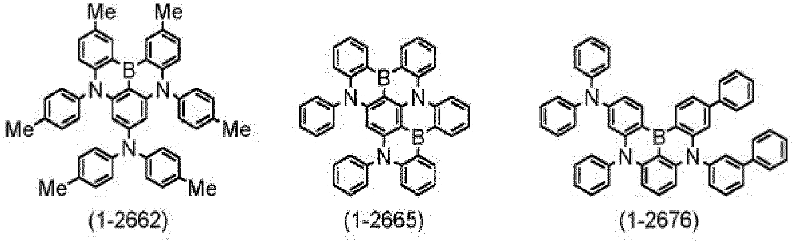

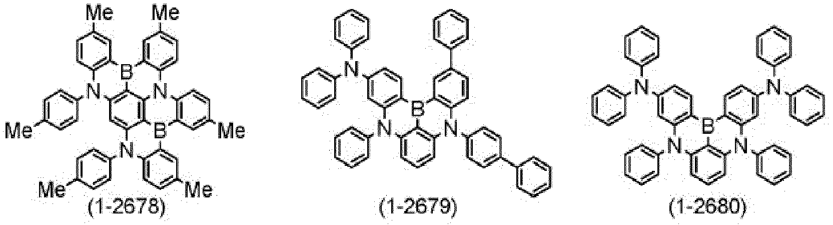

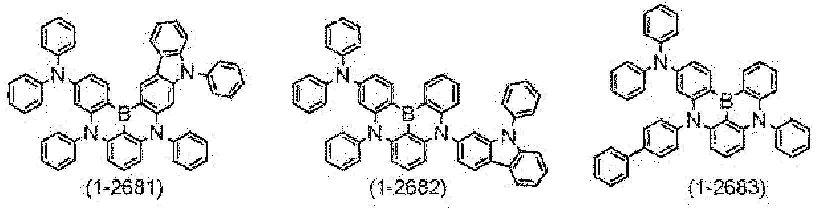

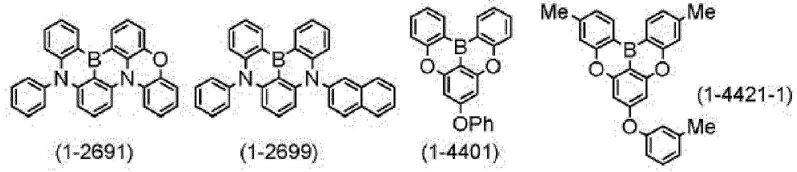

7. Matériau pour un dispositif organique, comprenant le composé aromatique polycyclique ou l'oligomère de celui-ci décrit dans l'une quelconque des revendications 1 à 6.

8. Matériau pour un dispositif organique décrit dans la revendication 7, dans lequel le matériau pour un dispositif organique est un matériau pour un élément électroluminescent organique, un matériau pour un transistor organique à effet de champ, ou un matériau pour une cellule solaire à film mince organique.

9. Matériau pour un élément électroluminescent organique décrit dans la revendication 8, qui est un matériau pour une couche émettrice de lumière.

10. Matériau pour un élément électroluminescent organique décrit dans la revendication 8, qui est un matériau pour une couche d'injection d'électrons ou un matériau pour une couche de transport d'électrons.

11. Matériau pour un élément électroluminescent organique décrit dans la revendication 8, qui est un matériau pour une couche d'injection de trous ou un matériau pour une couche de transport de trous.

12. Élément électroluminescent organique, comprenant une paire d'électrodes composée d'une électrode positive et d'une électrode négative ; et une couche émettrice de lumière qui est disposée entre la paire d'électrodes et qui contient le matériau pour une couche émettrice de lumière décrit dans la revendication 9, ou
comprenant une paire d'électrodes composée d'une électrode positive et d'une électrode négative ; une couche émettrice de lumière qui est disposée entre la paire d'électrodes ; et une couche d'injection d'électrons et/ou une couche de transport d'électrons qui est disposée entre l'électrode négative et la couche émettrice de lumière et qui contient le matériau pour une couche d'injection d'électrons et/ou le matériau pour une couche de transport d'électrons décrit dans la revendication 10, ou
comprenant une paire d'électrodes composée d'une électrode positive et d'une électrode négative ; une couche émettrice de lumière qui est disposée entre la paire d'électrodes ; et une couche d'injection de trous et/ou une couche de transport de trous qui est disposée entre l'électrode positive et la couche émettrice de lumière et qui contient le matériau pour une couche d'injection de trous et/ou le matériau pour une couche de transport de trous décrit dans la revendication 11.

13. Élément électroluminescent organique décrit dans la revendication 12, comprenant en outre une couche de transport d'électrons et/ou une couche d'injection d'électrons qui est disposées entre l'électrode négative et la couche émettrice de lumière, dans lequel au moins l'une parmi la couche de transport d'électrons et la couche d'injection d'électrons contient au moins l'un sélectionné dans le groupe constitué d'un complexe métallique à base de quinolinol, d'un dérivé de pyridine, d'un dérivé de phénanthroline, d'un dérivé de borane, et d'un dérivé de benzimidazole.

14. Élément électroluminescent organique décrit dans la revendication 13, dans lequel la couche de transport d'électrons et/ou la couche d'injection d'électrons contient en outre au moins l'un sélectionné dans le groupe constitué d'un métal alcalin, d'un métal alcalino-terreux, d'un métal des terres rares, d'un oxyde de métal alcalin, d'un halogénure de métal alcalin, d'un oxyde de métal alcalino-terreux, d'un halogénure de métal alcalino-terreux, d'un oxyde de métal des terres rares, d'un halogénure de métal des terres rares, d'un complexe organique d'un métal alcalin, d'un complexe organique d'un métal alcalino-terreux, et d'un complexe organique d'un métal des terres rares.

15. Appareil d'affichage comprenant l'élément électroluminescent organique décrit dans l'une quelconque des revendications 12 à 14.

16. Appareil d'éclairage comprenant l'élément électroluminescent organique décrit dans l'une quelconque des revendications 12 à 14.

17. Procédé de production du composé aromatique polycyclique représenté par la formule générale (2) suivante ou de l'oligomère d'un composé aromatique polycyclique ayant plusieurs structures représentées chacune par la formule générale (2) suivante décrite dans la revendication 1,
le procédé comprenant une étape réactionnelle de liaison du cycle a, du cycle b et du cycle c dans l'intermédiaire suivant via Y¹ par l'intermédiaire d'une réaction de substitution électrophile aromatique continue, au moyen d'un réactif sélectionné dans le groupe constitué d'un halogénure de Y¹, d'un halogénure d'amination de Y¹, d'un produit d'alcoxylation de Y¹ et d'un produit d'aryloxylation de Y¹, et facultativement d'une base de Brønsted : 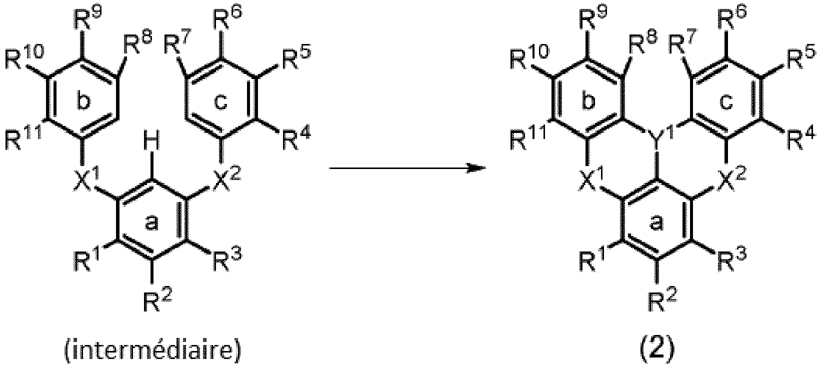 ou le procédé comprenant :
une étape réactionnelle d'ortho-métallation d'un atome d'hydrogène présent entre X¹ et X² dans l'intermédiaire suivant au moyen d'un composé alcalin organique ;
une étape réactionnelle d'échange du métal par Y¹ au moyen d'un réactif sélectionné dans le groupe constitué d'un halogénure de Y¹, d'un halogénure aminé de Y¹, d'un produit d'alcoxylation de Y¹, et d'un produit d'aryloxylation de Y¹ ; et
une étape réactionnelle de liaison du cycle b et du cycle c via Y¹ par l'intermédiaire d'une réaction de substitution électrophile aromatique continue au moyen d'une base de Brønsted :

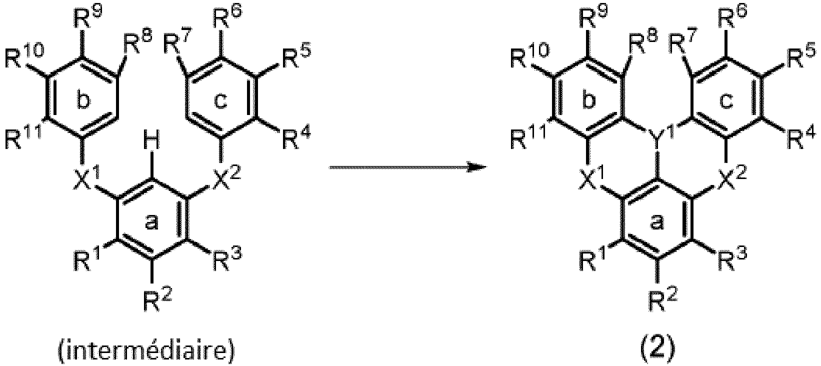

18. Procédé de production décrit dans la revendication 17, dans lequel les réactions sont accélérées en ajoutant en outre un acide de Lewis au système réactionnel.

19. Procédé de production décrit dans la revendication 17 ou 18, comprenant en outre une étape réactionnelle d'halogénation à l'avance d'un atome d'hydrogène présent entre X¹ et X² dans l'intermédiaire.
